# EUROPEAN PATENT SPECIFICATION

(11) **EP 2 182 002 B1**
(45) Date of publication and mention of the grant of the patent: **04.07.2012**
(21) Application number: 09250947.0
(22) Date of filing: 30.03.2009
(51) Int. Cl.: C07F 15/00, H05B 33/14, C09K 11/06

(54) **Novel compounds for electronic material and organic electronic device using the same**
Neuartige Verbindungen für elektronisches Material und organische elektronische Vorrichtung damit
Nouveaux composés pour matériau électronique et dispositif électronique organique utilisant ceux-ci

(30) Priority: 29.10.2008 KR 20080106370
(43) Date of publication of application: 05.05.2010
(73) Proprietor: Gracel Display Inc., Seoul 133-833 (KR)
(72) Inventor: Cho, Young Jun, Seoul 136-060 (KR); Kwon, Hyuck Joo, Seoul 130-100 (KR); Kim, Bong Ok, Seoul 135-090 (KR); Kim, Sung Min, Seoul-city 157-886 (KR); Yoon, Seung Soo, Seoul 135-884 (KR)
(74) Representative: Kent, Venetia Katherine

(56) References cited:
- WO-A2-2008/109824
- CN-A- 101 077 971

## Description

### FIELD OF THE INVENTION

The present invention relates to novel compounds for electronic material, and organic electronic devices comprising the same. More specifically, the invention relates to novel compounds for electronic material having high efficiency, and organic electronic devices employing the compounds as phosphorescent dopant for forming an electroluminescent layer.

### BACKGROUND OF THE INVENTION

The most important factor to determine luminous efficiency in an organic light-emitting diode (OLED) is electroluminescent material. Though fluorescent materials have been widely used as electroluminescent material up to the present, development of phosphorescent materials is one of the best ways to improve the luminous efficiency theoretically up to four (4) times, in view of electroluminescent mechanism.

Up to now, iridium (III) complexes have been widely known as phosphorescent material, including (acac)Ir(btp)₂, Ir(ppy)₃ and Firpic, as the red, green and blue one, respectively. In particular, a lot of phosphorescent materials have been recently investigated in Japan, Europe and America.

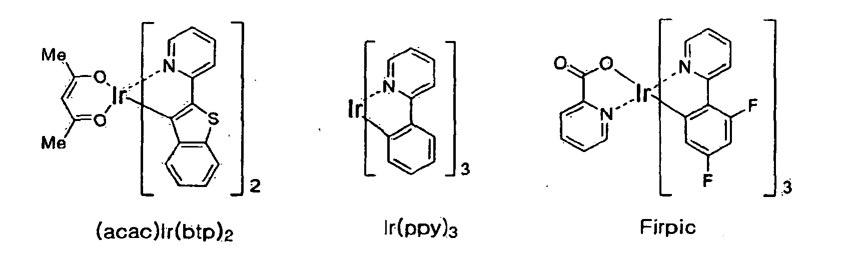

Among conventional red phosphorescent materials, several materials have been reported to have good EL (electroluminescent) properties. However, very rare materials among them have reached the level of commercialization. As the most preferable material, an iridium complex of 1-phenyl isoquinoline may be mentioned, which is known to have excellent EL property and to exhibit color purity of dark red with high luminous efficiency. [See A. Tsuboyama et al., J. Am. Chem. Soc. 2003, 125(42), 12971-12979.]

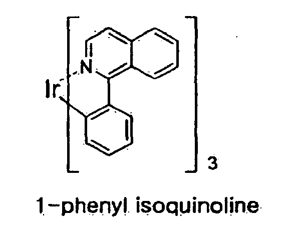

Moreover, the red materials, having no significant problem of lifetime, have tendency of easy commercialization if they have good color purity or luminous efficiency. Thus, the above-mentioned iridium complexes are those having noticeable viability of commercialization due to their excellent color purity and luminous efficiency.

Patent documents WO2008/109824 A2 and CN 101077971 A disclose iridium complexes that are used in electronic devices.

However, the iridium complex is still construed as a material which is merely applicable to small displays (thereby having limitation to be applied to medium to large sized OLED panels) because they cannot provide pure red color and high luminous efficiency at the same time, while higher levels of EL properties than those of known materials are practically required for an OLED panel of medium to large size.

### SUMMARY OF THE INVENTION

With intensive efforts to overcome the problems of conventional techniques as described above, the present inventors have researched for developing novel compounds for electronic material to realize an organic EL device having excellent quantum efficiency and noticeably improved lifetime. Eventually, the inventors found that excellent luminous efficiency and life property with pure red color could be obtained when using an iridium complex, which was synthesized by introducing fused benzo[f]quinoline or benzo[h]quinoline, in which [f] or [h] of quinoline ring has been fused, as a primary ligand of iridium complex, instead of pyridine (as was for conventional iridium complex), and completed the present invention.

Thus, the object of the invention is to provide novel compounds for electronic material having the backbone to give more excellent electroluminescent properties as compared to those of conventional phosphorescent materials, with overcoming disadvantages of them.

Another object of the invention is to provide novel compounds for electronic material which are applicable to OLED panels of medium to large size, and organic electronic devices comprising the same.

Still another object of the invention is to provide organic solar cells comprising the novel compounds for electronic material.

Thus, the present invention relates to novel compounds for electronic material, and organic electronic devices comprising the same. Specifically, the novel compounds for electronic material according to the invention are represented by Chemical Formula (1): 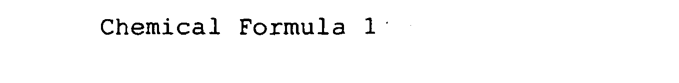 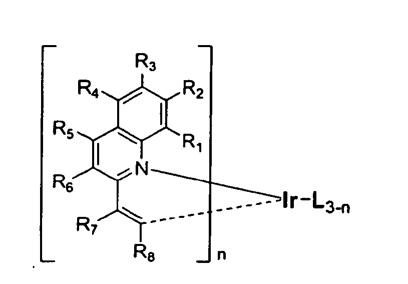 wherein, L represents an organic ligand;
R₁ and R₂, or R₃ and R₄ are independently linked via (C3-C12)alkylene or (C3-C12)alkenylene to form at least one fused ring(s), and the substituents which do not form a fused ring are independently substituted by hydrogen, deuterium, halogen, (C1-C60)alkyl, (C6-C60)aryl, (C4-C60)heteroaryl, 5- or 6-membered heterocycloalkyl containing one or more heteroatom (s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
the fused ring formed by linkage from R₁ and R₂, or R₃ and R₄ via (C3-C12)alkylene or (C3-C12)alkenylene, or the alkyl, alkenyl, alkynyl, cycloalkyl, heterocycloalkyl, aryl, heteroaryl, arylsilyl, alkylsilyl, alkylamino or arylamino of other substituents which do not form a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (Cl-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₅ and R₆ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₇ and R₈ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₇ and R₈ may be linked via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, arylamino of R₅, R₆, R₇ and R₈, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from deuterium, halogen, (C1-C60)alkyl, halo(C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60-)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
n is an integer from 1 to 3;
provided that, if the ring formed from R₃ and R₄ of 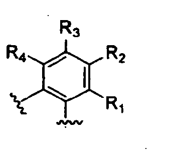 by linkage via alkylene or alkenylene is benzene, the ring formed from R₇ and R₈ of 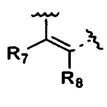 by linkage via alkylene or alkenylene is not benzene.

### BRIEF DESCRIPTION OF THE DRAWINGS

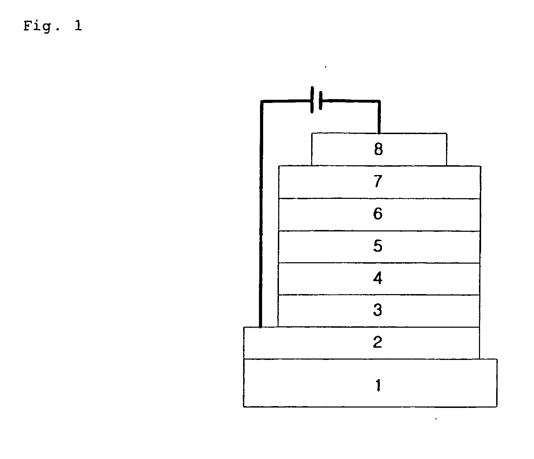

Fig. 1 is a cross-sectional view of an OLED.

### DETAILED DESCRIPTION OF THE INVENTION

Referring now to the Drawings, Fig. 1 illustrates a cross-sectional view of an OLED of the present invention comprising a Glass 1, Transparent electrode 2, Hole injecting layer 3, Hole transport layer 4, Electroluminescent layer 5, Electron transport layer 6, Electron injecting layer 7 and A1 cathode 8.

The term "alkyl" and other substituents containing "alkyl" moiety includes linear and branched species.

The term "aryl" described herein means an organic radical derived from aromatic hydrocarbon via elimination of one hydrogen atom. Each ring suitably comprises a monocyclic or fused ring system containing from 4 to 7, preferably from 5 to 6 cyclic atoms. Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S for the aromatic cyclic backbone atoms, and carbon atom(s) for remaining aromatic cyclic backbone atoms. The heteroaryl may be 5- or 6-membered monocyclic heteroaryl or a polycyclic heteroaryl which is fused with one or more benzene ring(s), and may be partially saturated. The heteroaryl groups may include divalent aryl groups of which the heteroatoms are oxidized or quarternized to form N-oxides, quaternary salts, or the like. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl and benzodioxolyl; and corresponding N-oxides (for example, pyridyl N-oxide, quinolyl N-oxide) and quaternary salts thereof; but they are not restricted thereto.

The naphthyl mentioned herein may be 1-naphthyl or 2-naphthyl; the anthryl may be 1-anthryl, 2-anthryl or 9-anthryl; and the fluorenyl may be 1-fluorenyl, 2-fluorenyl, 3-fluorenyl, 4-fluorenyl or 9-fluorenyl.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

The novel compounds for electronic material according to the invention are represented by Chemical Formula (2) or (3): 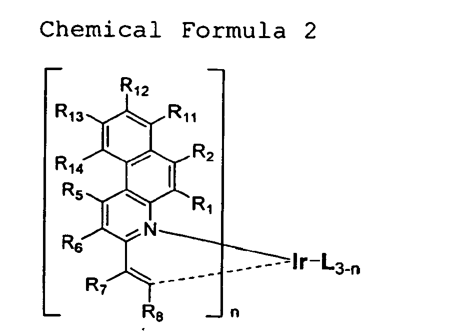 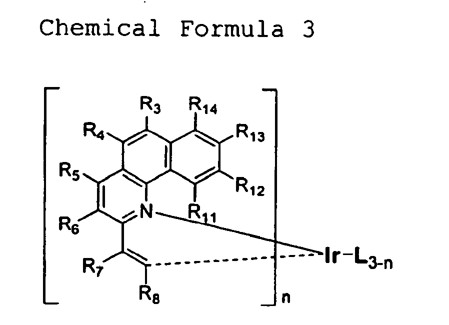 wherein, L, R₁, R₂, R₃, R₄, R₅, R₆, R₇, R₈ and n are defined as in Chemical Formula (1);
R₁₁ through R₁₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60) alkyloxy, (C1-C60)alkylthio, (C6-C60)aryloxy, (C6-C60)arylthio; (C1-C60)alkoxycarbonyl, (C1-C60)alkylcarbonyl, (C6-C60)arylcarbonyl, carboxyl, nitro or hydroxyl; and
the alkyl, alkenyl, alkynyl, cycloalkyl, heterocycloalkyl, aryl, heteroaryl, arylsilyl, alkylsilyl, alkylamino or arylamino of R₁₁ through R₁₄ may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

In the compounds represented by Chemical Formula (1) according to the present invention, the alicyclic ring, or the monocyclic or polycyclic aromatic ring formed from R₇ and R₈ by linkage via (C3-C12)alkylene or (C3-C12)alkenylene with or without a fused ring may be naphthalene, anthracene, fluorene, indene or phenanthrene, without restriction.

The compound within the square bracket ([]) in Chemical Formula (1) according to the present invention serves as a primary ligand of iridium, and L serves as a subsidiary ligand. The organic compounds for electronic material according to the present invention also include the complex with the ratio of primary ligand: subsidiary ligand = 2:1 (n=2) and the complex with the ratio of primary ligand: subsidiary ligand = 1:2 (n=1), as well as tris-chelated complexes without subsidiary ligand (L) (n=3).

The organic compounds for electronic material according to the present invention can be exemplified by compounds represented by one of Chemical Formulas (4) to (13): 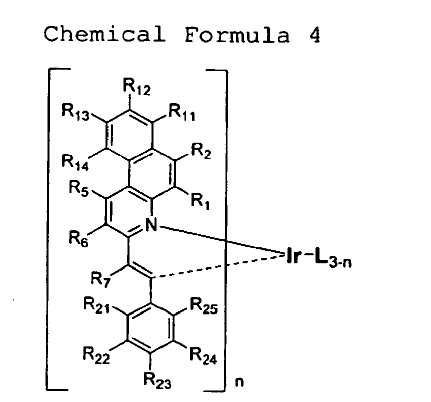 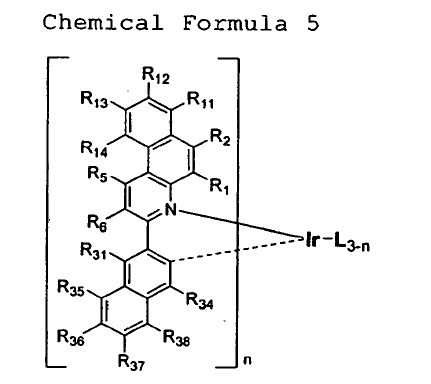 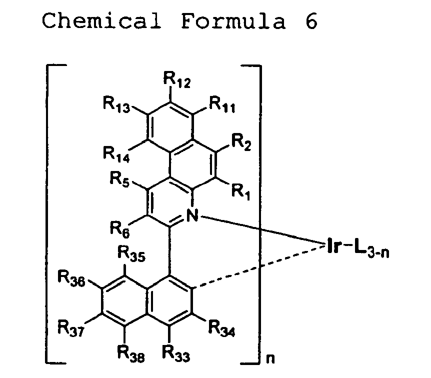 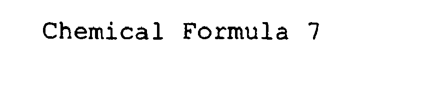 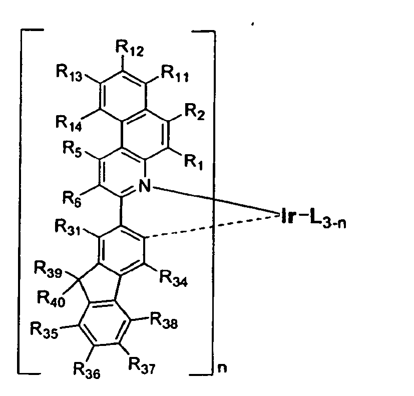 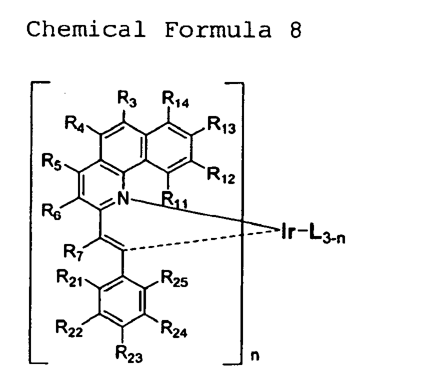 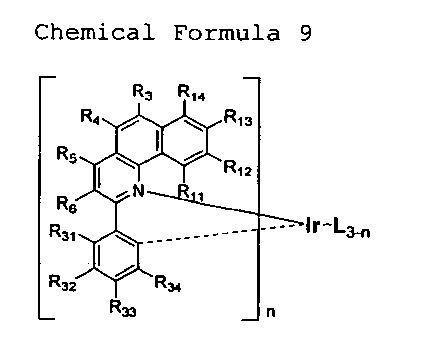 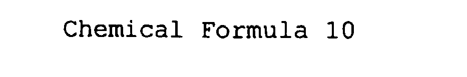 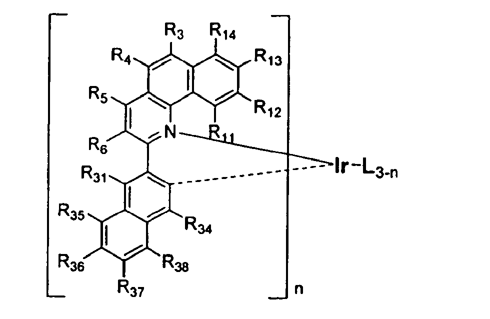 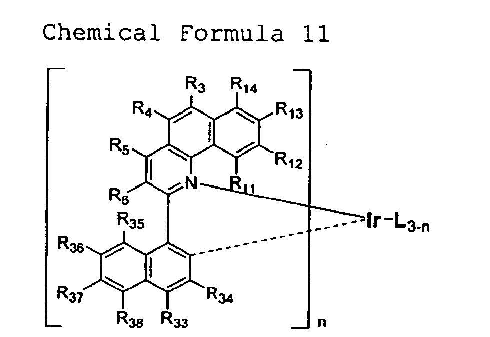 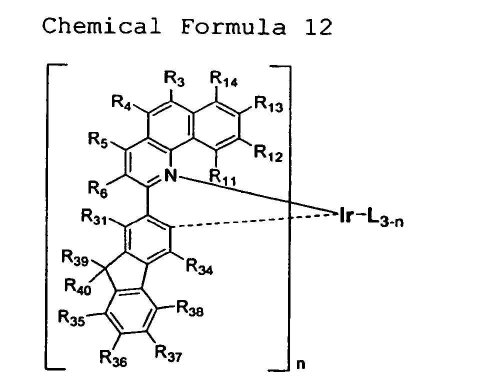 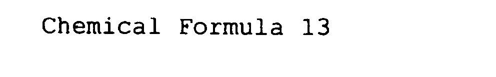 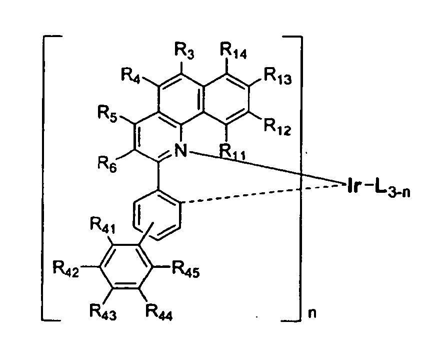 wherein, L, R₁, R₂, R₃, R₄, R₅, R₆, R₇ and n are defined as in Chemical Formula (1);
R₁₁, R₁₂, R₁₃ and R₁₄ are defined as in Chemical Formula (2) or (3);
R₂₁ through R₂₅, R₃₁ through R₃₈, and R₄₁ through R₄₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of them may be linked to an adjacent substituent via (C3-C60)alkylene or (C3-C60)alkenylene with or without a fused ring to form an alicyclic ring, or a monocyclic or polycyclic aromatic ring;
R₃₉ and R₄₀ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₉ and R₄₀ may be linked via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, arylamino of R₂₁ through R₂₅, and R₃₁ through R₄₅, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino (C6-C60)arylamino, (C6-C60)ar(C1-C60)alkyl, (C1-C60)alkyloxy, (C1-C60)alkylthio, (C6-C60)aryloxy, (C6-C60)arylthio, (Cl-C60)alkoxycarbonyl, (C1-C60)alkylcarbonyl, (C6-C60)arylcarbonyl, carboxyl, nitro and hydroxyl.

In Chemical Formula (1), R₁ through R₈ independently represent hydrogen, deuterium, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, cyano, methoxy, ethoxy, n-propoxy, i-propoxy, n-butoxy, i-butoxy, t-butoxy, n-pentoxy, n-hexyloxy, n-heptoxy, cyclopropyl, cyclobutyl, cyclopentyl, cyclohexyl, cycloheptyl, cyclooctyl, cyclononyl, cyclodecyl, trifluoromethyl, perfluorethyl, trifluoroethyl, perfluoropropyl, perfluorobutyl, phenyl, naphthyl, biphenyl, fluorenyl, phenanthryl, anthryl, fluoranthenyl, triphenylenyl, pyrenyl, chrysenyl, naphthacenyl, perylenyl, pyridyl, pyrrolyl, furanyl, thiophenyl, imidazolyl, benzimidazolyl, pyrazinyl, pyrimidinyl, pyridazinyl, quinolyl, triazinyl, benzofuranyl, benzothiophenyl, pyrazolyl, indolyl, carbazolyl, thiazolyl, oxazolyl, benzothiazolyl, benzoxazolyl, trimethylsilyl, triethylsilyl, tripropylsilyl, tri(t-butyl)silyl, t-butyldimethylsilyl, dimethylphenylsilyl, triphenylsilyl or benzyl; and
the phenyl, naphthyl, biphenyl, fluorenyl, phenanthryl, anthryl, fluoranthenyl, triphenylenyl, pyrenyl, chrysenyl, naphthacenyl, perylenyl, pyridyl, pyrrolyl, furanyl, thiophenyl, imidazolyl, benzimidazolyl, pyrazinyl, pyrimidinyl, pyridazinyl, quinolyl, triazinyl, benzofuranyl, benzothiophenyl, pyrazolyl, indolyl, carbazolyl, thiazolyl, oxazolyl, benzothiazolyl or benzoxazolyl of R₁ through R₈ may be further substituted by one or more substituent(s) selected from deuterium, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, trifluoromethyl, perfluorethyl, trifluoroethyl, perfluoropropyl, perfluorobutyl, methoxy, ethoxy, butoxy, hexyloxy, cyclopropyl, cyclopentyl, cyclohexyl, fluoro, cyano, phenyl, naphthyl, anthryl, trimethylsilyl, triethylsilyl, tripropylsilyl, tri(t-butyl)silyl, t-butyldimethylsilyl, dimethylphenylsilyl and triphenylsilyl.

The organic compounds for electronic material according to the present invention can be specifically exemplified by the following compounds, but they are not restricted thereto: 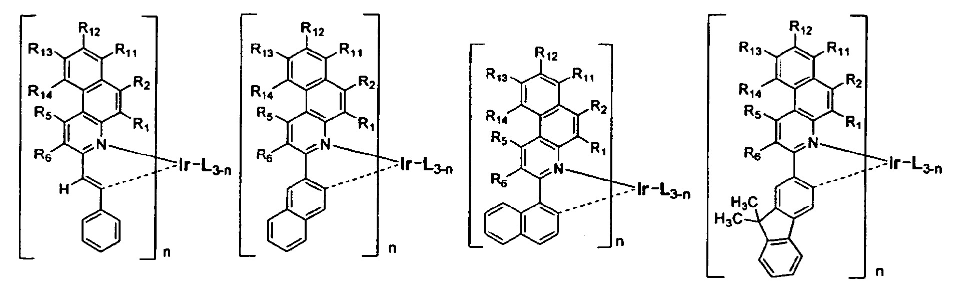 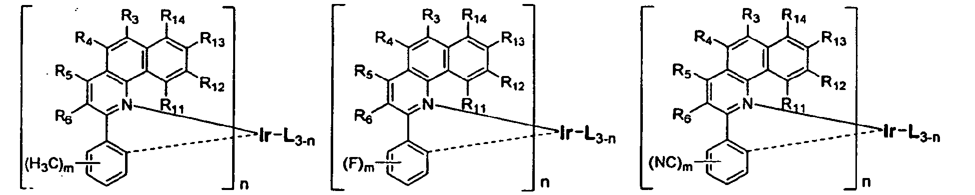 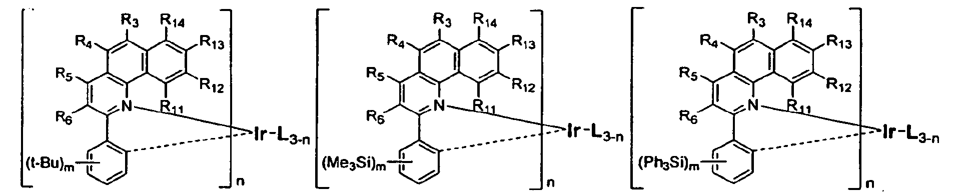 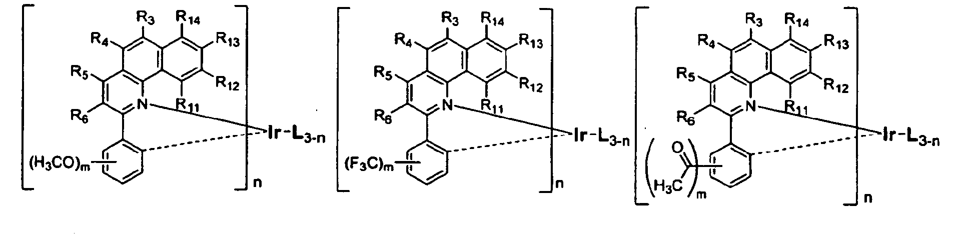 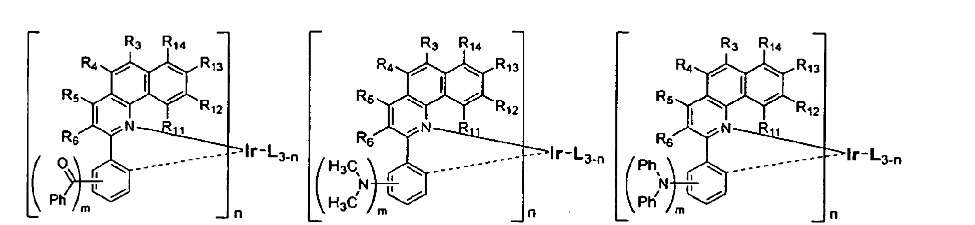 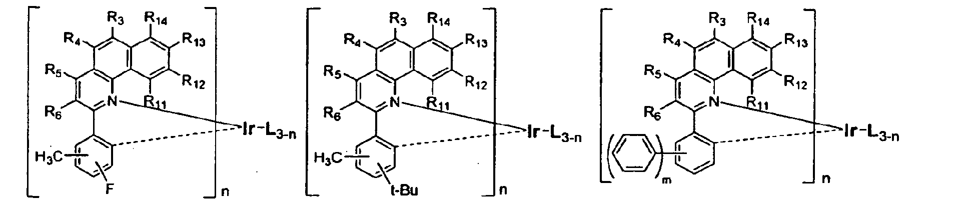 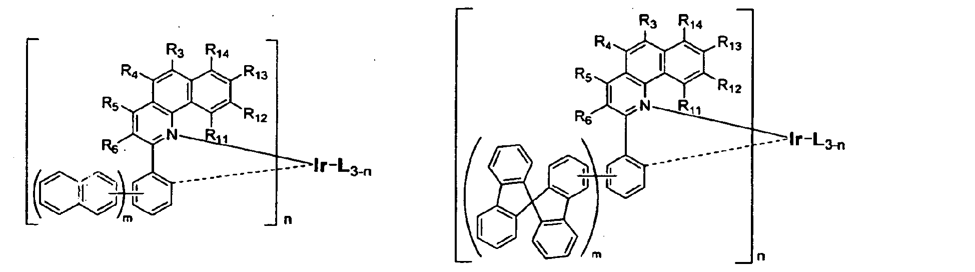 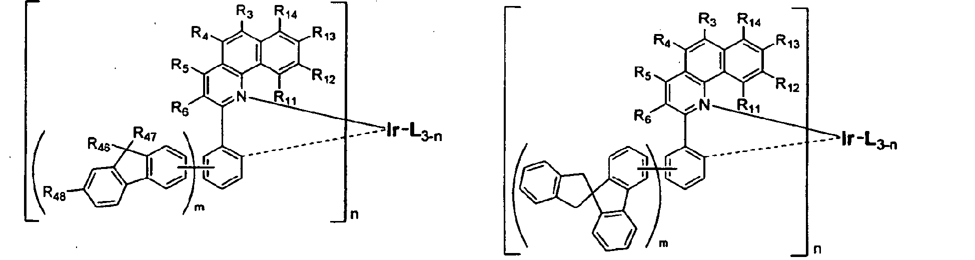 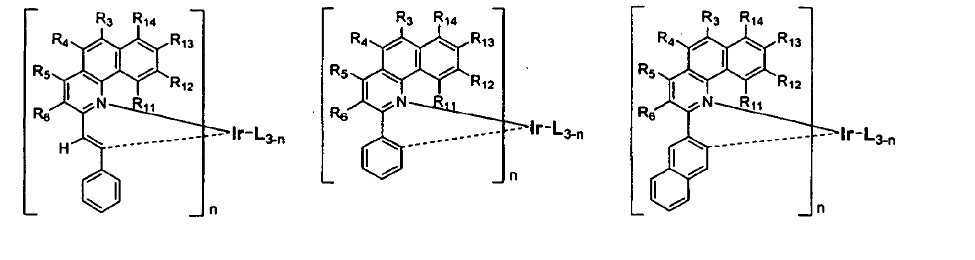 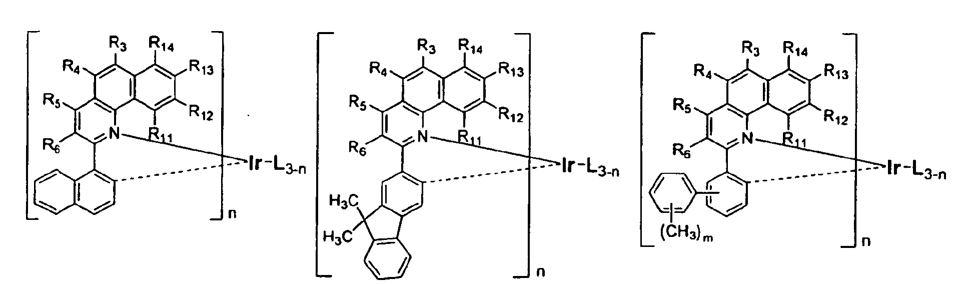 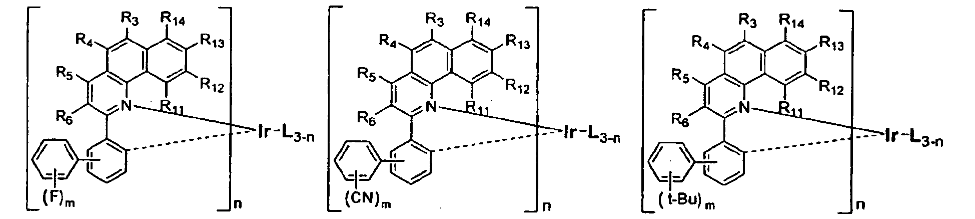 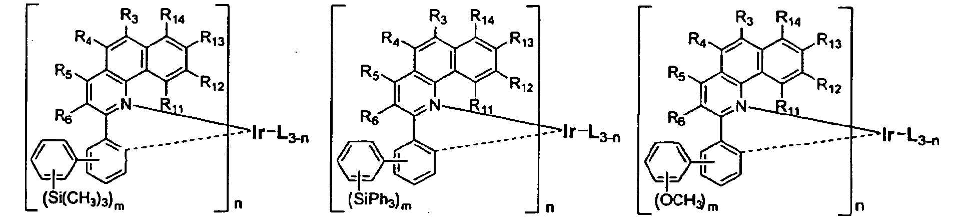 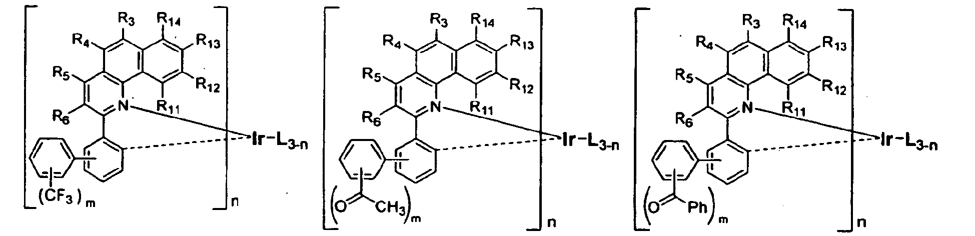 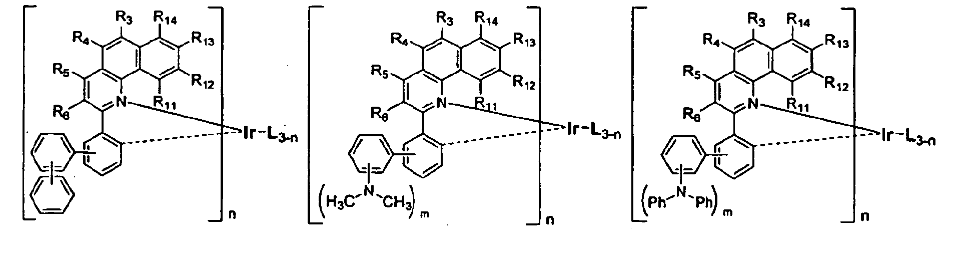 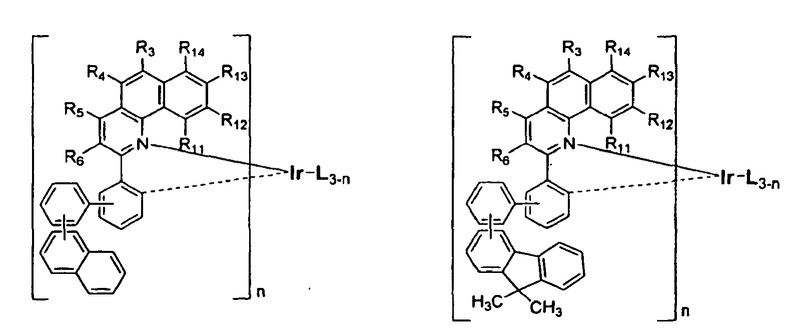 wherein, L, R₁, R₂, R₃, R₄, R₅, R₆, R₇, R₁₁, R₁₂, R₁₃, R₁₄ and n are defined as in Chemical Formula (2) or (3);
R₄₆ and R₄₇ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsjlyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; or R₄₆ and R₄₇ may be linked via (C3-C60)alkylene or (C3-C60)alkenylene with or without a fused ring to form an alicyclic ring, or a monocyclic or polycyclic aromatic ring;
R₄₈ independently represents hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
the alkyl, alkenyl, alkynyl, cycloalkyl, heterocycloalkyl, aryl, heteroaryl, arylsilyl, alkylsilyl, alkylamino, arylamino of R₄₆ through R₄₈, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
m is an integer from 1 to 5.

The subsidiary ligands (L) of the organic compounds for electronic material according to the present invention include the following structures: 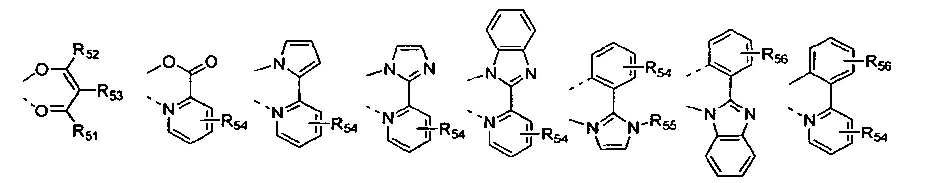 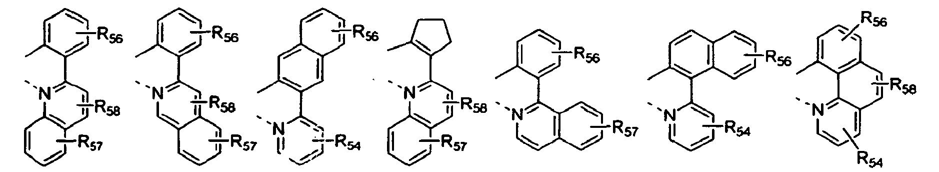 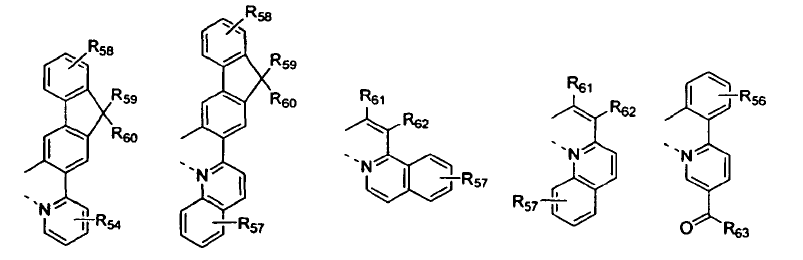 wherein, R₅₁ through R₆₃ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₅₁ through R₆₃ may be linked to an adjacent substituent via (C3-C60)alkylene or (C3-C60)alkenylene with or without a fused ring to form an alicyclic ring, or a monocyclic or polycyclic aromatic ring; and the alkyl, alkenyl, alkynyl, cycloalkyl, heterocycloalkyl, aryl, heteroaryl, arylsilyl, alkylsilyl, alkylamino or arylamino of R₅₁ through R₆₃, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

The subsidiary ligands (L) of the organic compounds for electronic material according to the present invention can be exemplified by the following structures, but they are not restricted thereto:

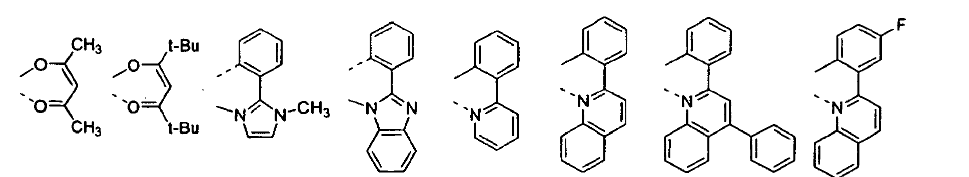

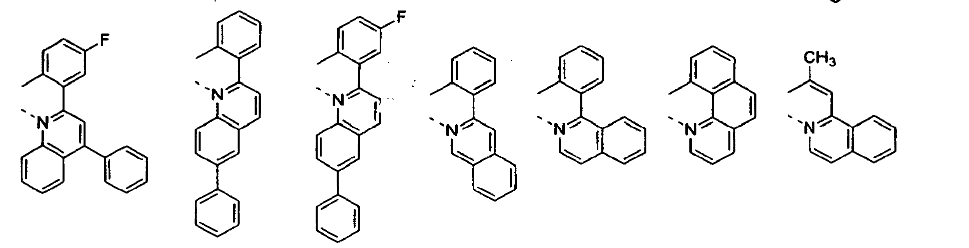

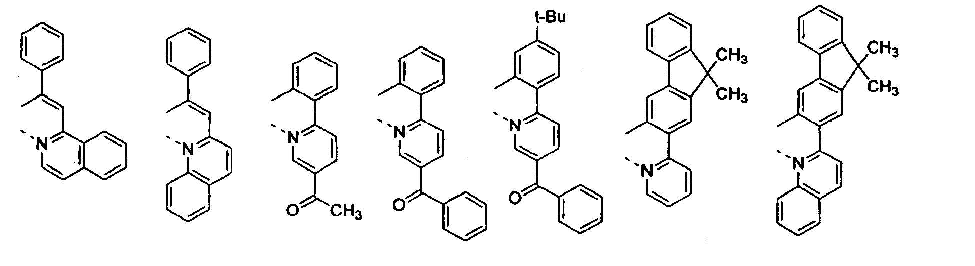

The processes for preparing the organic compounds for electronic material according to the present invention are illustrated on the basis of Reaction Schemes (1) to (3) shown below: 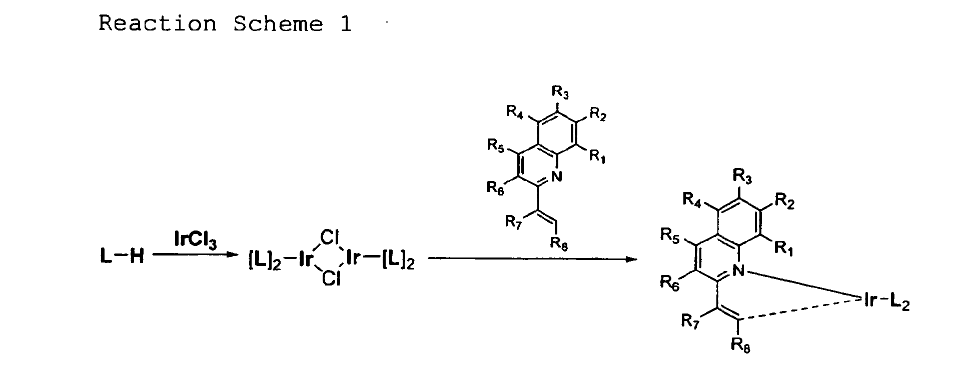 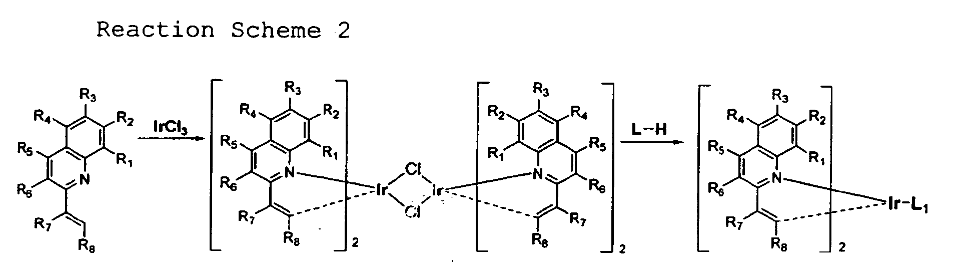 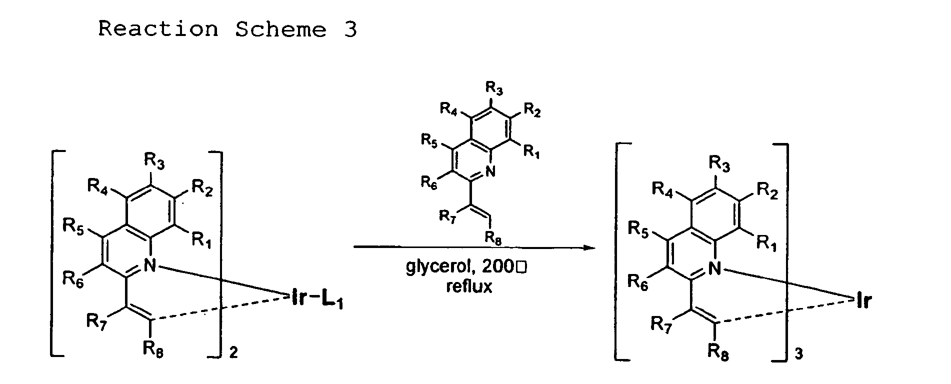 wherein, R₁, R₂, R₃, R₄, R₅, R₆, R₇, R₈ and L are defined as in Chemical Formula (1).

Reaction Scheme (1) provides a compound of Chemical Formula (1) with n=1, in which iridium trichloride (IrCl₃) and subsidiary ligand compound (L-H) are mixed in a solvent at a molar ratio of 1:2~3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with a primary ligand compound in organic solvent to provide an organic phosphorescent iridium compound having the ratio of primary ligand: subsidiary ligand of 1:2 as the final product. The reaction is carried out with AgCF₃SO₃, Na₂CO₃ or NaOH being admixed with organic solvent such as 2-ethoxyethanol and 2-methoxyethylether.

Reaction Scheme (2) provides a compound of Chemical Formula (1) with n=2, in which iridium trichloride (IrCl₃) and a primary ligand compound are mixed in a solvent at a molar ratio of 1:2~3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with the subsidiary ligand compound (L-H) in organic solvent to provide an organic phosphorescent iridium compound having the ratio of primary ligand: subsidiary ligand of 2:1 as the final product.

The molar ratio of the primary ligand compound to the subsidiary ligand (L) in the final product is determined by appropriate molar ratio of the reactant depending on the composition. The reaction may be carried out with AgCF₃SO₃, Na₂CO₃ or NaOH being admixed with organic solvent such as 2-ethoxyethanol, 2-methoxyethylether and 1,2-dichloroethane.

Reaction Scheme (3) provides a compound of Chemical Formula (1) with n=3, in which iridium complex prepared according to Reaction Scheme (1) or (2) and the primary ligand compound are mixed in glycerol at a molar ratio of 1:2~3, and the mixture is heated under reflux to obtain organic phosphorescent iridium complex coordinated with three primary ligands.

The compounds employed as a primary ligand in the present invention can be prepared, without limitation, according to the process illustrated by Reaction Scheme (4), on the basis of conventional processes. 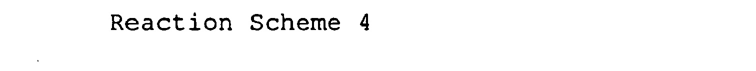 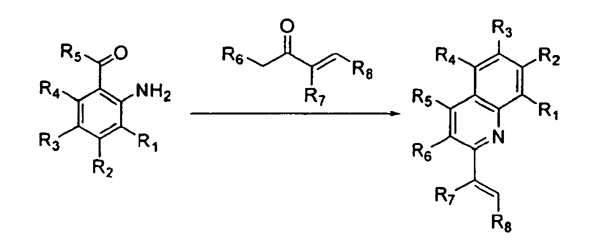 wherein, R₁ through R₈ are defined as in Chemical Formula (1).

The present invention also provides organic solar cells, which comprises one or more organic compound(s) for electronic material represented by Chemical Formula (1).

The present invention also provides an organic electronic device which is comprised of a first electrode; a second electrode; and at least one organic layer(s) interposed between the first electrode and the second electrode; wherein the organic layer comprises one or more organic compound(s) for electronic material represented by Chemical Formula (1).

The organic electronic device according to the present invention is characterized in that the organic layer comprises an electroluminescent region, which comprises one or more organic compound(s) for electronic material represented by Chemical Formula (1) as electroluminescent dopant in an amount of 0.01 to 10% by weight, and one or more host(s). The host to be applied to the organic electronic device according to the invention is not particularly restricted, but may be exemplified by 1,3,5-tricarbazolylbenzene, polyvinylcarbazole, m-biscarbazolylphenyl, 4,4'4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane or the compounds represented by one of Chemical Formulas (14) to (17).

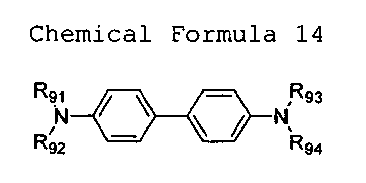

In Chemical Formula (14), R₉₁ through R₉₄ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

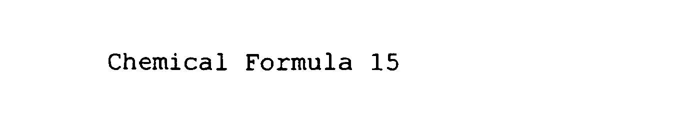

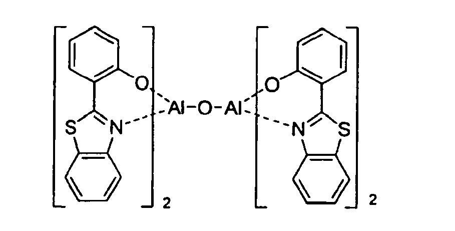

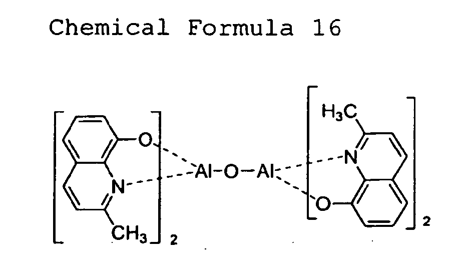

**L¹L²M¹(Q)_{y}** Chemical Formula 17

In Chemical Formula (17), the ligands L¹ and L² are independently selected from the following structures; 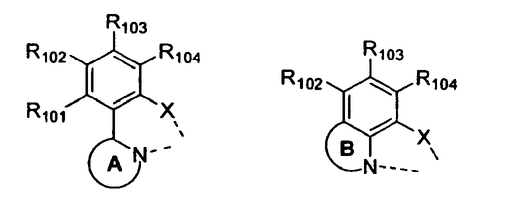 wherein, M¹ represents a bivalent or trivalent metal;
y is 0 when M¹ is a bivalent metal, while y is 1 when M¹ is a trivalent metal;
Q is (C6-C60)aryloxy or tri(C6-C60)arylsilyl, and the aryloxy or triarylsilyl of Q may be further substituted by (C1-C60)alkyl or (C6-C60)aryl;
X is O, S or Se;
ring A represents oxazole, thiazole, imidazole, oxadiazole, thiadiazole, benzoxazole, benzothiazole, benzimidazole, pyridine or quinoline;
ring B represents pyridine or quinoline which may be further substituted by (C1-C60)alkyl, or phenyl or naphthyl with or without (C1-C60)alkyl substituent(s);
R₁₀₁ through R₁₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and
ring A, or the alkyl, alkenyl, alkynyl, cycloalkyl, heterocycloalkyl, aryl, heteroaryl, arylsilyl, alkylsilyl, alkylamino or arylamino of R₁₀₁ through R₁₀₄, and the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60) aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

The ligands, L¹ and L² are independently selected from the following structures: 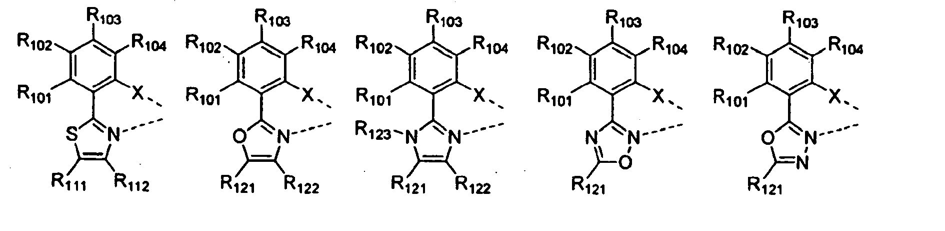 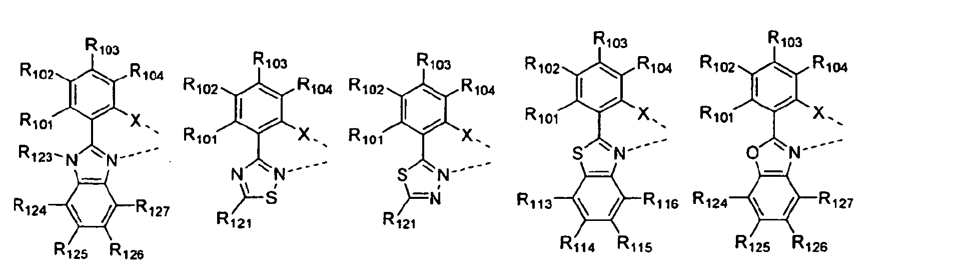 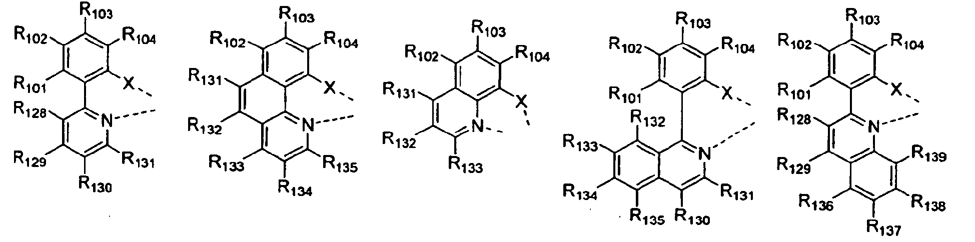 wherein, X represents O, S or Se;
R₁₀₁ through R₁₀₄ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring;
R₁₁₁ through R₁₁₆ and R₁₂₁ through R₁₃₉ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₁₁ through R₁₁₆ and R₁₂₁ through R₁₃₉ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkylamino, or arylamino of R₁₀₁ through R₁₀₄, R₁₁₁ through R₁₁₆ and R₁₂₁ through R₁₃₉, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

In Chemical Formula (17), M¹ is a bivalent metal selected from Be, Zn, Mg, Cu and Ni, or a trivalent metal selected from A1, Ga, In and B, and Q is selected from the following structures.

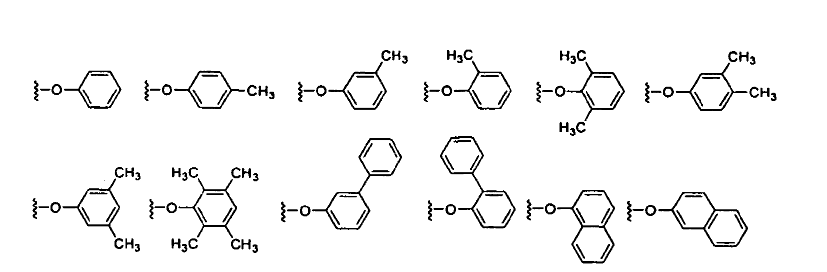

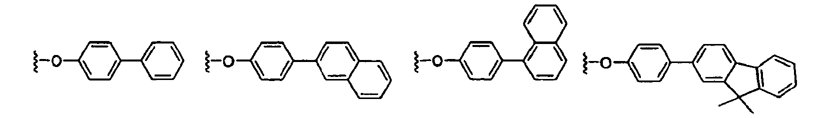

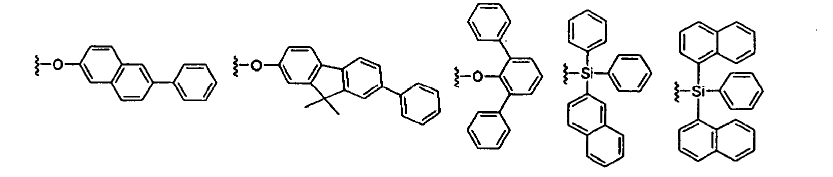

The compounds of Chemical Formula (14) may be specifically exemplified by the compounds represented by the following structures, but they are not restricted thereto.

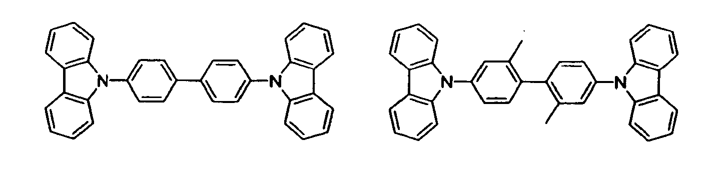

The compounds represented by one of Chemical Formulas (15) to (17) may be specifically exemplified by the compounds having one of the following structures, but they are not restricted thereto.

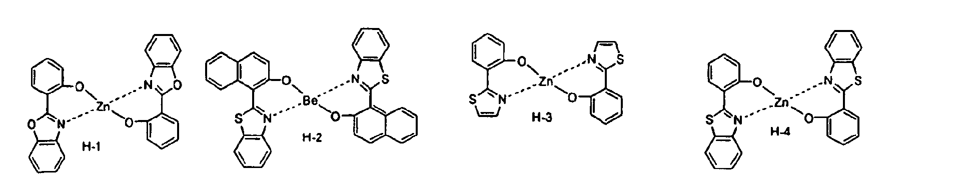

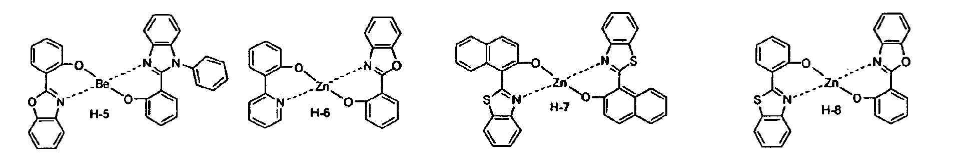

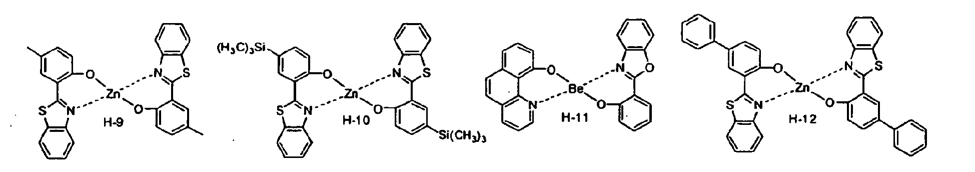

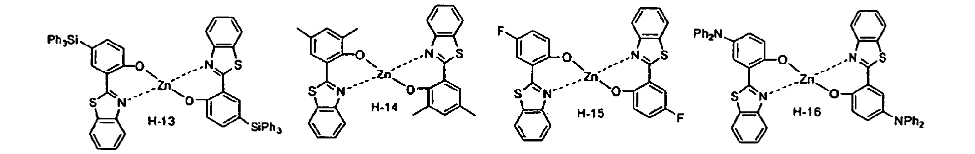

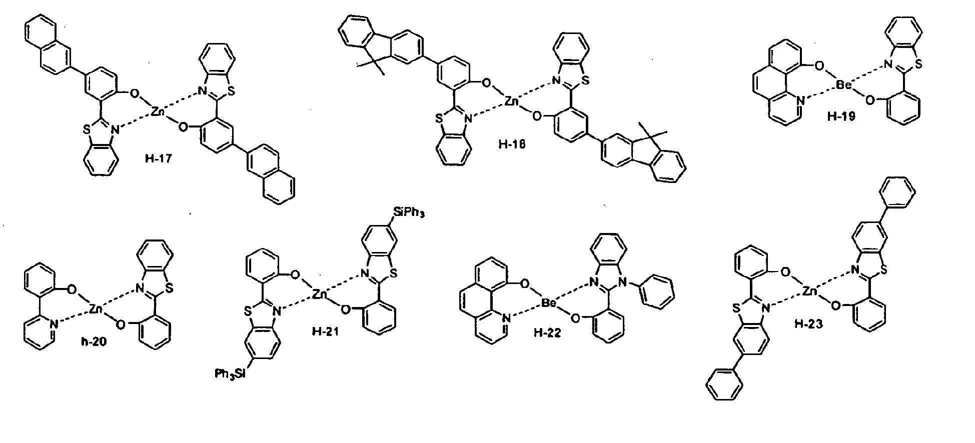

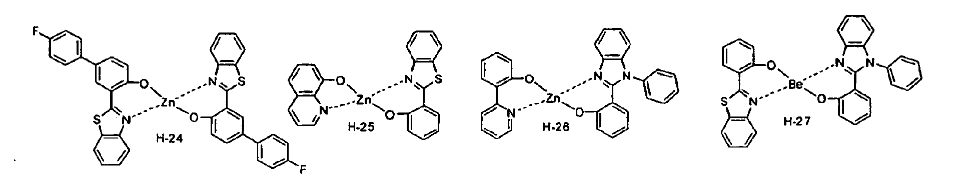

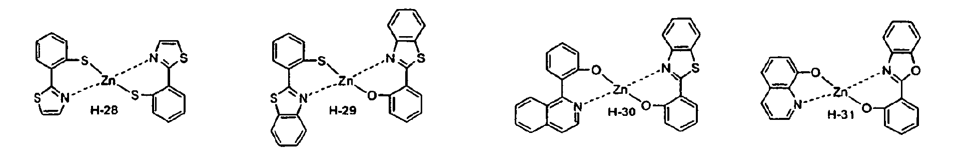

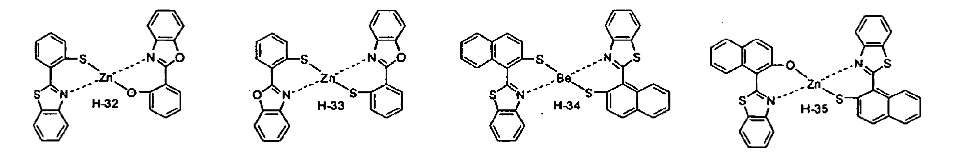

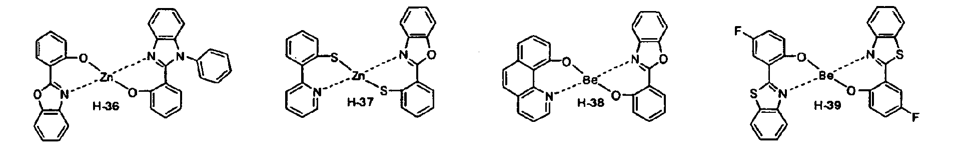

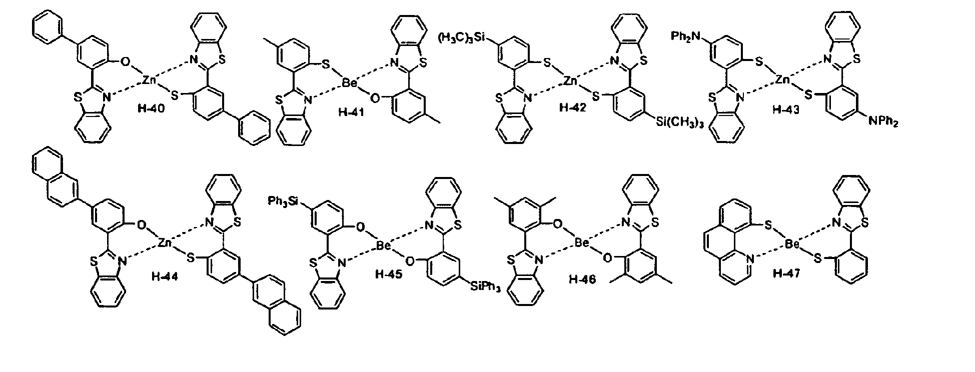

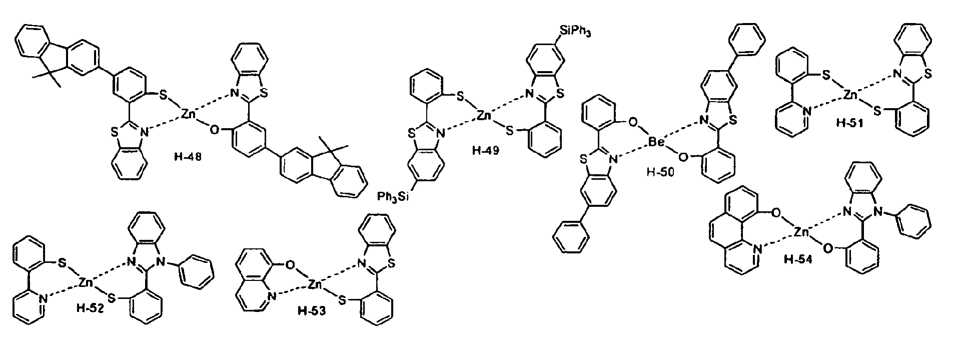

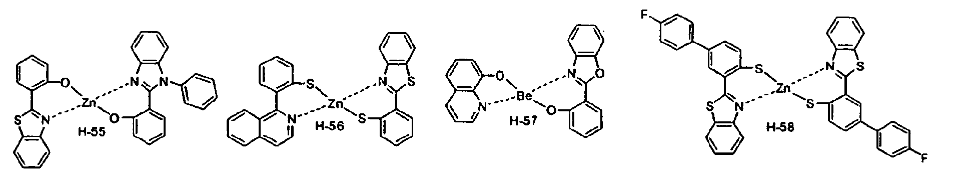

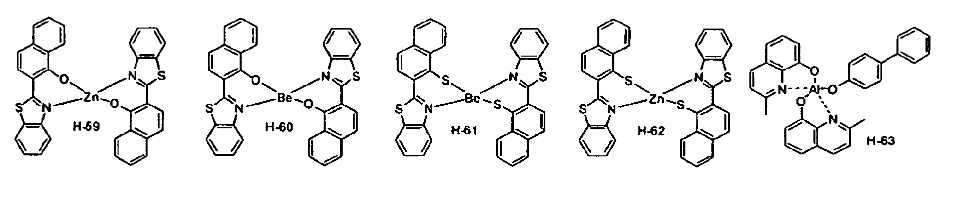

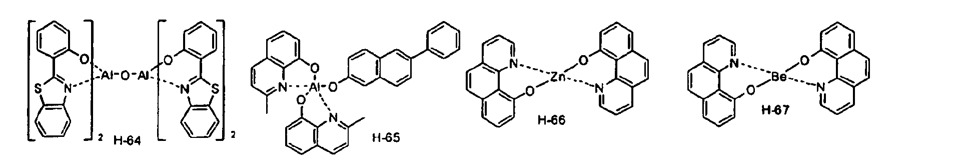

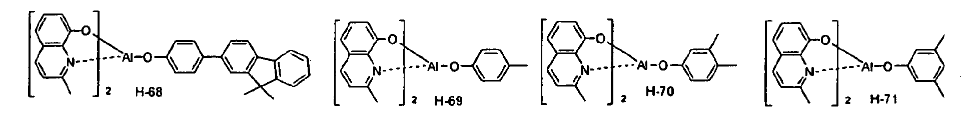

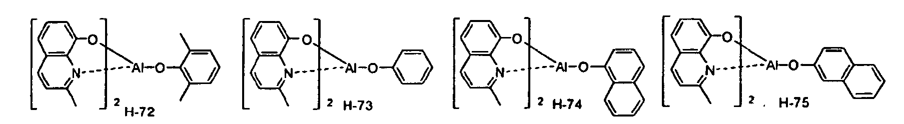

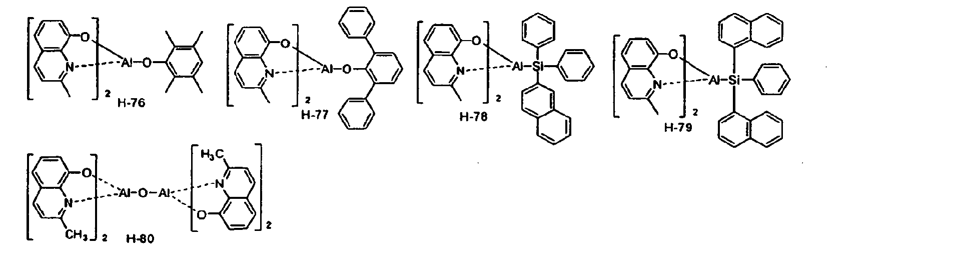

The electroluminescent layer means the layer where electroluminescence occurs, and it may be a single layer or a multi-layer consisting of two or more layers laminated. When a mixture of host-dopant is used according to the constitution of the present invention, noticeable improvement in device life as well as in luminous efficiency may be confirmed.

The organic electronic device according to the invention may further comprise one or more compound(s) selected from a group consisting of arylamine compounds and styrylarylamine compounds, as well as the organic compound for electronic material represented by Chemical Formula (1). Examples of the arylamine or styrylarylamine compounds include the compounds represented by Chemical Formula (18), but they are not restricted thereto: 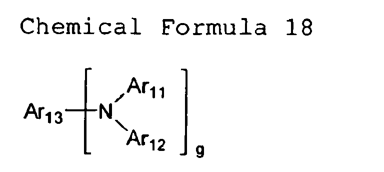 wherein, Ar₁₁ and Ar₁₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when g is 1, Ar₁₃ represents (C6-C60)aryl, (C4-C60)heteroaryl, or aryl represented by one of the following structural formulas: 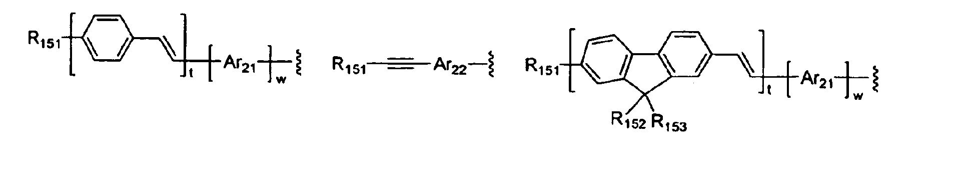 when g is 2, Ar₁₃ represents (C6-C60)arylene, (C4-C60)heteroarylene, or arylene represented by one of the following structural formulas: 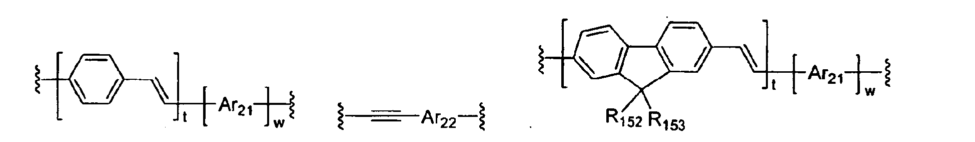 wherein Ar₂₁ and Ar₂₂ independently represent (C6-C60)arylene or (C4-C60)heteroarylene;
R₁₅₁, R₁₅₂ and R₁₅₃ independently represent hydrogen, deuterium, (C1-C60)alkyl or (C6-C60)aryl;
t is an integer from 1 to 4, w is an integer of 0 or 1; and
the alkyl, aryl, heteroaryl, arylamino, alkylamino, cycloalkyl or heterocycloalkyl of Ar₁₁ and Ar₁₂; the aryl, heteroaryl, arylene or heteroarylene of Ar₁₃; the arylene or heteroarylene of Ar₂₁ and Ar₂₂; or the alkyl or aryl of R₁₅₁ through R₁₅₃ may be further substituted by one or more substituent(s) selected from a group consisting of deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

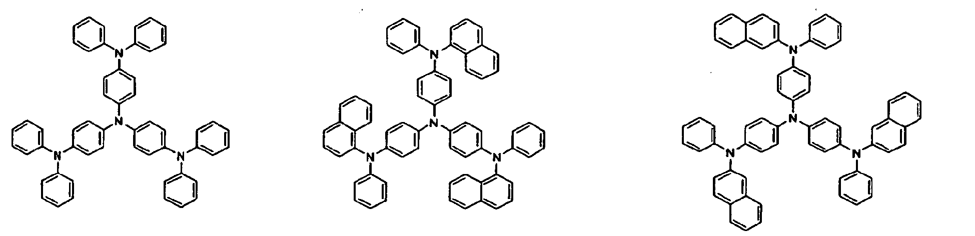

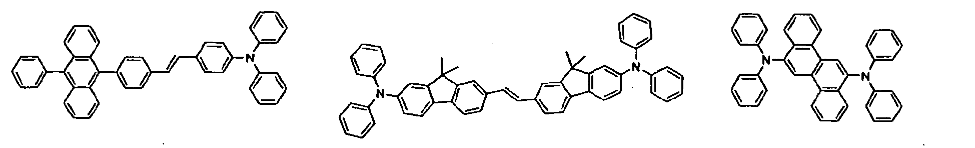

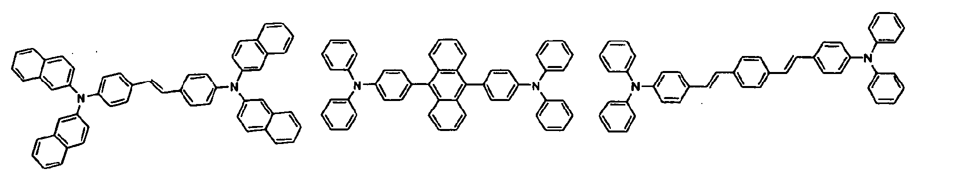

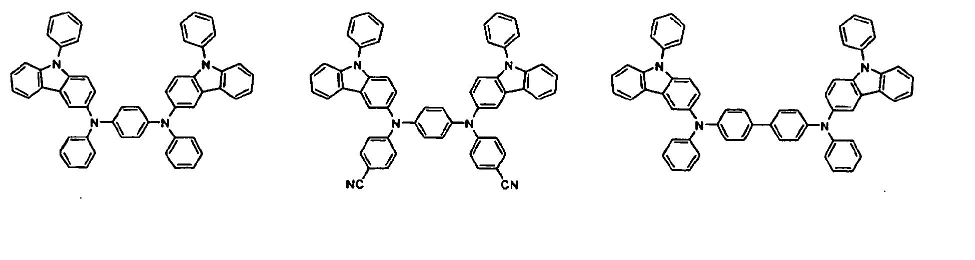

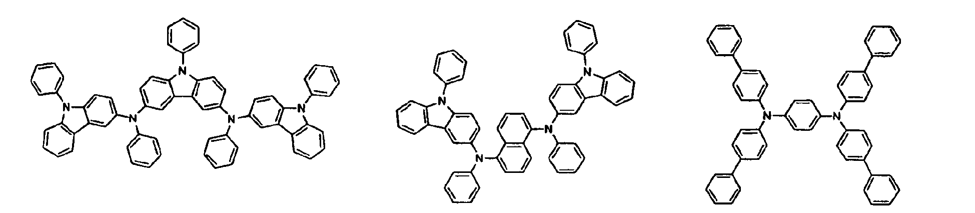

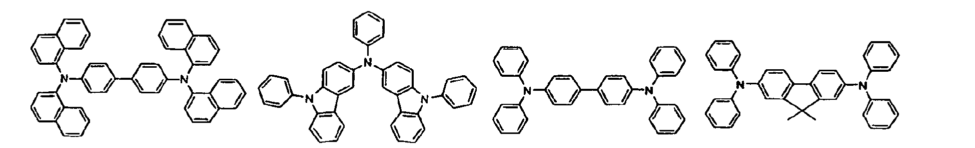

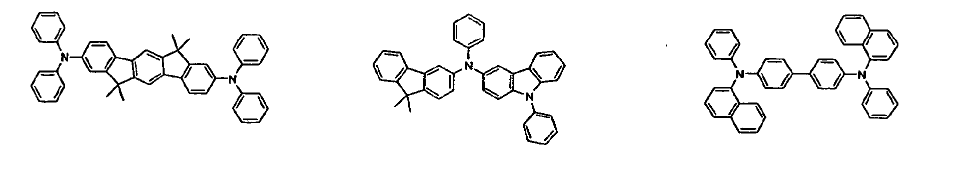

In an organic electronic device according to the present invention, the organic layer may further comprise one or more metal(s) selected from a group consisting of organometals of Group 1, Group 2, 4^{th} period and 5^{th} period transition metals, lanthanide metals and d-transition elements in the Periodic Table of Elements, as well as the organic compounds for electronic material represented by Chemical Formula (1). The organic layer may comprise a charge generating layer in addition to the electroluminescent layer.

The present invention can realize an organic electronic device having a pixel structure of independent light-emitting mode, which comprises an organic electronic device containing the compound of Chemical Formula (1) as a sub-pixel and one or more sub-pixel(s) comprising one or more compound(s) selected from a group consisting of arylamine compounds and styrylarylamine compounds, patterned in parallel at the same time.

Further, the organic electronic device may comprise, in addition to the organic compound for electronic material, organic or organometallic compound(s) with green or blue electroluminescence, which can be exemplified the compounds represented by one of Chemical Formulas (19) to (23).

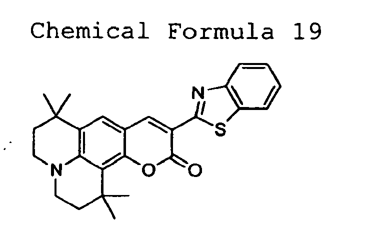

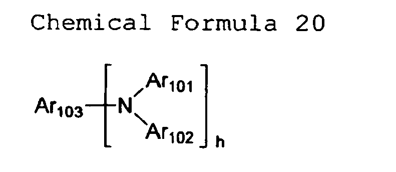

In Chemical Formula (20), Ar₁₀₁ and Ar₁₀₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₁₀₁ and Ar₁₀₂ may be linked via (C3-C60)alkylene or (C3-C60)alkenylene with or without a fused ring to form an alicyclic ring, or a monocyclic or polycyclic aromatic ring;
when h is 1, Ar₁₀₃ represents (C6-C60) aryl, (C4-C60)heteroaryl, or a substituent represented by one of the following structural formulas: 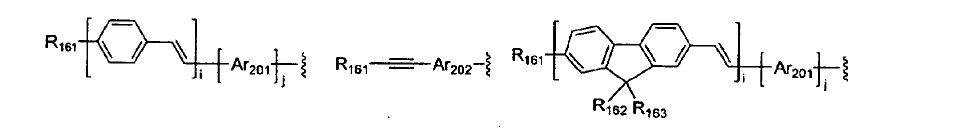 when h is 2, Ar₁₀₃ represents (C6-C60)arylene, (C4-C60)heteroarylene, or a substituent represented by one of the following structural formulas: 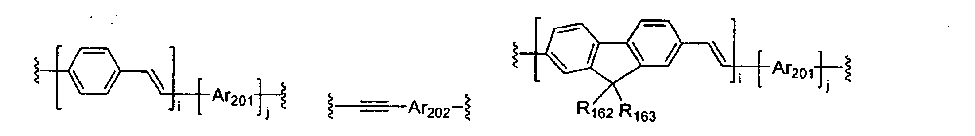 wherein Ar₂₀₁ and Ar₂₀₂ independently represent (C6-C60)arylene or (C4-C60)heteroarylene;
R₁₆₁ through R₁₆₃ independently represent hydrogen, deuterium, (C1-C60)alkyl or (C6-C60)aryl;
i is an integer from 1 to 4, j is an integer of 0 or 1; and
the alkyl, aryl, heteroaryl, arylamino, alkylamino, cycloalkyl or heterocycloalkyl of Ar₁₀₁ and Ar₁₀₂; the aryl, heteroaryl, arylene or heteroarylene of Ar₁₀₃; the arylene or heteroarylene of Ar₂₀₁ and Ar₂₀₂; or the alkyl or aryl of R₁₆₁ through R₁₆₃ may be further substituted by one or more substituent(s) selected from a group consisting of deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkilcarbonyl, (C6-C60)arylcarbonyl, carboxyl, nitro and hydroxyl.

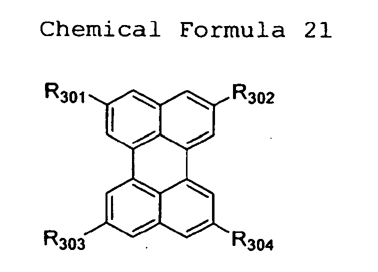

In Chemical Formula (21), R₃₀₁ through R₃₀₄ independently represents hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

(Ar₃₀₁)ₚ-L₁₁-(Ar₃₀₂)_{q} Chemical Formula 22

(Ar₃₀₃)ᵣ-L₁₂-(Ar₃₀₄)ₛ Chemical Formula 23

In Chemical Formulas (22) and (23),
L₁₁ represents (C6-C60)arylene or (C4-C60)heteroarylene;
L₁₂ represents anthracenylene;
Ar₃₀₁ through Ar₃₀₄ are independently selected from hydrogen, deuterium, (C1-C60)alkyl, (C1-C60)alkoxy, halogen, (C4-C60)heteroaryl, (C5-C60)cycloalkyl and (C6-C60)aryl: the cycloalkyl, aryl or heteroaryl of Ar₃₀₁ through Ar₃₀₄ may be further substituted by one or more substituent(s) selected from a group consisting of (C6-C60)aryl or (C4-C60)heteroaryl with or without one or more substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
p, q, r and s independently represent an integer from 0 to 4.

The compounds represented by Chemical Formula (22) or (23) can be exemplified by anthracene derivatives or benz[a]anthracene derivatives represented by one of Chemical Formulas (24) to (26):

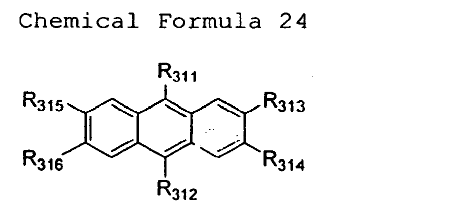

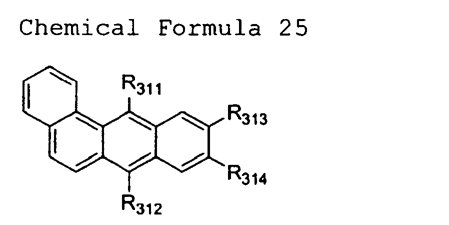

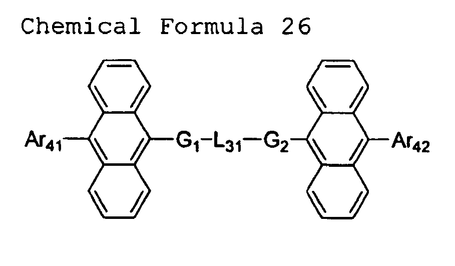

In Chemical Formulas (24) through (26),
R₃₁₁ and R₃₁₂ independently represent (C6-C60) aryl, (C4-C60)heteroaryl, 5- or 6-membered heterocycloalkyl containing one or more heteroatom(s) selected from N, O and S, or (C3-C60) cycloalkyl; the aryl or heteroaryl of R₃₁₁ and R₃₁₂ may be further substituted by one or more substituent(s) selected from a group consisting of deuterium, (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₃₁₃ through R₃₁₆ independently represent hydrogen, deuterium, (C1-C60)alkyl, (C1-C50)alkoxy, halogen, (C4-C60)heteroaryl, (C5-C60)cycloalkyl or (C6-C60)aryl, and the heteroaryl, cycloalkyl or aryl of R₃₁₃ through R₃₁₆ may be further substituted by one or more substituent(s) selected from a group consisting of deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond, or (C6-C60)arylene with or without one or more substituent(s) selected from (C1-C60)alkyl, (C1-C60)alkoxy, (C6-C60)aryl, (C4-C60)heteroaryl and halogen;
Ar₄₁ and Ar₄₂ represent (C4-C60)heteroaryl or aryl selected from the following structures: 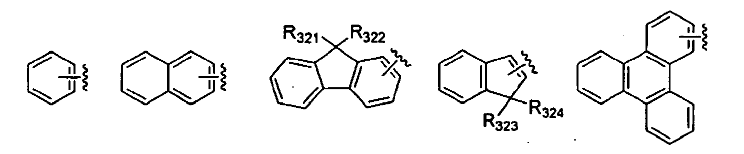 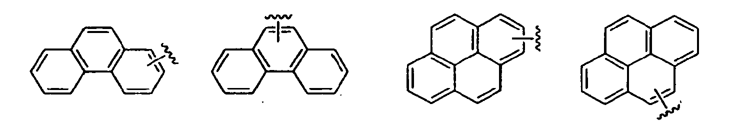 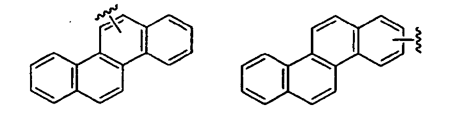 the aryl or heteroaryl of Ar₄₁ and Ar₄₂ may be substituted by one or more substituent(s) selected from deuterium, (C1-C60)alkyl, (C1-C60)alkoxy, (C6-C60)aryl and (C9-C60)heteroaryl;
L₃₁ represents (C6-C60)arylene, (C4-C60)heteroarylene or a compound represented by the following structural formula: 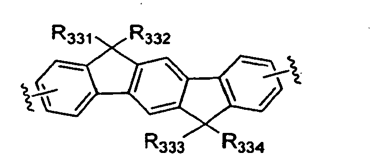 the arylene or heteroarylene of L₃₁ may be substituted by one or more substituent(s) selected from deuterium, (C1-C60)alkyl, (C1-C60)alkoxy, (C6-C60)aryl, (C4-C60)heteroaryl and halogen;
R₃₂₁ through R₃₂₄ independently represent hydrogen, deuterium, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring; and
R₃₃₁ through R₃₃₄ independently represent hydrogen, deuterium, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

The organic compounds and organometallic compounds with green or blue electroluminescence can be more specifically exemplified by the following compounds, but they are not restricted thereto.

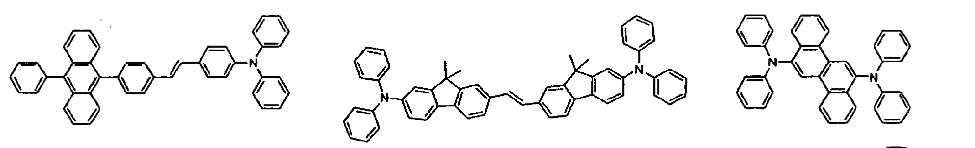

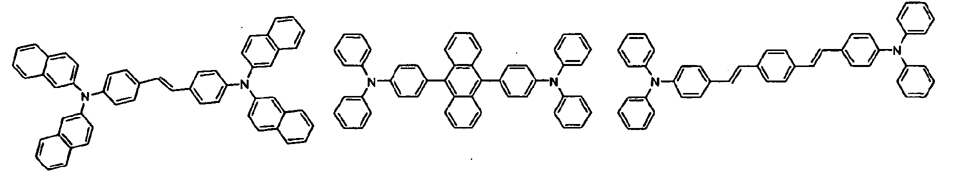

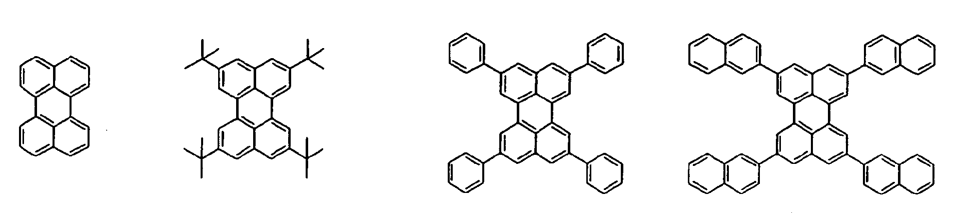

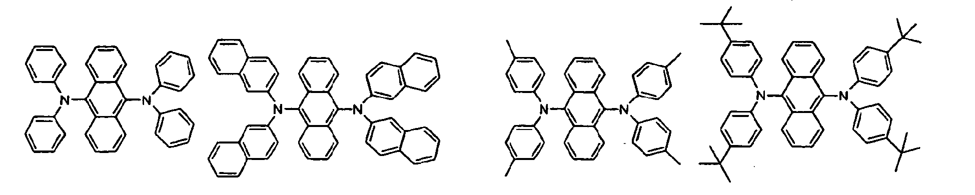

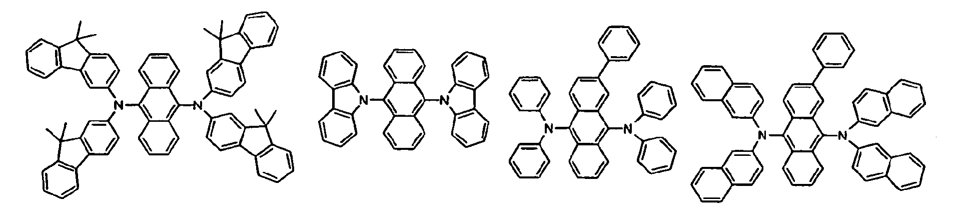

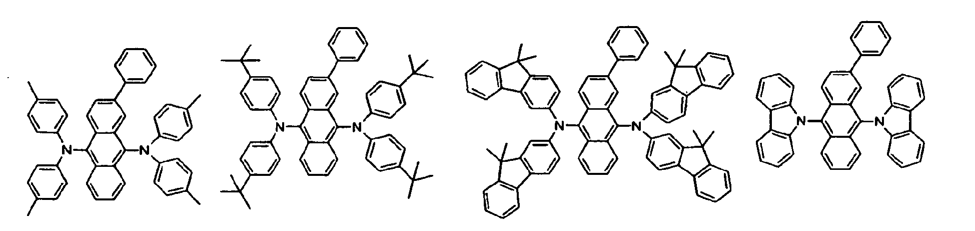

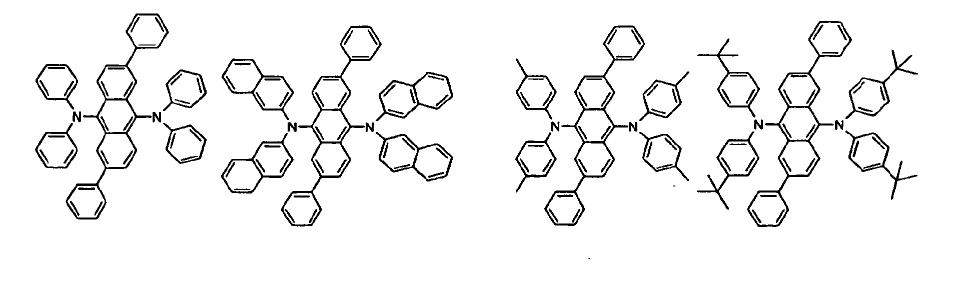

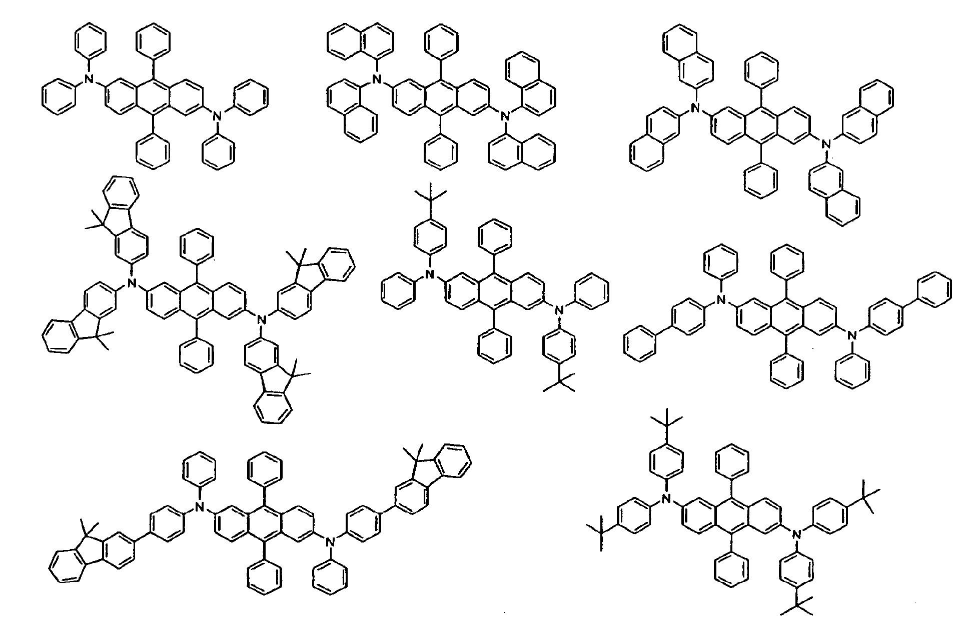

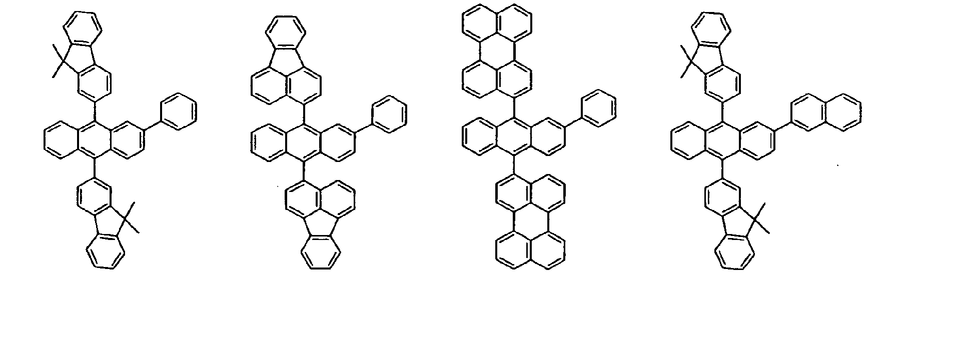

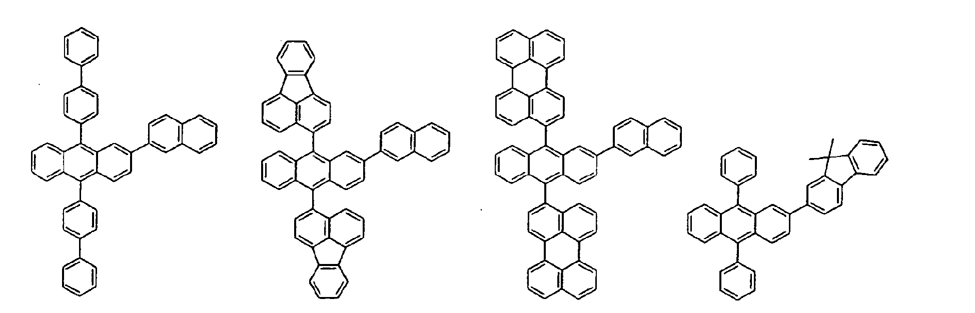

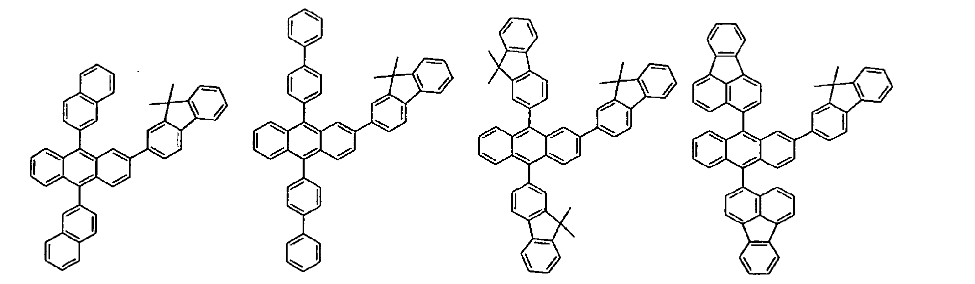

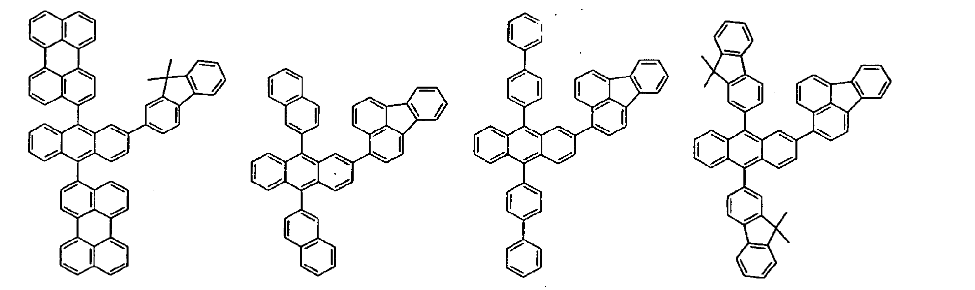

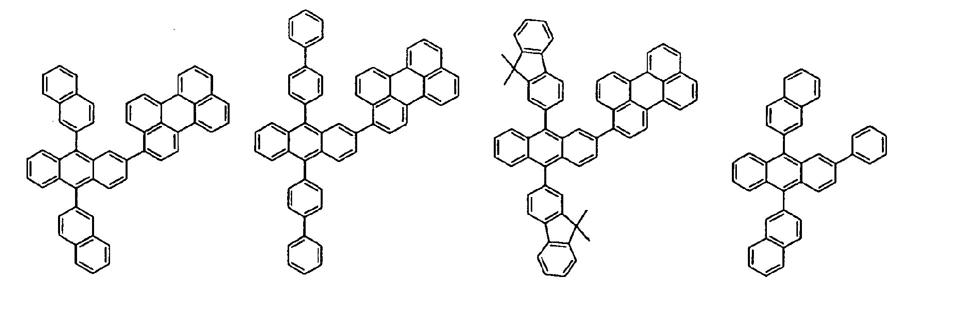

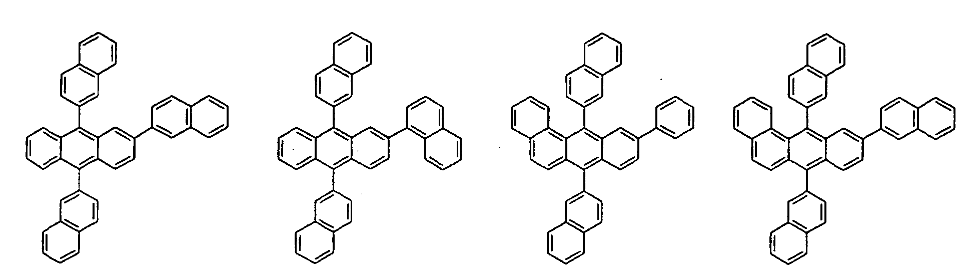

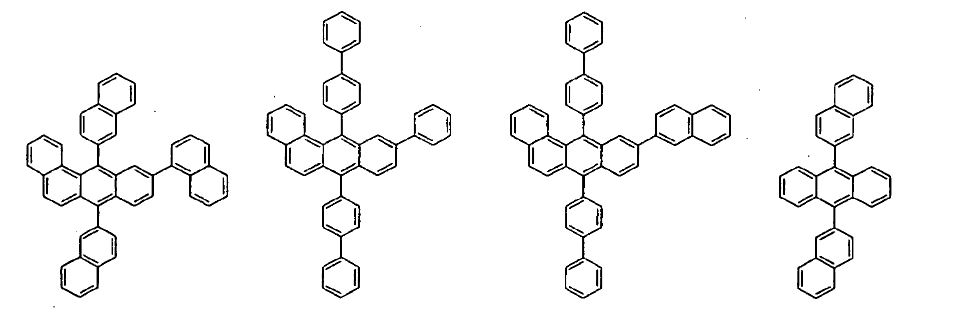

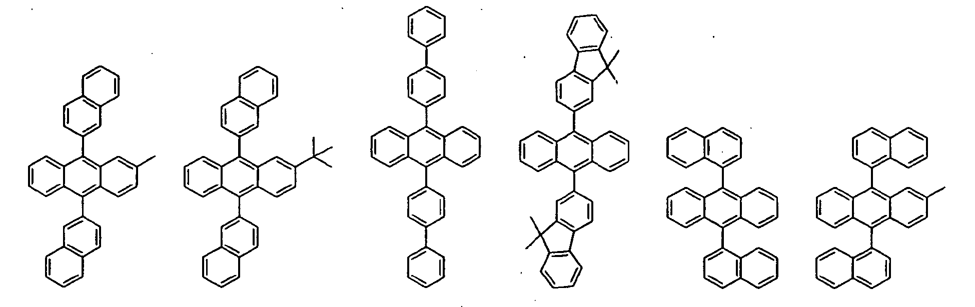

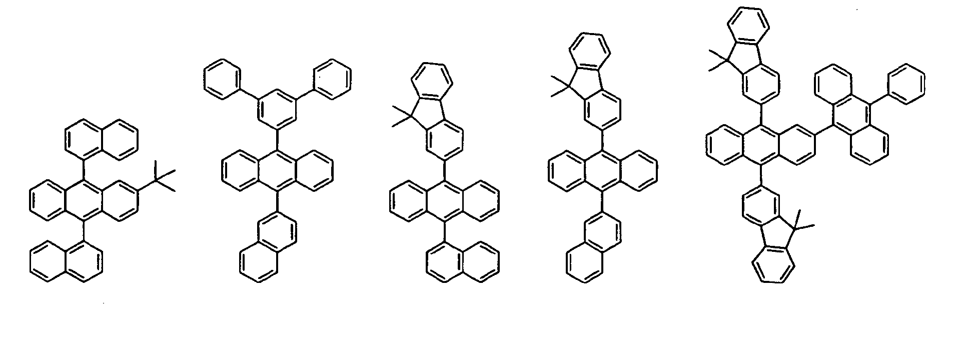

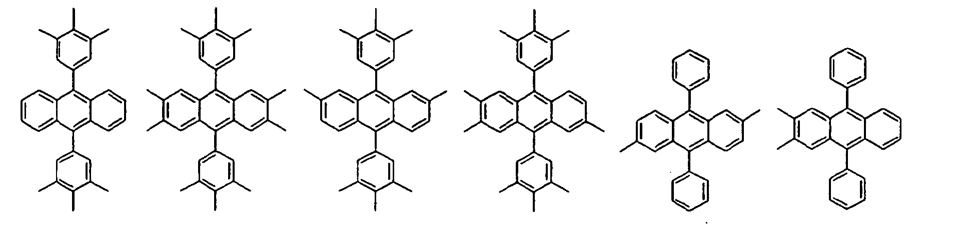

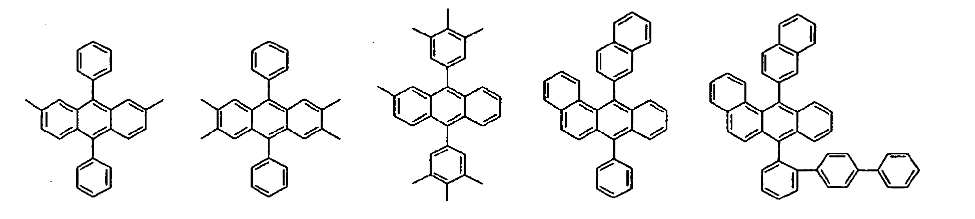

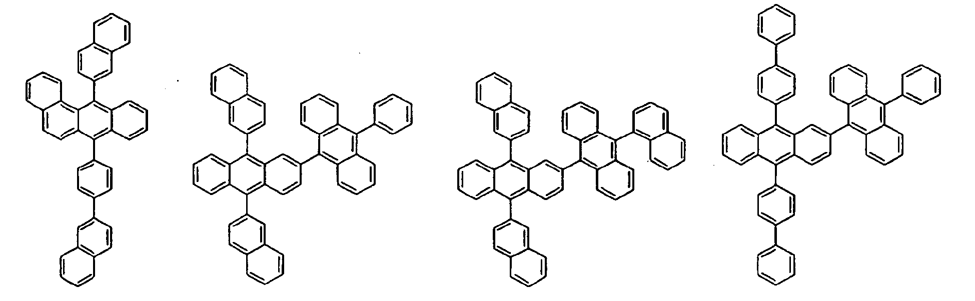

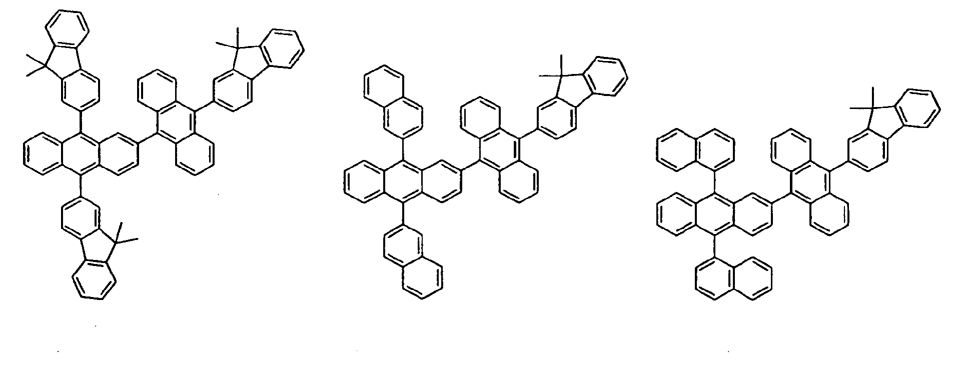

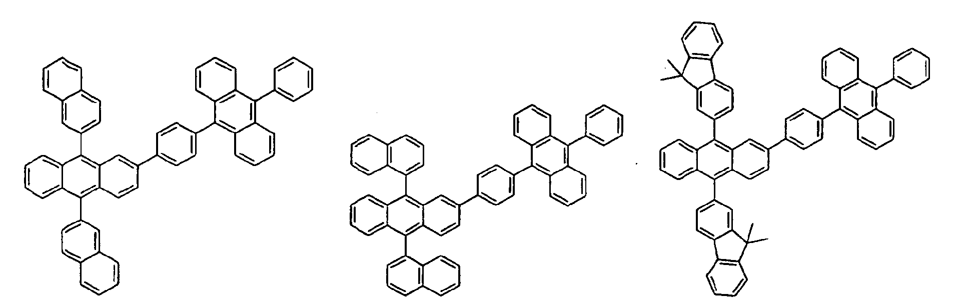

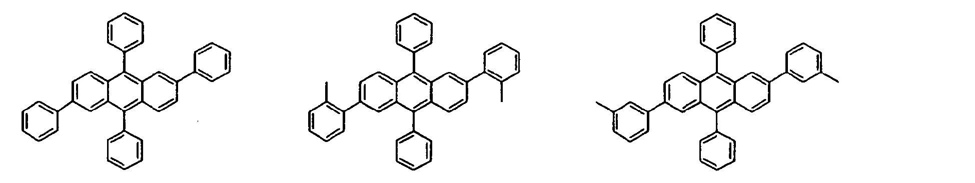

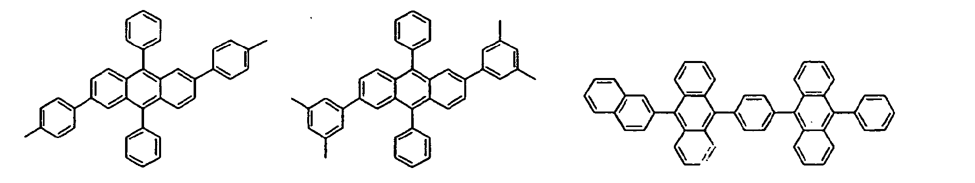

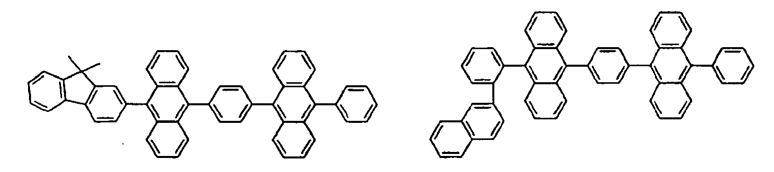

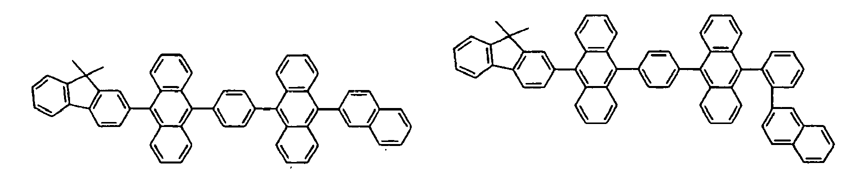

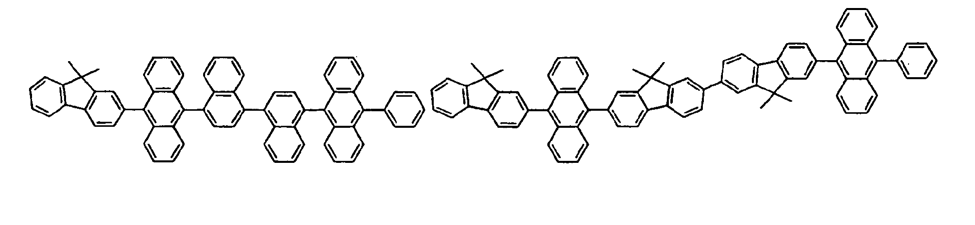

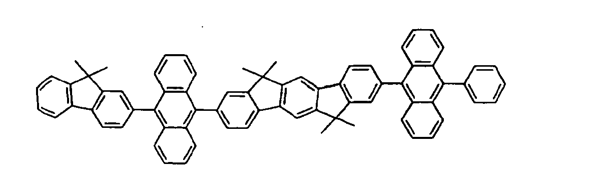

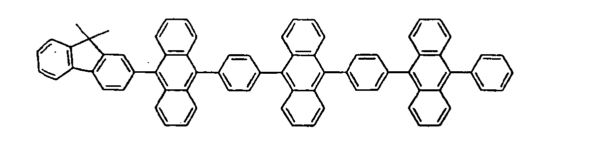

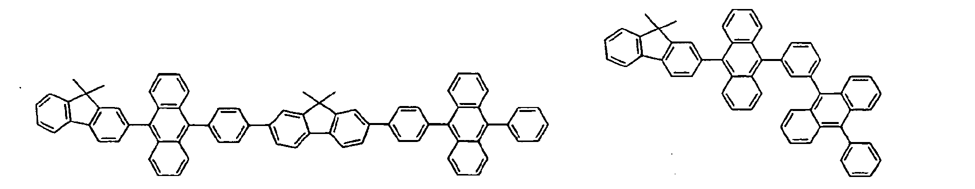

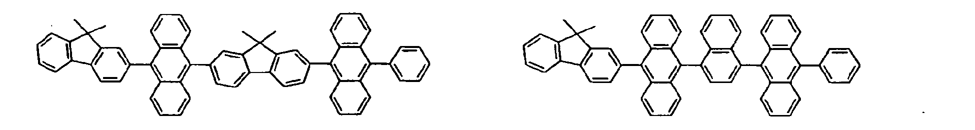

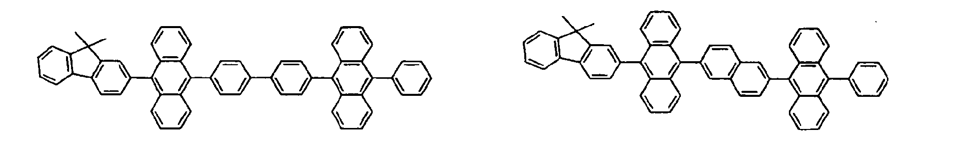

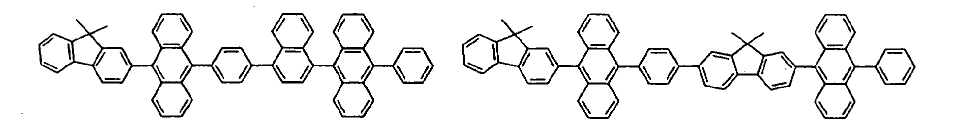

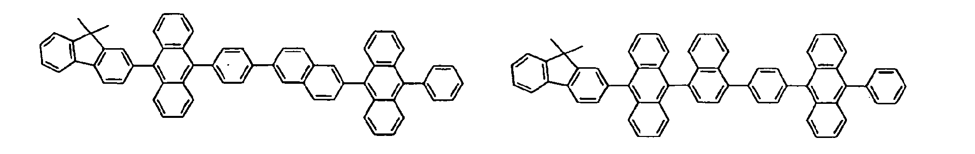

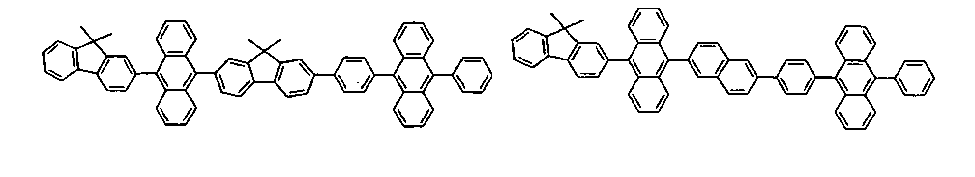

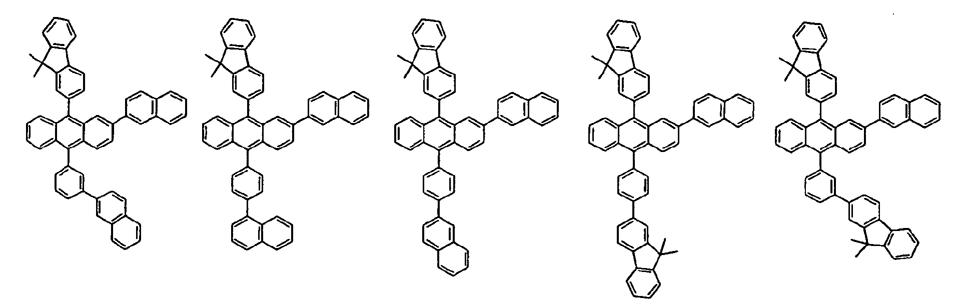

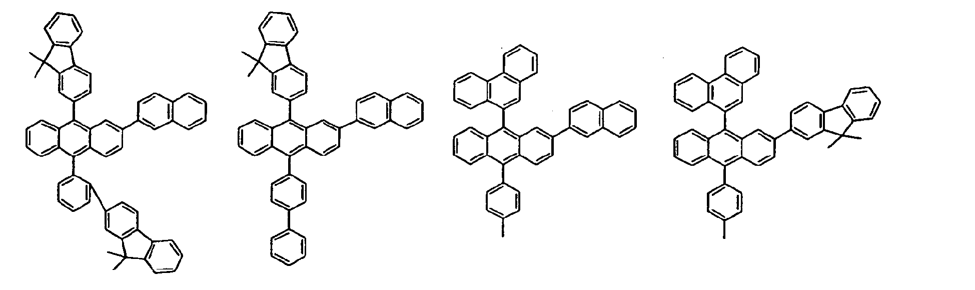

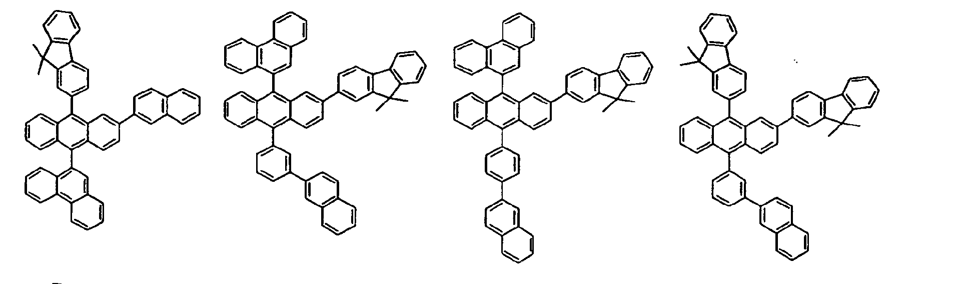

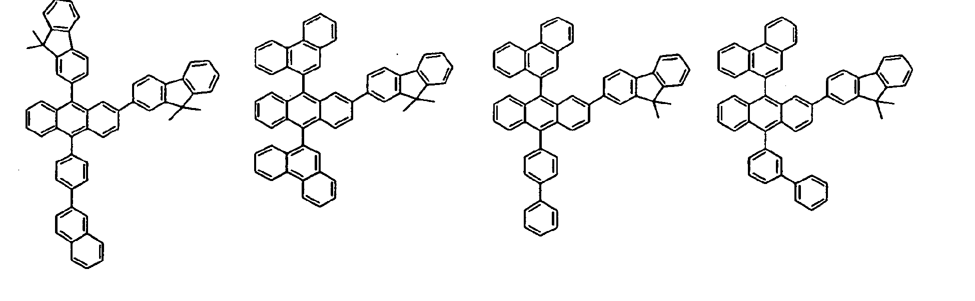

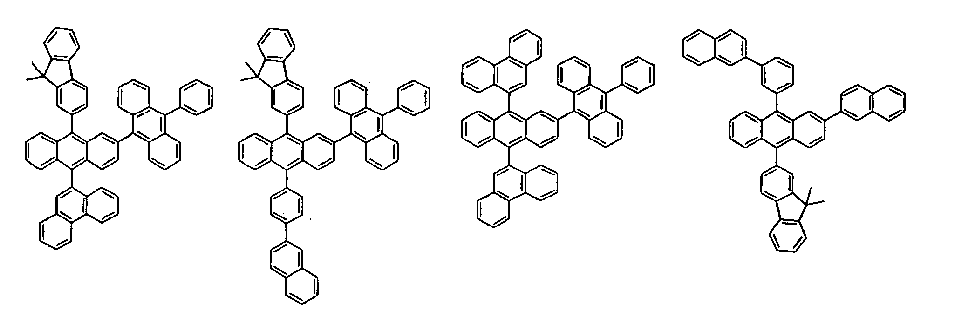

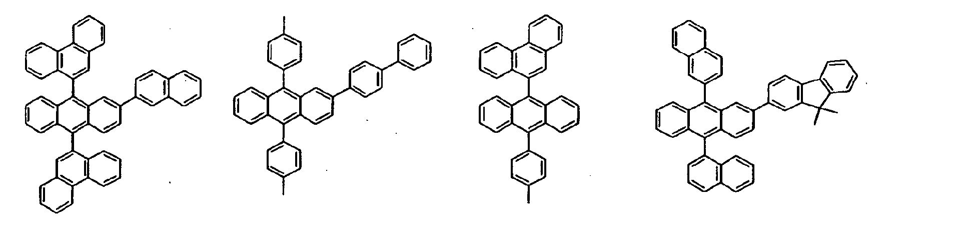

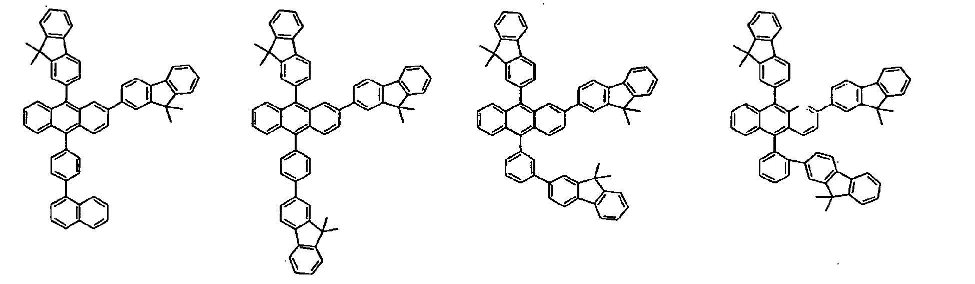

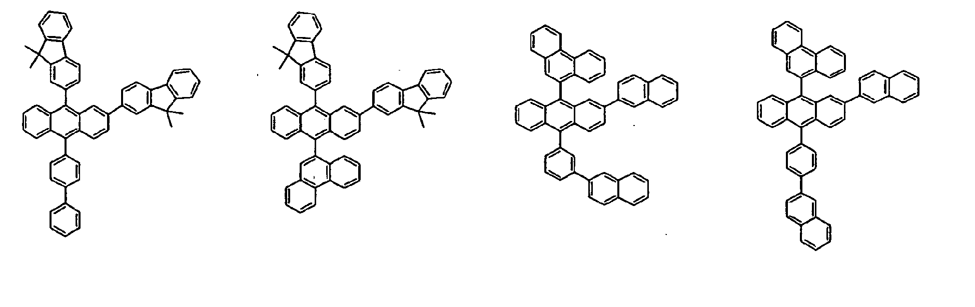

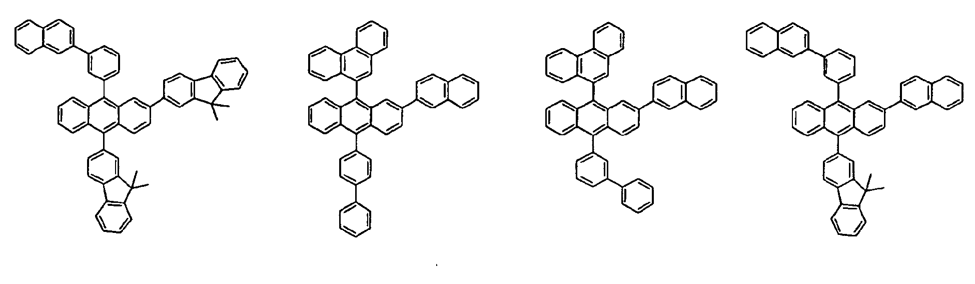

In an organic electronic device according to the present invention, it is preferable to place one or more layer(s) (herein-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metal, or the like. Examples of metal oxides preferably include Cs₂O, Li₂O, MgO, SrO, BaO, CaO, or the like.

In an organic electronic device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The compounds for electronic material according to the invention have the backbone to provide higher electroluminescent properties and better thermal stability with higher quantum efficiency and lowered operation voltage than those of conventional phosphorescent material. Thus, it is expected that applying the compounds for electronic material according to the invention to OLED panels would provide one step forward development of medium or large sized OLED's. Further, it is anticipated that organic solar cells employing those compounds as a material of high efficiency would exhibit far better properties as compared to those employing conventional materials.

### Best Mode

The present invention is further described with respect to the representative compounds of the invention, by describing the organic compounds for electronic material, the processes for preparing the same, and luminescent properties of the device manufactured therefrom in the Examples below, which are provided for illustration of the embodiments only but are not intended to limit the scope of the invention by any means.

### Preparation Examples

### [Preparation Example 1] Preparation of Compound (2)

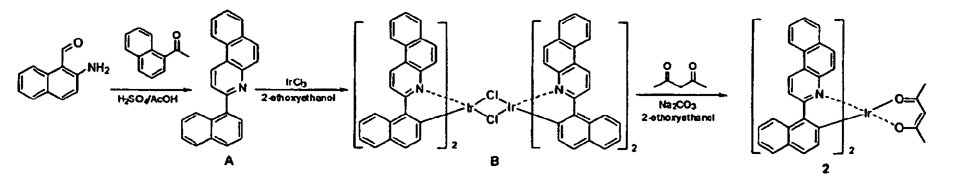

### Preparation of Compound (A)

A reaction vessel was charged with 2-aminonaphthalen-1-aldehyde (5.0 g, 29.2 mmol), 1-acetonaphthalene (4.1 mL, 35.1 mmol), potassium hydroxide (3.3 g, 58.4 mmol) and ethanol (100 mL), and the mixture was stirred under reflux in the presence of argon atmosphere. When the reaction was completed, the reaction mixture was cooled to room temperature, and an excess amount of aqueous ammonium hydroxide solution was added thereto. The mixture was extracted with chloromethane, and the extract was filtered under reduced pressure. Purification via column chromatography gave Compound (A) (4.8 g, 64%).

### Preparation of Compound (B)

Compound (A) (4.0 g, 15.7 mmol) and iridium chloride (2.1 g, 7.1 mmol) were dissolved in 2-ethoxyethanol (38 mL) and distilled water (13 mL), and the solution was stirred under reflux in the presence of argon atmosphere for 24 hours. When the reaction was completed, the reaction mixture was cooled to room temperature. Solid precipitate thus produced was filtered and dried to obtain Compound (B) (8.9 g, 85%).

### Preparation of Compound (2)

Compound (B) (8.0 g, 5.4 mmol), 2,4-pentanedione (1.7 mL, 16.3 mmol) and sodium carbonate (3.5 g, 32.6 mmol) were dissolved in 2-ethoxyethanol (100 mL), and the solution was heated for 4 hours. When the reaction was completed, the reaction mixture was cooled to room temperature, and the solid precipitate thus produced was filtered. Purification via silica gel column chromatography and recrystallization gave Compound (2) (1.5 g, 35%) as red crystal.

### [Preparation Example 2] Preparation of Compound (21)

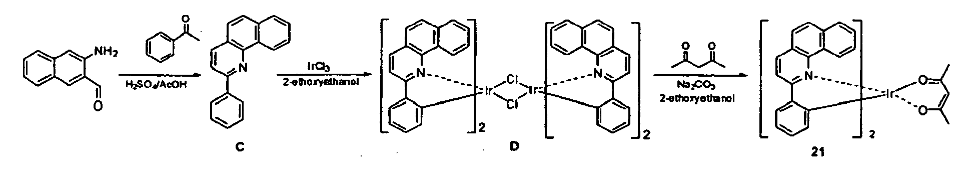

### Preparation of Compound (C)

A reaction vessel was charged with 2-aminonaphthalen-3-aldehyde (5.0 g, 29.2 mmol), acetophenone (4.1 mL, 35.1 mmol), potassium hydroxide (3.3 g, 58.4 mmol) and ethanol (100 mL), and the mixture was stirred under reflux in the presence of argon atmosphere. When the reaction was completed, the reaction mixture was cooled to room temperature, and an excess amount of aqueous ammonium hydroxide solution was added thereto. The mixture was extracted with chloromethane, and the extract was filtered under reduced pressure. Purification via column chromatography gave Compound (C) (4.8 g, 64%).

### Preparation of Compound (D)

Compound (C) (4.0 g, 15.7 mmol) and iridium chloride (2.1 g, 7.1 mmol) were dissolved in 2-ethoxyethanol (38 mL) and distilled water (13 mL), and the solution was stirred under reflux in the presence of argon atmosphere for 24 hours. When the reaction was completed, the reaction mixture was cooled to room temperature. Solid precipitate thus produced was filtered and dried to obtain Compound (D) (8.9 g, 85%).

### Preparation of Compound (21)

Compound (D) (8.0 g, 5.4 mmol), 2,4-pentanedione (1.7 mL, 16.3 mmol) and sodium carbonate (3.5 g, 32.6 mmol) were dissolved in 2-ethoxyethanol (100 mL), and the solution was heated for 4 hours. When the reaction was completed, the reaction mixture was cooled to room temperature, and the solid precipitate thus produced was filtered. Purification via silica gel column chromatography and recrystallization gave Compound (21) (1.5 g, 35%) as red crystal.

### [Preparation Example 3] Preparation of Compound (75)

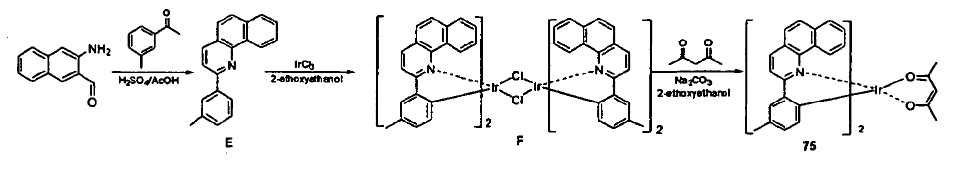

### Preparation of Compound (E)

A reaction vessel was charged with 2-aminonaphthalen-3-aldehyde (5.0 g, 29.2 mmol), 3-methylacetophenone (4.1 mL, 35.1 mmol), potassium hydroxide (3.3 g, 58.4 mmol) and ethanol (100 mL), and the mixture was stirred under reflux in the presence of argon atmosphere. When the reaction was completed, the reaction mixture was cooled to room temperature, and an excess amount of aqueous ammonium hydroxide solution was added thereto. The mixture was extracted with chloromethane, and the extract was filtered under reduced pressure. Purification via column chromatography gave Compound (E) (4.8 g, 64%).

### Preparation of Compound (F)

Compound (E) (4.0 g, 15.7 mmol) and iridium chloride (2.1 g, 7.1 mmol) were dissolved in 2-ethoxyethanol (38 mL) and distilled water (13 mL), and the solution was stirred under reflux in the presence of argon atmosphere for 24 hours. When the reaction was completed, the reaction mixture was cooled to room temperature. Solid precipitate thus produced was filtered and dried to obtain Compound (F) (8.9 g, 85%).

### Preparation of Compound (75)

Compound (F) (8.0 g, 5.4 mmol), 2,4-pentanedione (1.7 mL, 16.3 mmol) and sodium carbonate (3.5 g, 32.6 mmol) were dissolved in 2-ethoxyethanol (100 mL), and the solution was heated for 4 hours. When the reaction was completed, the reaction mixture was cooled to room temperature, and the solid precipitate thus produced was filtered. Purification via silica gel column chromatography and recrystallization gave Compound (75) (1.5 g, 35%) as red crystal.

### [Preparation Example 4] Preparation of Compound (1044)

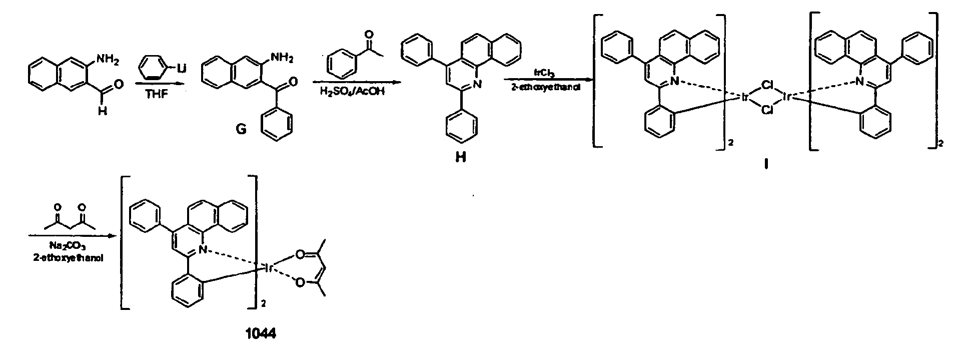

### Preparation of Compound (G)

In THF (50 mL), dissolved was 2-aminonaphthalene-3-carbaldehyde (1.0 g, 5.4 mmol), and the solution was chilled to 0°C. After slowly adding phenyl lithium (11.9 mL, 21.4 mmol) thereto, the mixture was stirred for 2 hours. The reaction was quenched by adding aqueous ammonium chloride solution. The mixture was then extracted with diethyl ether, and the extract was filtered under reduced pressure. Purification via column chromatography gave Compound (G) (0.79 g, 60%).

### Preparation of Compound (H)

A reaction vessel was charged with Compound (G) (1.29 g, 5.24 mmol), 1-methylacetophenone (0.55 mL, 4.76 mmol), glacial acetic acid (7.13 mL) and sulfuric acid (0.04 mL), and the mixture was stirred under reflux in the presence of argon atmosphere. When the reaction was completed, the reaction mixture was cooled to room temperature, and an excess amount of aqueous ammonium hydroxide solution was added thereto. Solid thus produced was filtered, washed with distilled water. Purification via column chromatography gave Compound (H) (1.27 g, 80%).

### Preparation of Compound (I)

Compound (H) (0.6 g, 1.81 mmol) and iridium chloride (0.25 g, 0.82 mmol) were dissolved in 2-ethoxyethanol (9 mL) and distilled water (3 mL), and the solution was stirred under reflux in the presence of argon atmosphere for 24 hours. When the reaction was completed, the reaction mixture was cooled to room temperature. Solid precipitate thus produced was filtered and dried to obtain Compound (I) (0.37 g, 11%).

### Preparation of Compound (1044)

Compound (I) (0.37 g, 0.21 mmol), 2,4-pentanedione (0.06 mL, 0.62 mmol) and sodium carbonate (0.13 g, 1.25 mmol) were dissolved in 2-ethoxyethanol (10 mL), and the solution was heated for 4 hours. When the reaction was completed, the reaction mixture was cooled to room temperature, and the solid precipitate thus produced was filtered. Purification via column chromatography and recrystallization gave Compound (1044) (0.14 g, 37%) as red crystal.

### [Preparation Example 5] Preparation of Compound (1446)

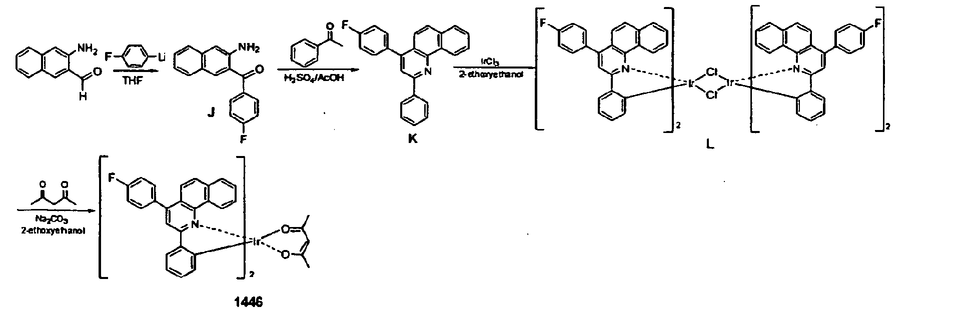

### Preparation of Compound (J)

In THF (50 mL), dissolved was 2-aminonaphthalene-3-carbaldehyde (1.0 g, 5.4 mmol), and the solution was chilled to 0°C. After slowly adding 4-fluorophenyllithium (11.9 mL, 21.4 mmol) thereto, the mixture was stirred for 2 hours. The reaction was quenched by adding aqueous ammonium chloride solution. The mixture was then extracted with diethyl ether, and the extract was filtered under reduced pressure. Purification via column chromatography gave Compound (J) (0.79 g, 60%).

### Preparation of Compound (K)

A reaction vessel was charged with Compound (J) (1.29 g, 5.24 mmol), 1-methylacetophenone (0.55 mL, 4.76 mmol), acetic acid (7.13 mL) and sulfuric acid (0.04 mL), and the mixture was stirred under reflux in the presence of argon atmosphere. When the reaction was completed, the reaction mixture was cooled to room temperature, and an excess amount of aqueous ammonium hydroxide solution was added thereto. Solid thus produced was filtered, washed with distilled water. Purification via column chromatography gave Compound (K) (1.27 g, 80%).

### Preparation of Compound (L)

Compound (K) (0.6 g, 1.81 mmol) and iridium chloride (0.25 g, 0.82 mmol) were dissolved in 2-ethoxyethanol (9 mL) and distilled water (3 mL), and the solution was stirred under reflux in the presence of argon atmosphere for 24 hours. When the reaction was completed, the reaction mixture was cooled to room temperature. Solid precipitate thus produced was filtered and dried to obtain Compound (L) (0.37 g, 11%).

### Preparation of Compound (1446)

Compound (L) (0.37 g, 0.21 mmol), 2,4-pentanedione (0.06 mL, 0.62 mmol) and sodium carbonate (0.13 g, 1.25 mmol) were dissolved in 2-ethoxyethanol (10 mL), and the solution was heated for 4 hours. When the reaction was completed, the reaction mixture was cooled to room temperature, and the solid precipitate thus produced was filtered. Purification via silica gel column chromatography and recrystallization gave Compound (1446) (0.14 g, 37%) as red crystal.

### [Preparation Example 6] Preparation of Compound (1033)

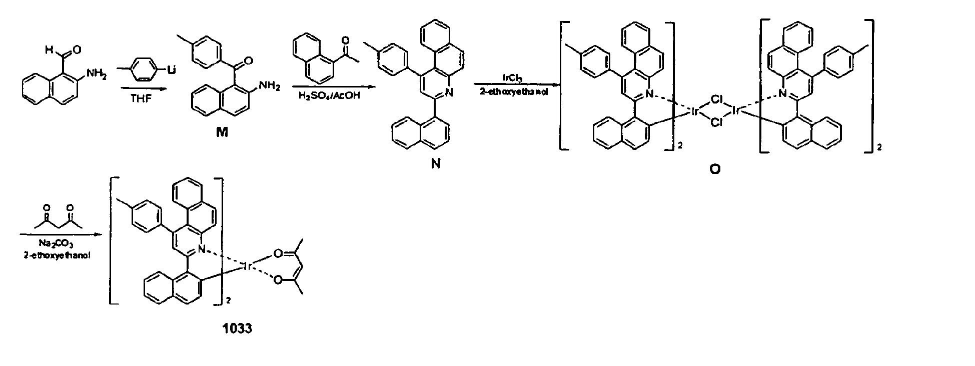

### Preparation of Compound (M)

In THF (50 mL), dissolved was 2-aminonaphthalene-1-carbaldehyde (1.0 g, 5.4 mmol), and the solution was chilled to 0°C. After slowly adding 4-methylphenyllithium (11.9 mL, 21.4 mmol) thereto, the mixture was stirred for 2 hours. The reaction was quenched by adding aqueous ammonium chloride solution. The mixture was then extracted with diethyl ether, and the extract was filtered under reduced pressure. Purification via column chromatography gave Compound (M) (0.79 g, 60%).

### Preparation of Compound (N)

A reaction vessel was charged with Compound (M) (1.29 g, 5.24 mmol), 1-methylacetophenone (0.55 mL, 4.76 mmol), glacial acetic acid (7.13 mL) and sulfuric acid (0.04 mL), and the mixture was stirred under reflux in the presence of argon atmosphere. When the reaction was completed, the reaction mixture was cooled to room temperature, and an excess amount of aqueous ammonium hydroxide solution was added thereto. Solid thus produced was filtered, washed with distilled water. Purification via column chromatography gave Compound (N) (1.27 g, 80%).

### Preparation of Compound (O)

Compound (N) (0.6 g, 1.81 mmol) and iridium chloride (0.25 g, 0.82 mmol) were dissolved in 2-ethoxyethanol (9 mL) and distilled water (3 mL), and the solution was stirred under reflux in the presence of argon atmosphere for 24 hours. When the reaction was completed, the reaction mixture was cooled to room temperature. Solid precipitate thus produced was filtered and dried to obtain Compound (O) (0.37 g, 11%).

### Preparation of Compound (1033)

Compound (O) (0.37 g, 0.21 mmol), 2,4-pentanedione (0.06 mL, 0.62 mmol) and sodium carbonate (0.13 g, 1.25 mmol) were dissolved in 2-ethoxyethanol (10 mL), and the solution was heated for 4 hours. When the reaction was completed, the reaction mixture was cooled to room temperature, and the solid precipitate thus produced was filtered. Purification via silica gel column chromatography and recrystallization gave Compound (1033) (0.14 g, 37%) as red crystal.

Organic compounds for electronic material (Compounds 1 to 20) shown in Table 1 were prepared according to the same procedure as described in Preparation Example 1; those shown in Table 2 (Compounds 21 to 1028) according to the procedure of Preparation Example 2 or 3; those shown in Table 3 (Compounds 1029 to 1043) according to the procedure of Preparation Example 6; and those shown in Table 4 (Compounds 1044 to 2060) according to the procedure of Preparation Example 4 or 5; the ¹H NMR and MS/FAB data of those compounds are shown in Table 5.

**Table 1**

| | | | | | | | | | | | |
|---|---|---|---|---|---|---|---|---|---|---|---|
| 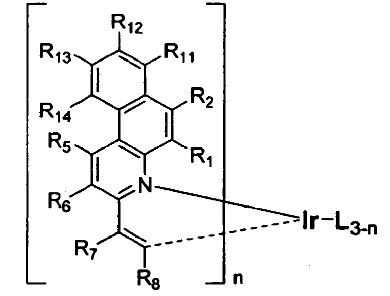 | | | | | | | | | | | |

| Compound No. | R₁ | R₂ | R₁₁ | R₁₂ | R₁₃ | R₁₄ | R₅ | R₆ | 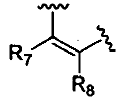 | L | n |
|---|---|---|---|---|---|---|---|---|---|---|---|
| 1 | H | H | H | H | H | H | H | H | 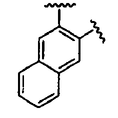 | 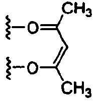 | 2 |
| 2 | H | H | H | H | H | H | H | H | 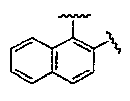 | 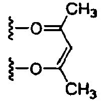 | 2 |
| 3 | H | H | H | H | H | H | H | H | 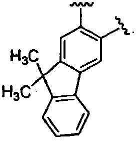 | 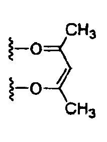 | 2 |
| 4 | H | H | H | H | H | H | H | H | 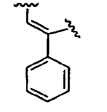 | 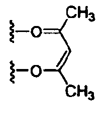 | 2 |
| 5 | H | H | H | H | H | H | -CH₃ | H | 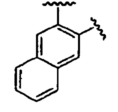 | 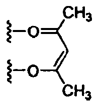 | 2 |
| 6 | H | H | H | H | H | H | -CH₃ | H | 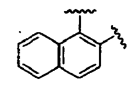 | 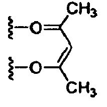 | 2 |
| 7 | H | H | H | H | H | H | -CH₃ | H | 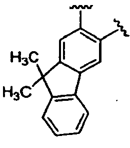 | 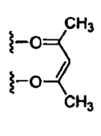 | 2 |
| 8 | H | H | H | H | H | H | -CH₃ | H | 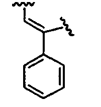 | 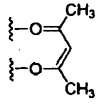 | 2 |
| 9 | H | H | H | H | H | H | F | H | 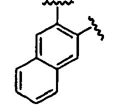 | 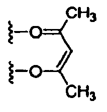 | 2 |
| 10 | H | H | H | H | H | H | F | H | 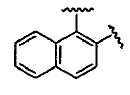 | 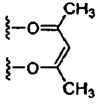 | 2 |
| 11 | H | H | H | H | H | H | F | H | 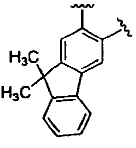 | 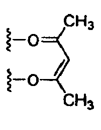 | 2 |
| 12 | H | H | H | H | H | H | F | H | 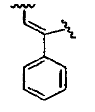 | 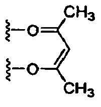 | 2 |
| 13 | H | H | H | H | H | H | -C(CH₃)₃ | H | 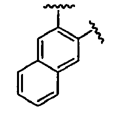 | 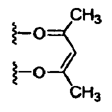 | 2 |
| 14 | H | H | H | H | H | H | -C(CH₃)₃ | H | 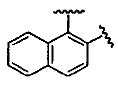 | 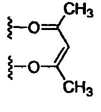 | 2 |
| 15 | H | H | H | H | H | H | -C(CH₃)₃ | H | 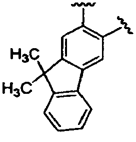 | 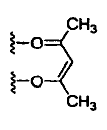 | 2 |
| 16 | H | H | H | H | H | H | -C(CH₃)₃ | H | 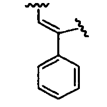 | 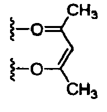 | 2 |
| 17 | H | H | H | H | H | H | -Si (CH₃) ₃ | H | 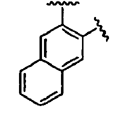 | 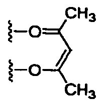 | 2 |
| 18 | H | H | H | H | H | H | -Si (CH₃) ₃ | H | 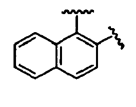 | 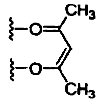 | 2 |
| 19 | H | H | H | H | H | H | -Si (CH₃) ₃ | H | 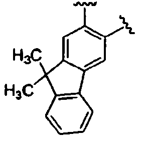 | 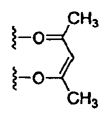 | 2 |
| 20 | H | H | H | H | H | H | -Si (CH₃) ₃ | H | 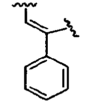 | 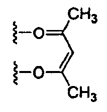 | 2 |

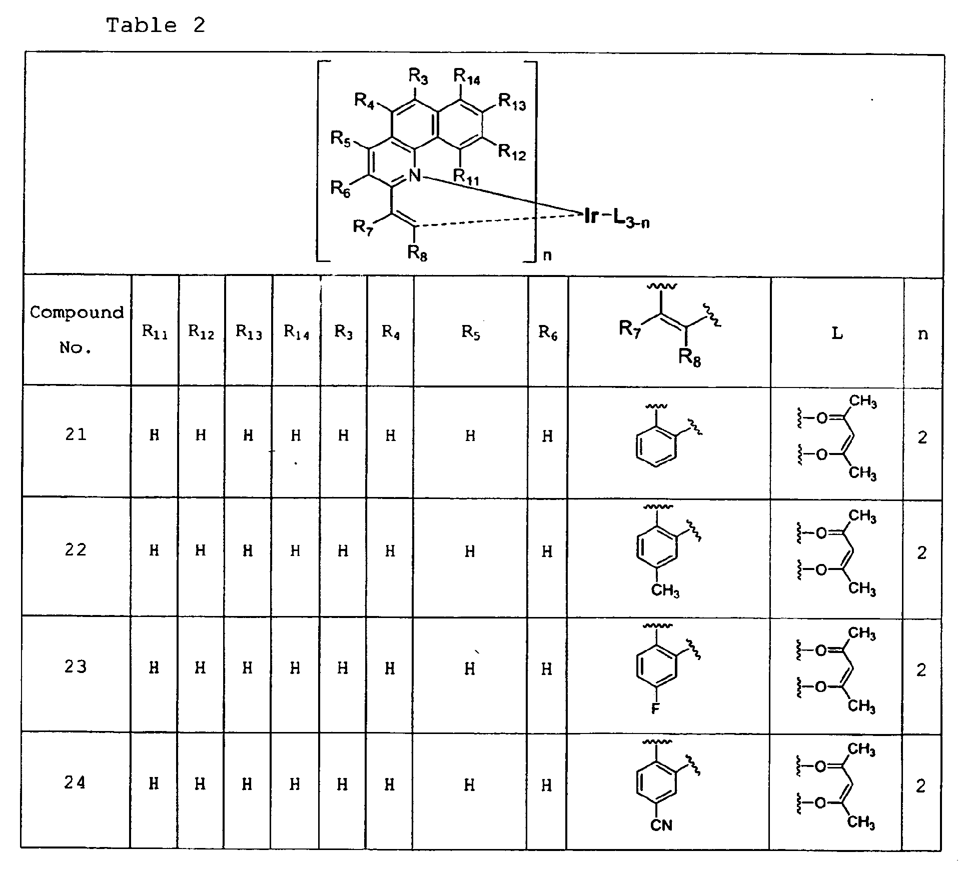

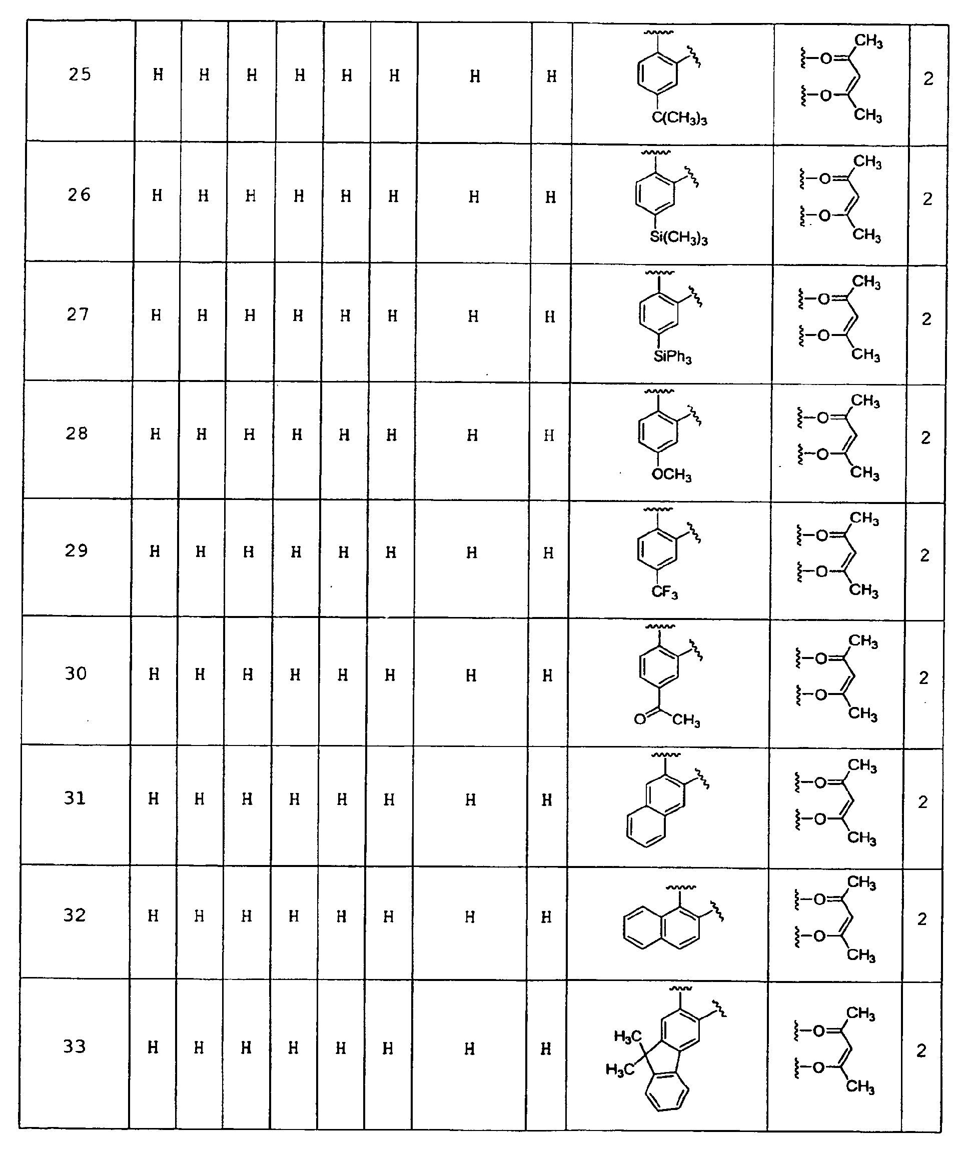

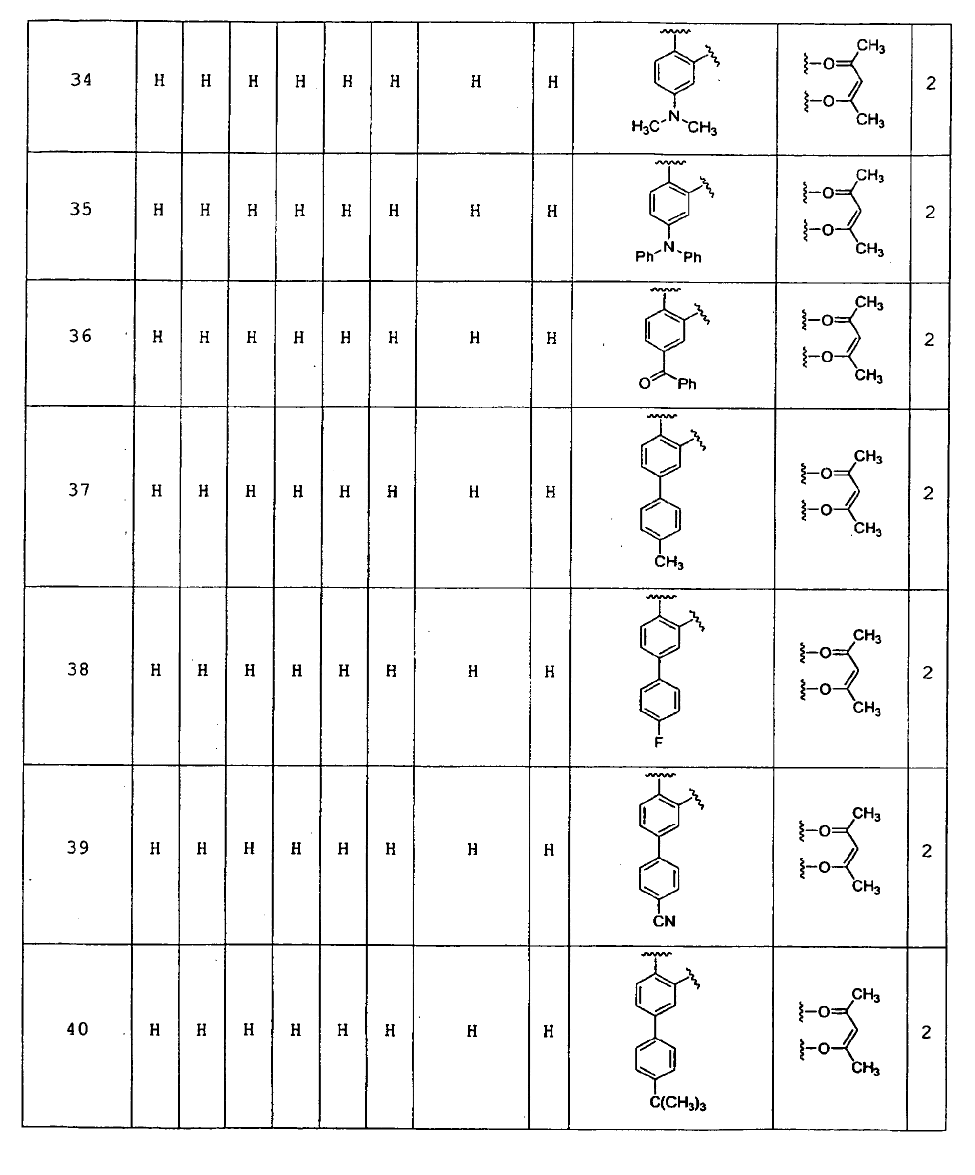

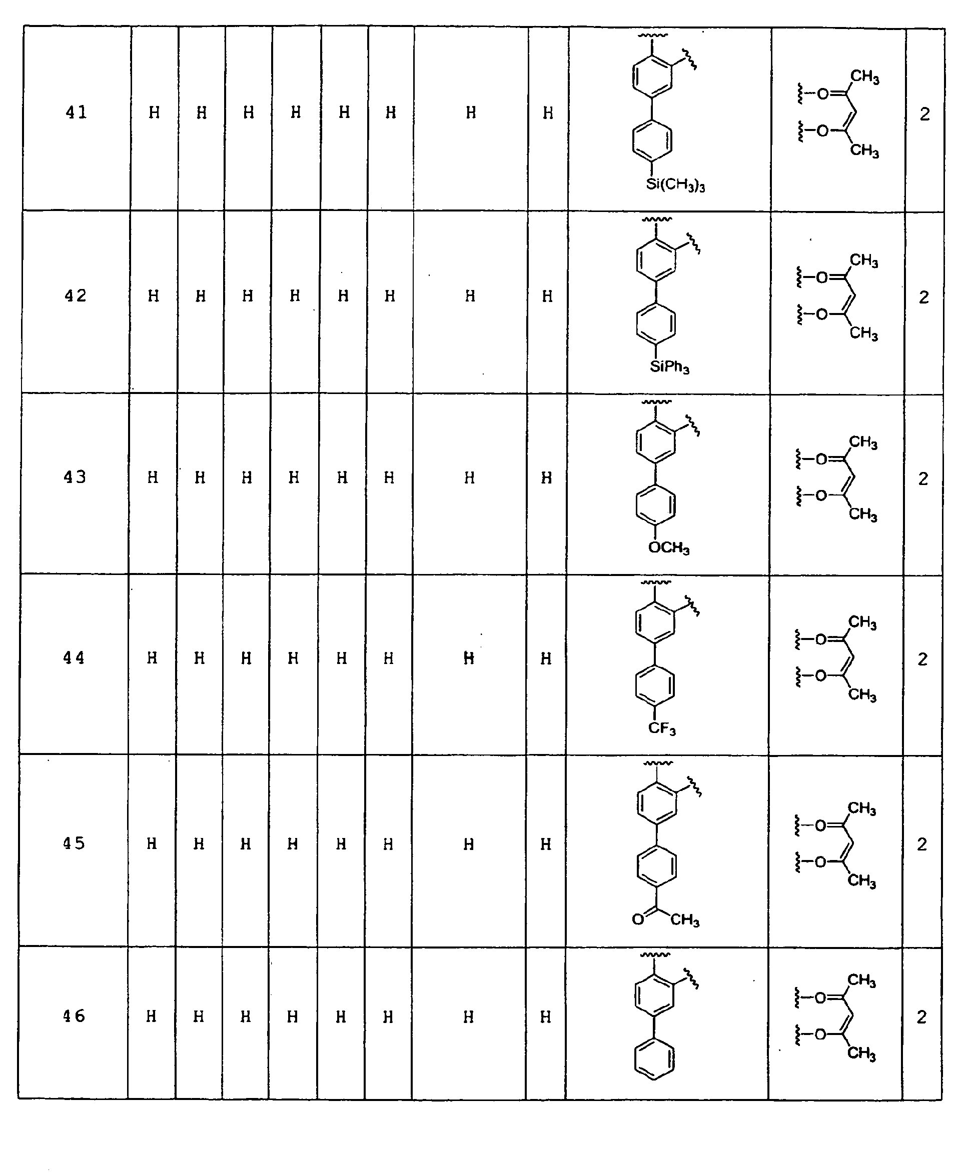

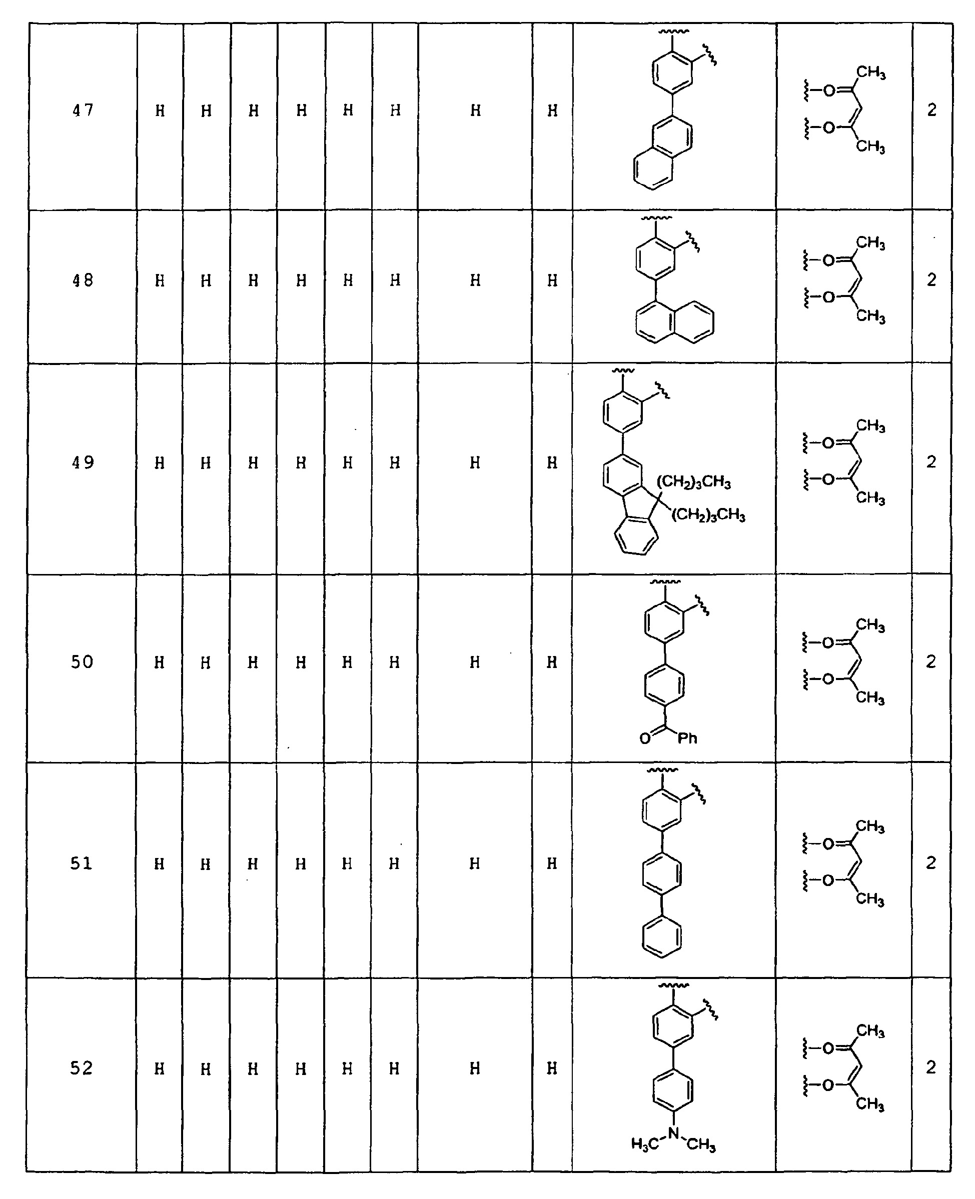

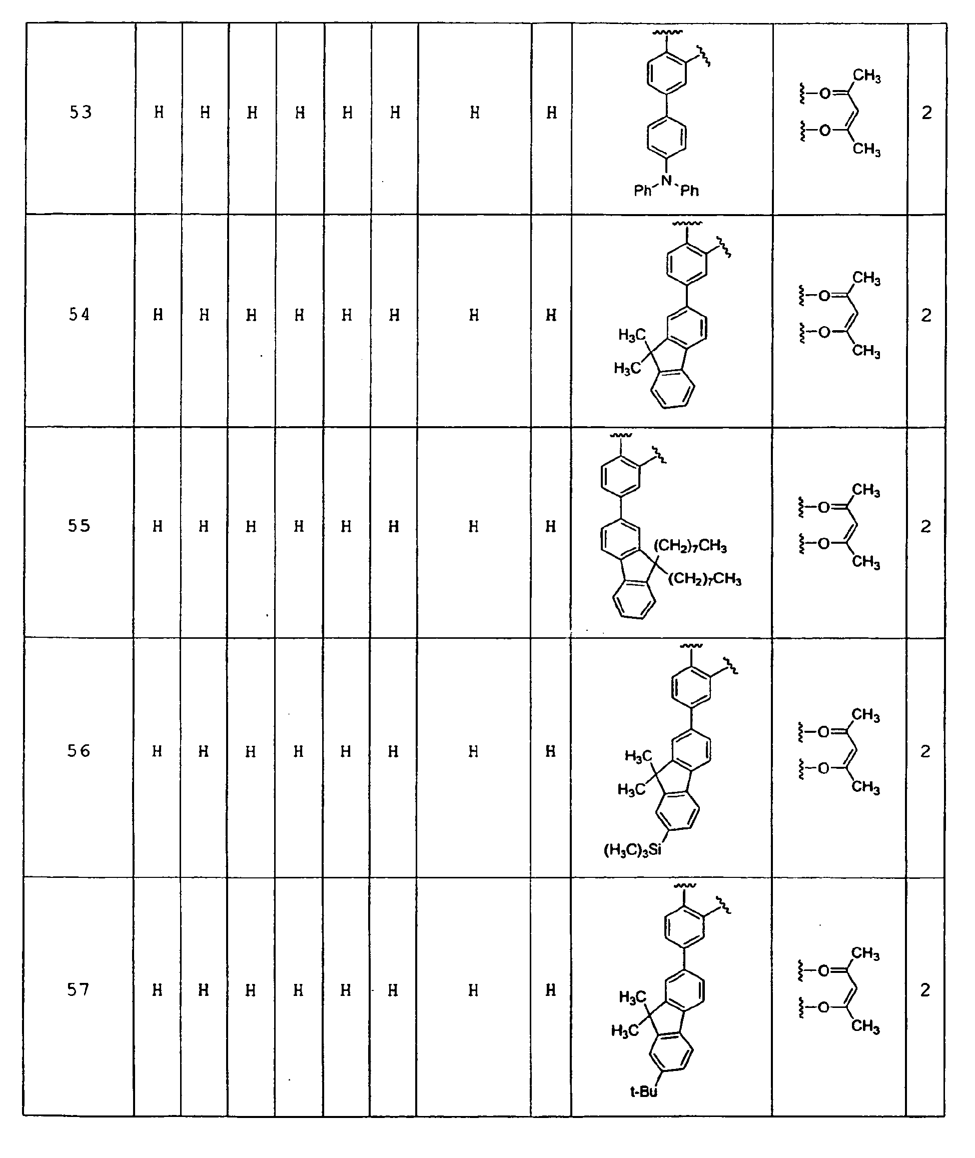

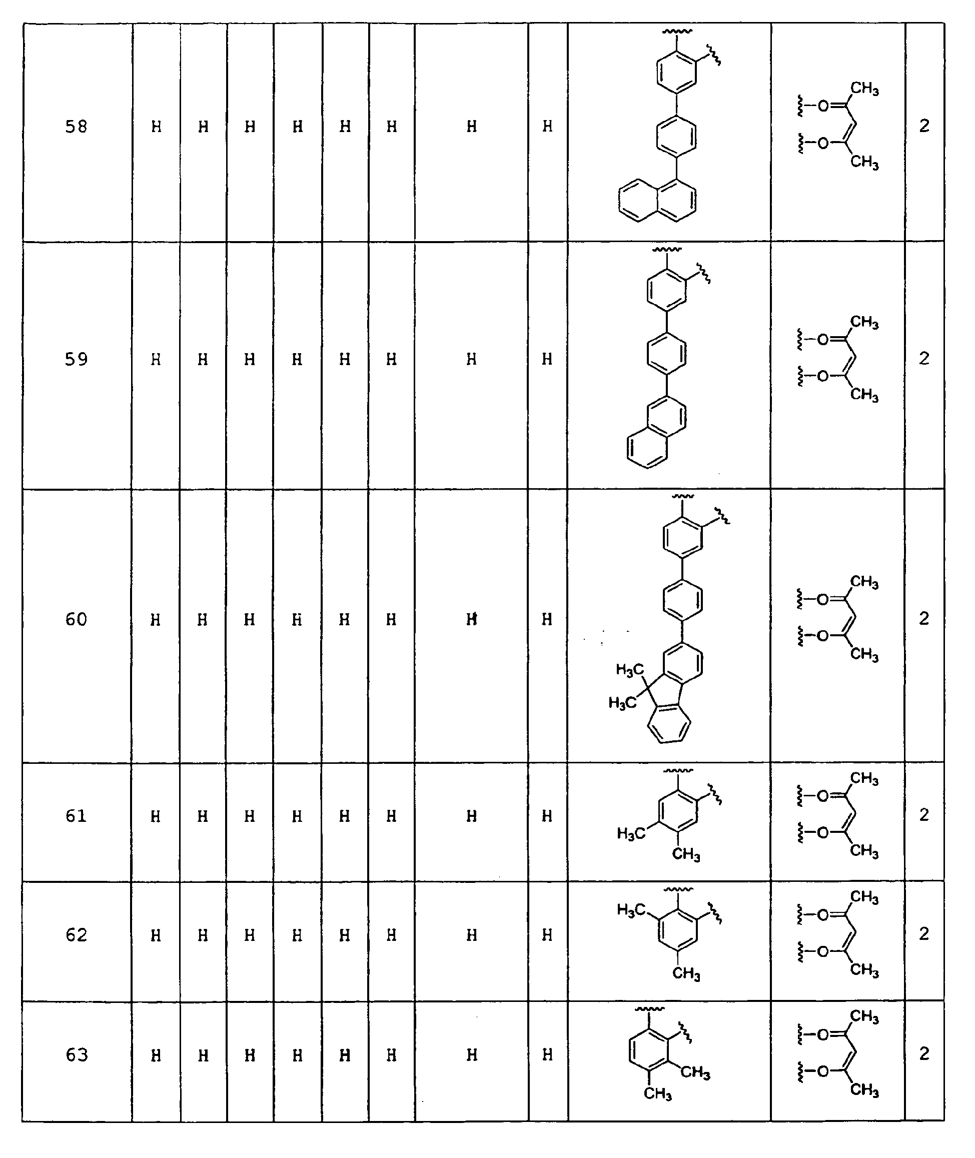

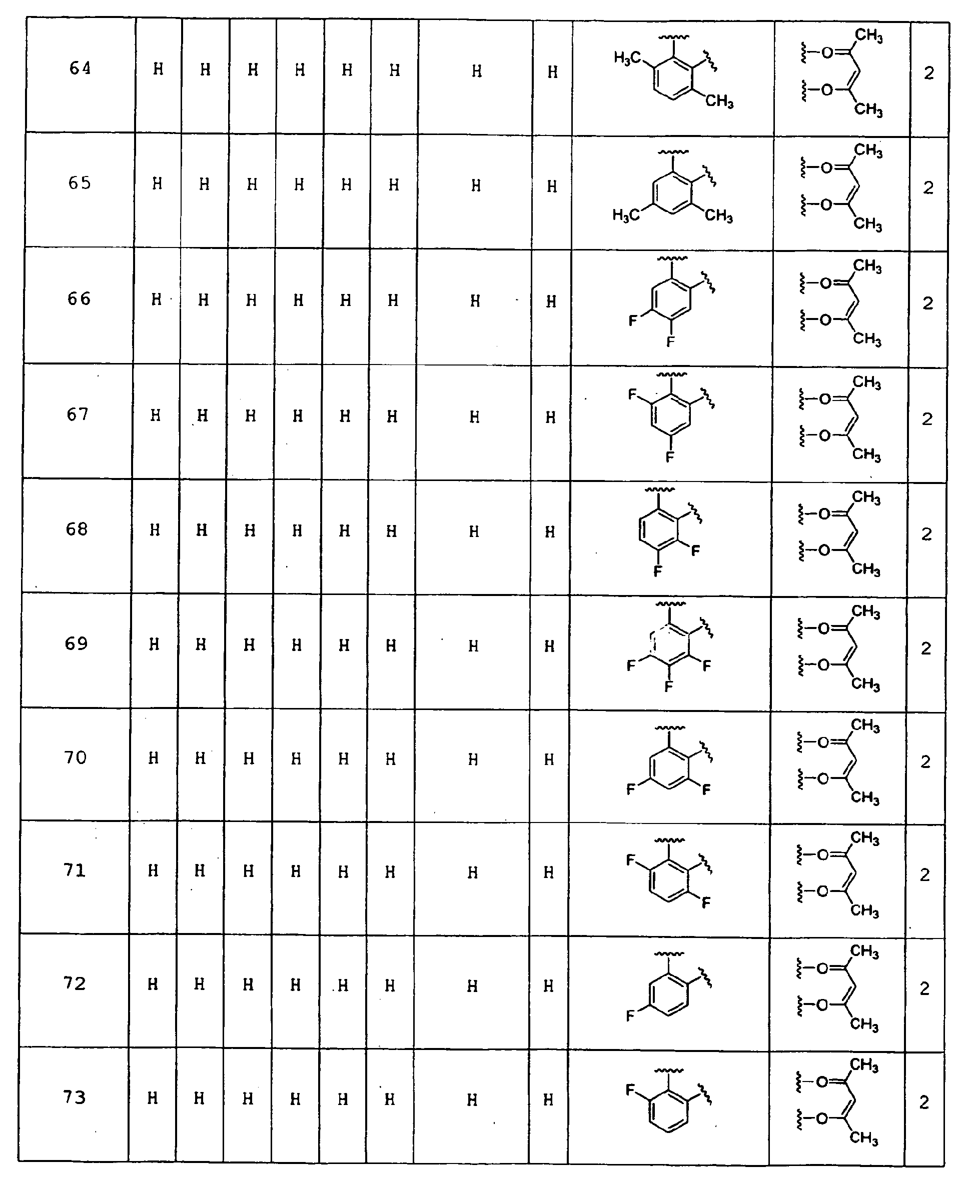

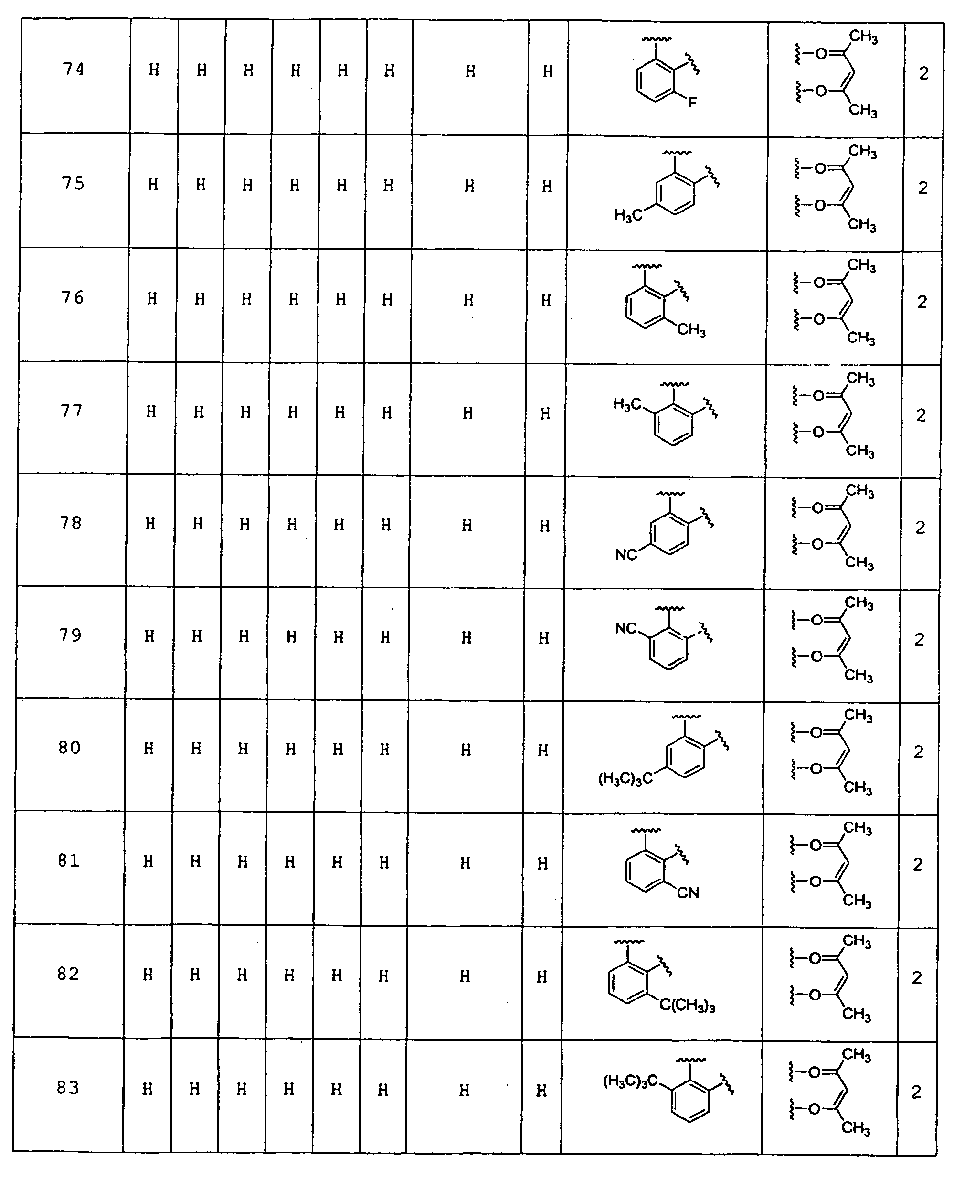

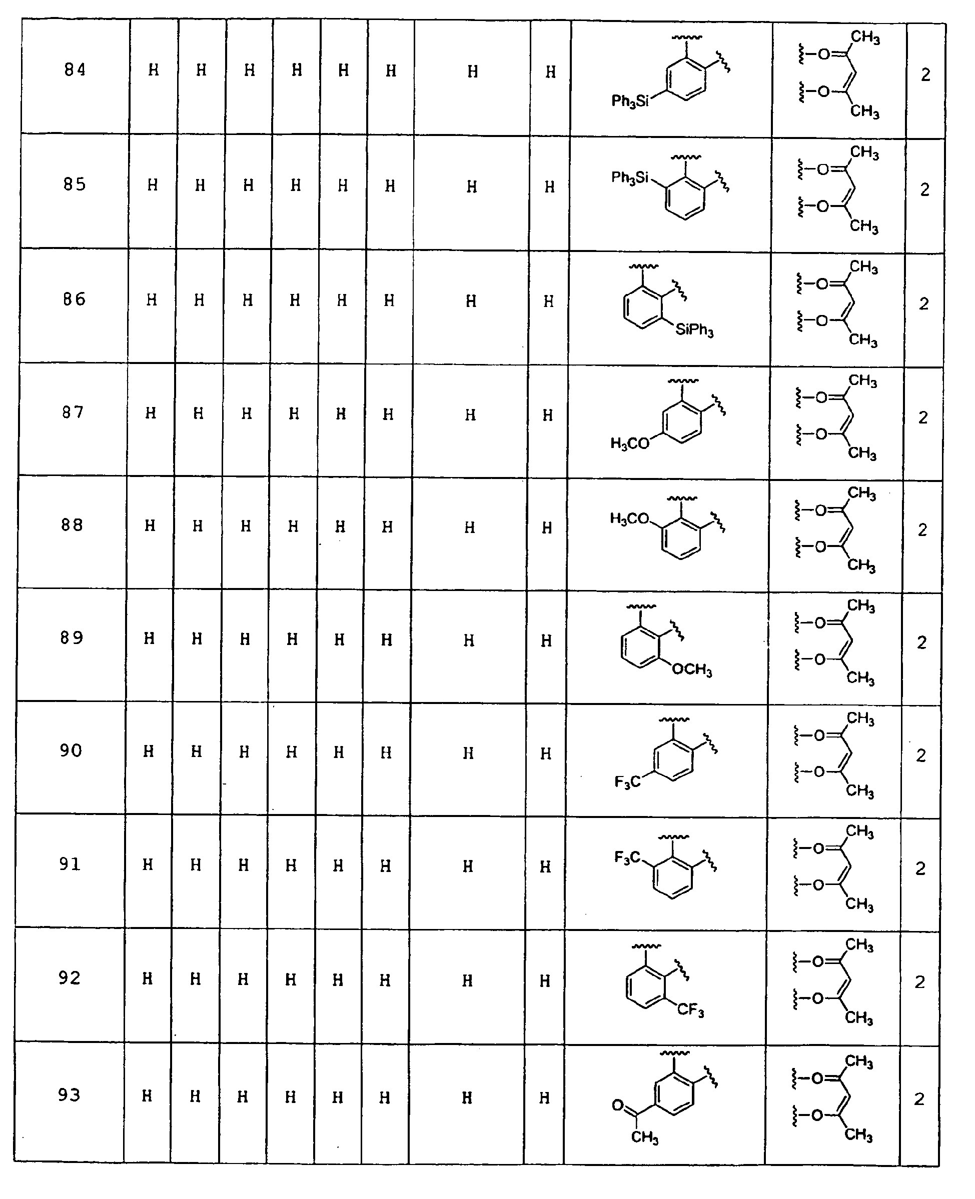

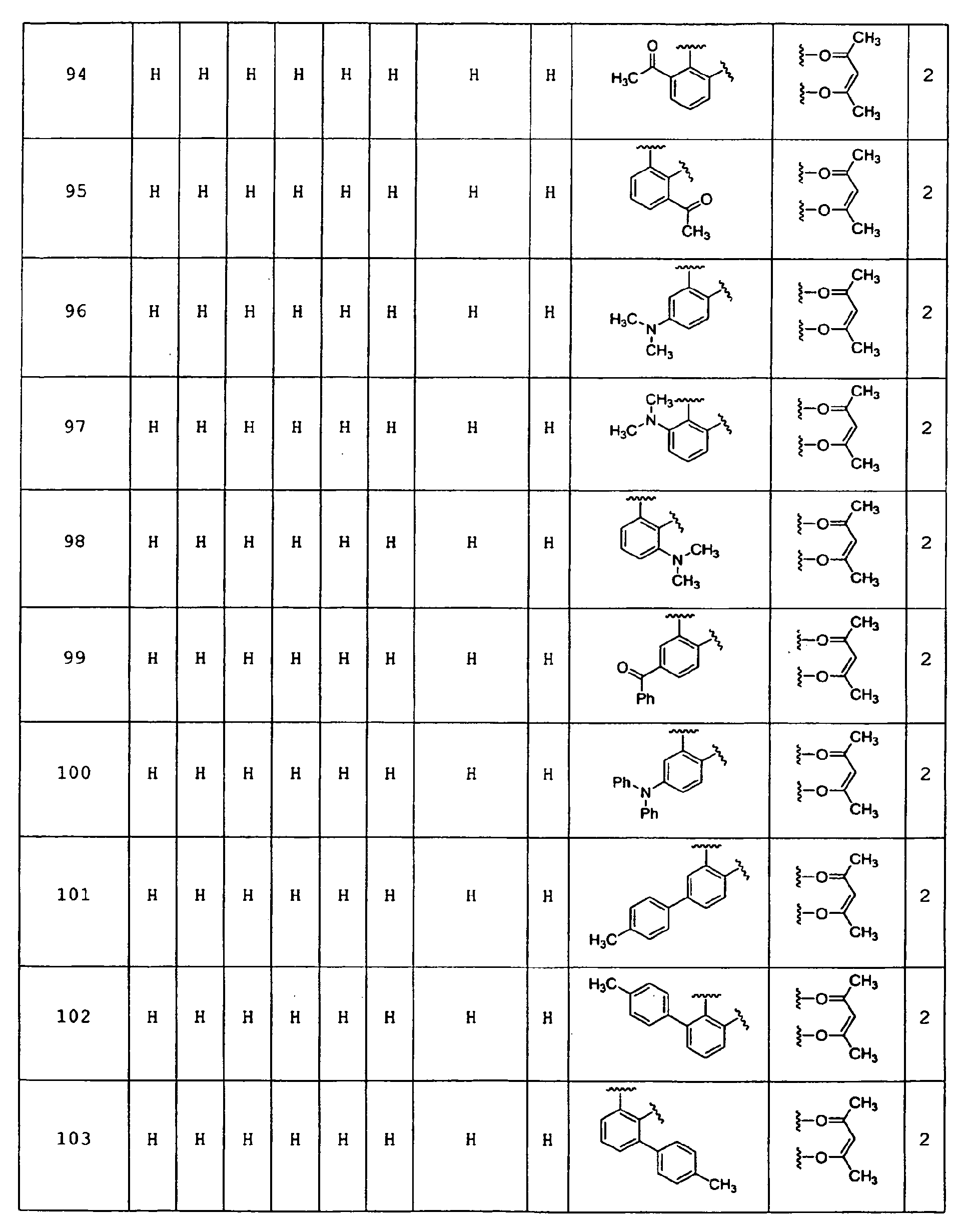

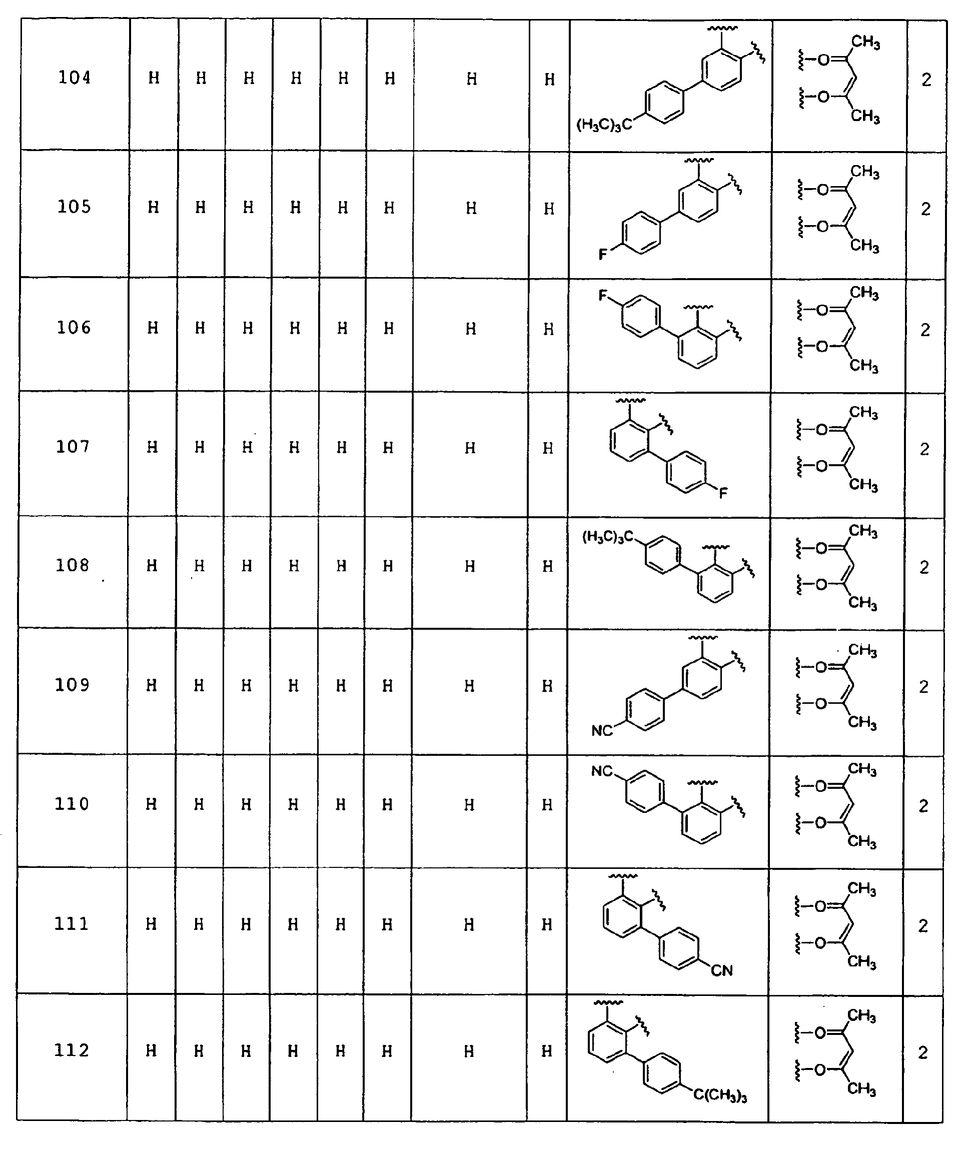

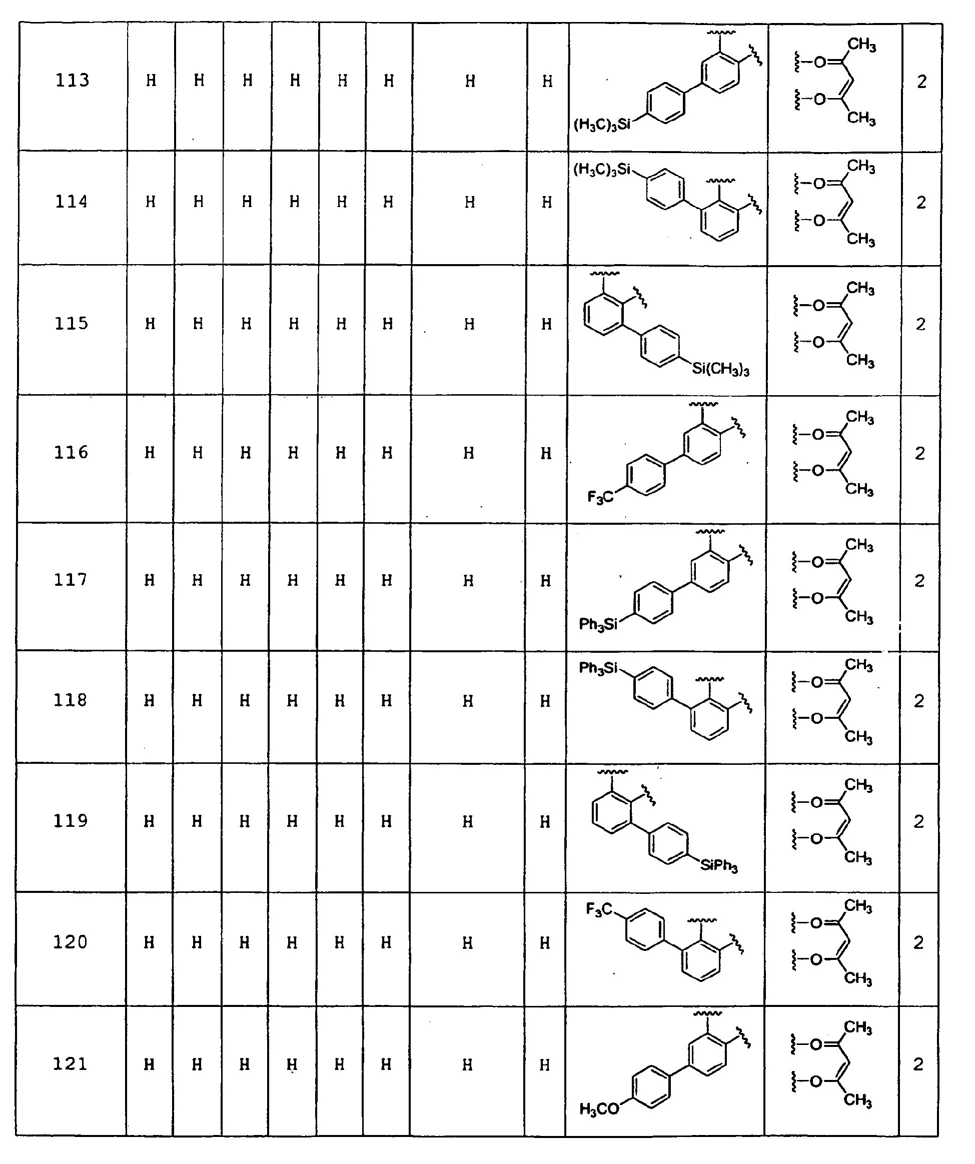

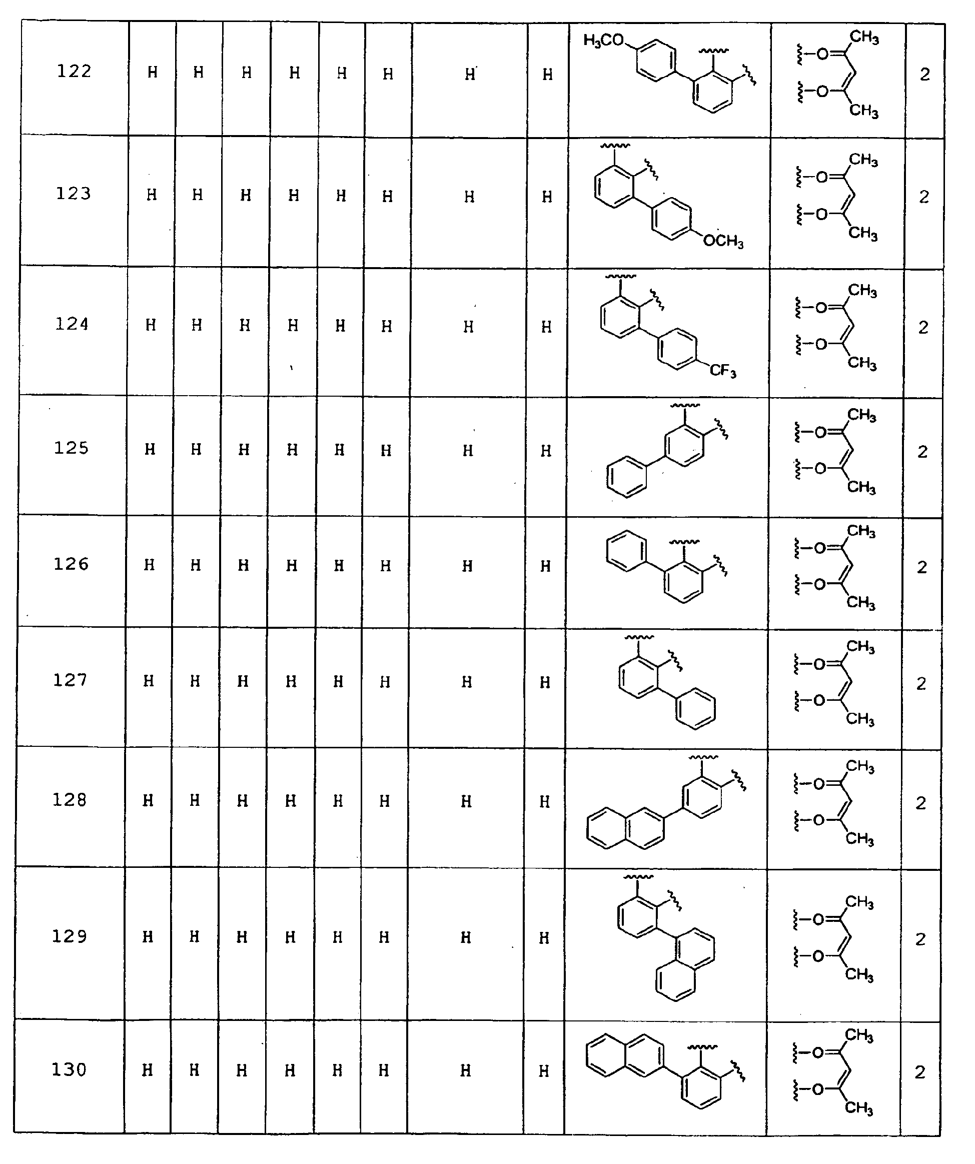

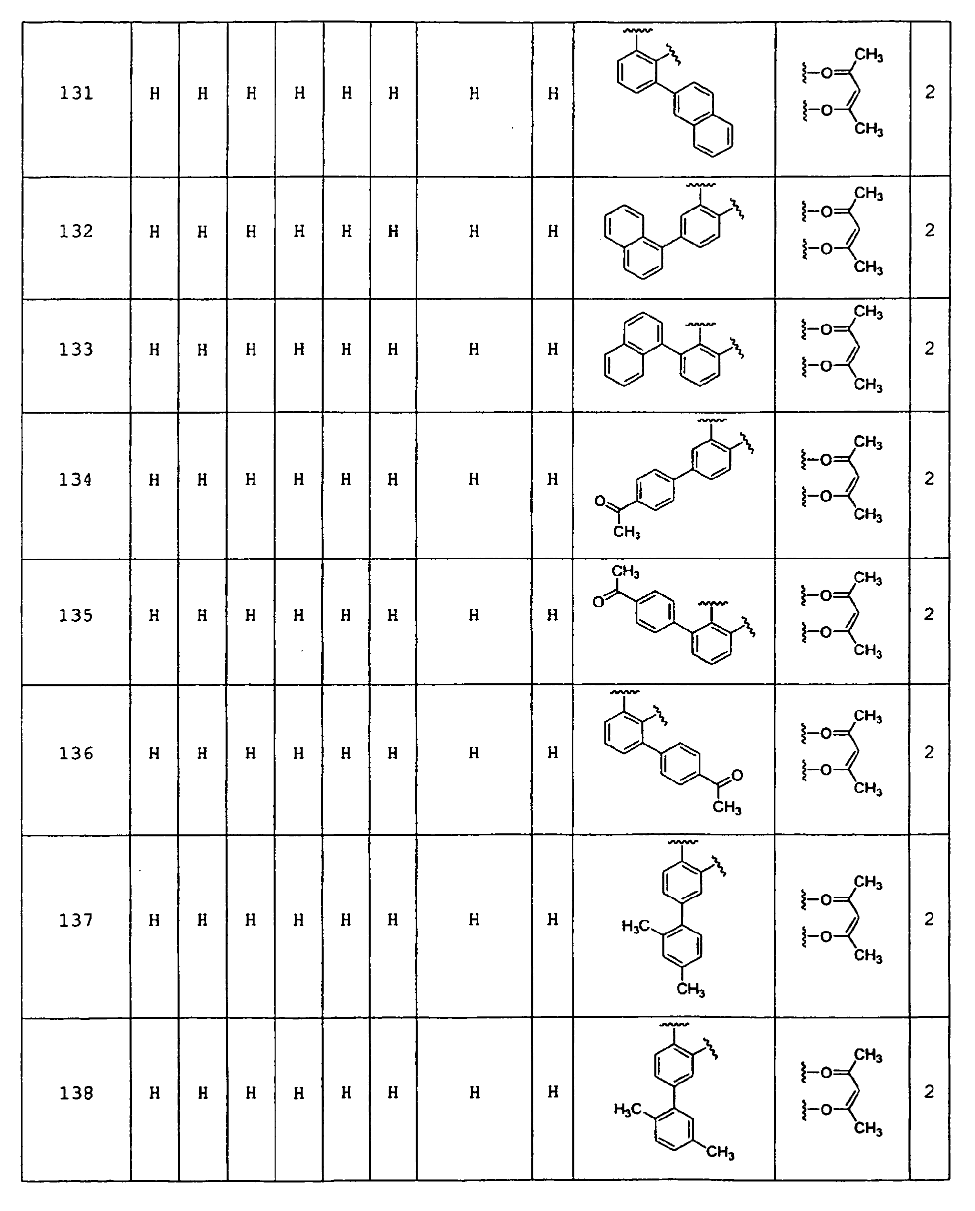

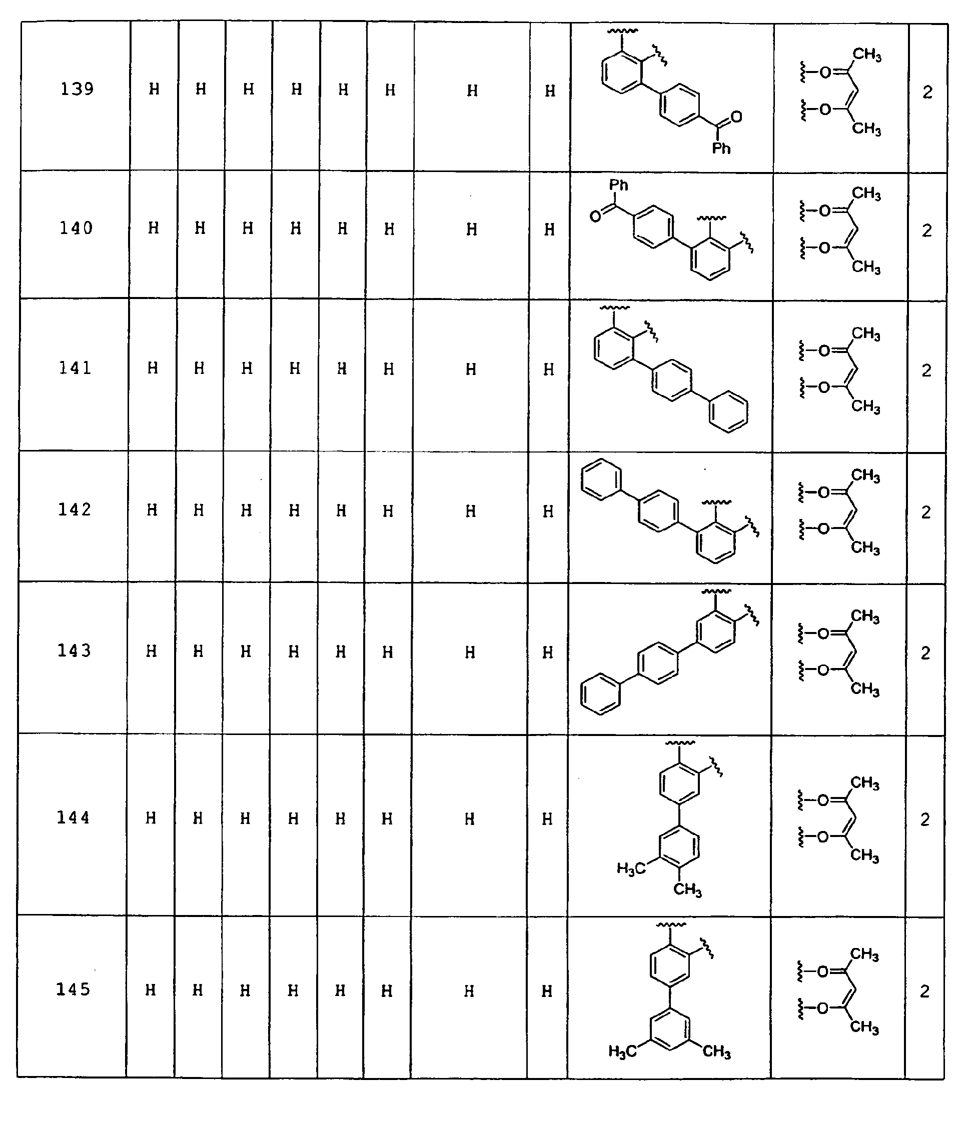

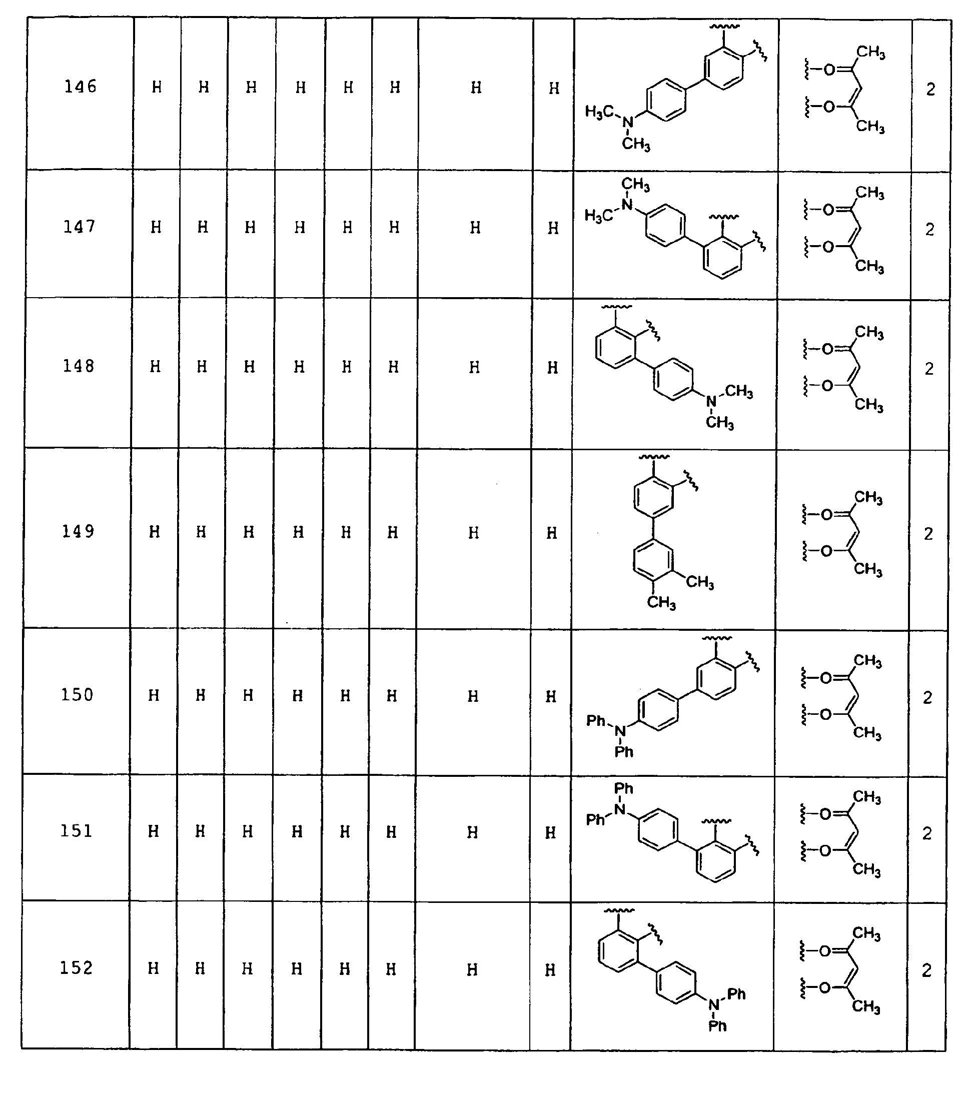

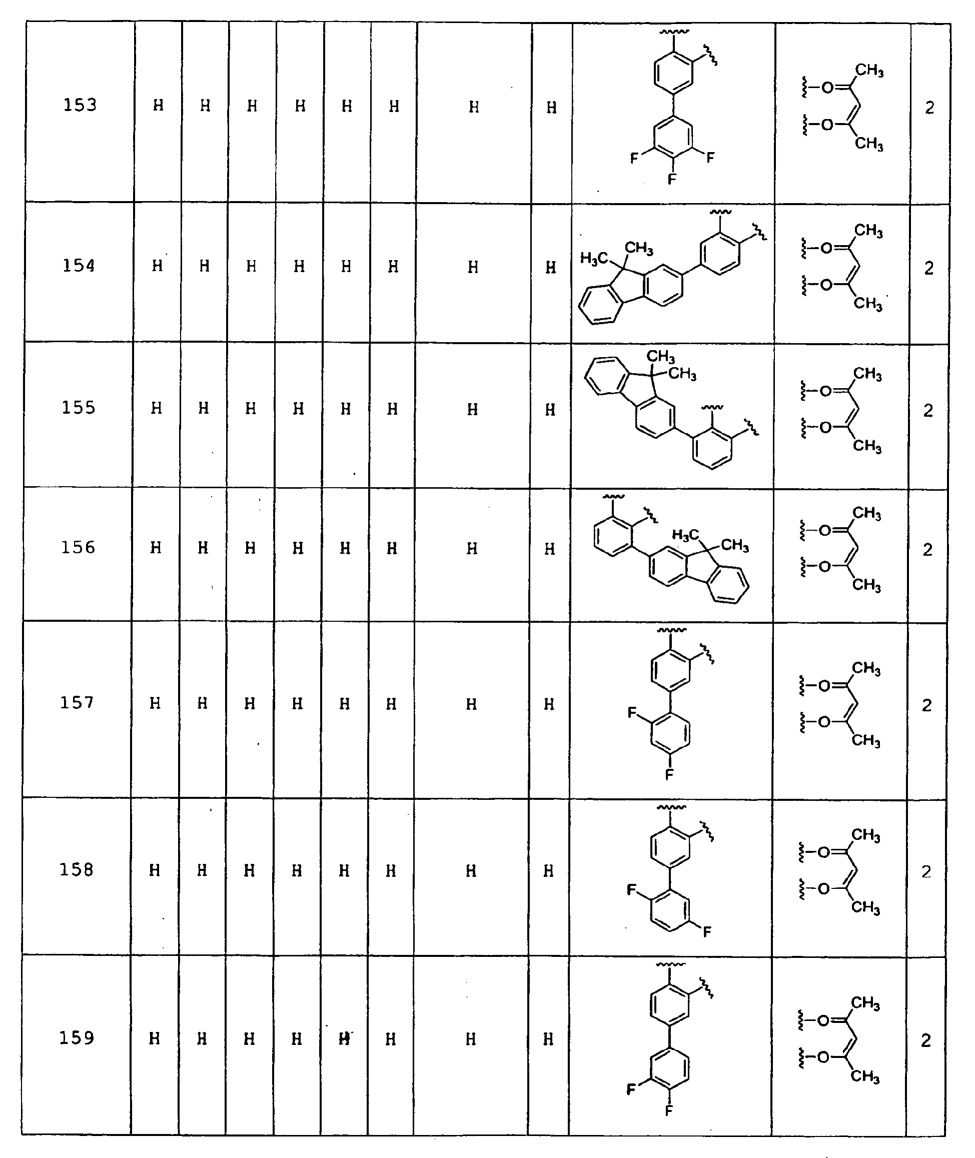

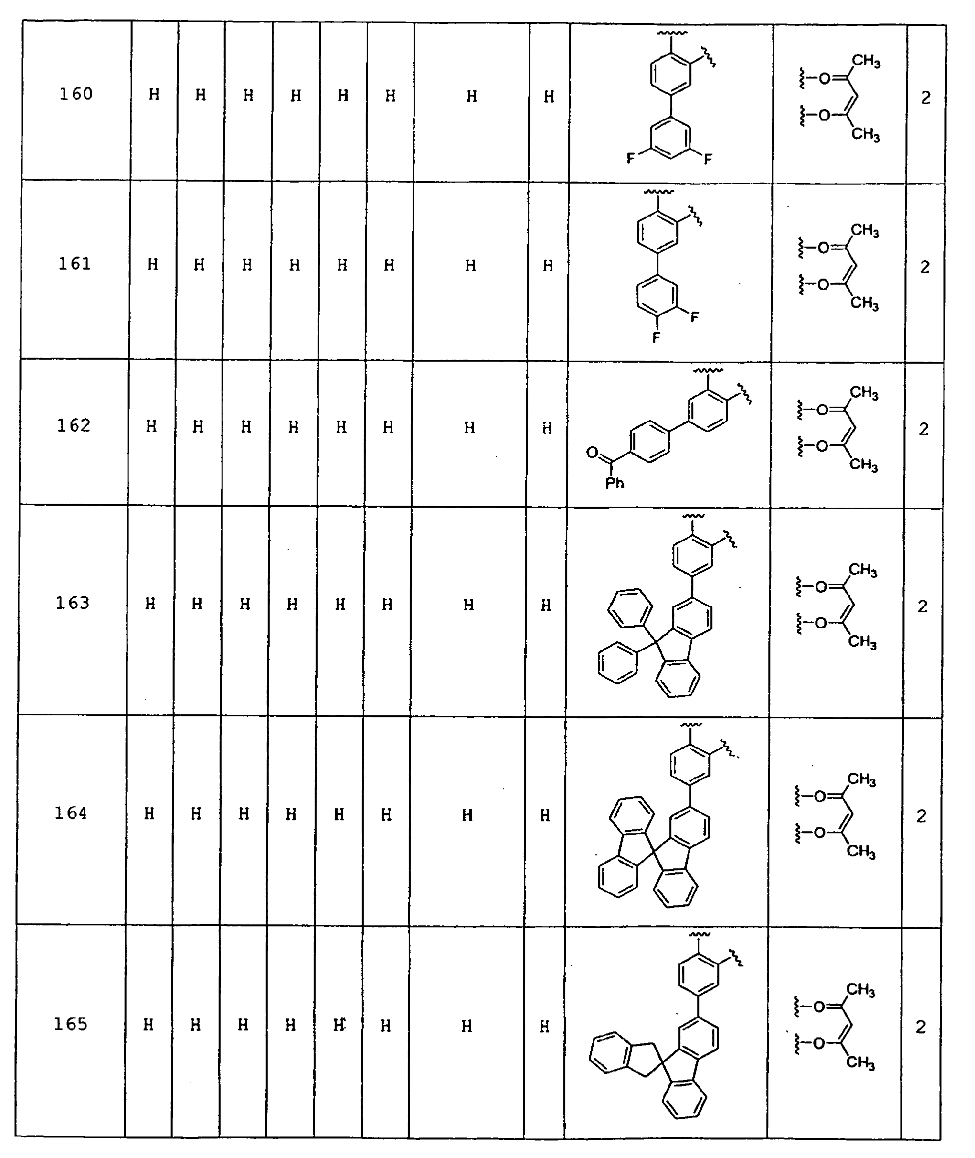

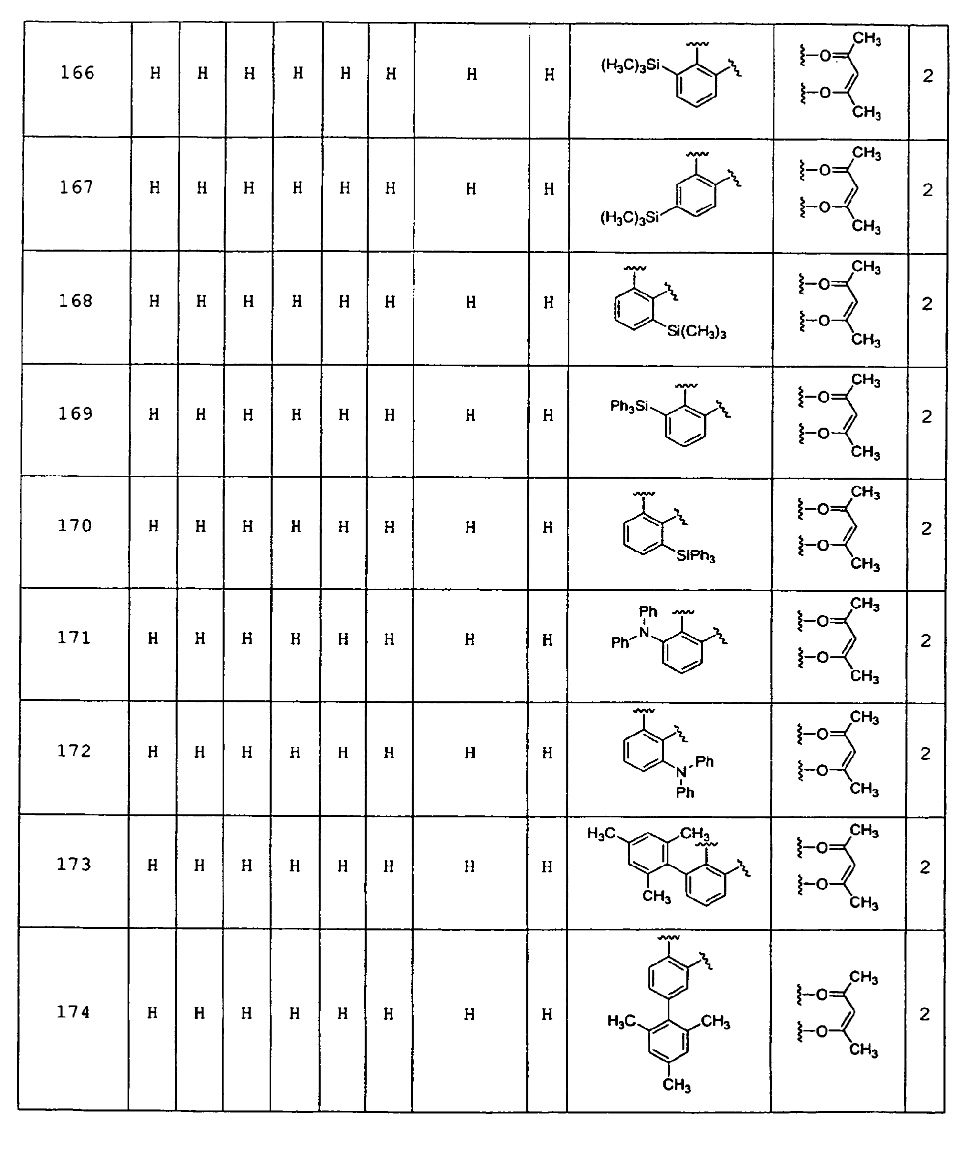

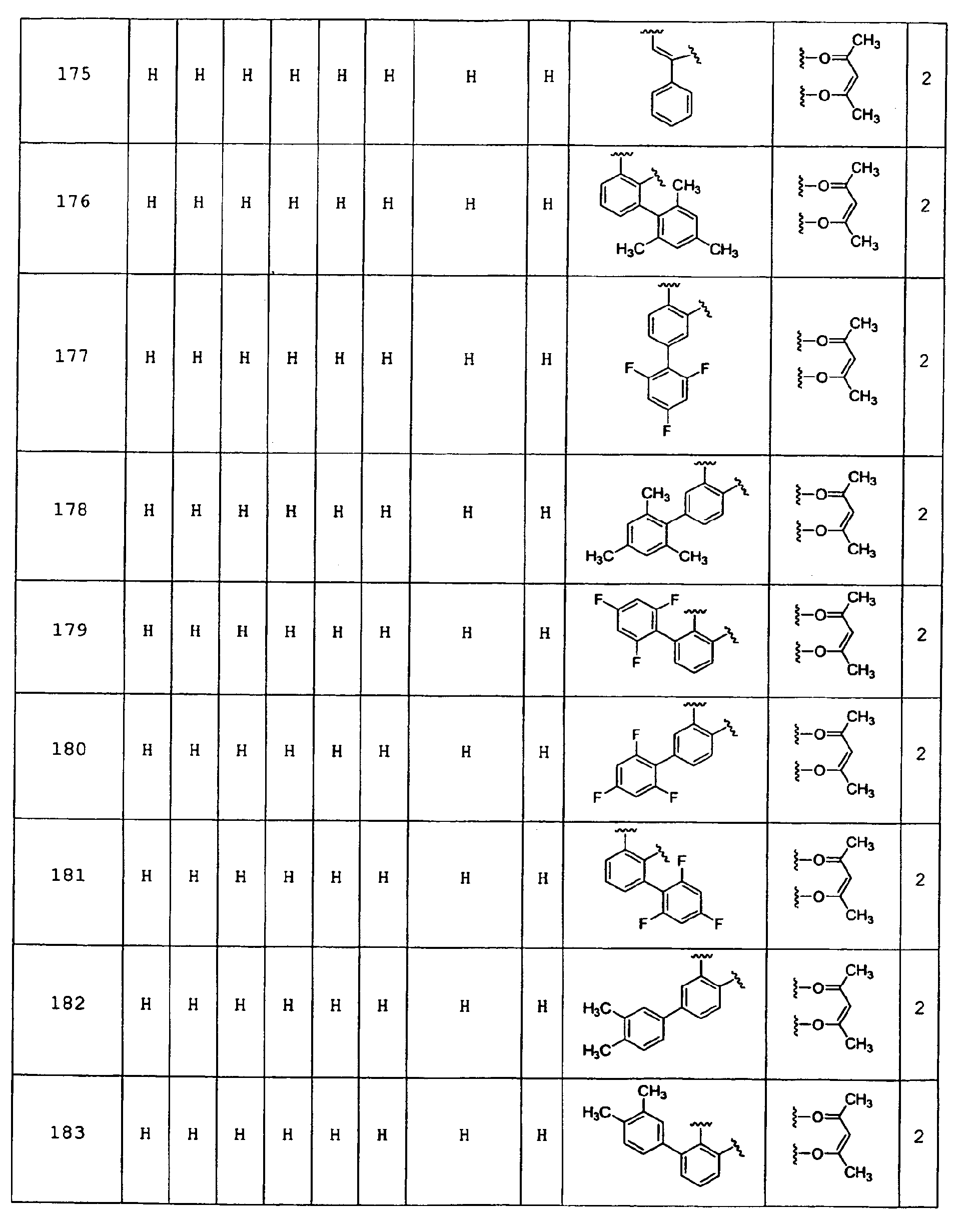

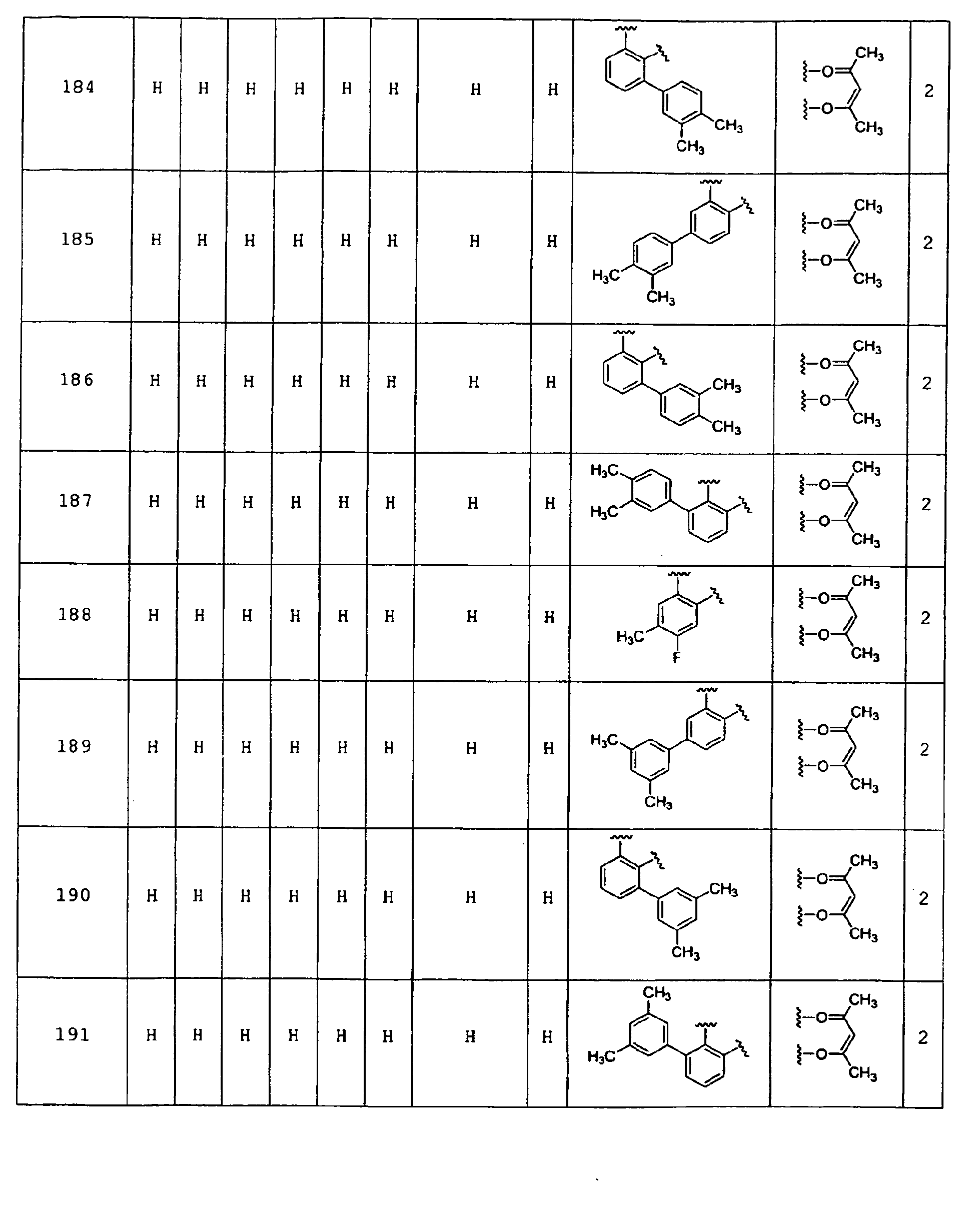

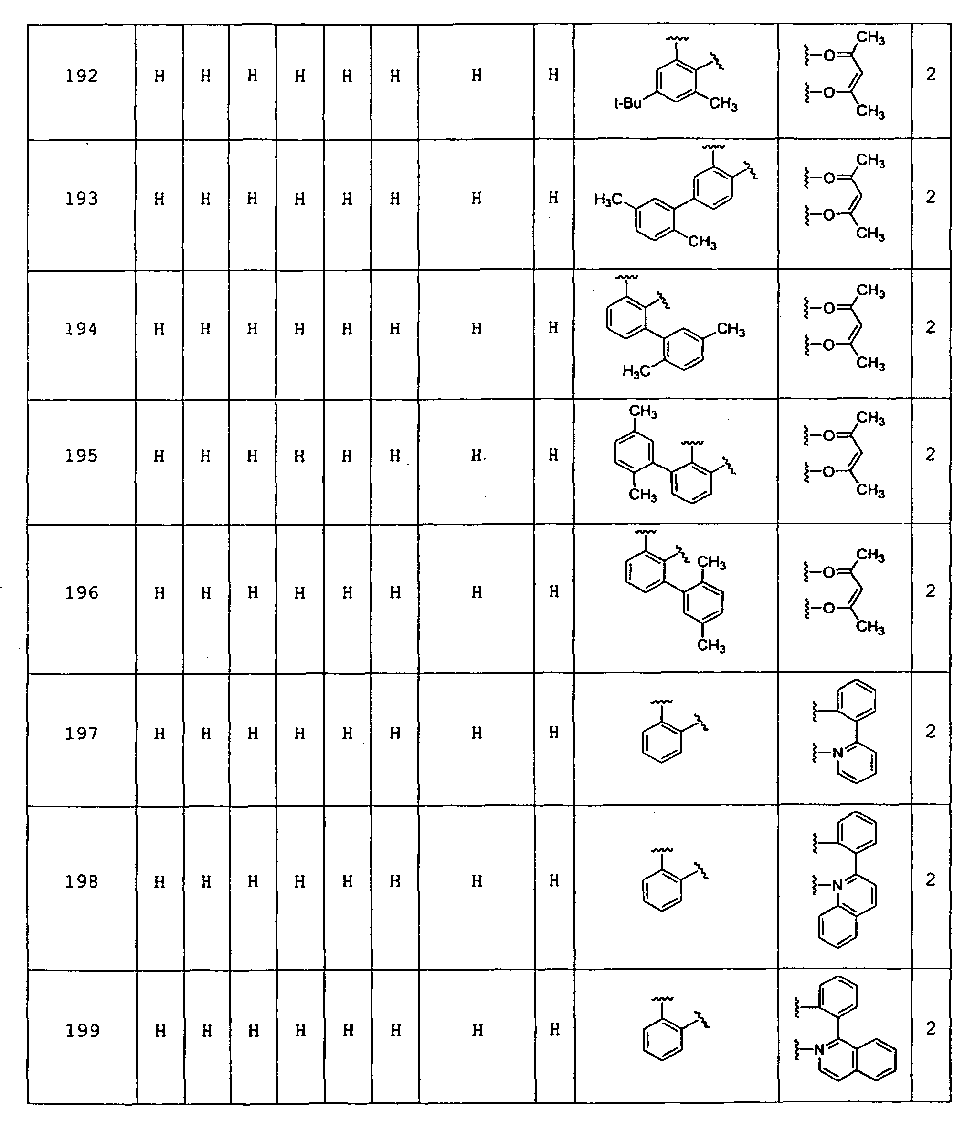

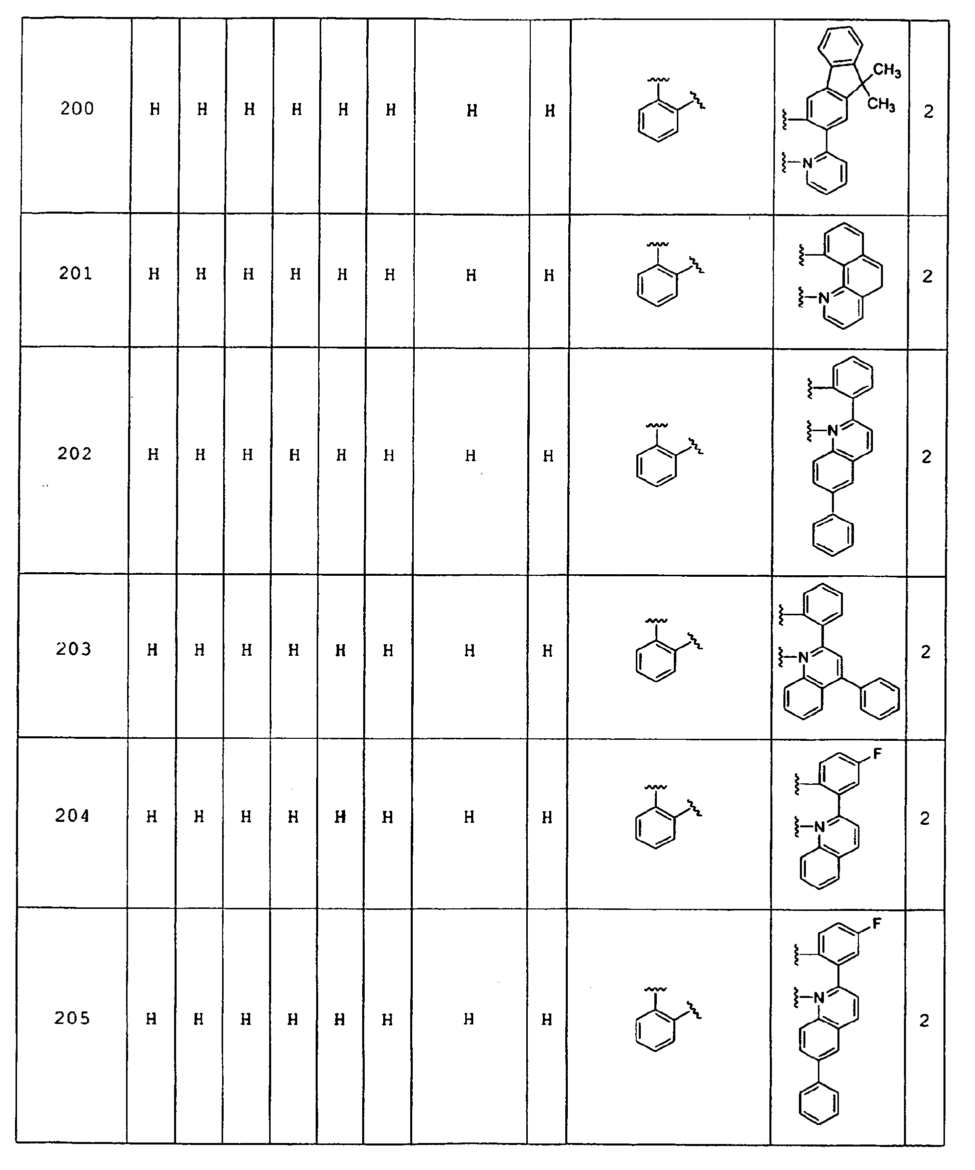

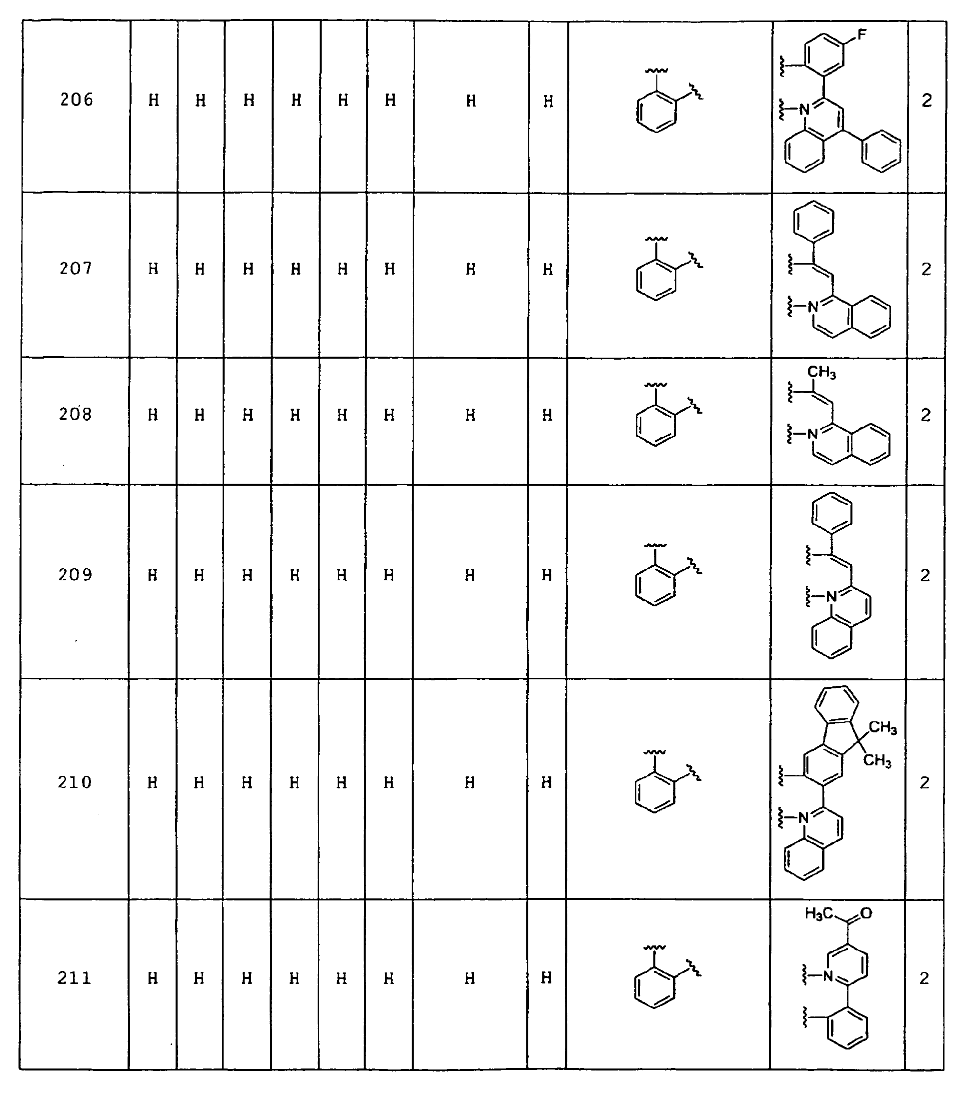

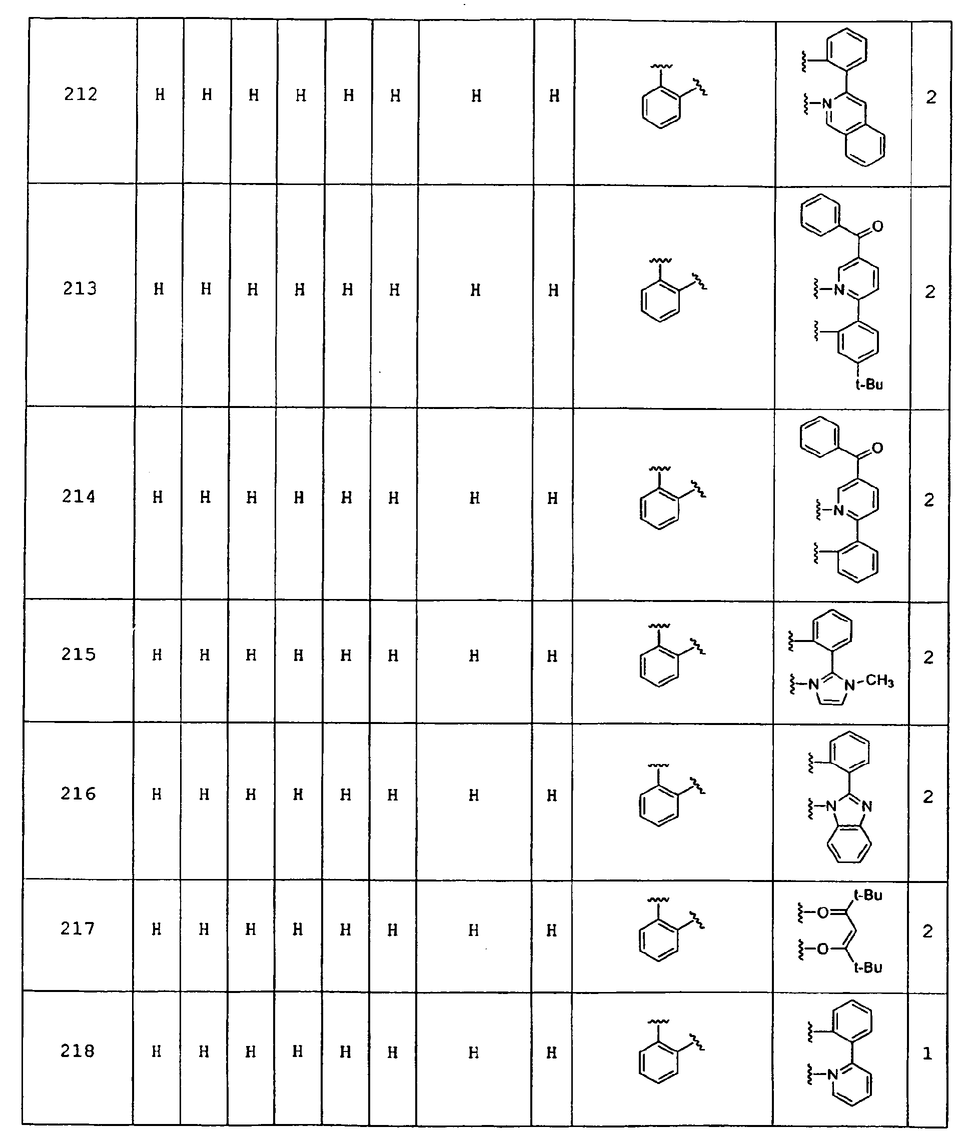

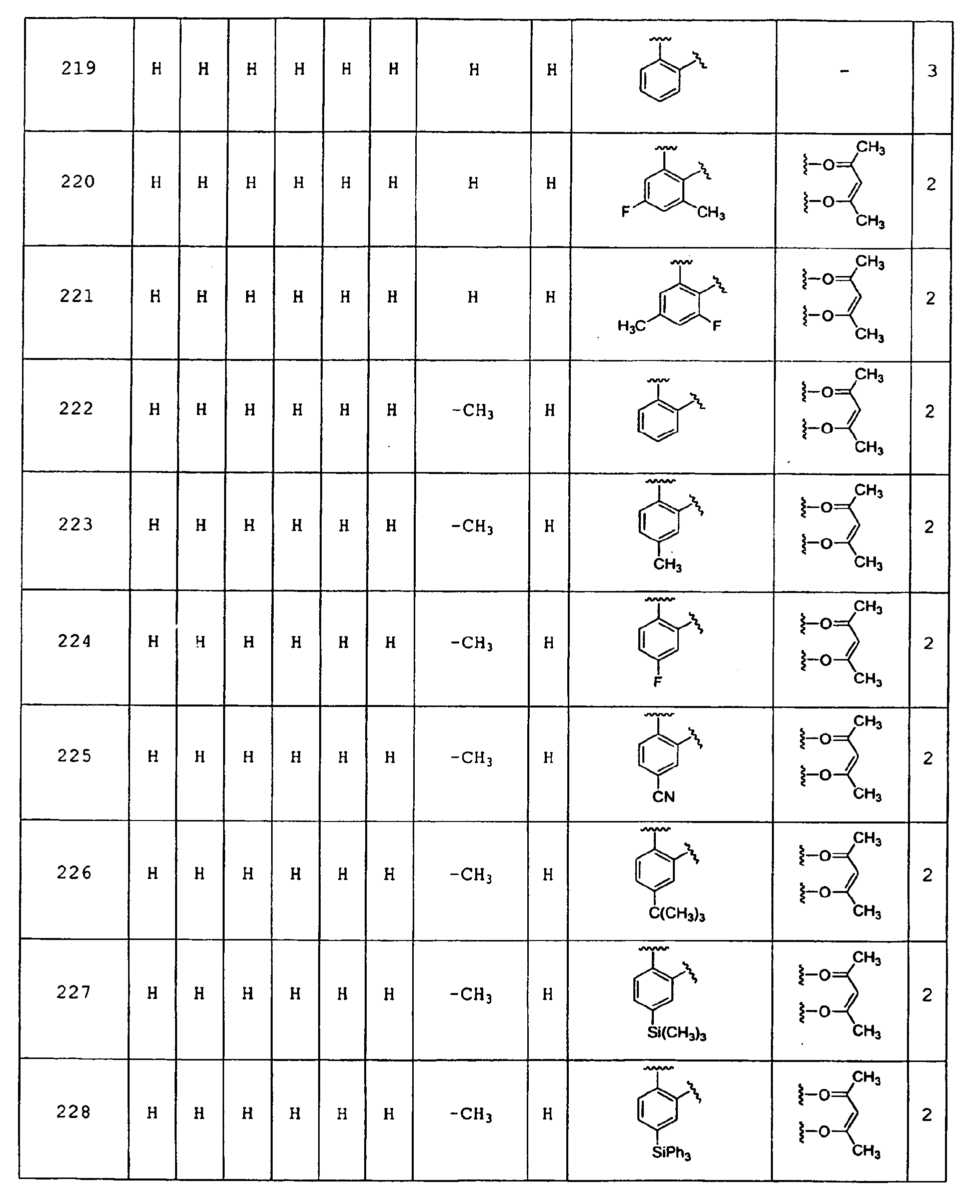

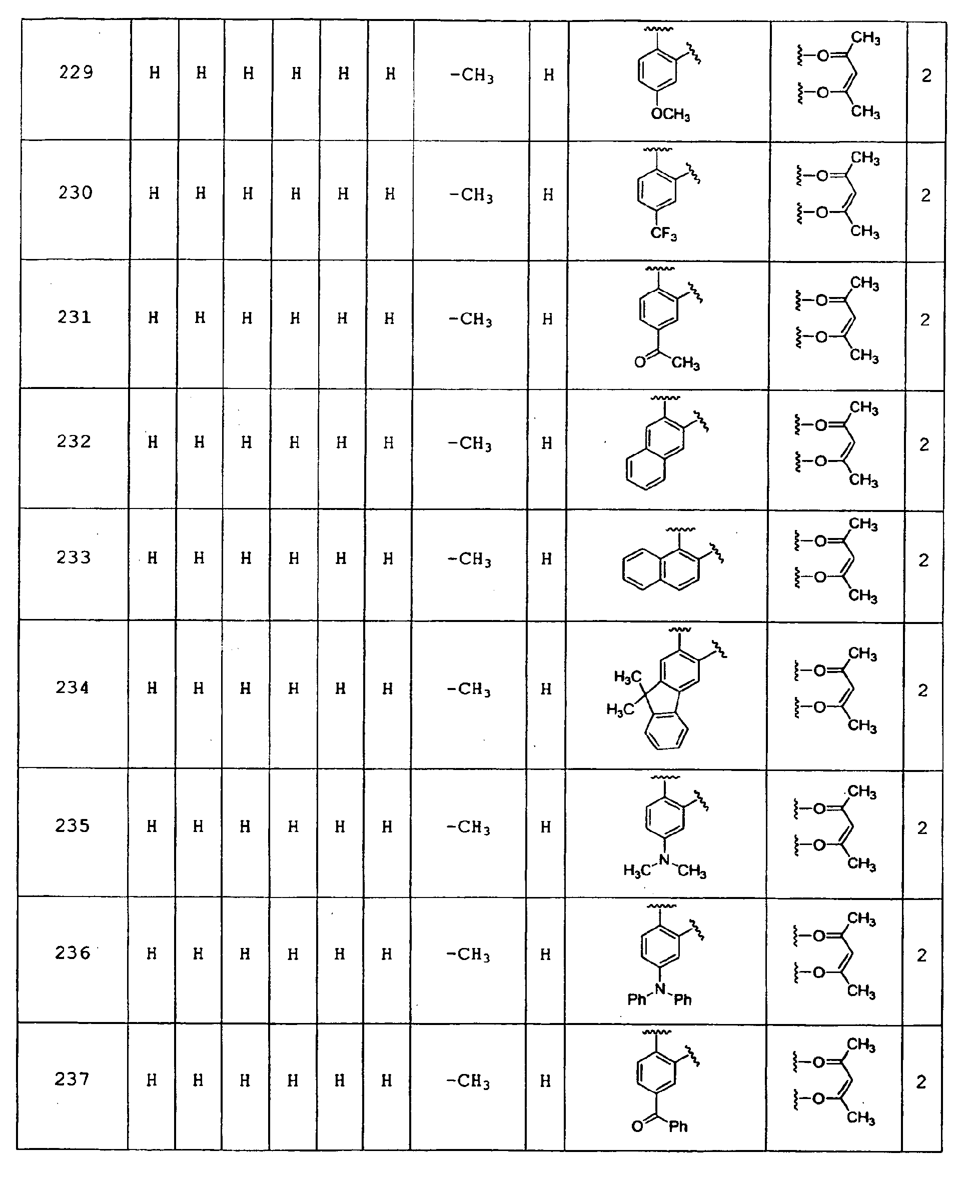

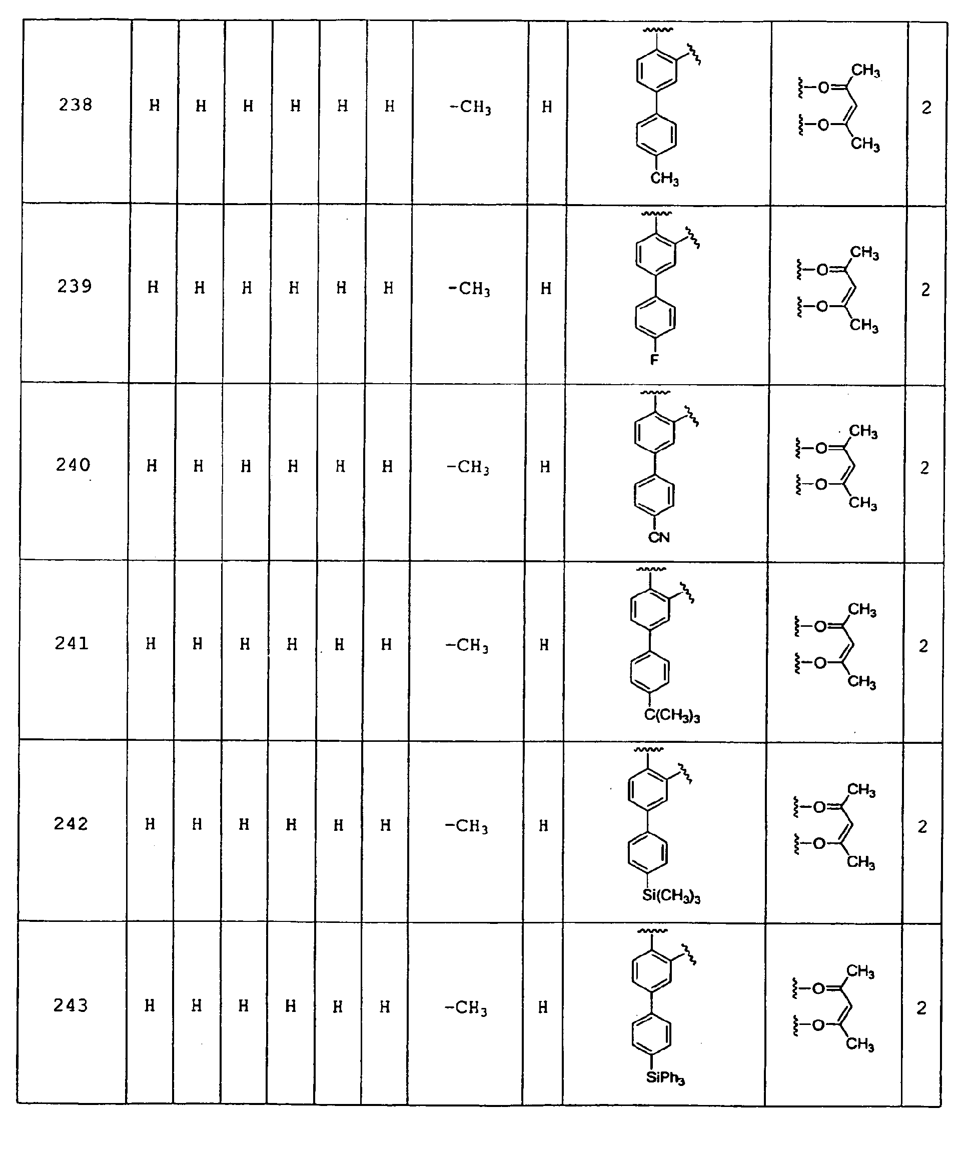

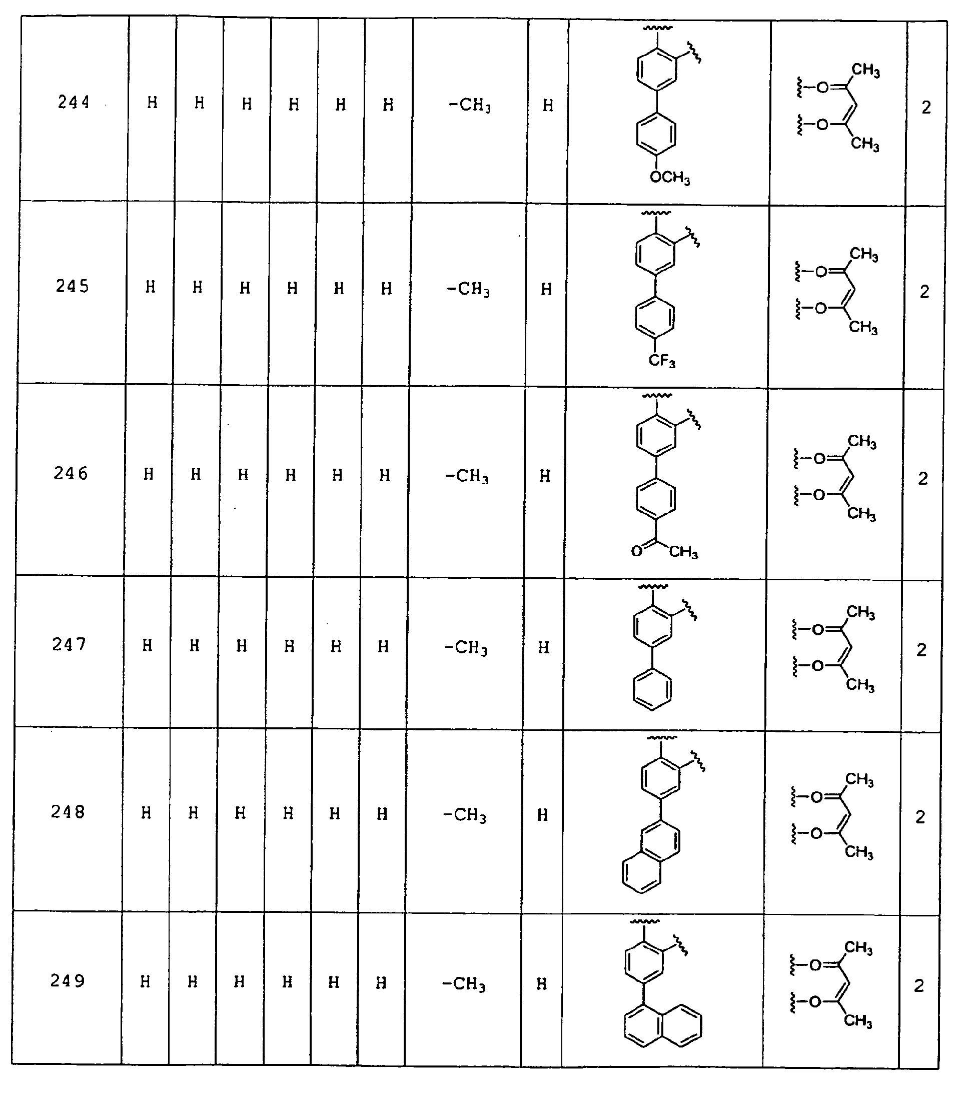

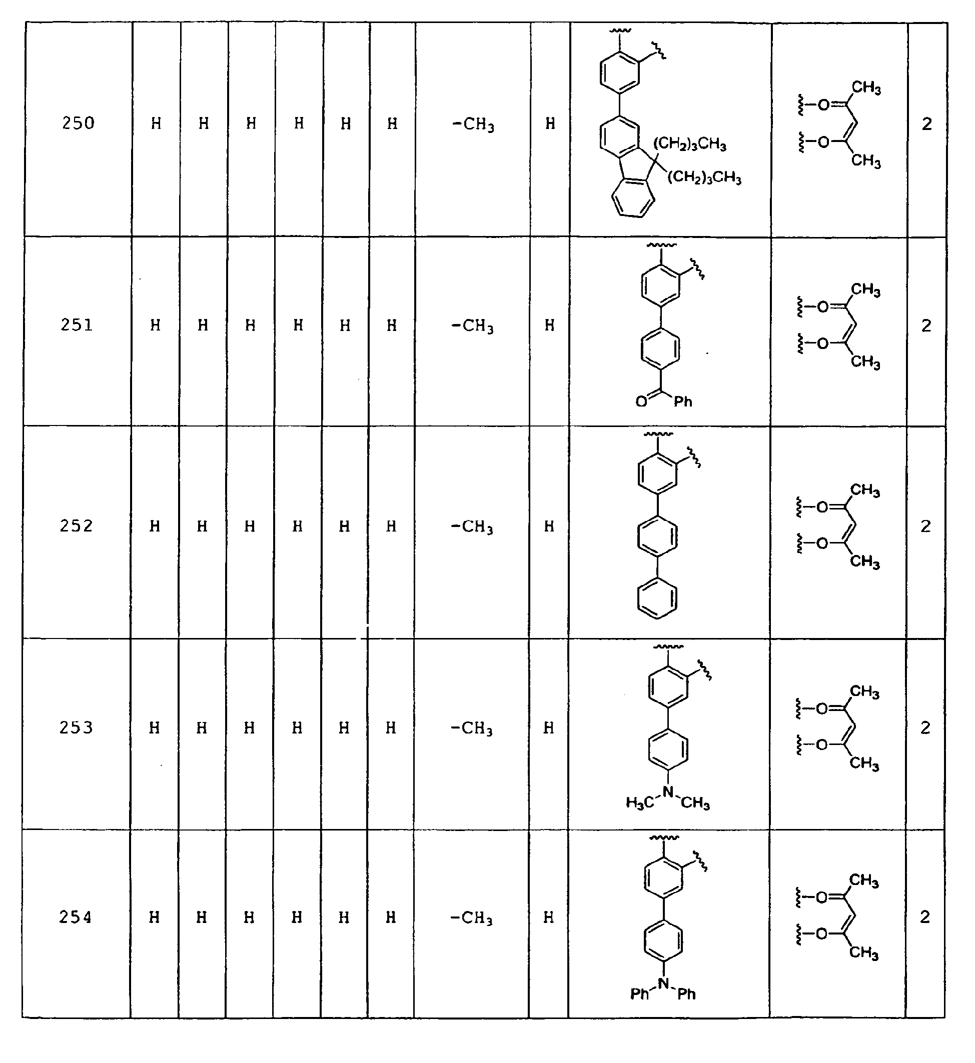

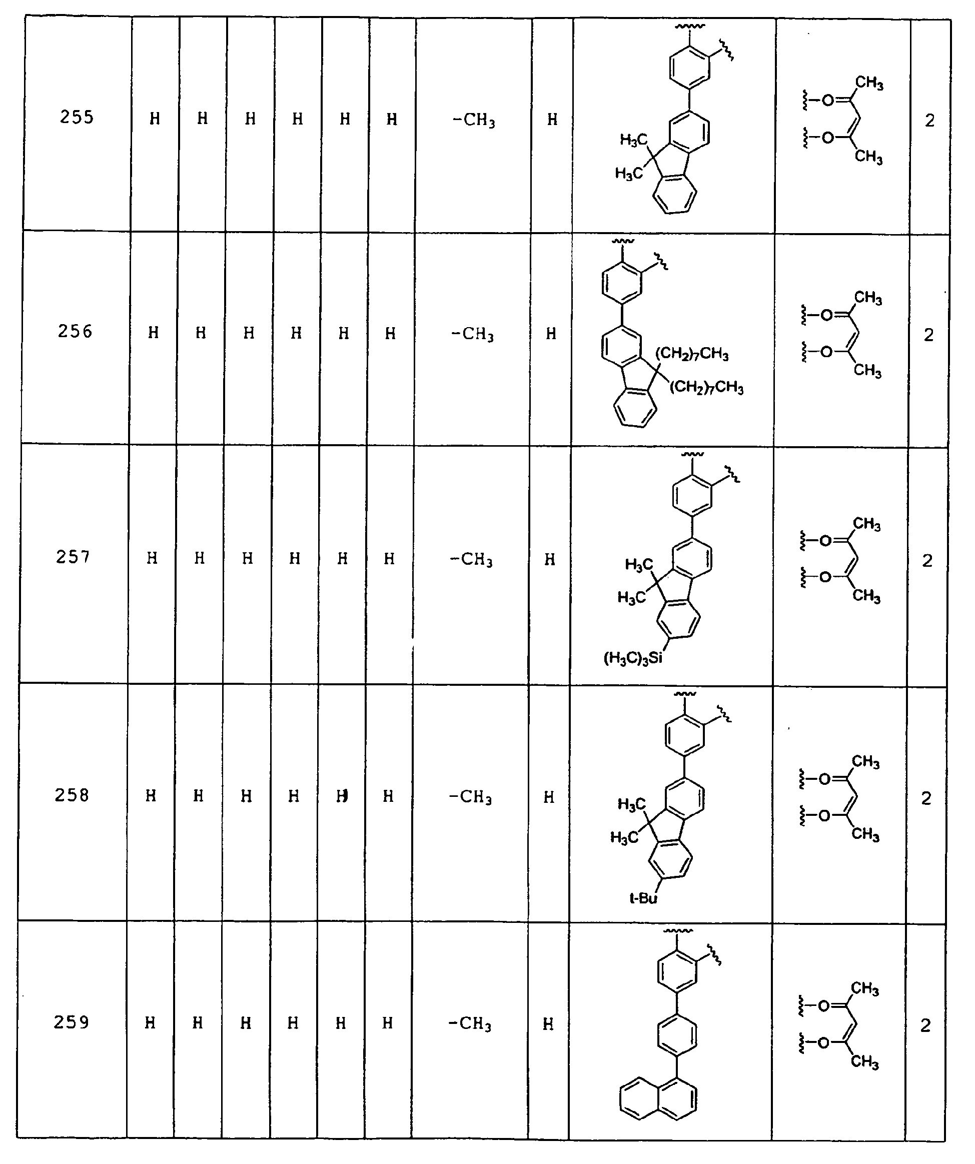

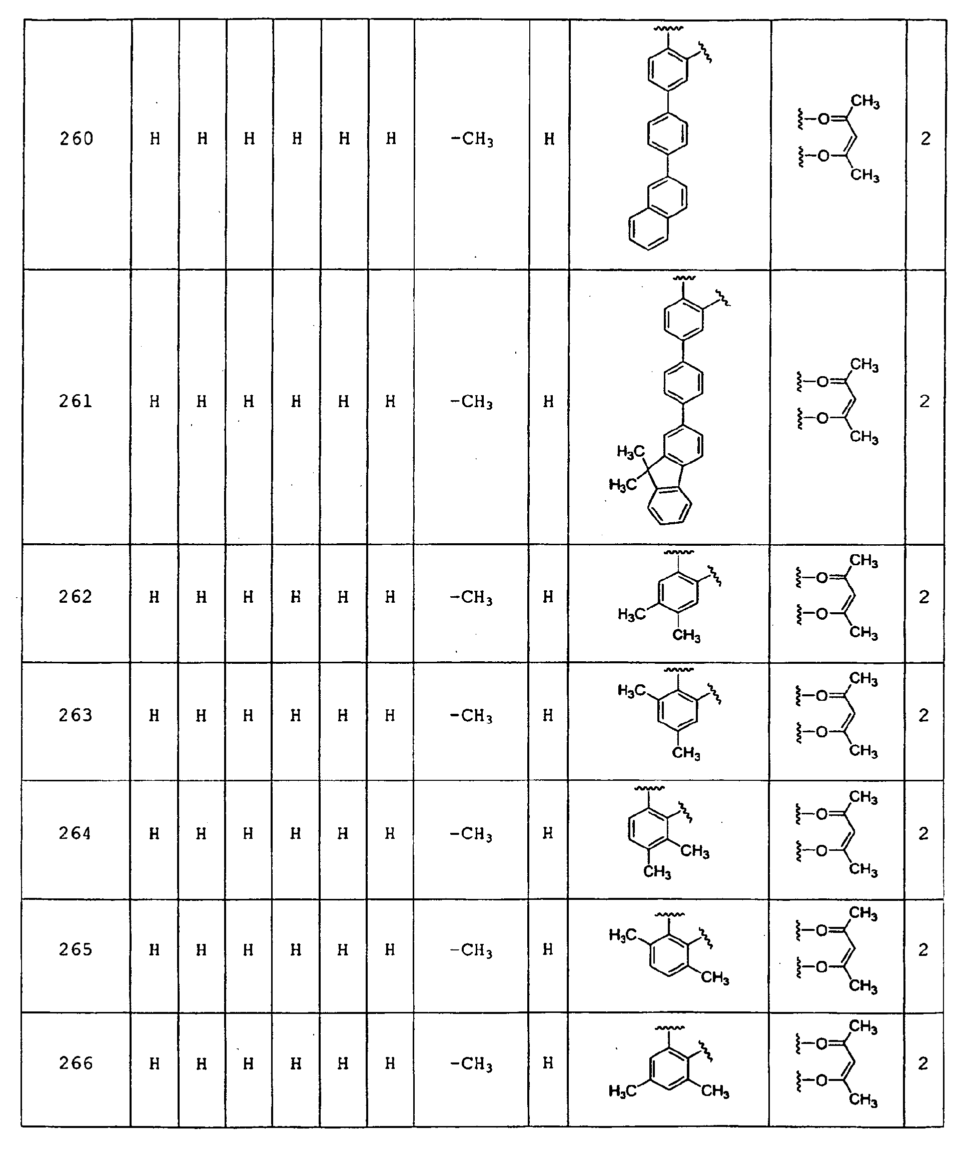

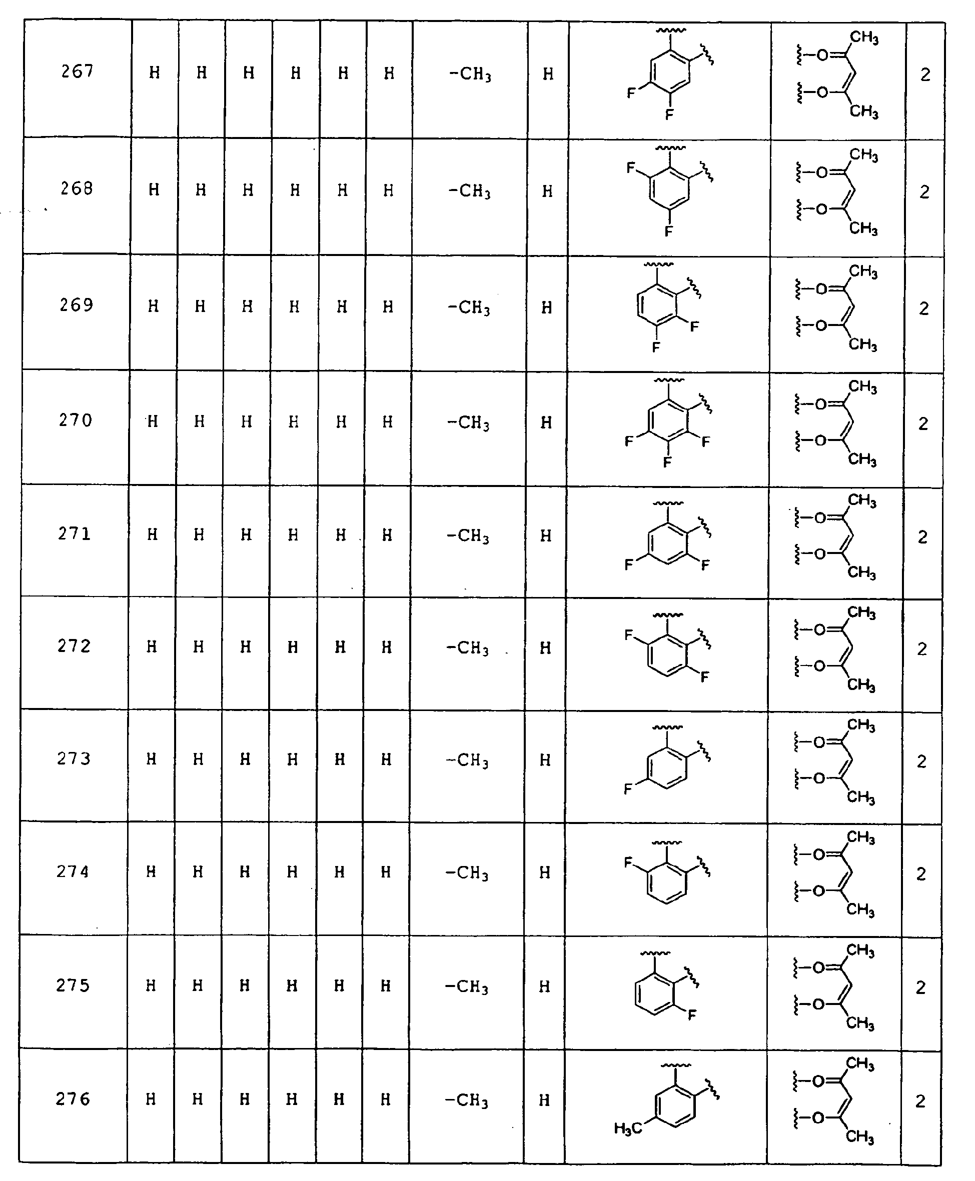

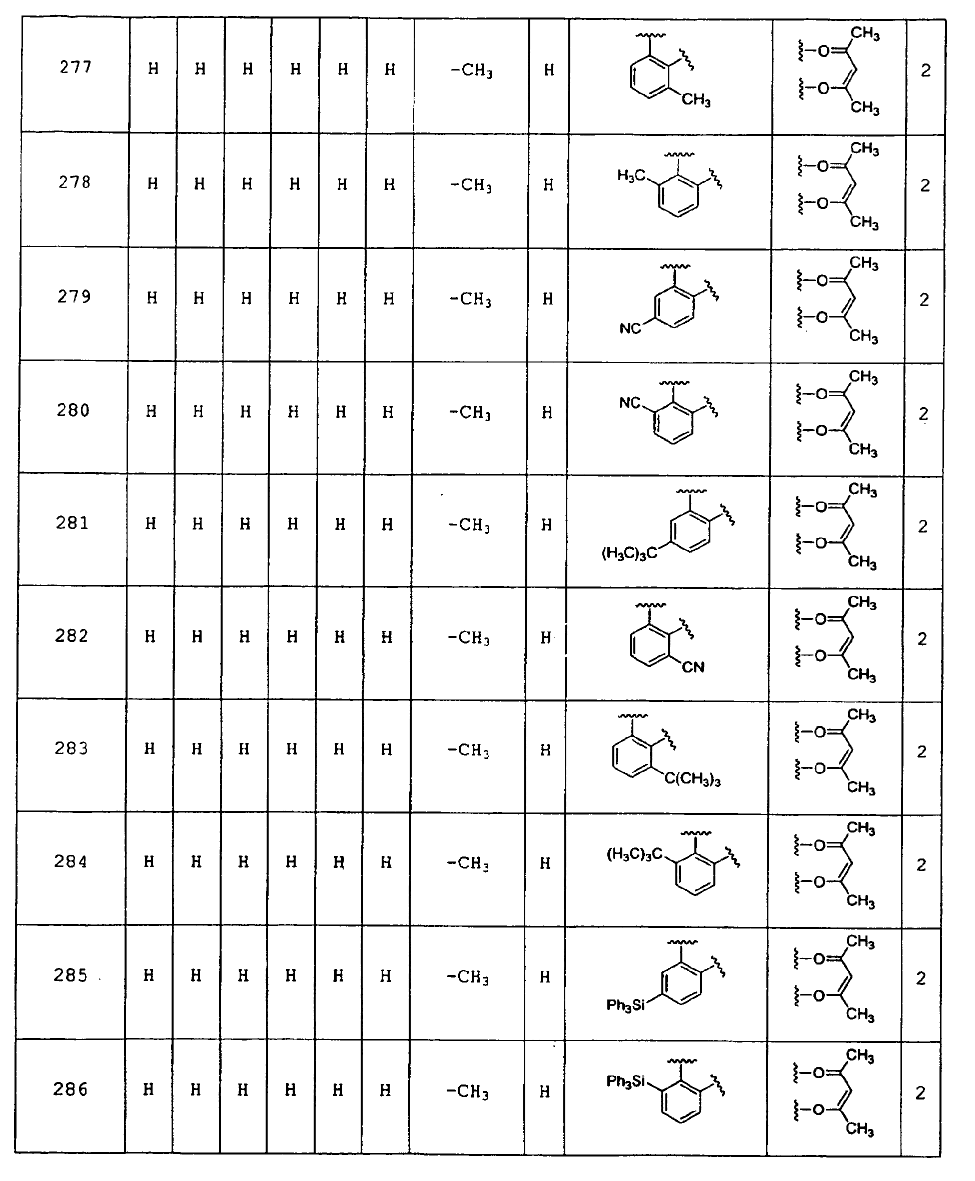

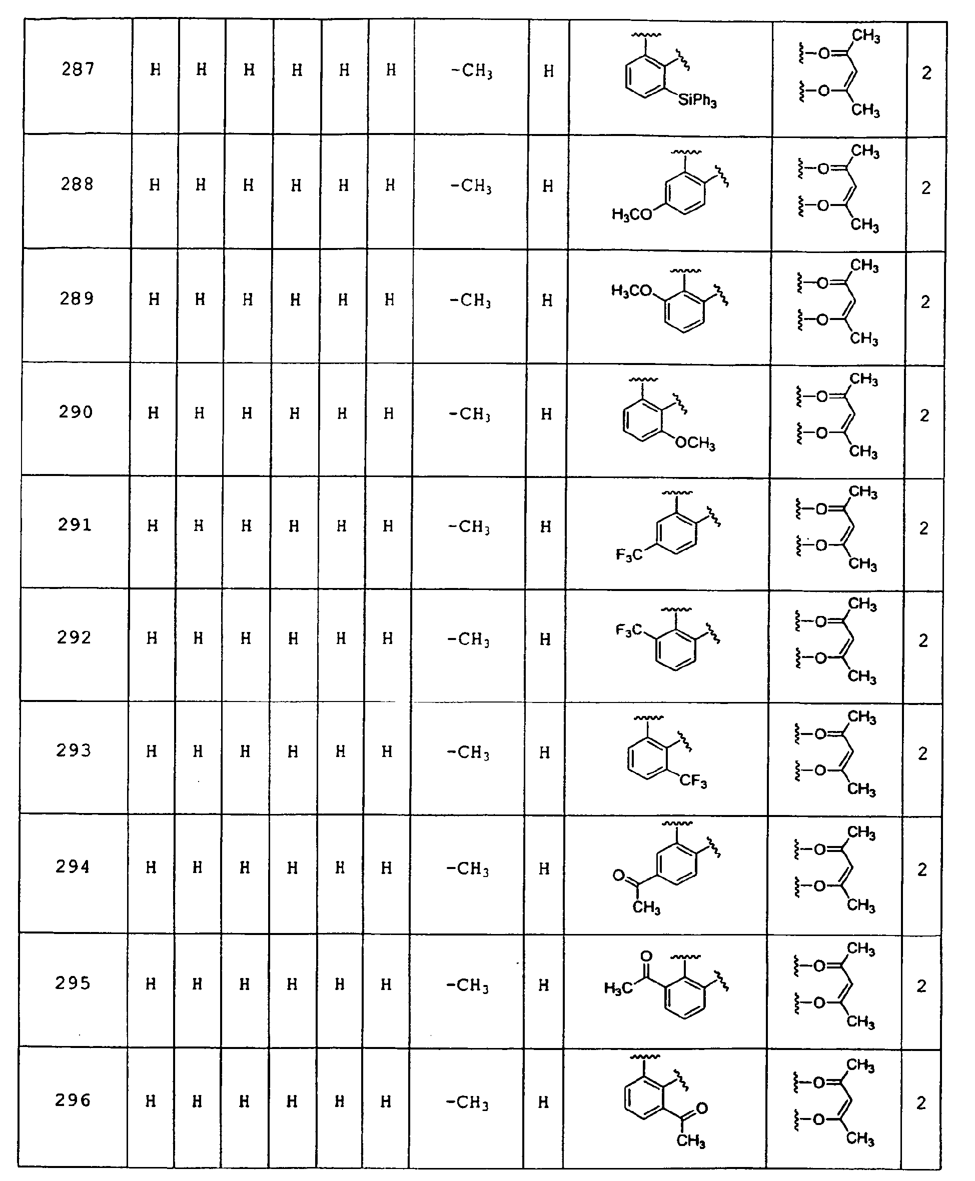

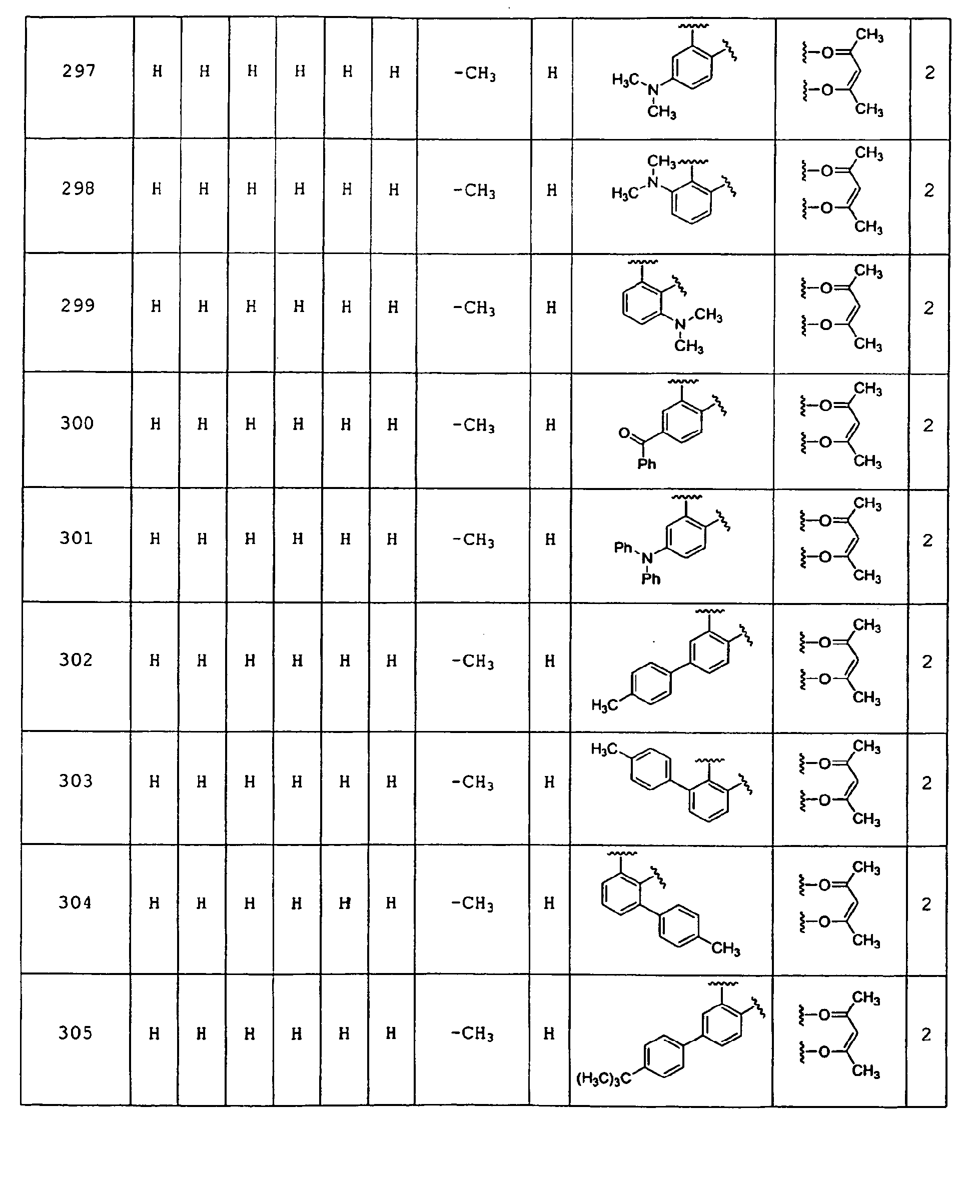

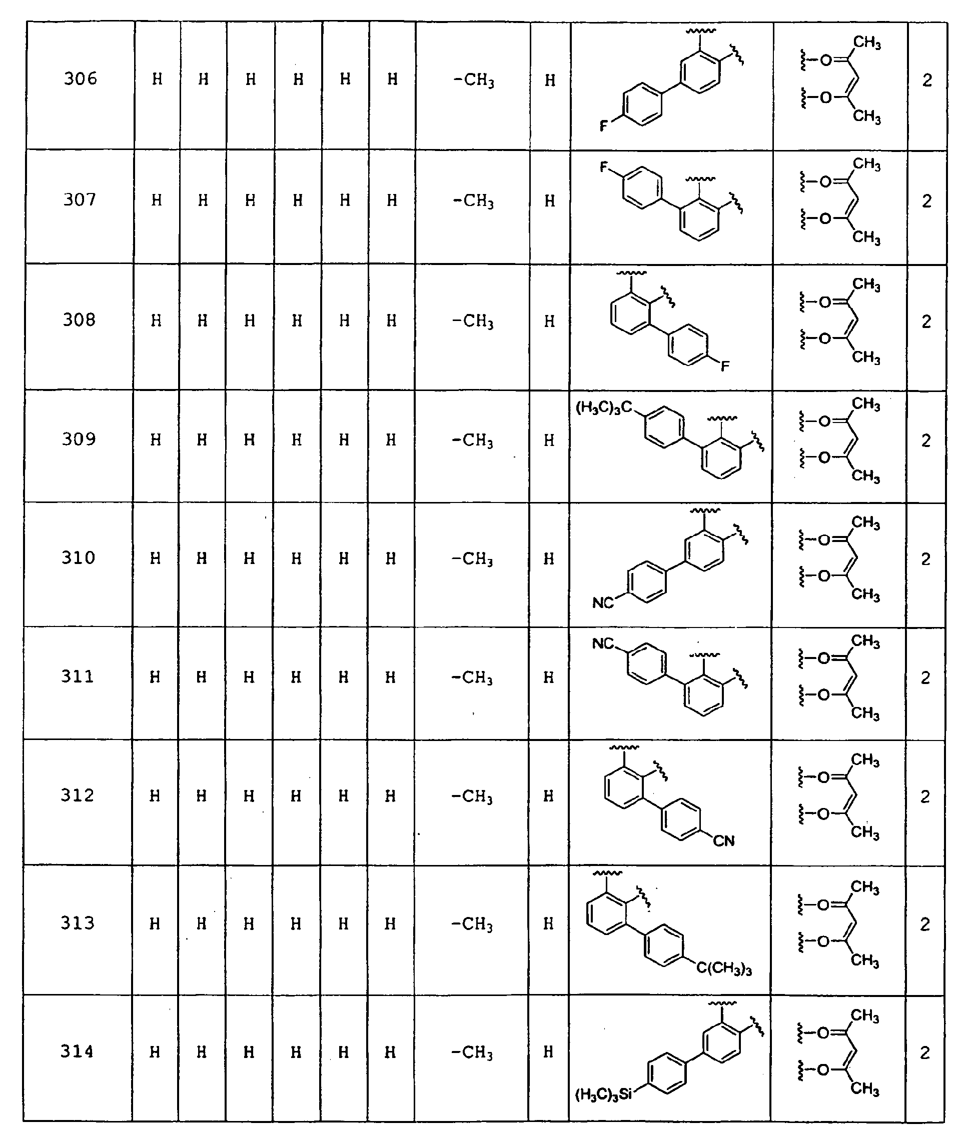

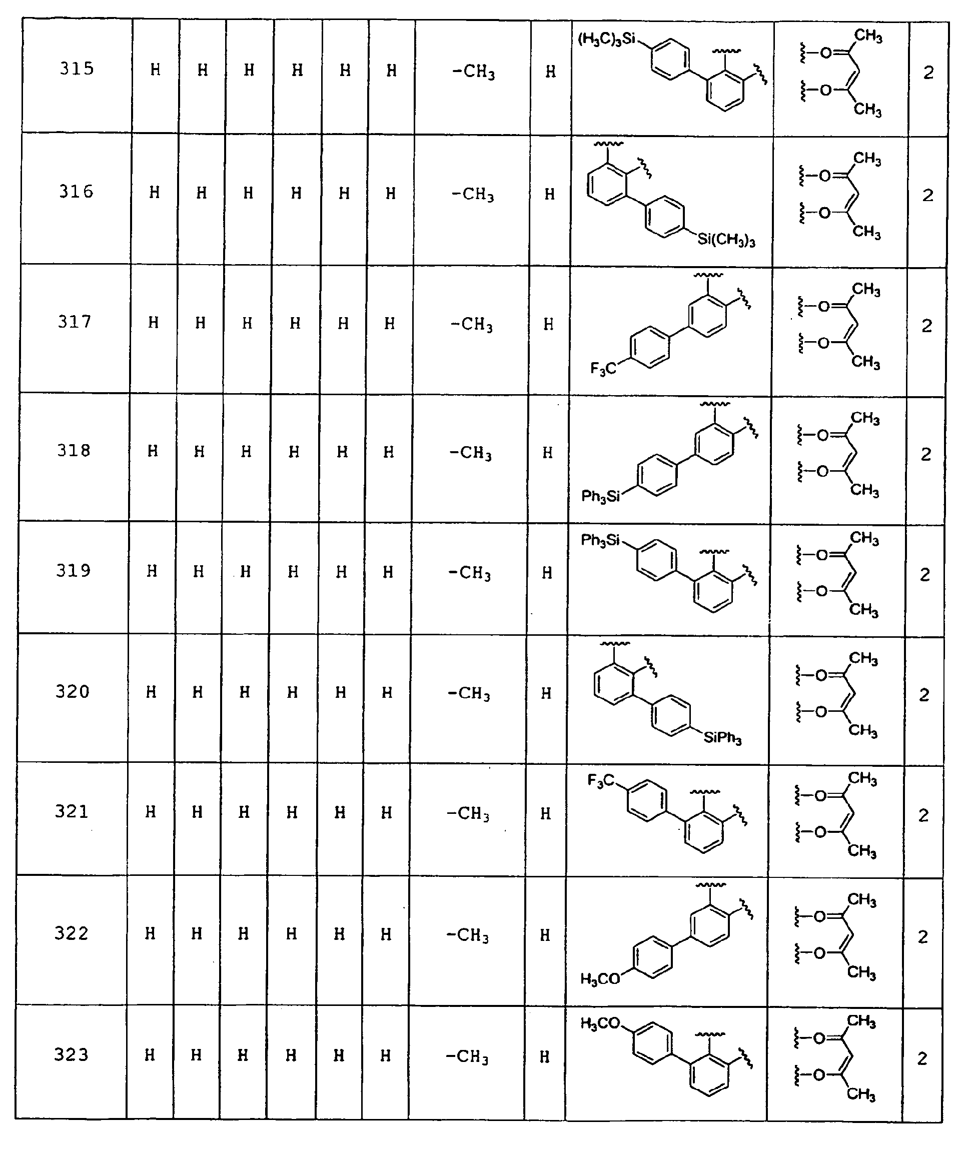

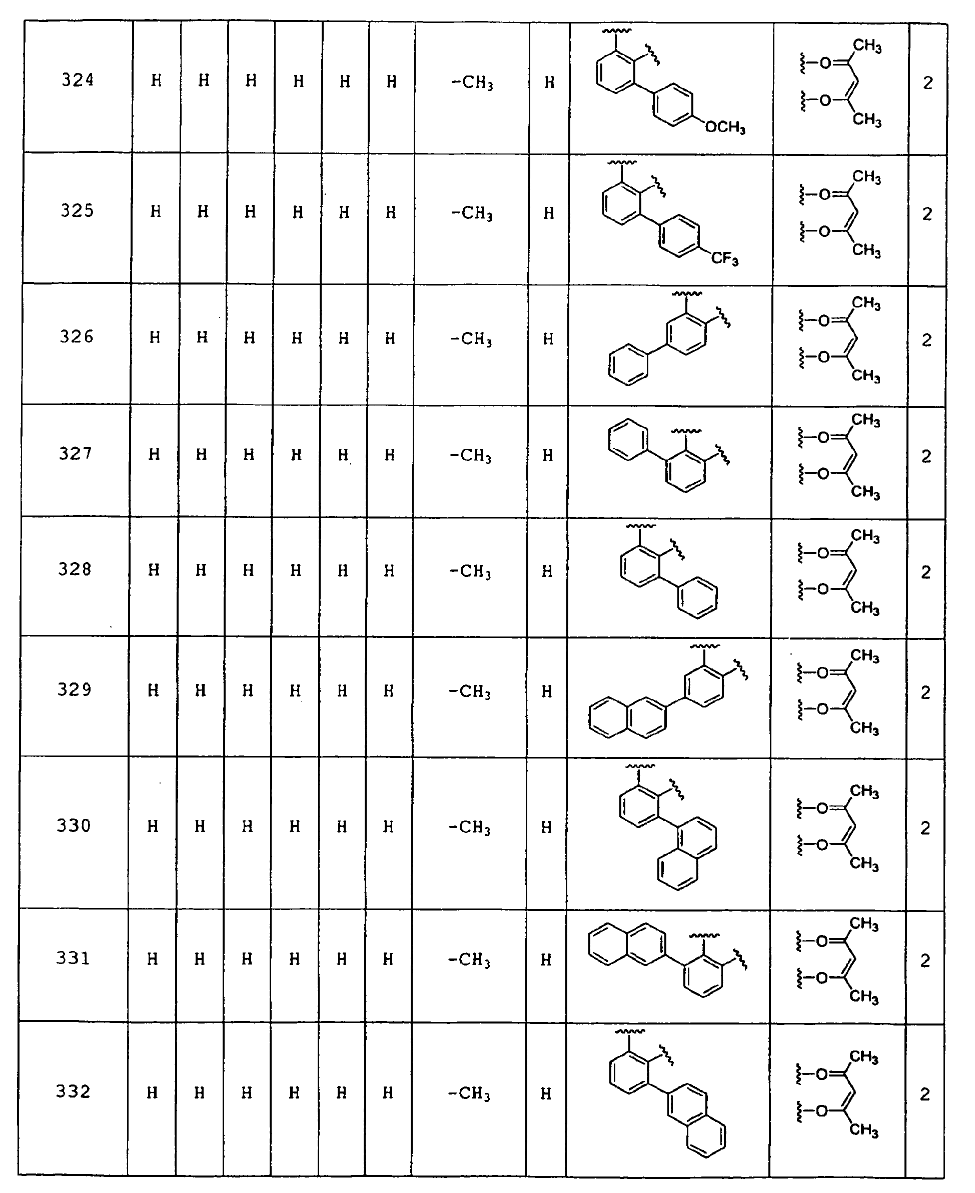

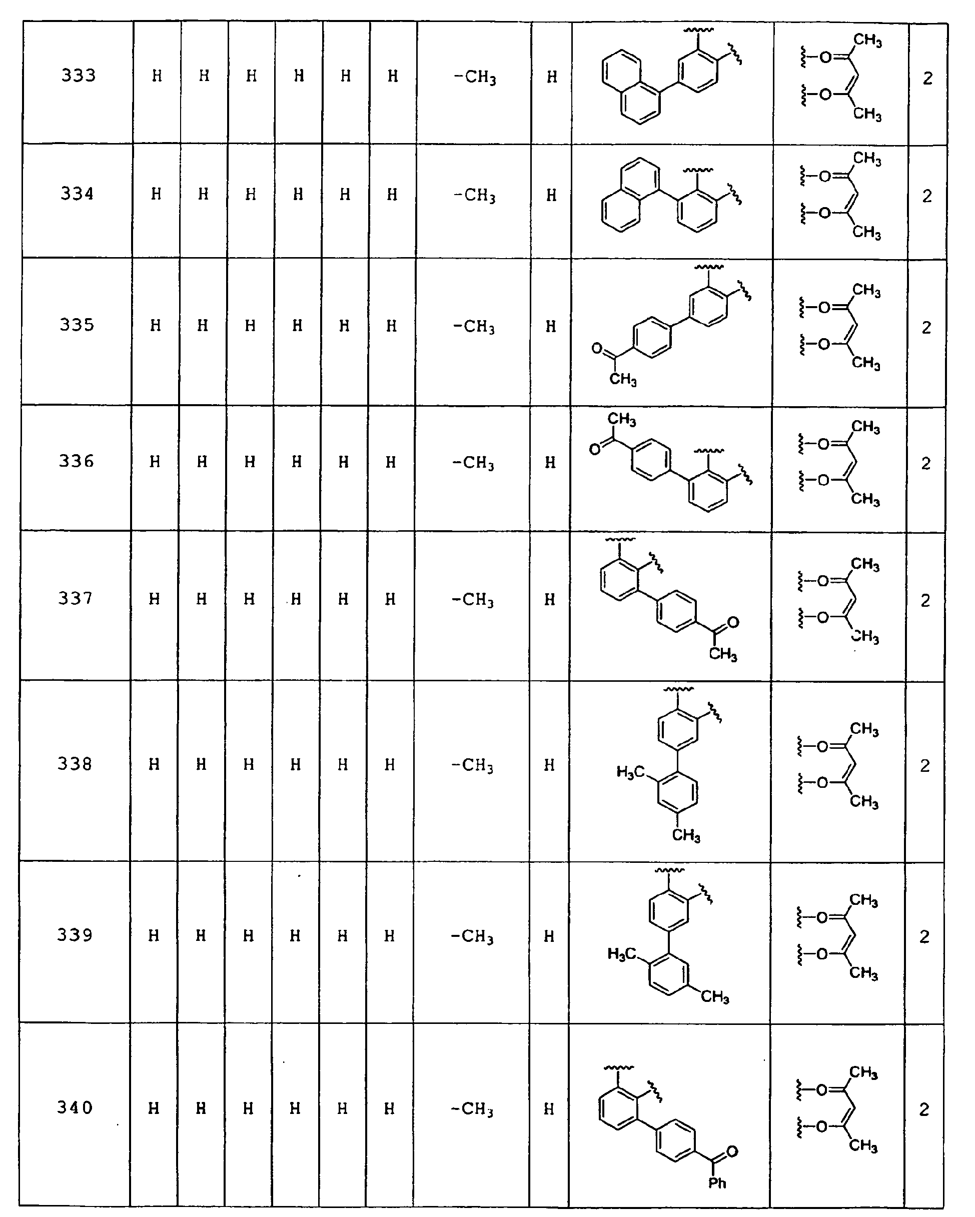

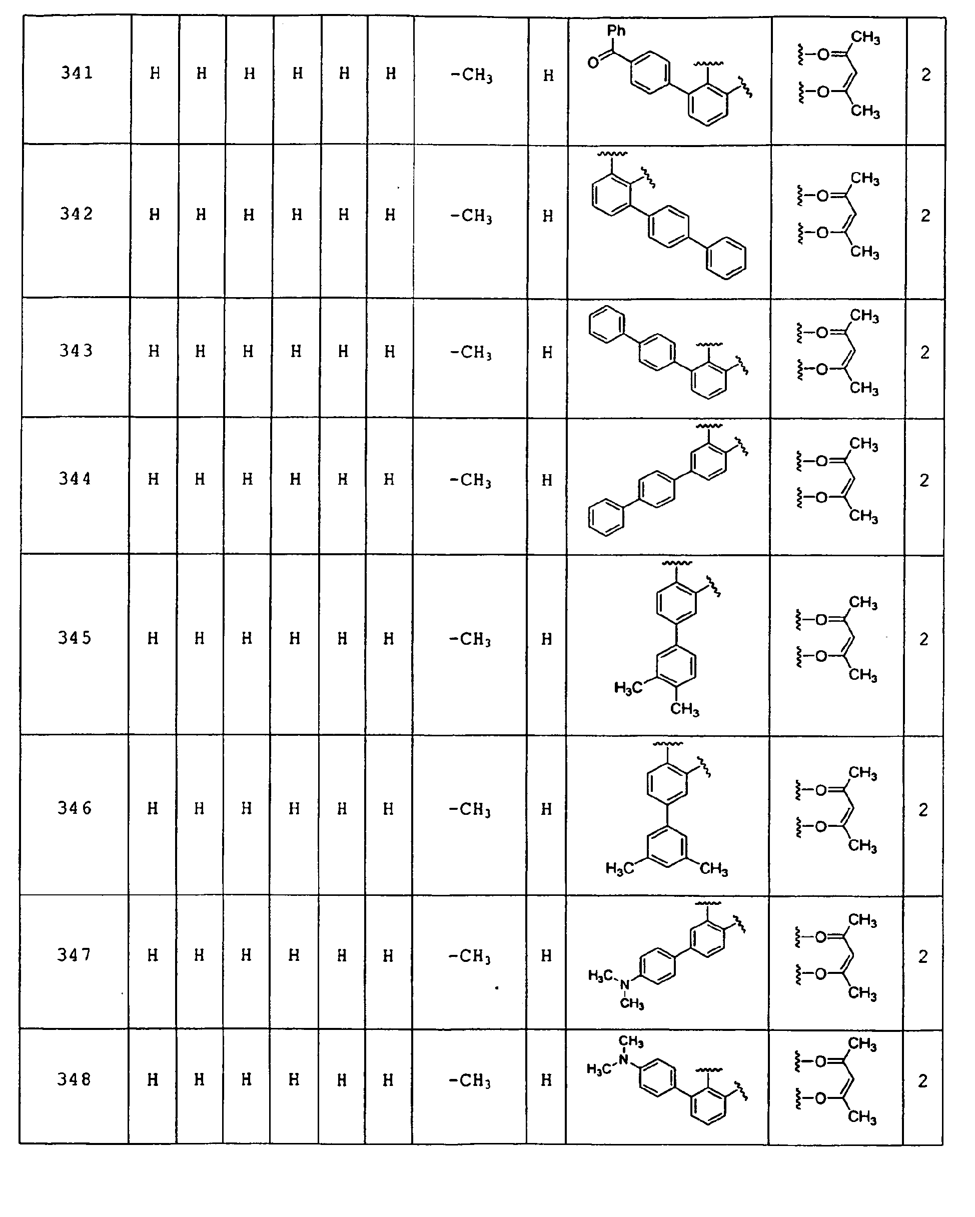

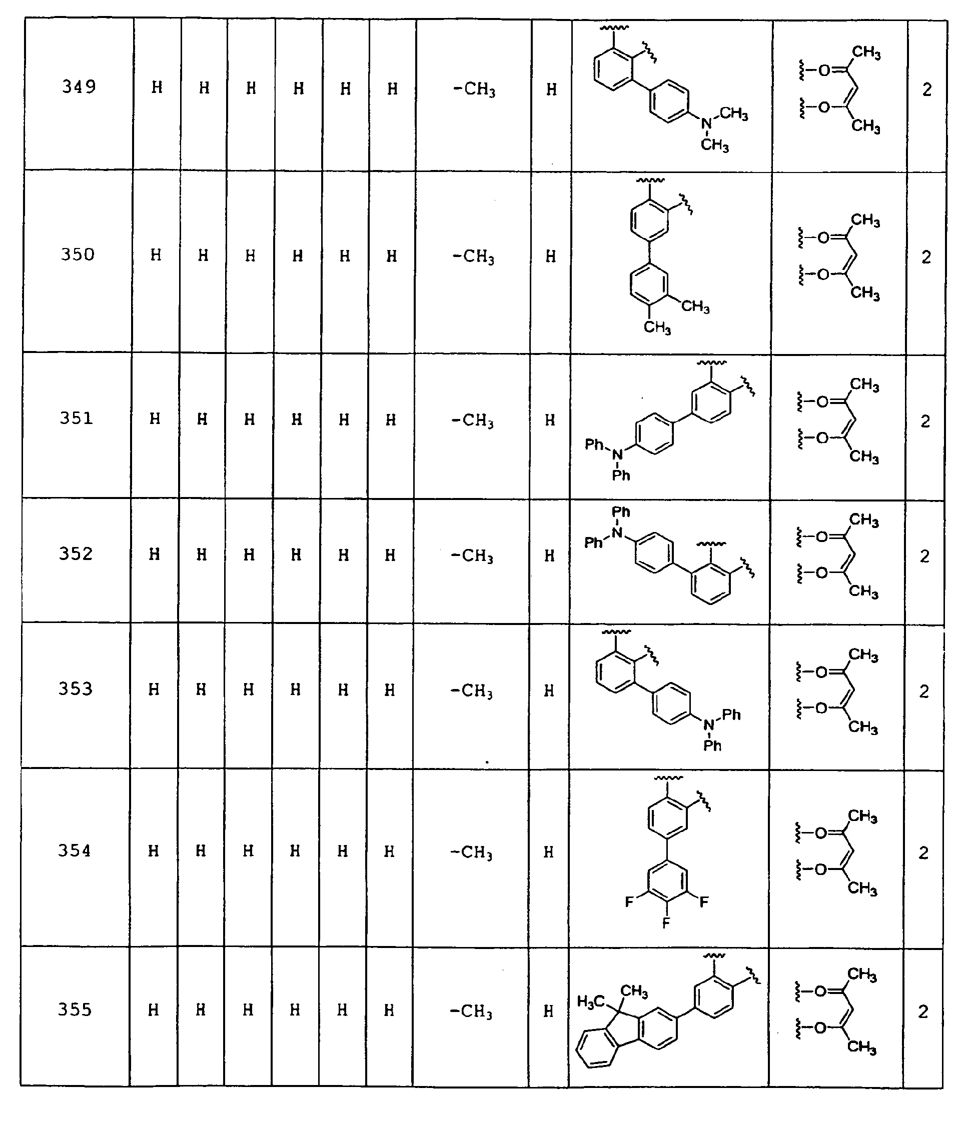

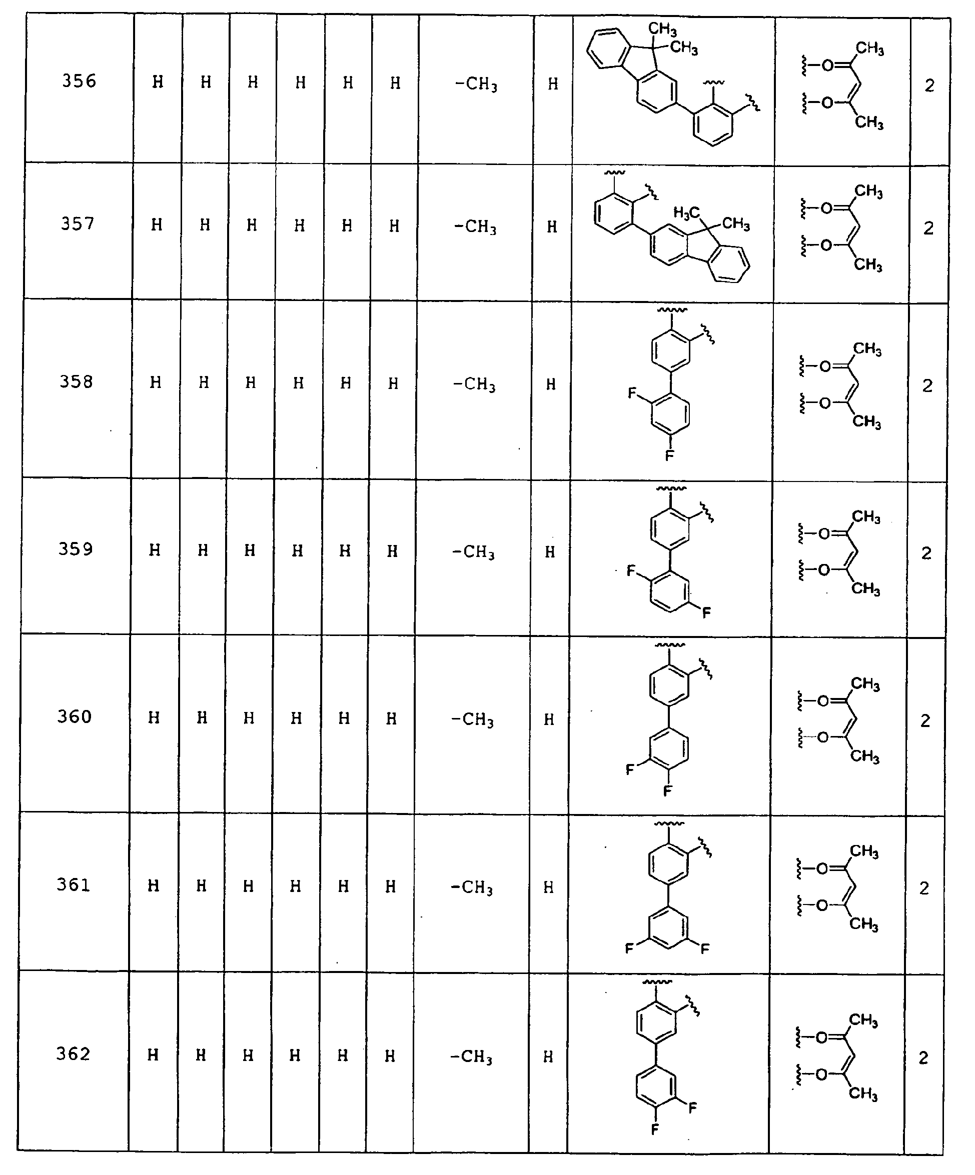

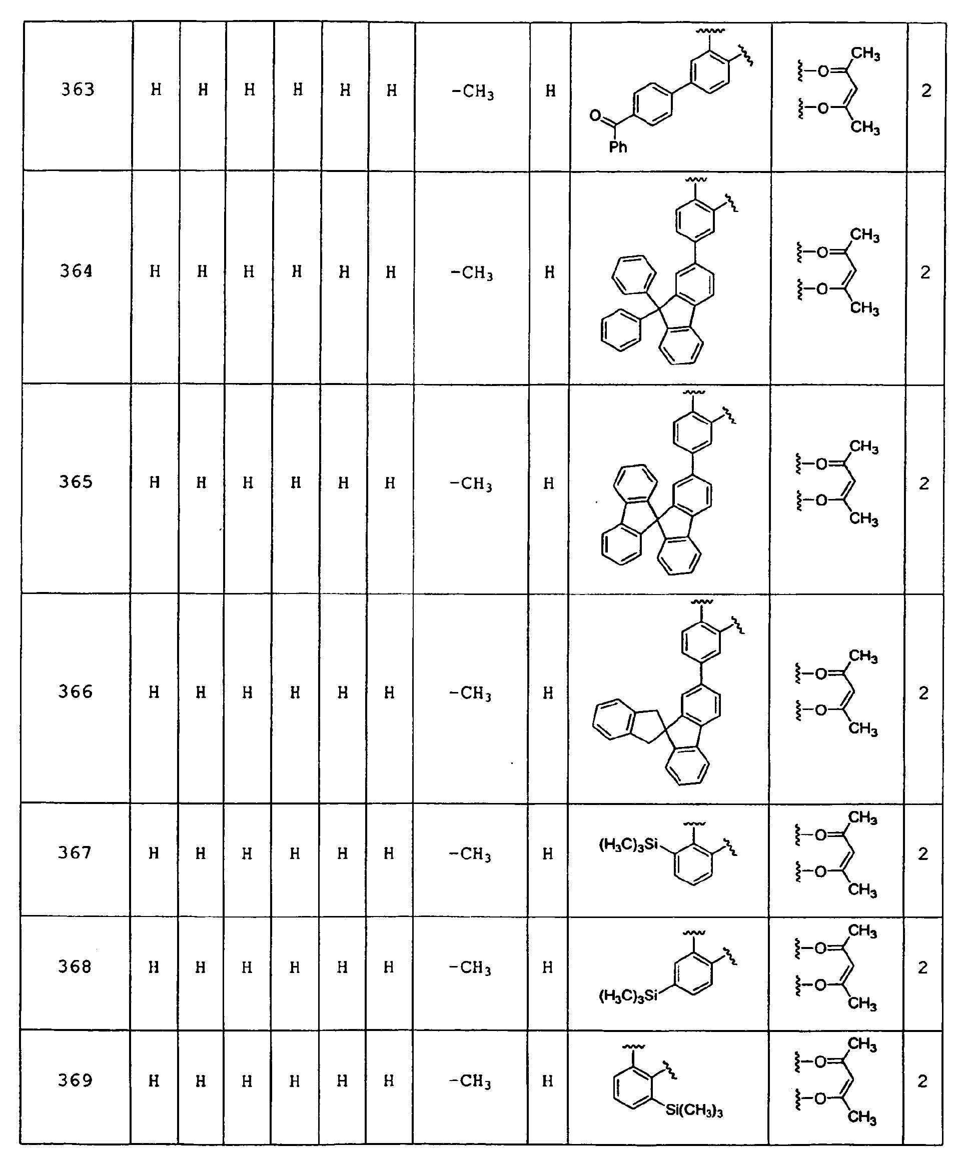

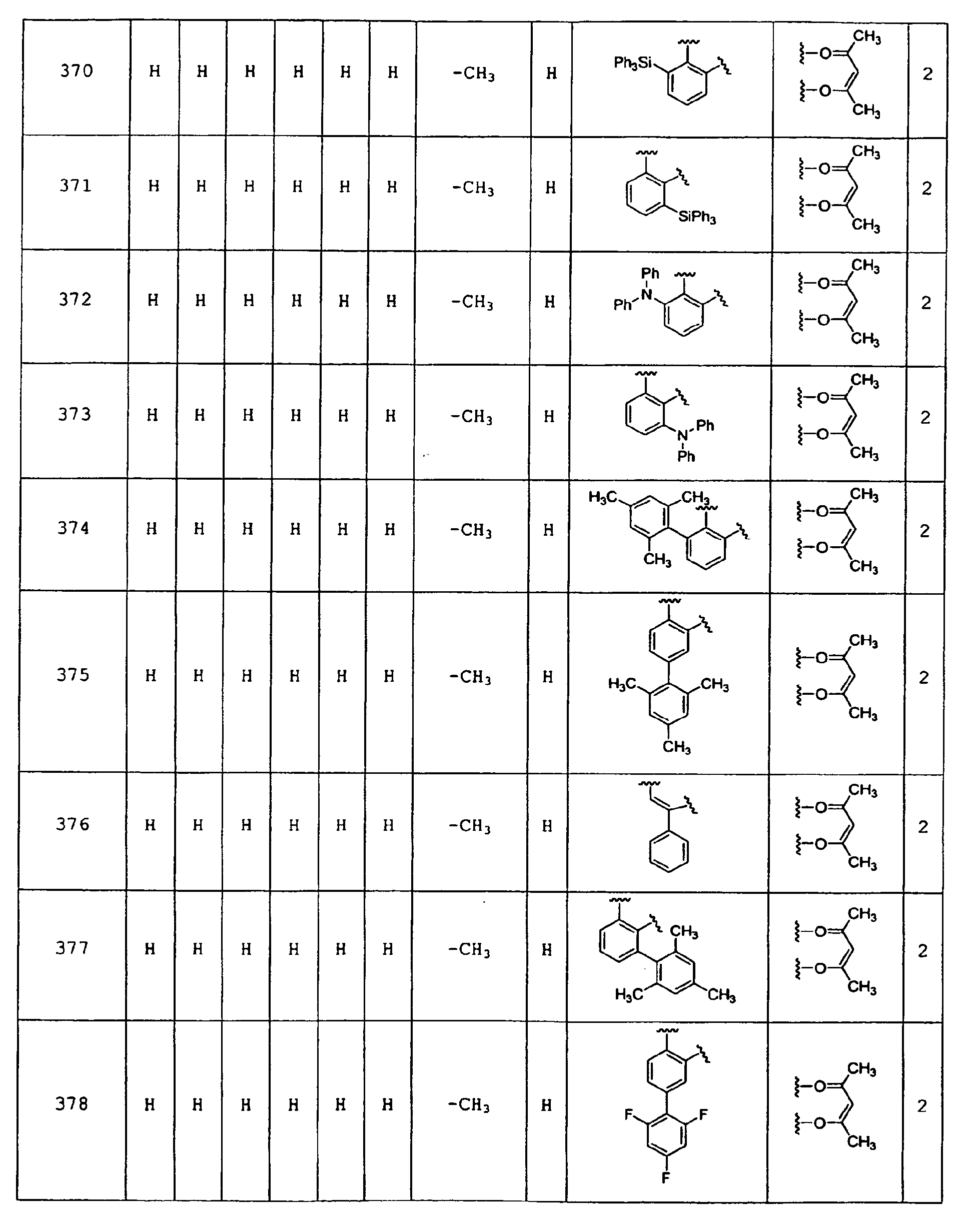

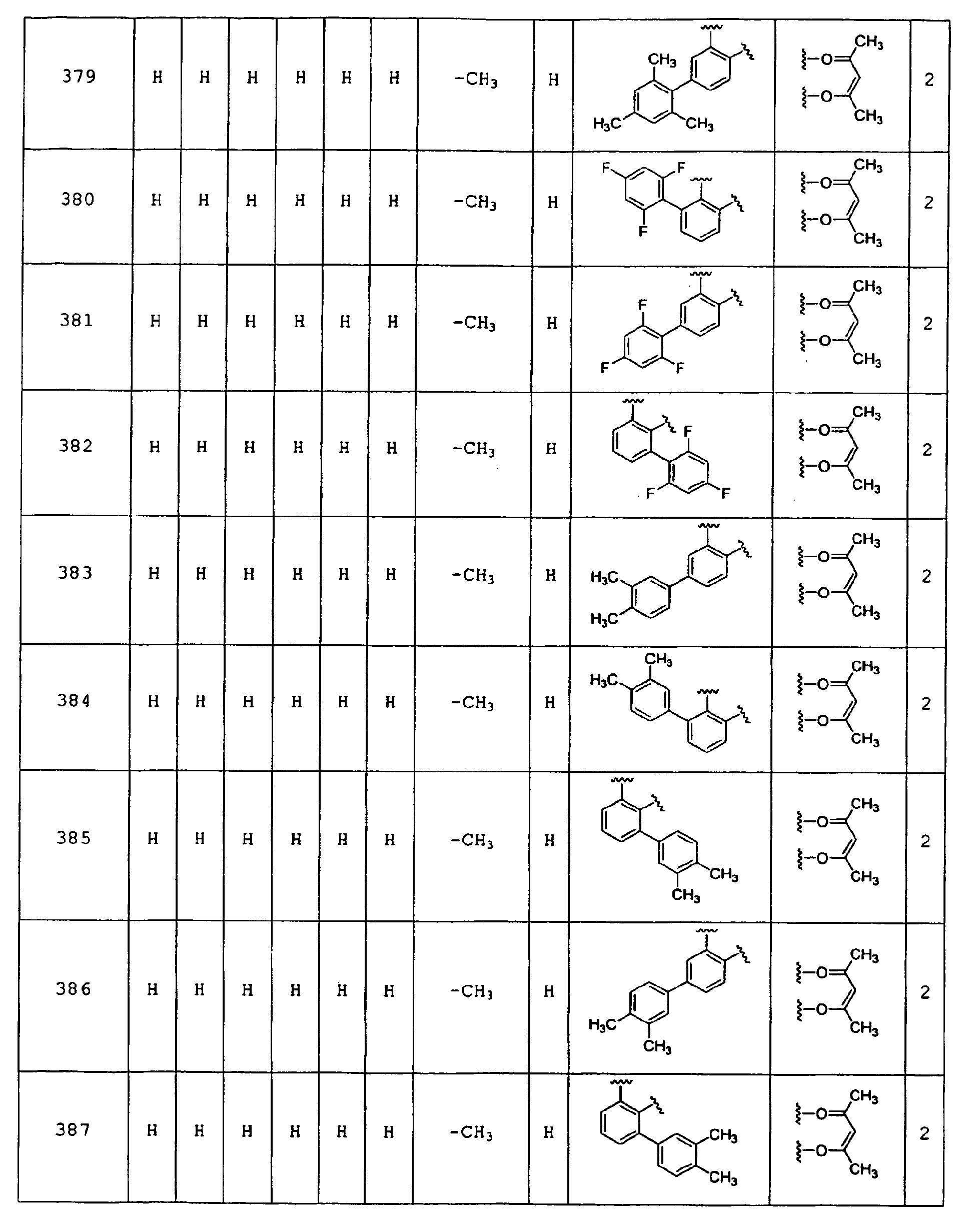

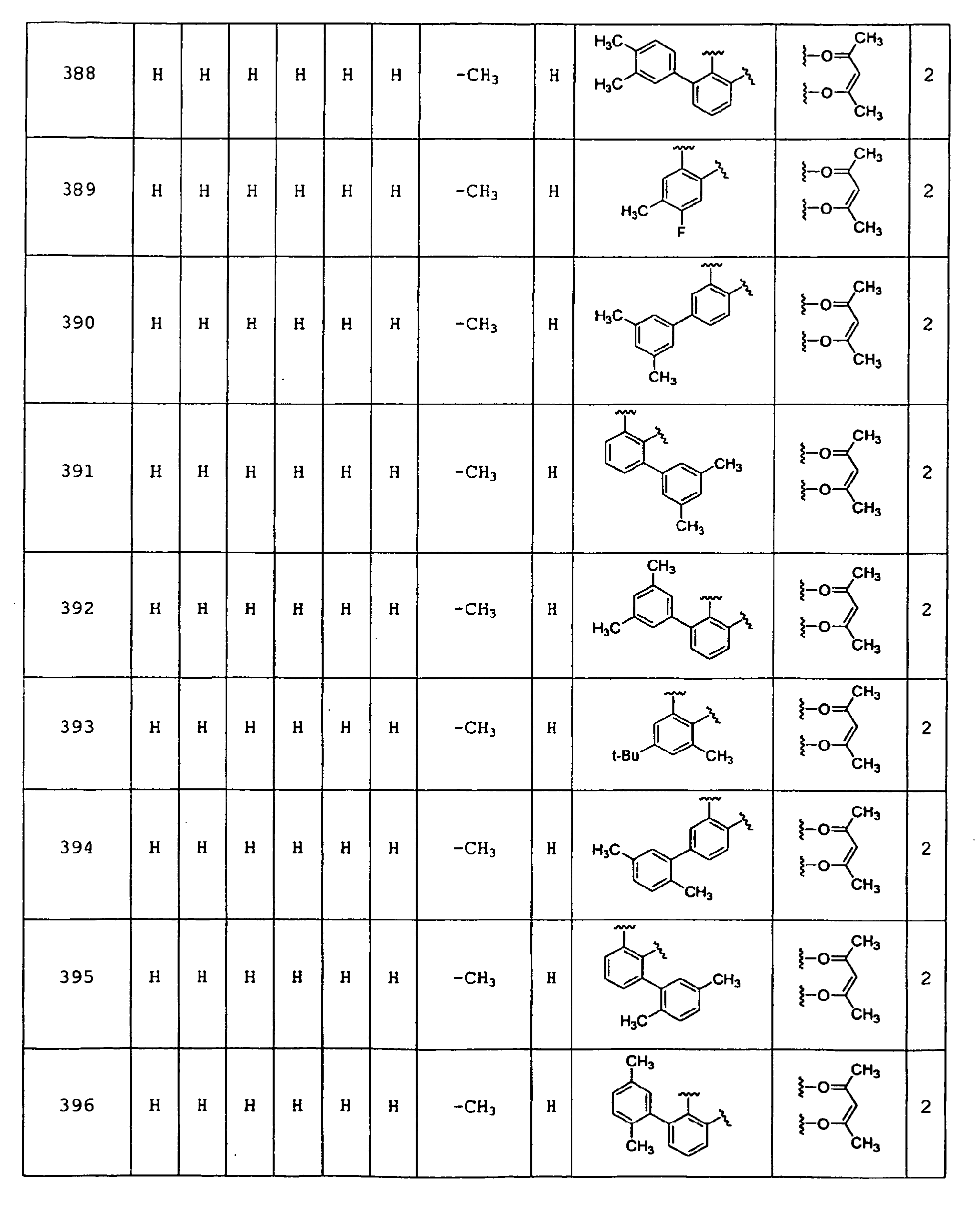

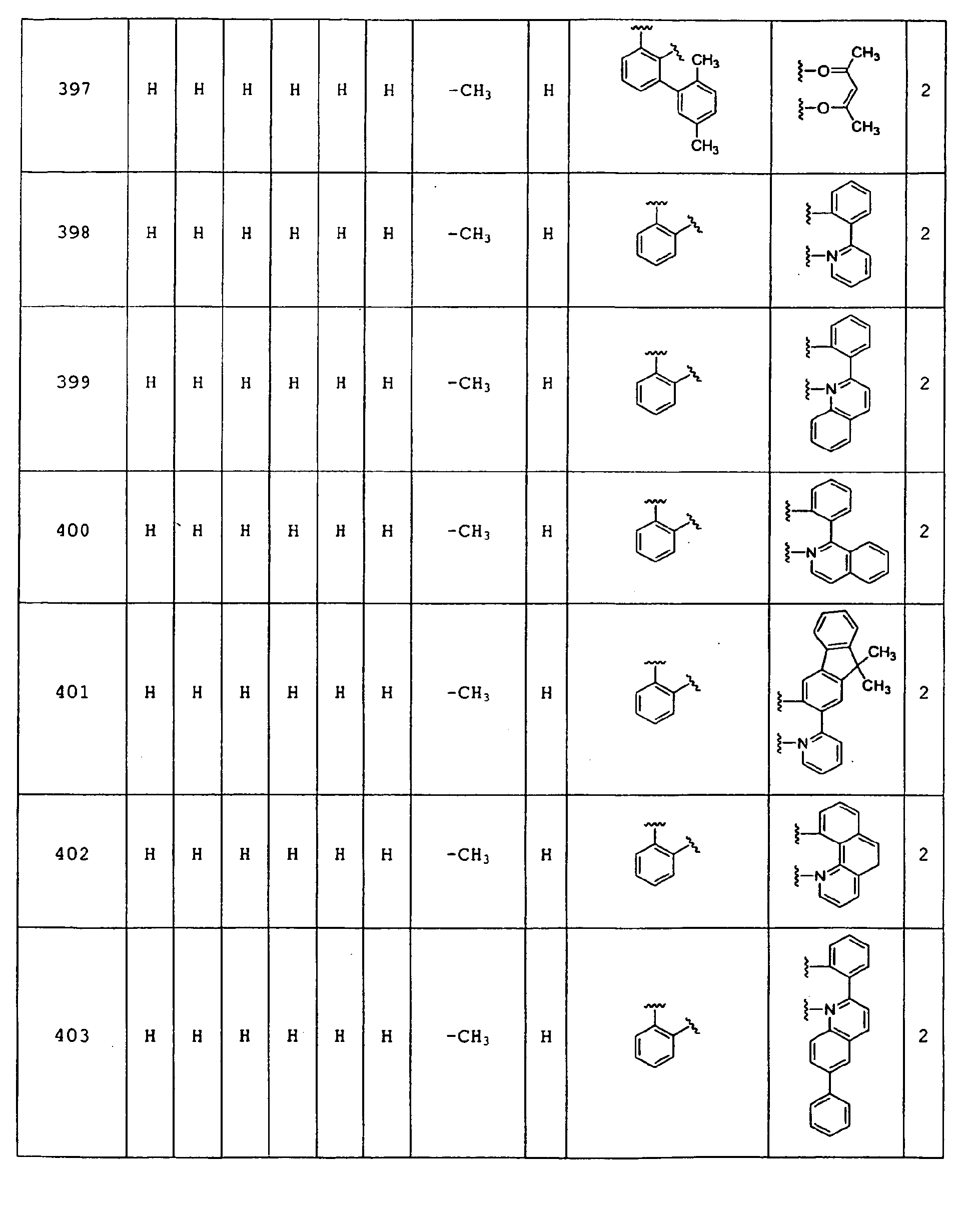

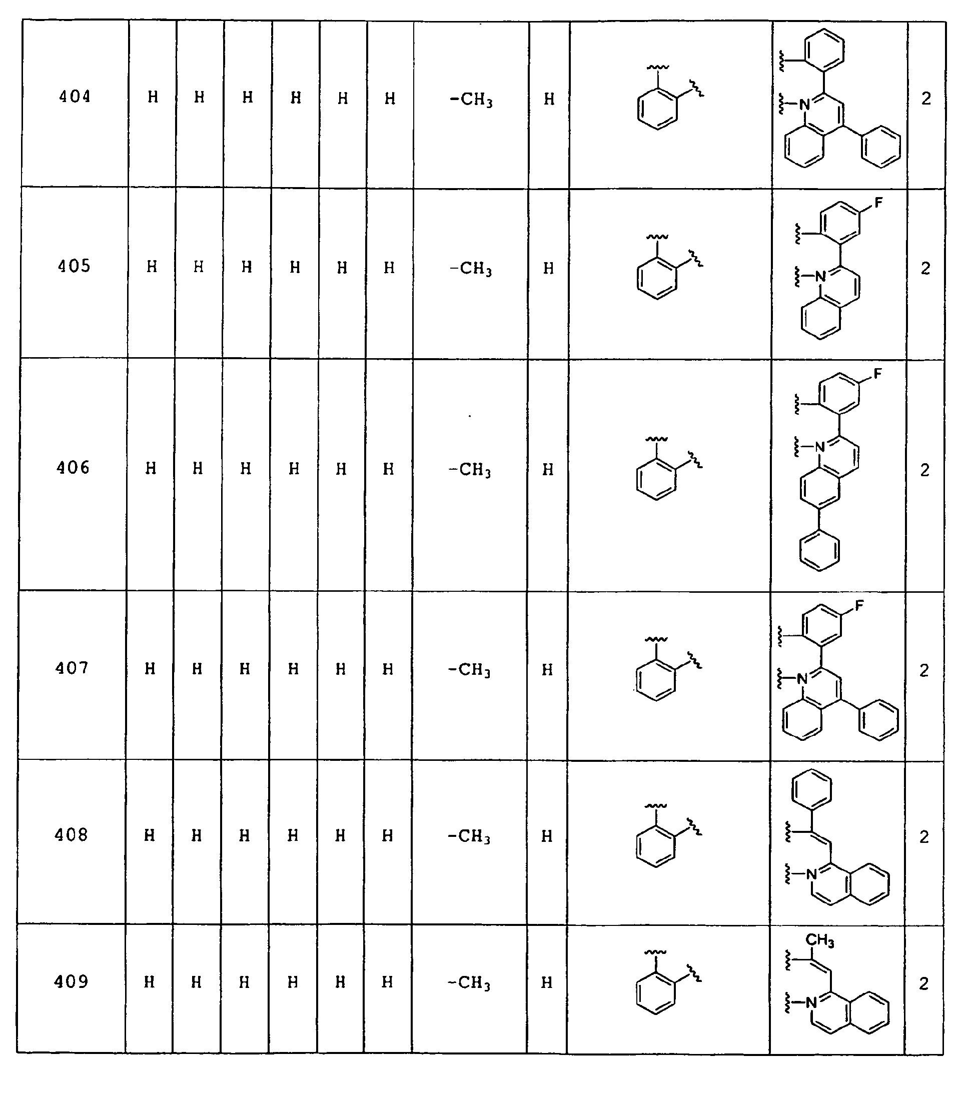

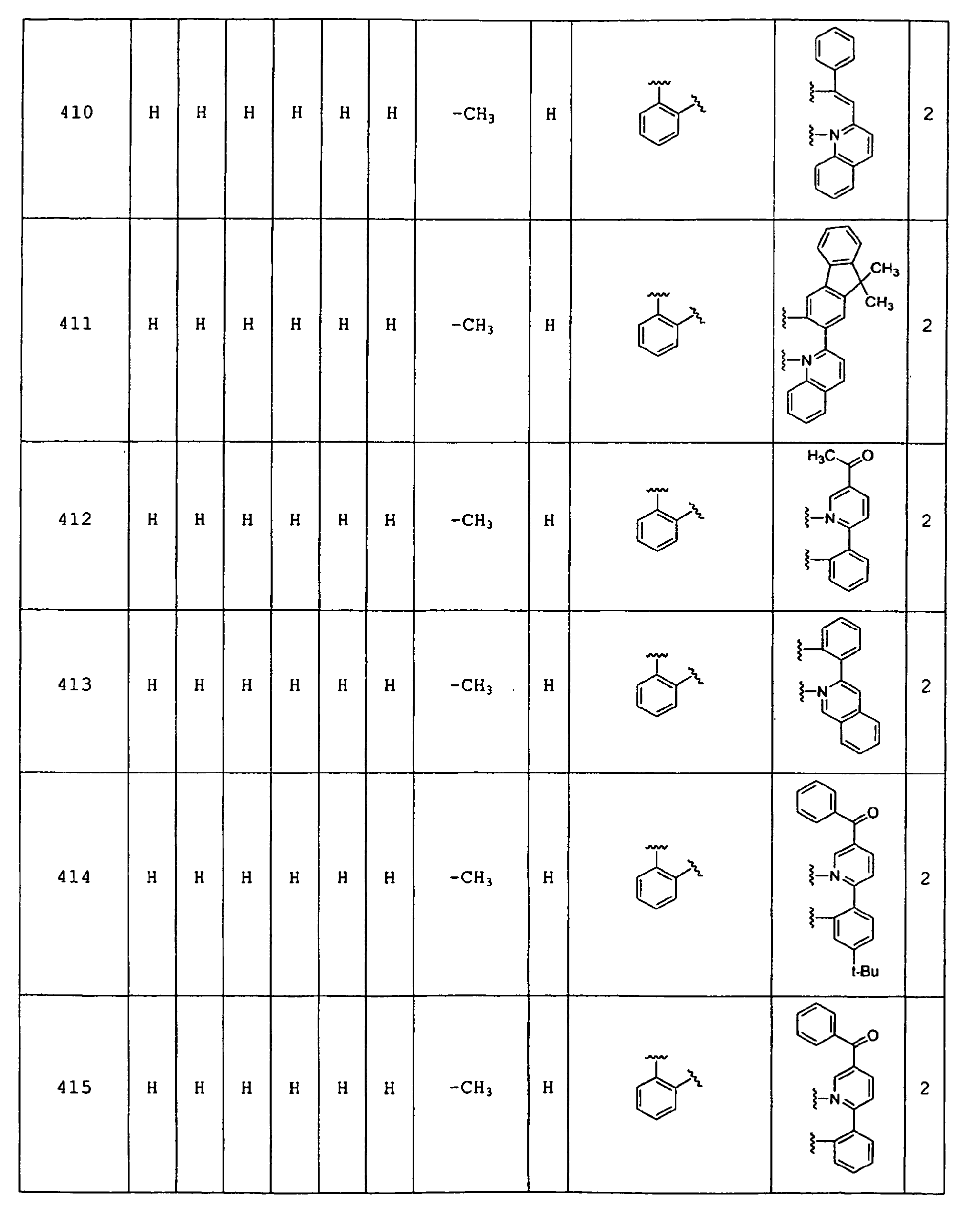

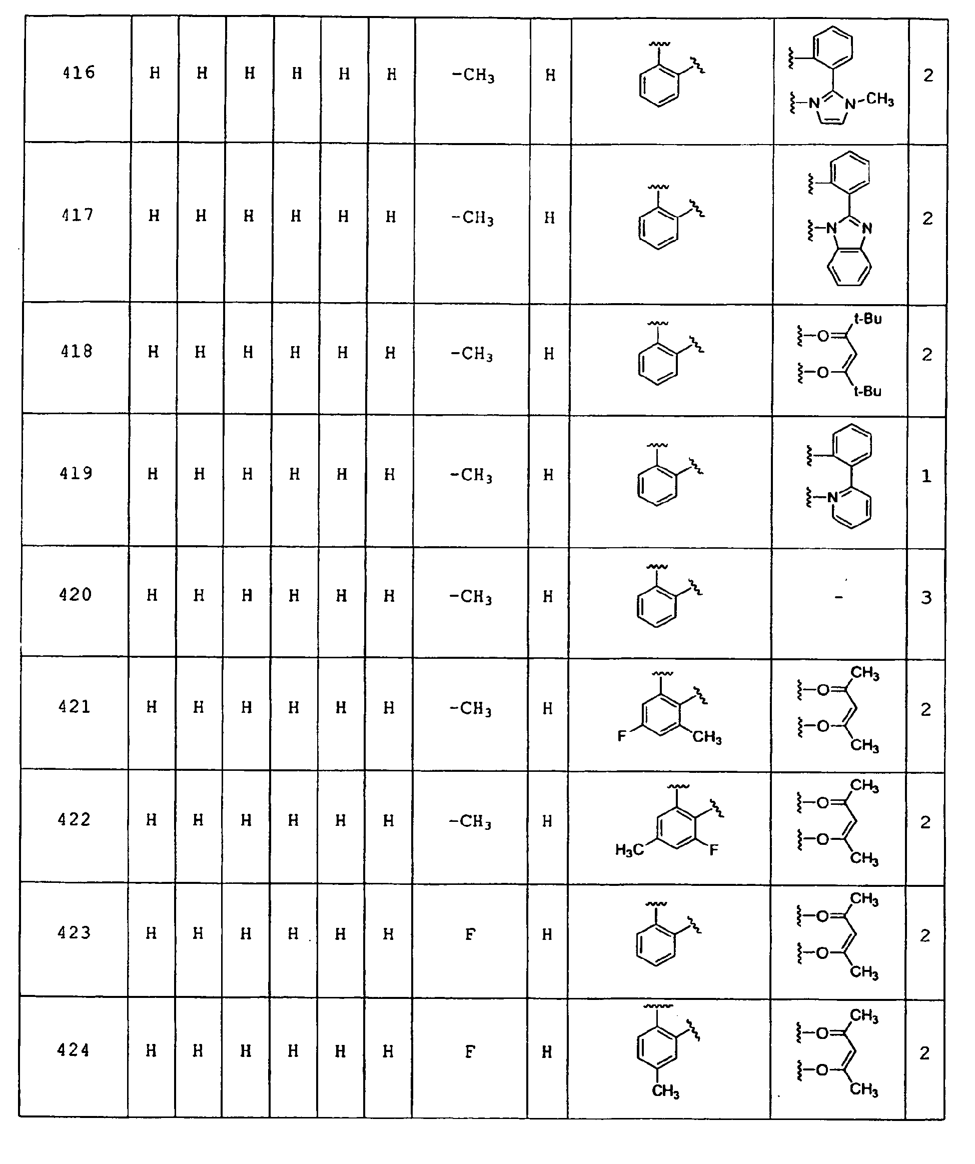

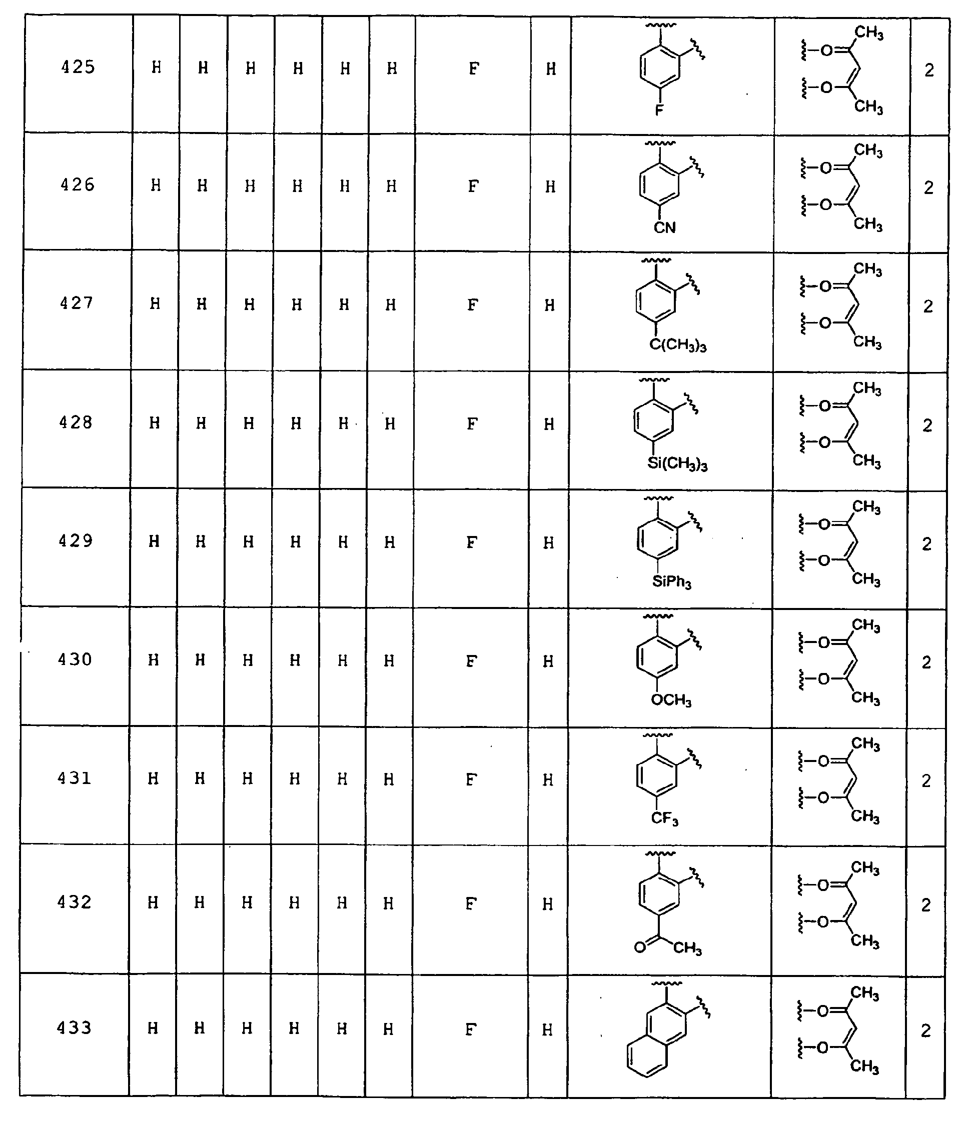

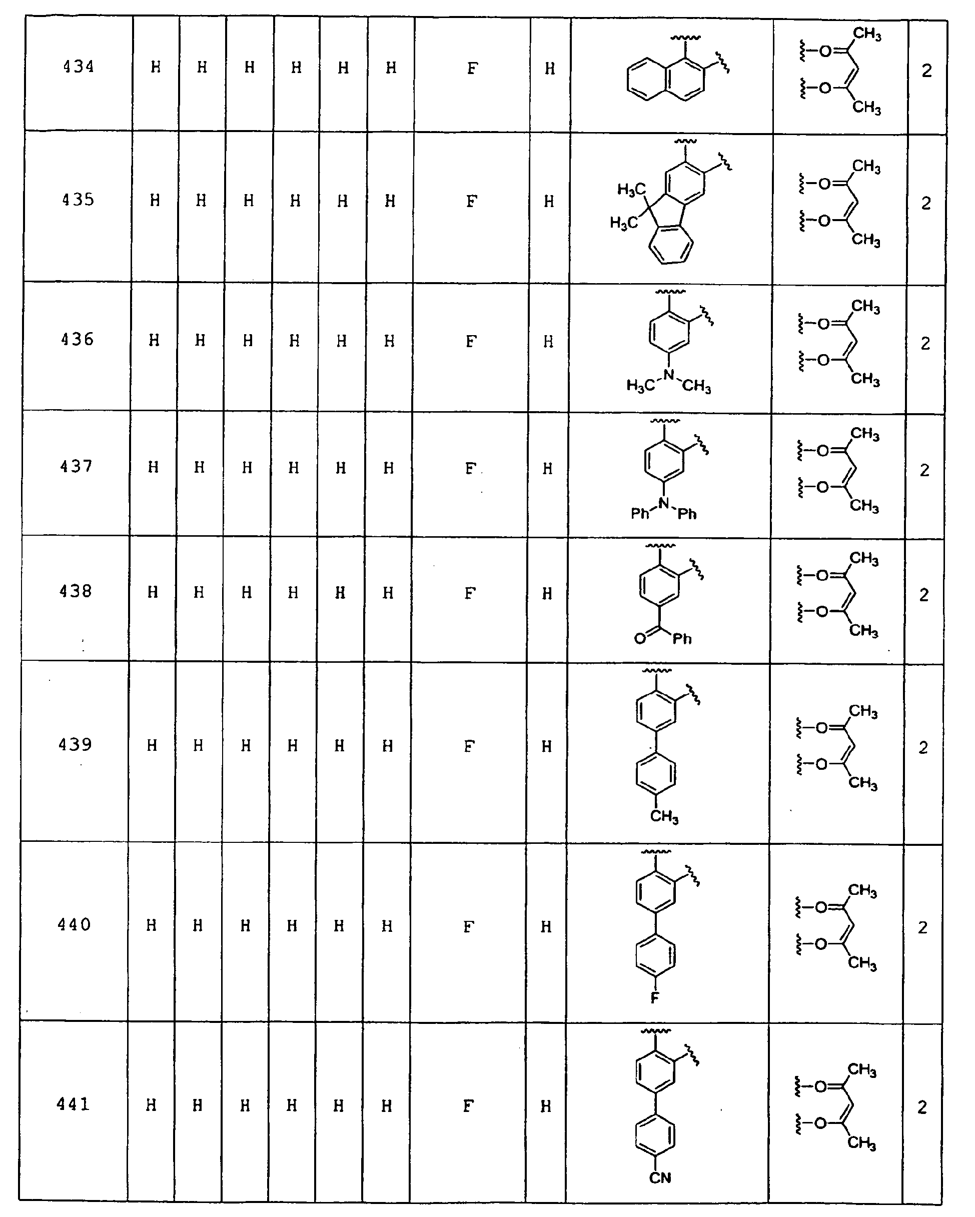

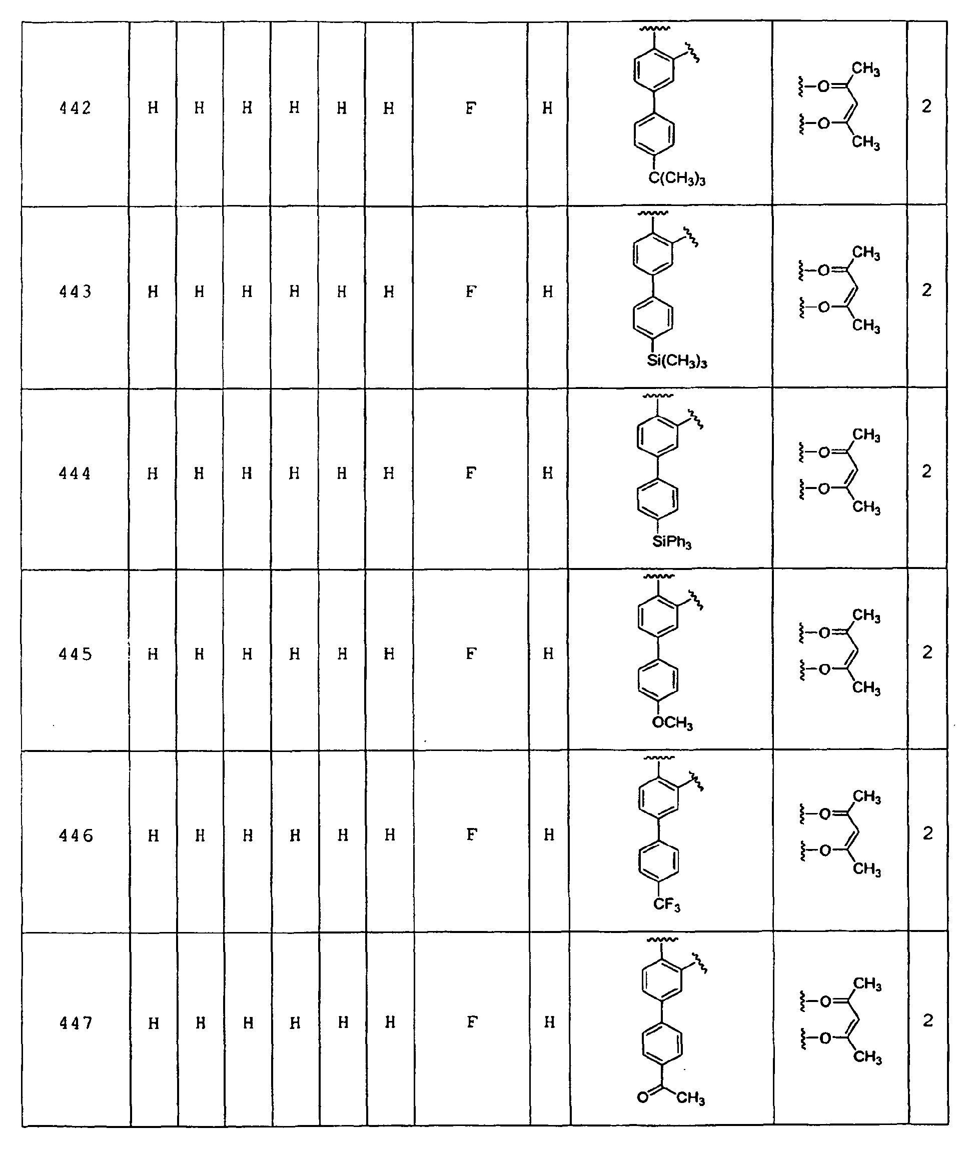

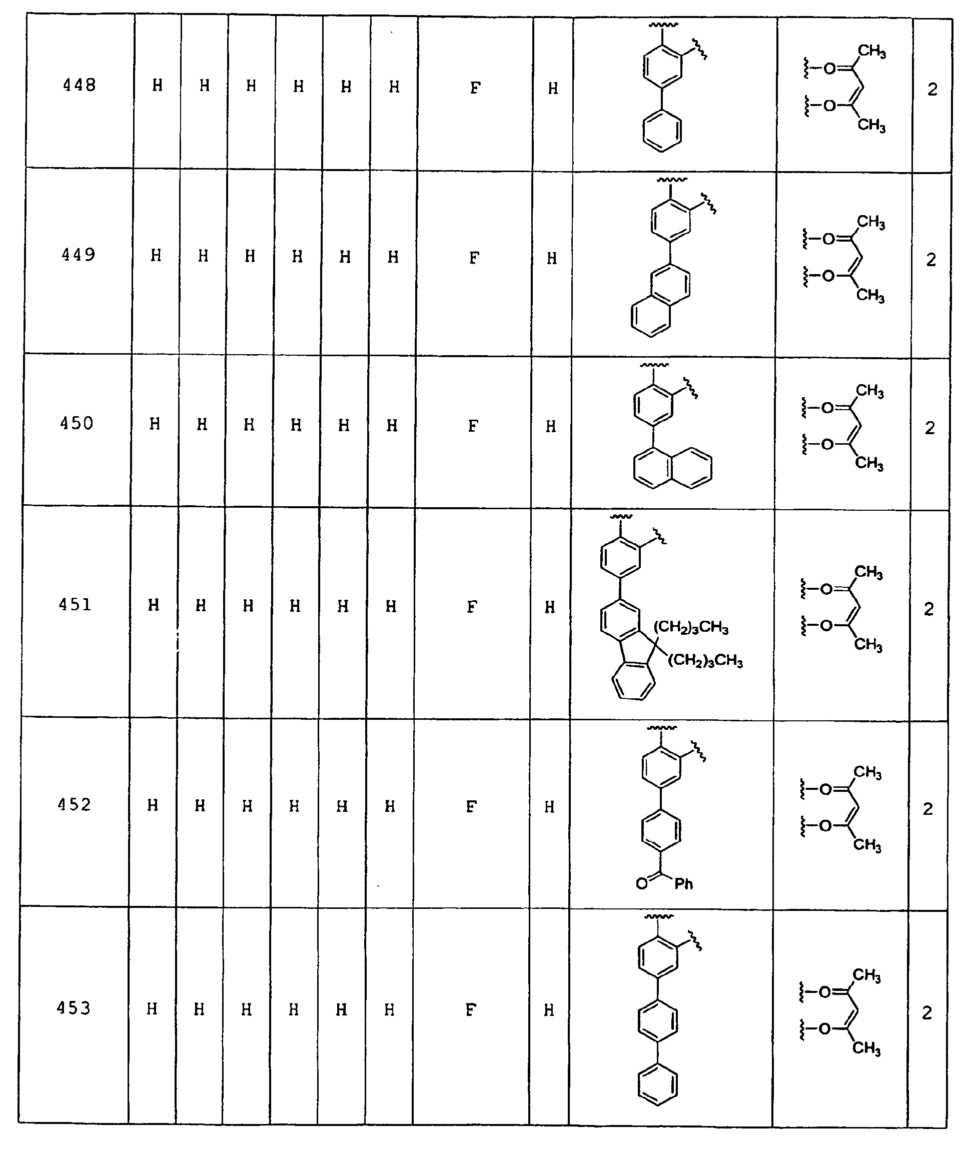

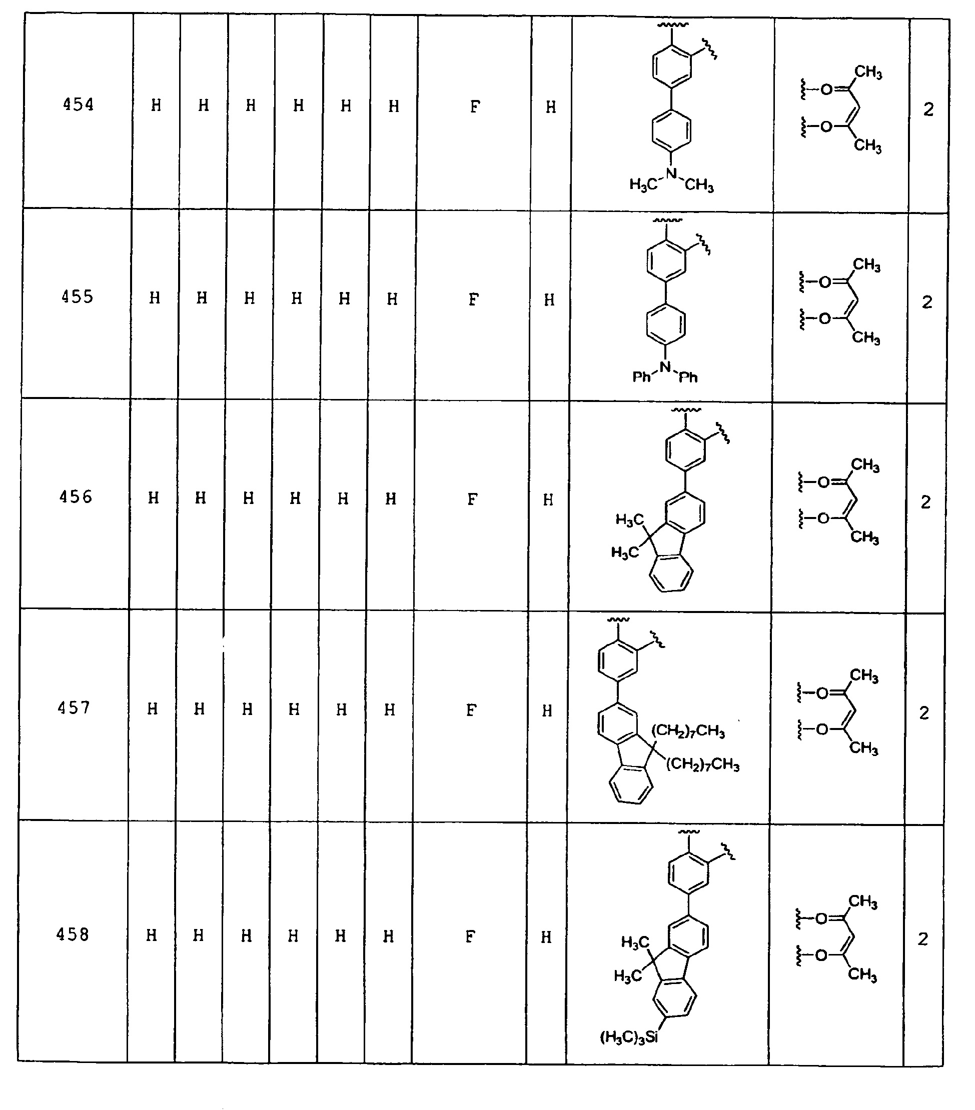

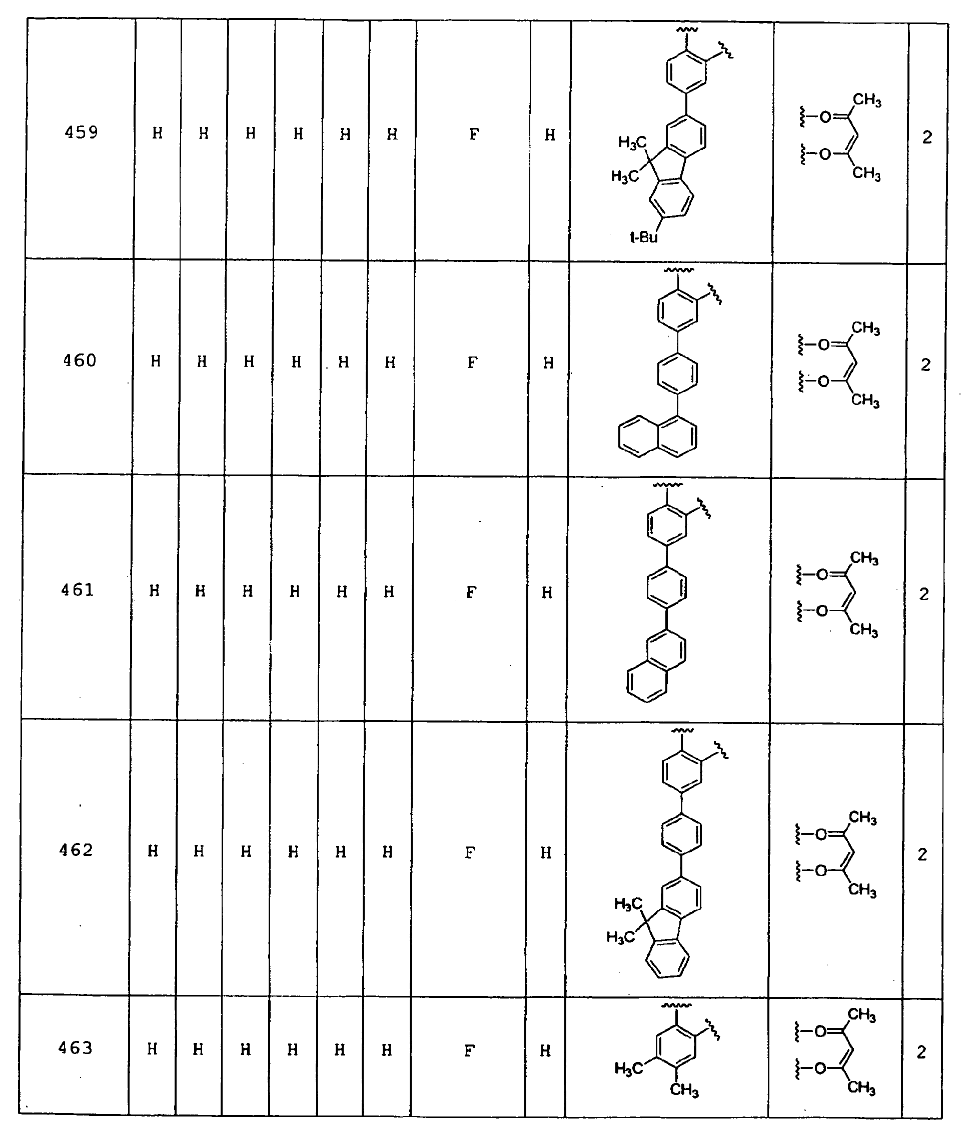

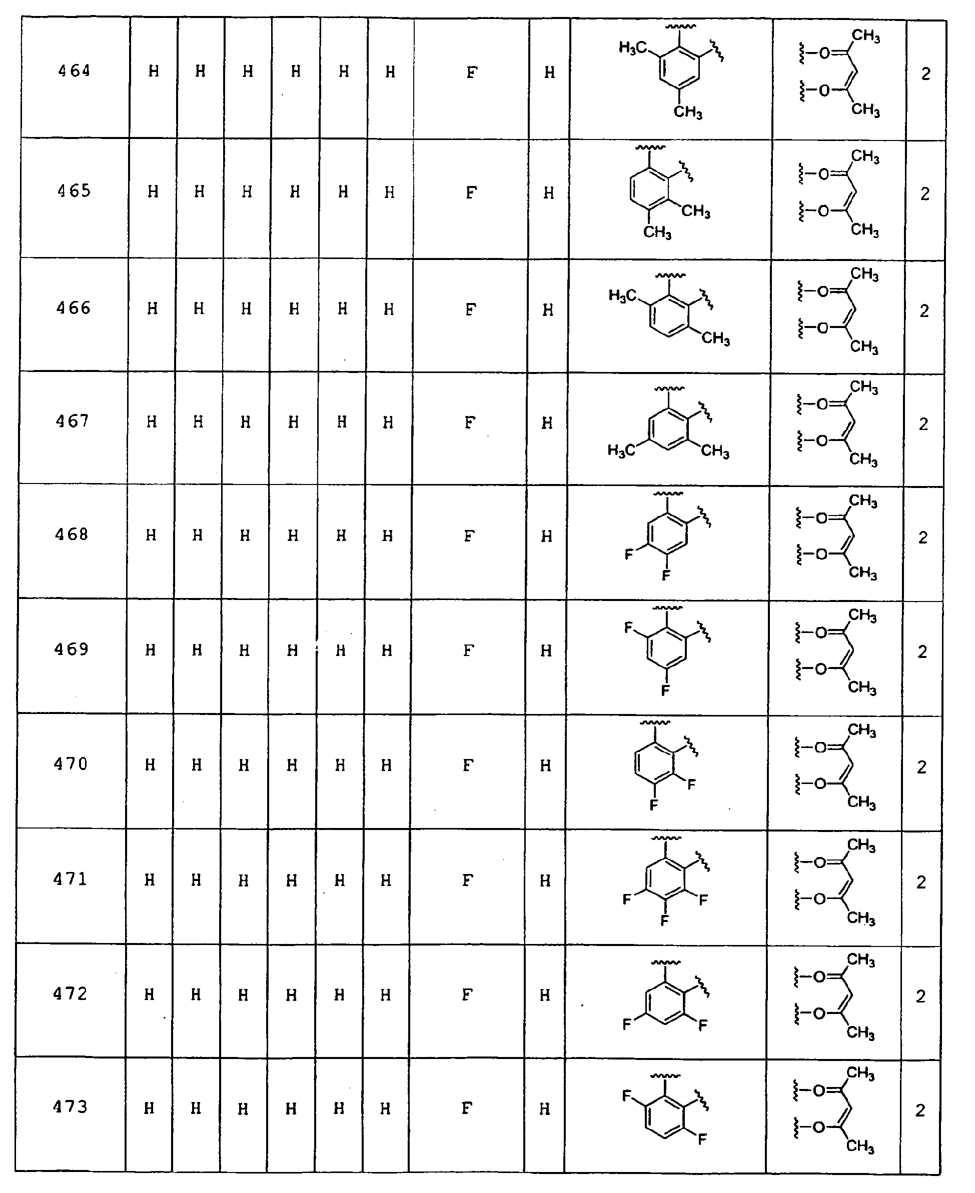

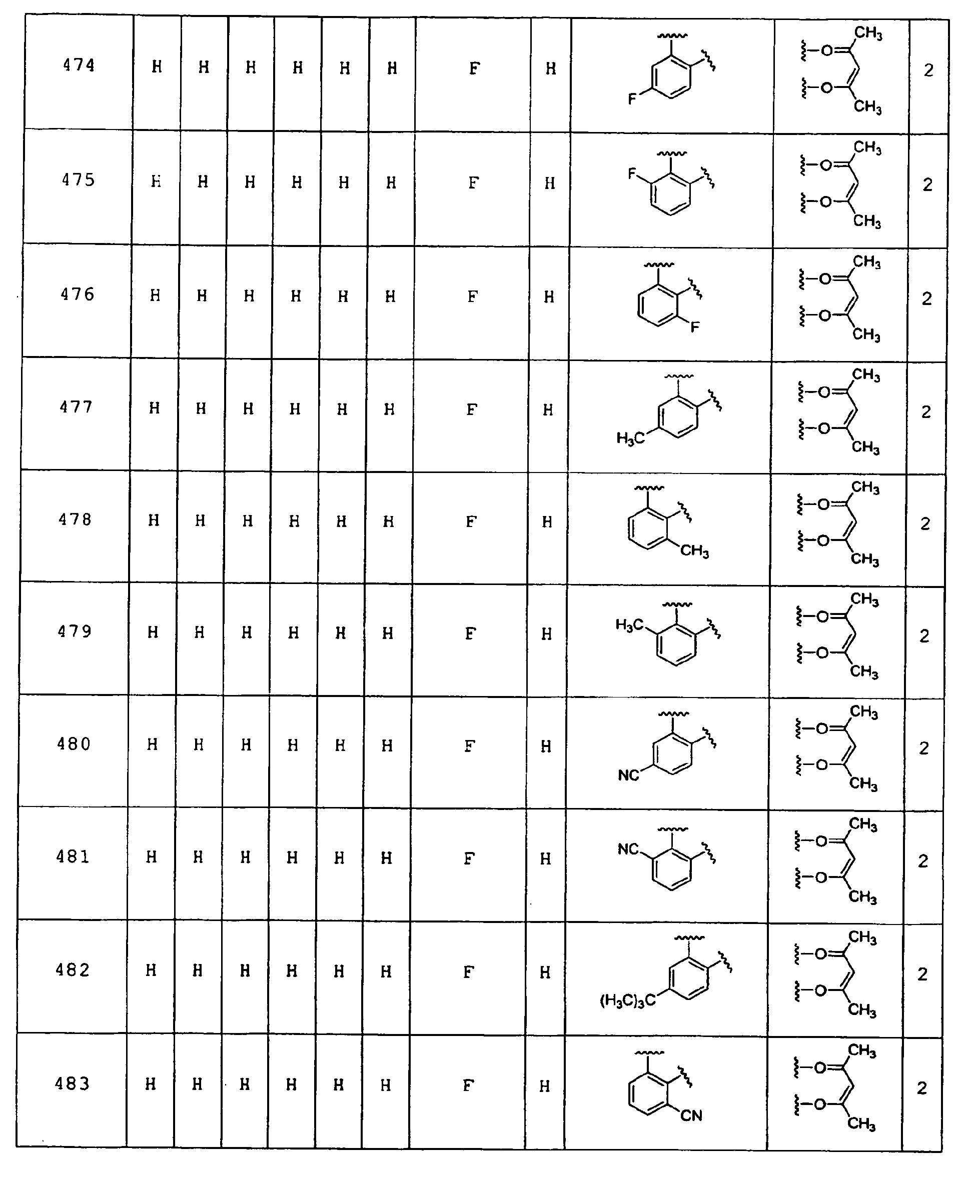

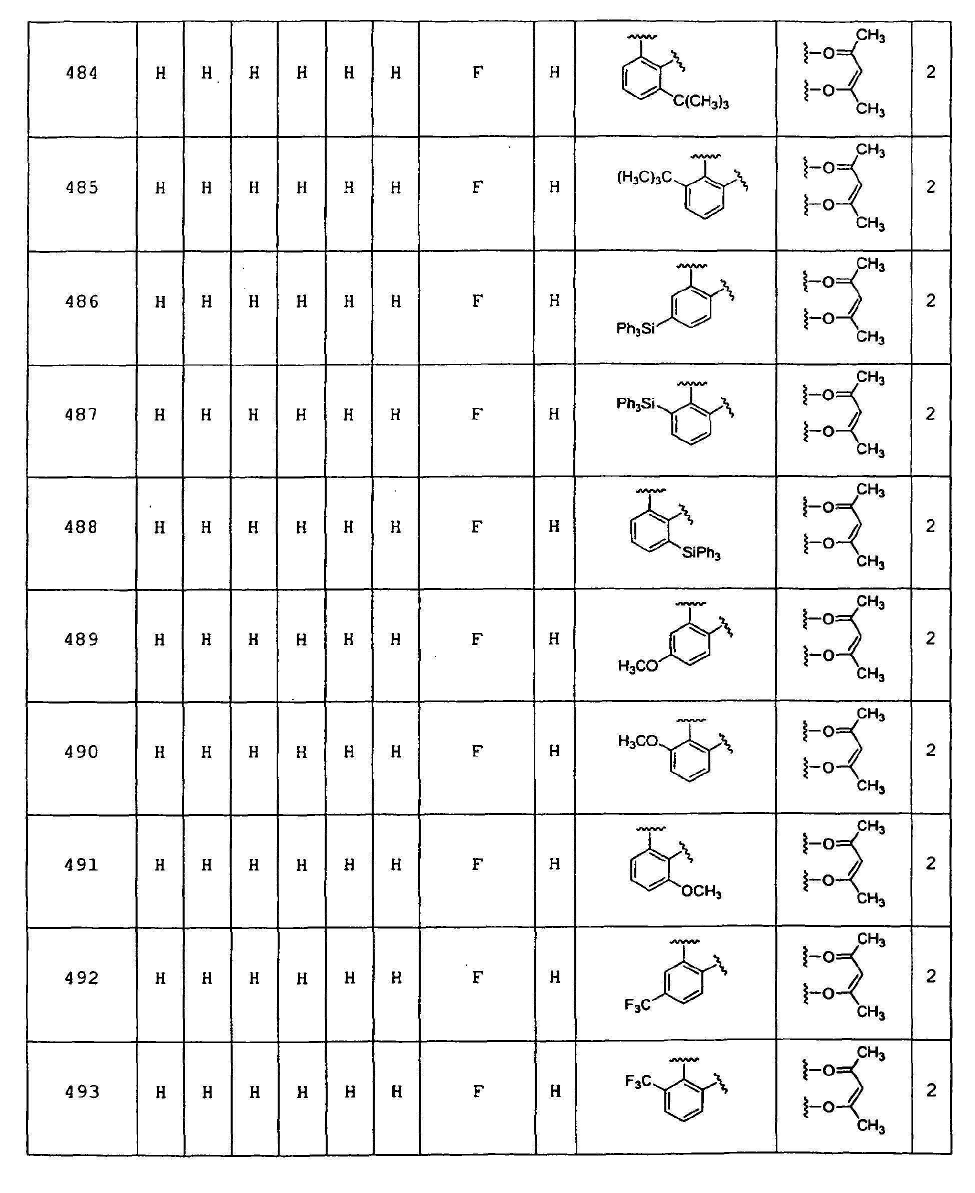

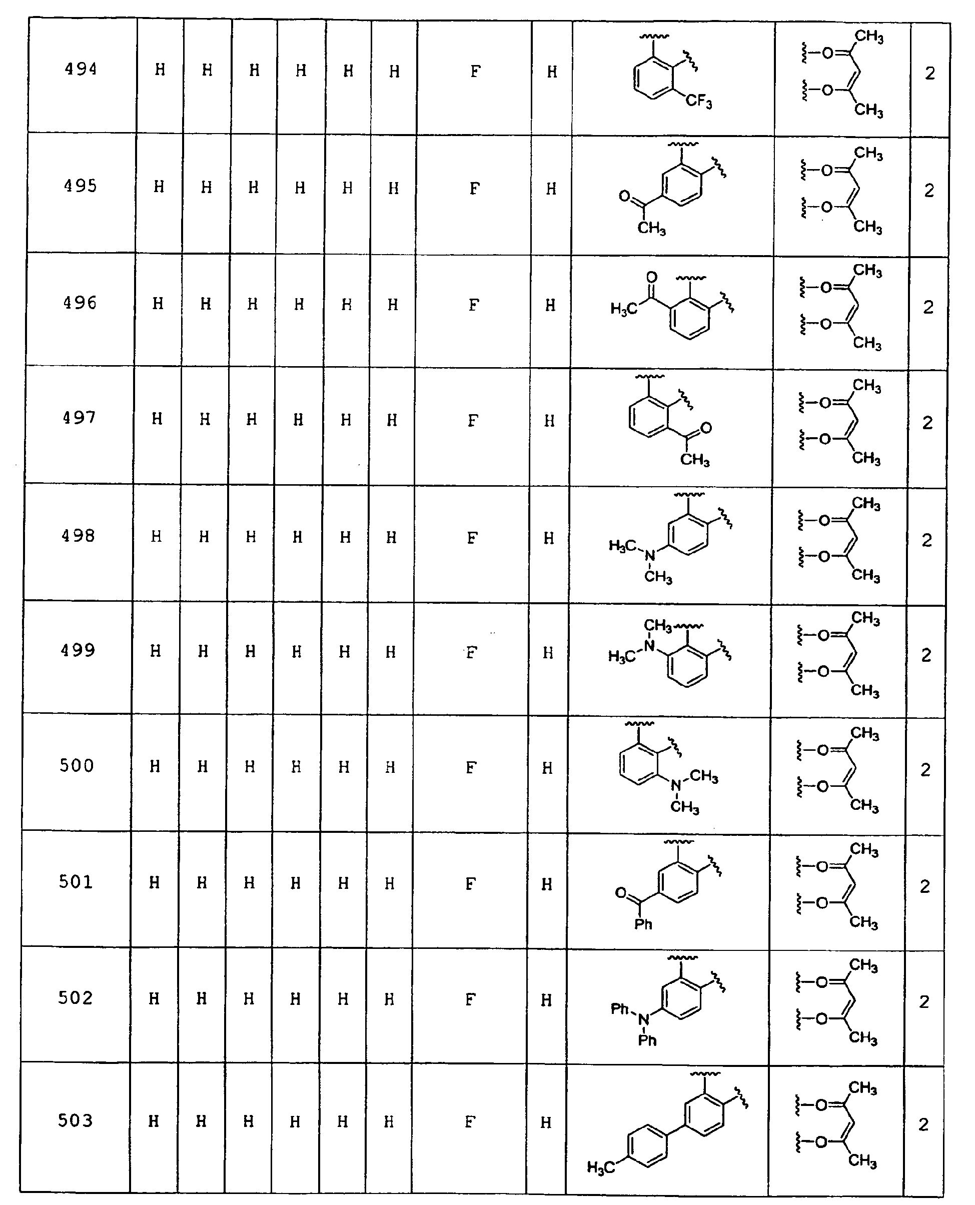

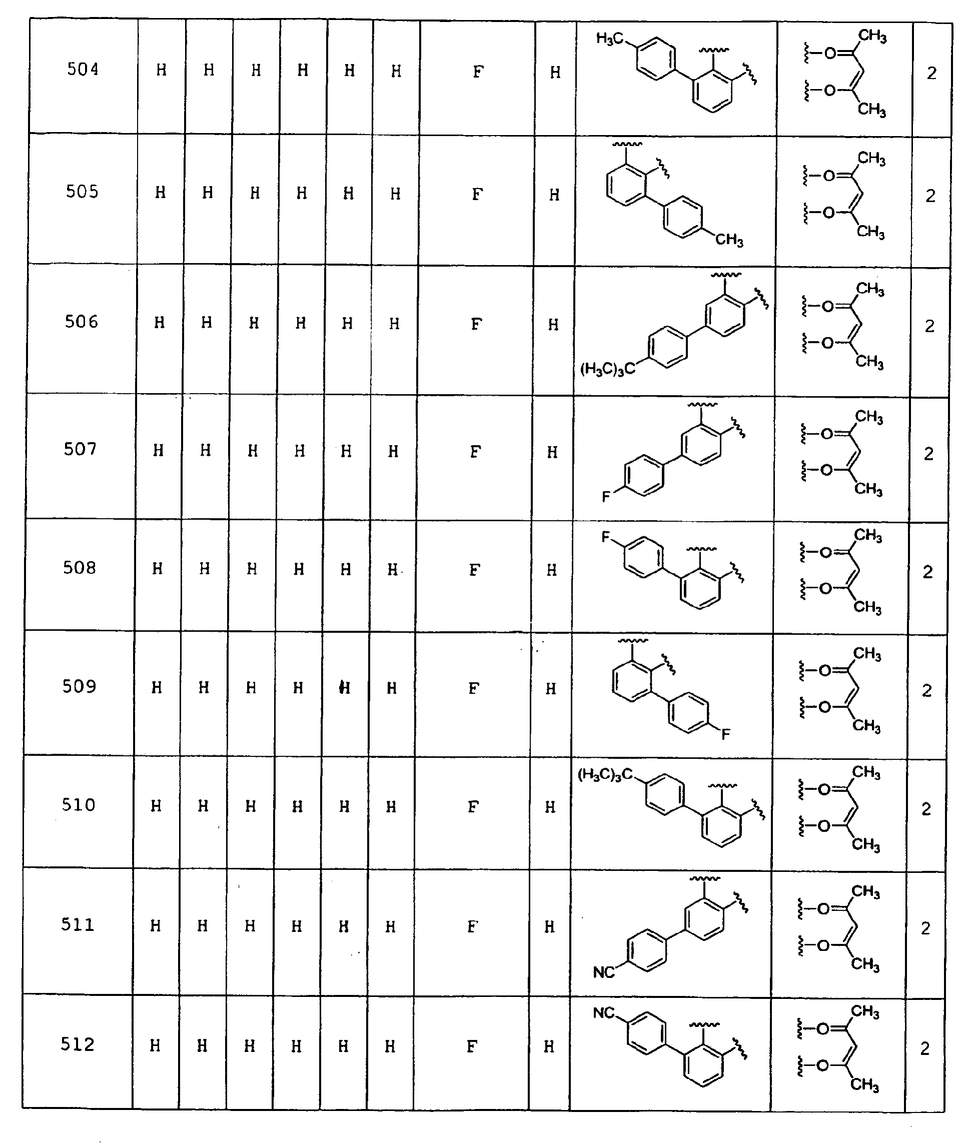

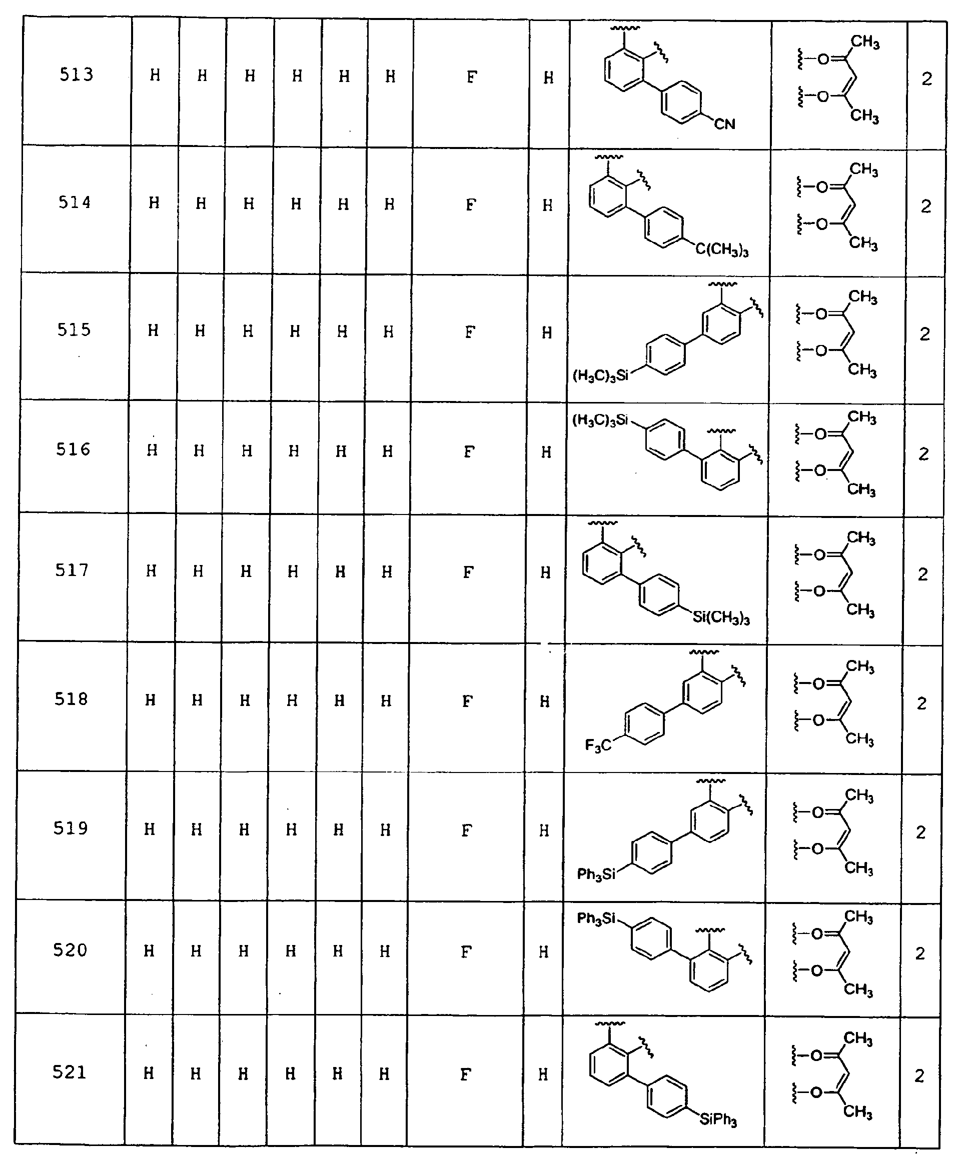

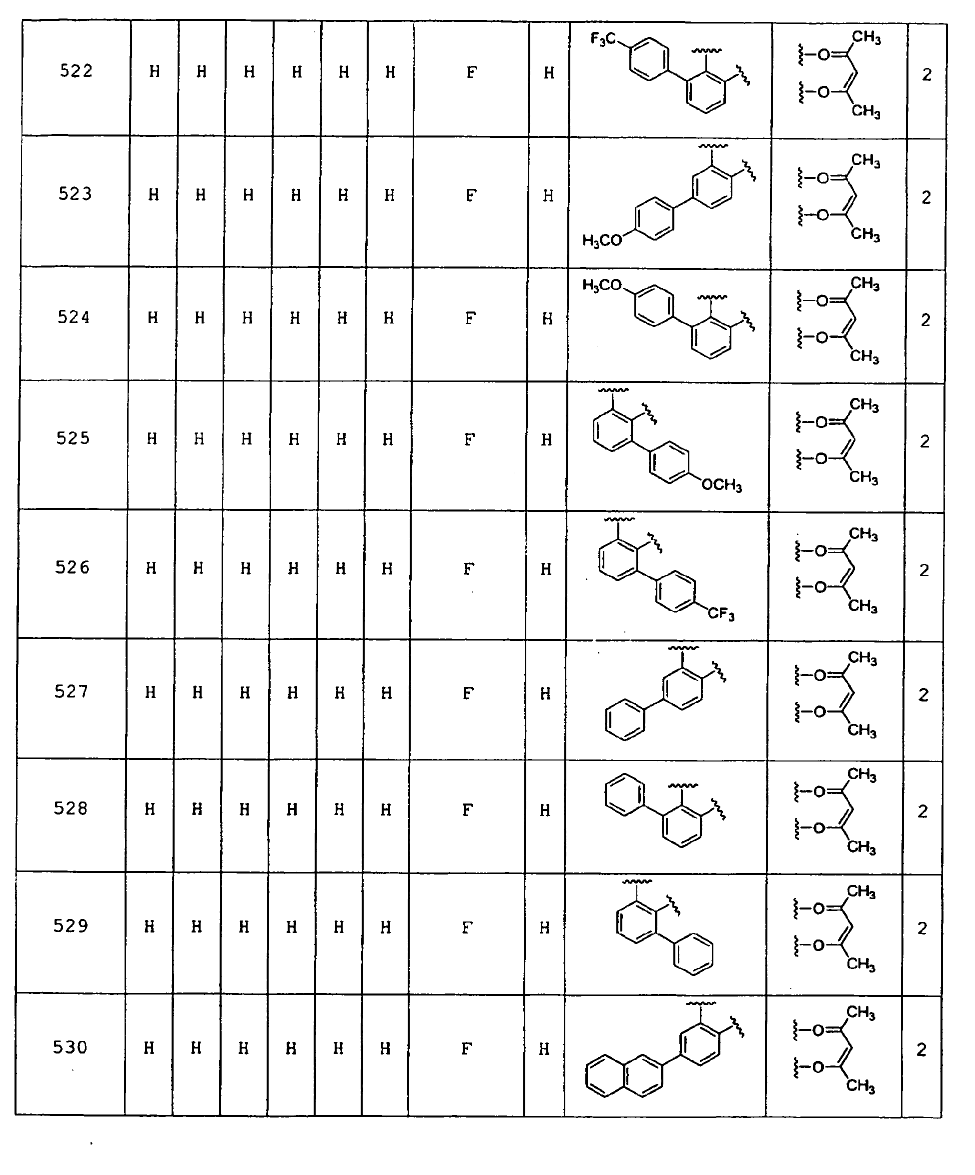

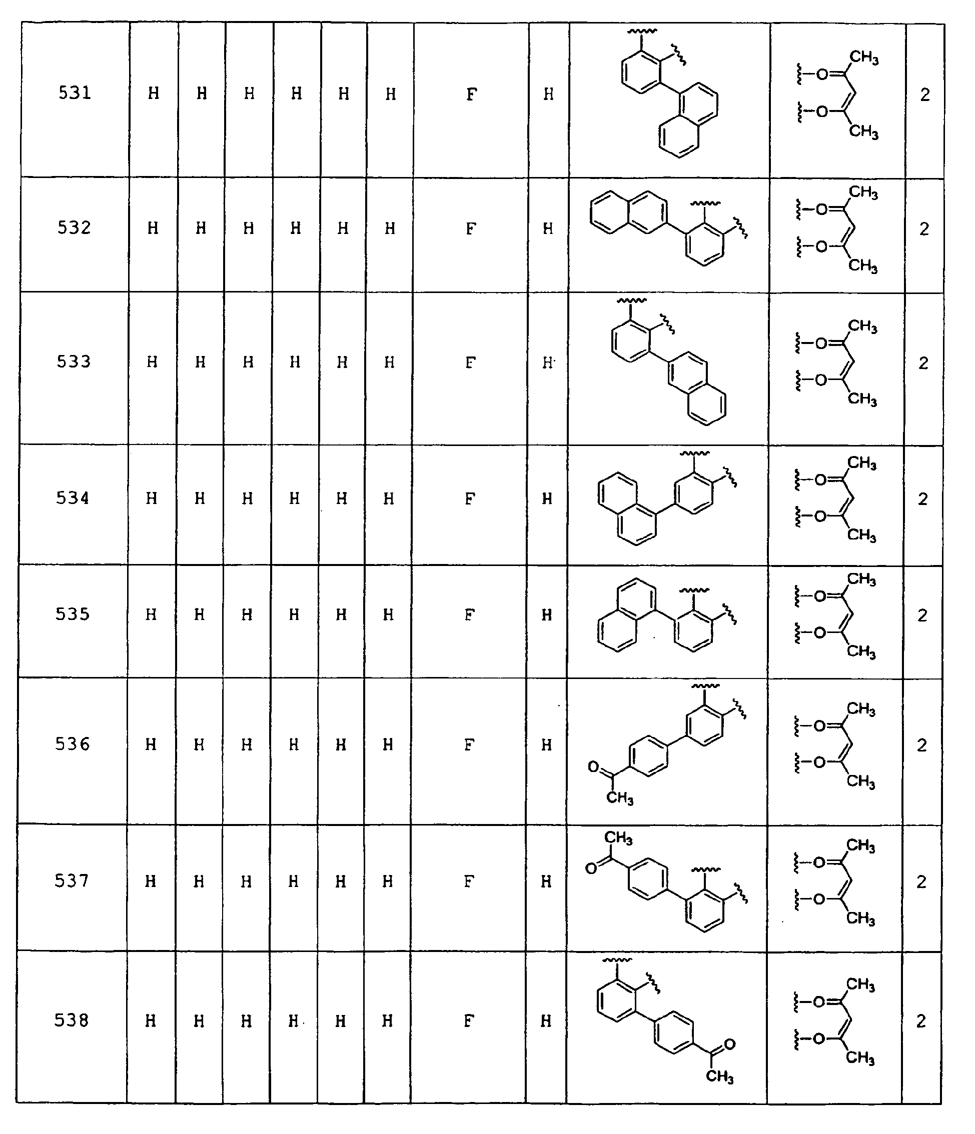

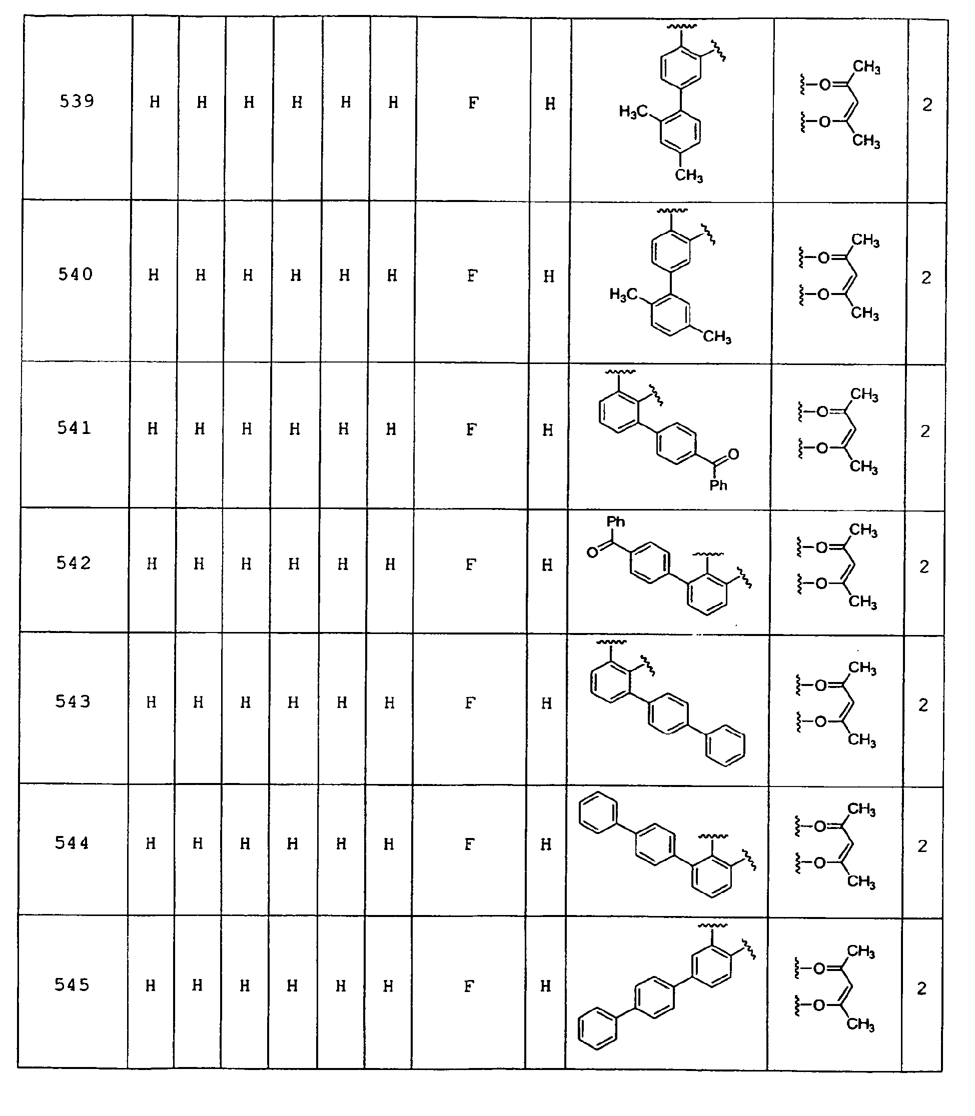

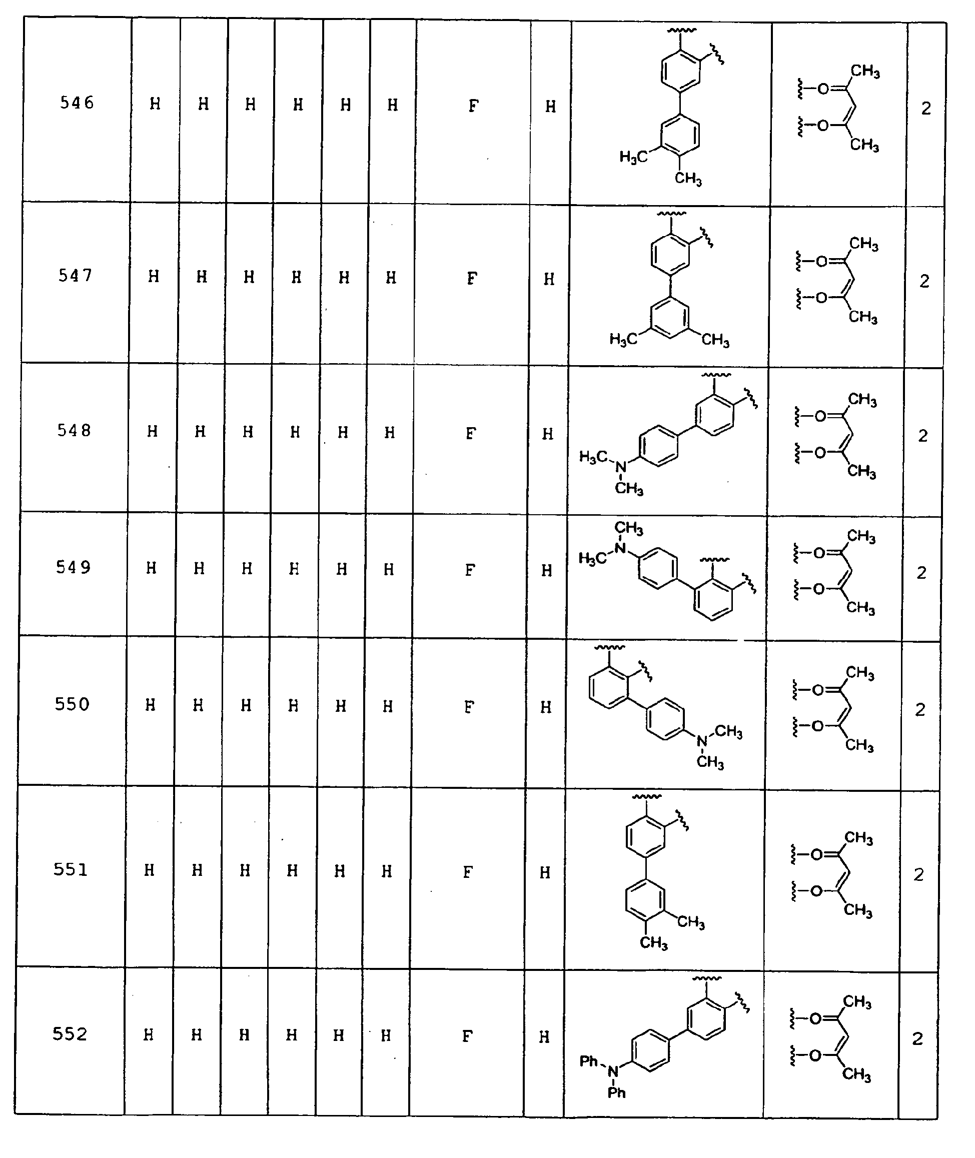

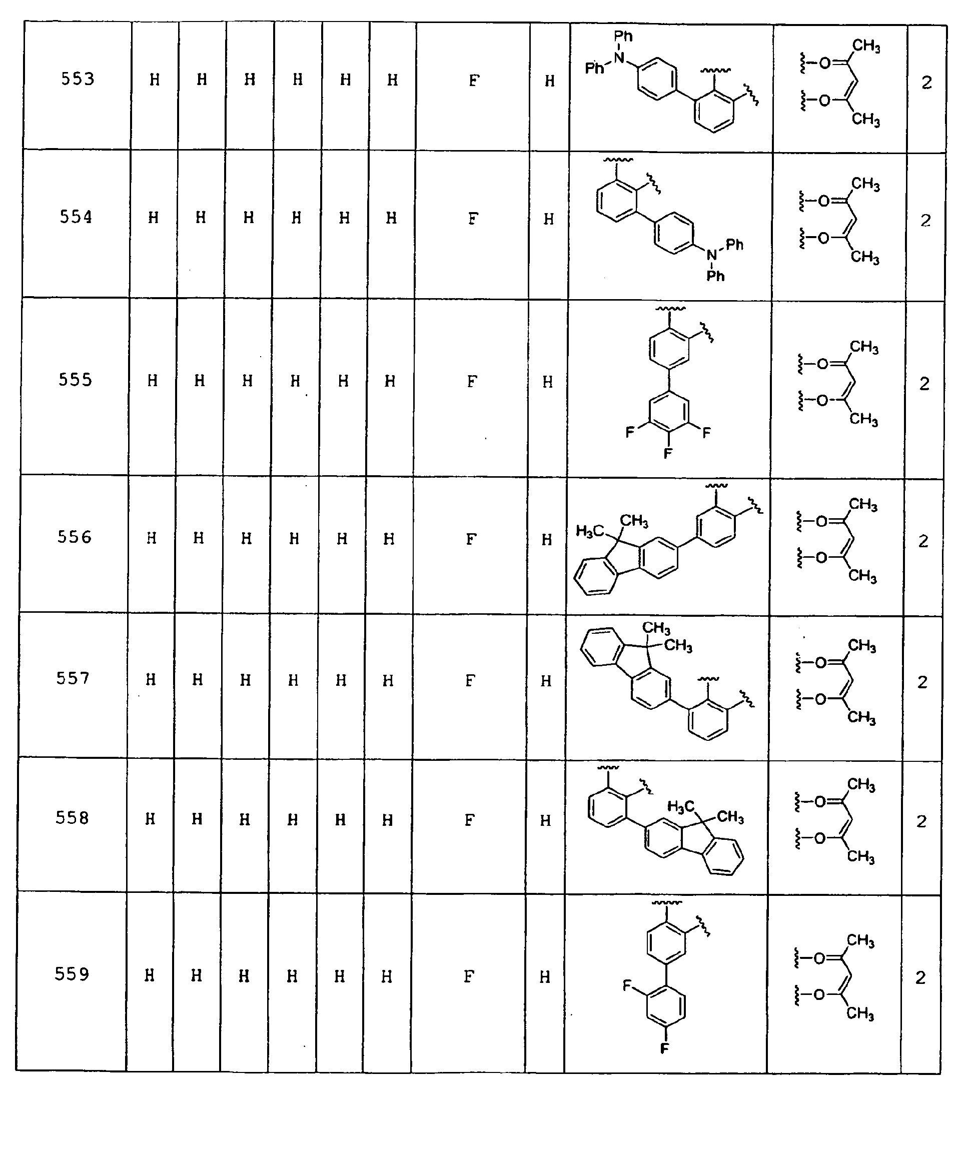

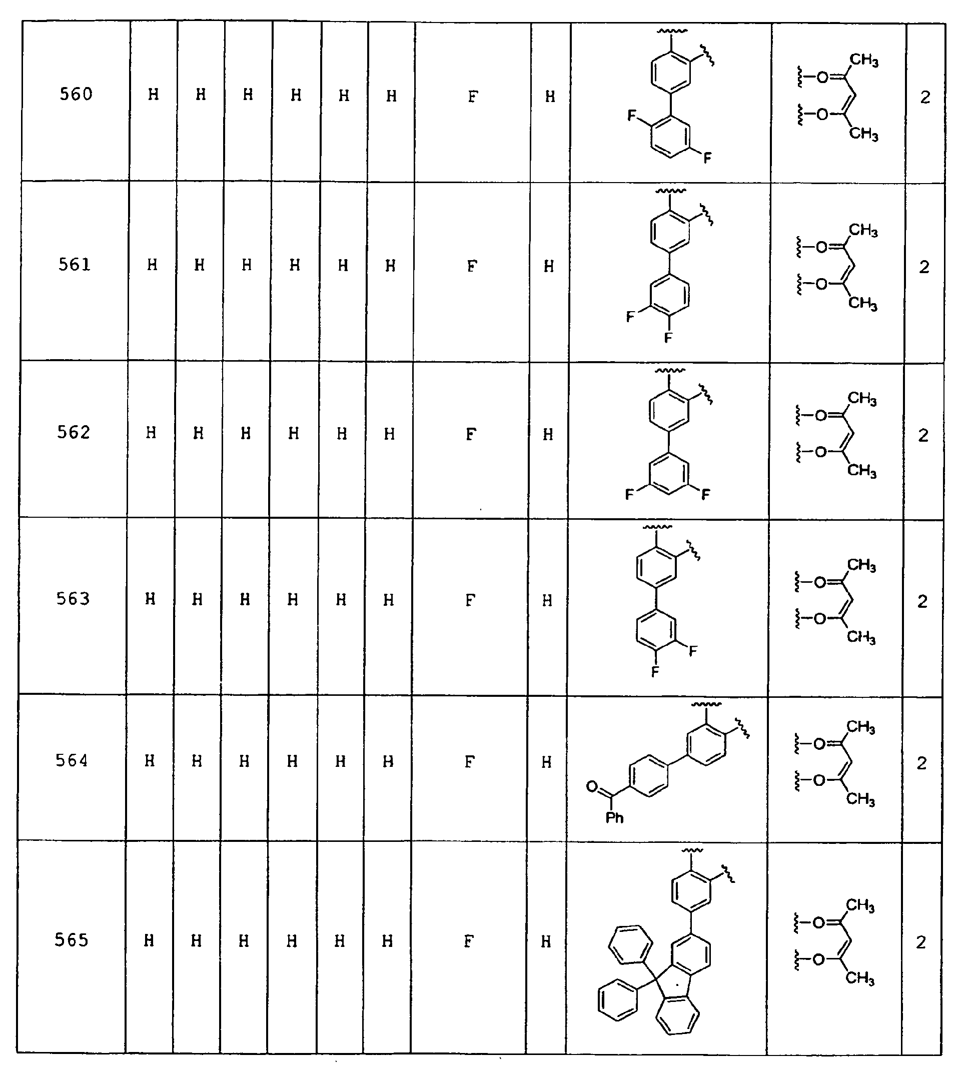

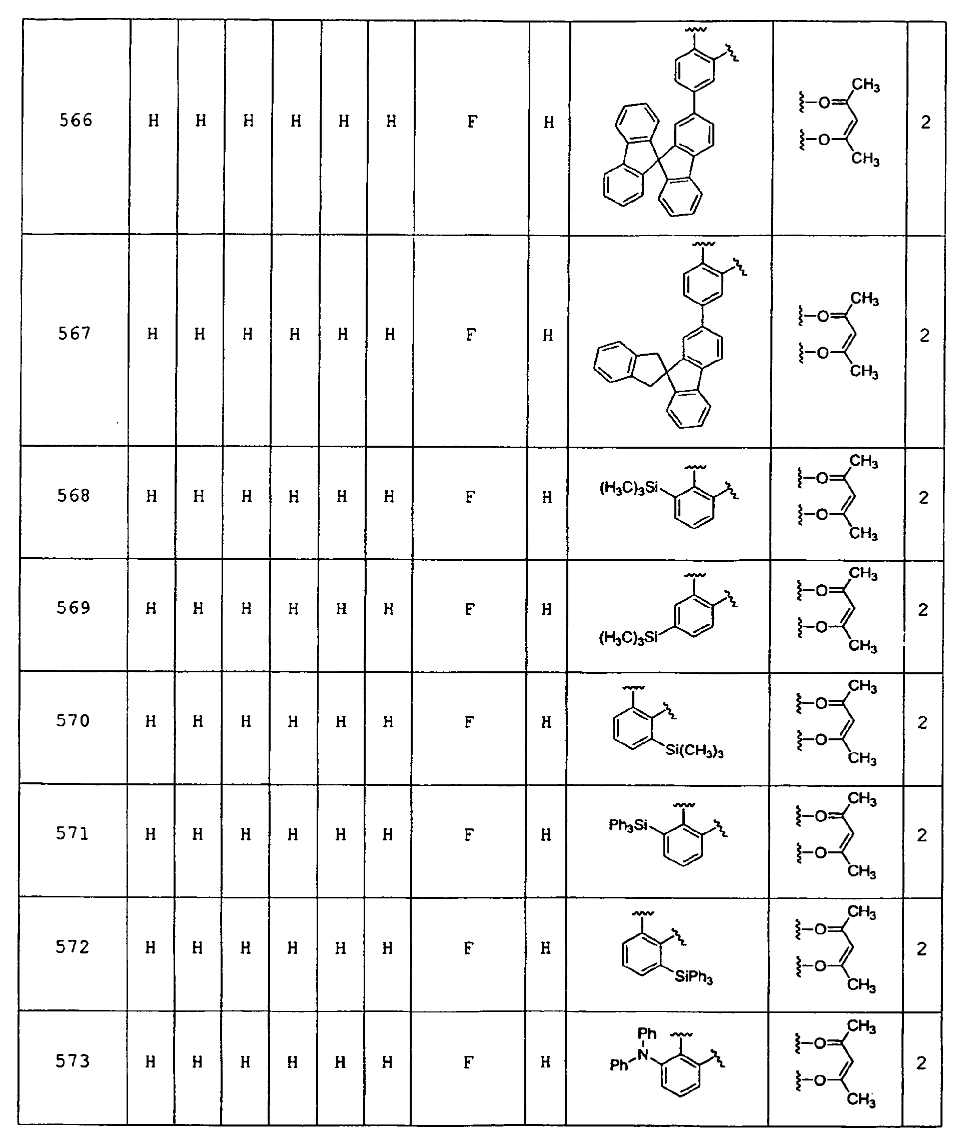

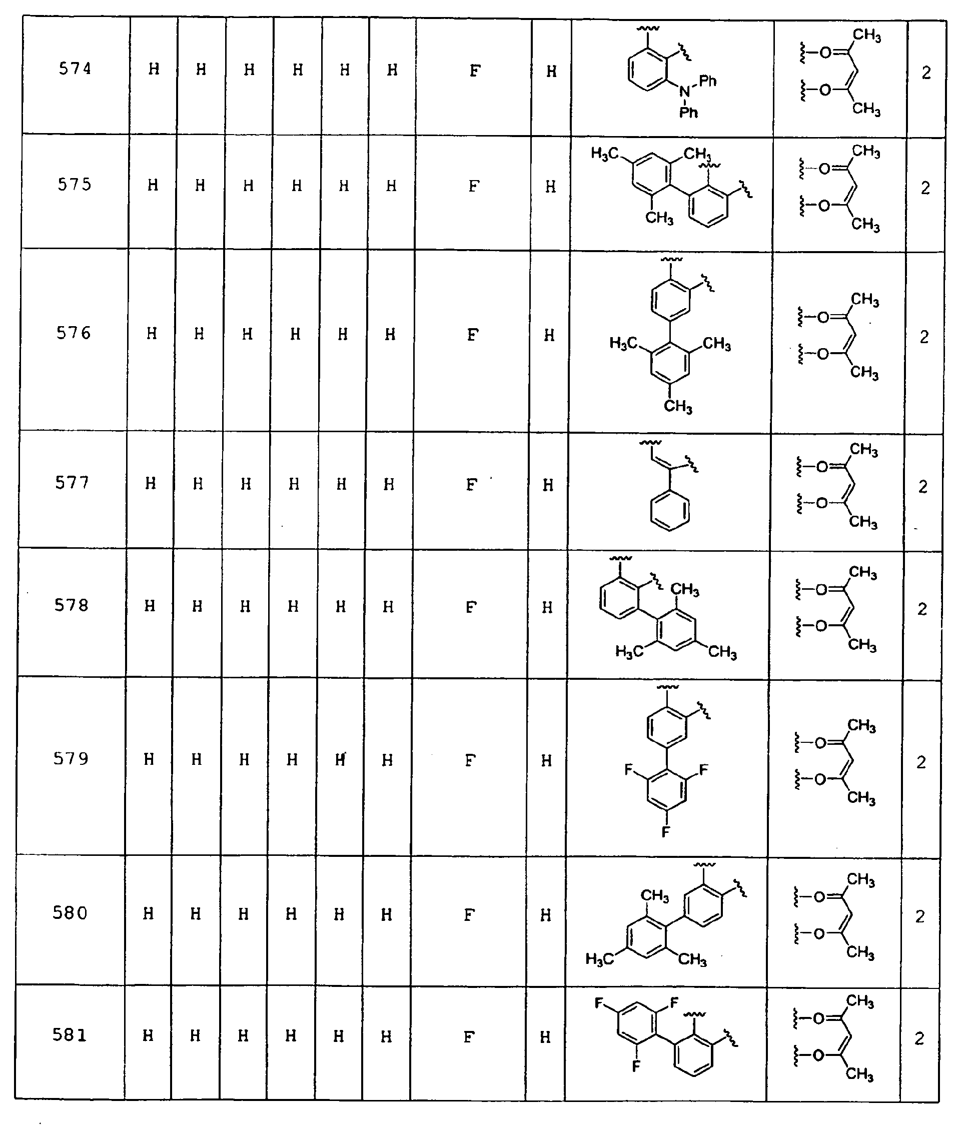

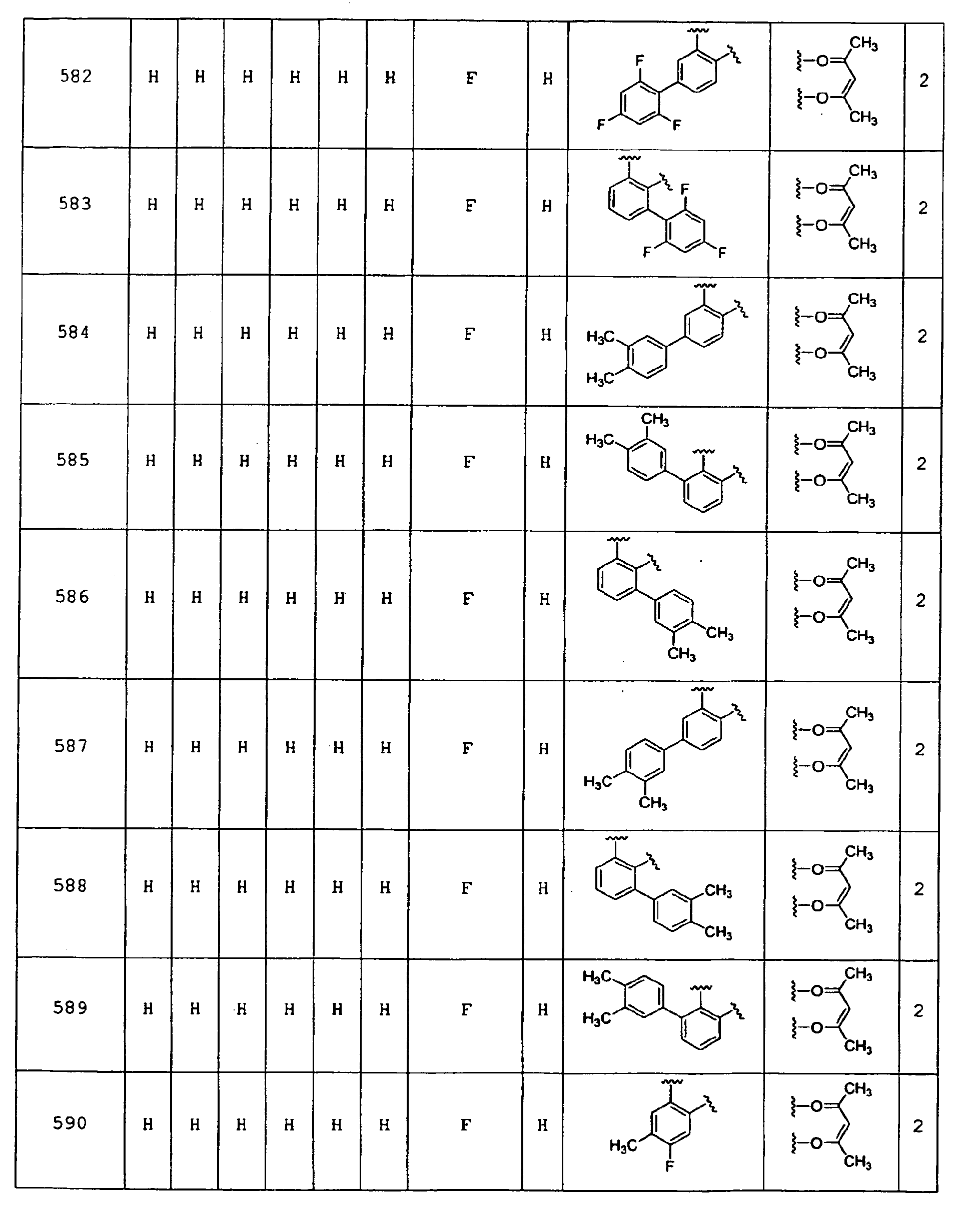

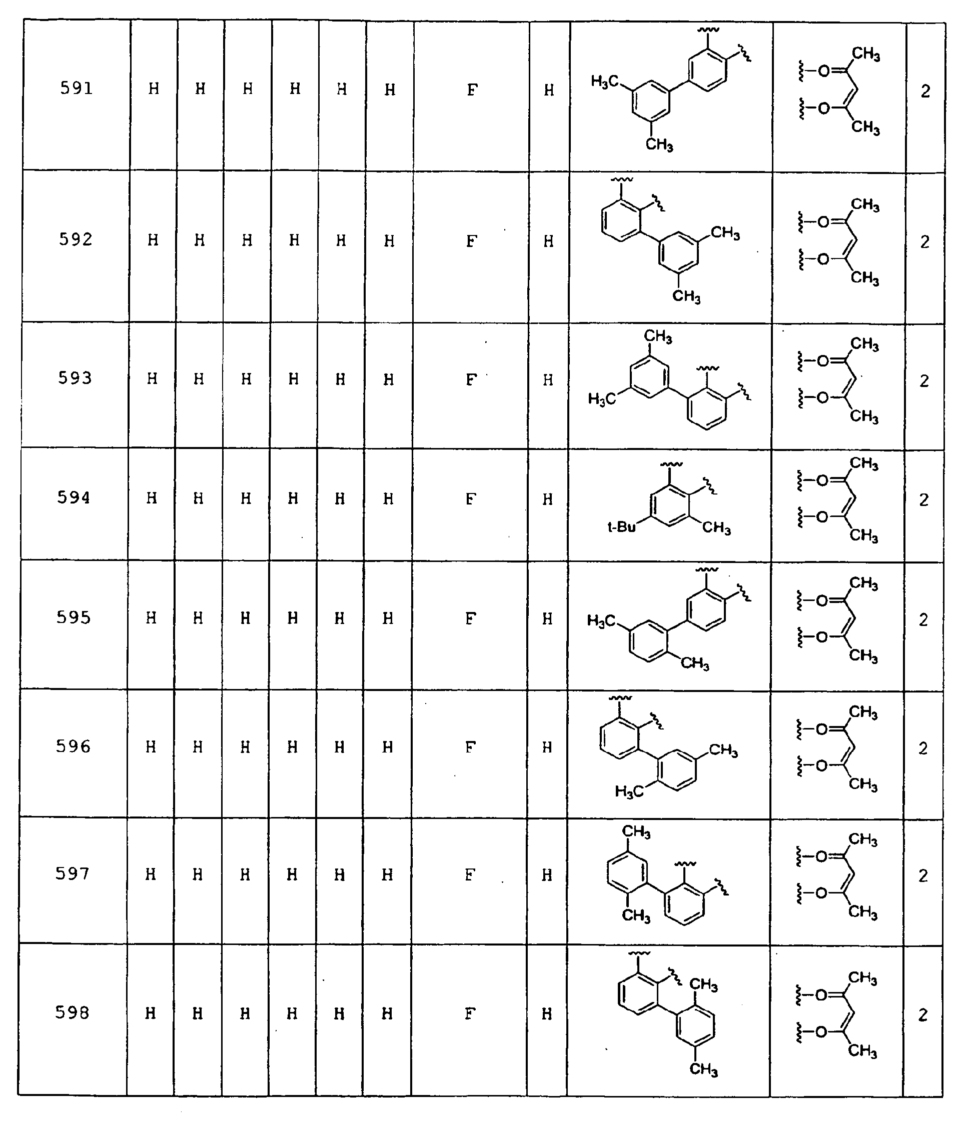

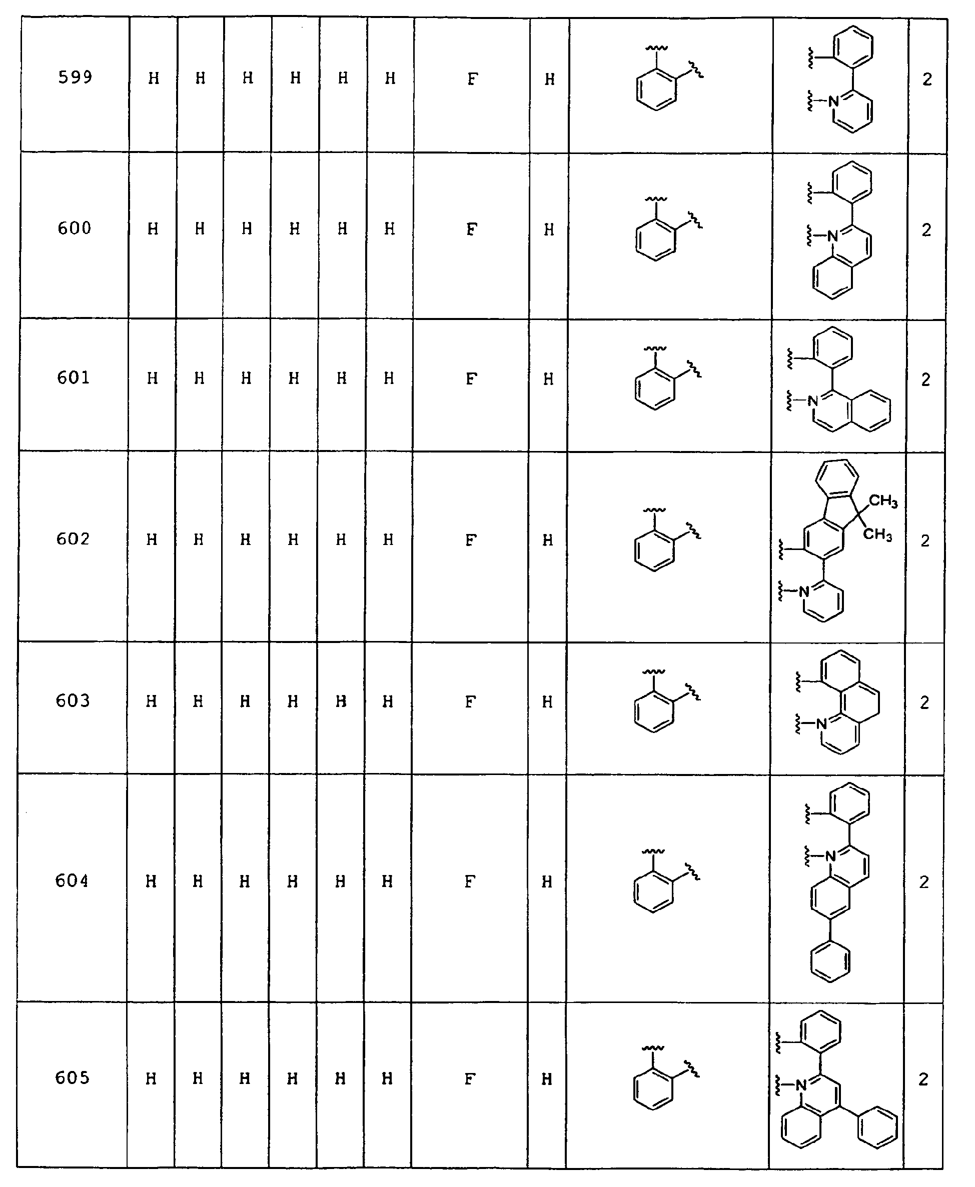

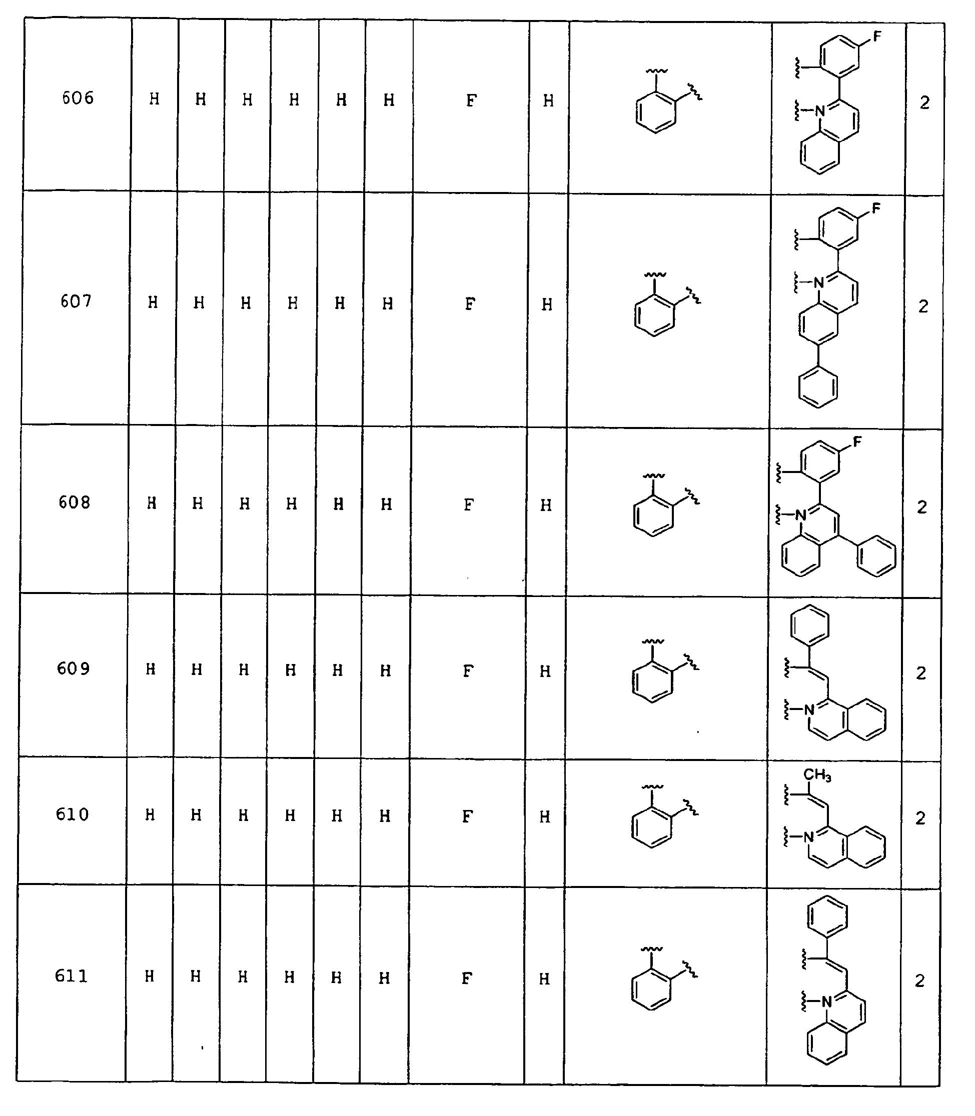

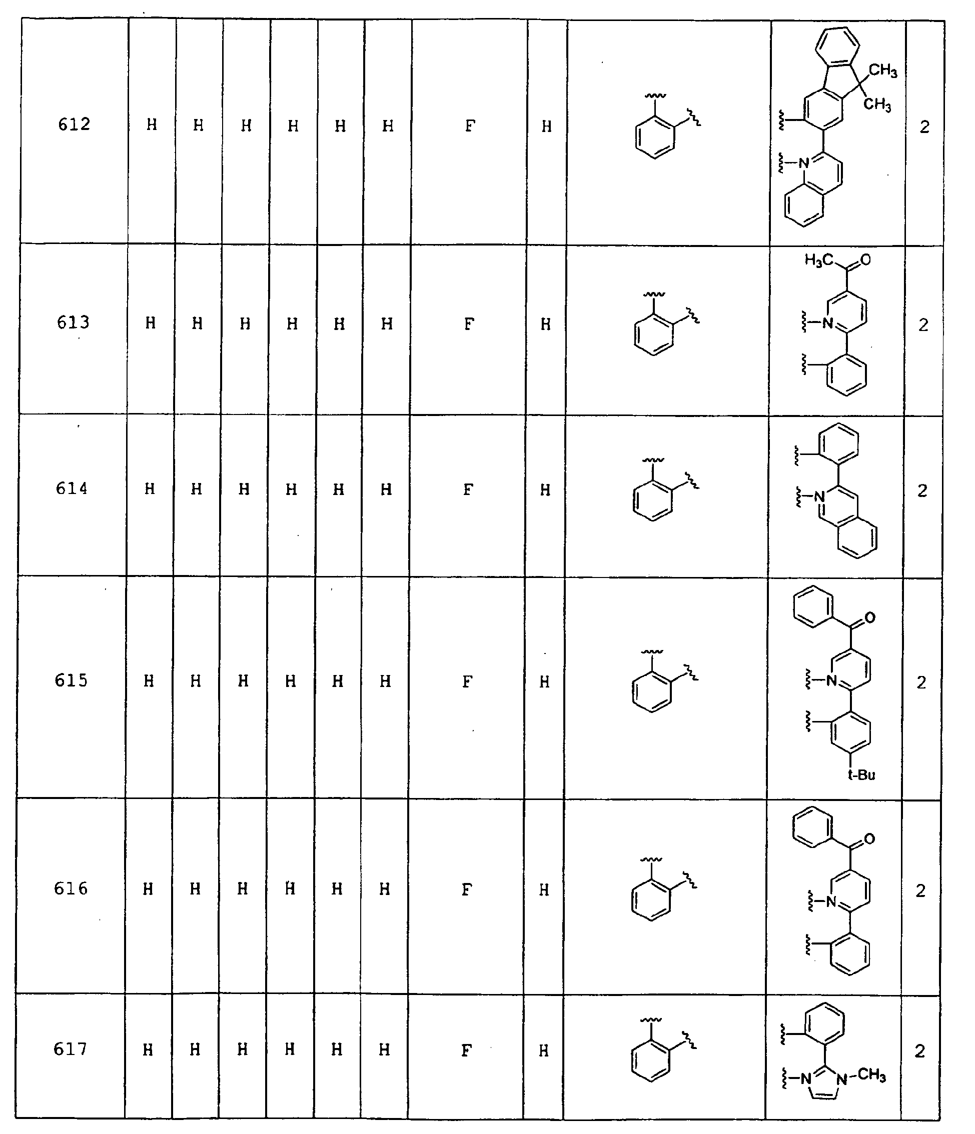

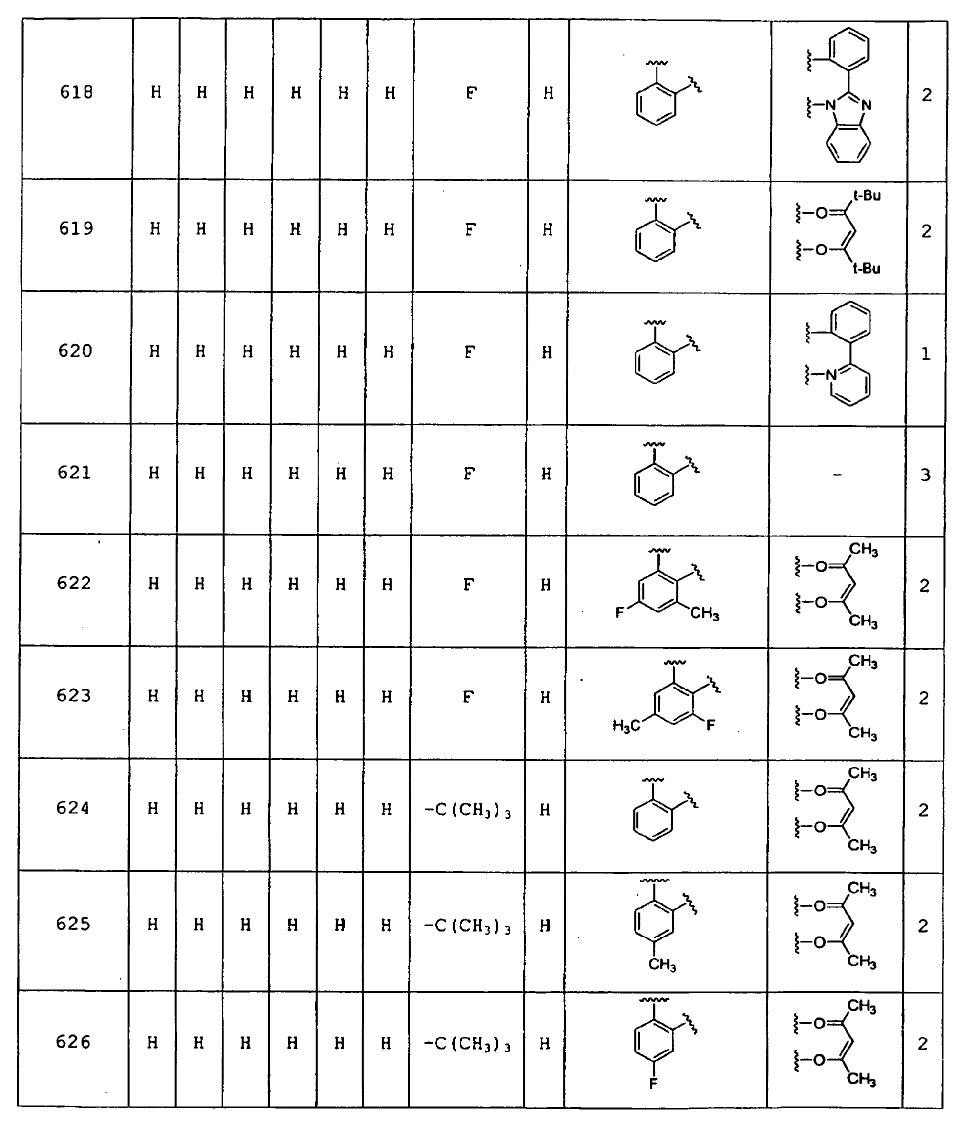

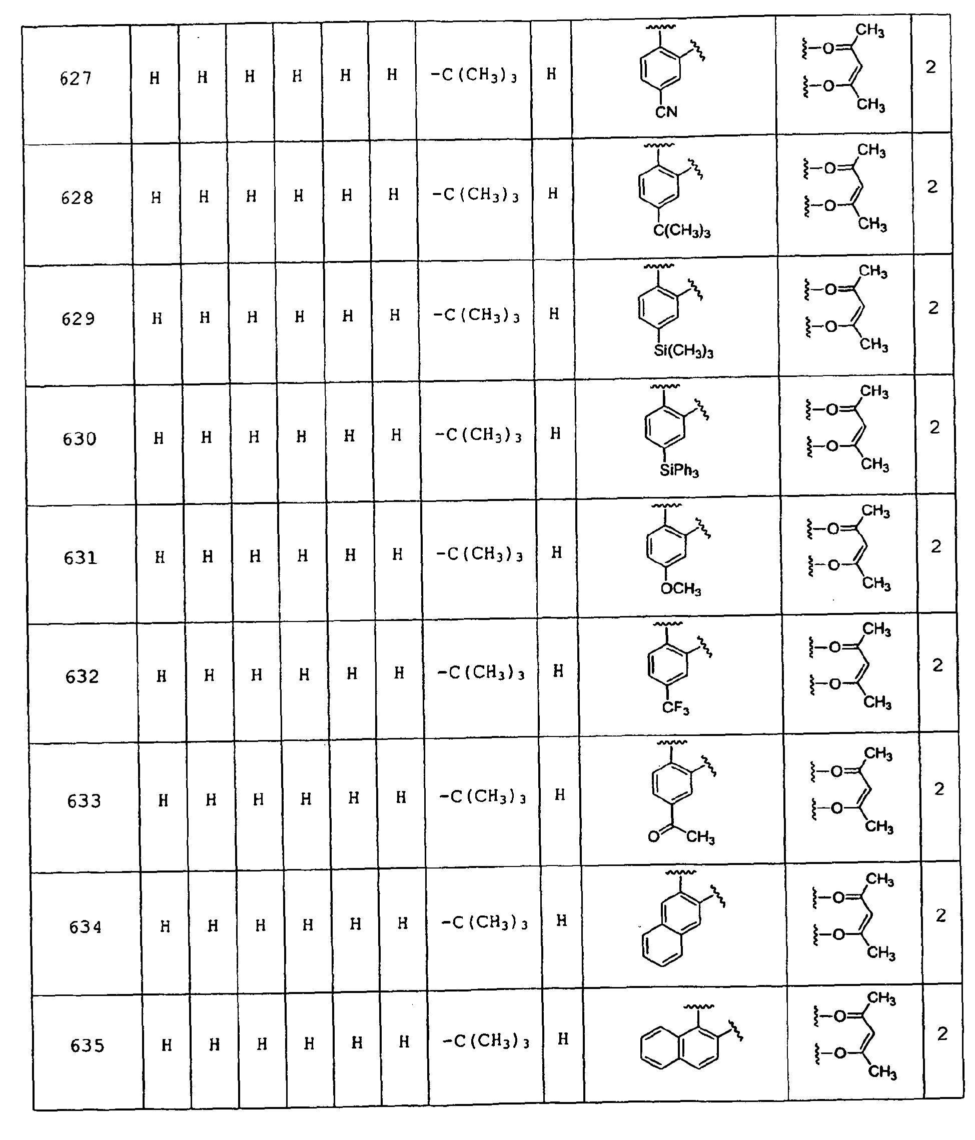

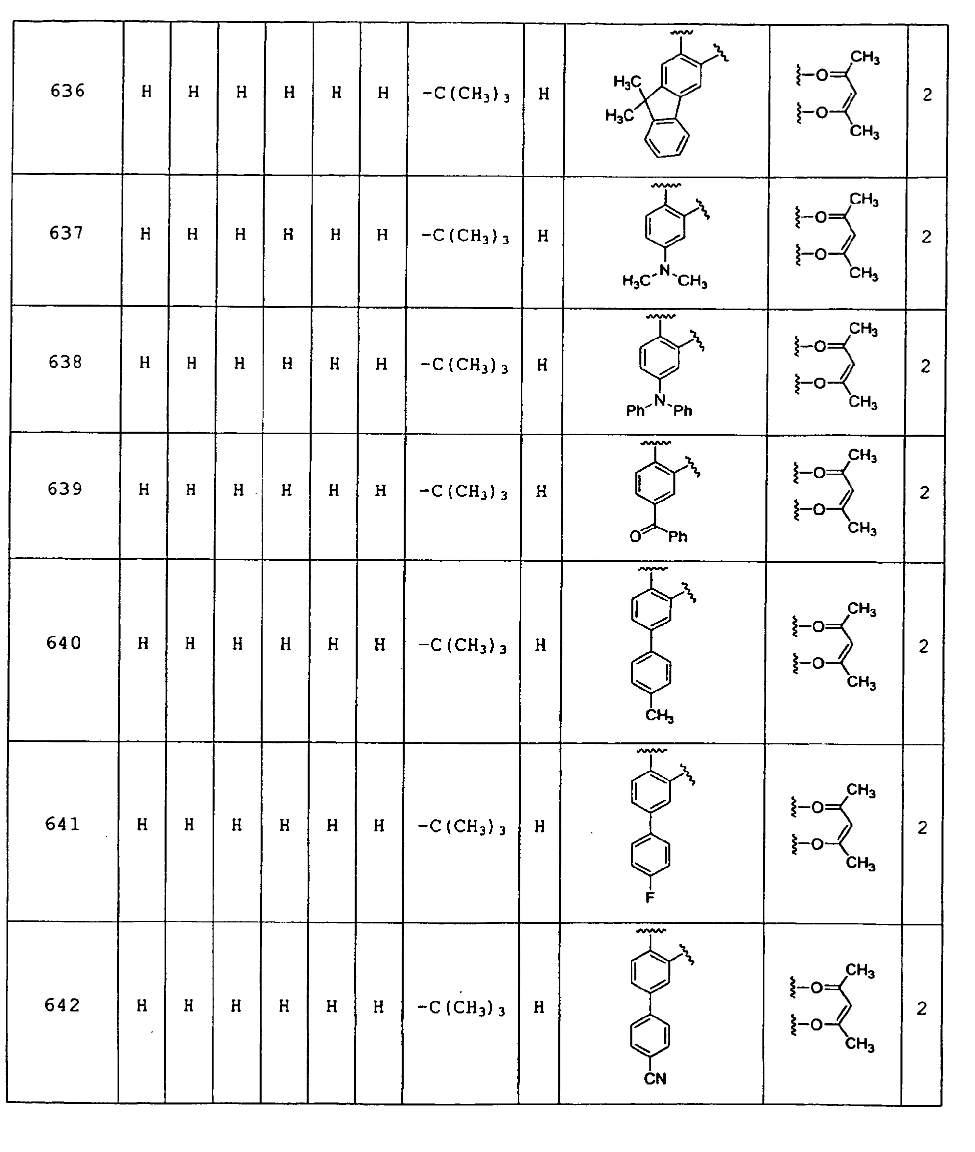

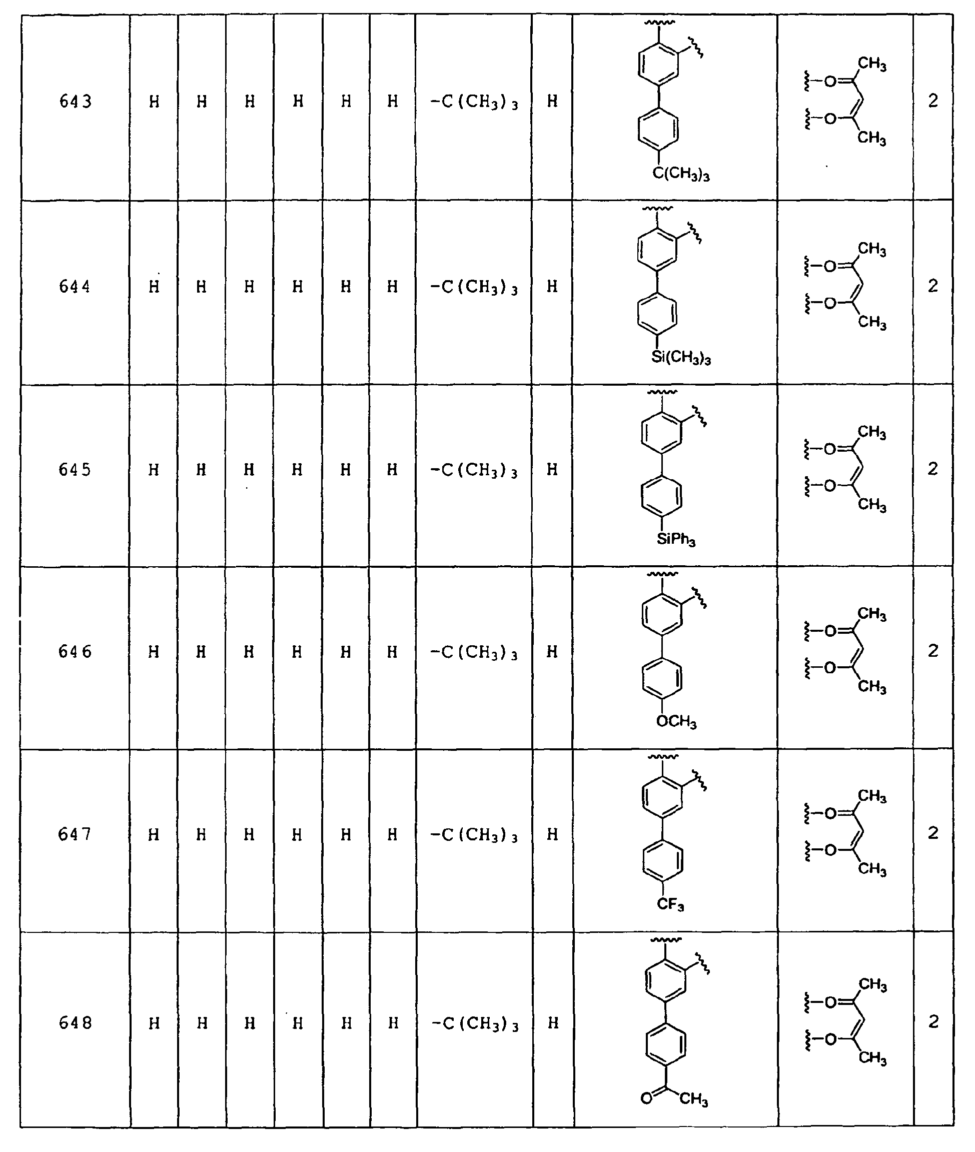

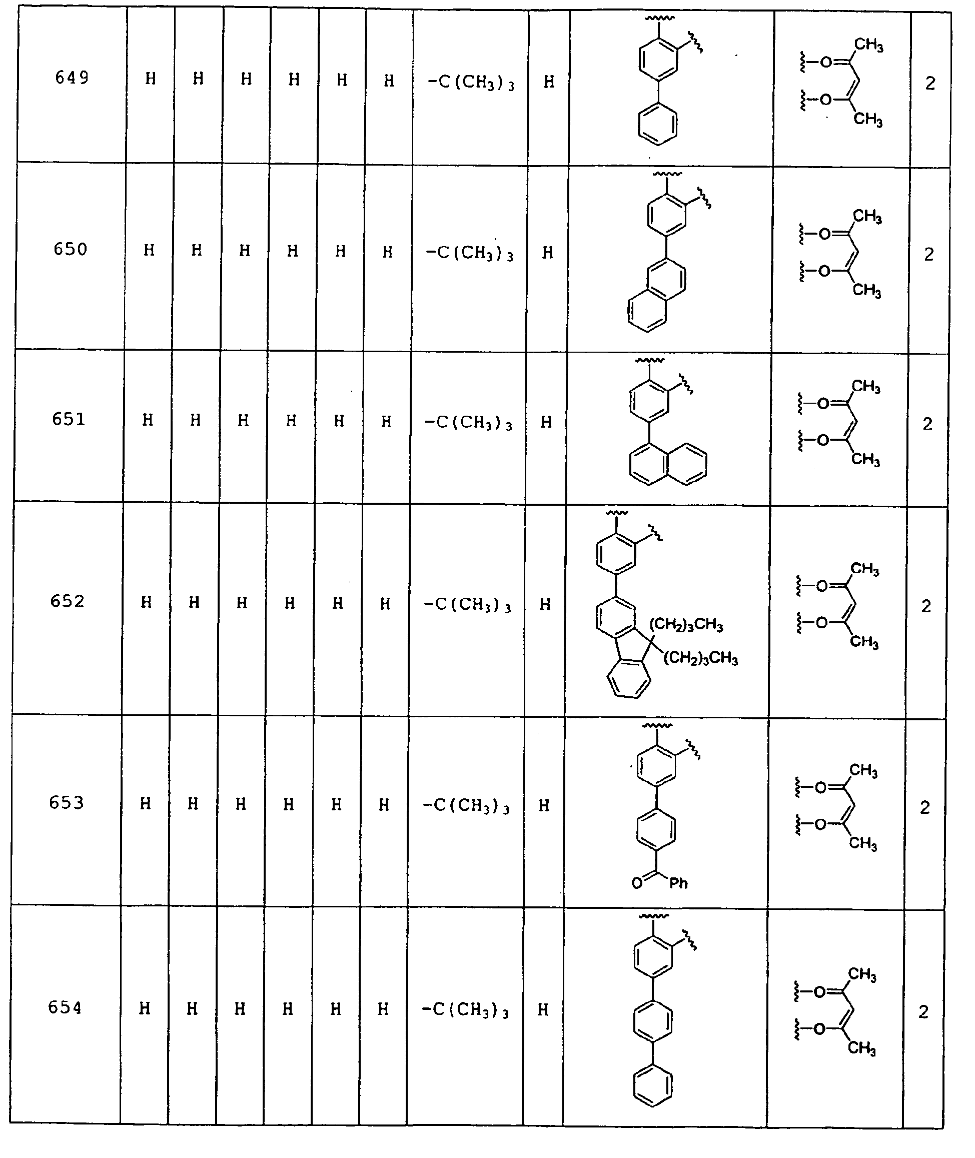

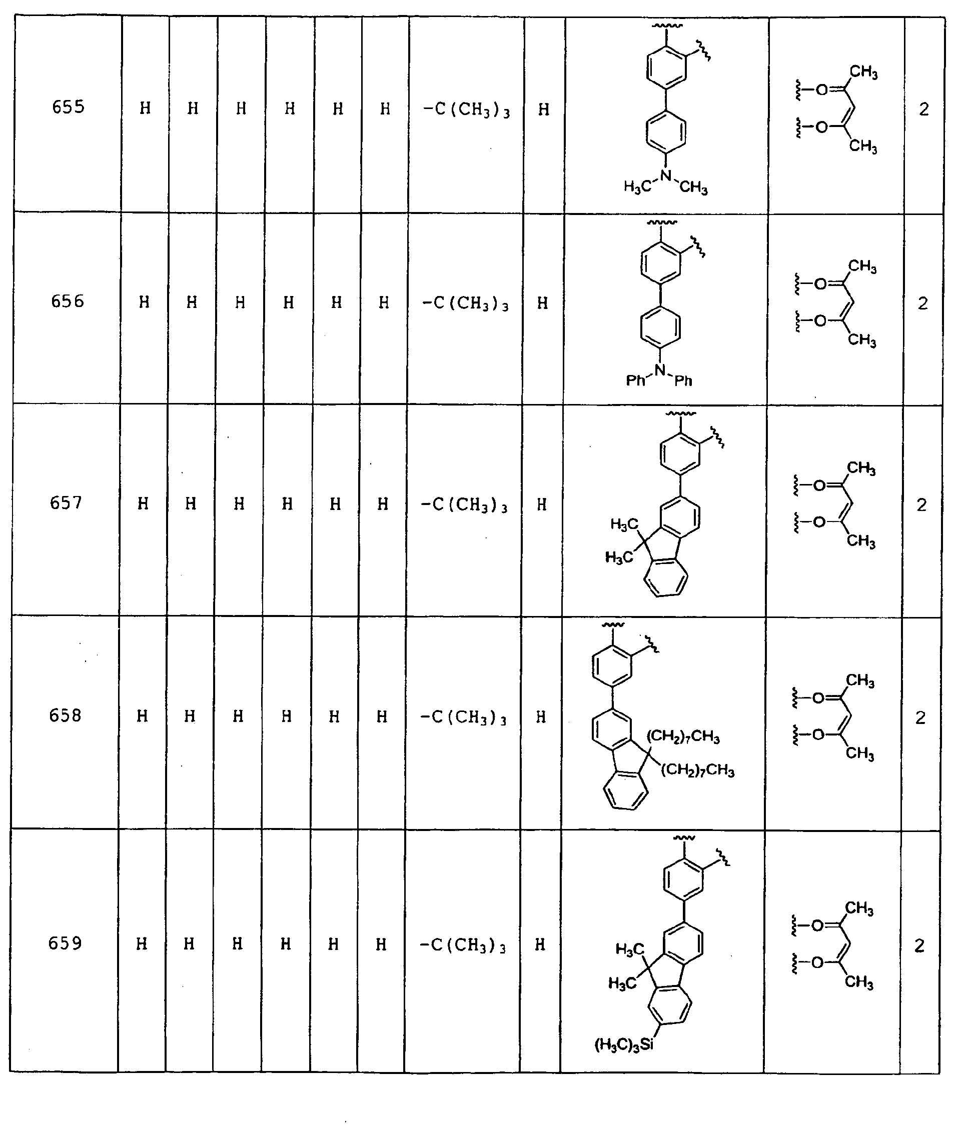

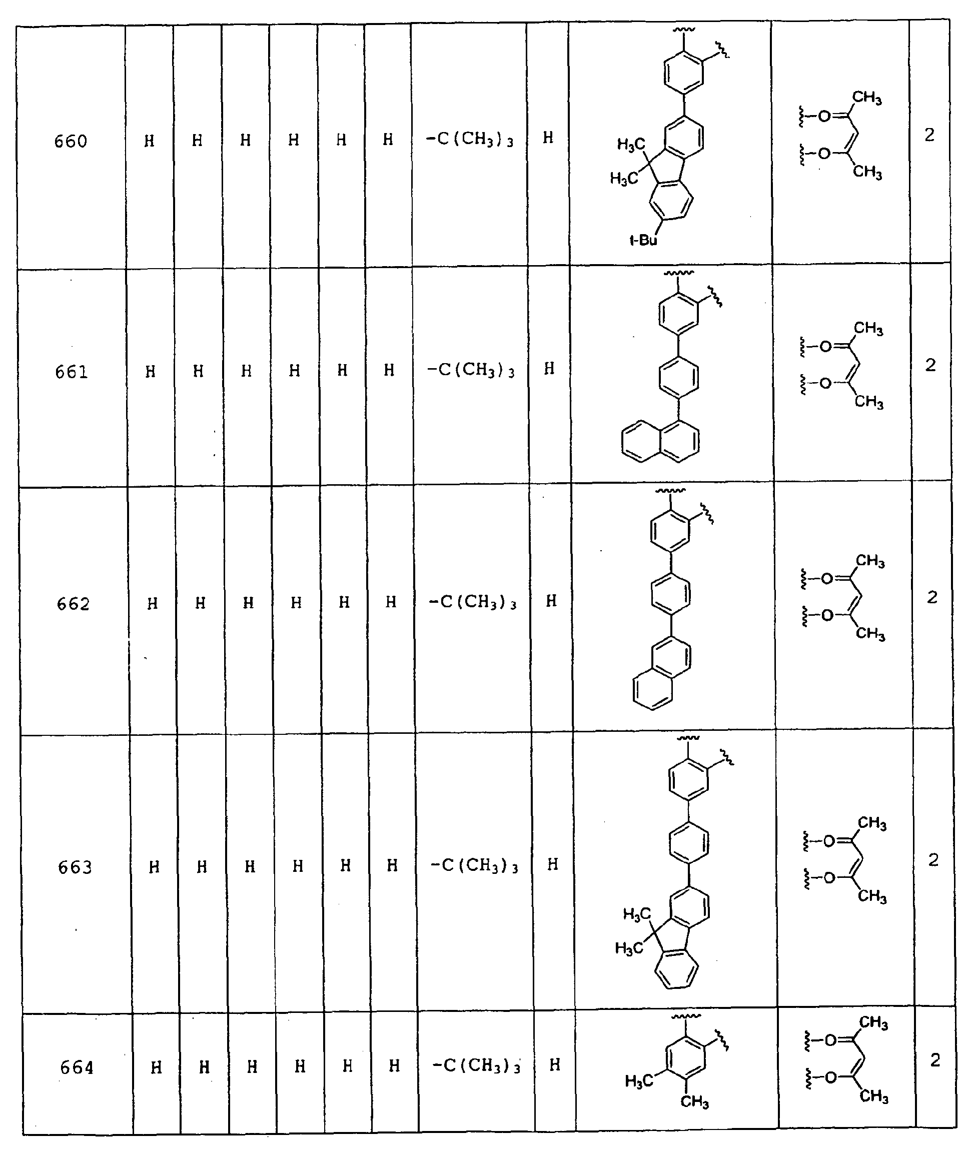

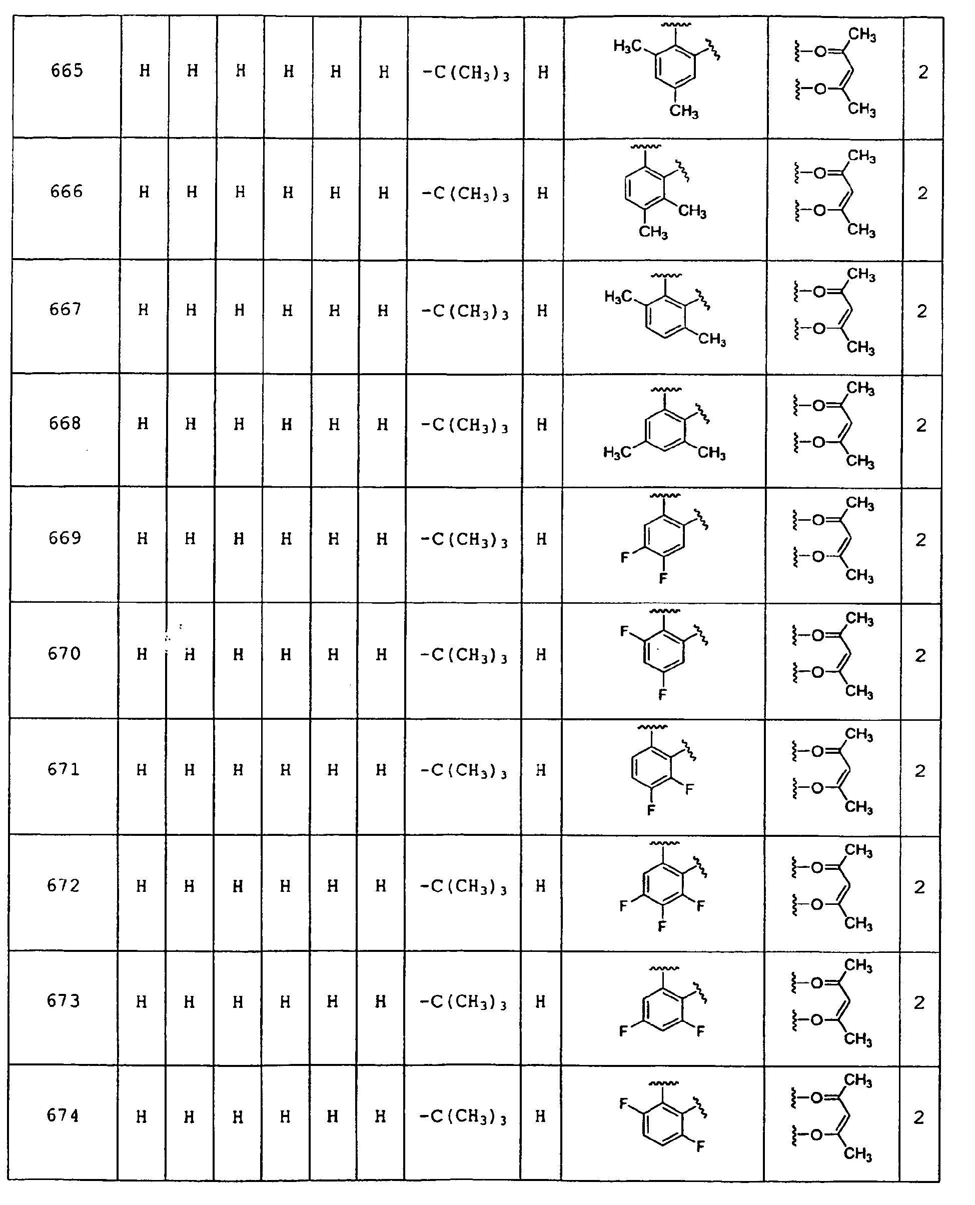

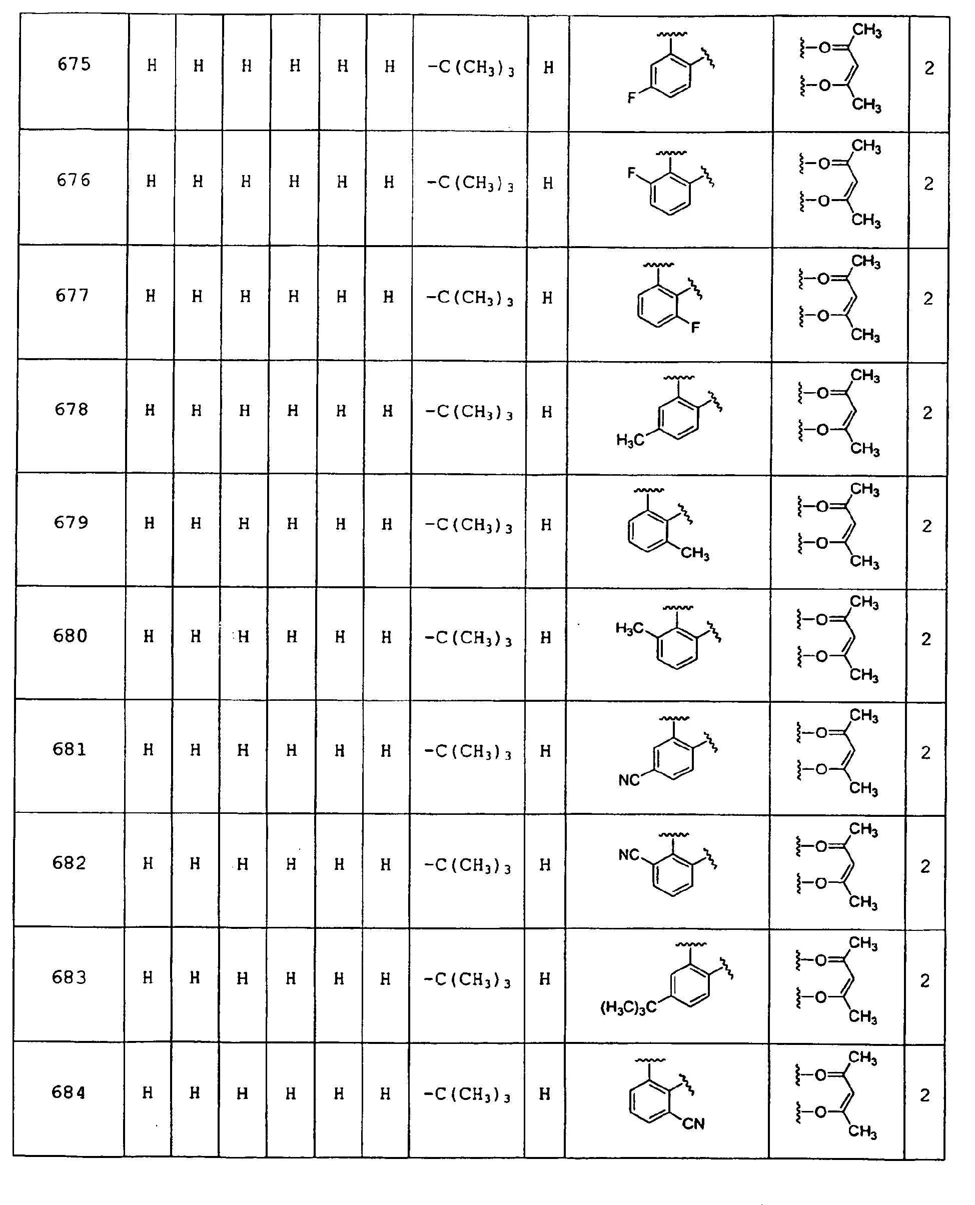

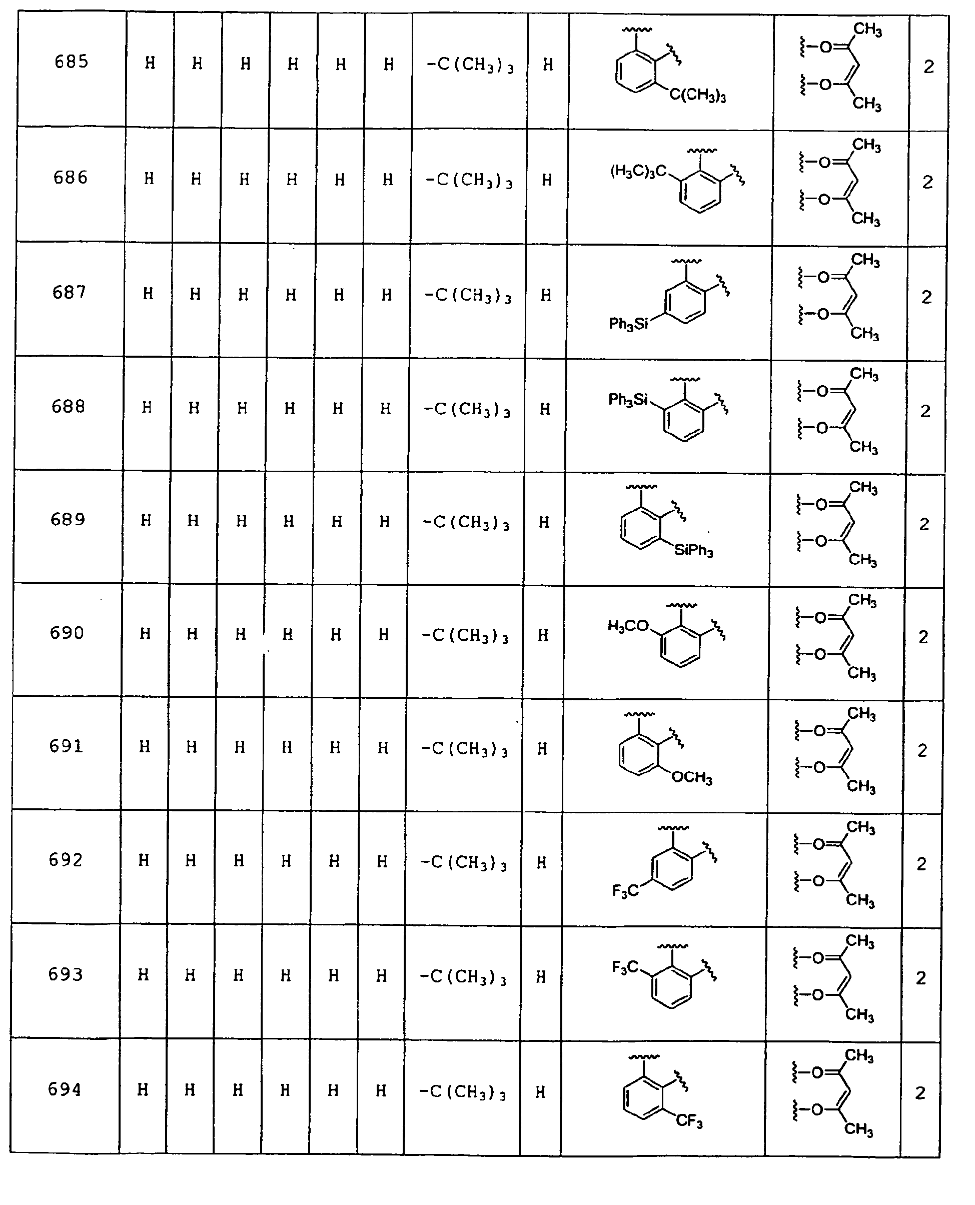

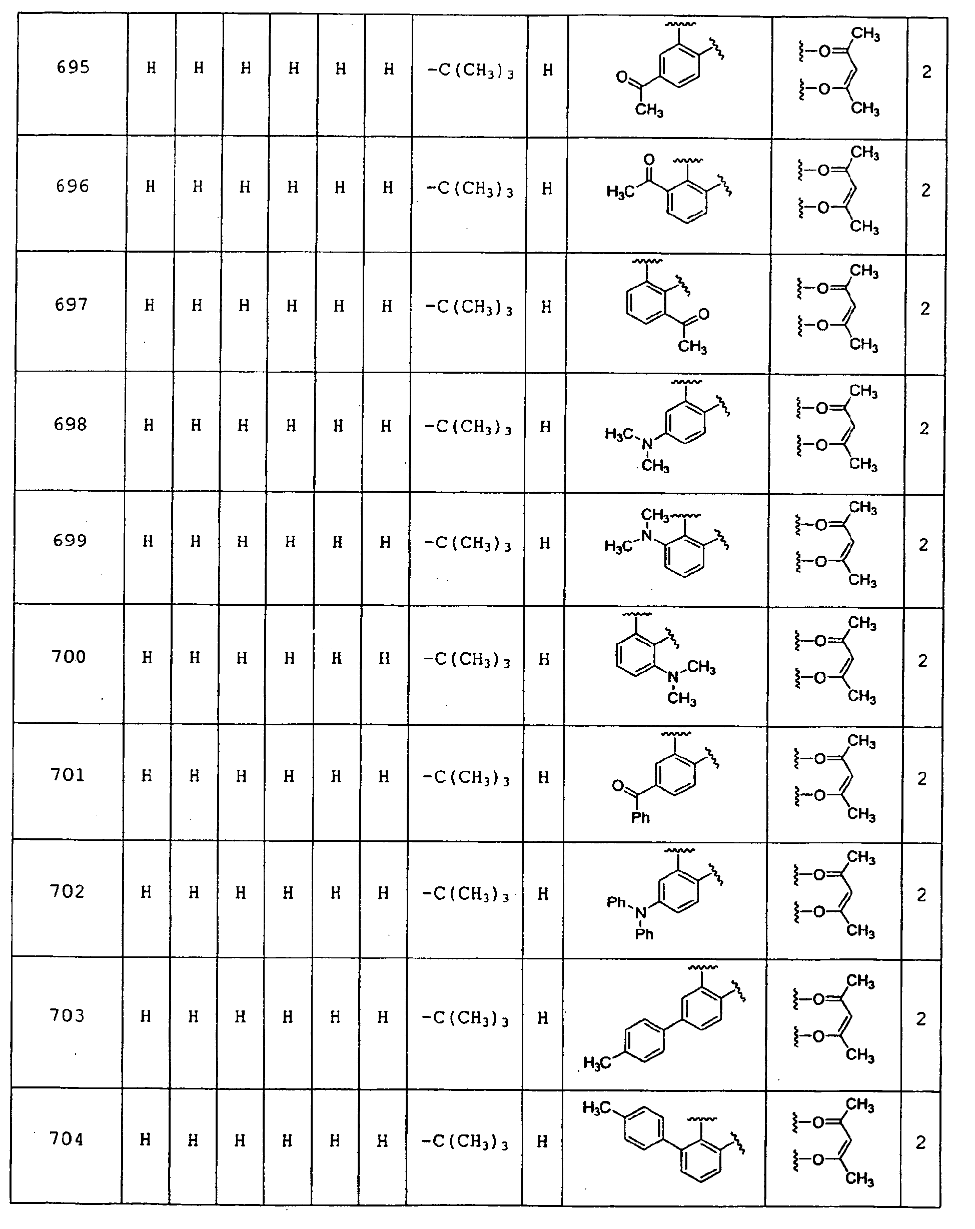

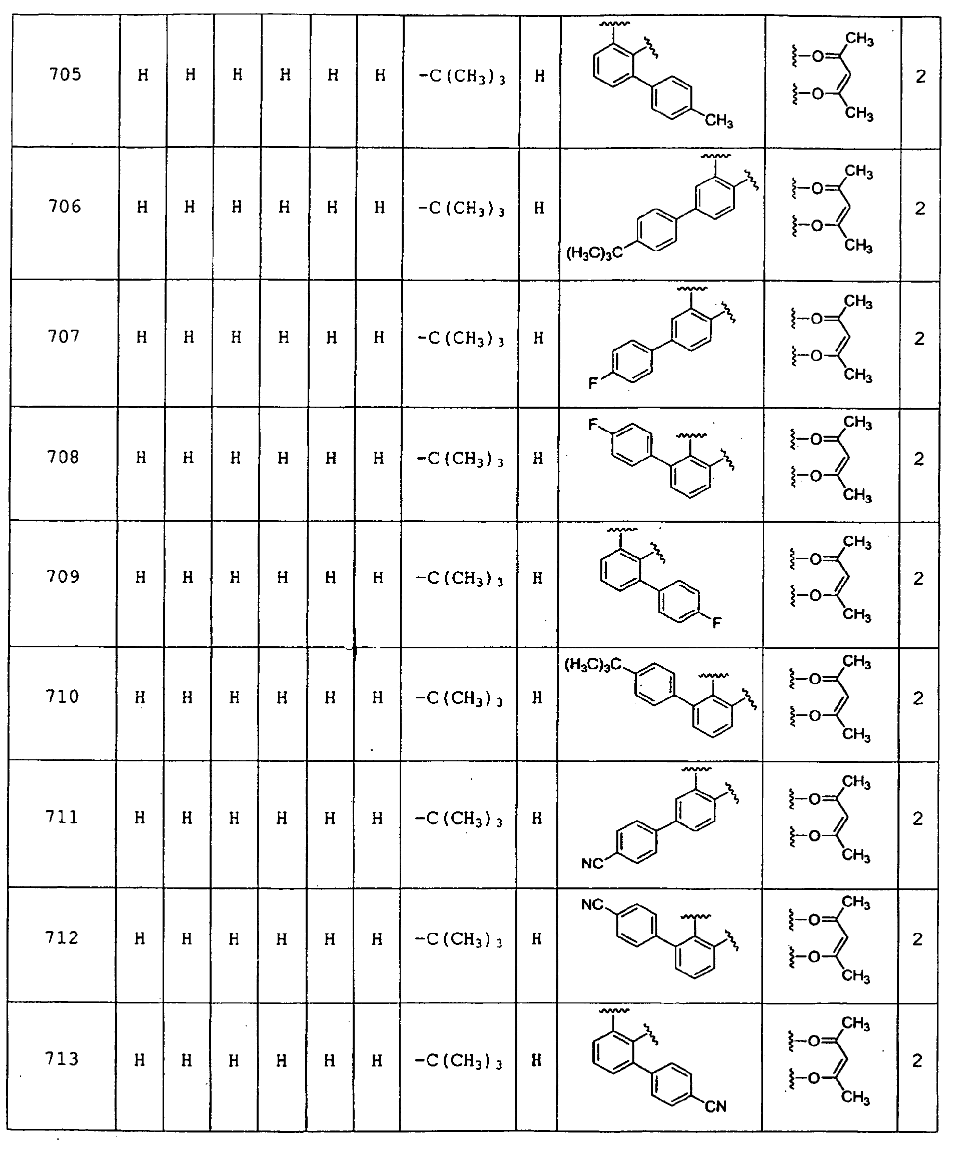

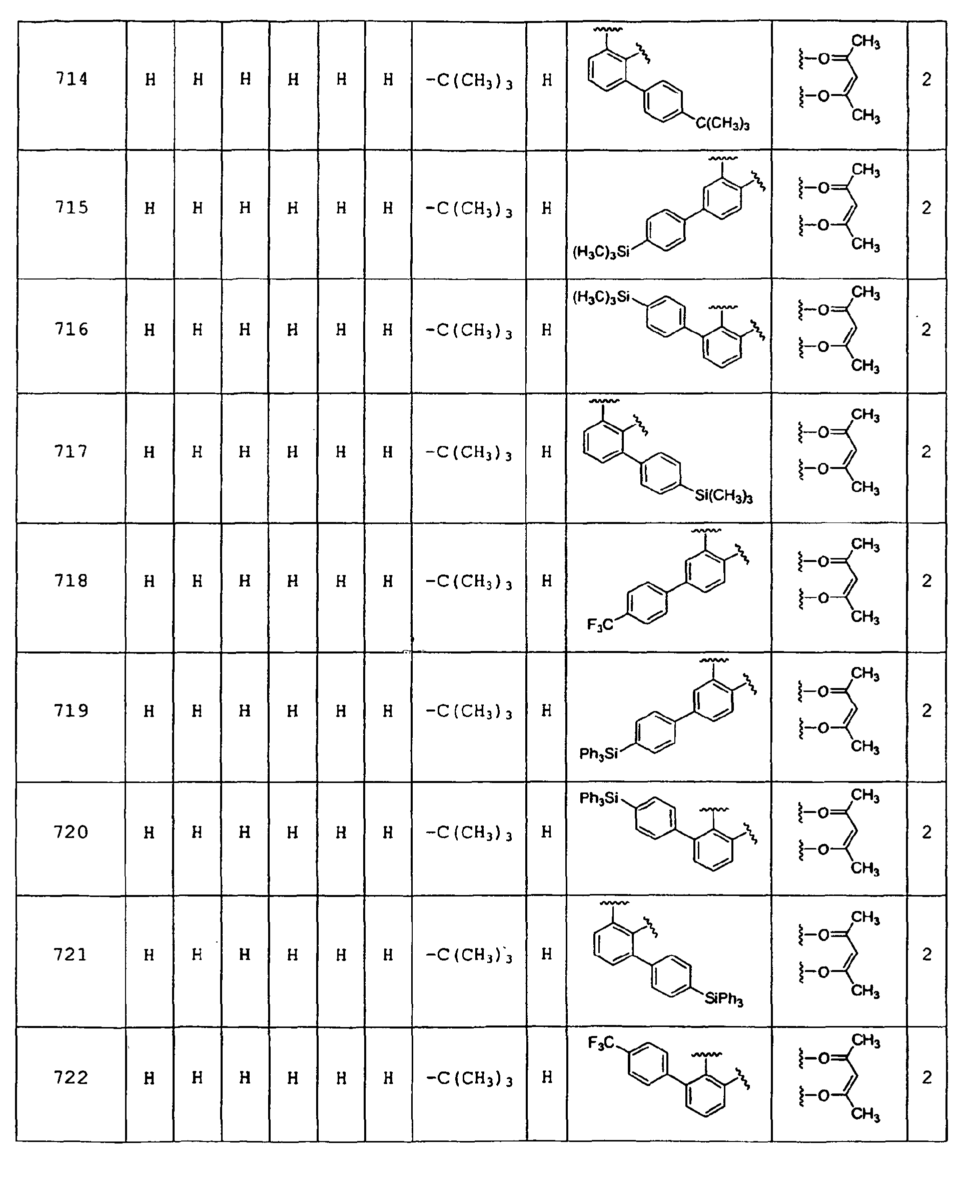

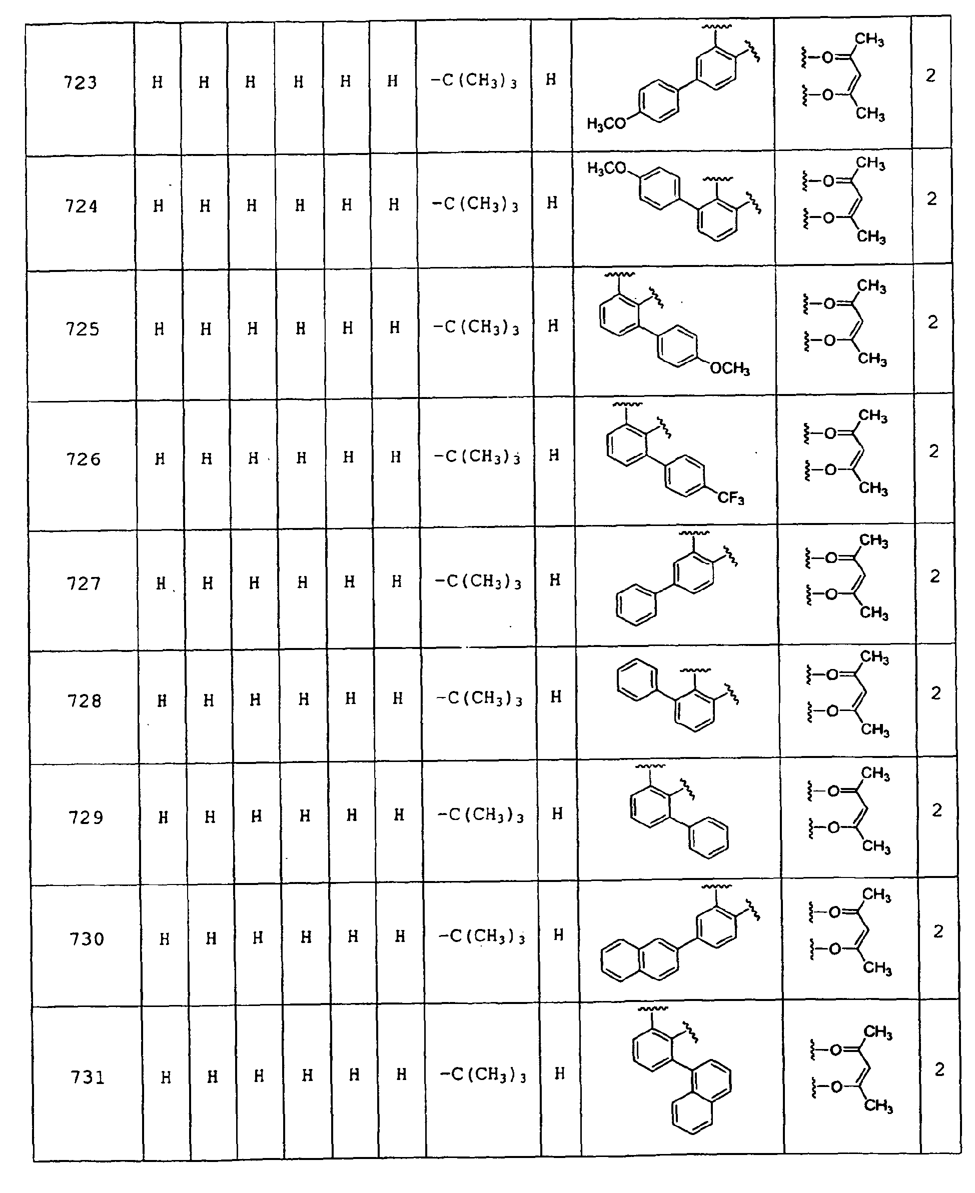

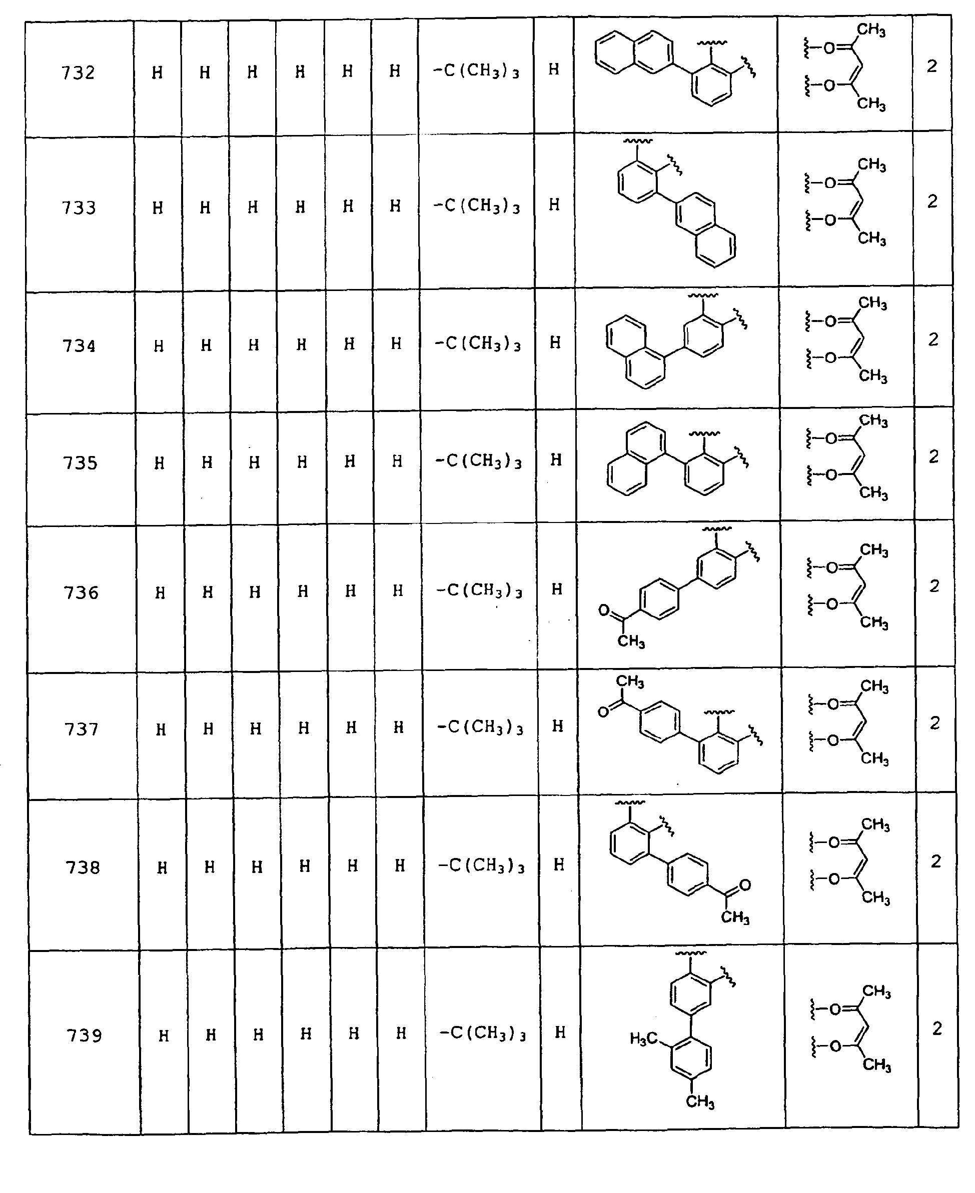

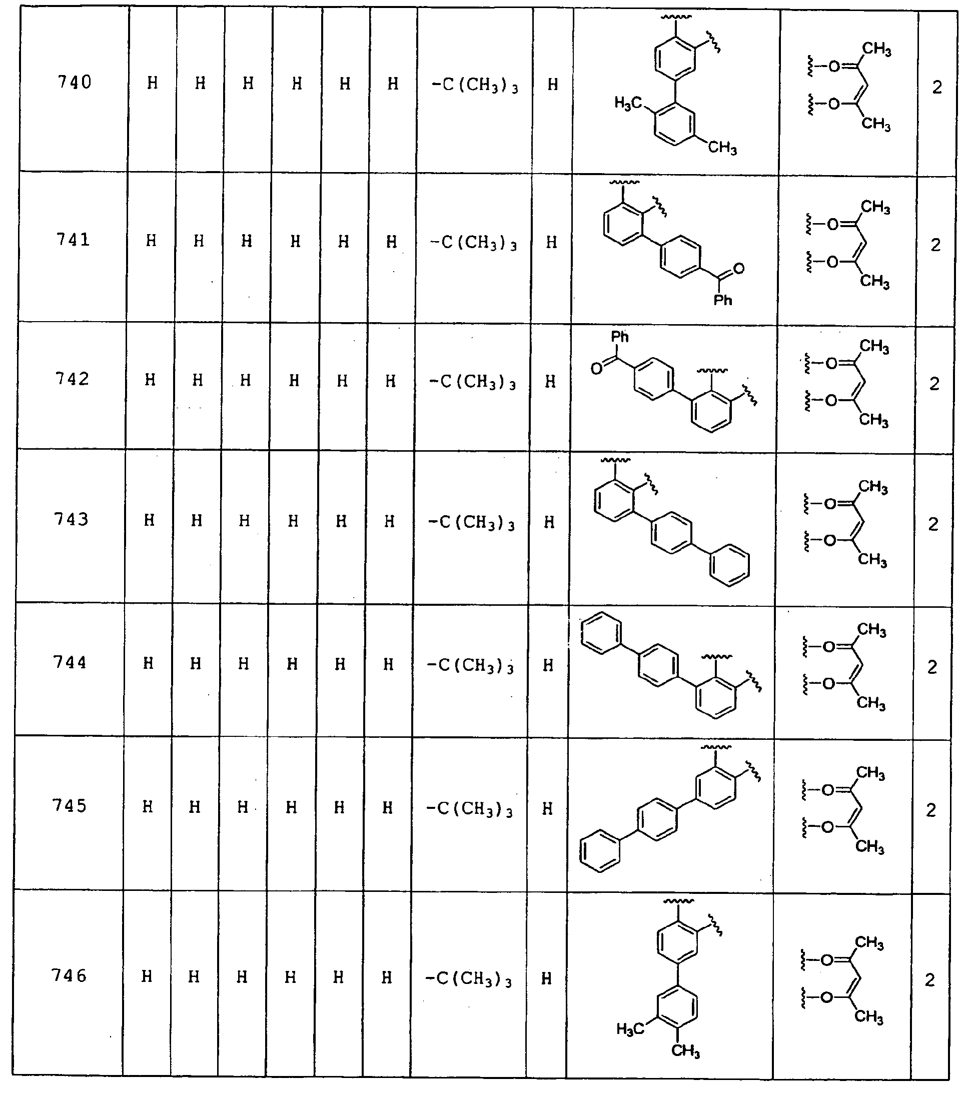

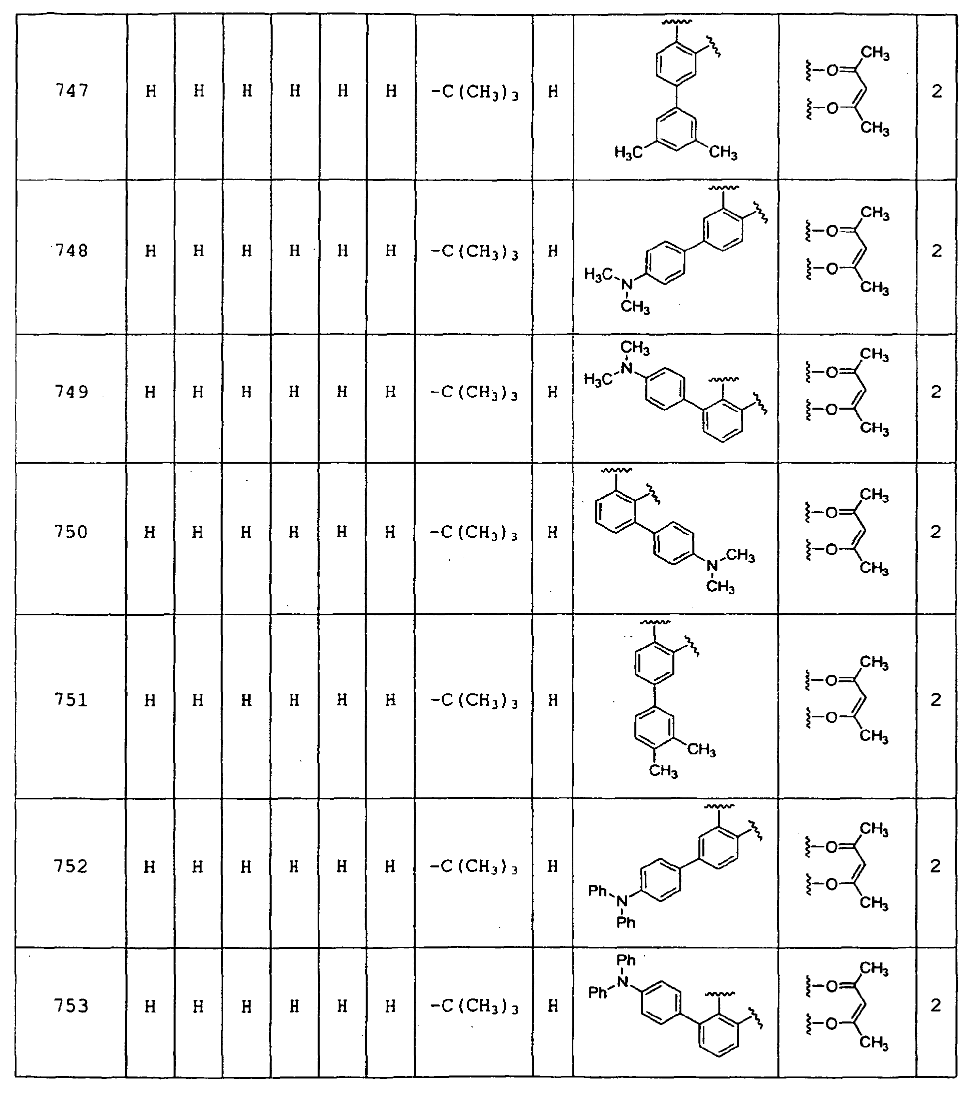

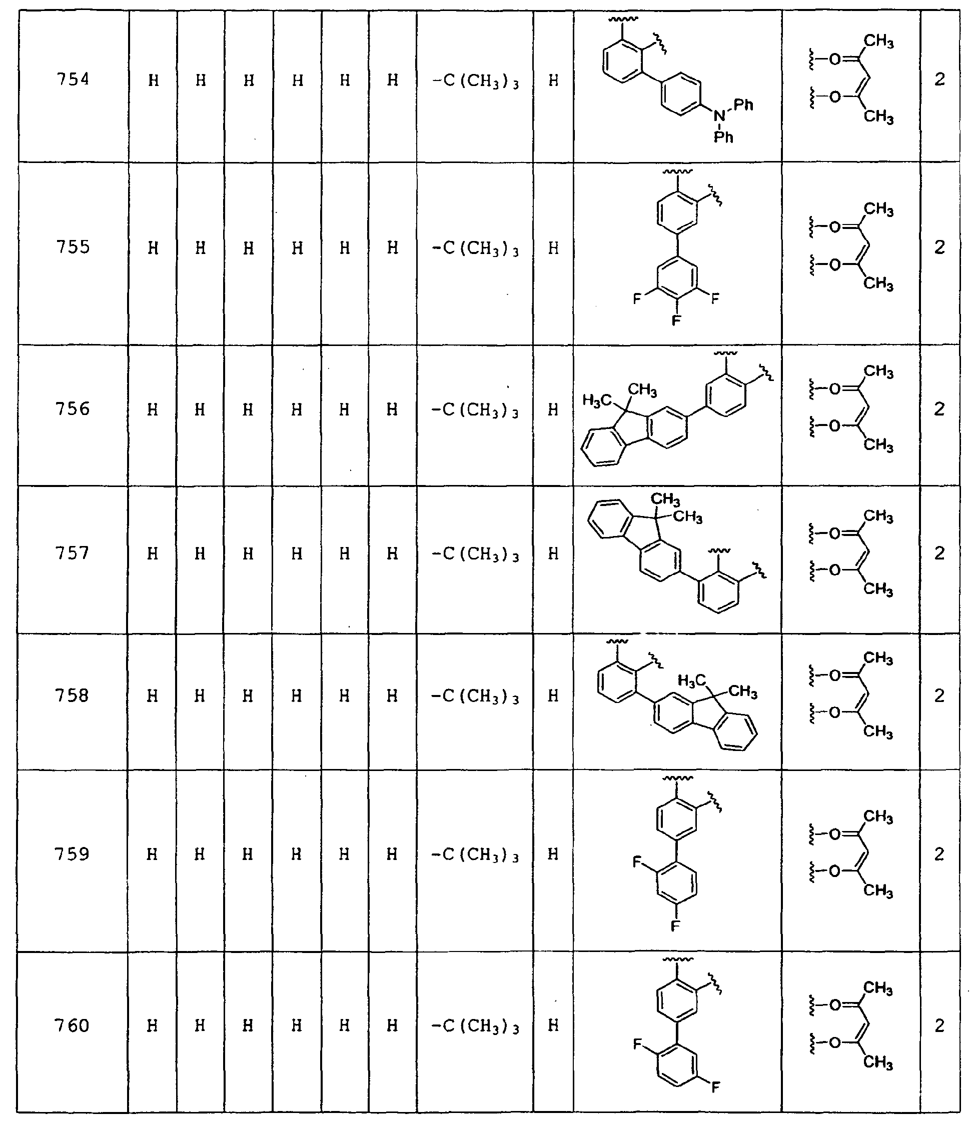

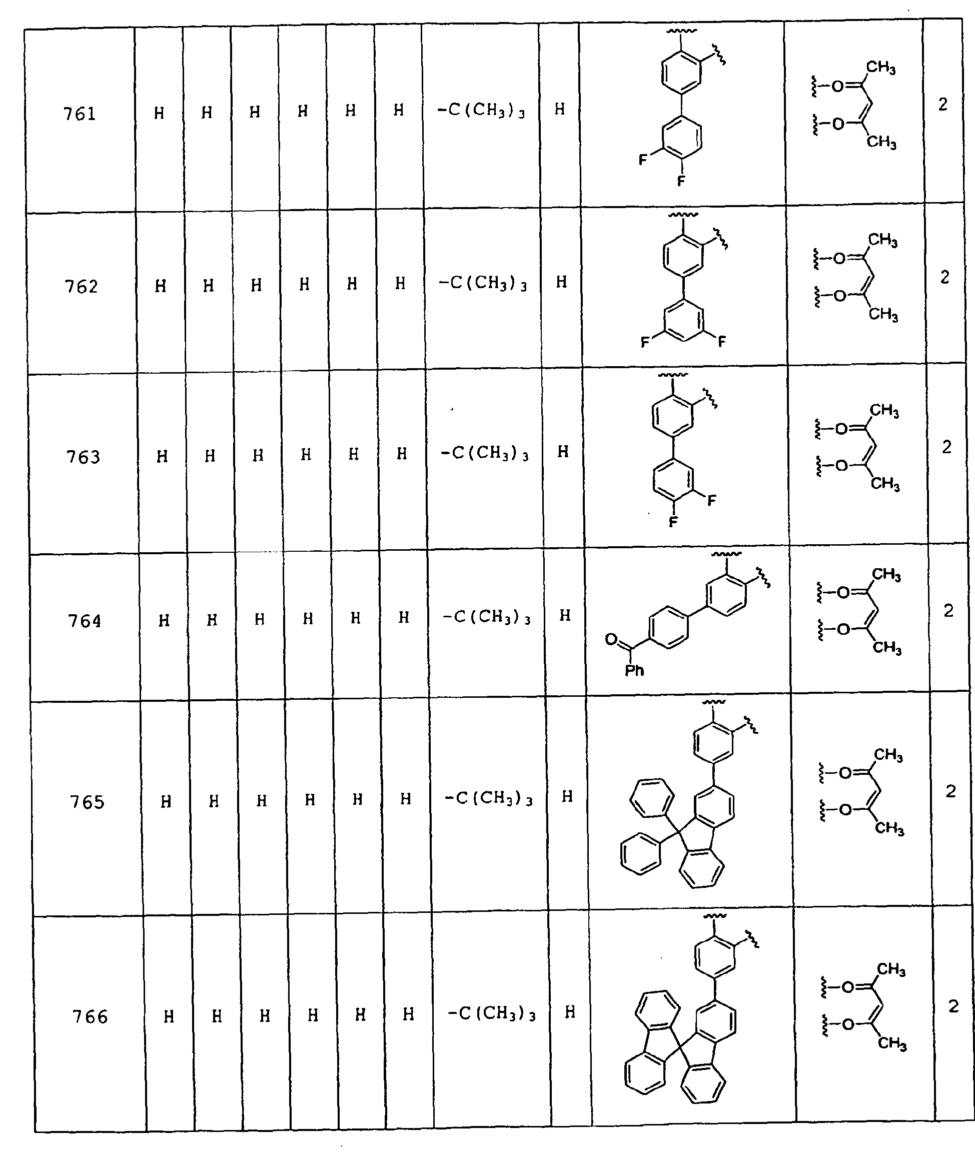

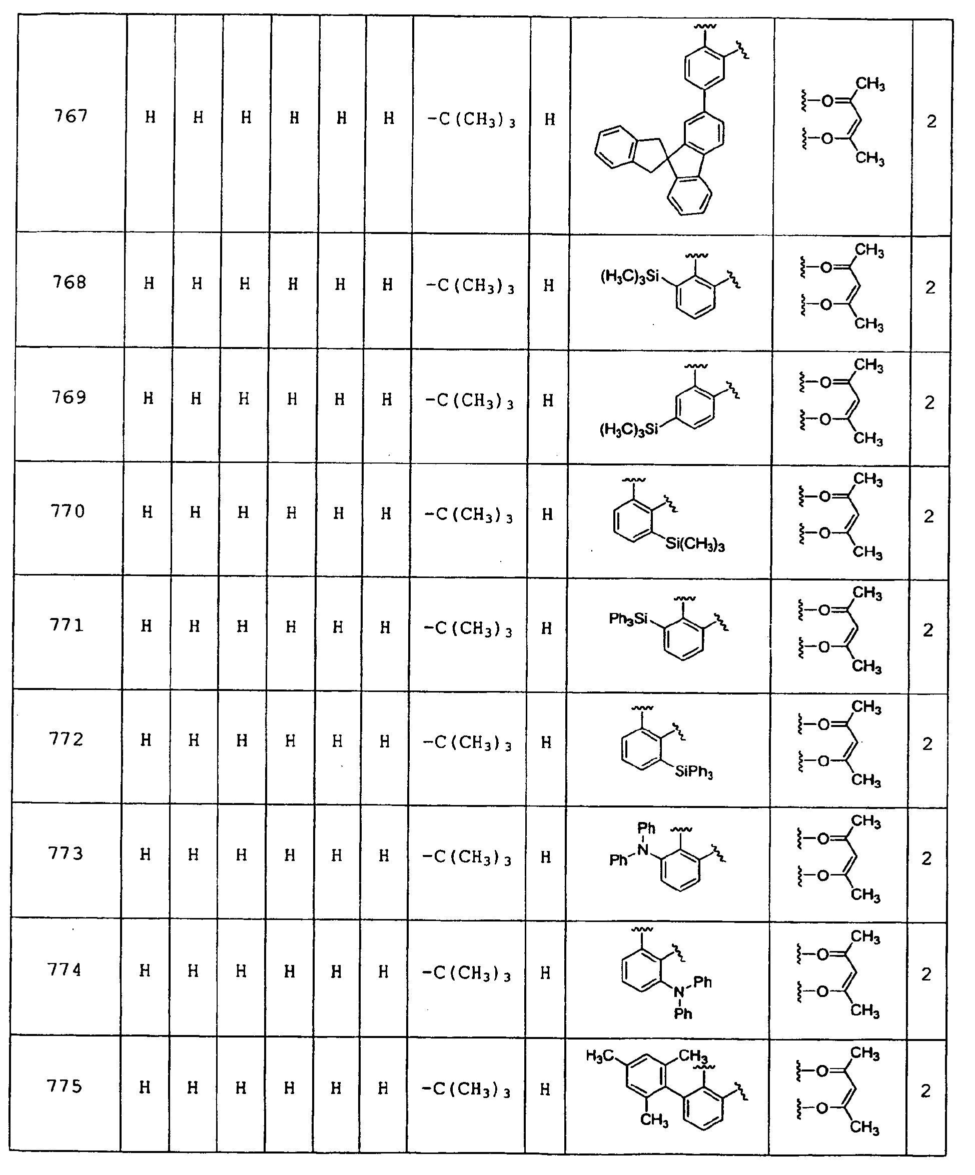

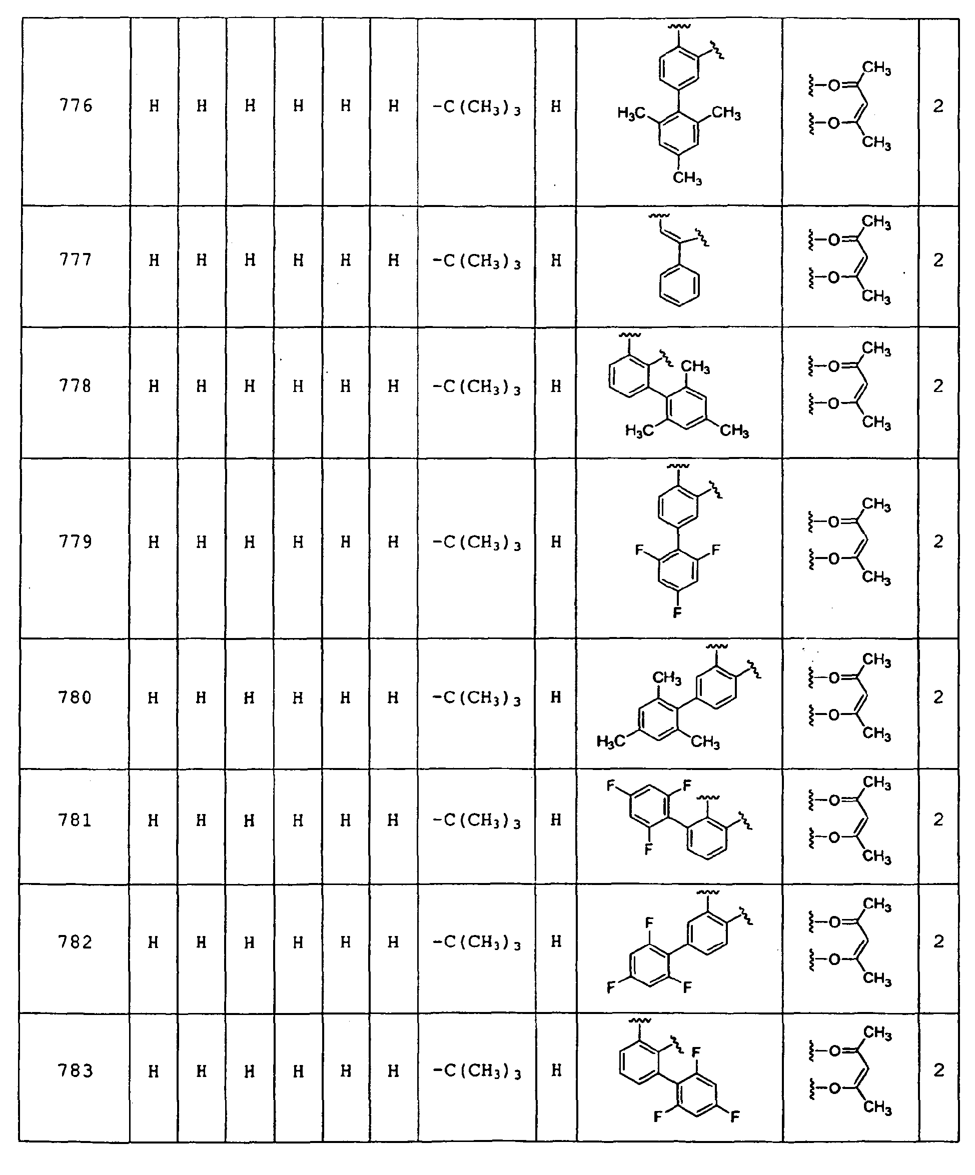

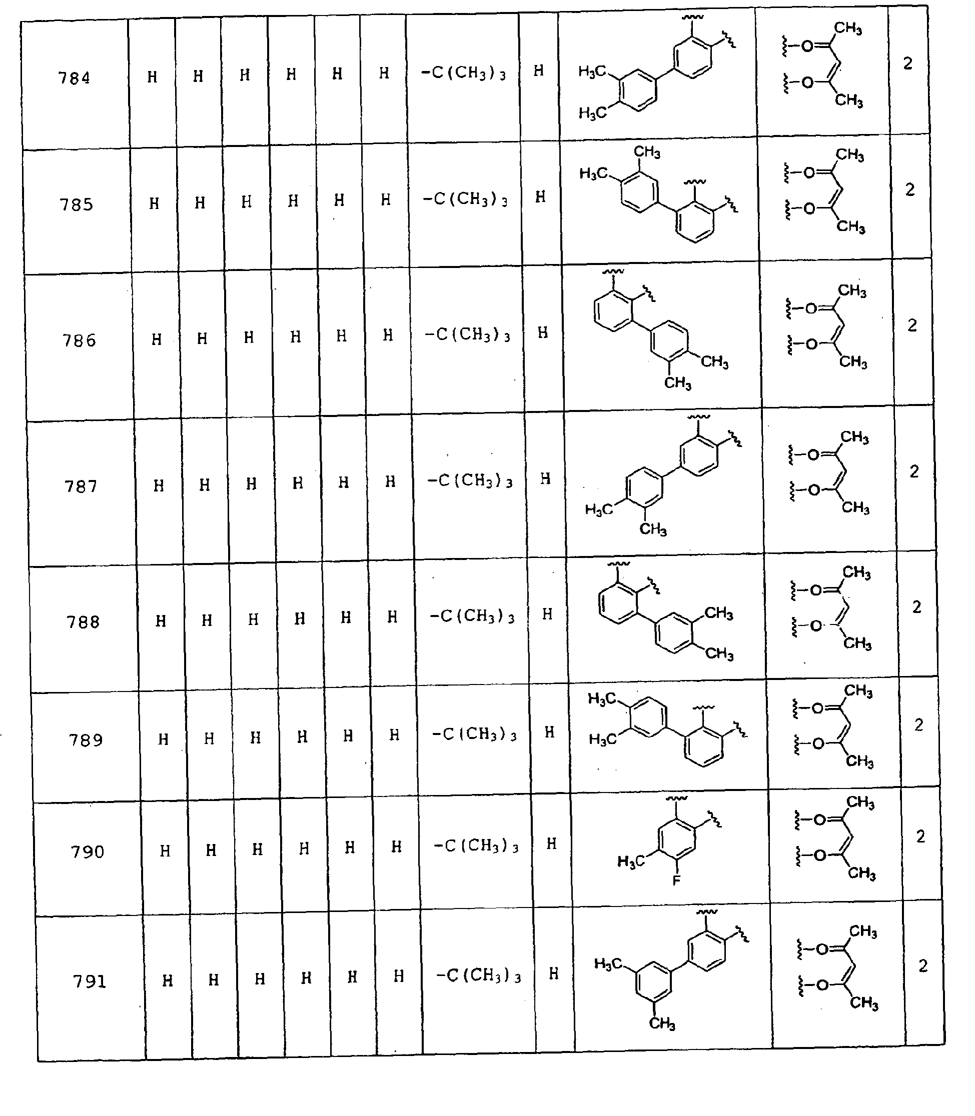

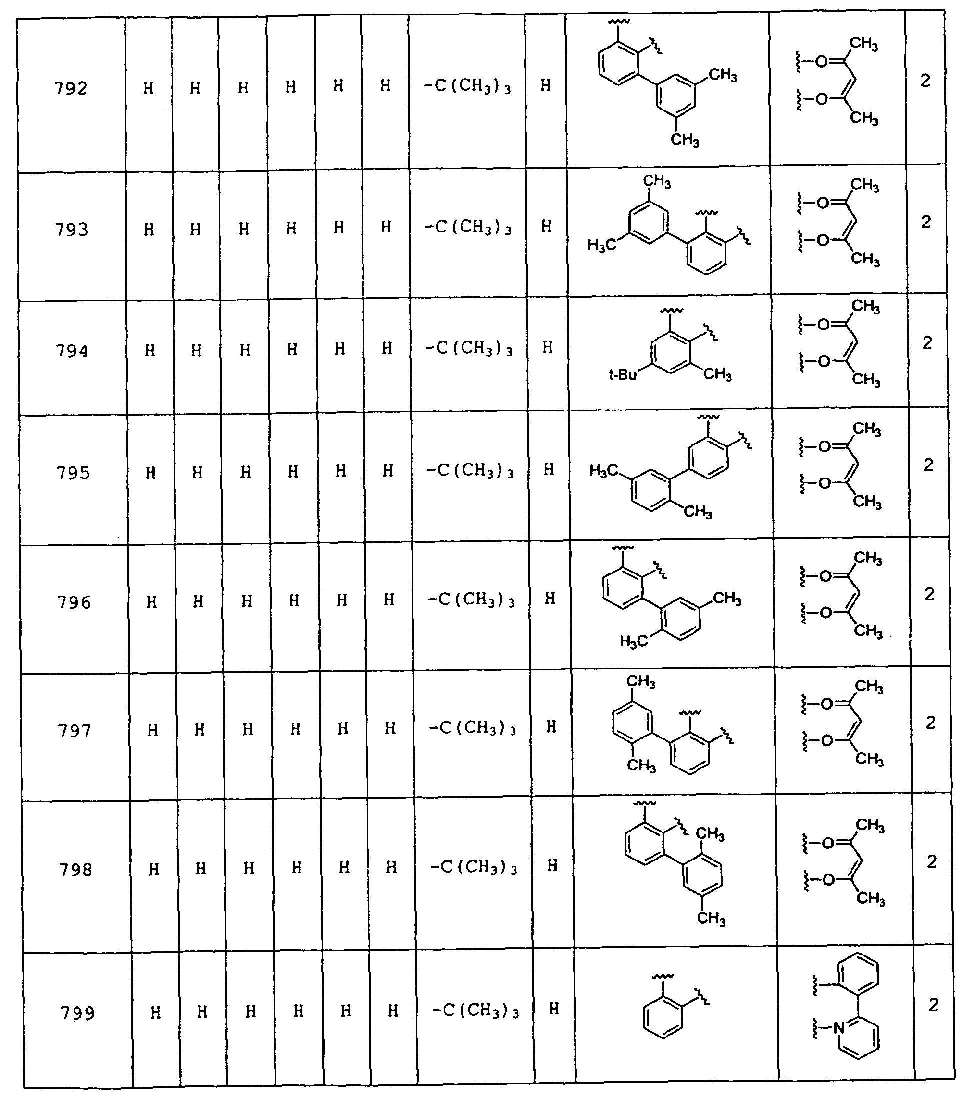

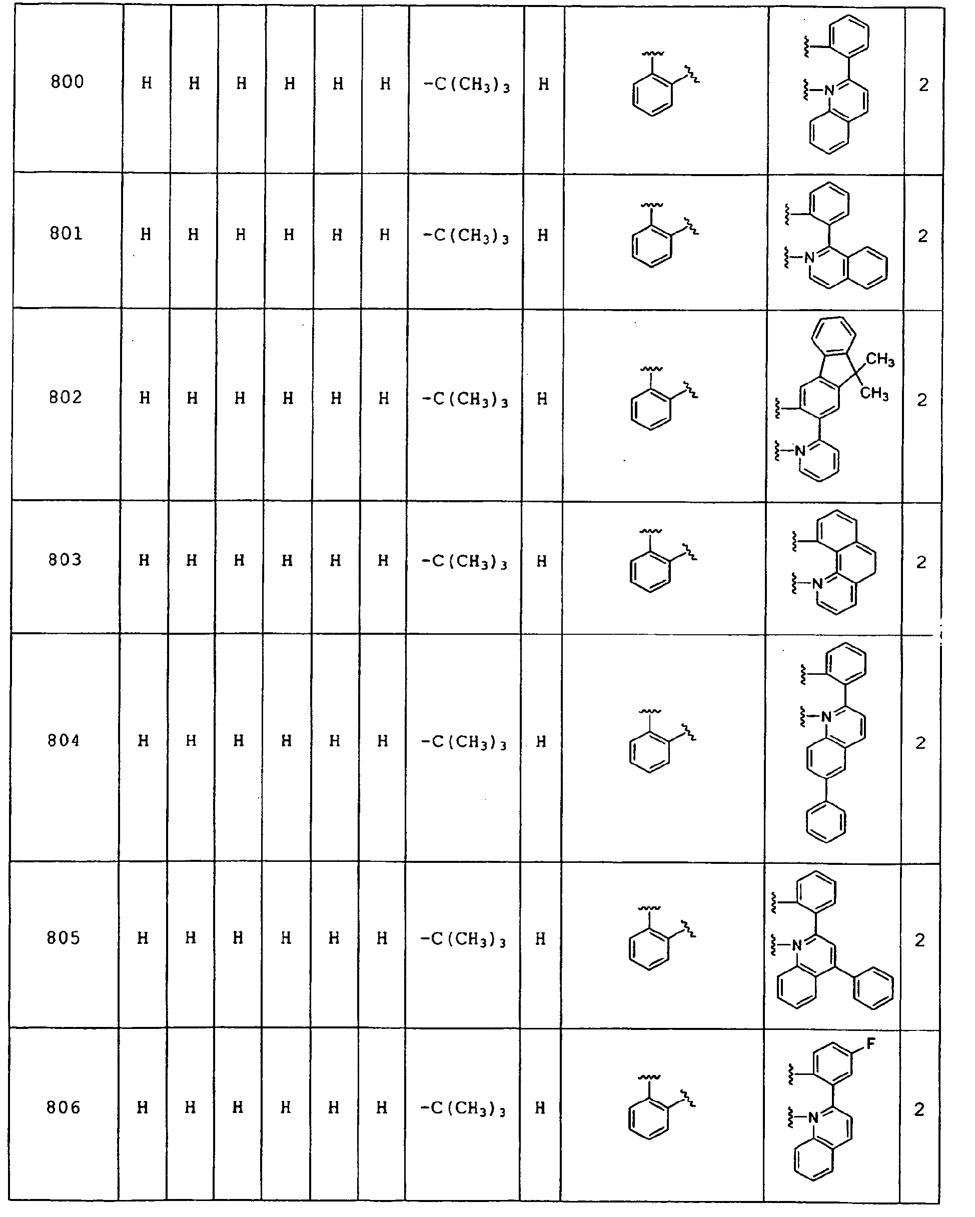

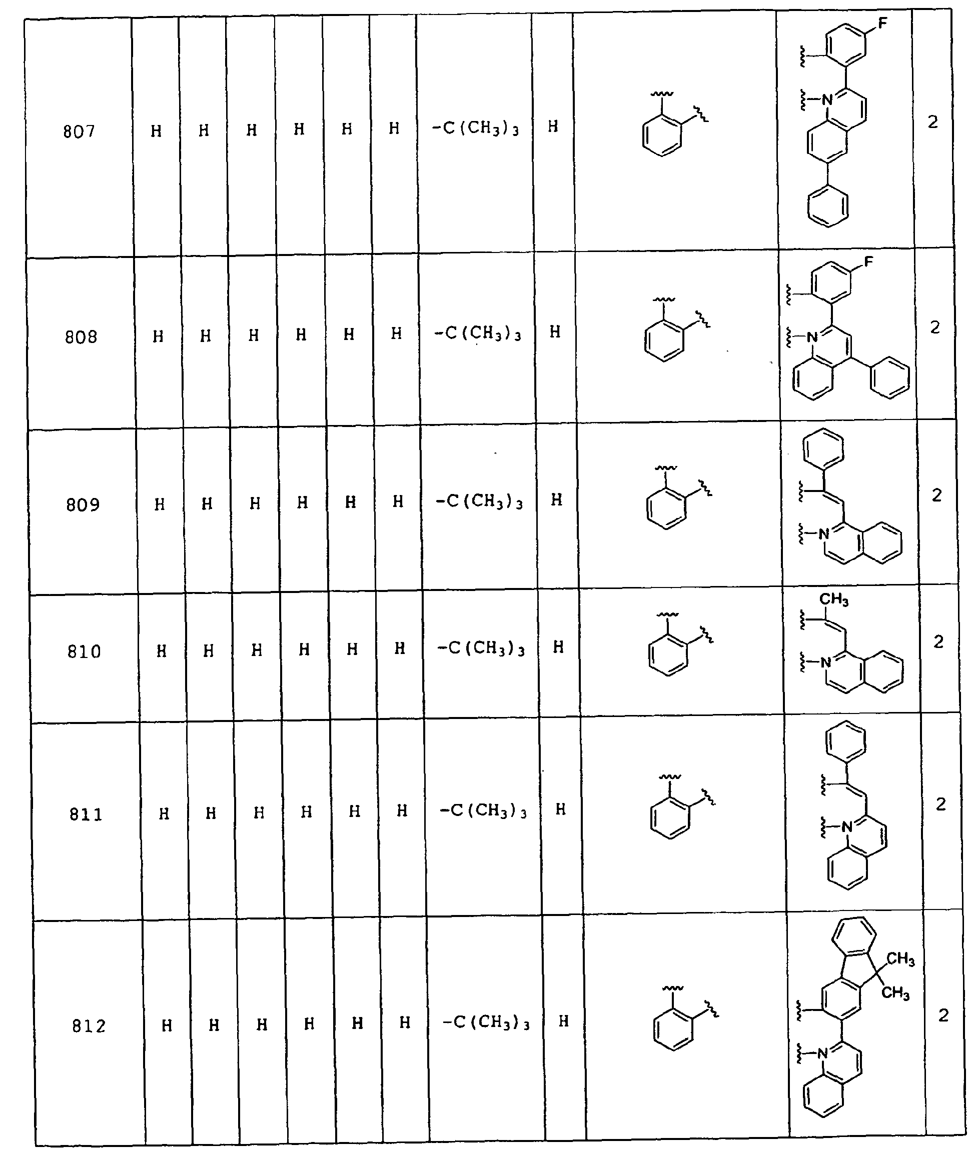

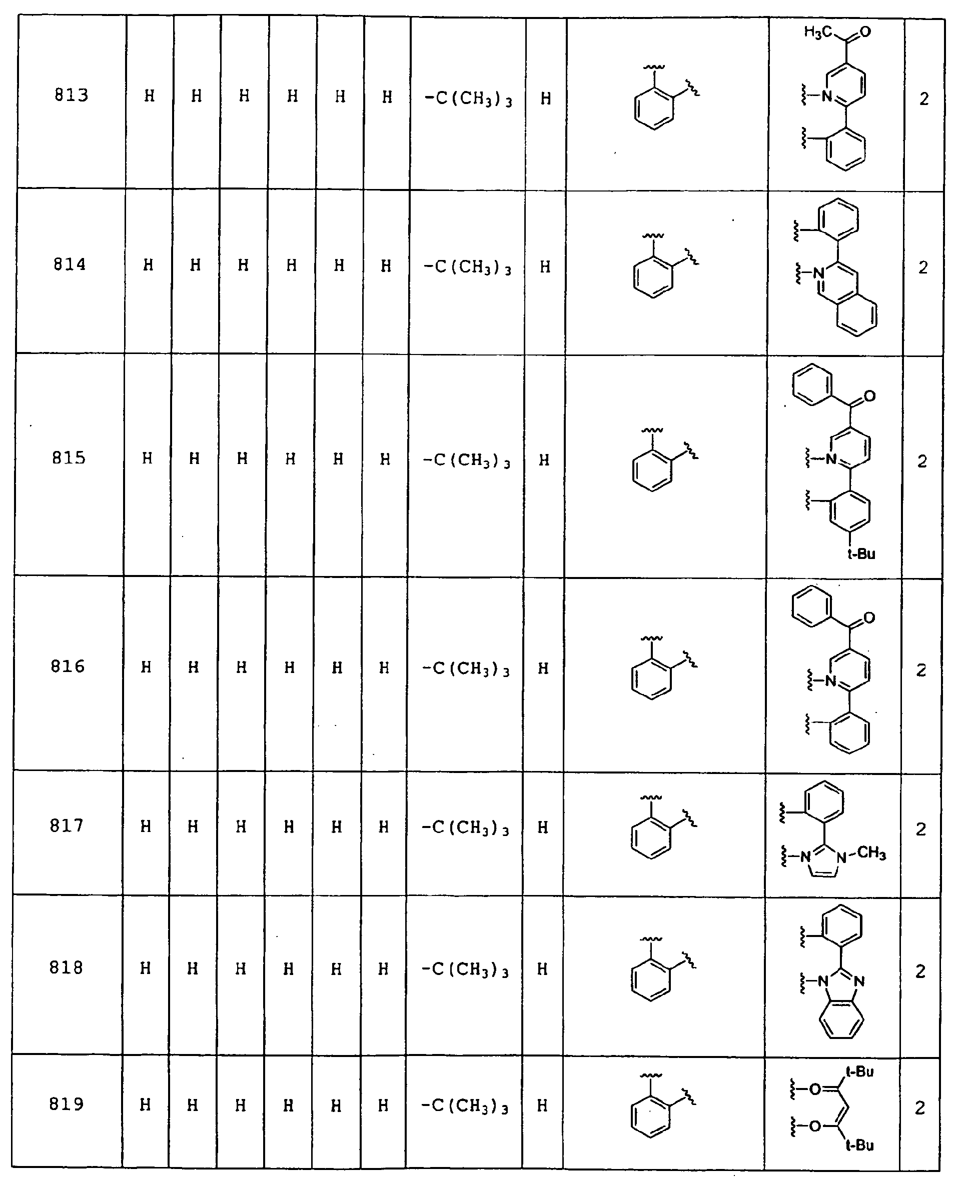

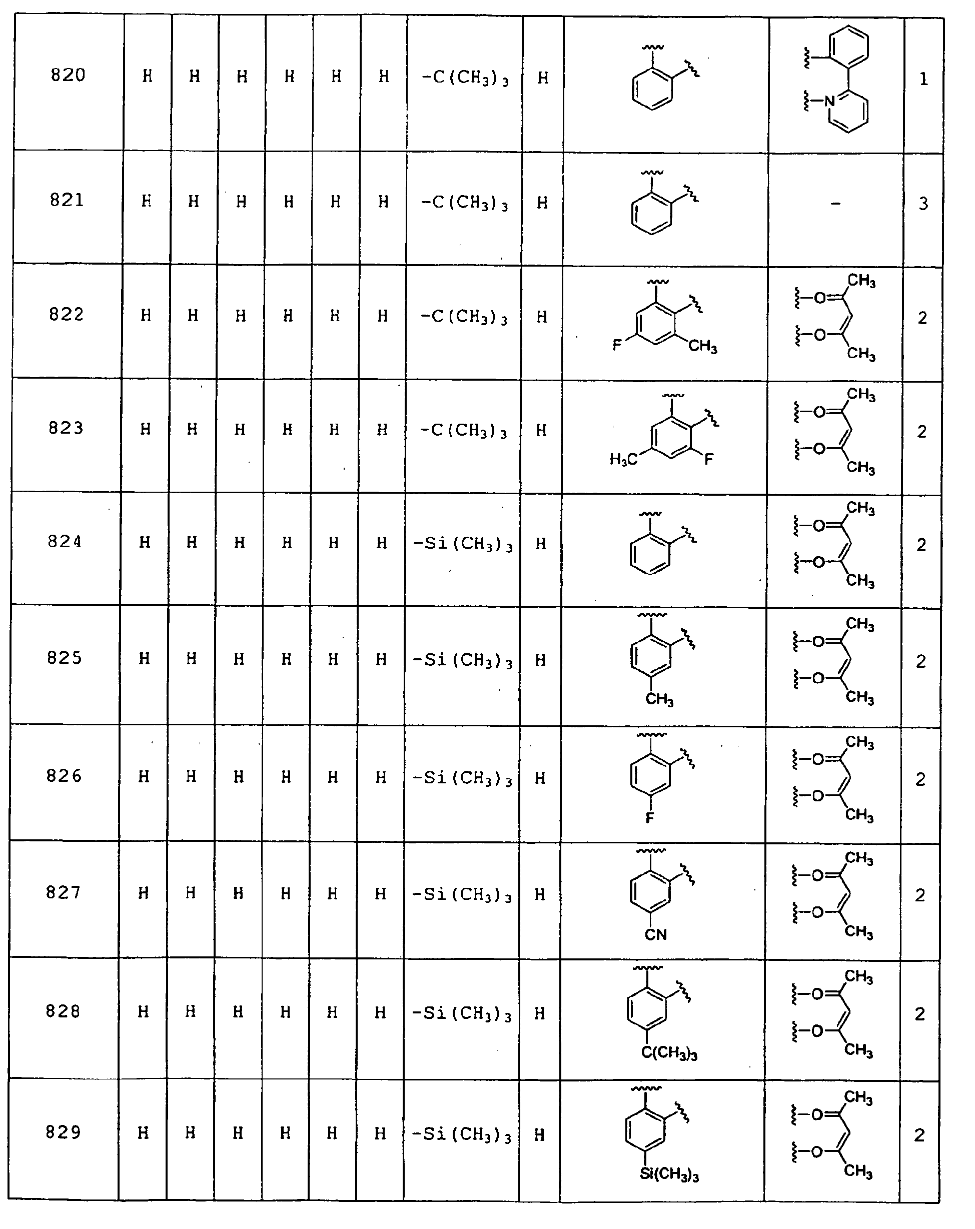

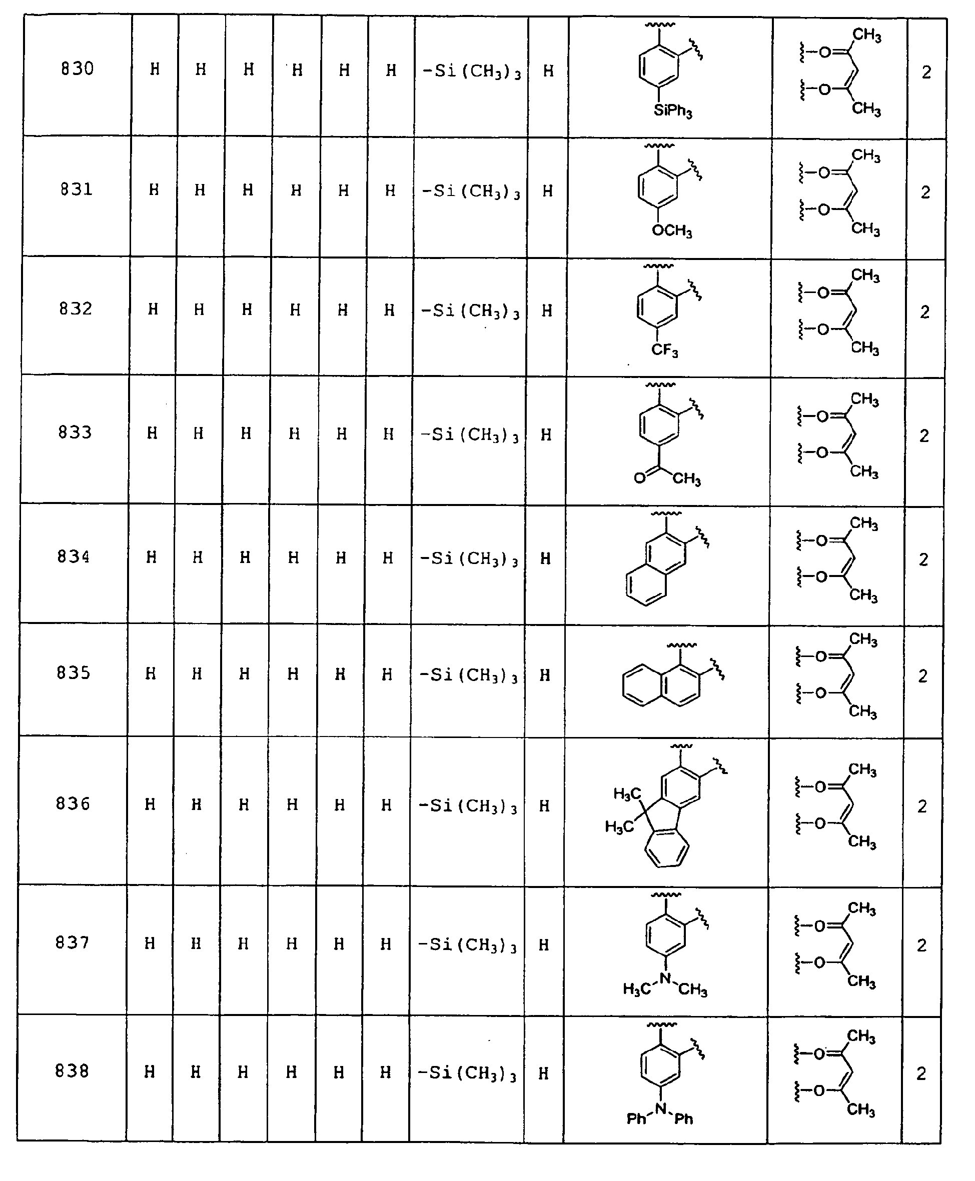

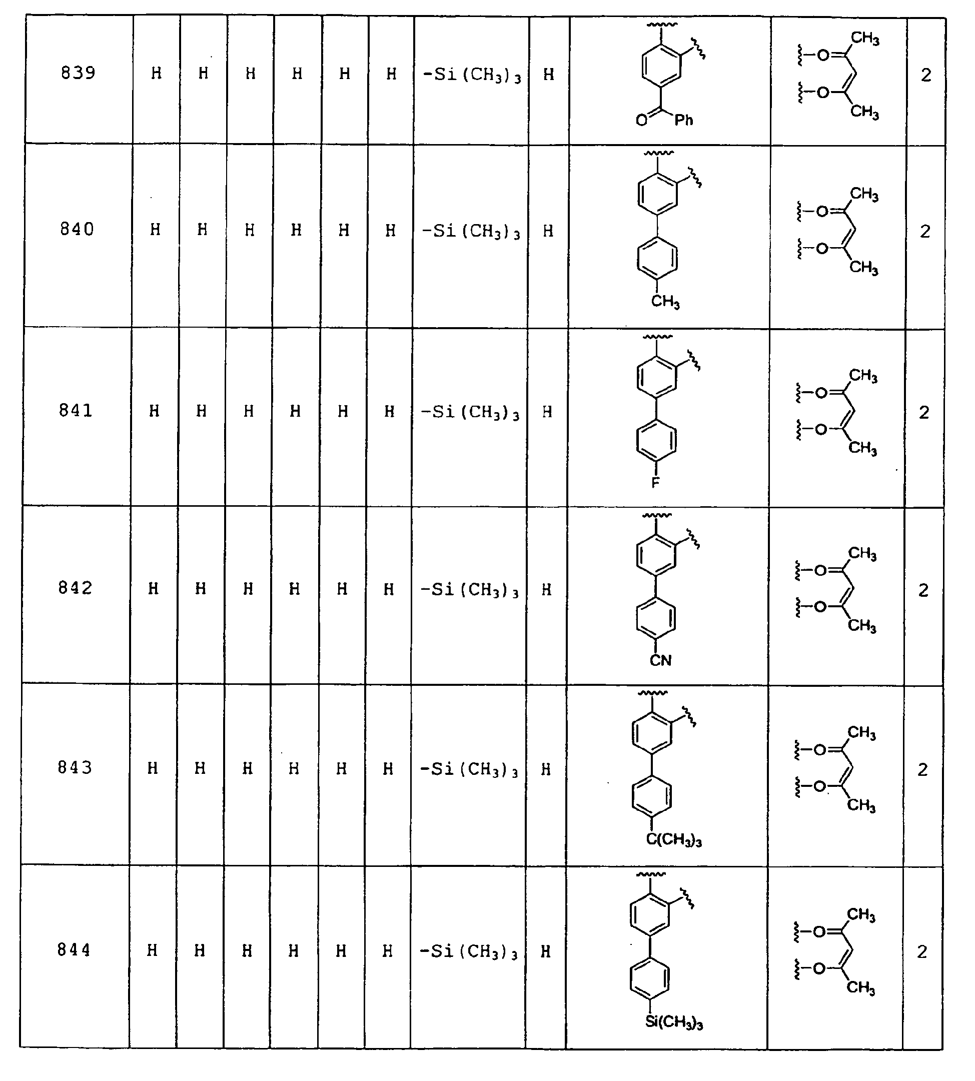

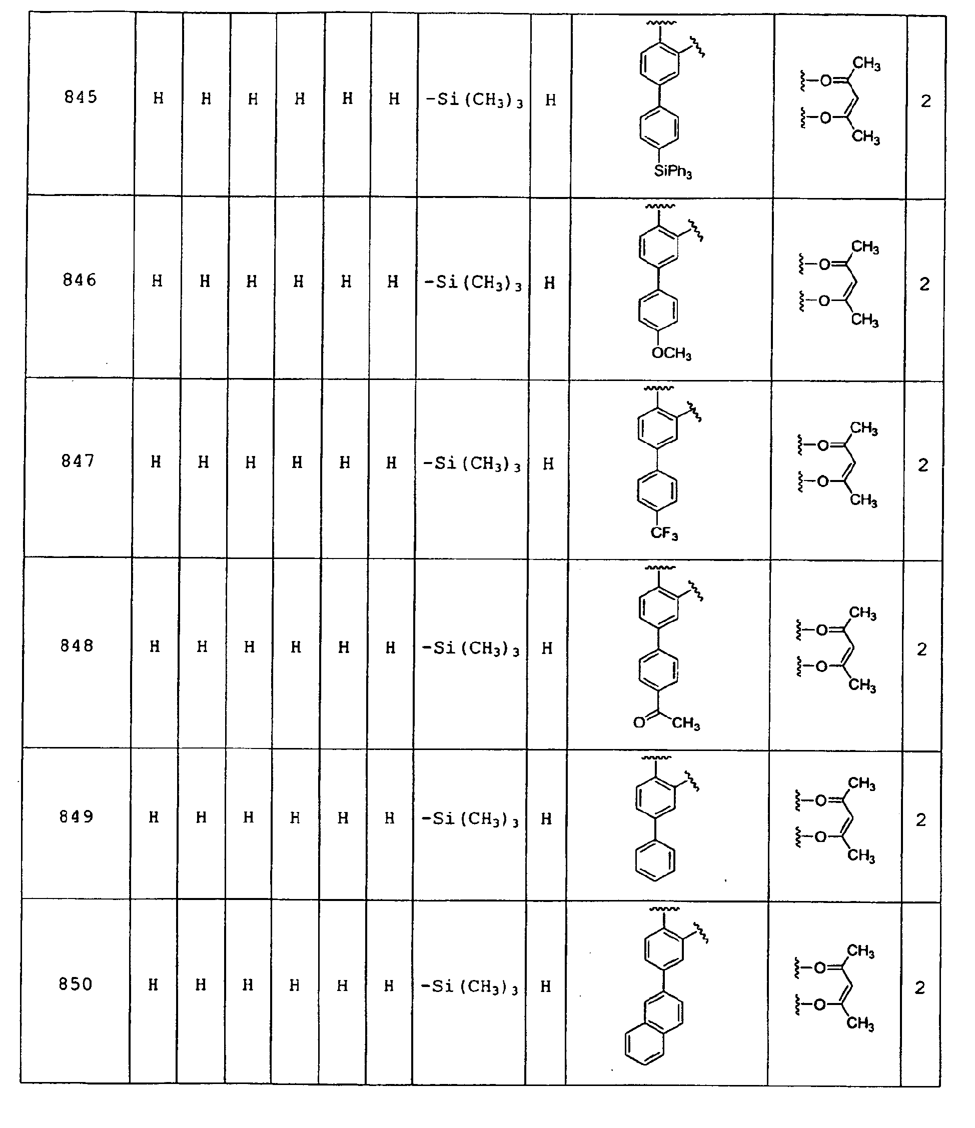

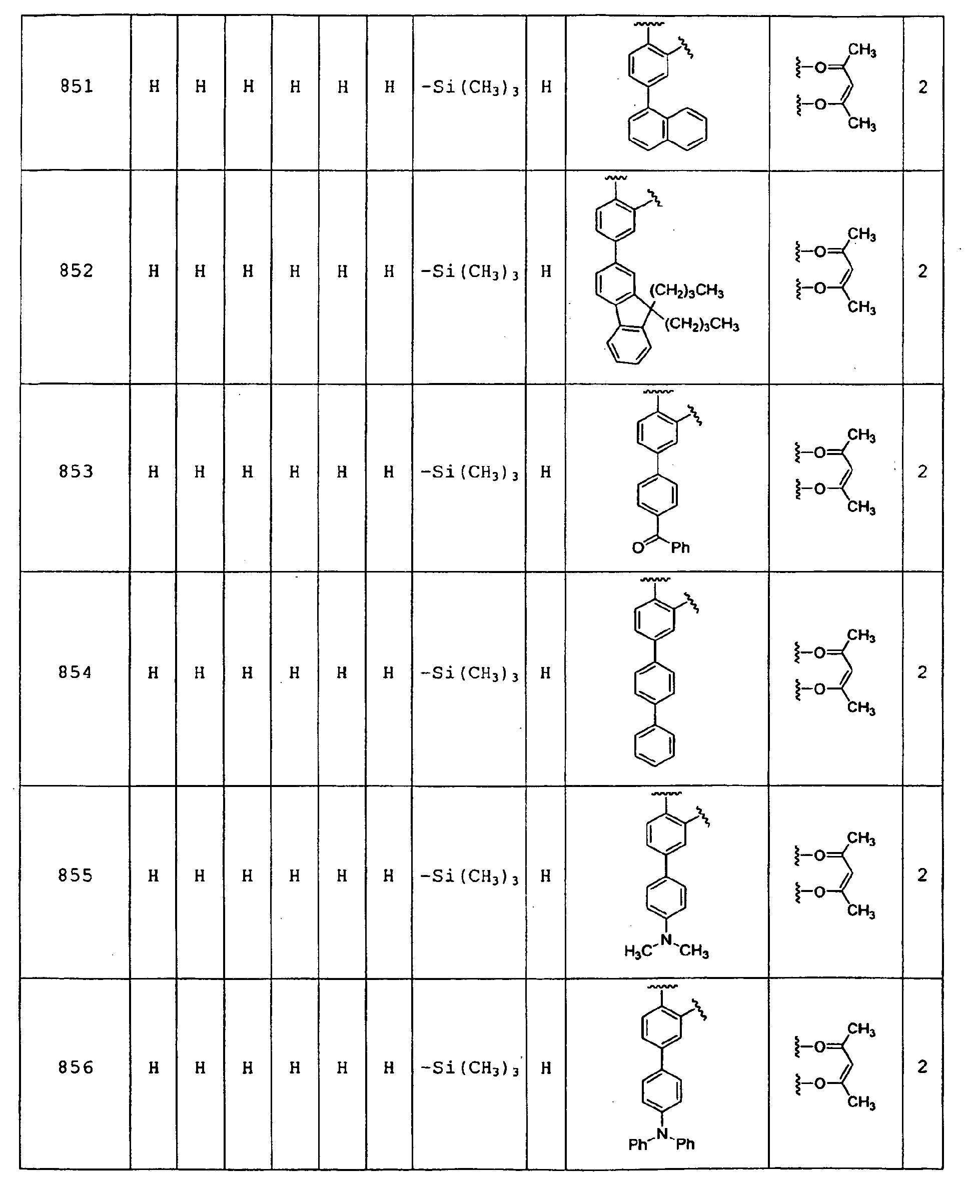

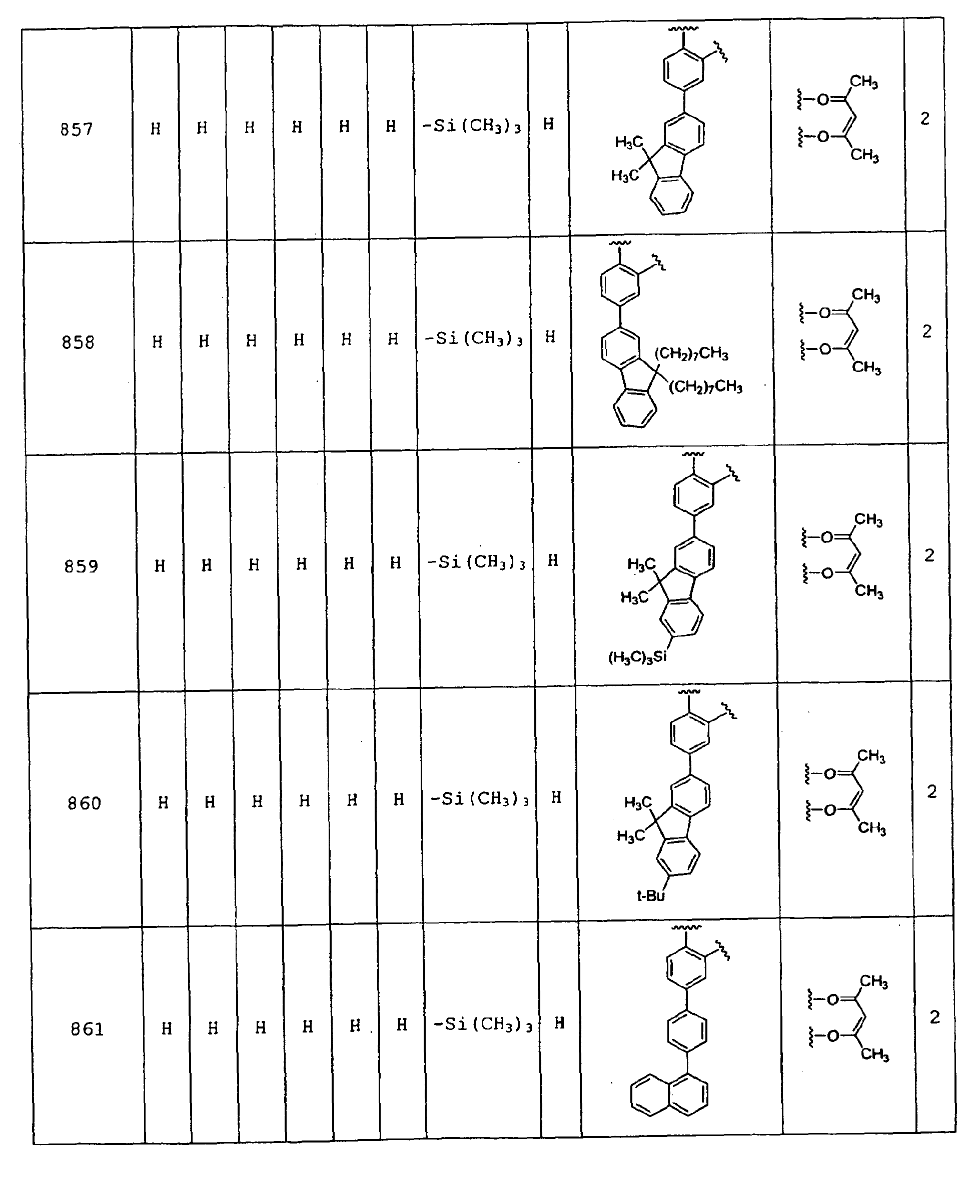

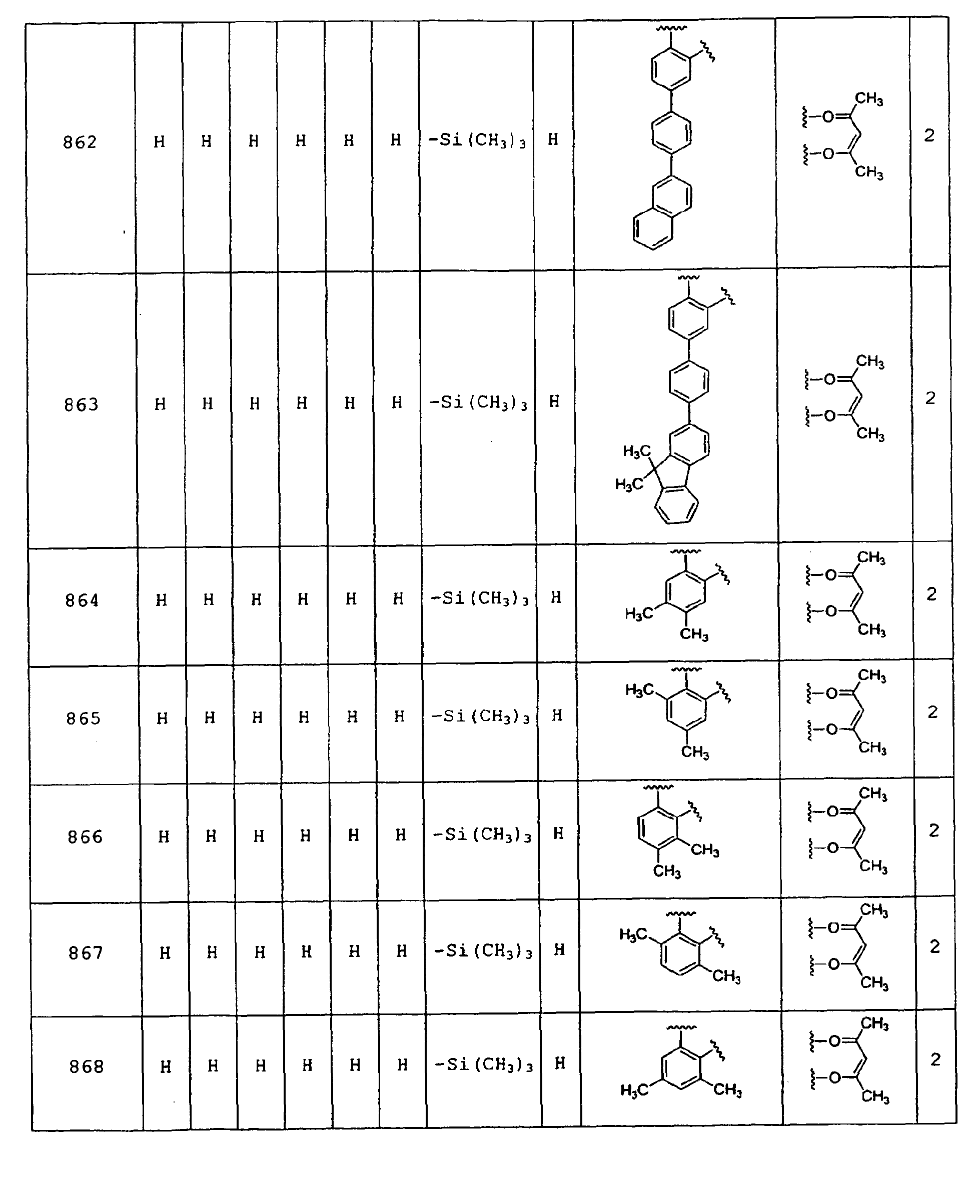

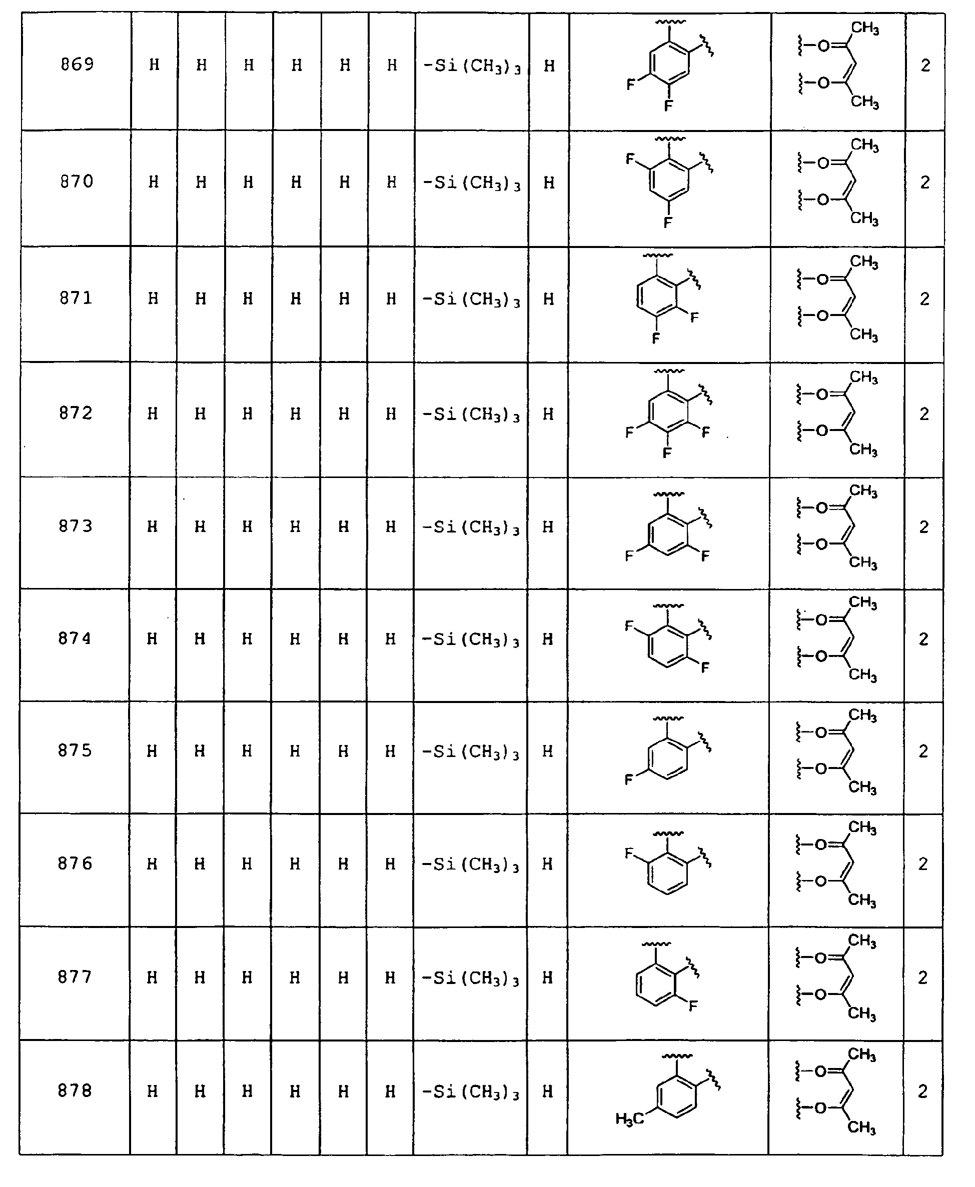

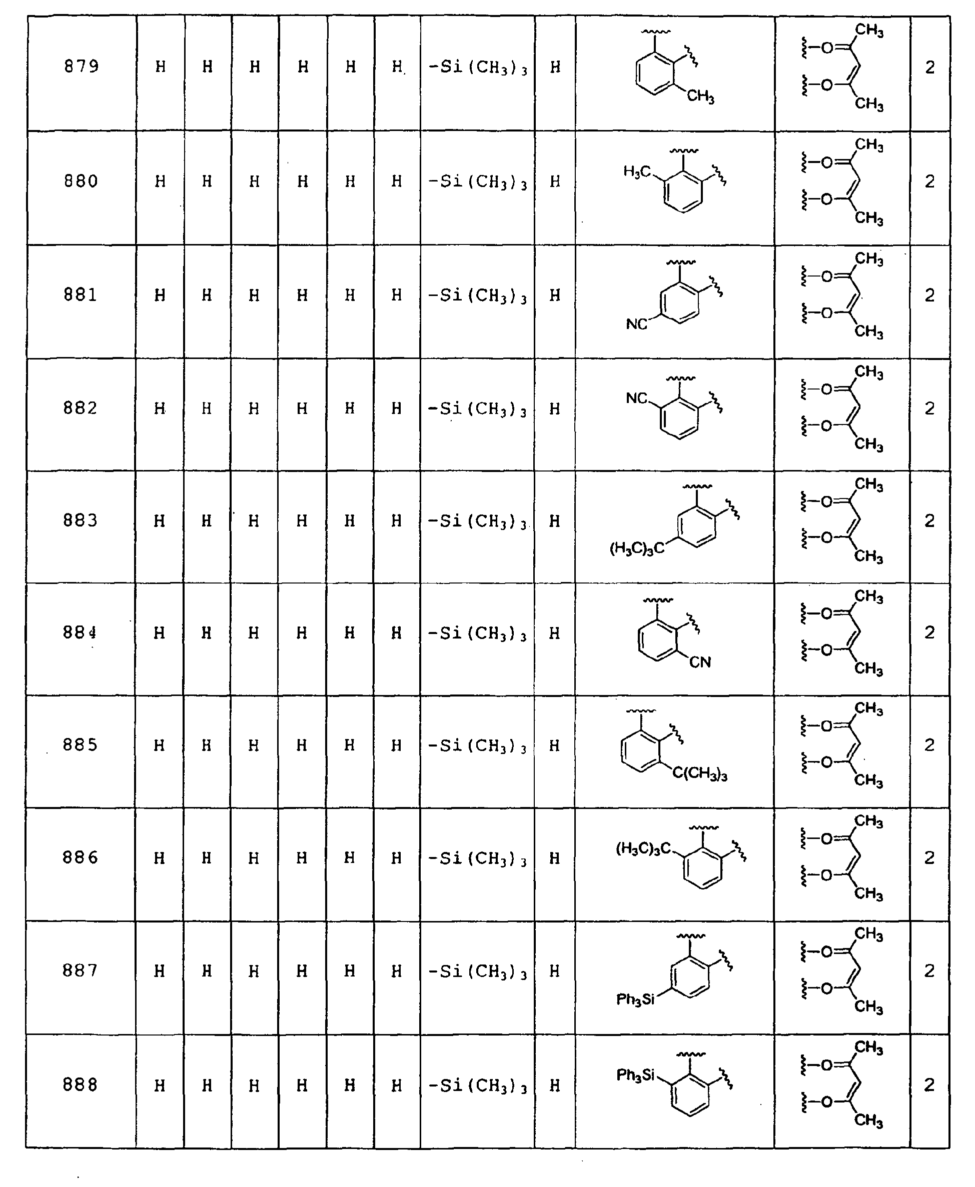

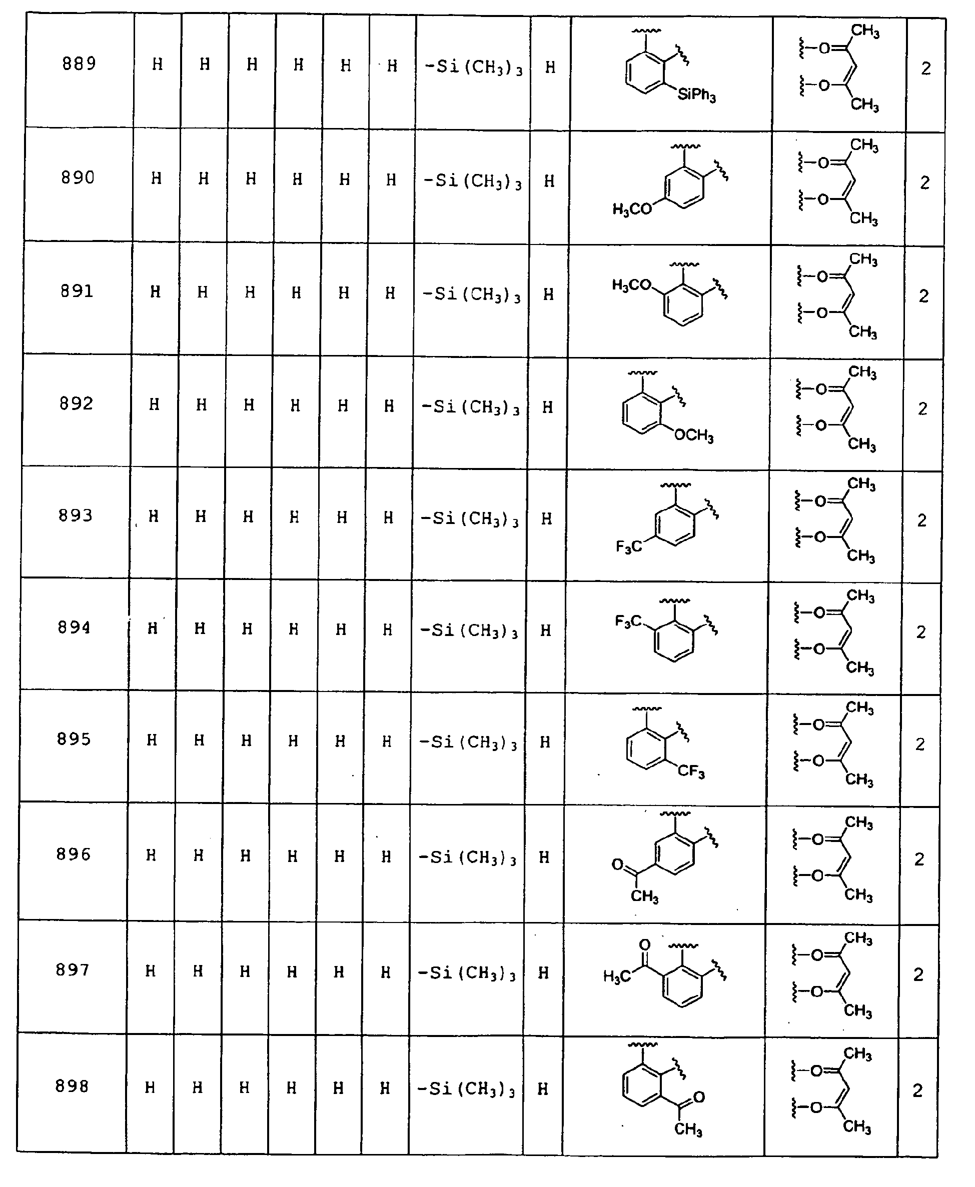

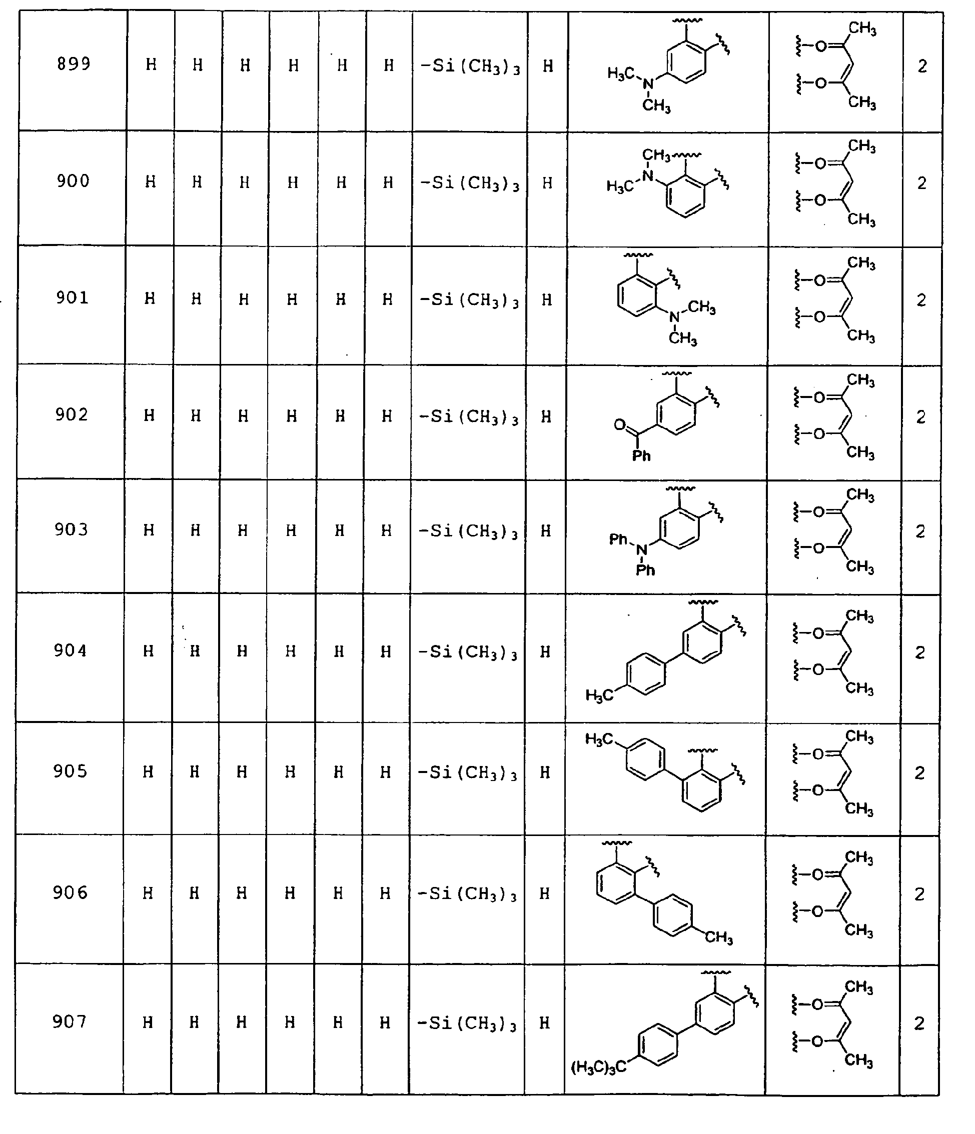

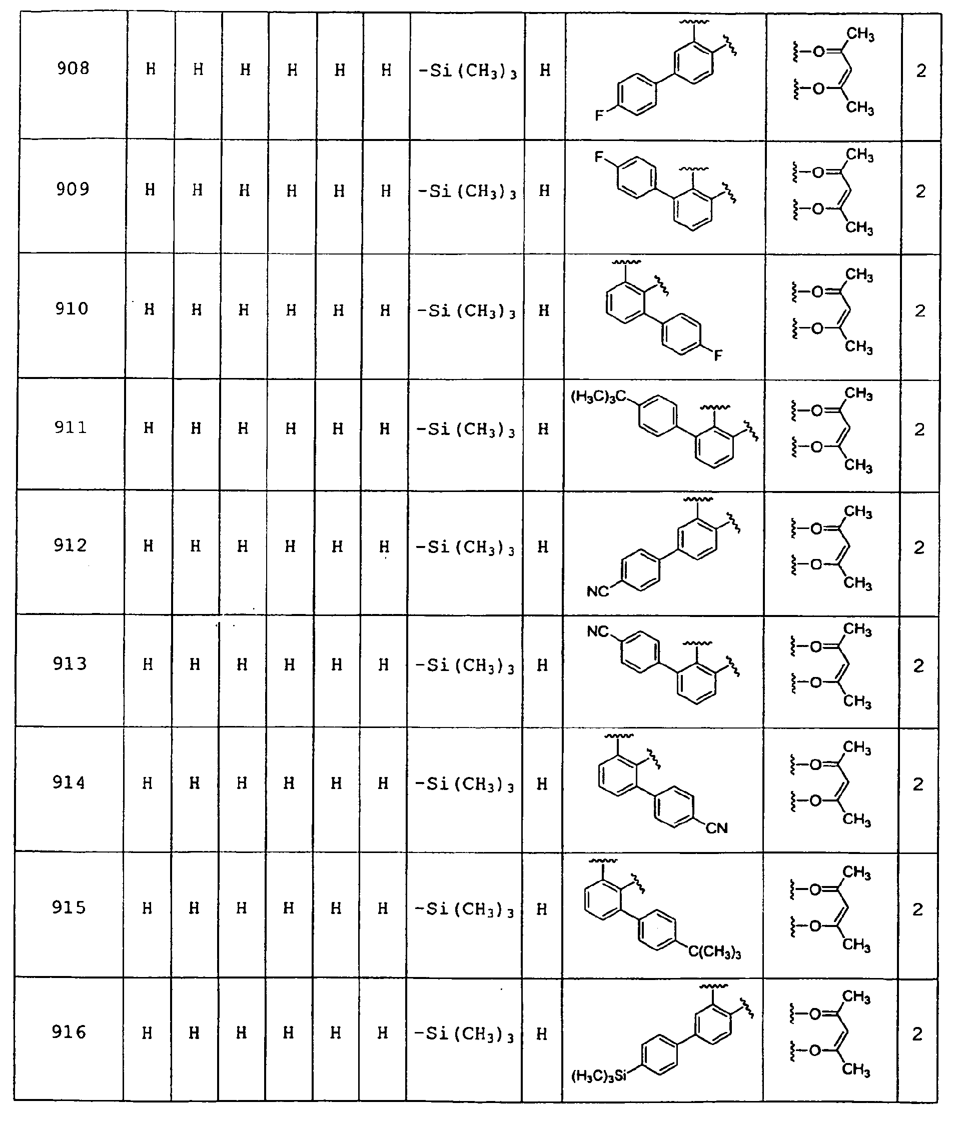

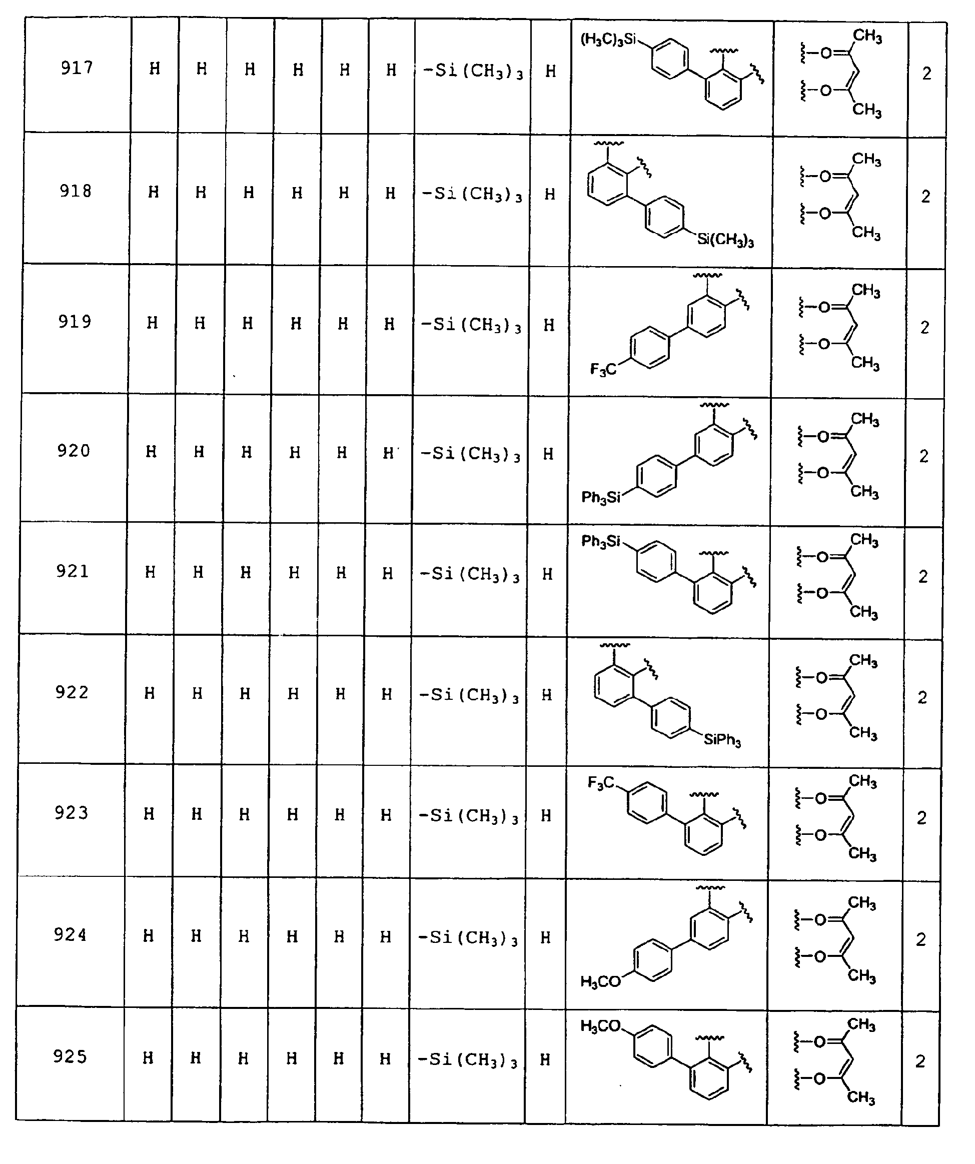

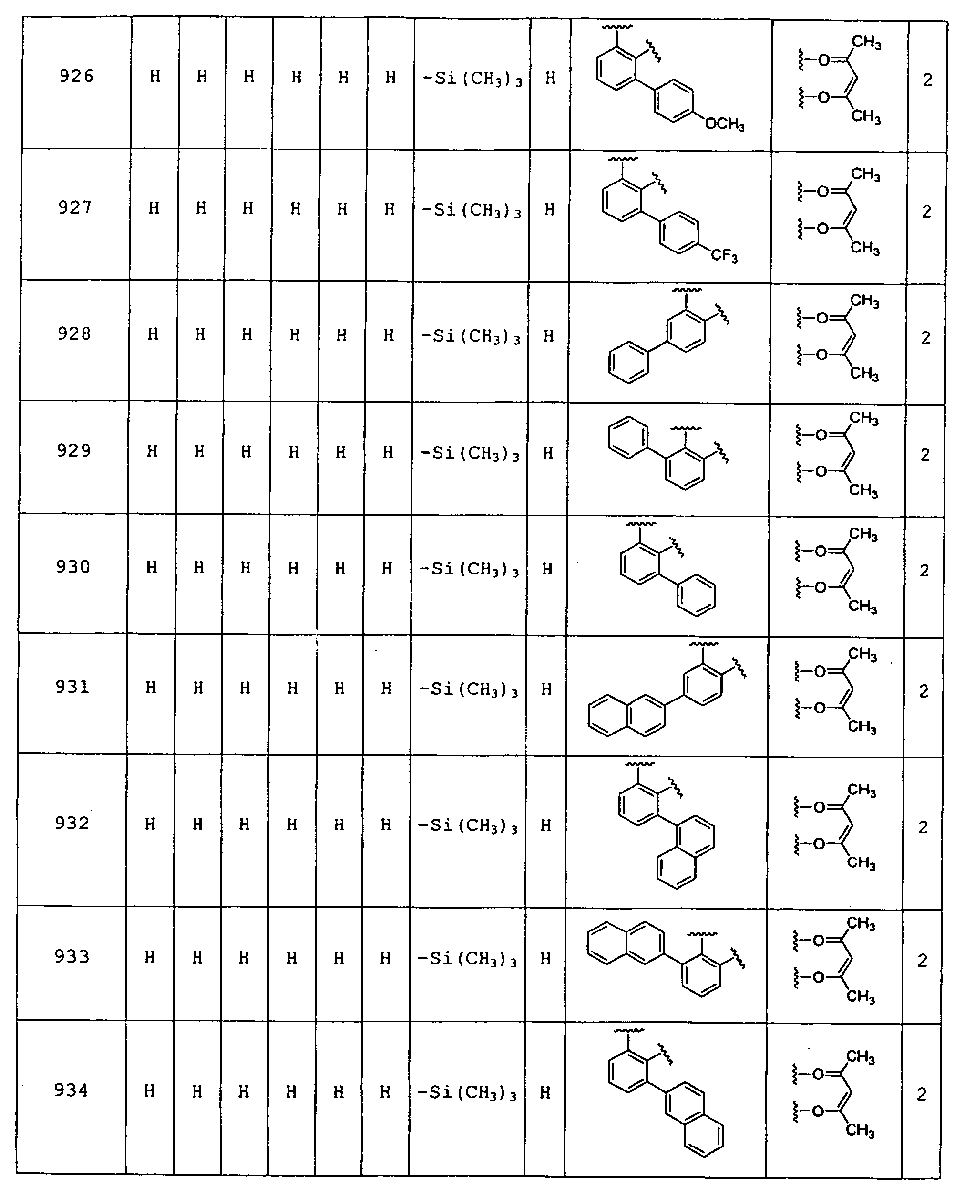

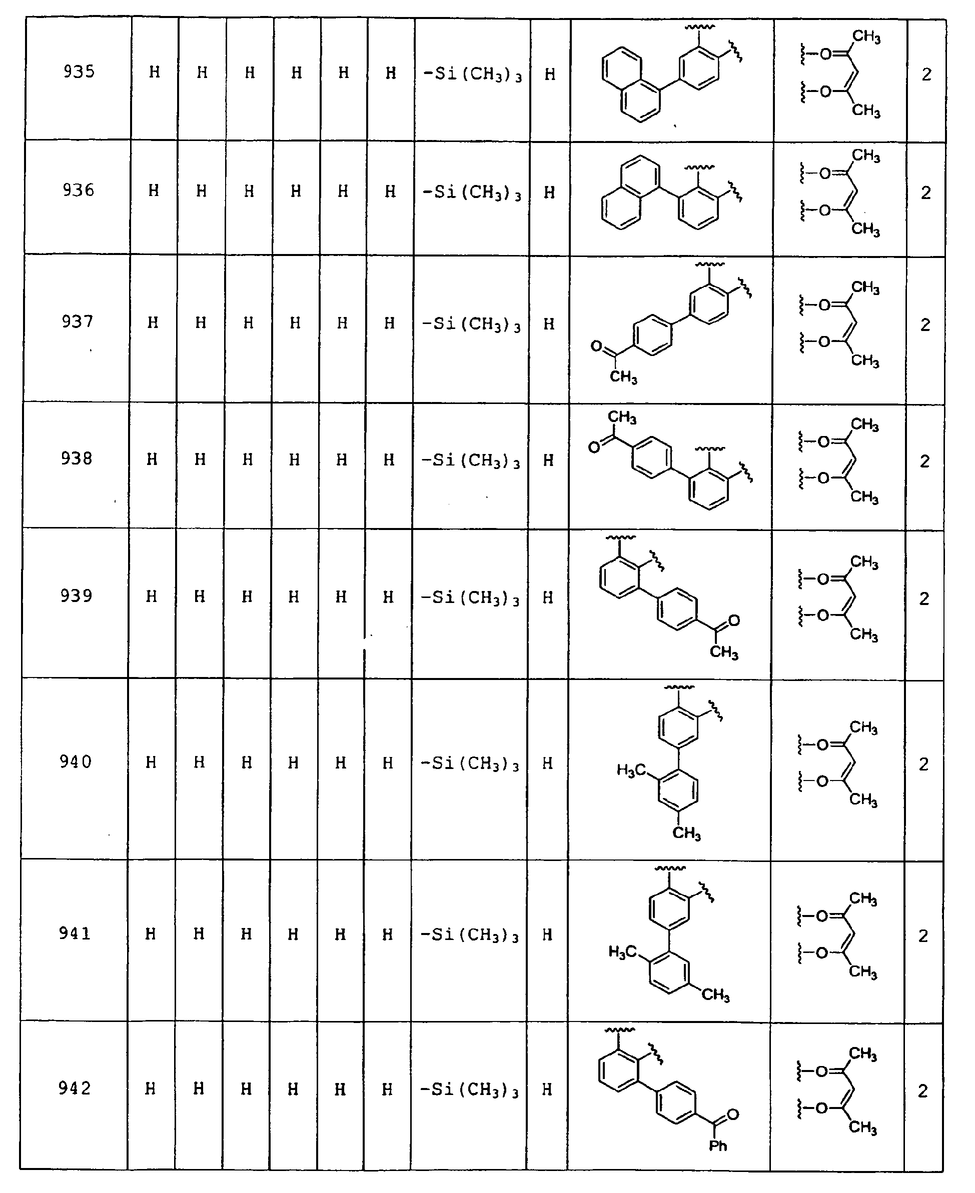

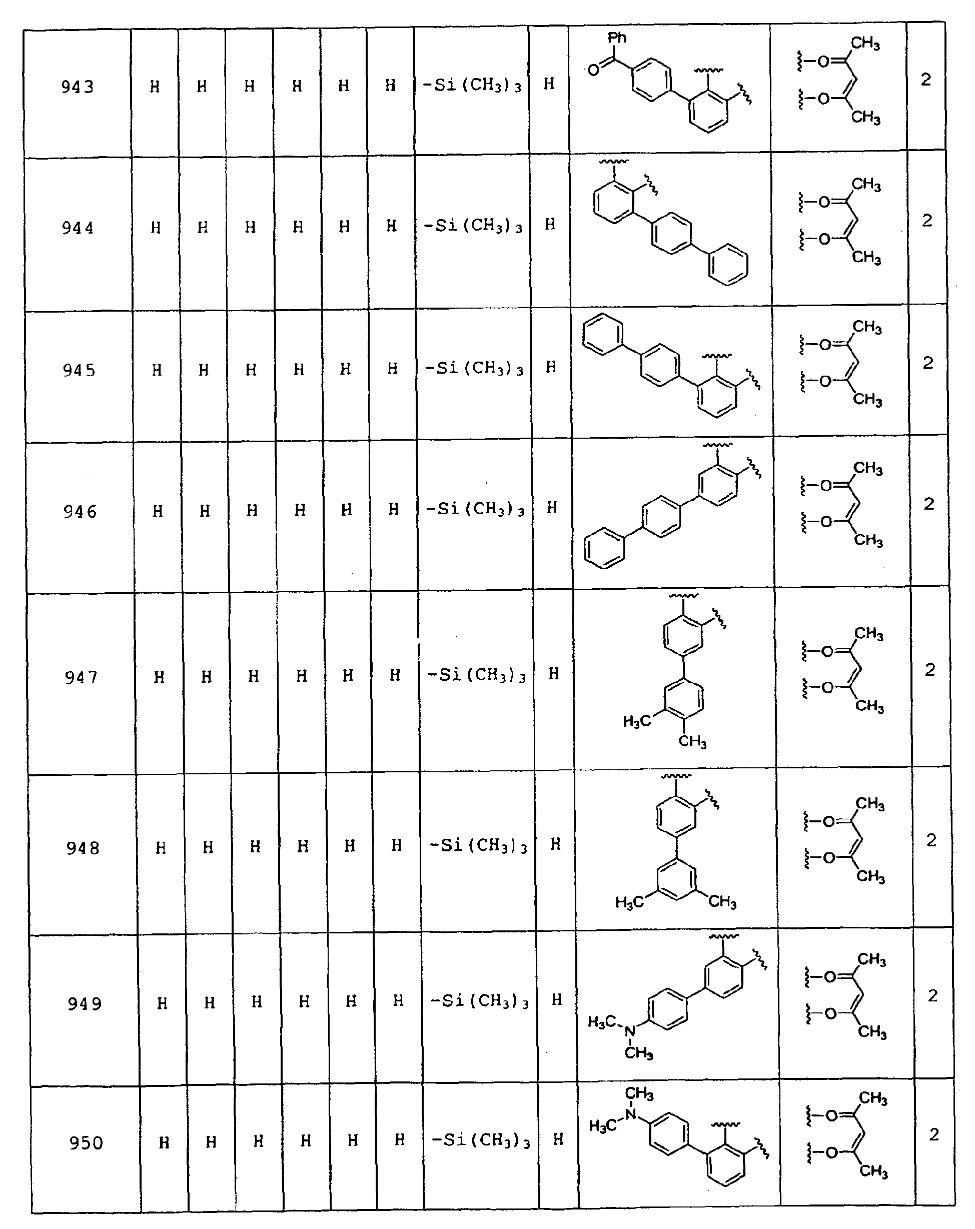

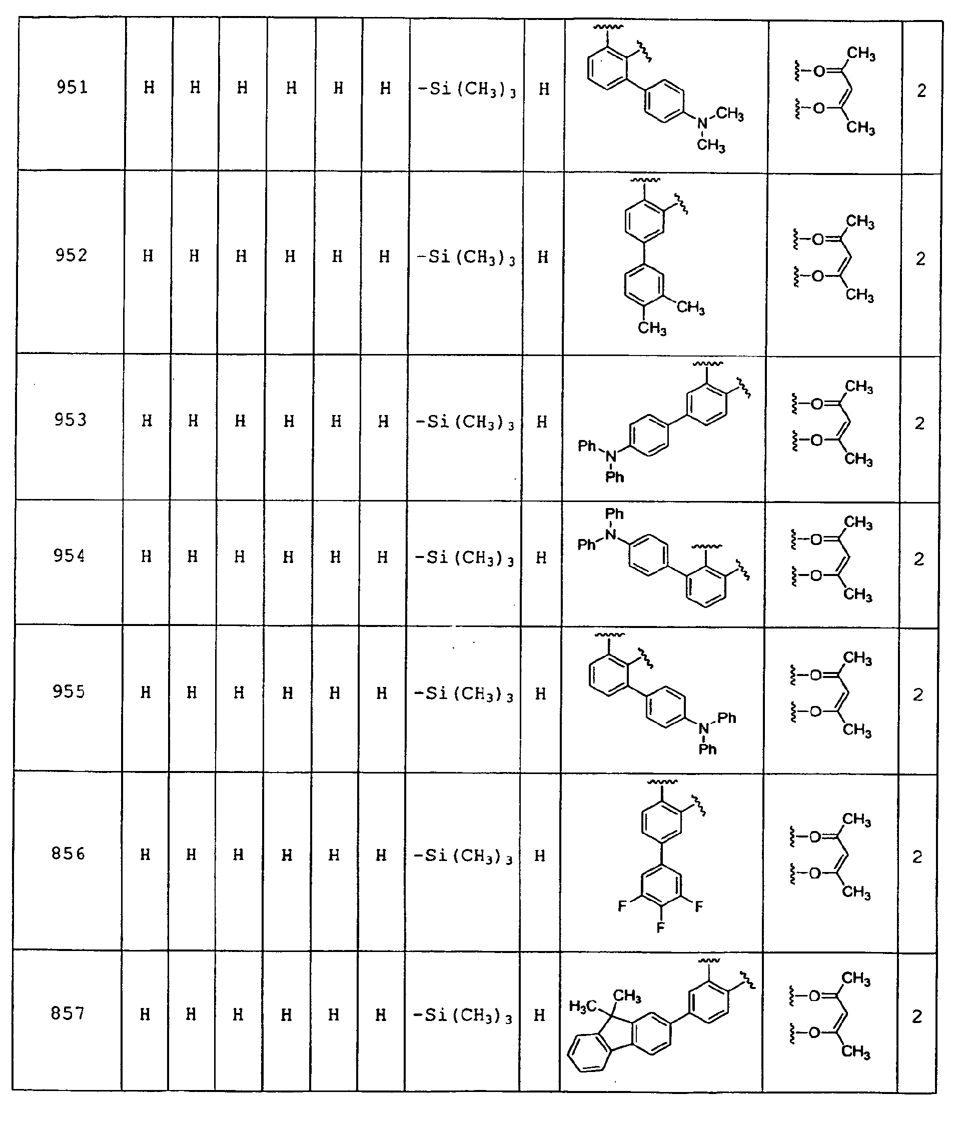

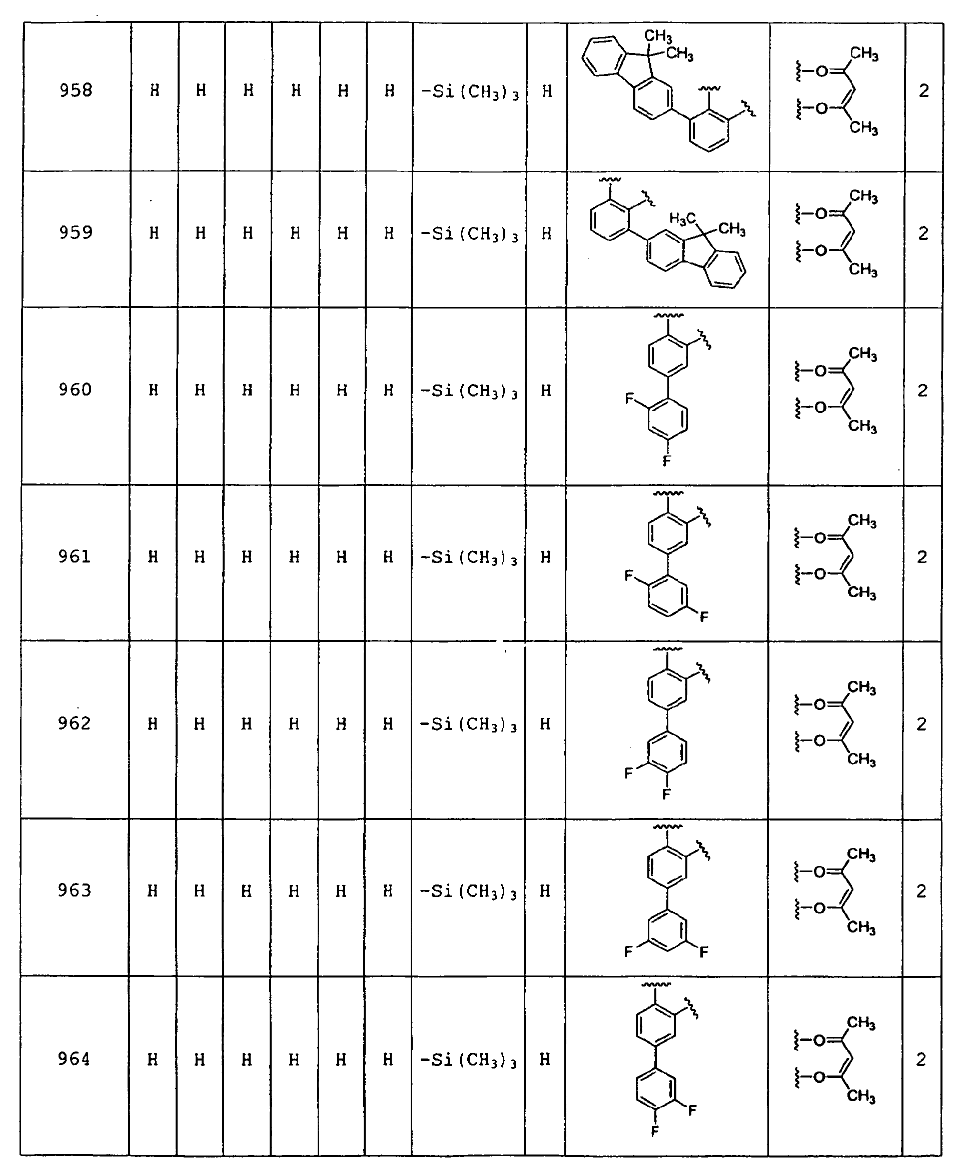

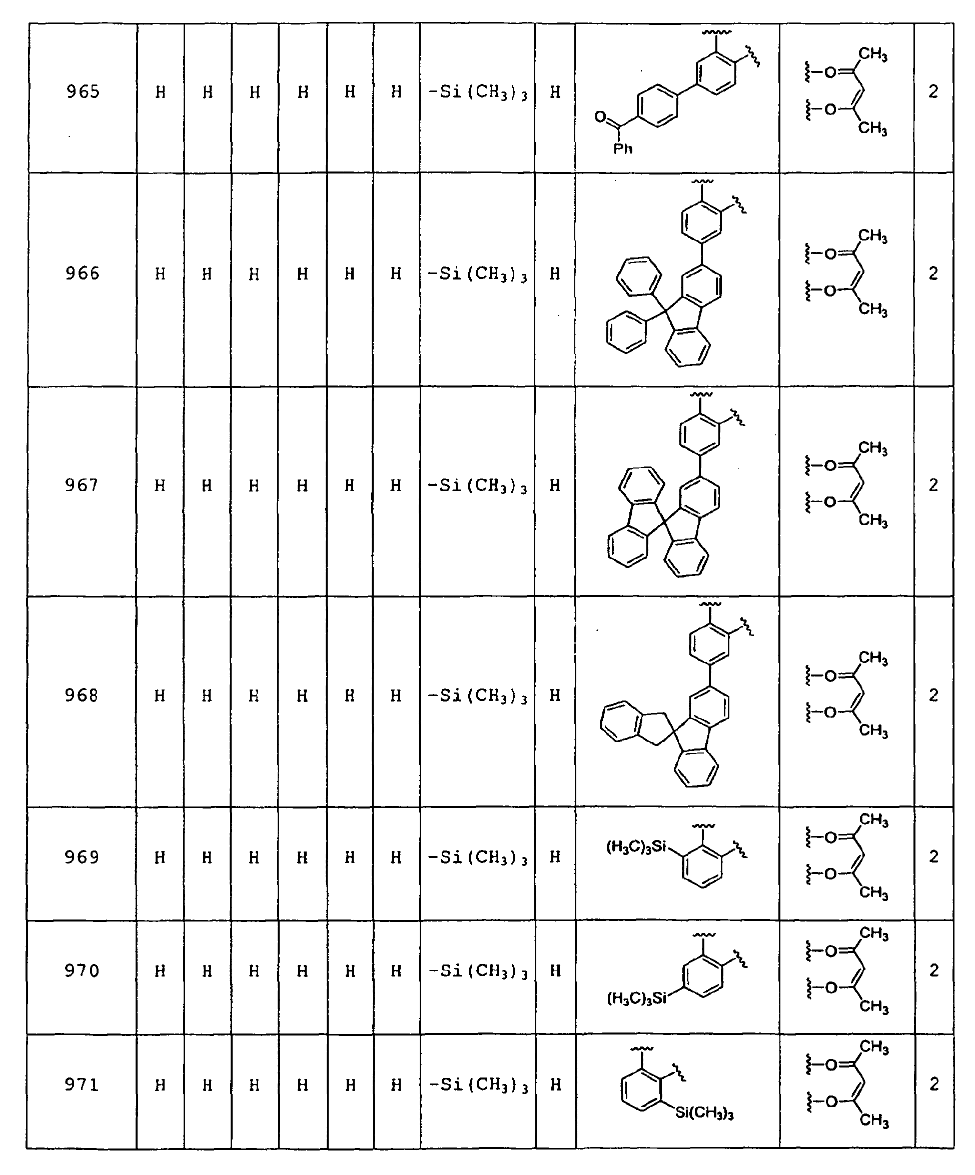

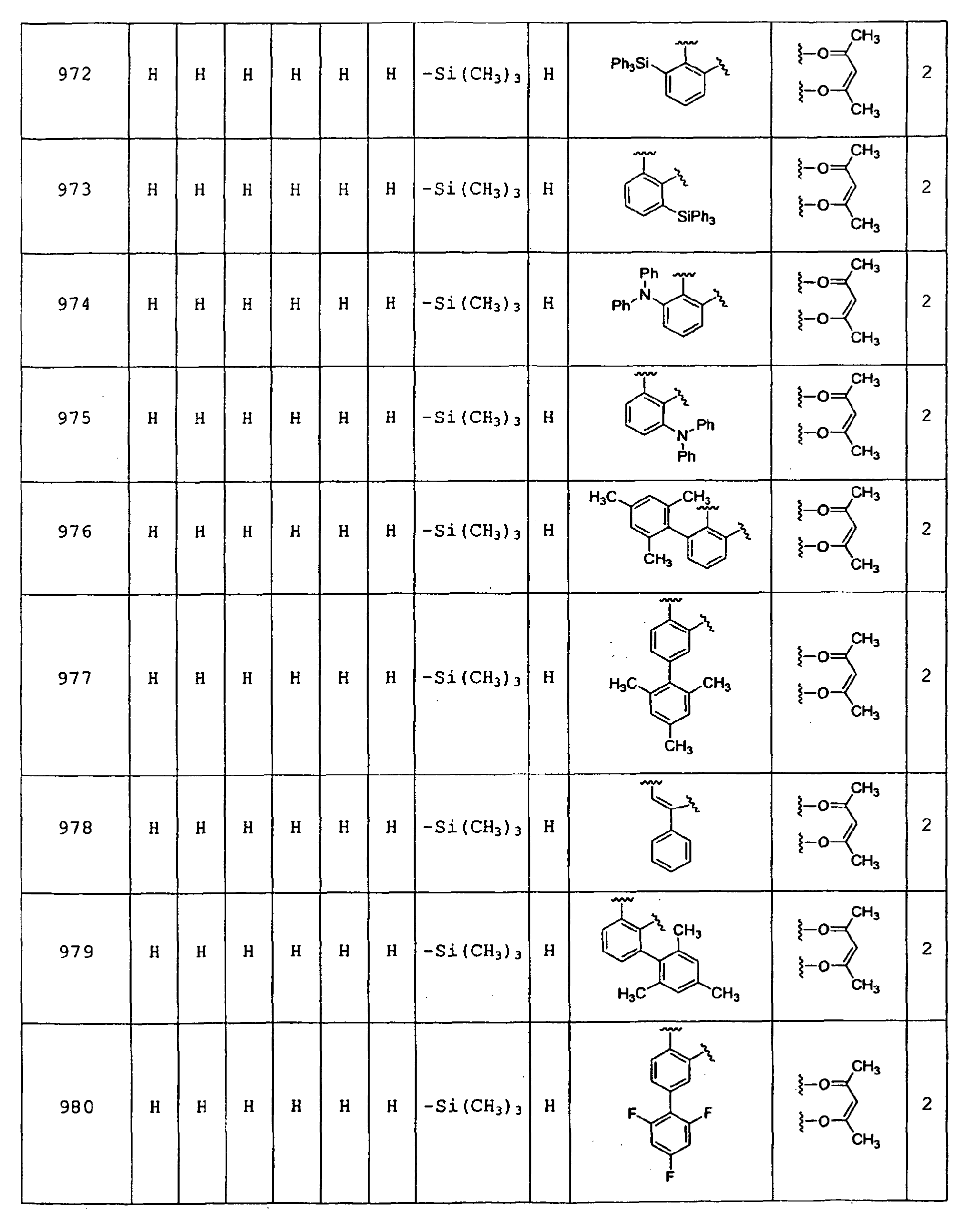

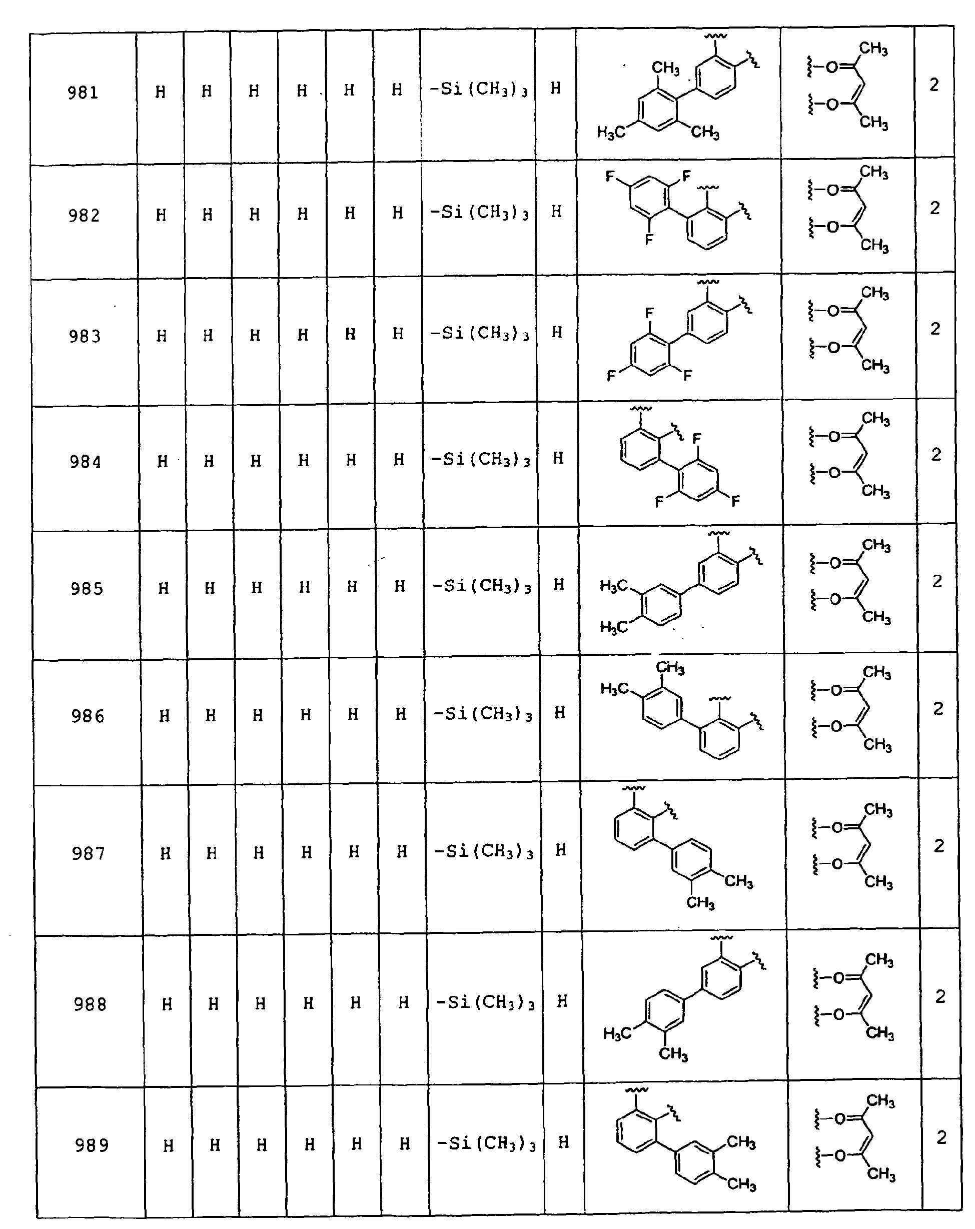

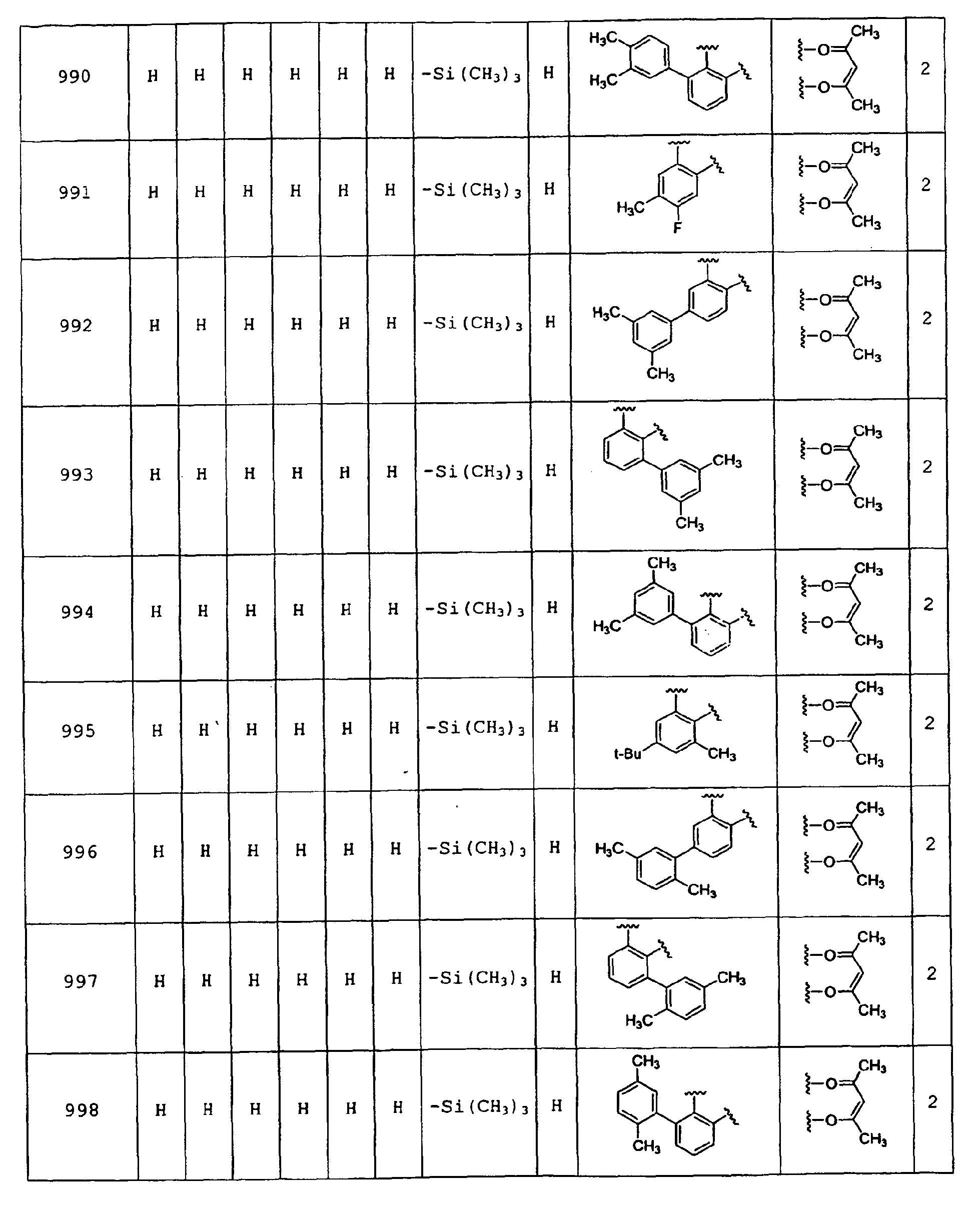

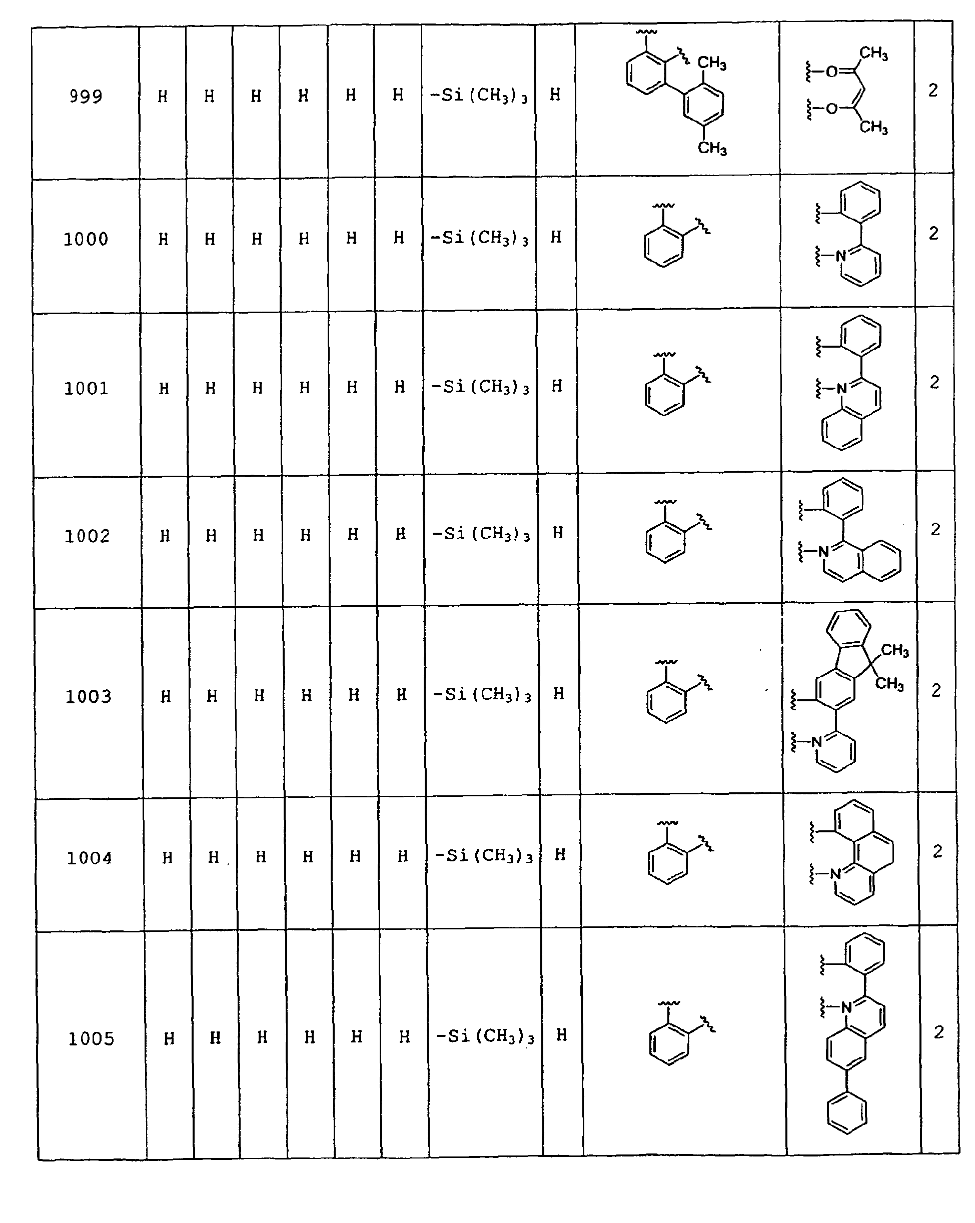

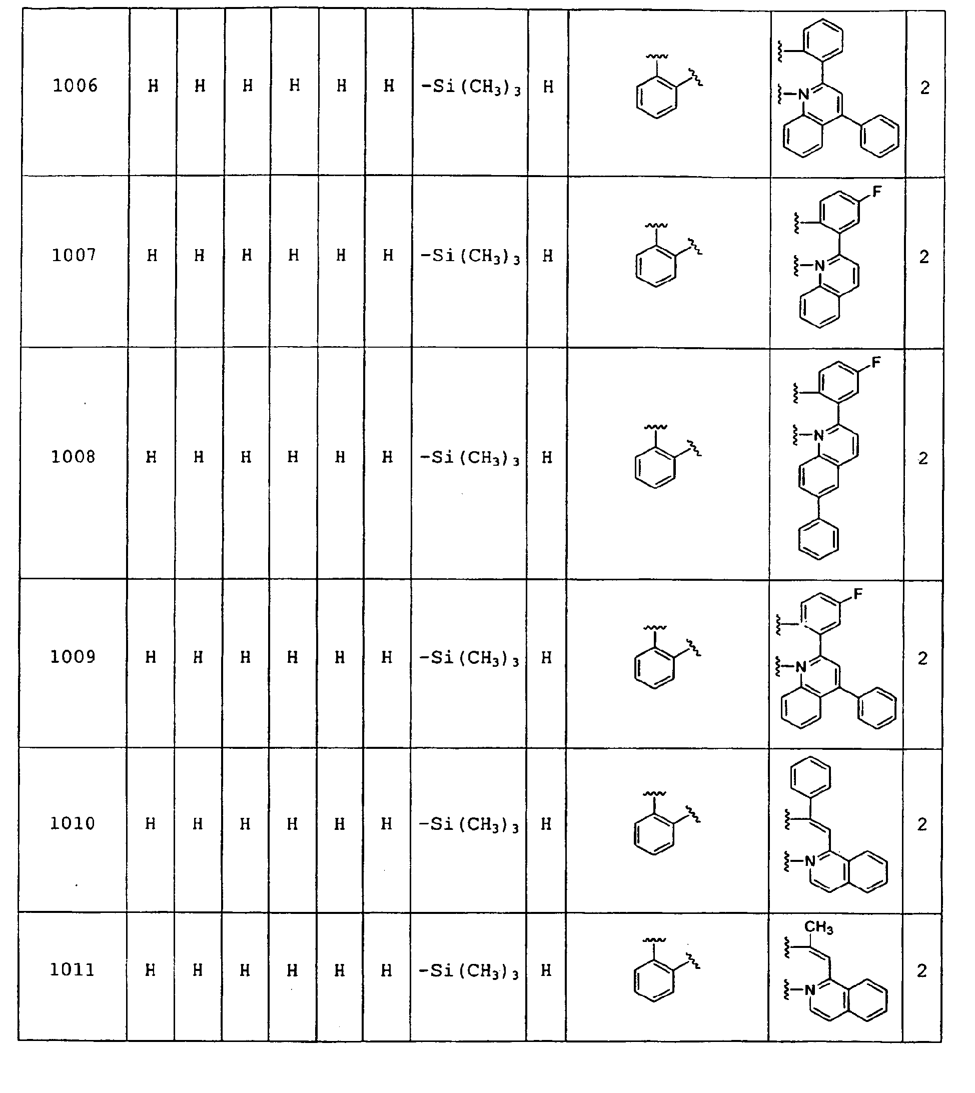

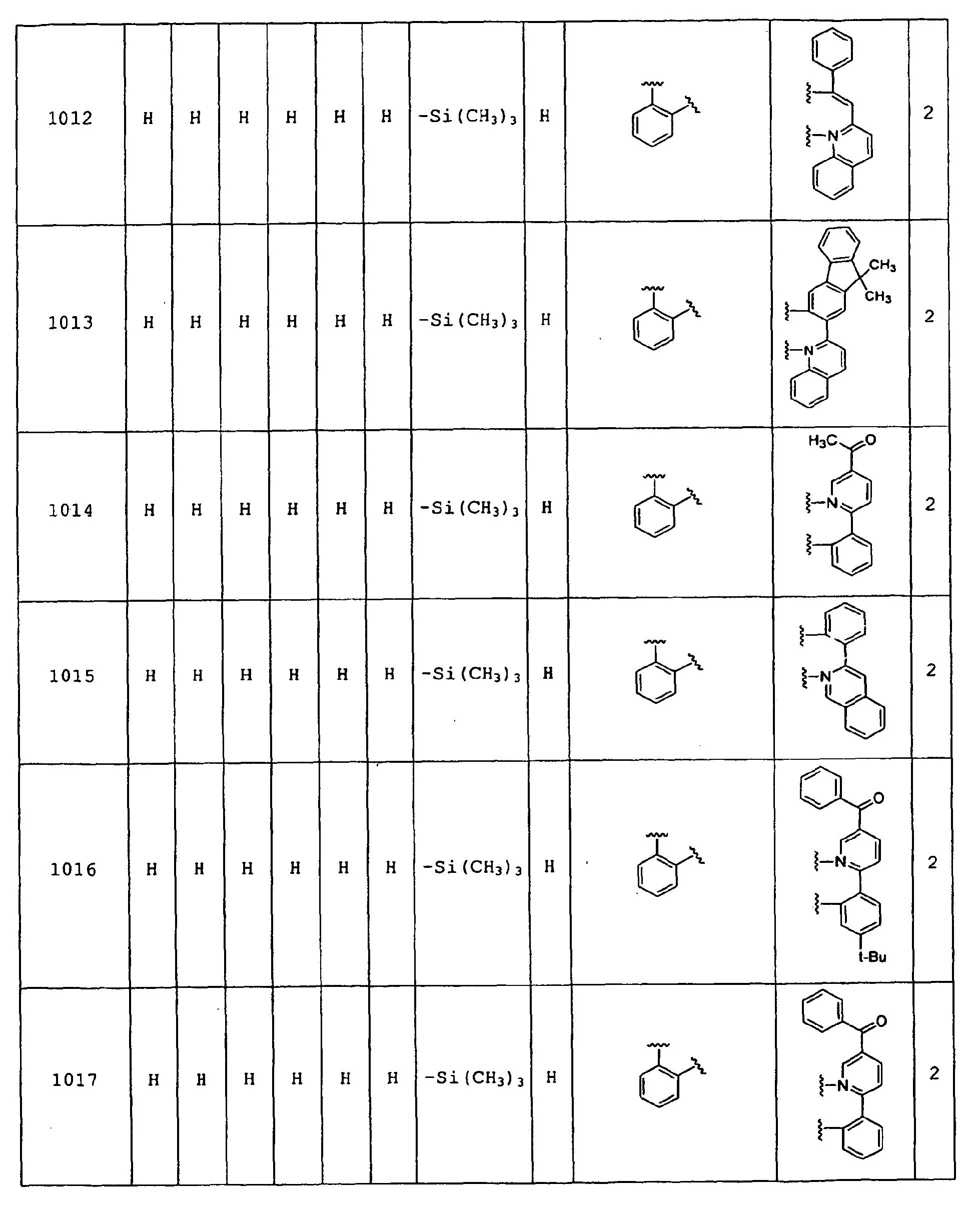

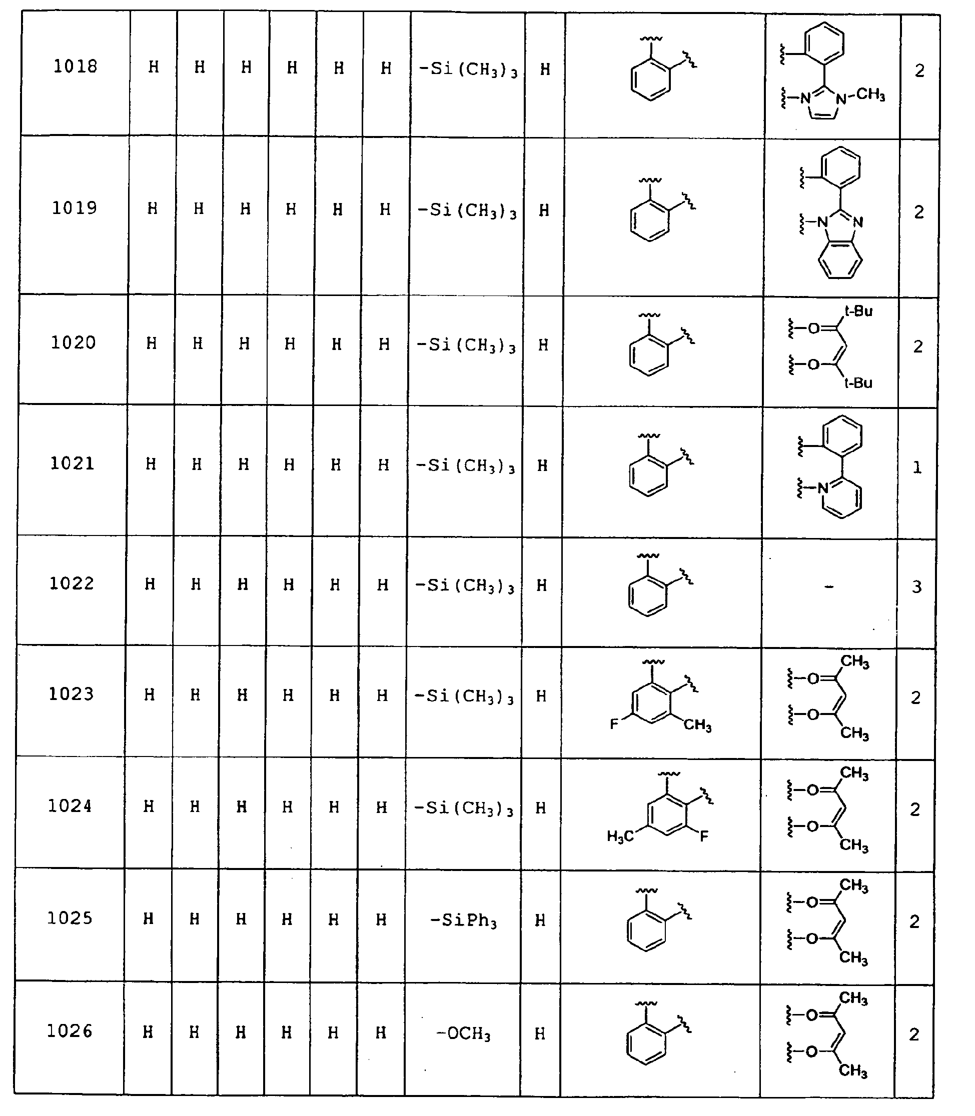

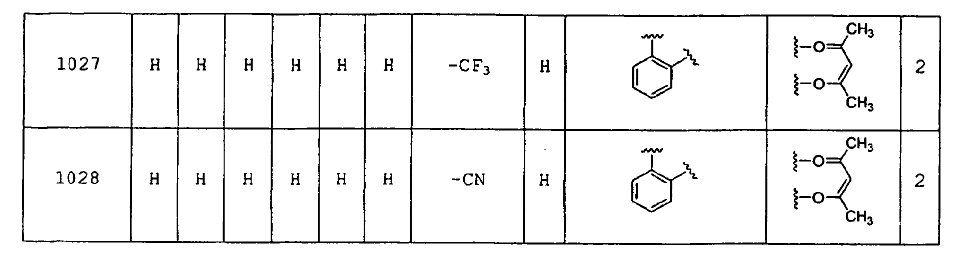

**Table 3**

| | | | | | | | | | | | |
|---|---|---|---|---|---|---|---|---|---|---|---|
| 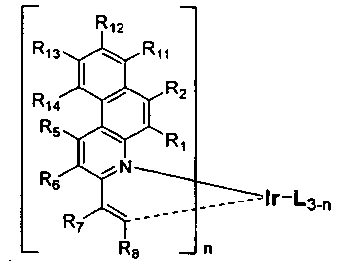 | | | | | | | | | | | |

| Compound No. | R₁ | R₂ | R₁₁ | R₁₂ | R₁₃ | R₁₄ | R₅ | R₆ | | L | n |
|---|---|---|---|---|---|---|---|---|---|---|---|
| 1029 | H | H | H | H | H | H | 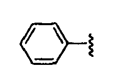 | H | 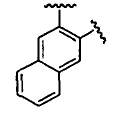 | 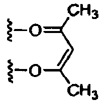 | 2 |
| 1030 | H | H | H | H | H | H | 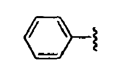 | H | 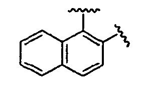 | 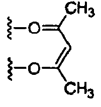 | 2 |
| 1031 | H | H | H | H | H | H | 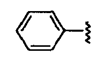 | H | 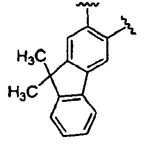 | 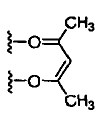 | 2 |
| 1032 | H | H | H | H | H | H | 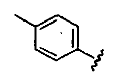 | H | 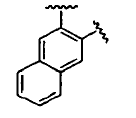 | 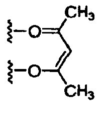 | 2 |
| 1033 | H | H | H | H | H | H | 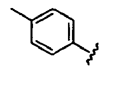 | H | 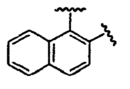 | 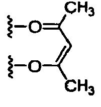 | 2 |
| 1034 | H | H | H | H | H | H | 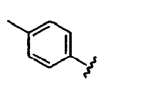 | H | 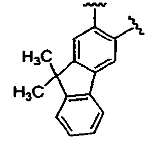 | 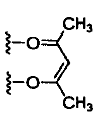 | 2 |
| 1035 | H | H | H | H | H | H | 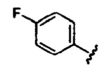 | H | 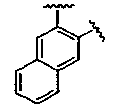 | 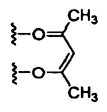 | 2 |
| 1036 | H | H | H | H | H | H | 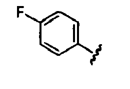 | H | 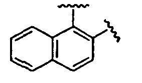 | 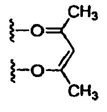 | 2 |
| 1037 | H | H | H | H | H | H | 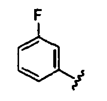 | H | 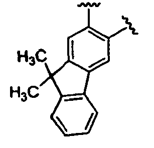 | 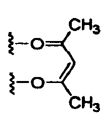 | 2 |
| 1038 | H | H | H | H | H | H | 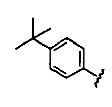 | H | 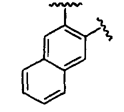 | 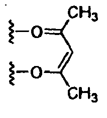 | 2 |
| 1039 | H | H | H | H | H | H | 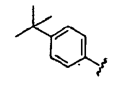 | H | 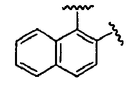 | 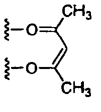 | 2 |
| 1040 | H | H | H | H | H | H | 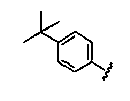 | H | 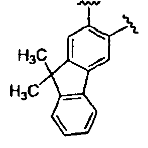 | 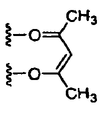 | 2 |
| 1041 | H | H | H | H | H | H | 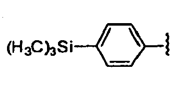 | H | 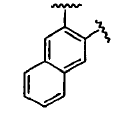 | 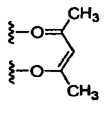 | 2 |
| 1042 | H | H | H | H | H | H | 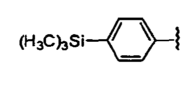 | H | 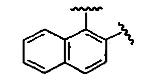 | 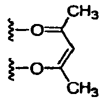 | 2 |
| 1043 | H | H | H | H | H | H | 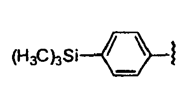 | H | 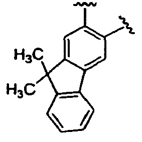 | 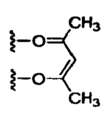 | 2 |

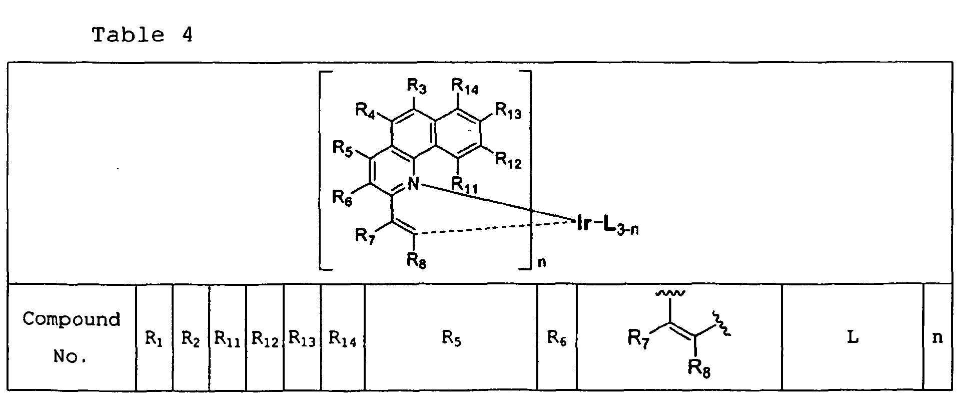

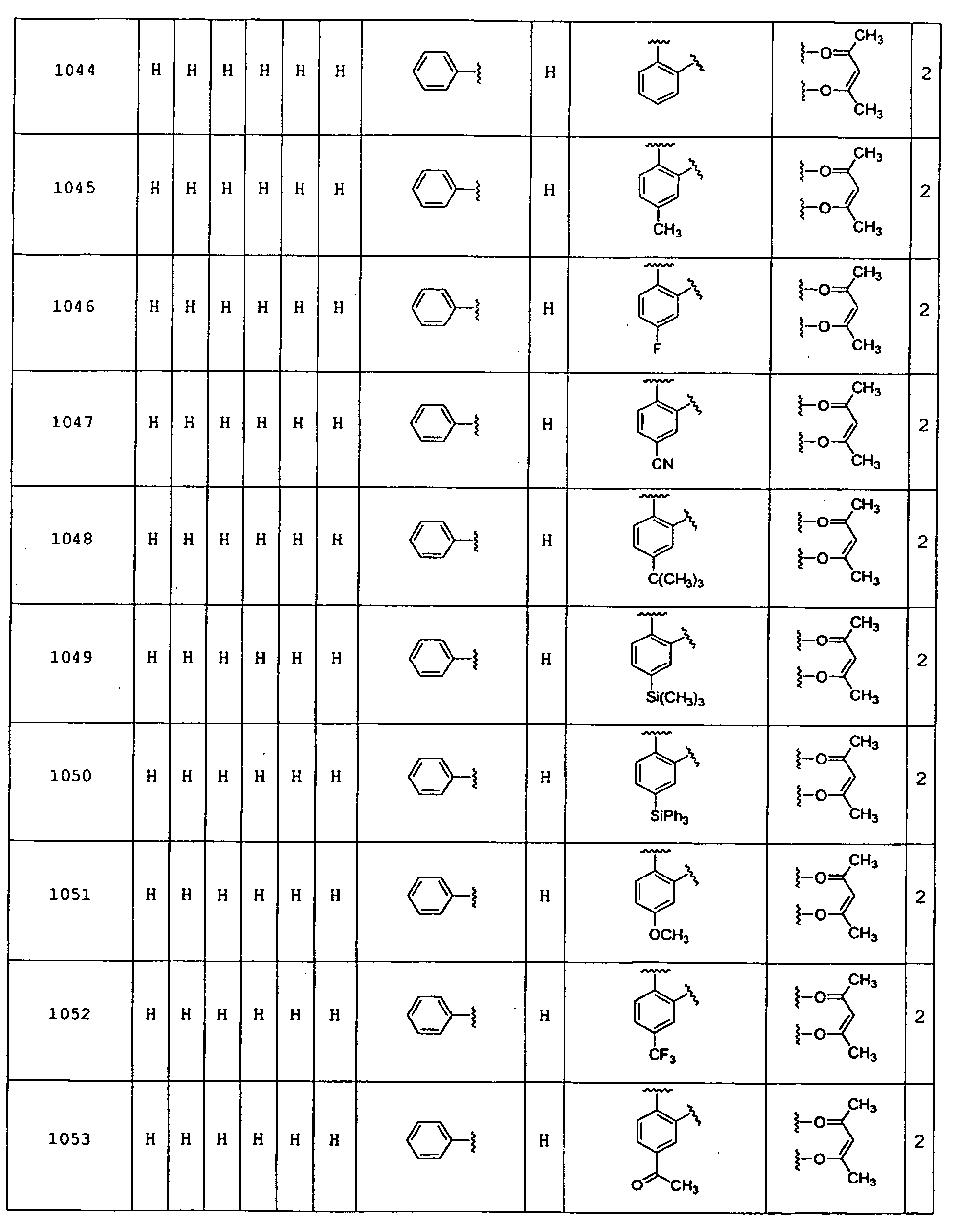

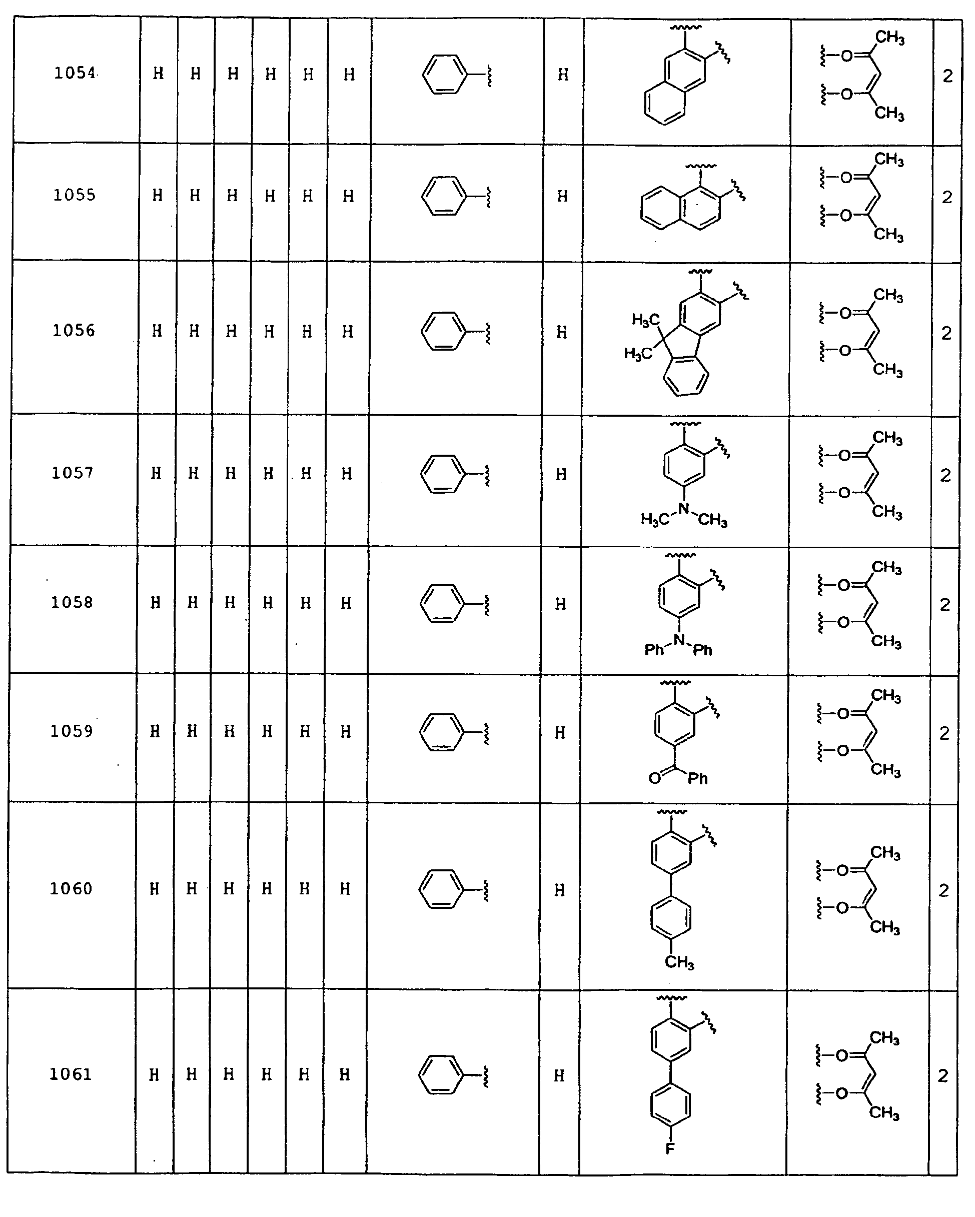

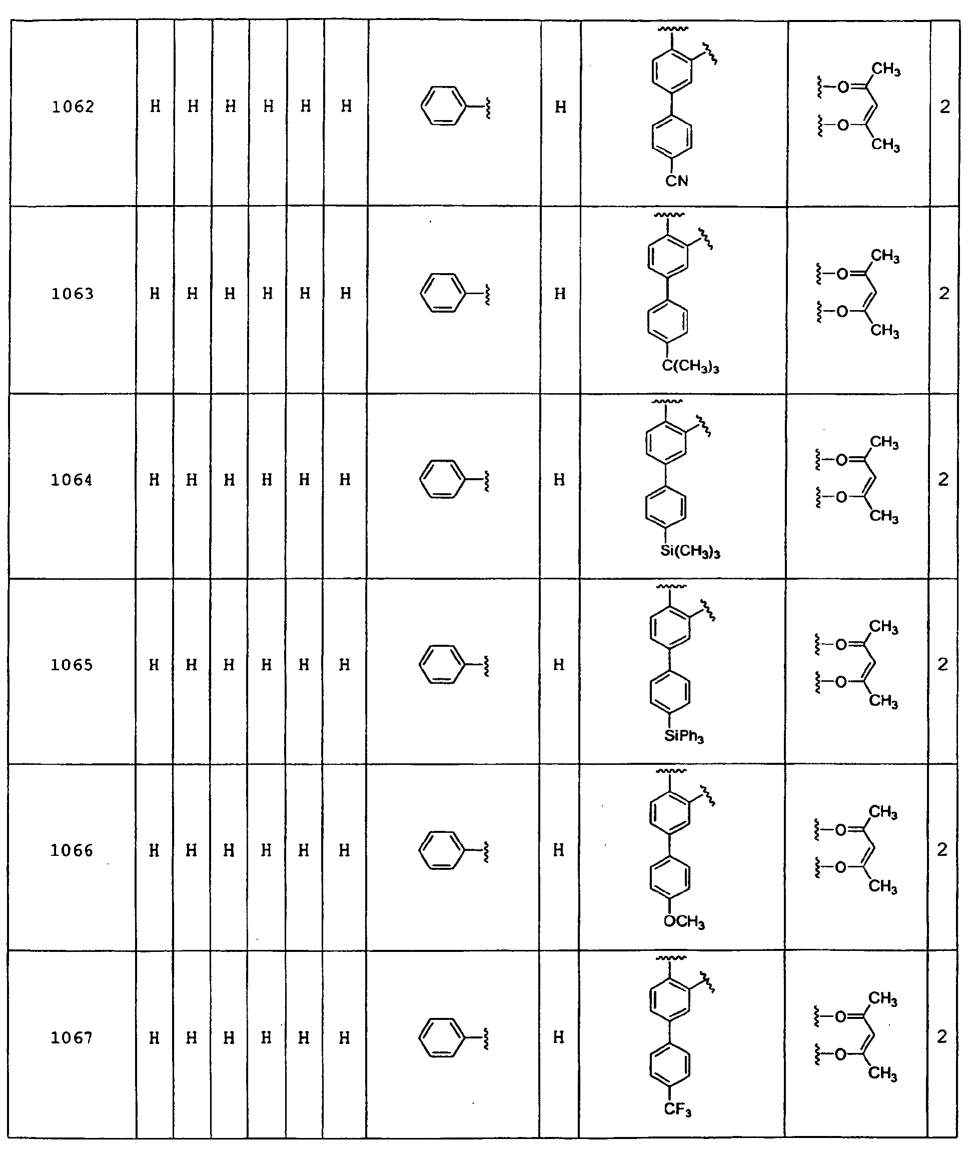

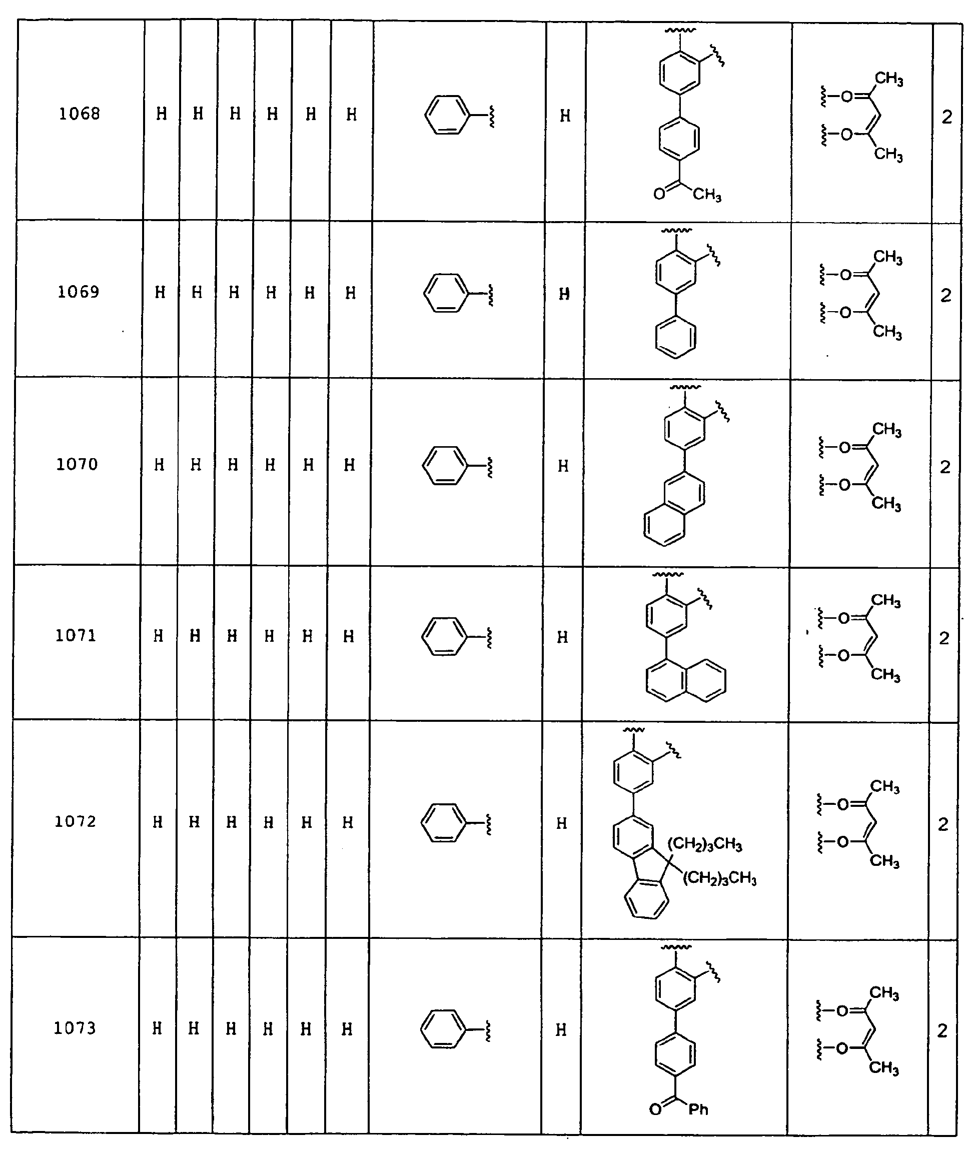

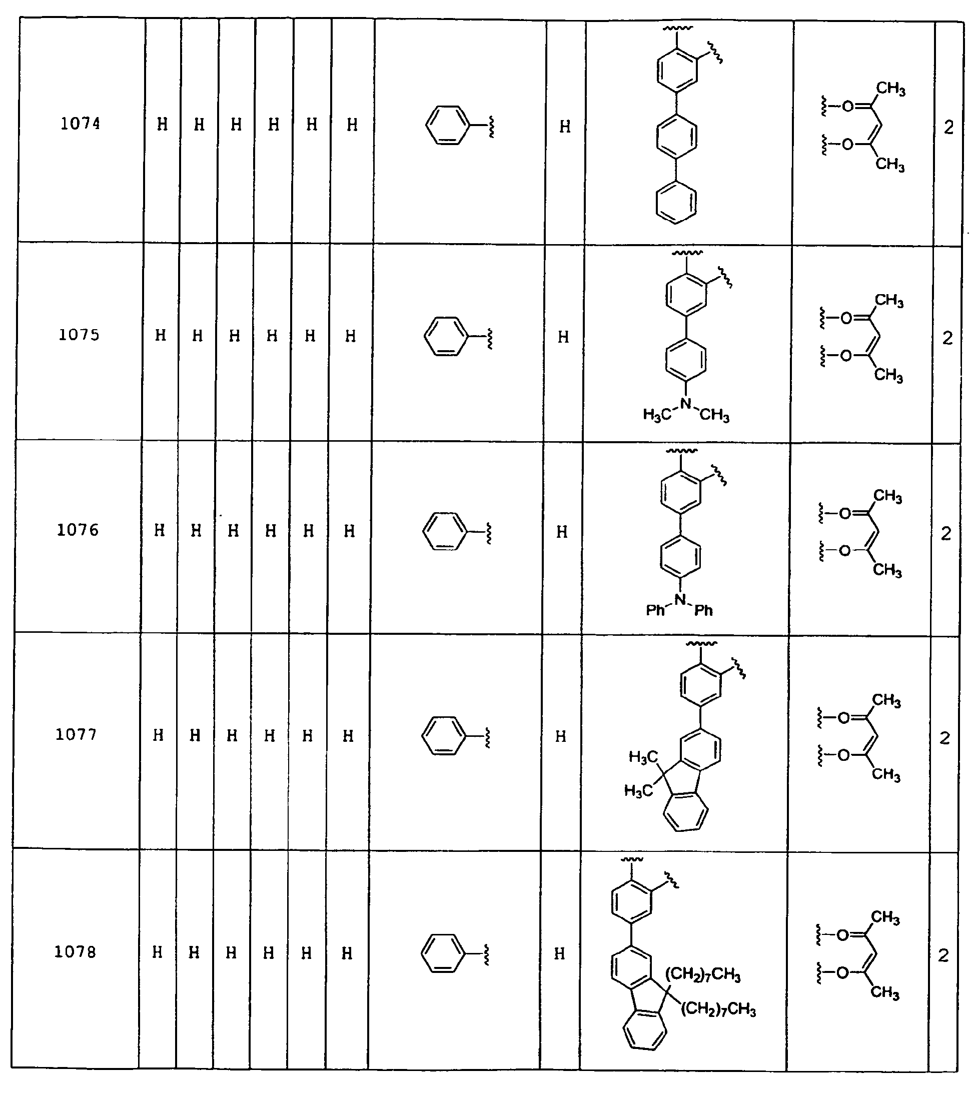

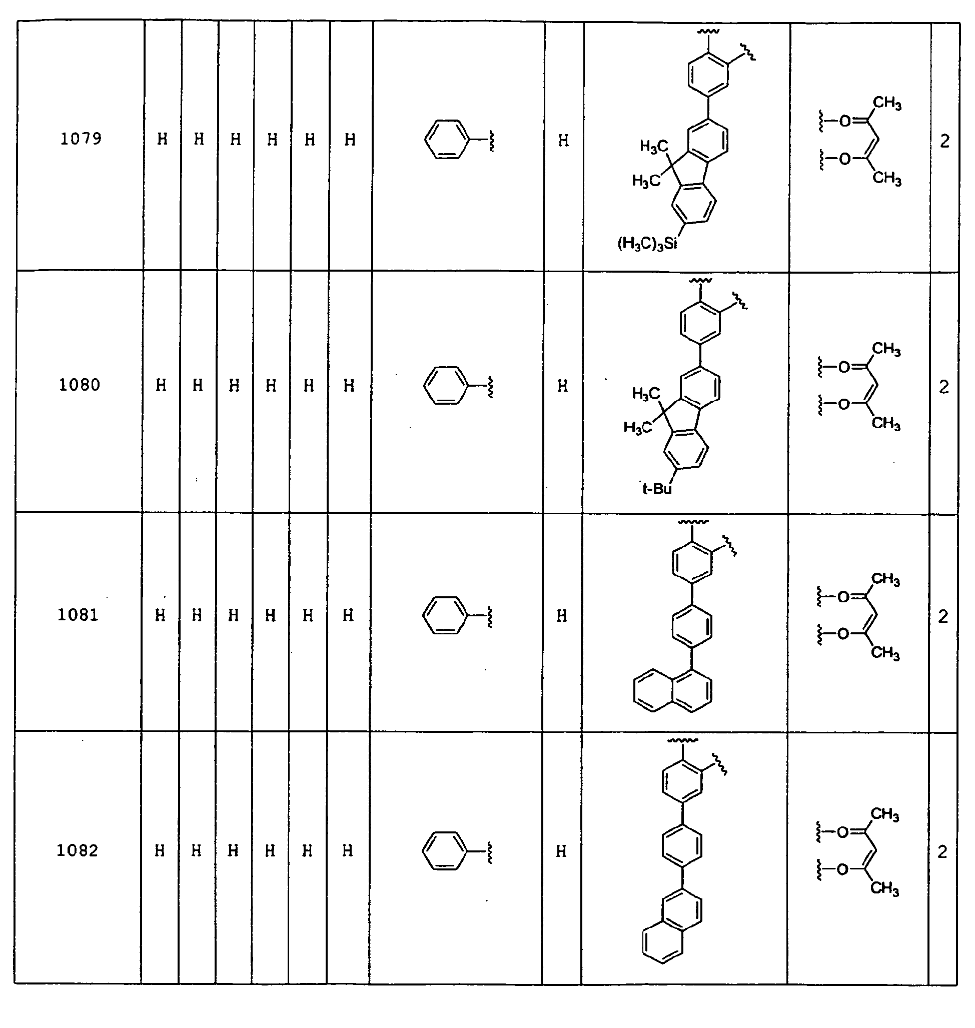

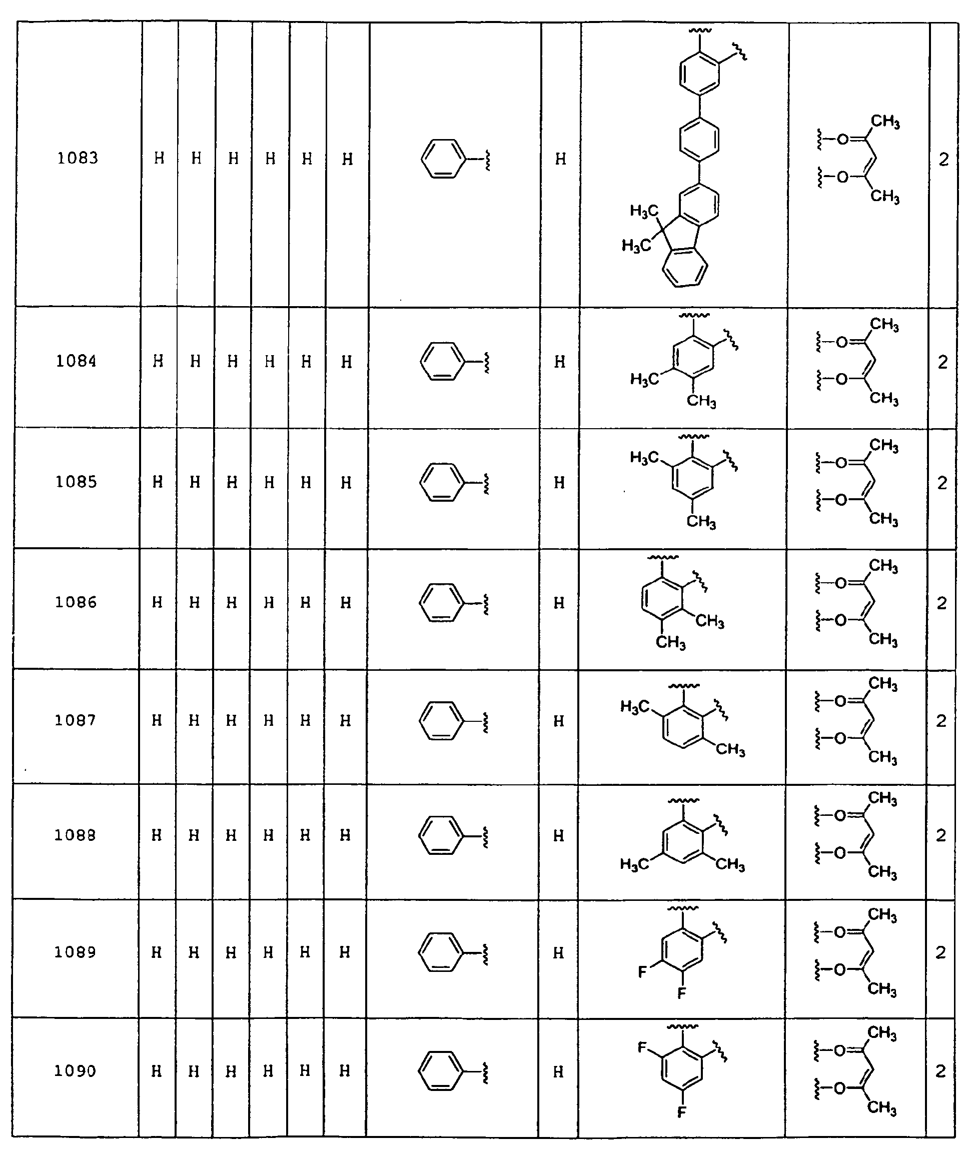

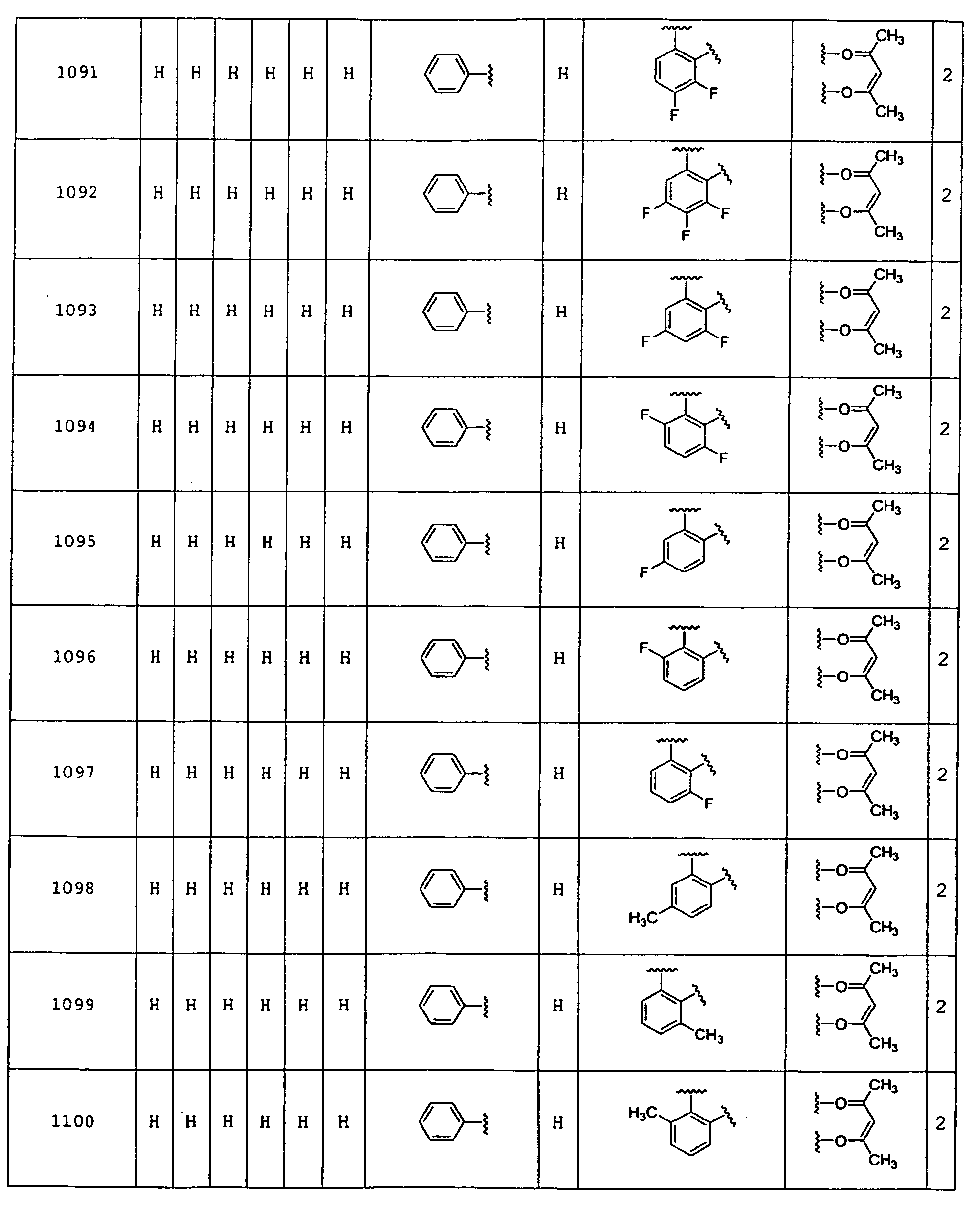

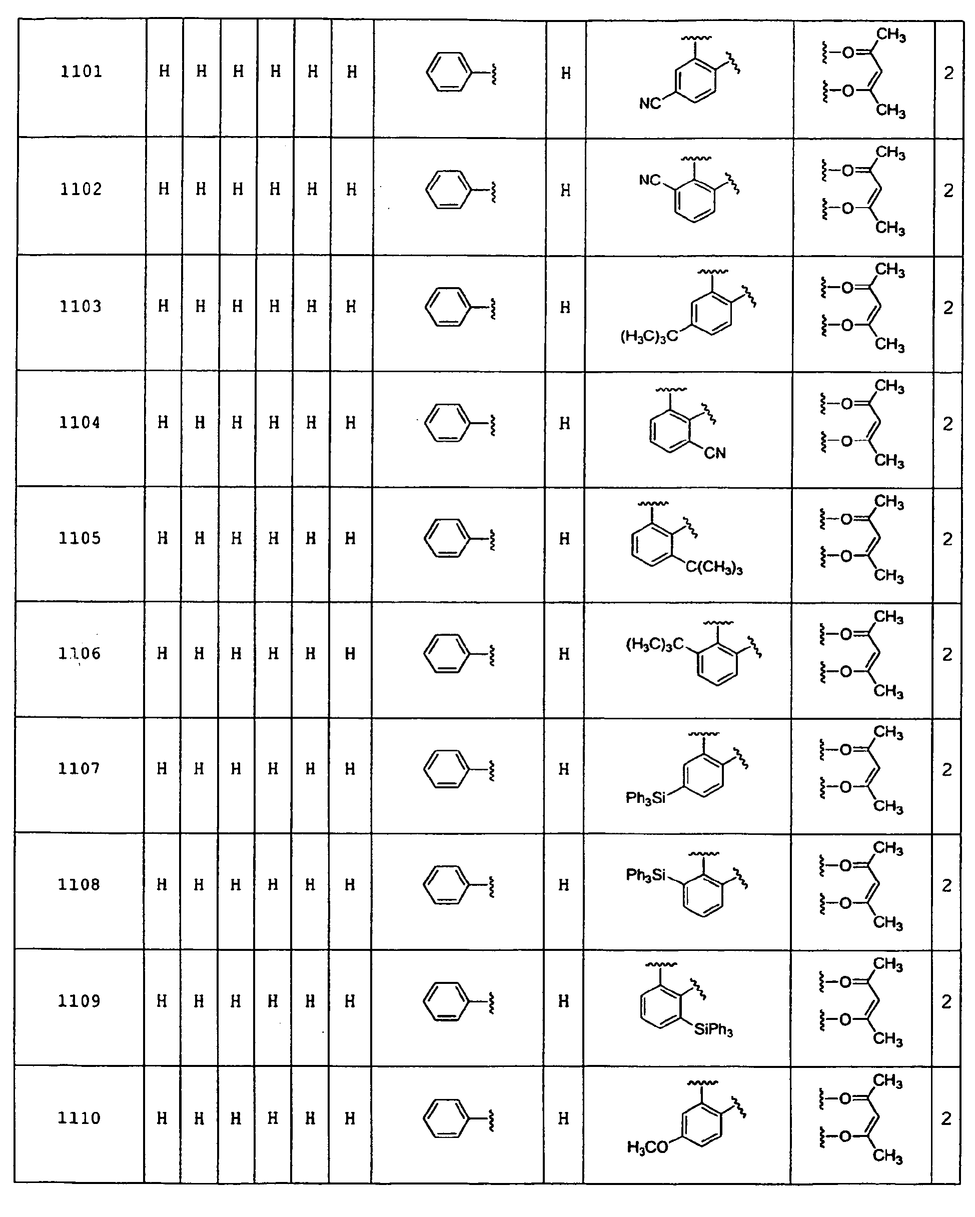

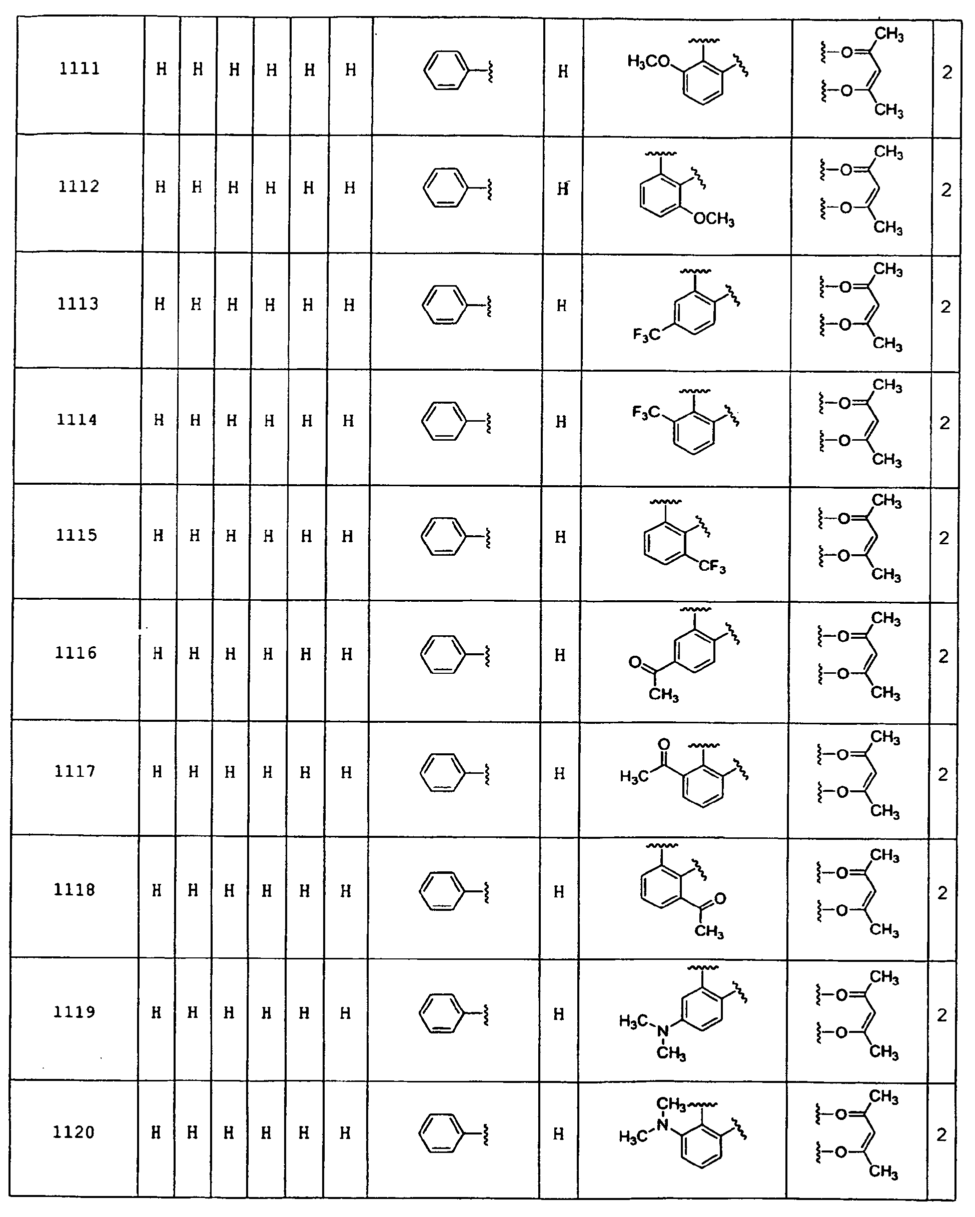

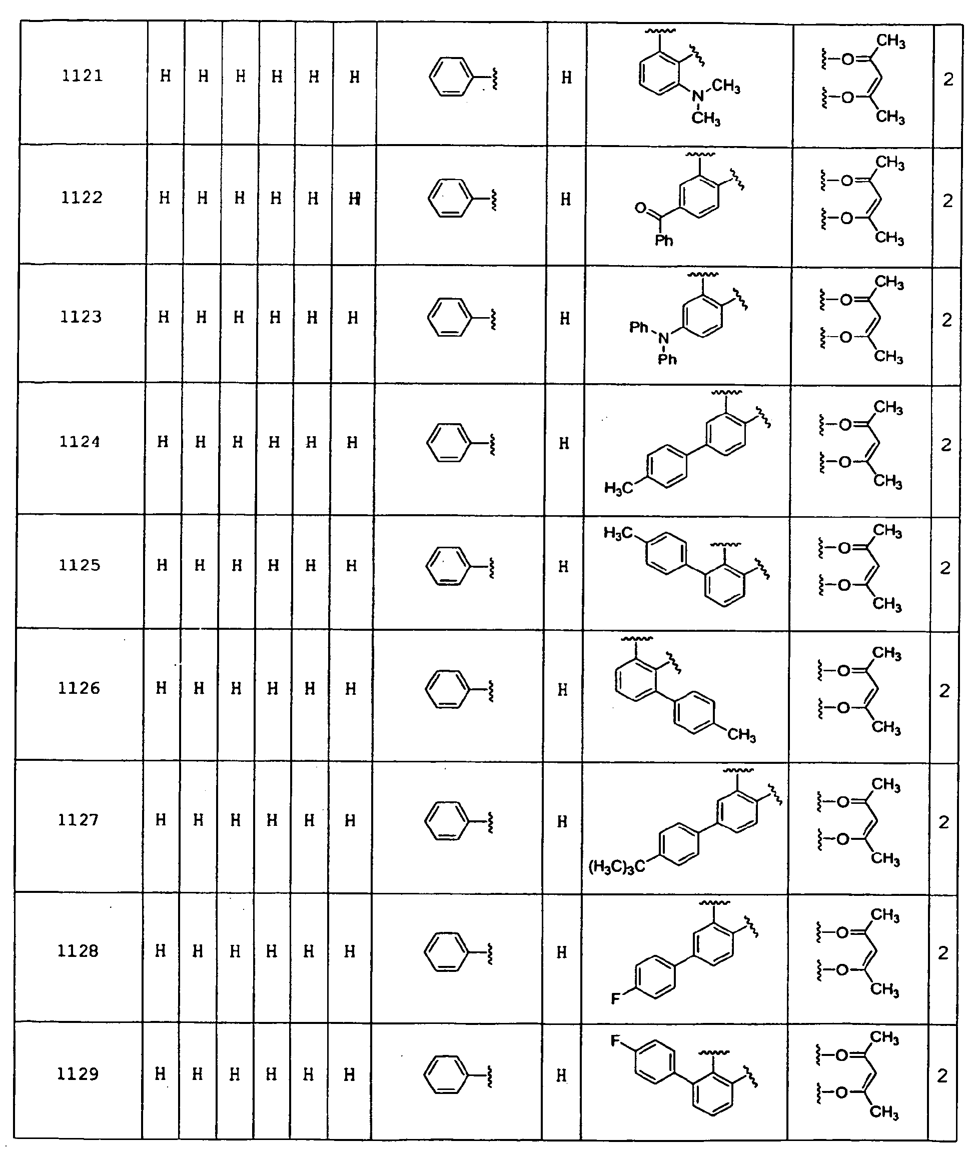

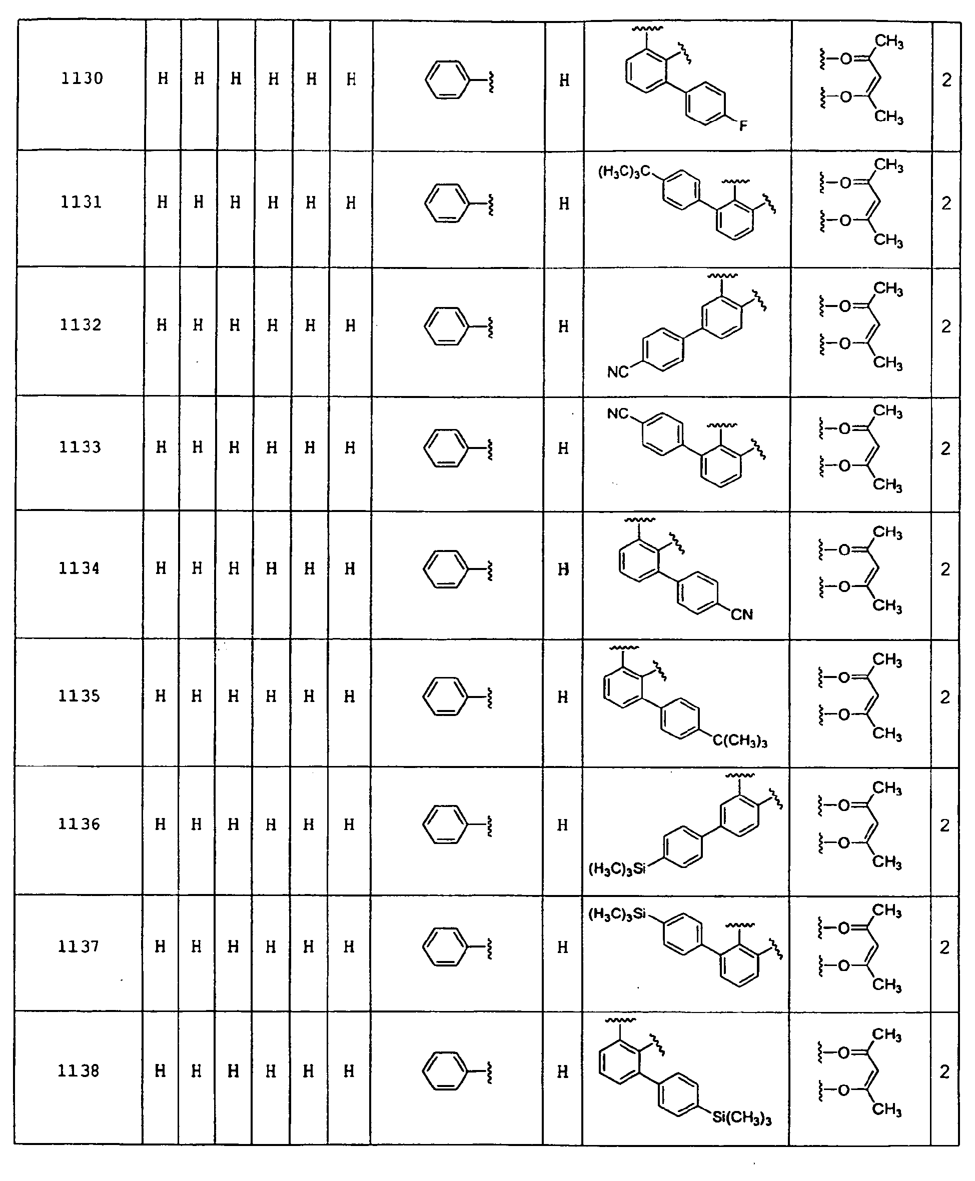

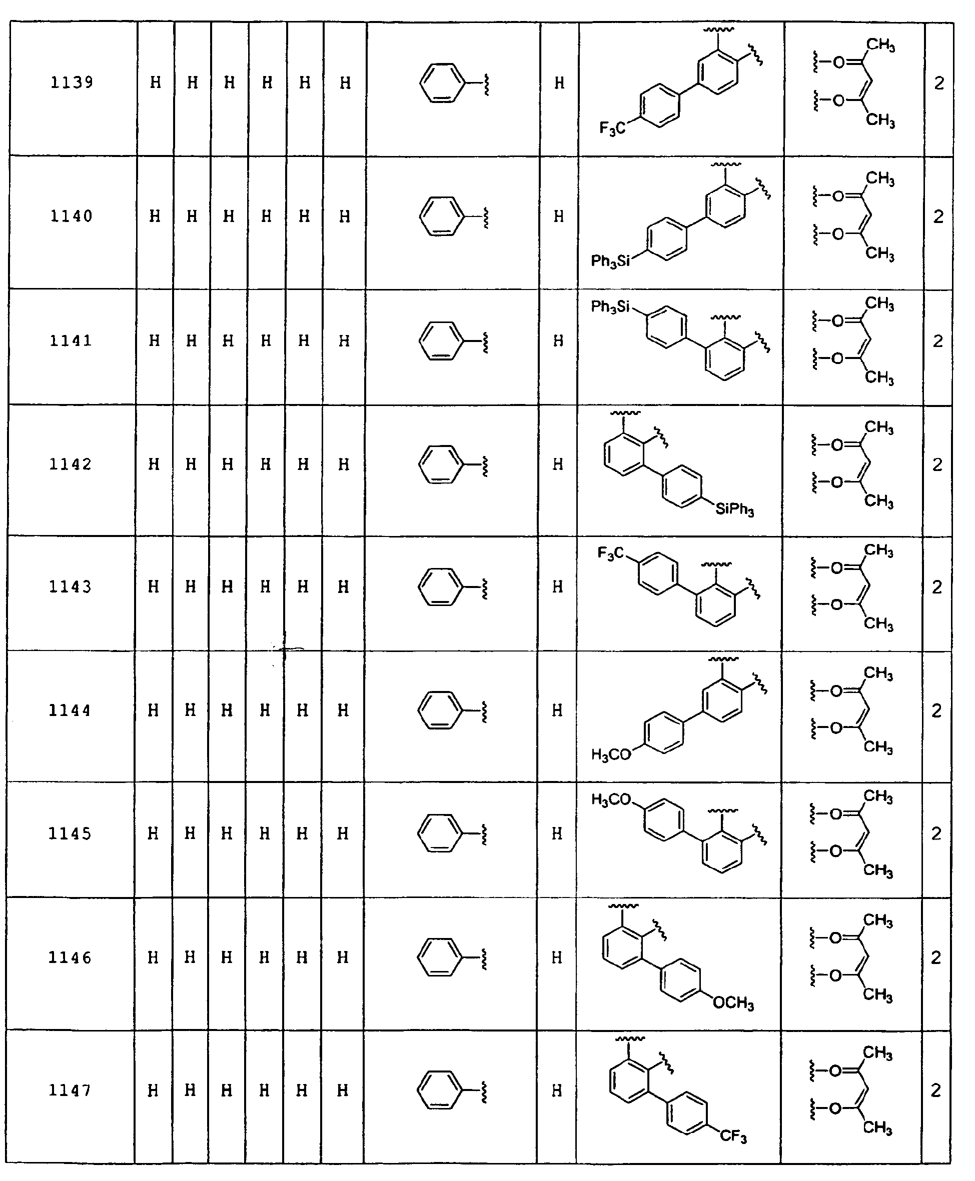

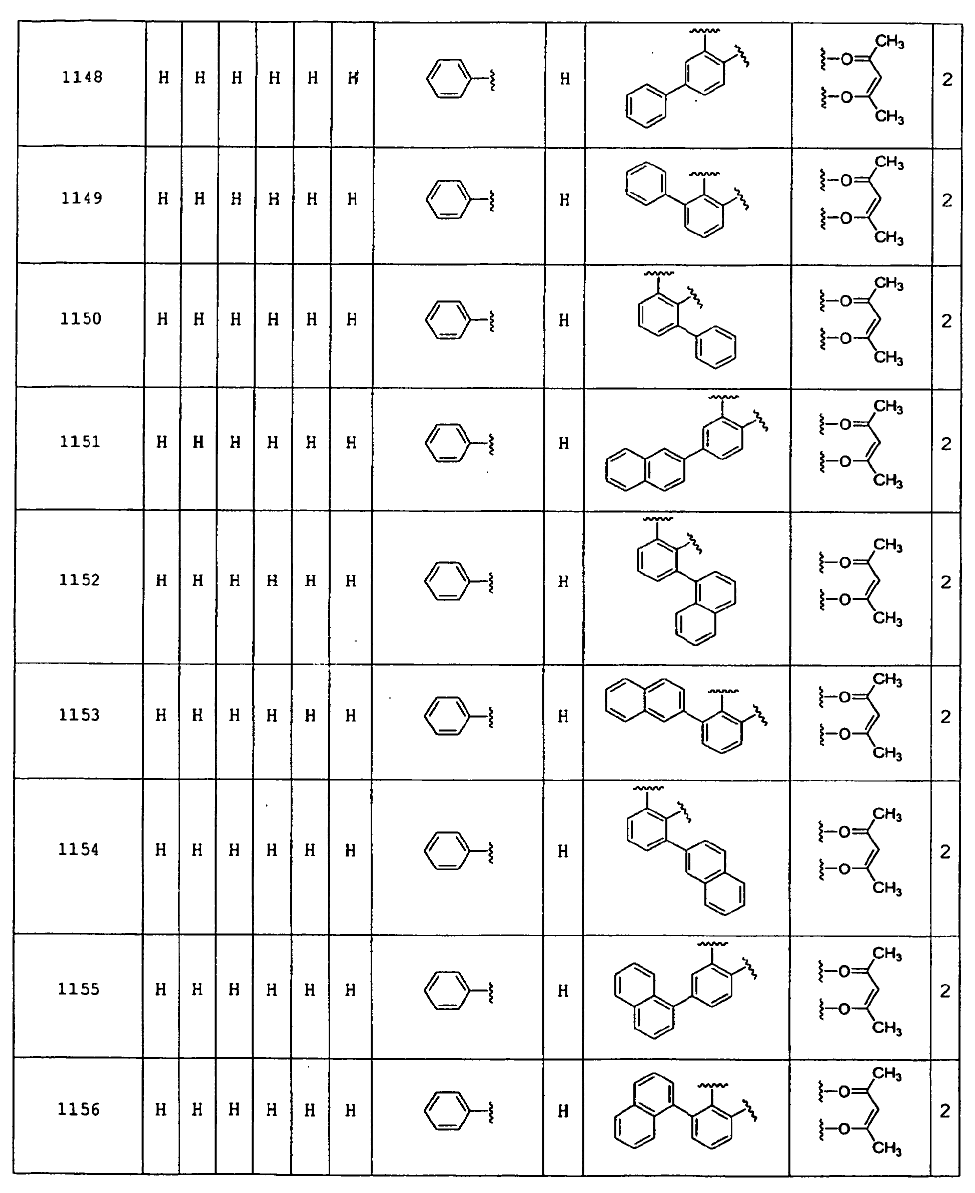

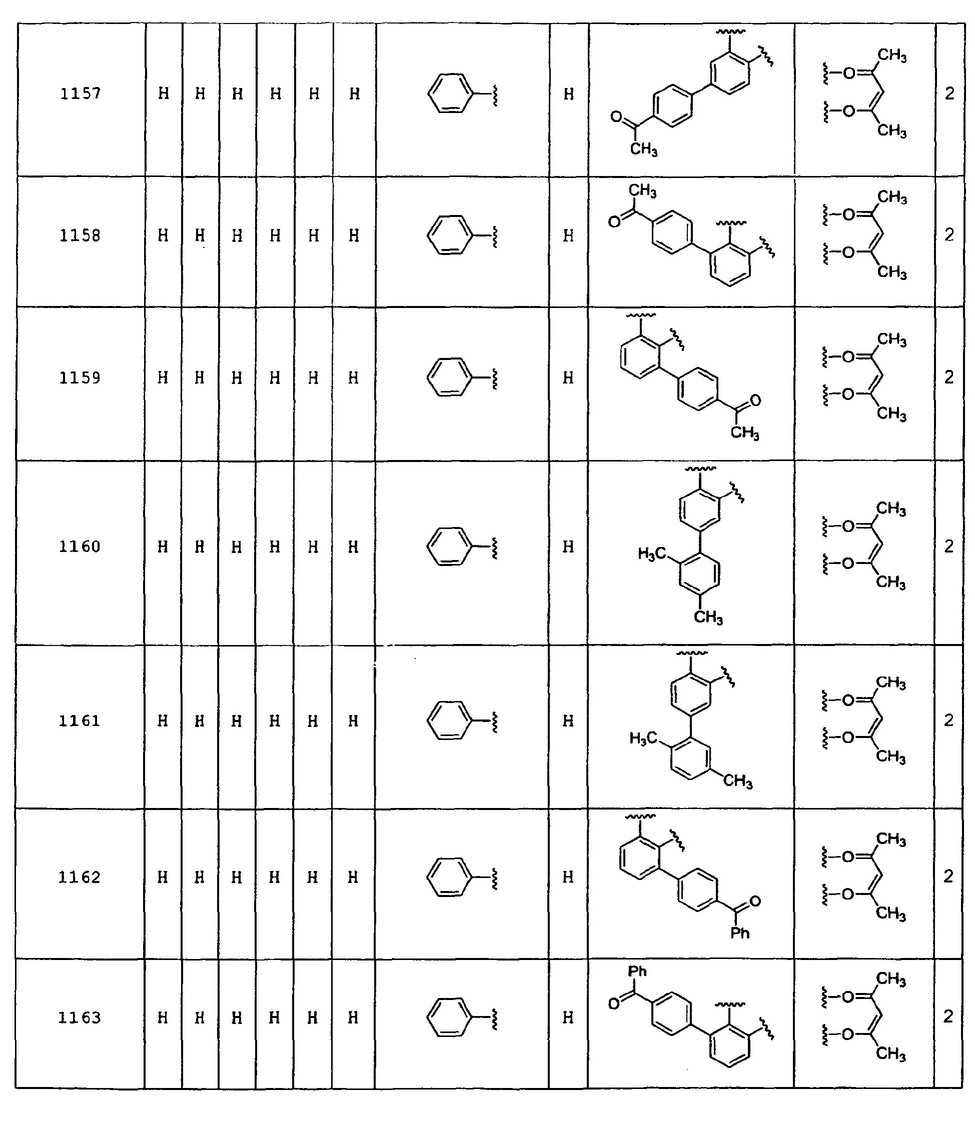

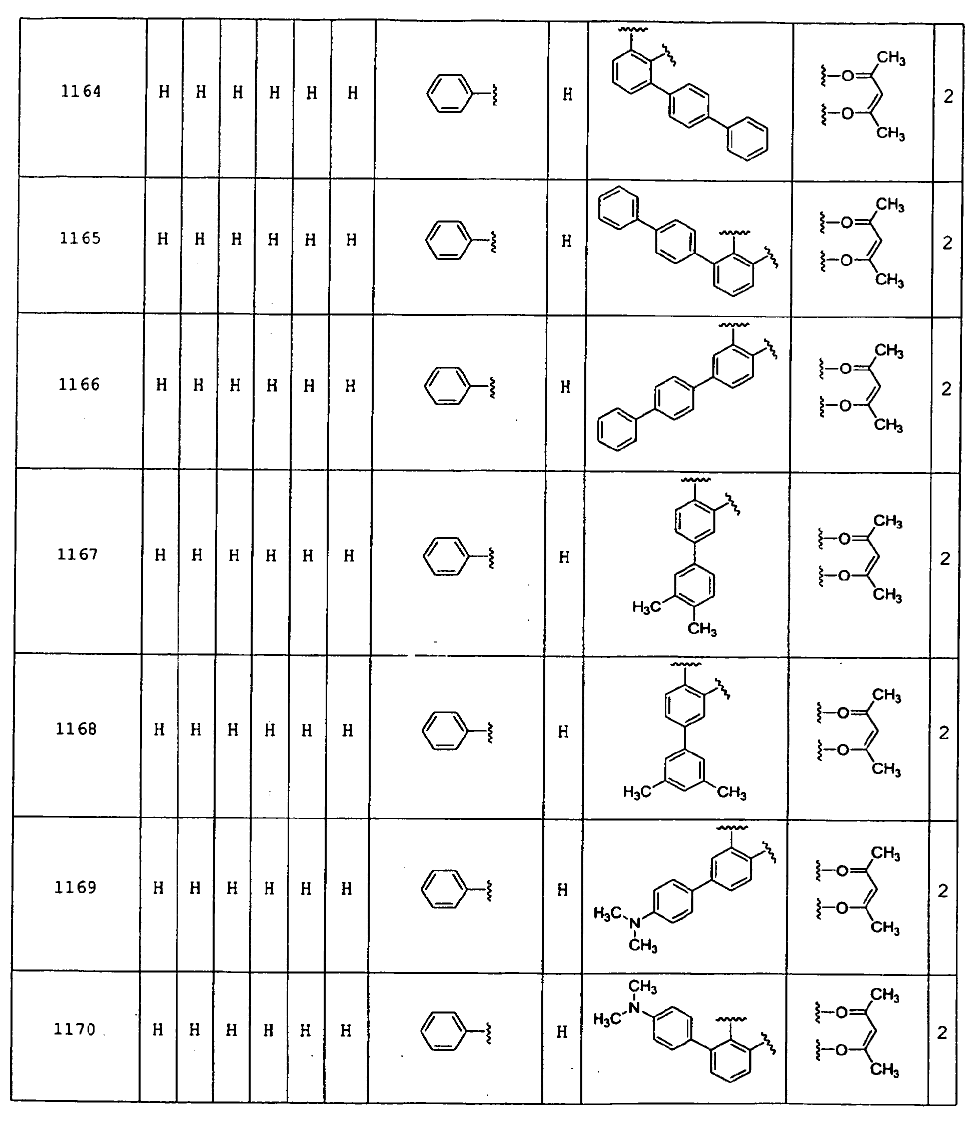

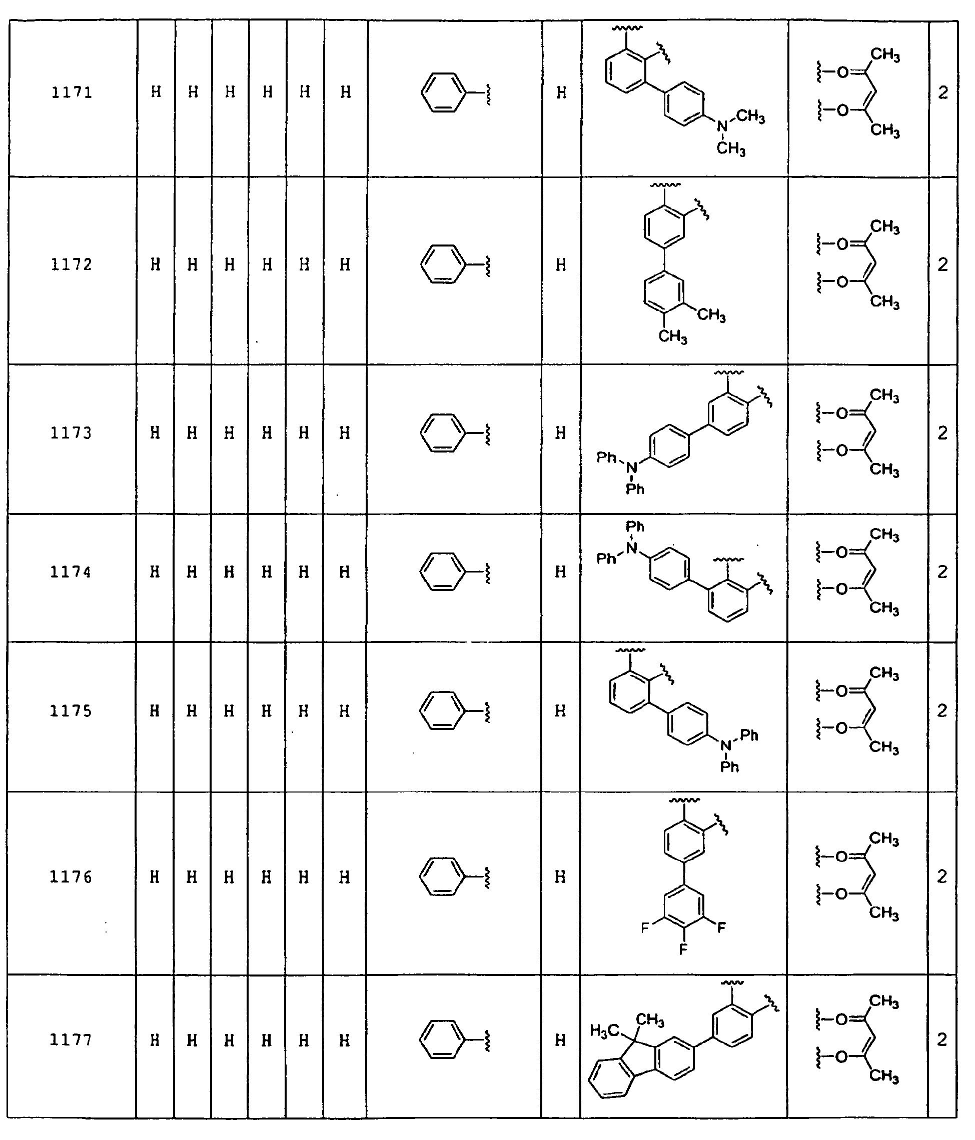

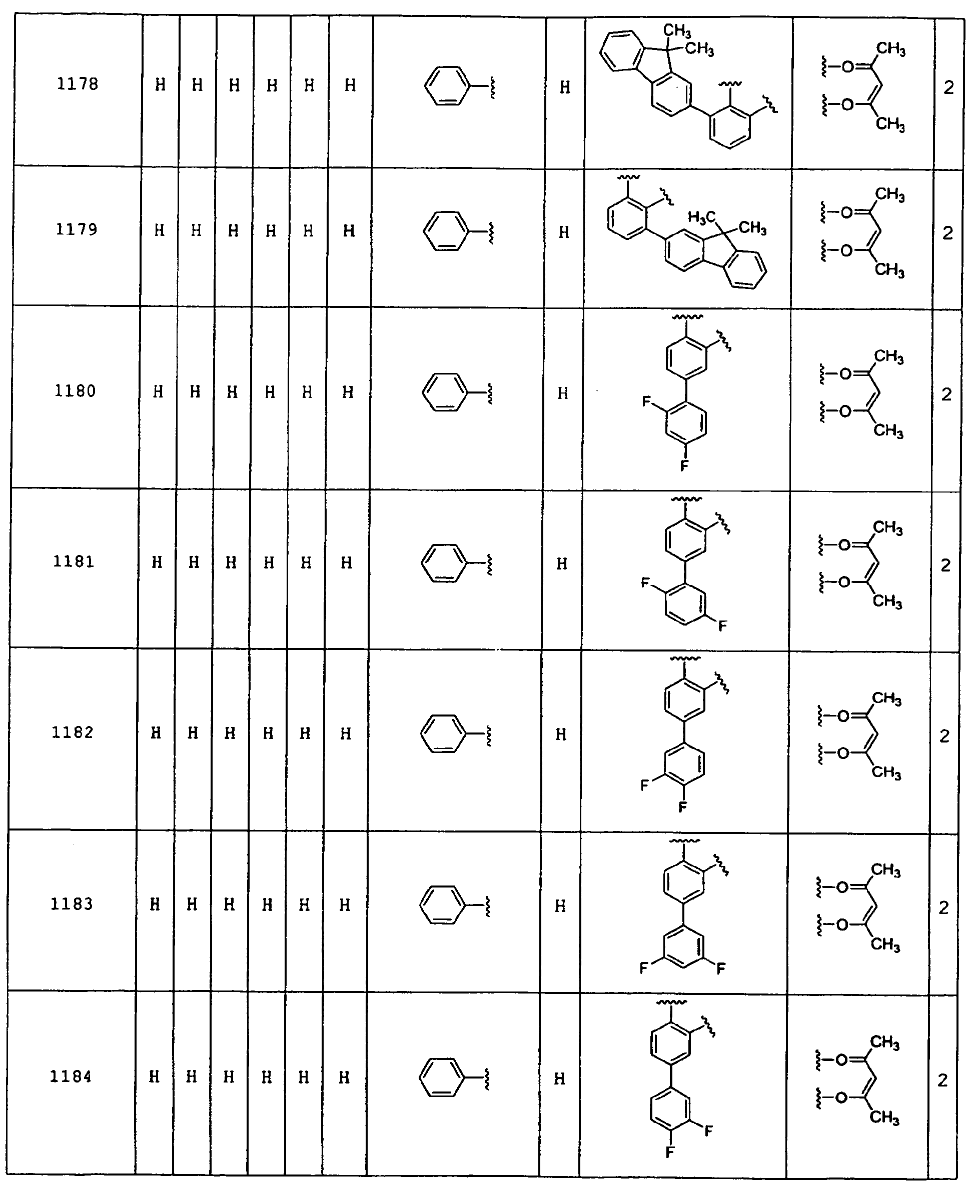

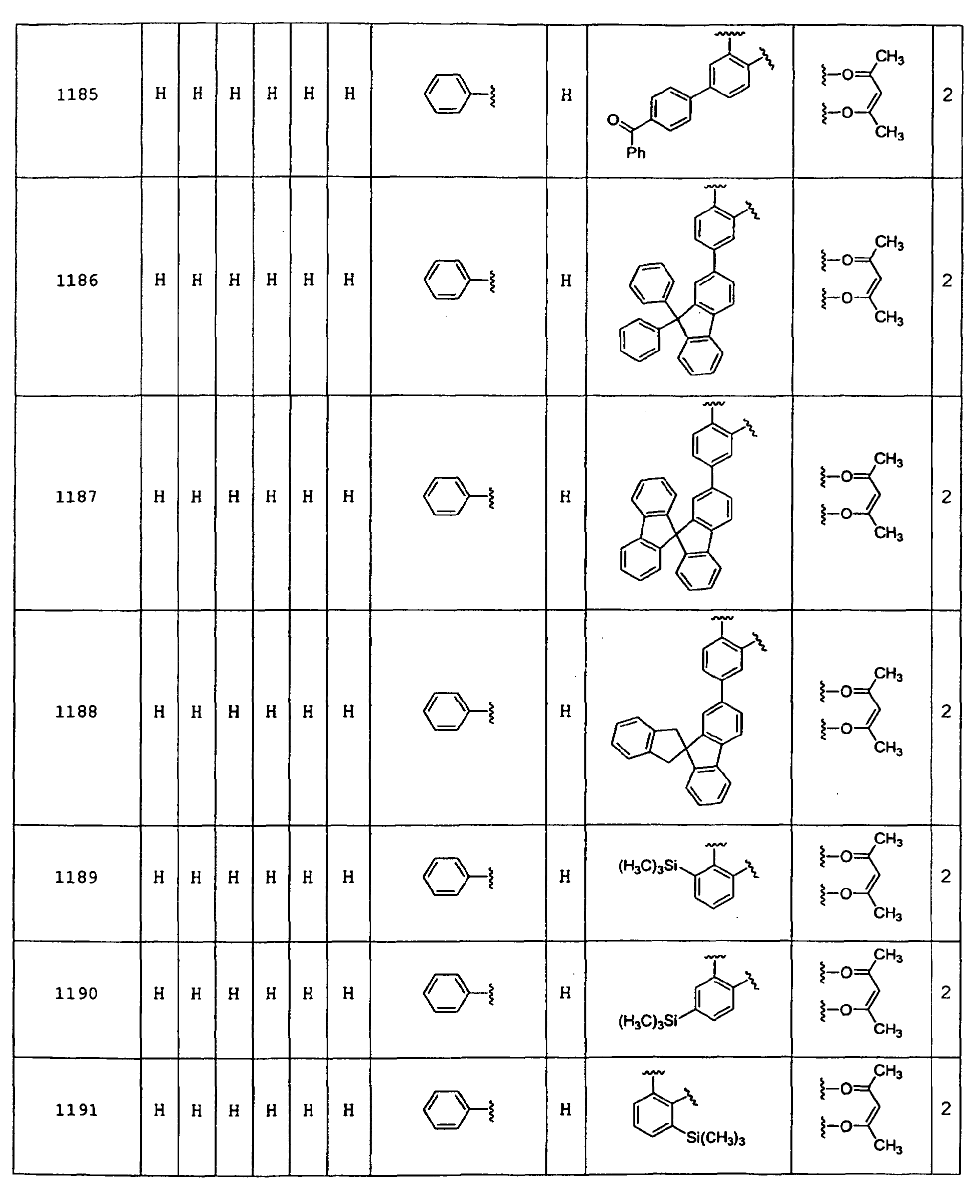

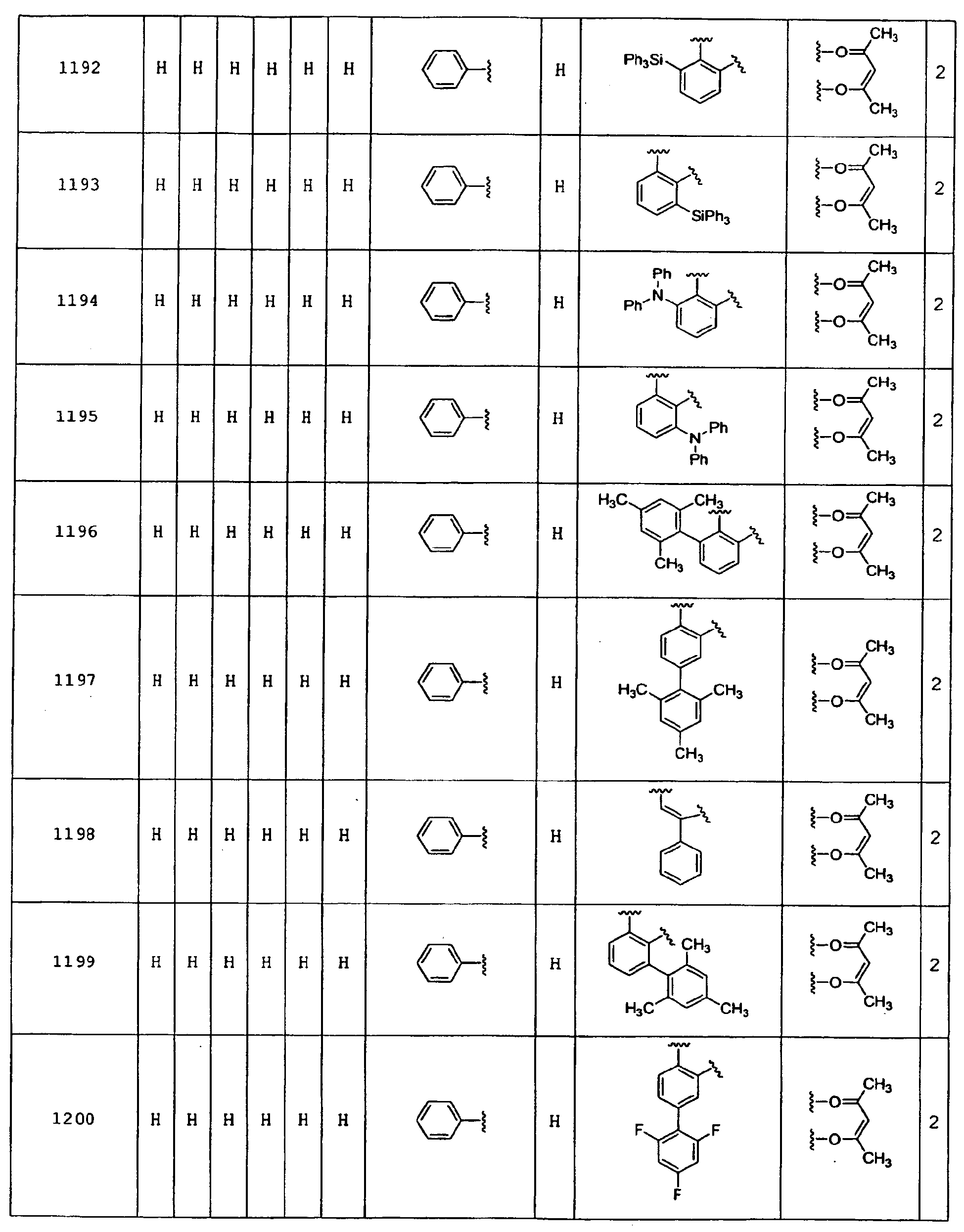

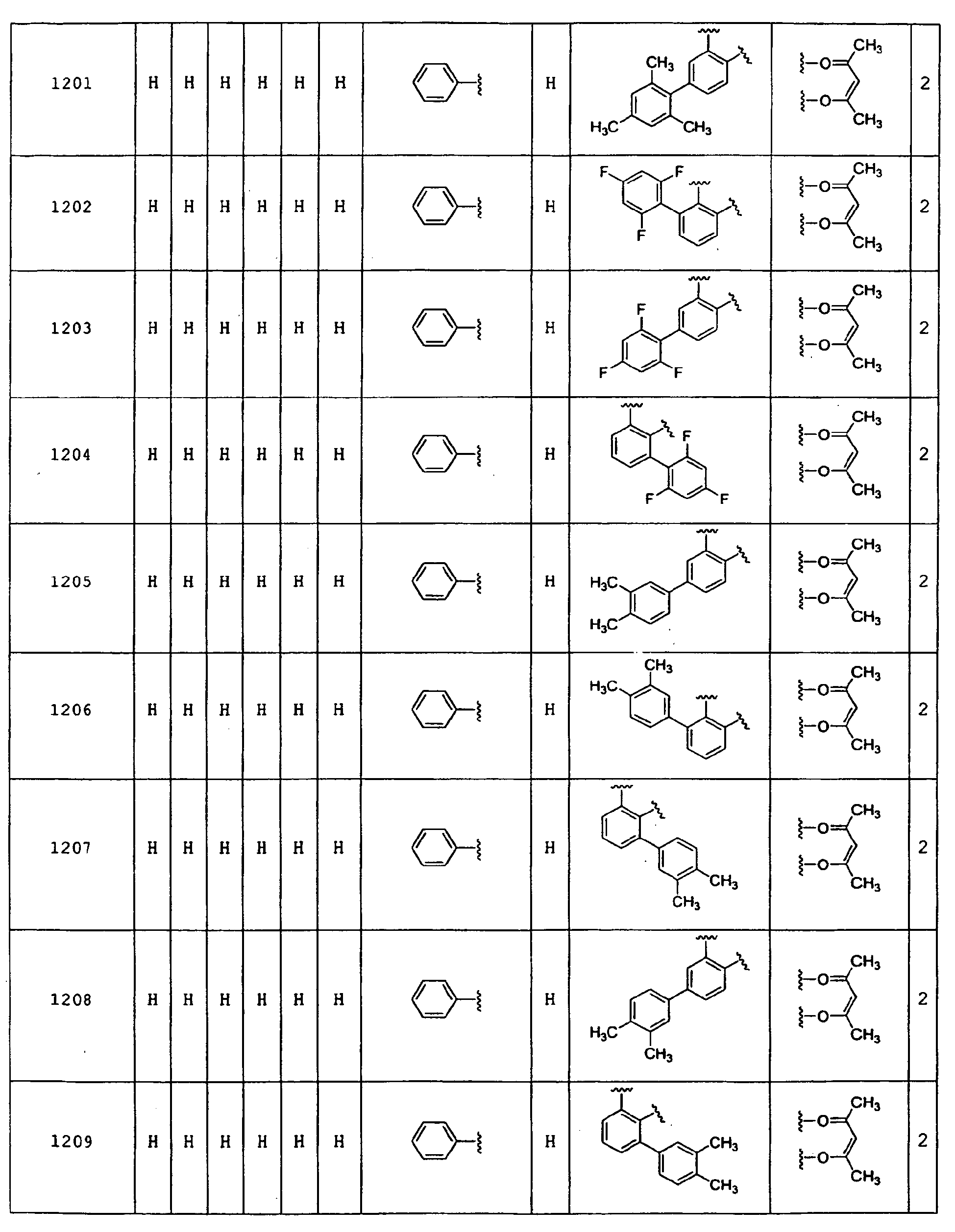

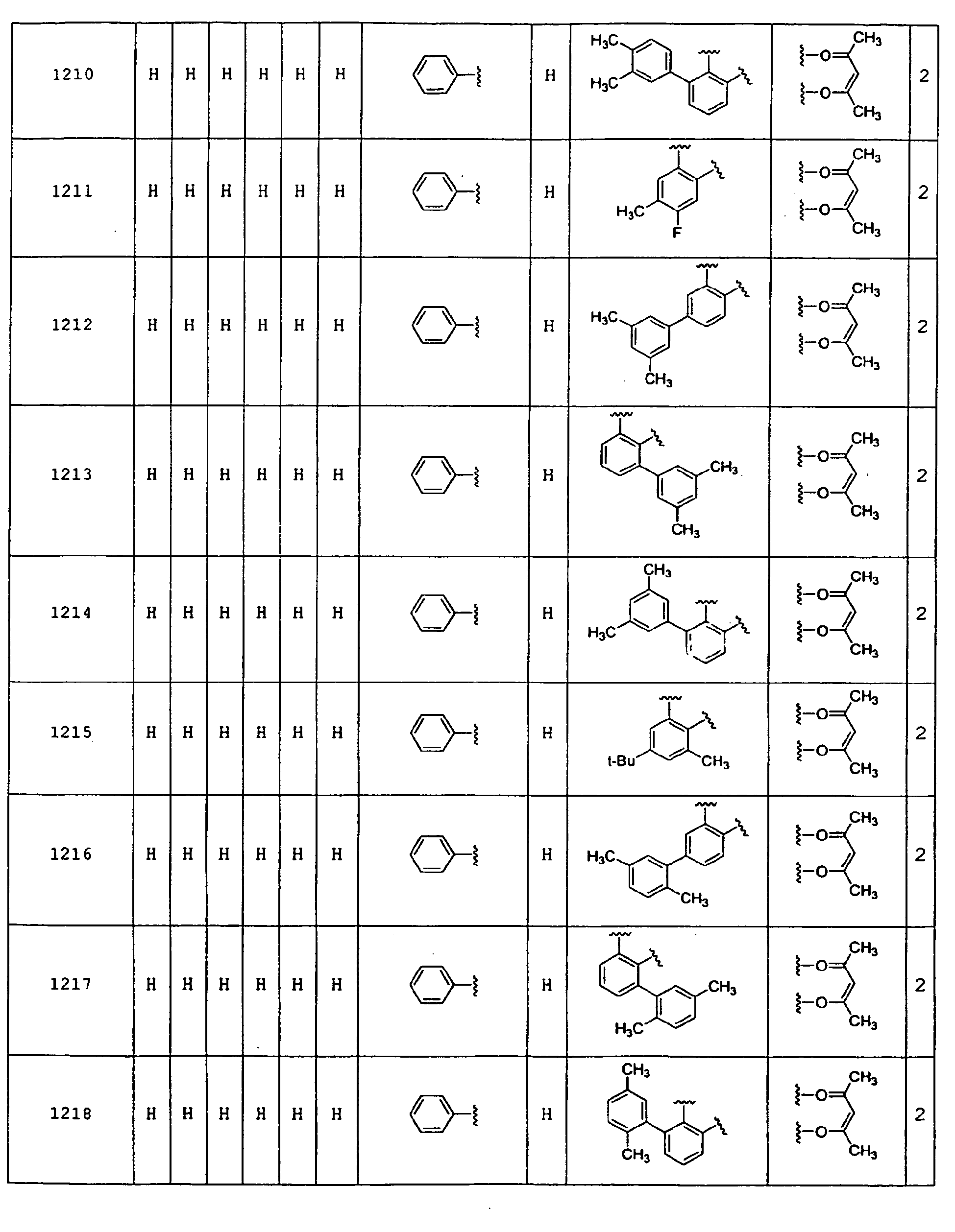

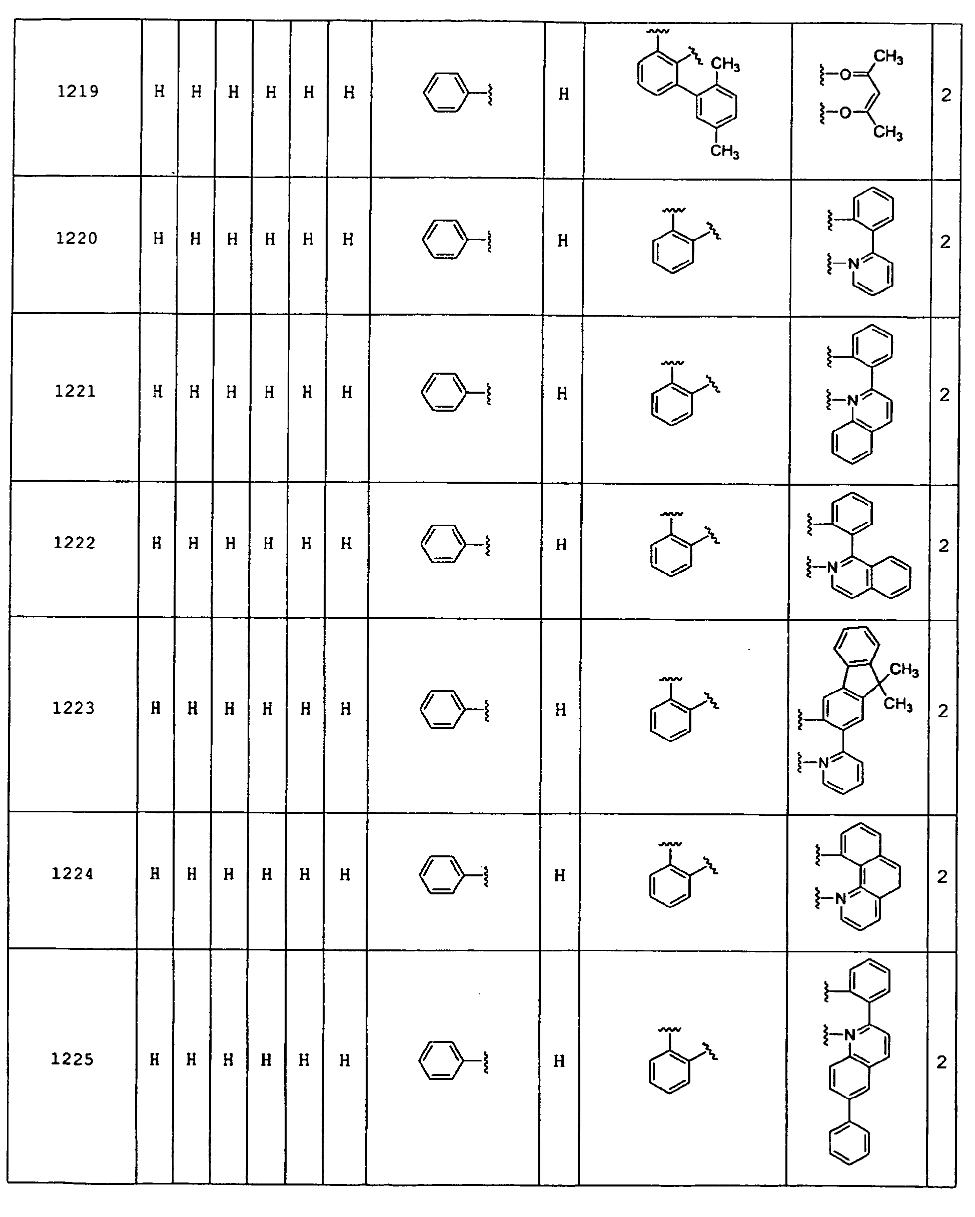

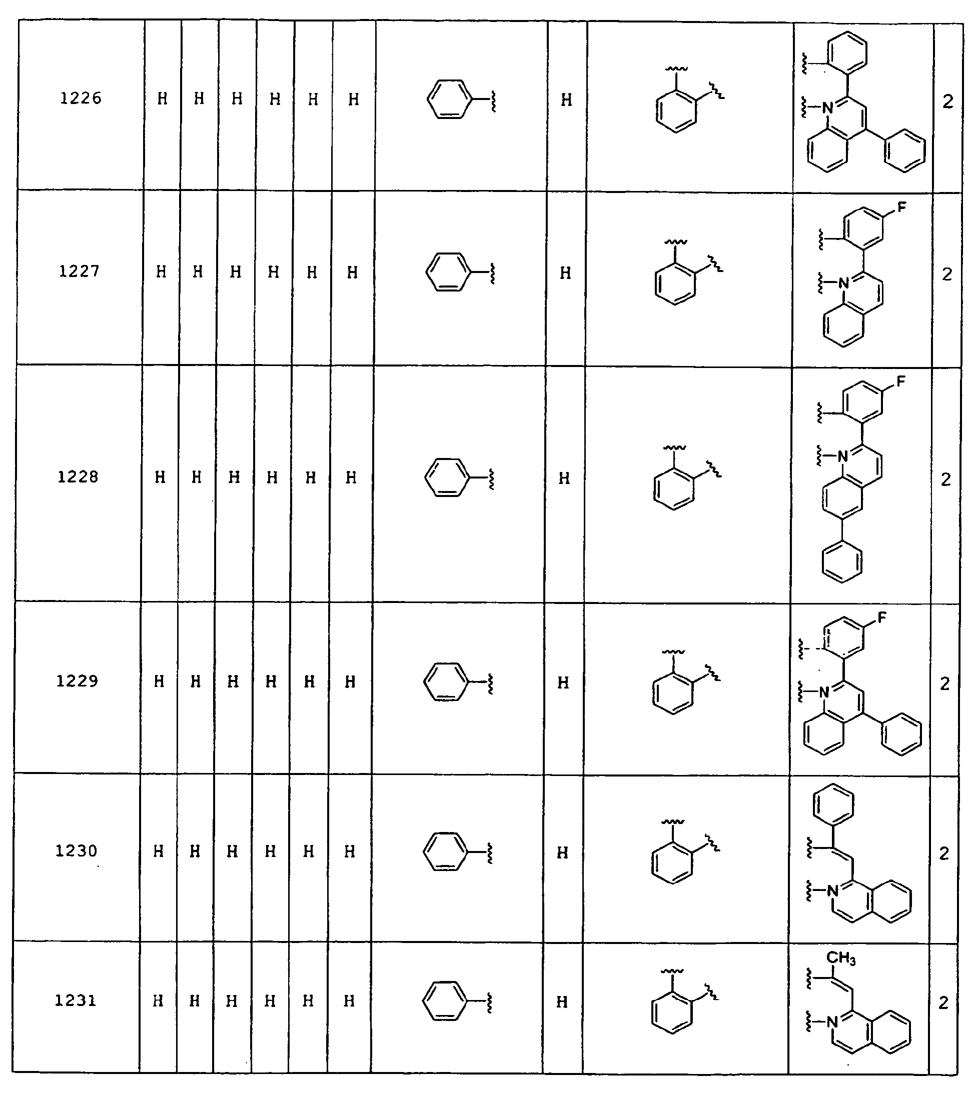

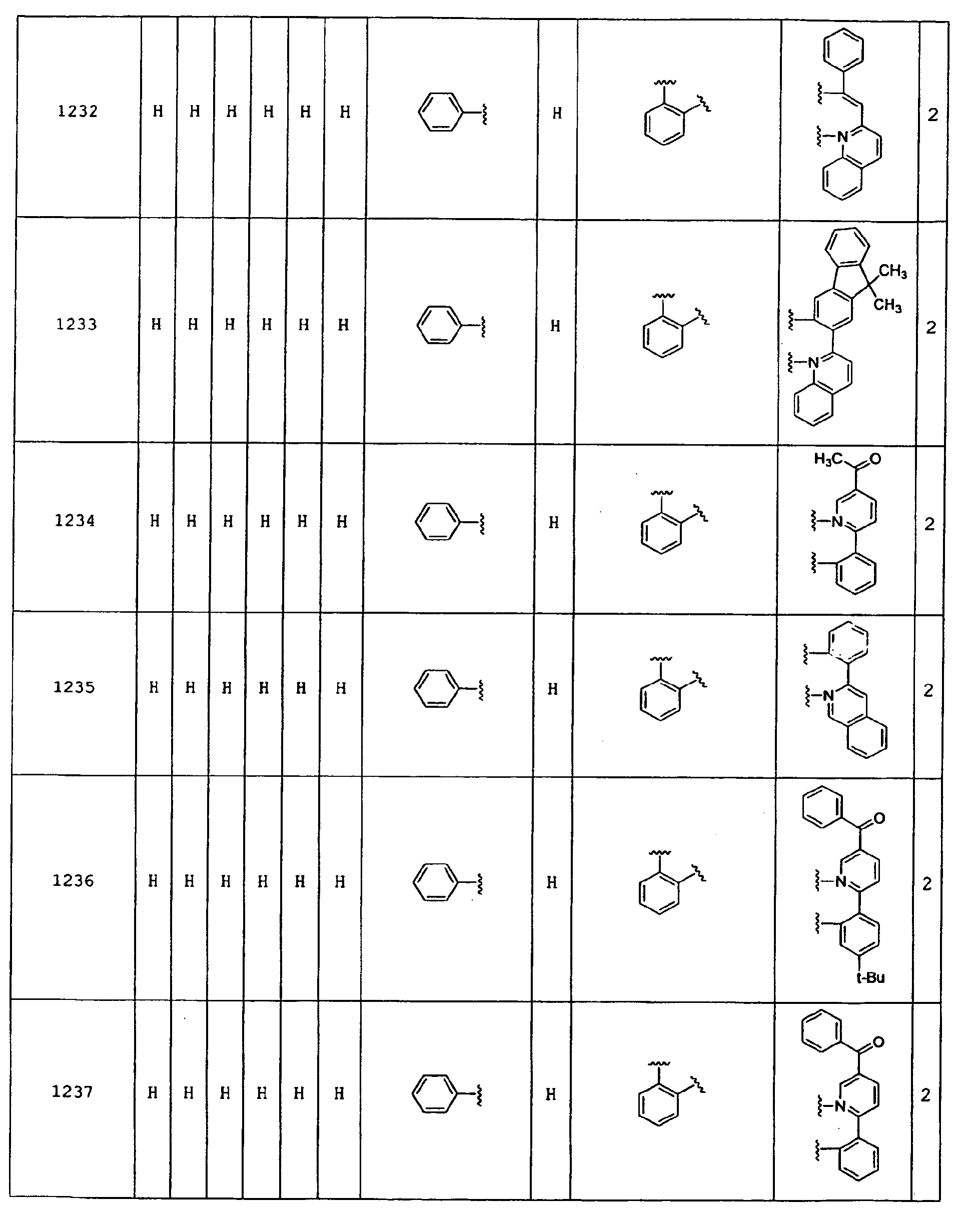

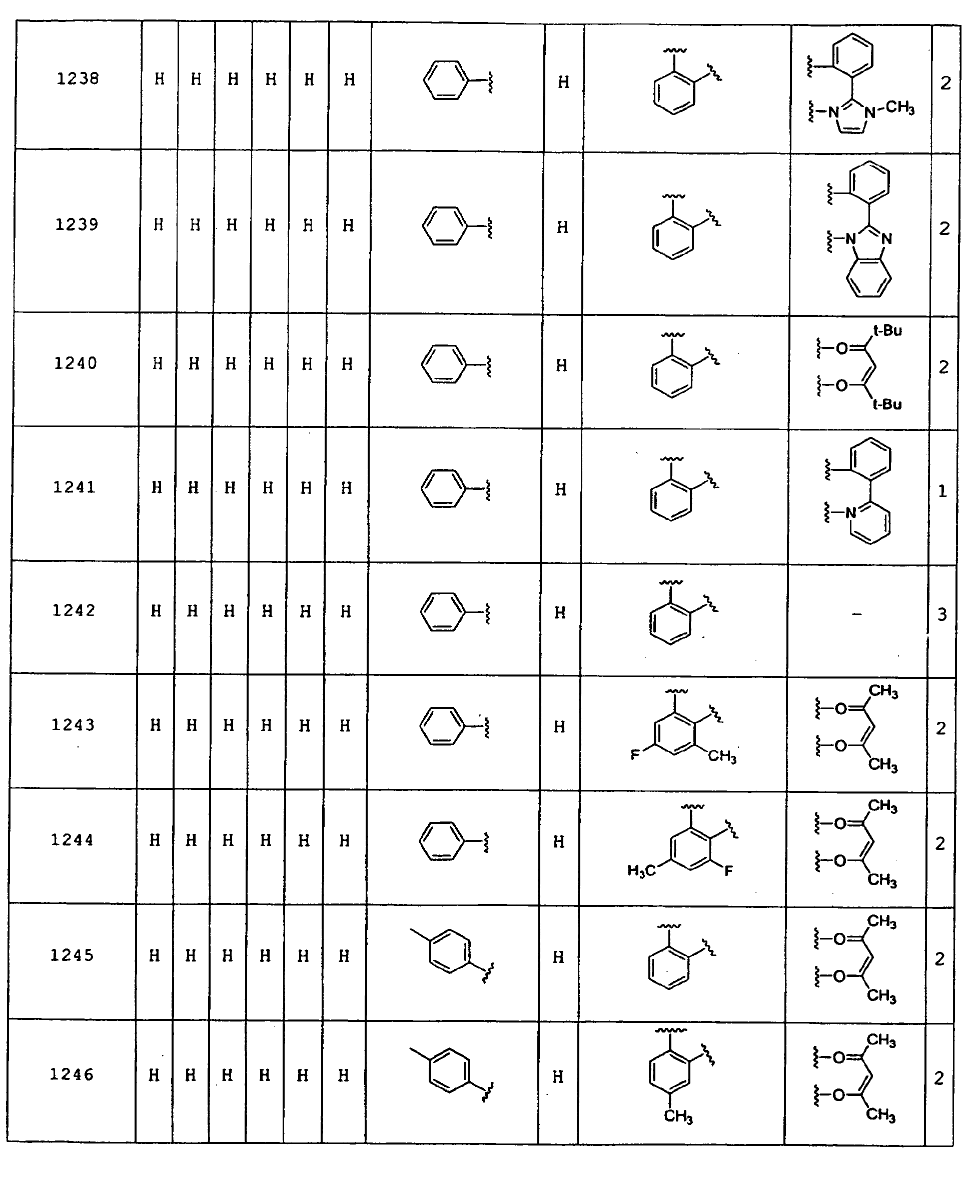

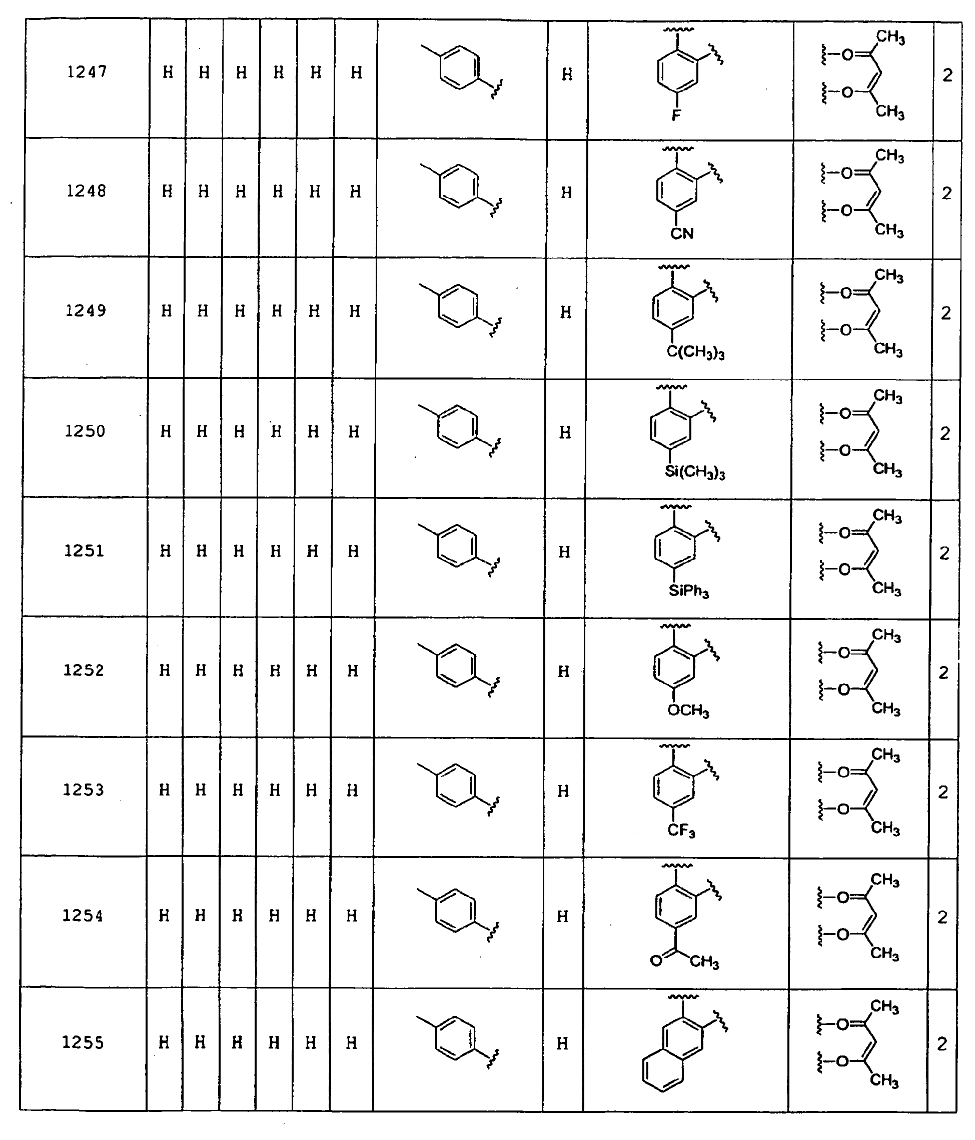

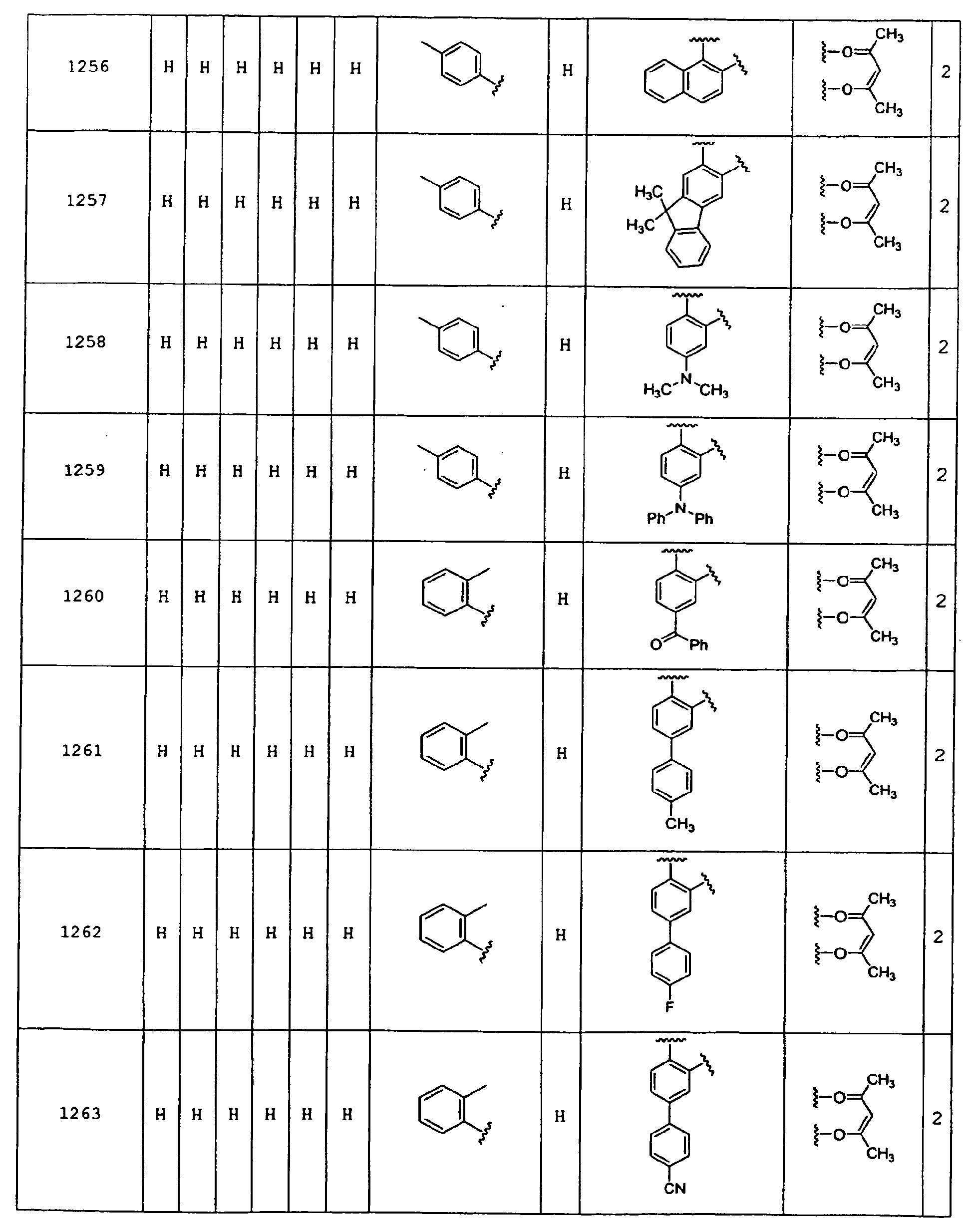

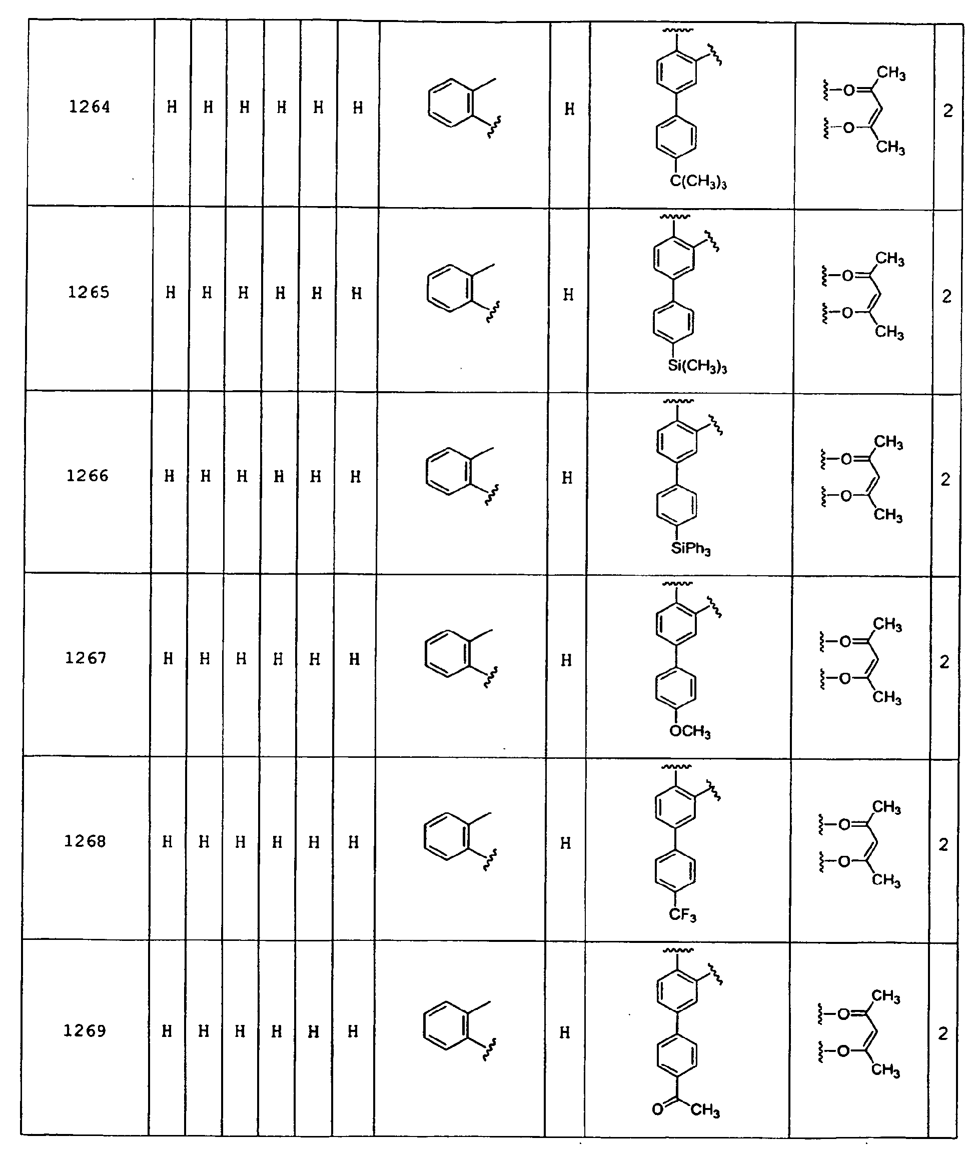

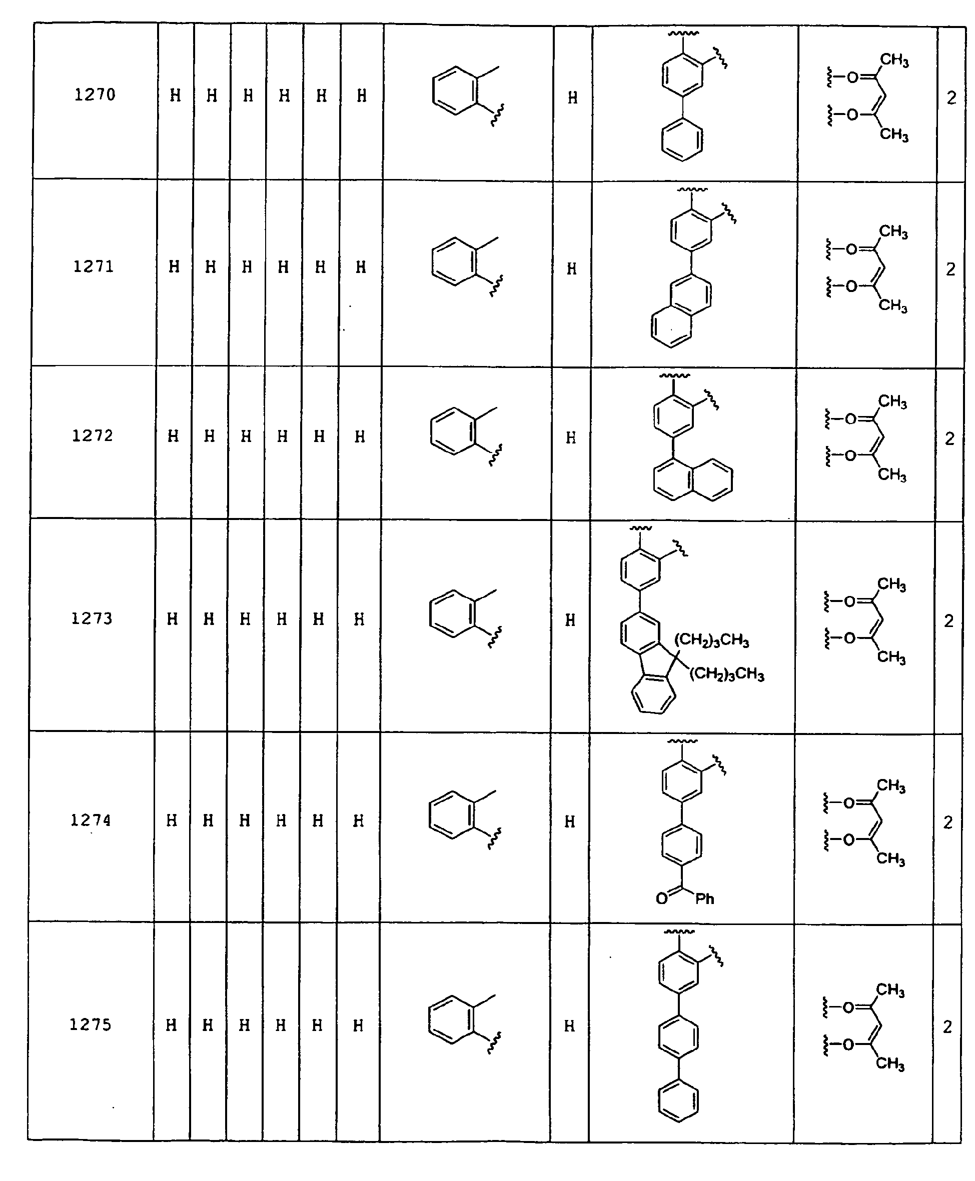

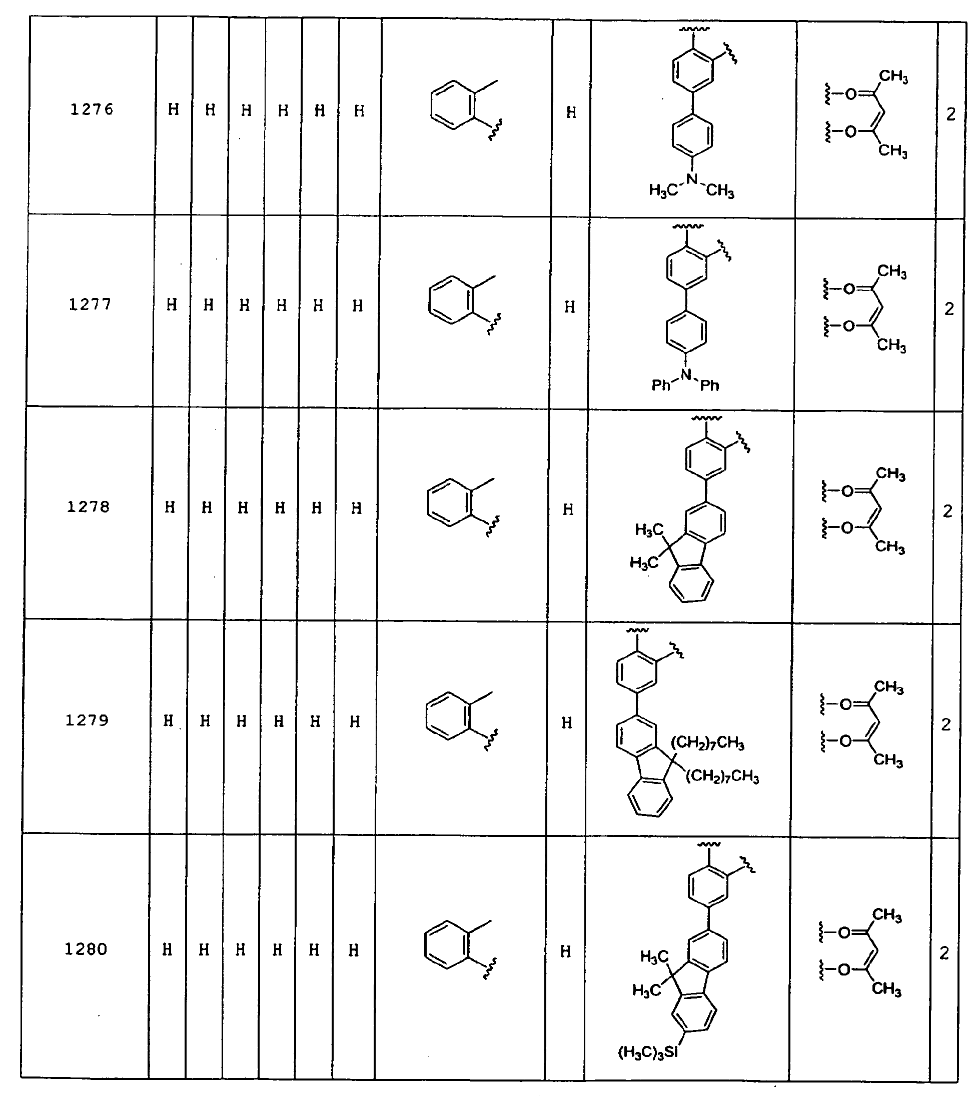

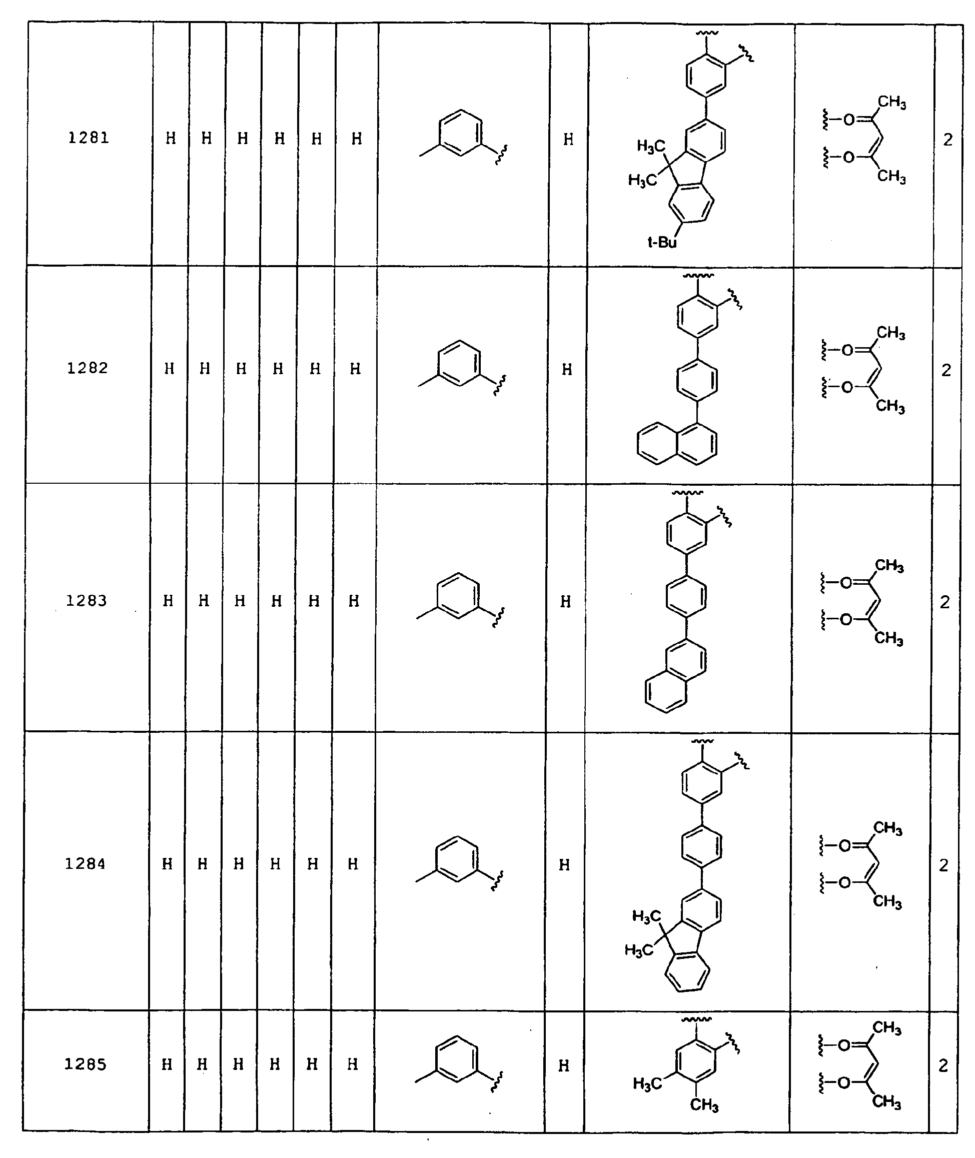

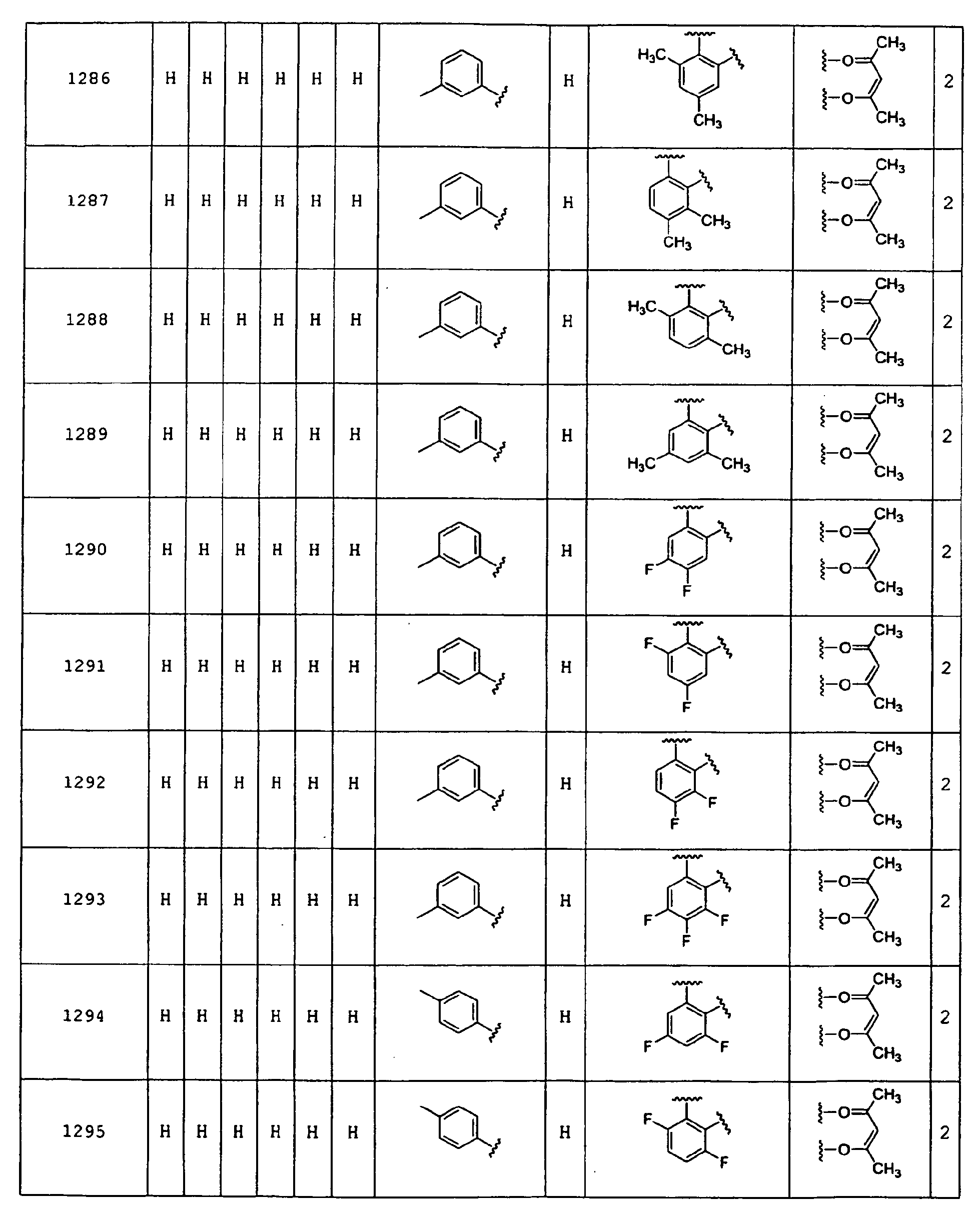

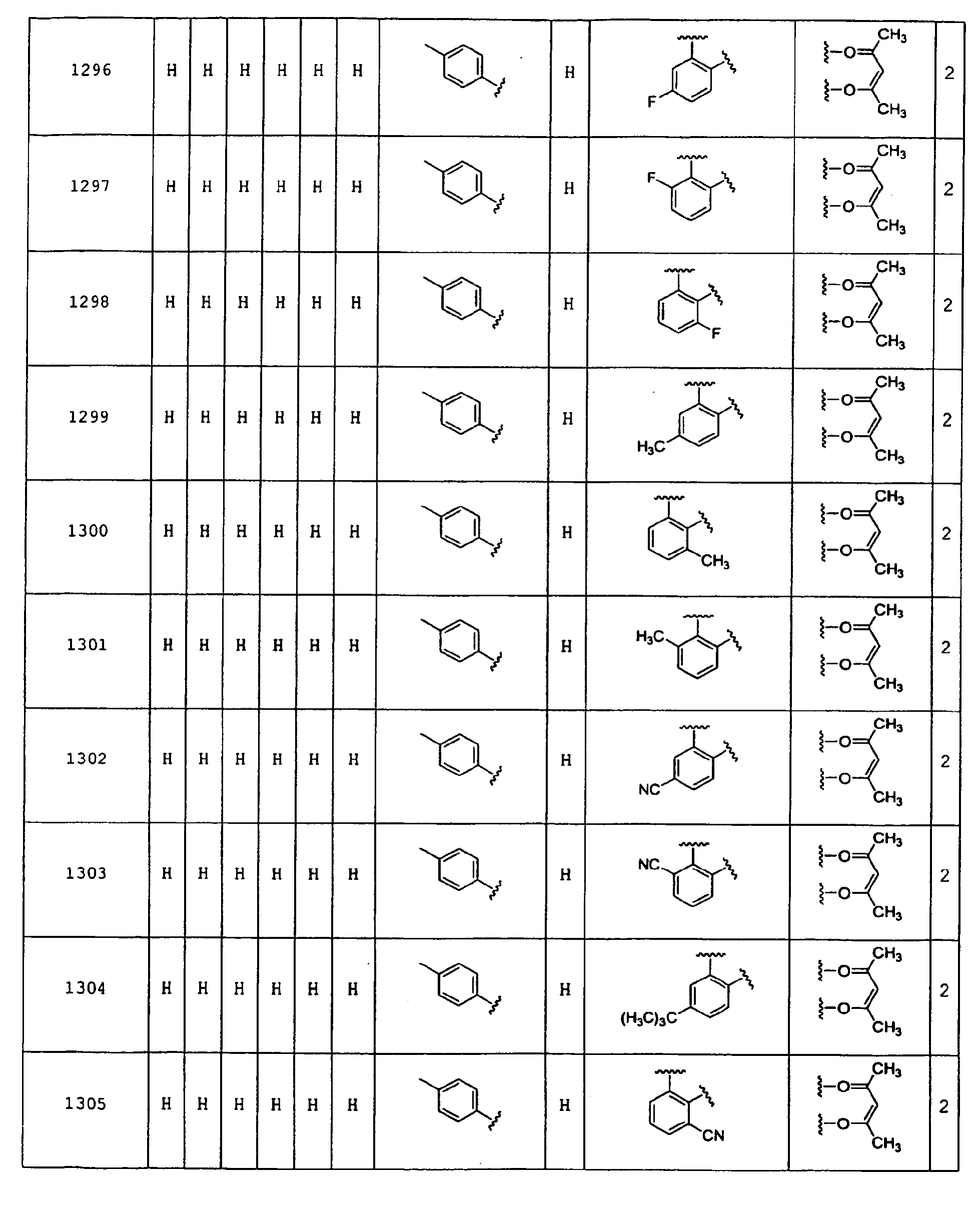

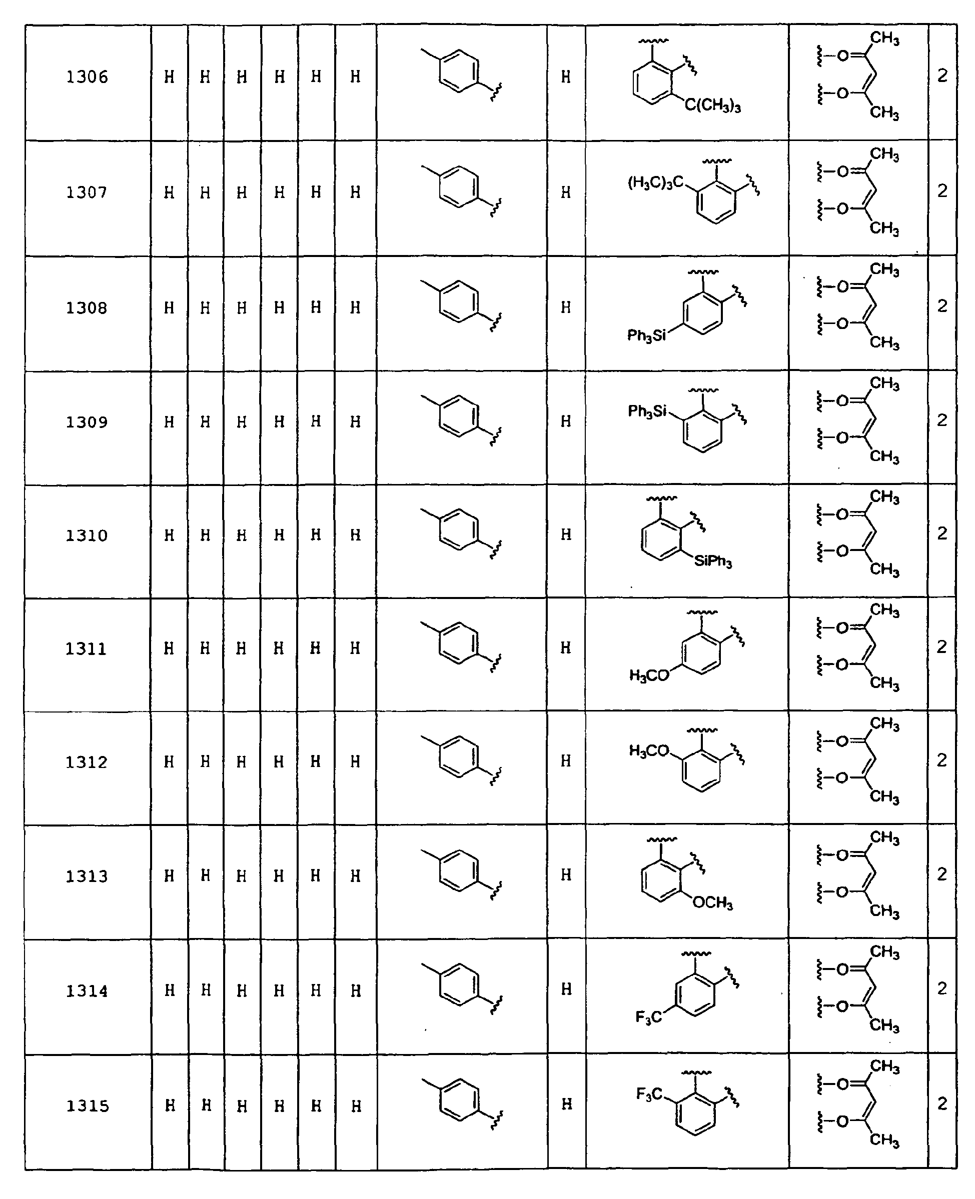

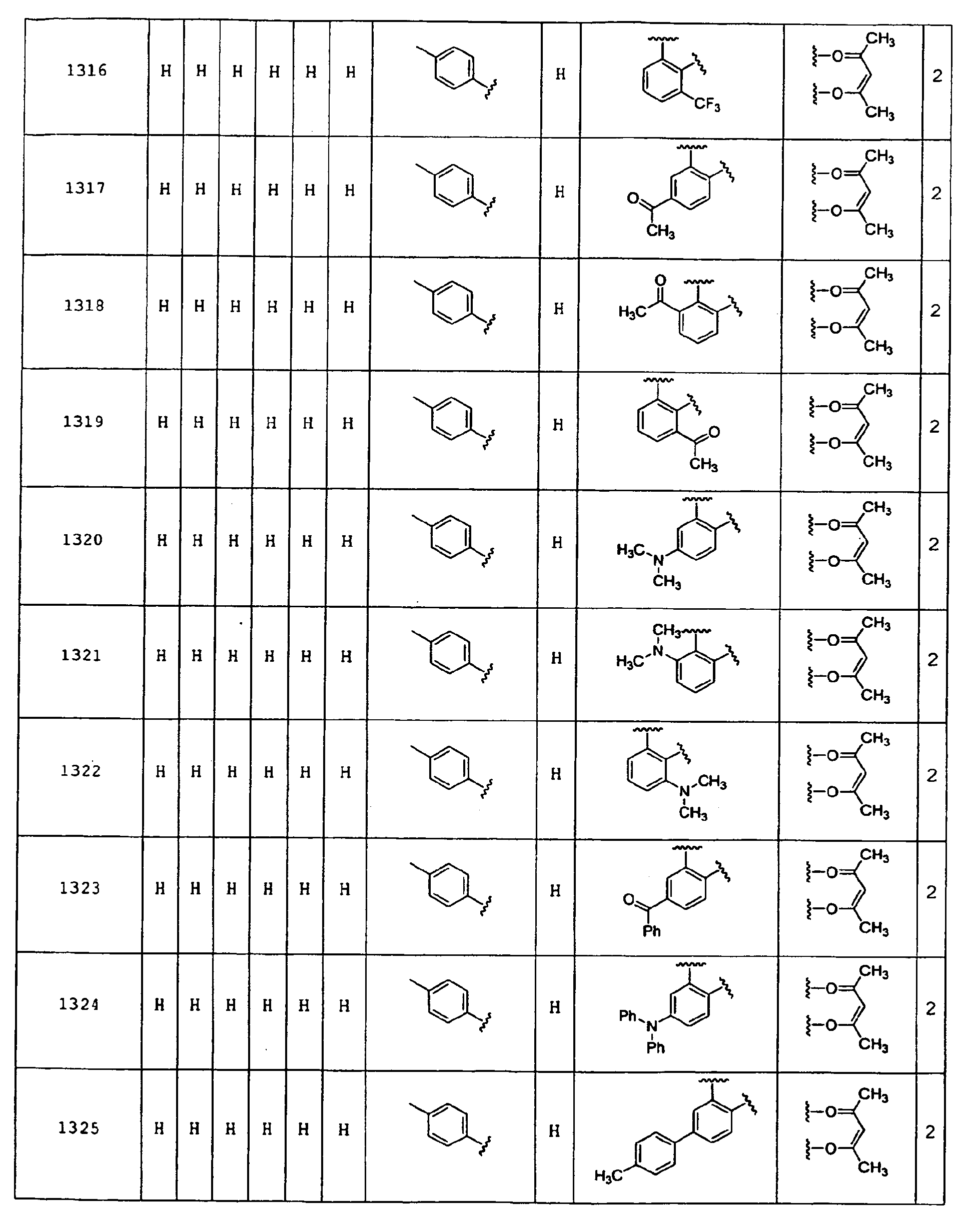

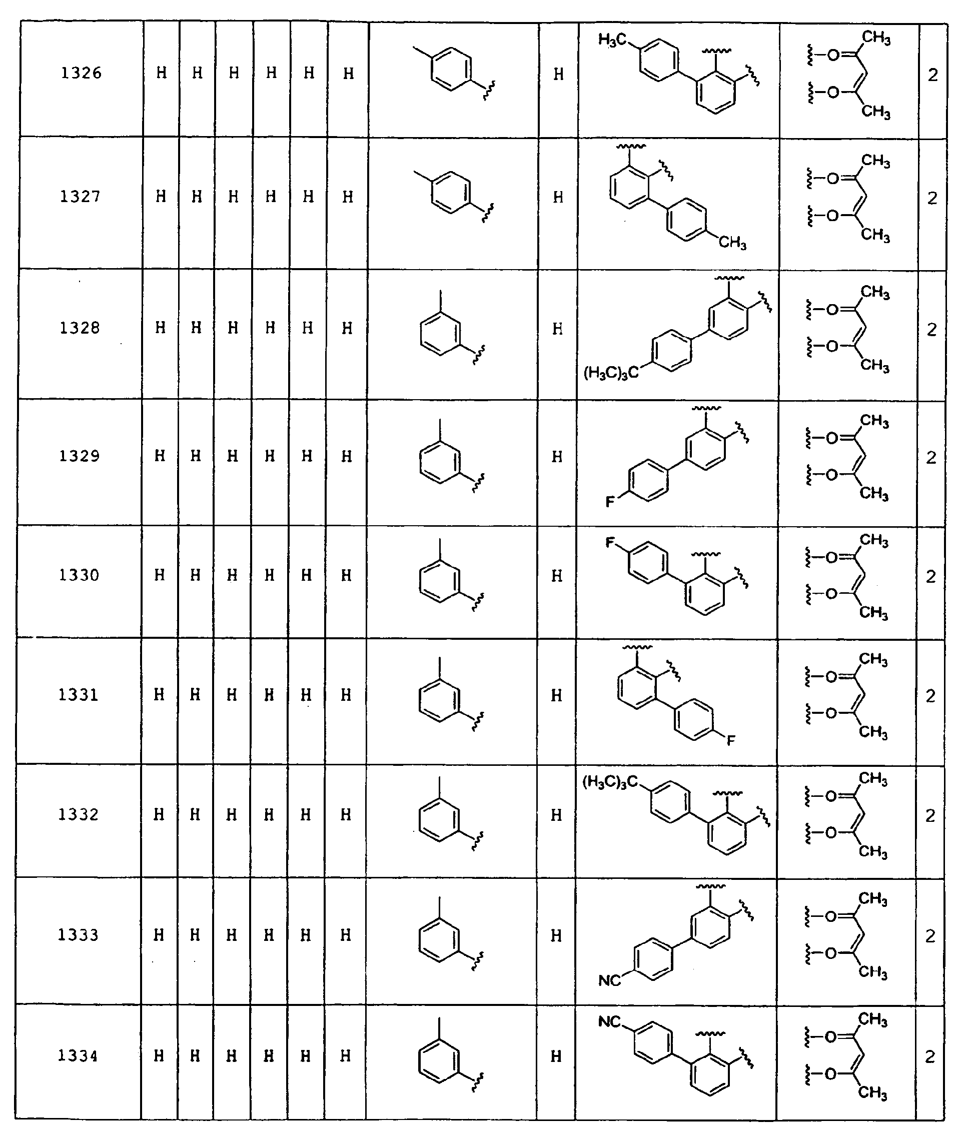

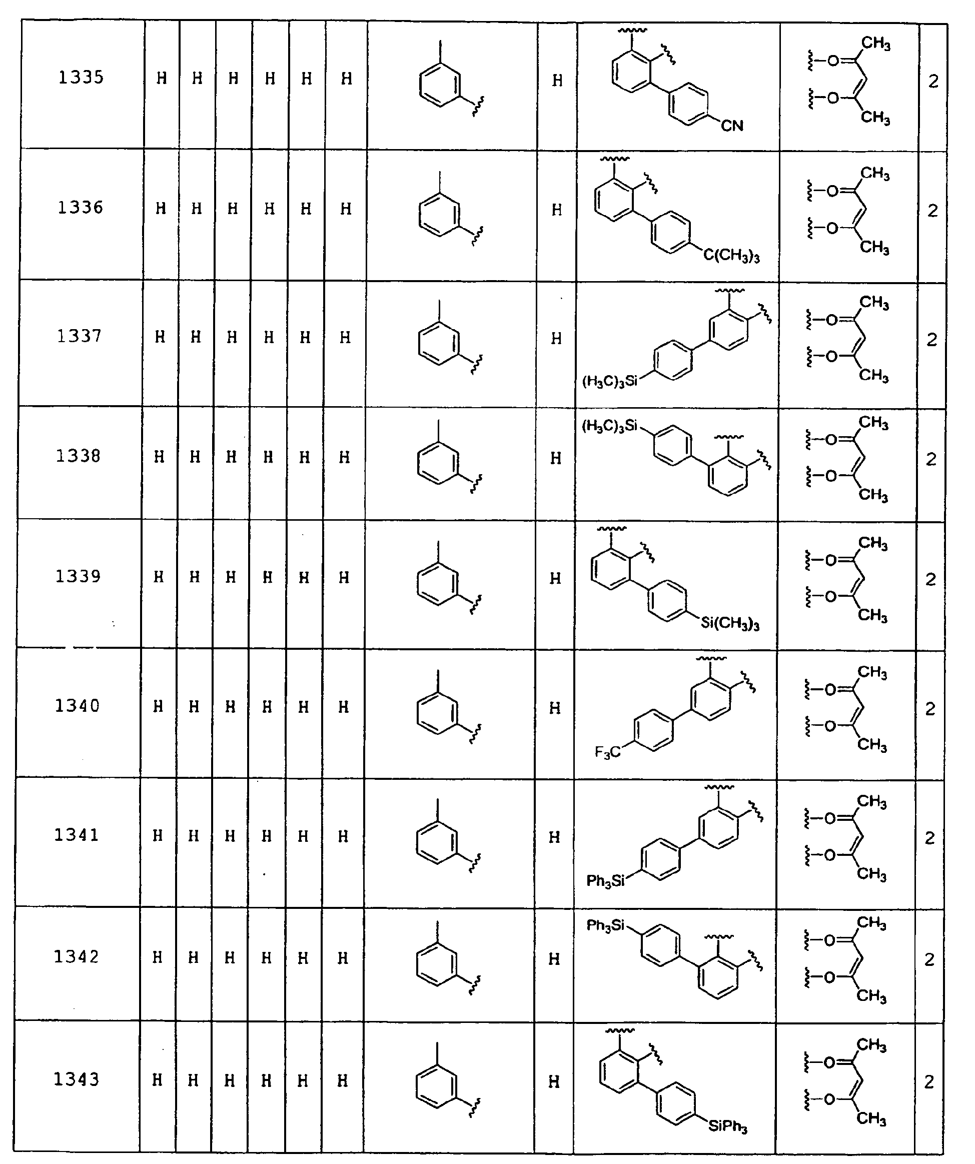

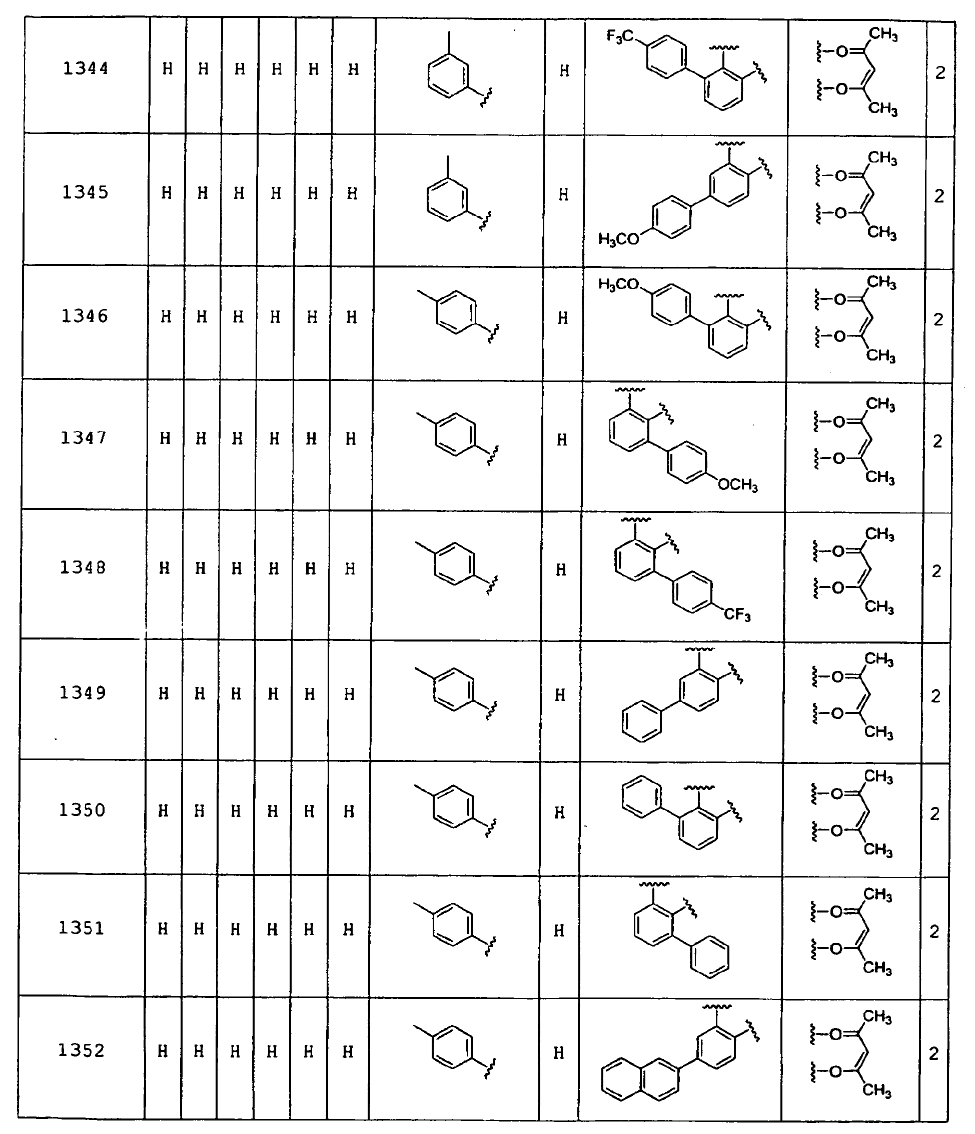

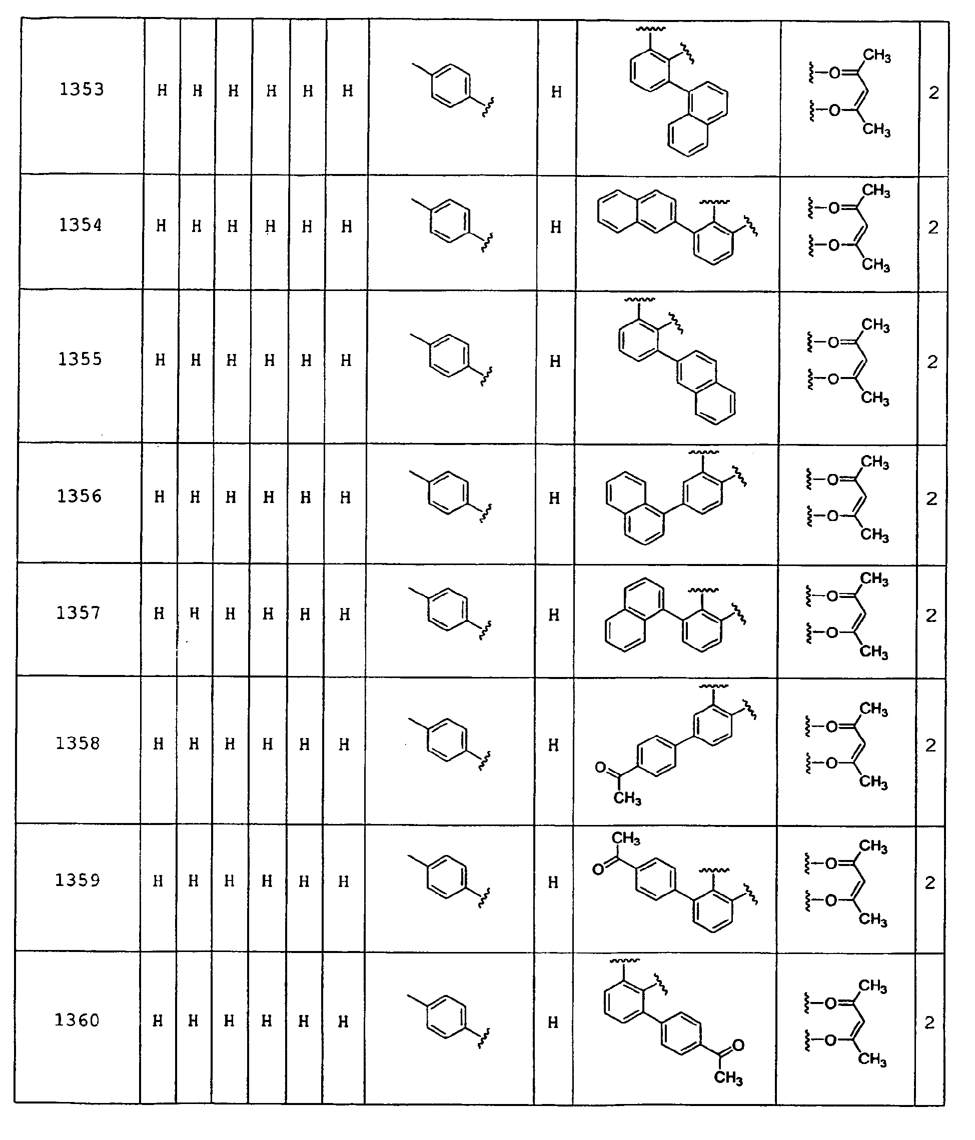

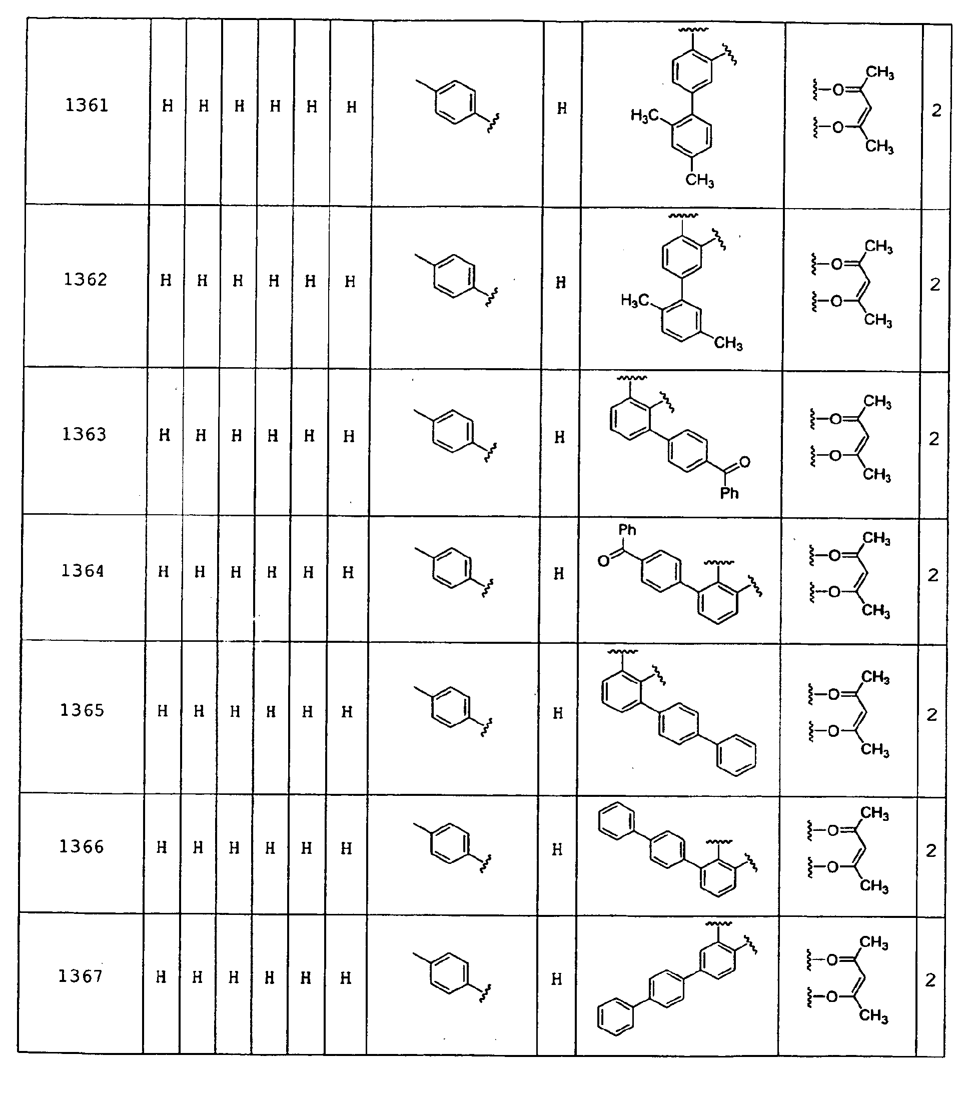

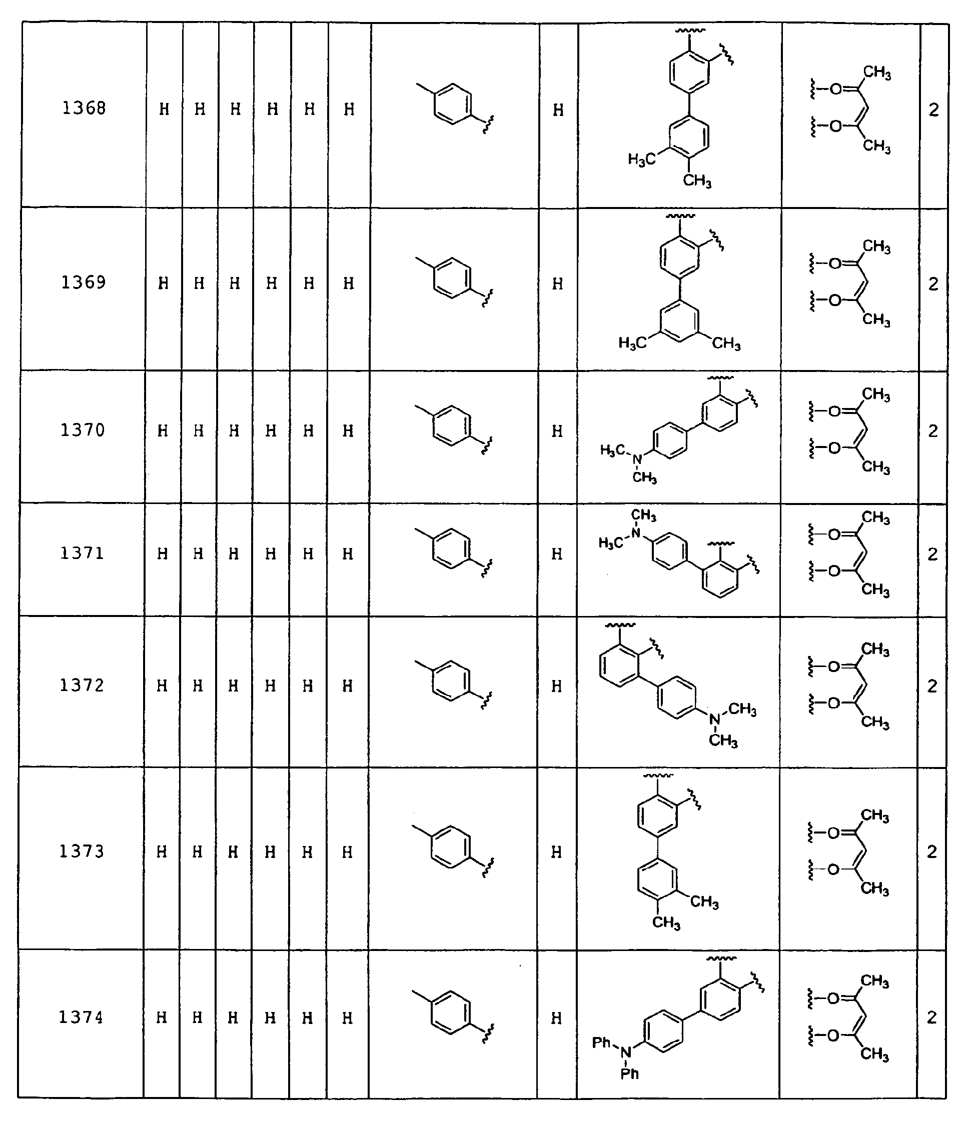

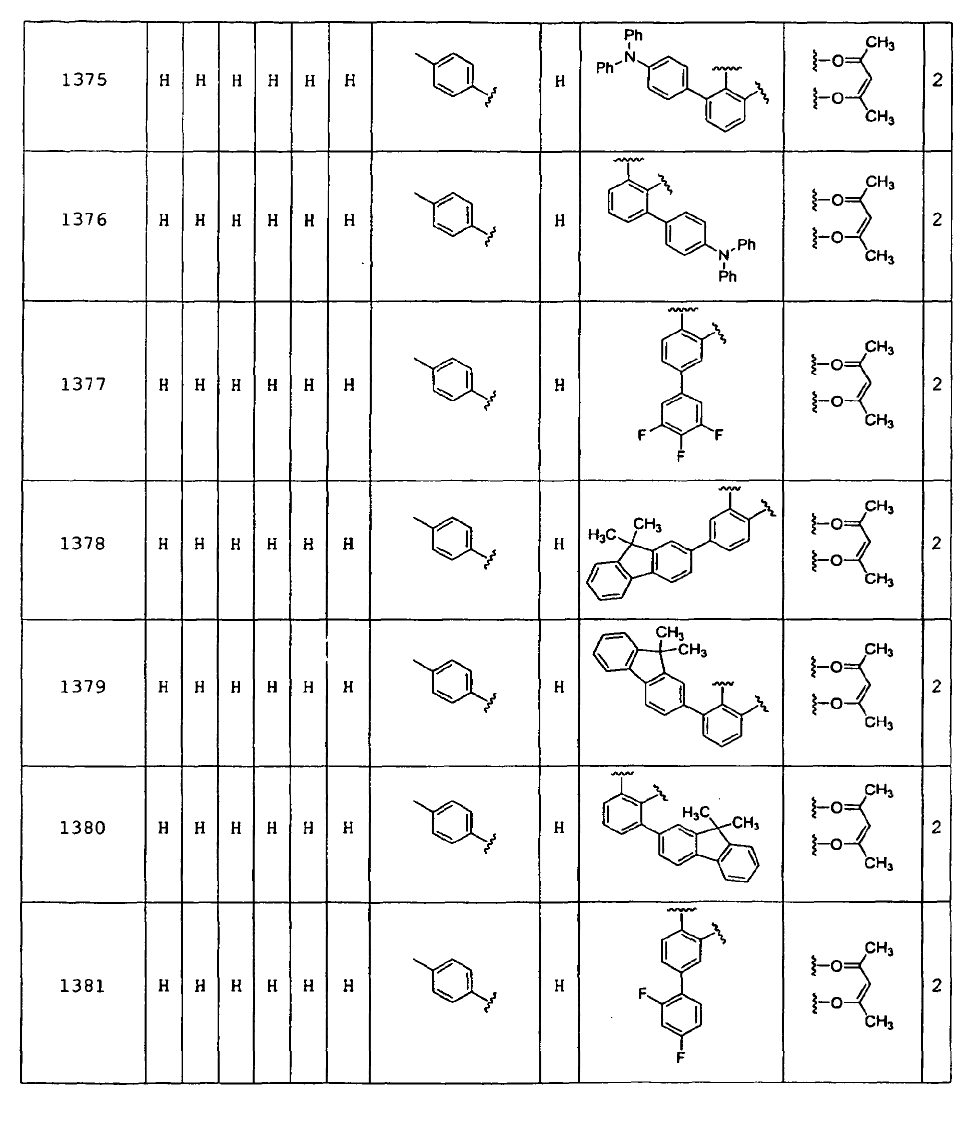

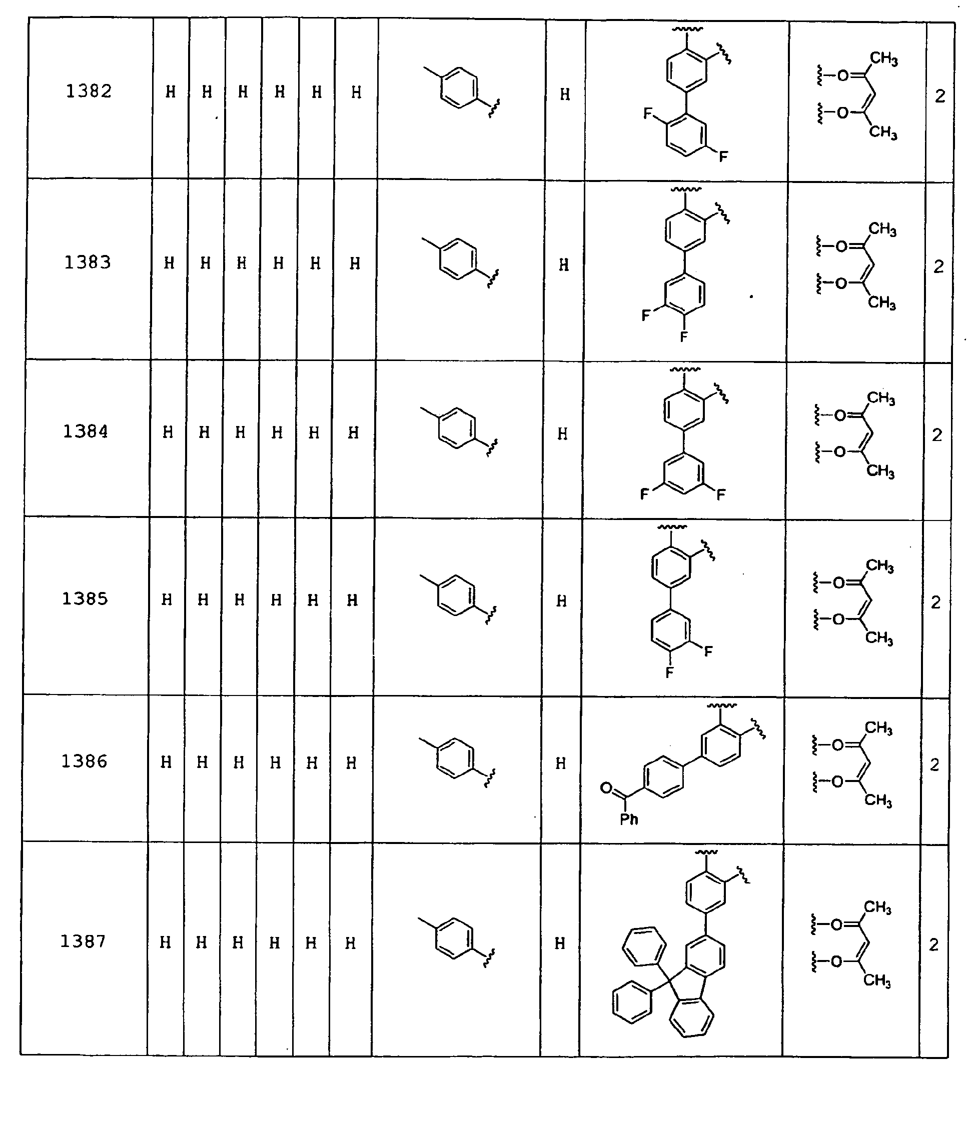

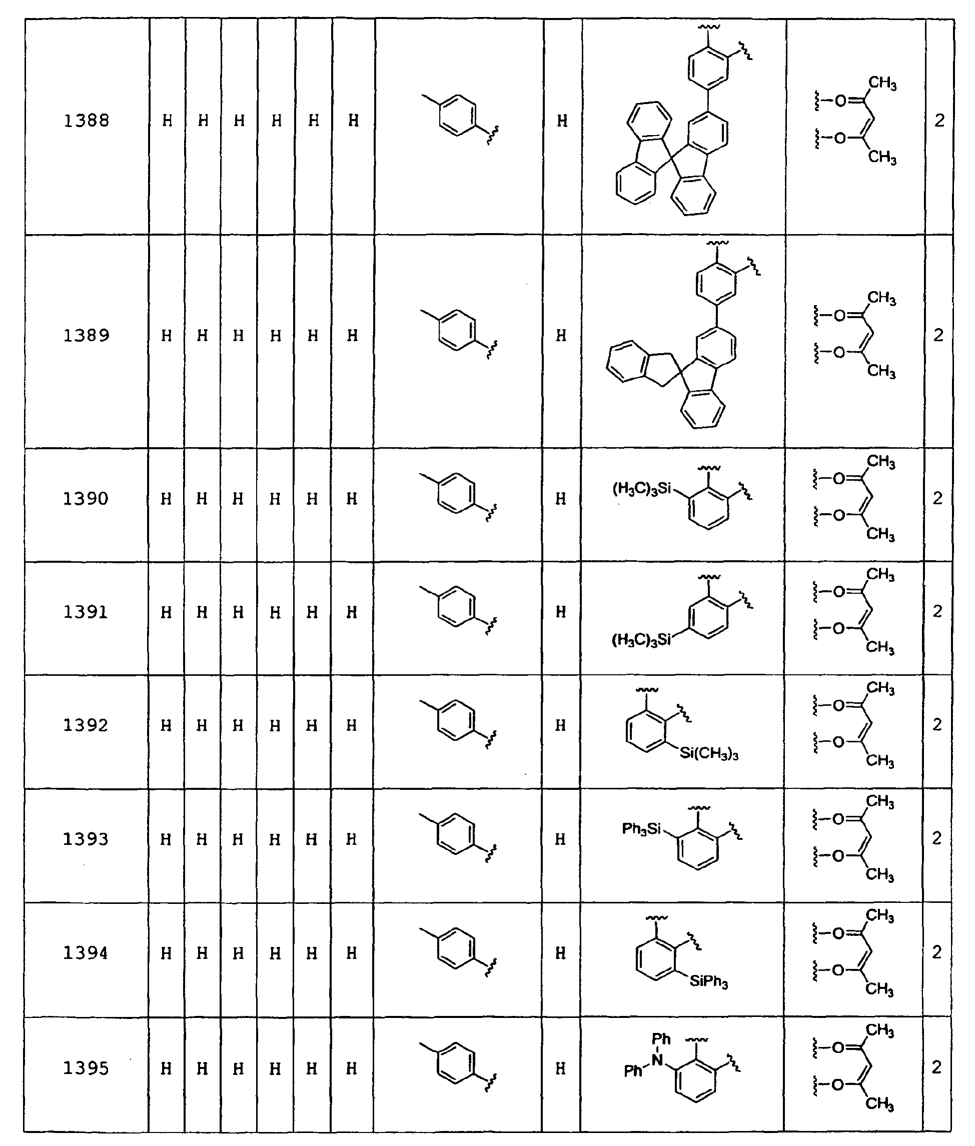

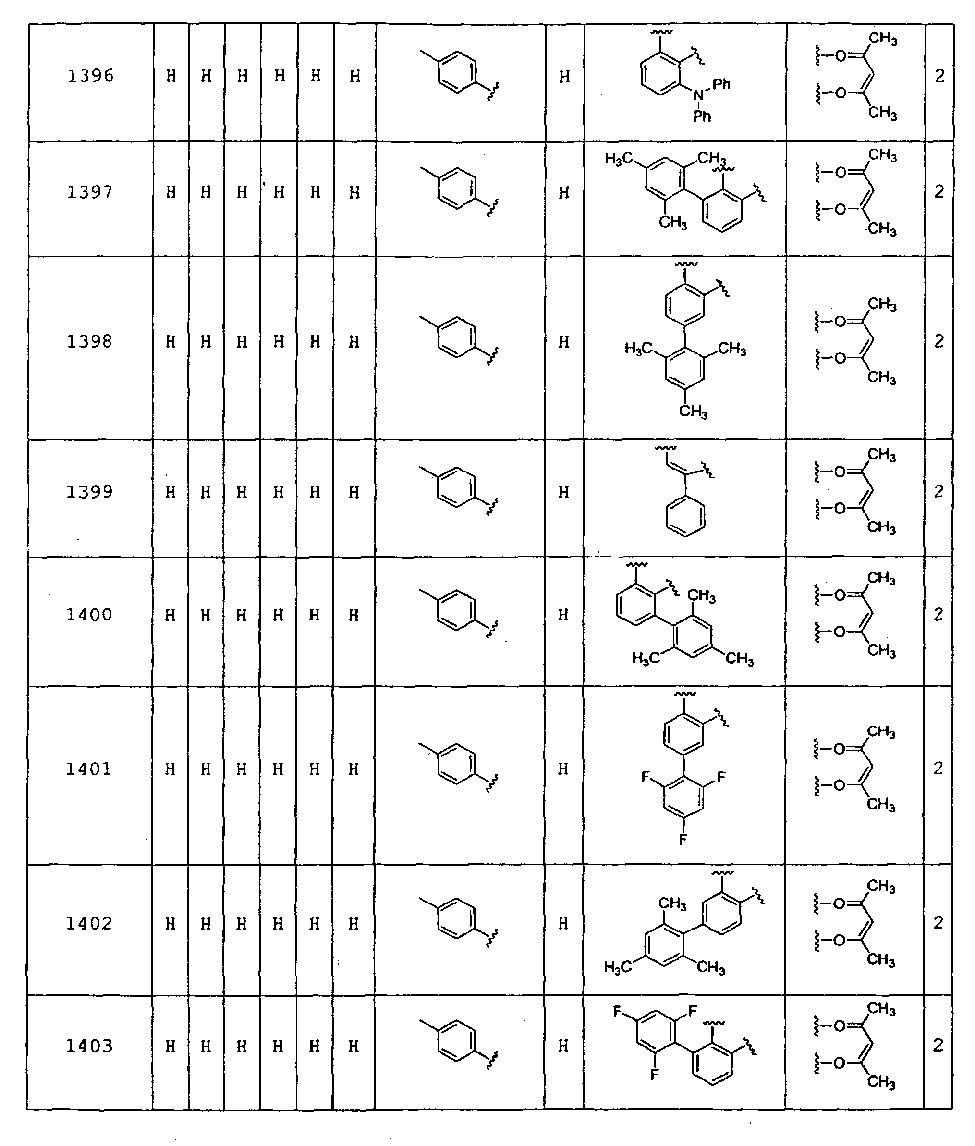

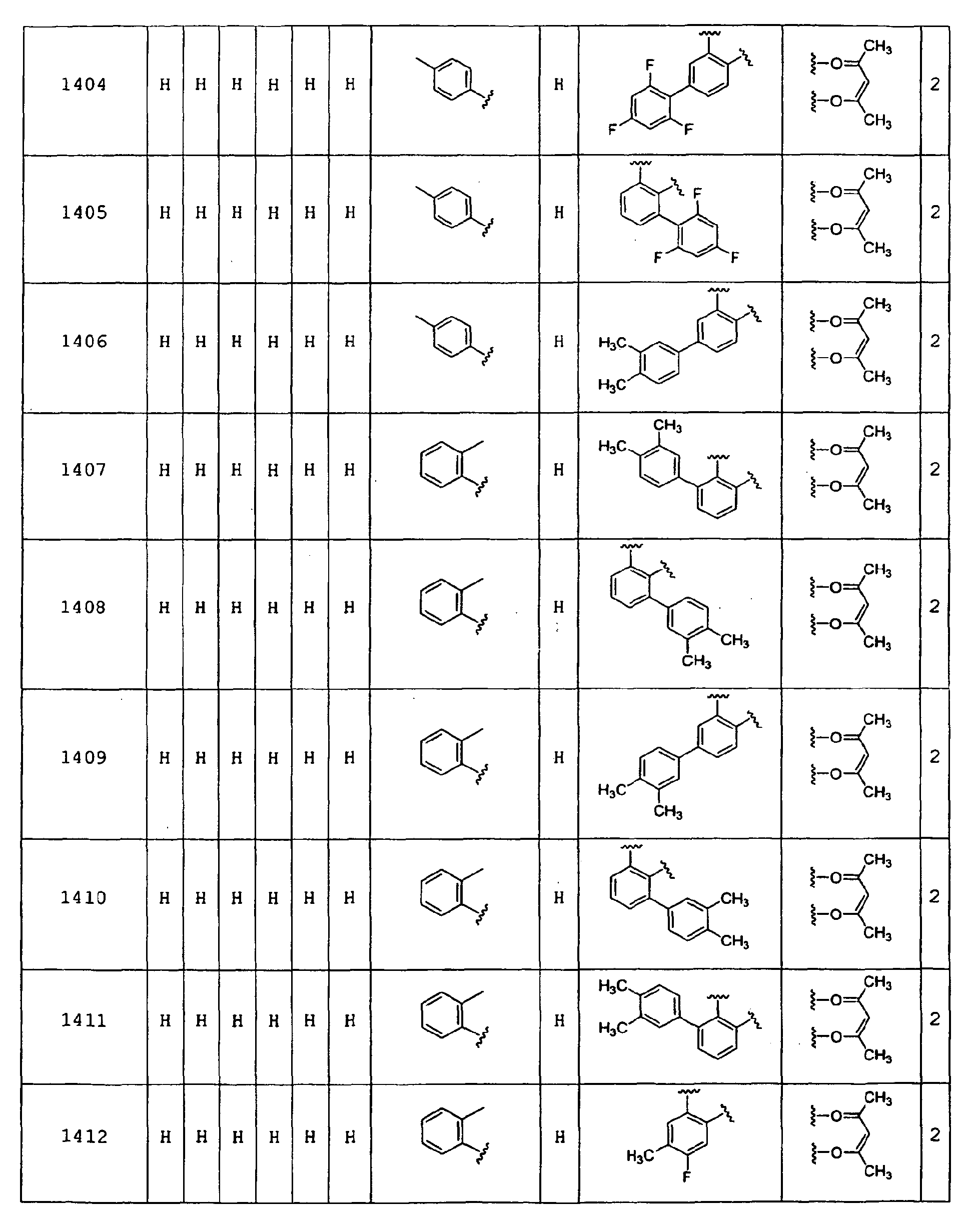

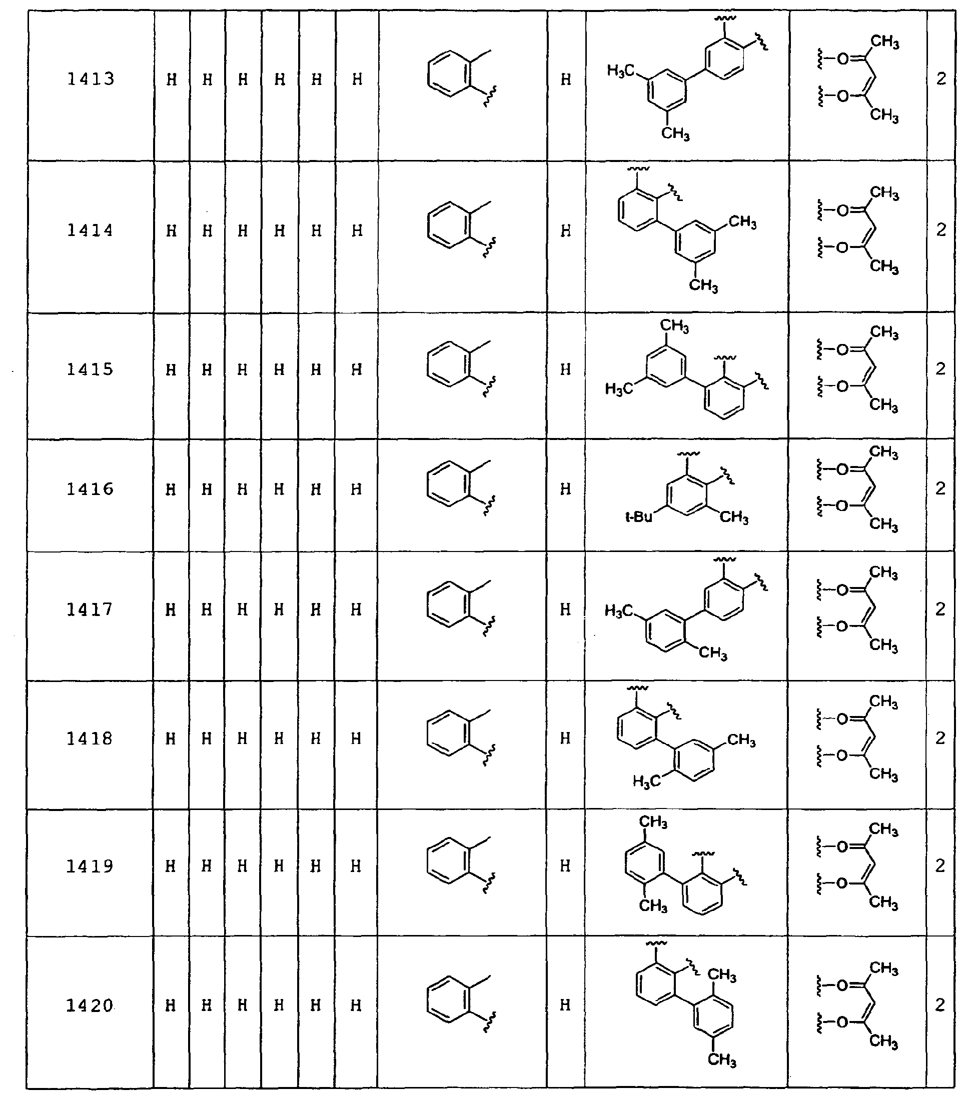

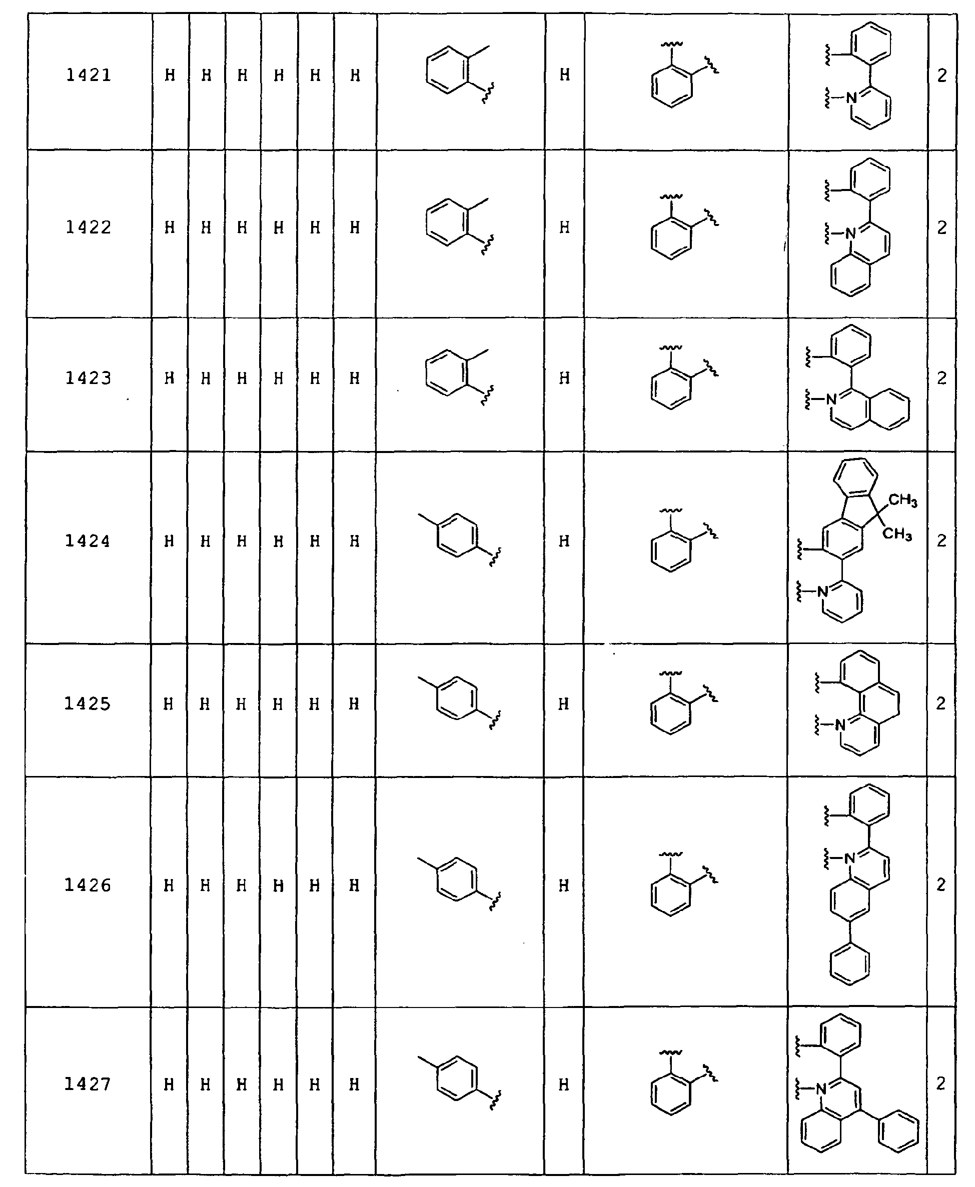

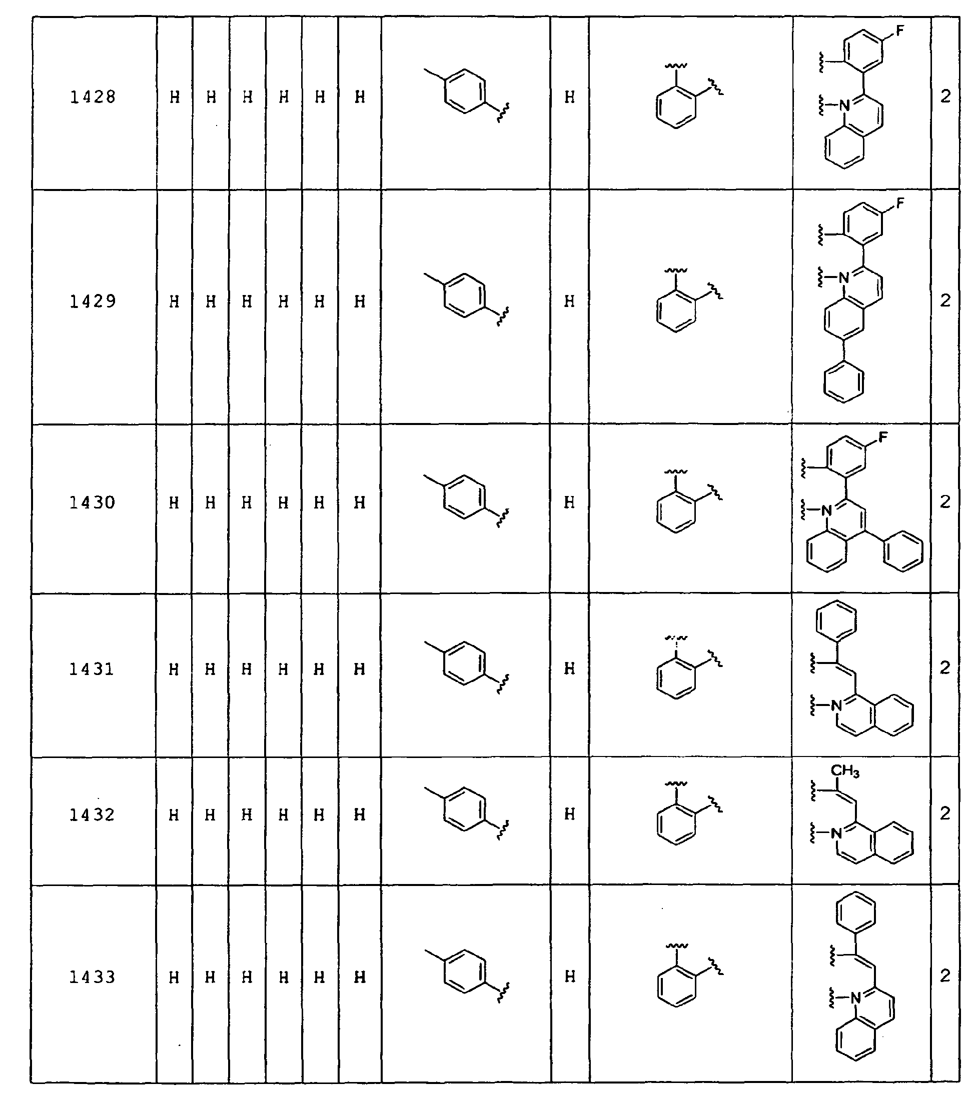

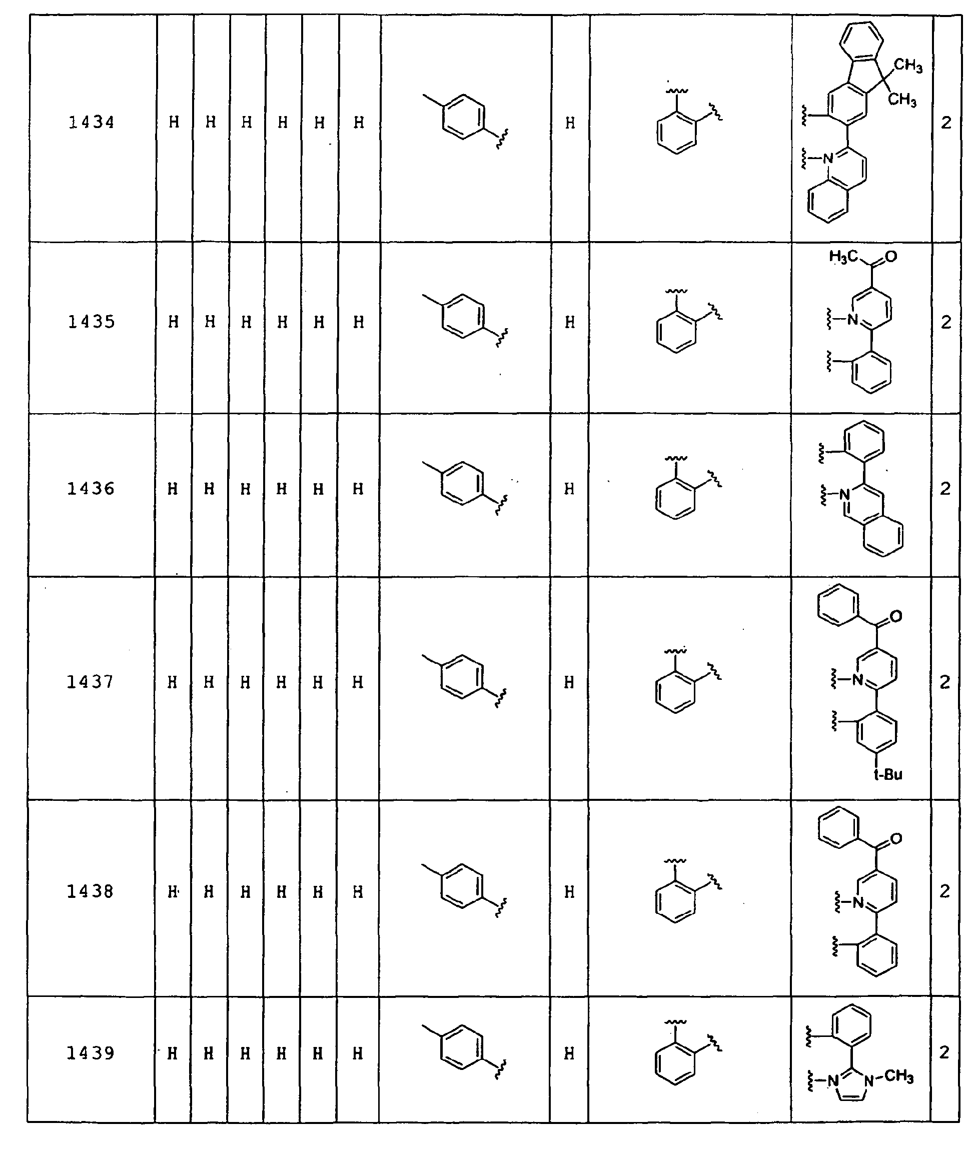

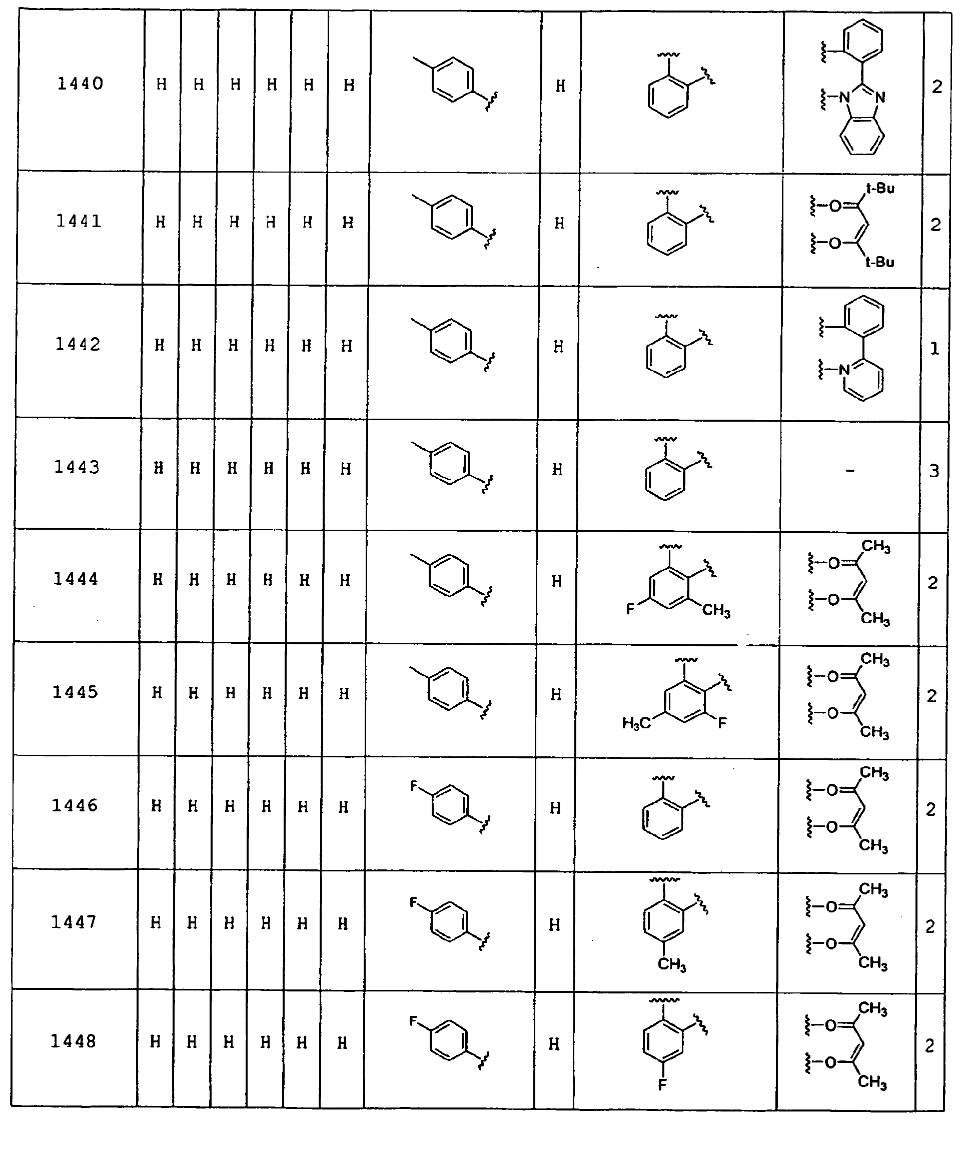

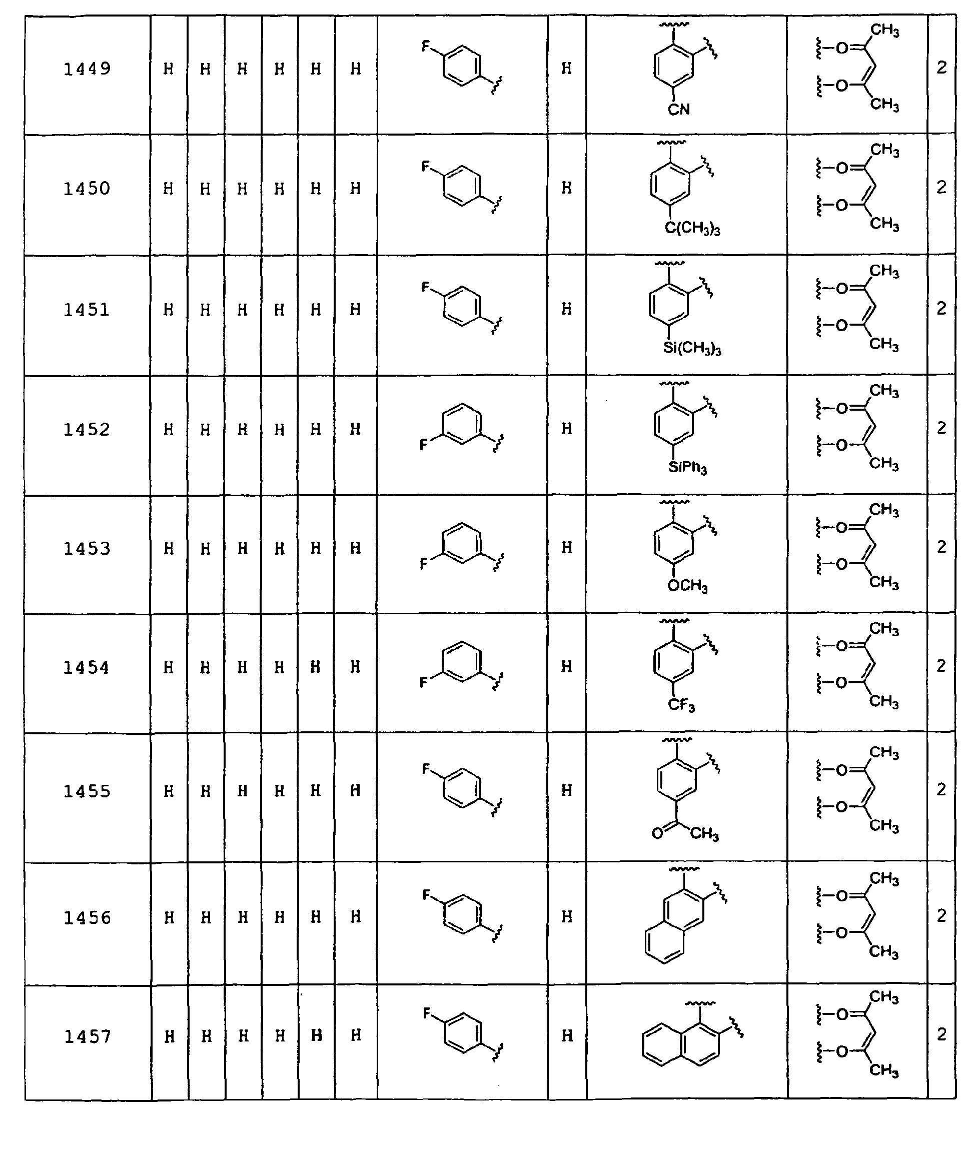

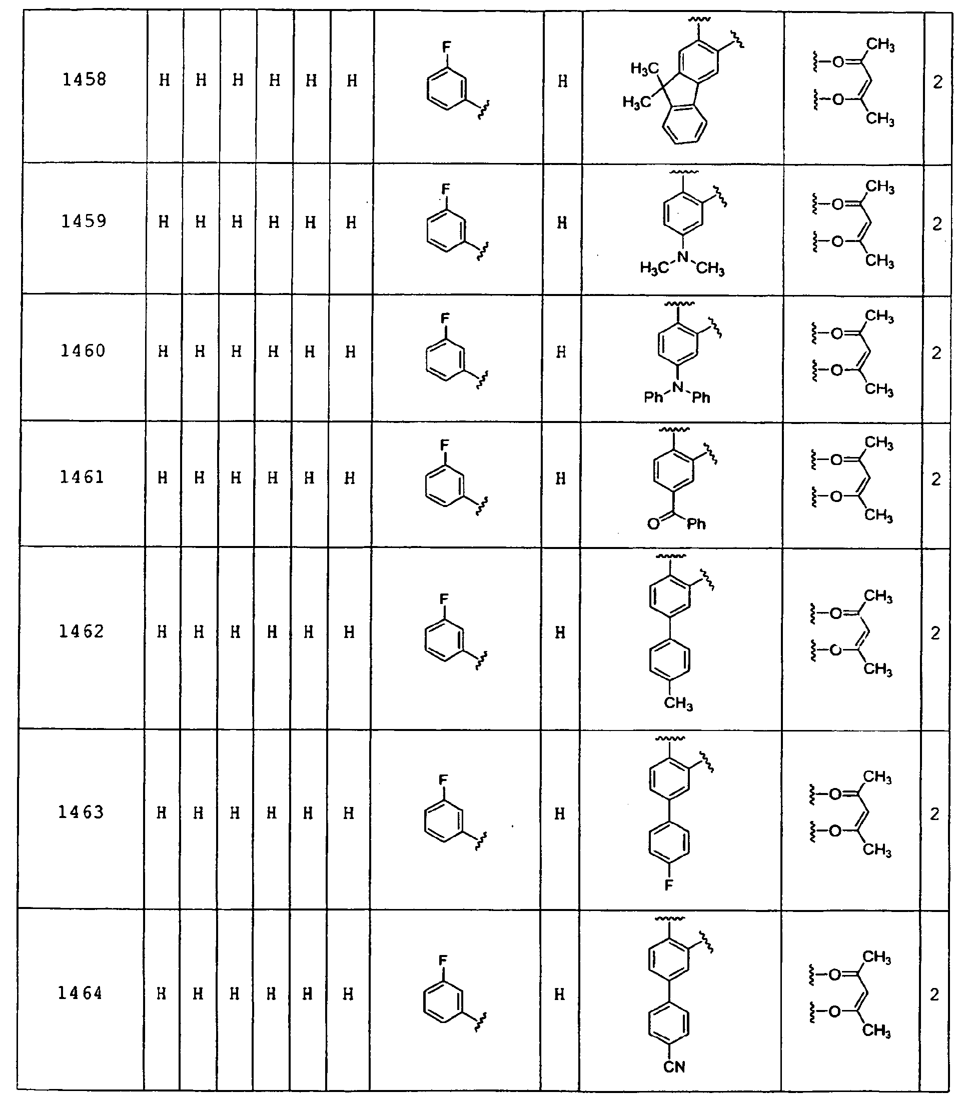

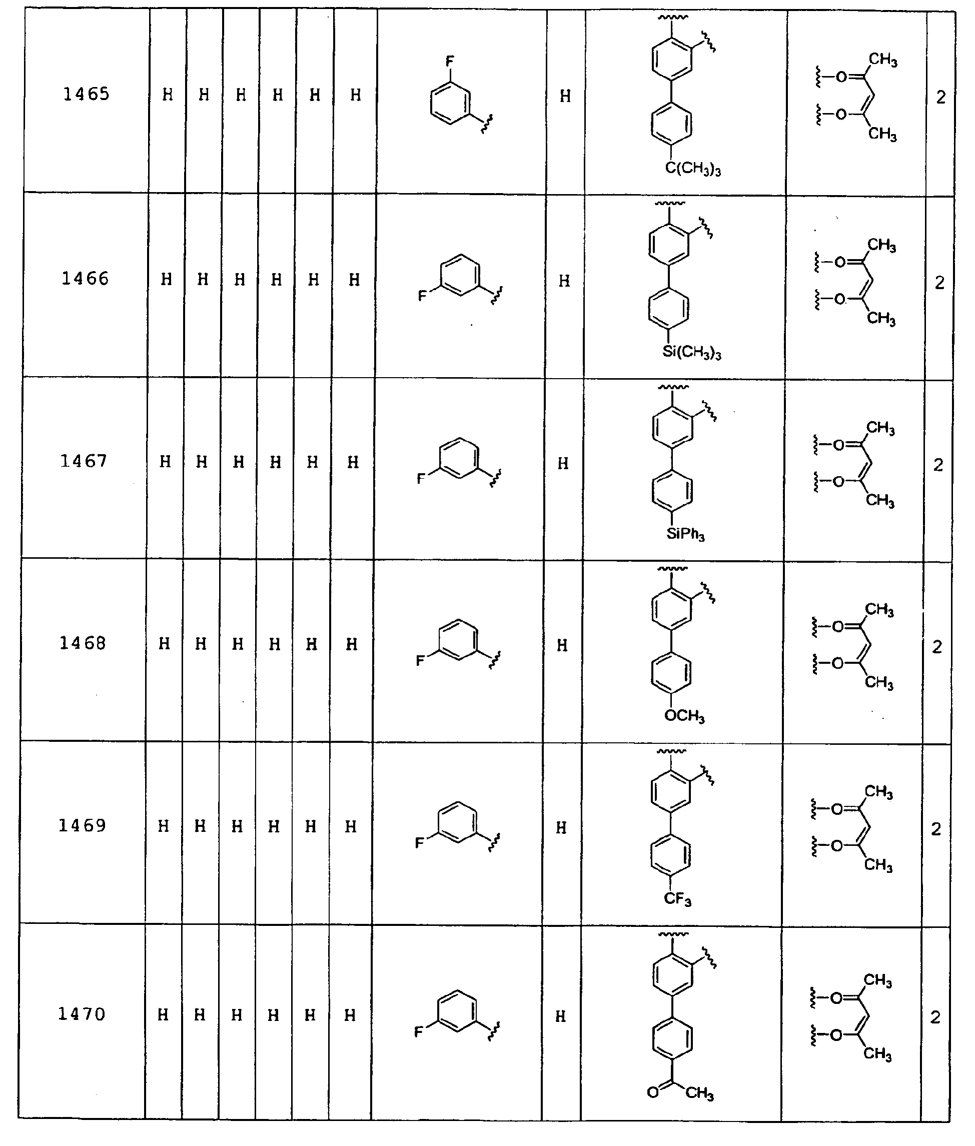

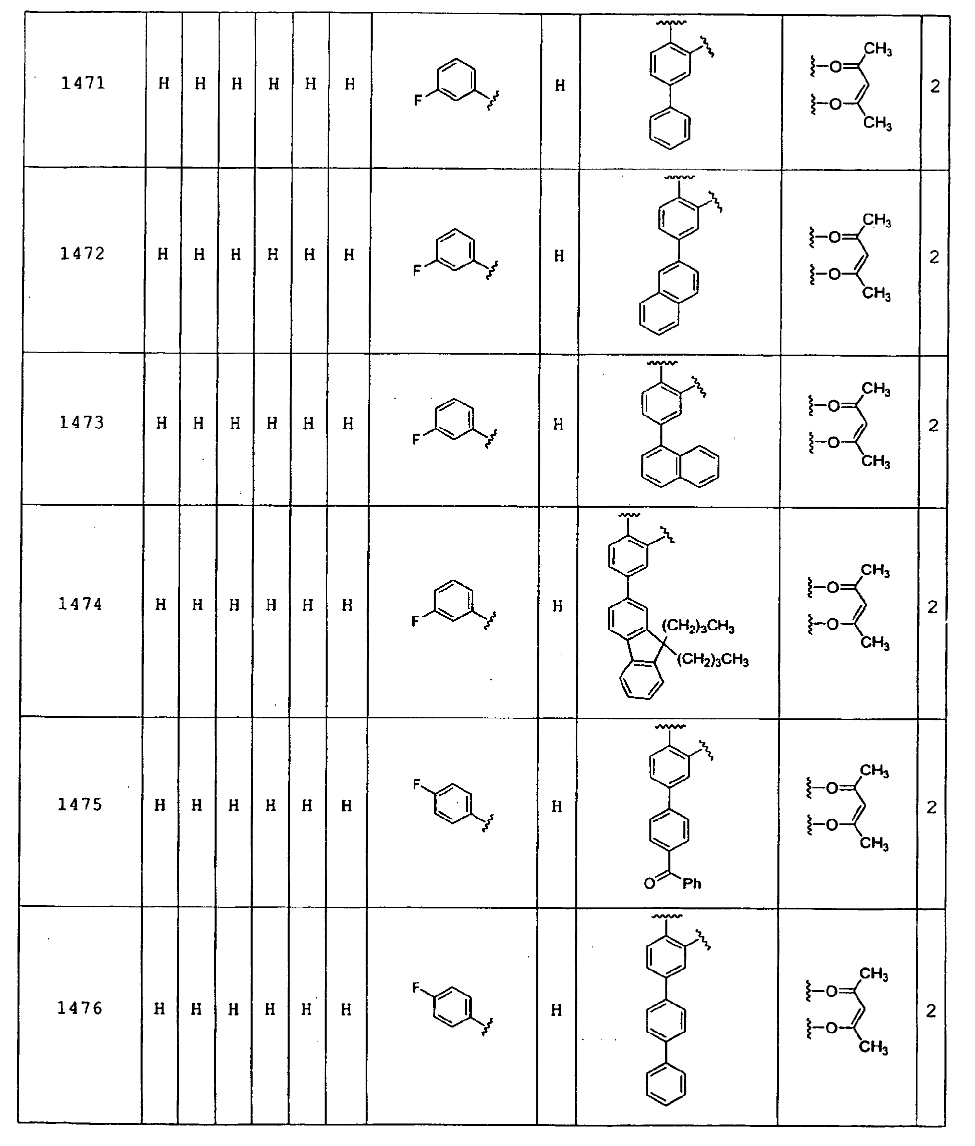

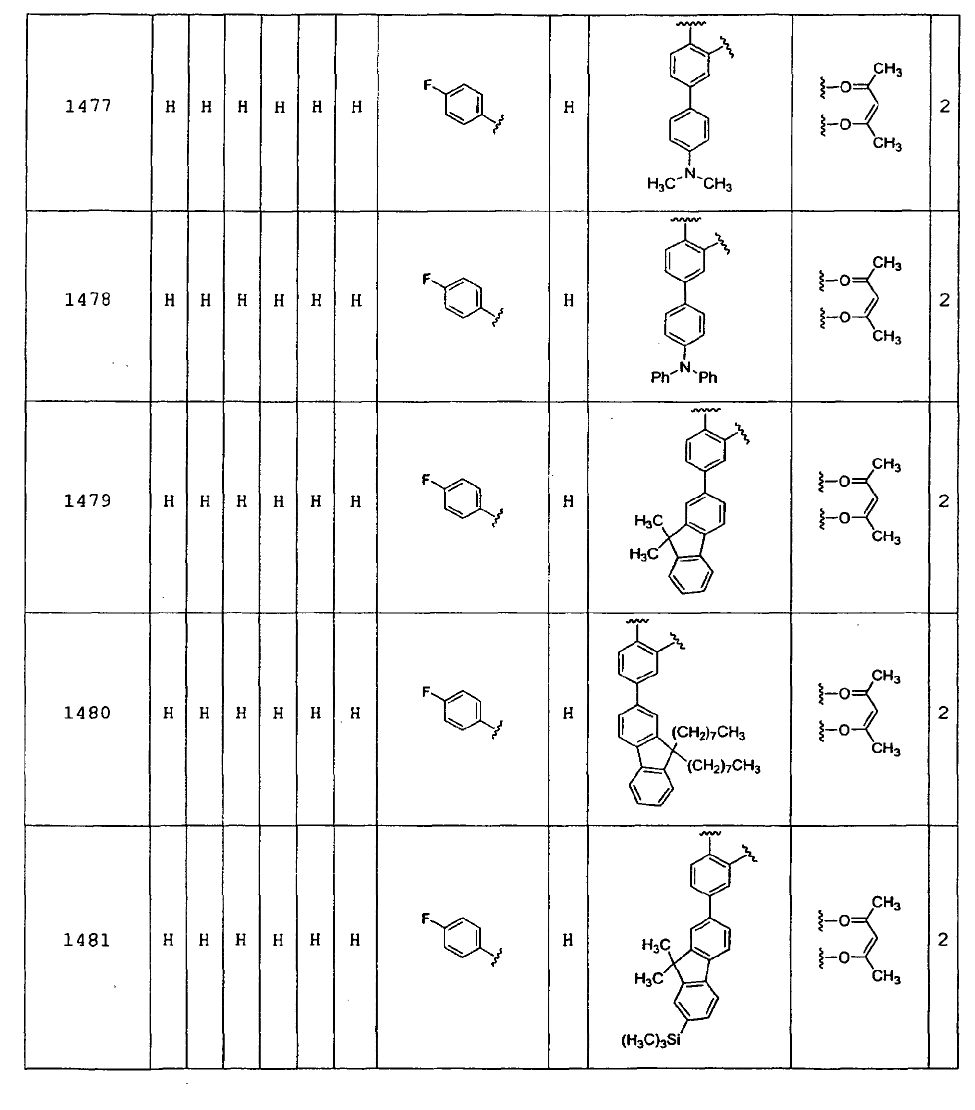

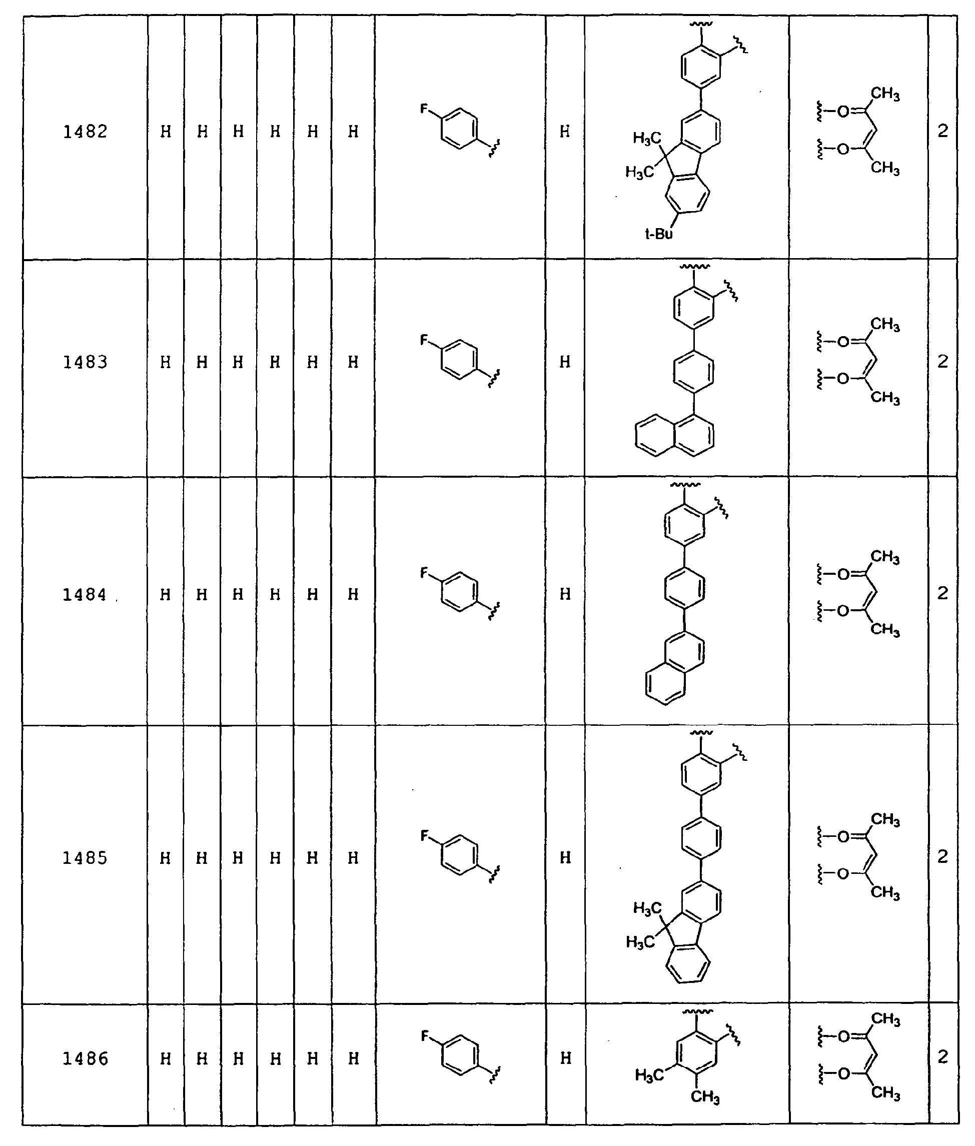

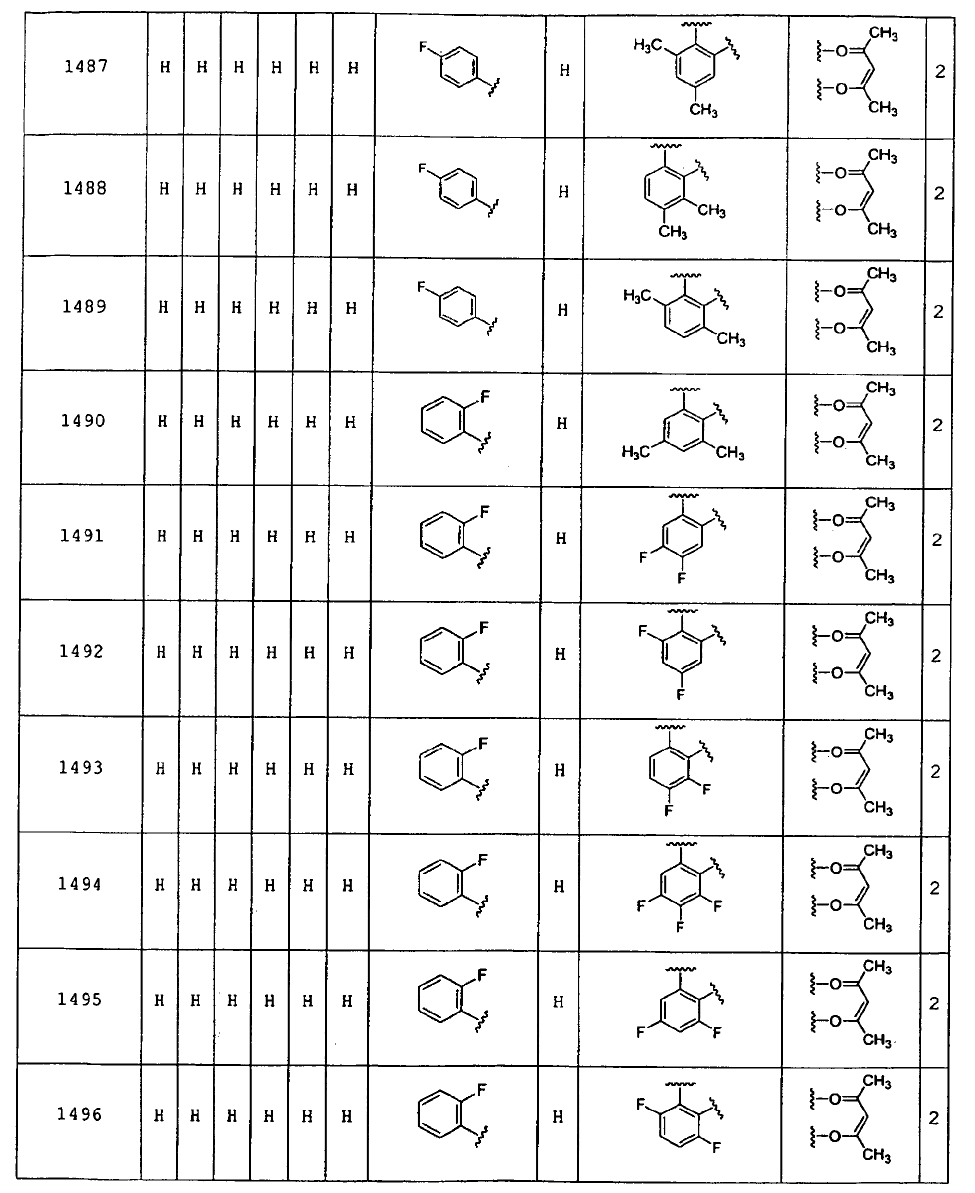

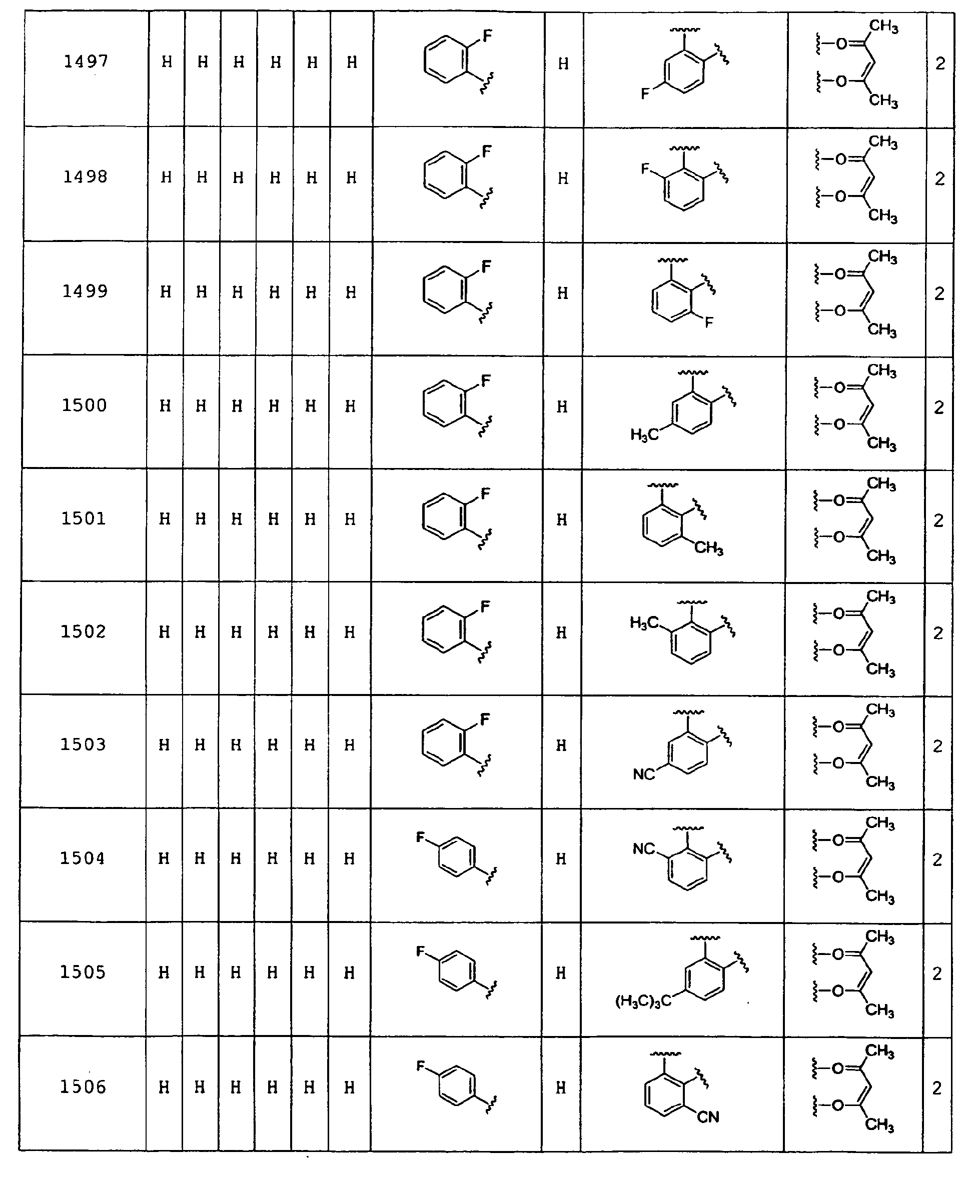

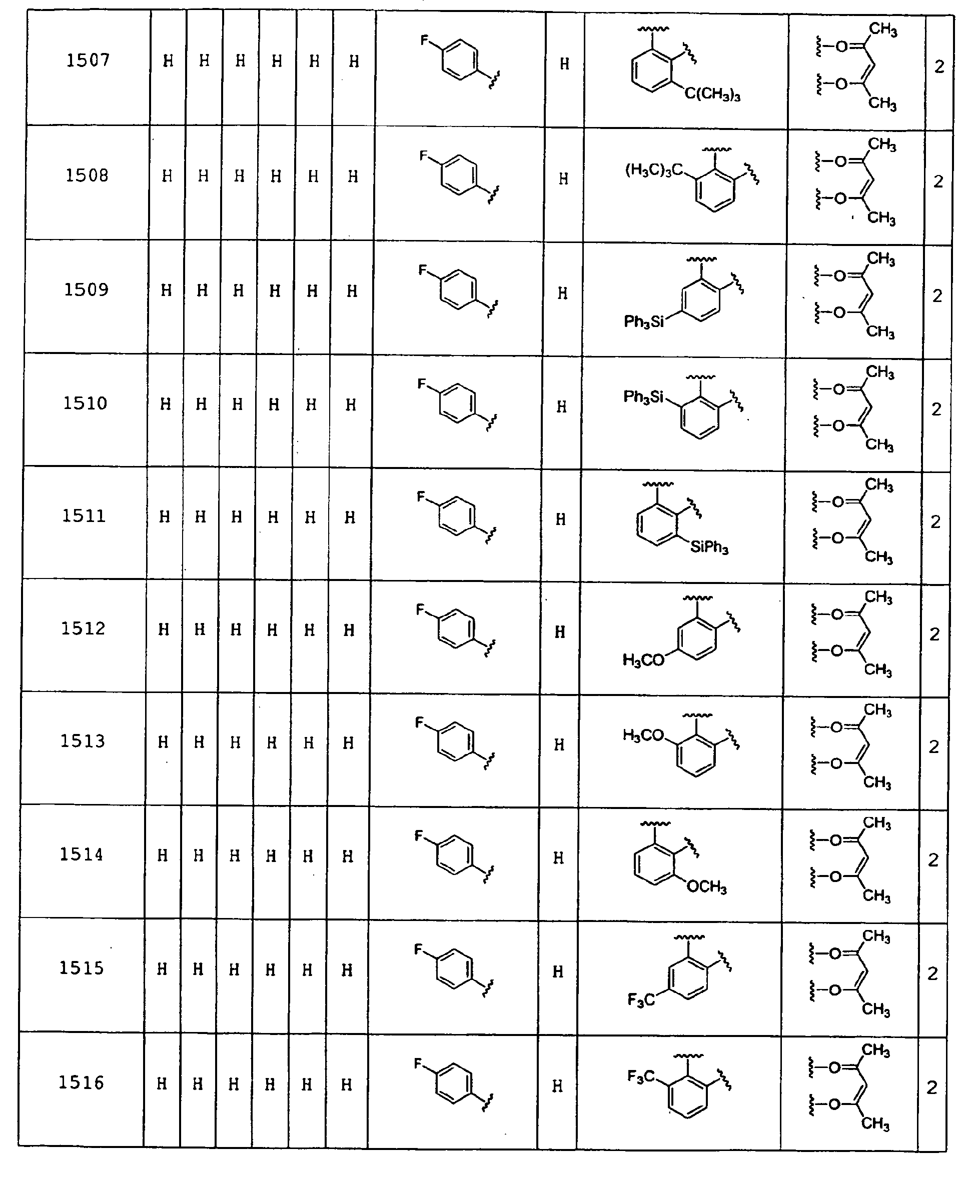

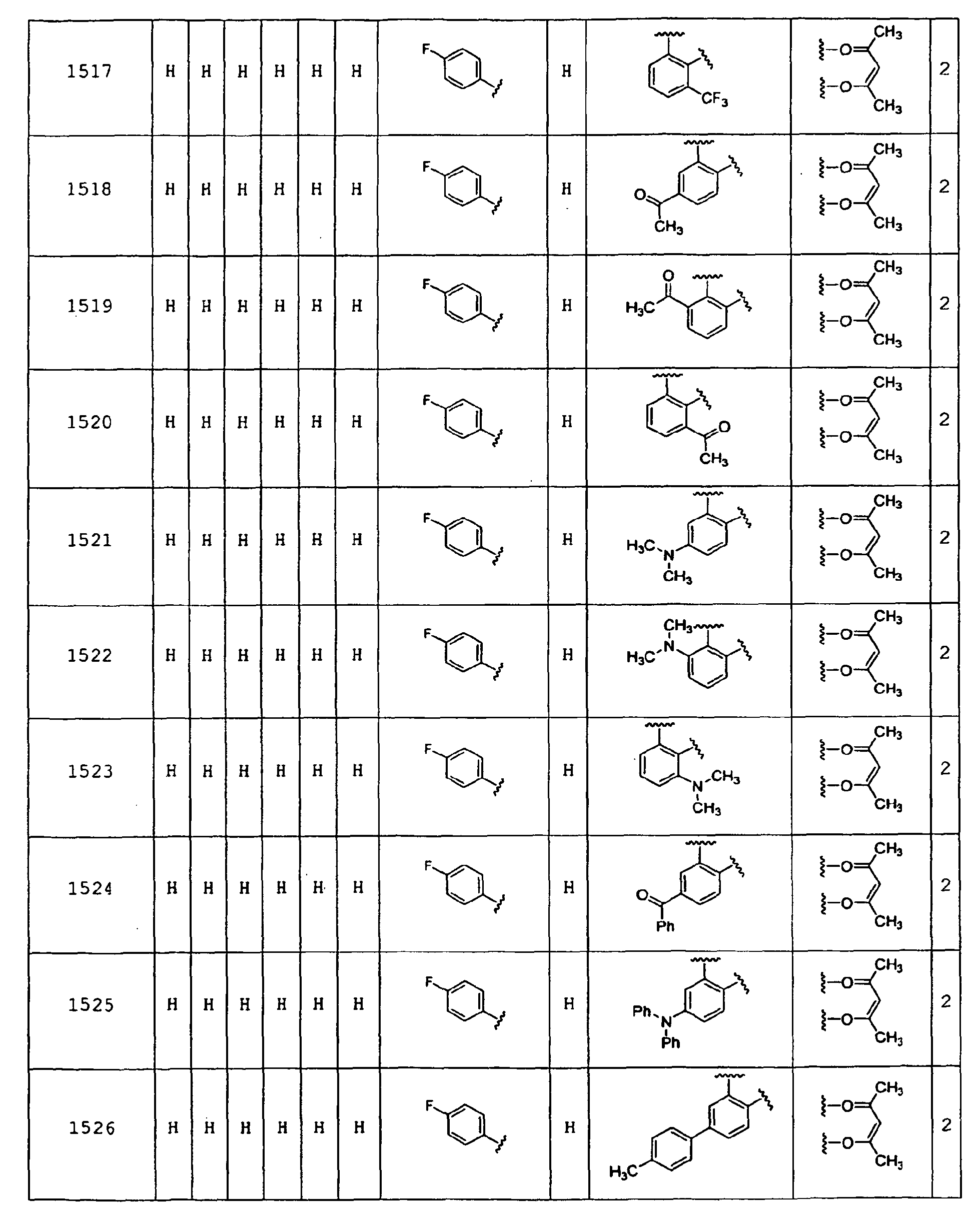

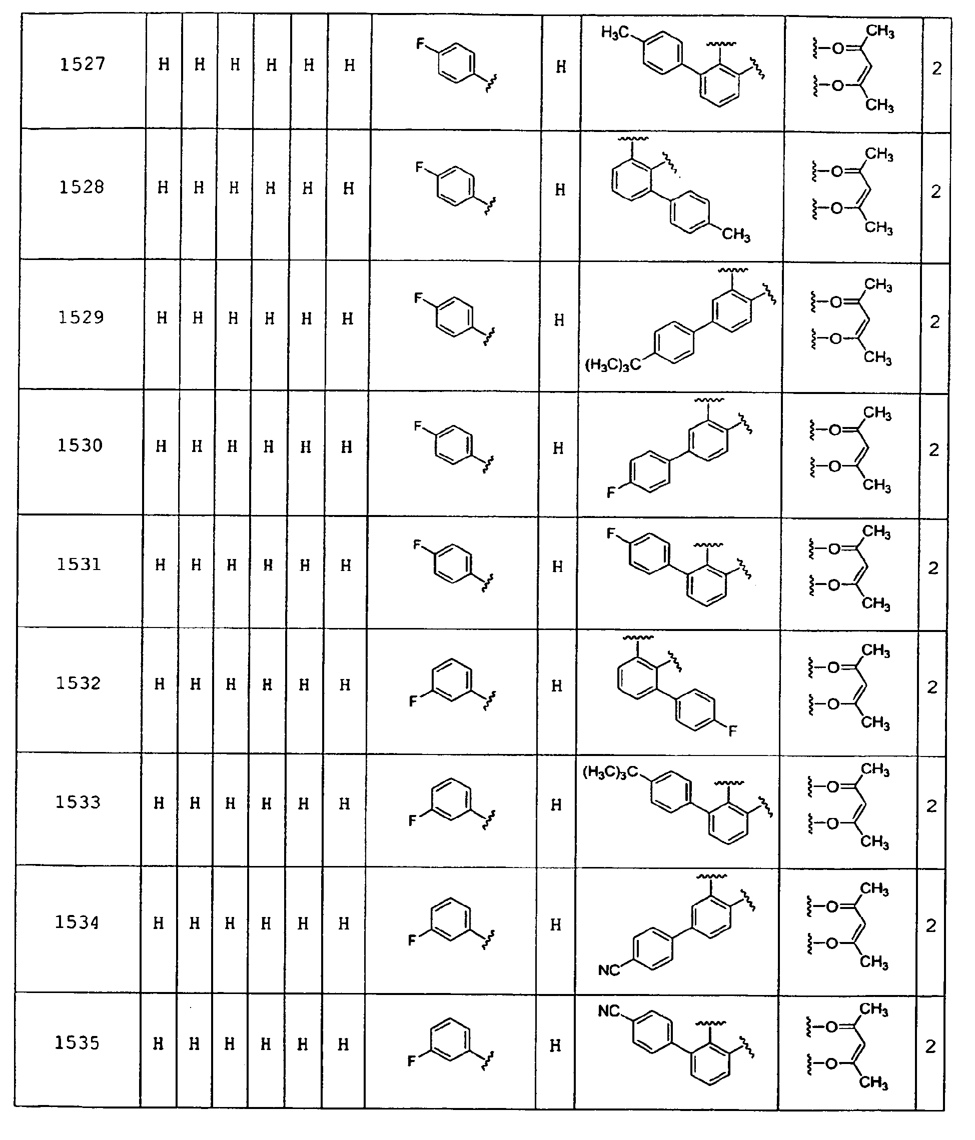

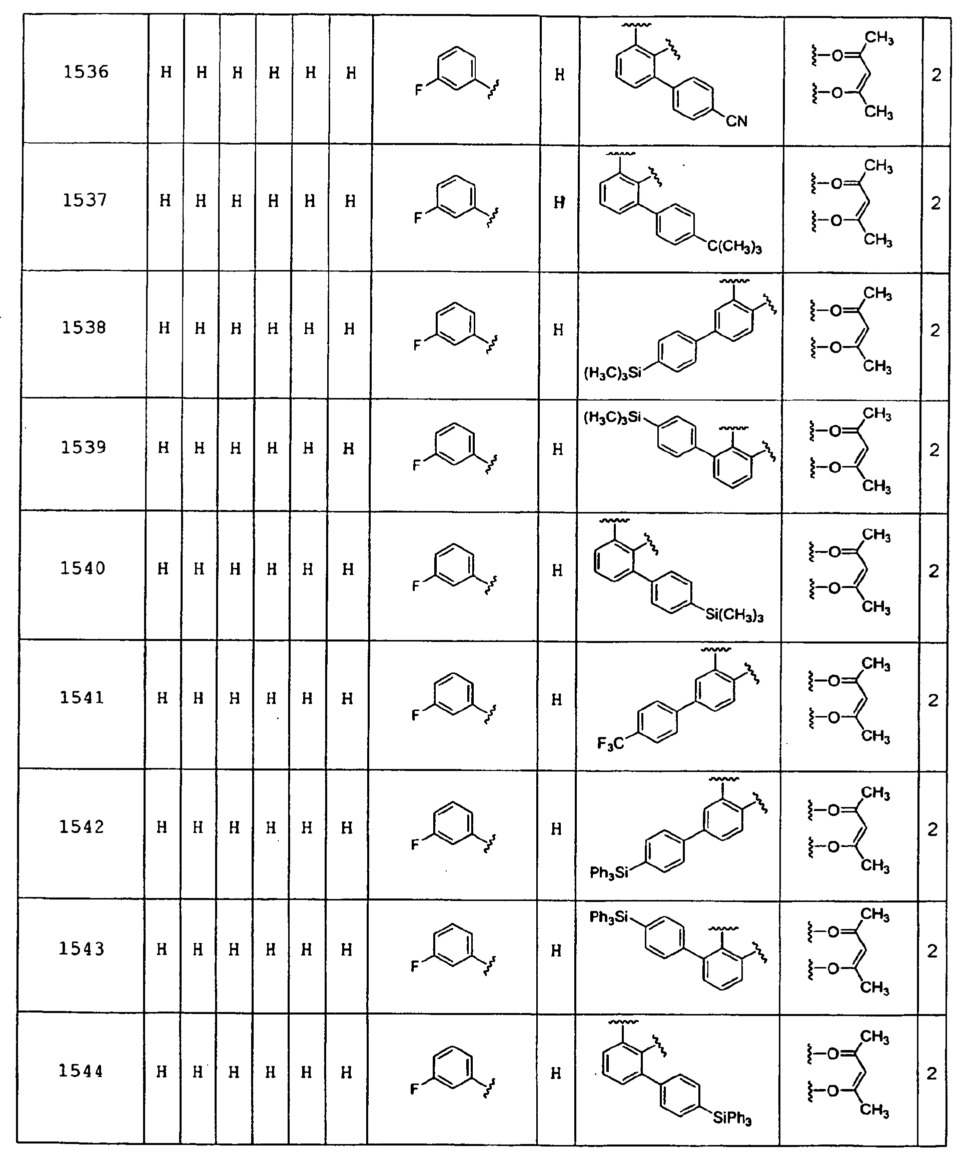

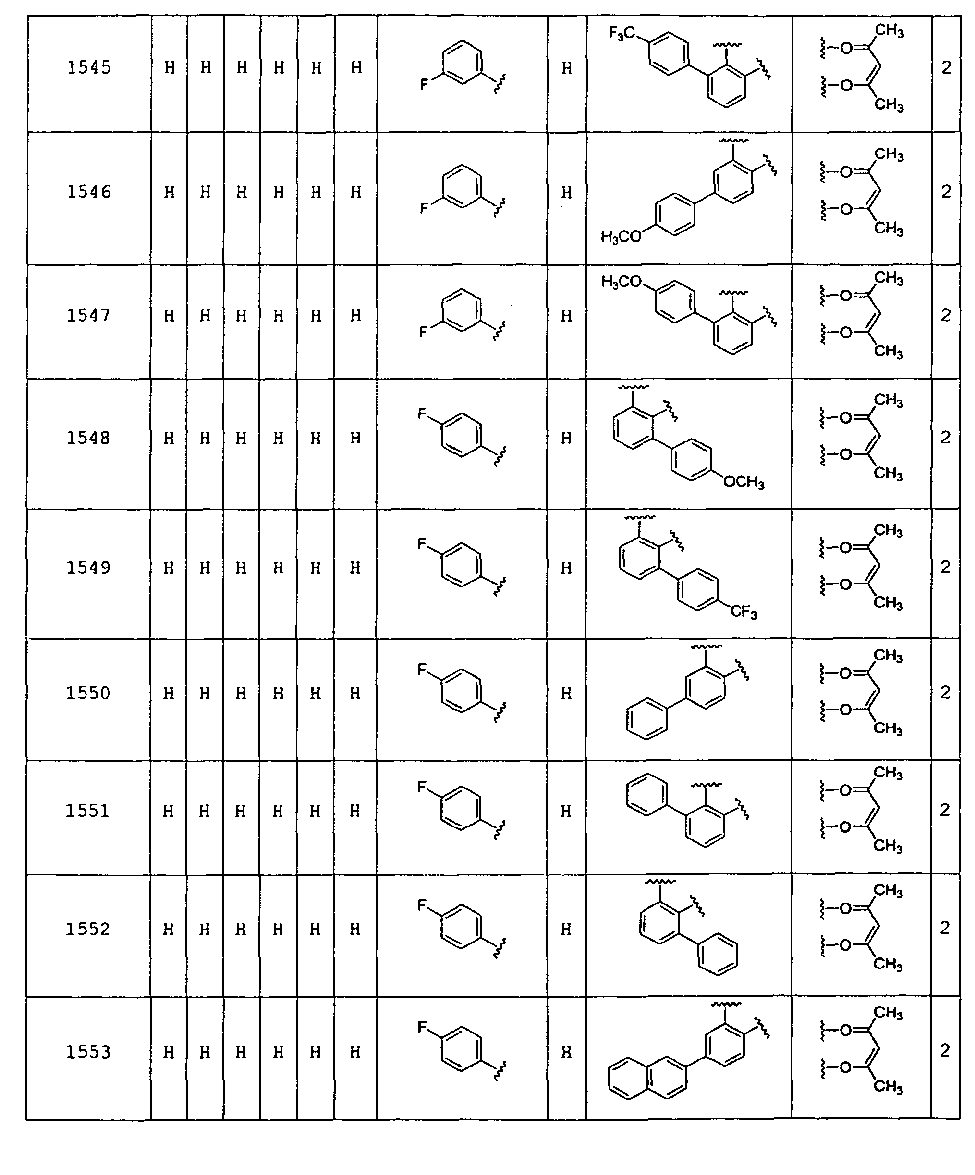

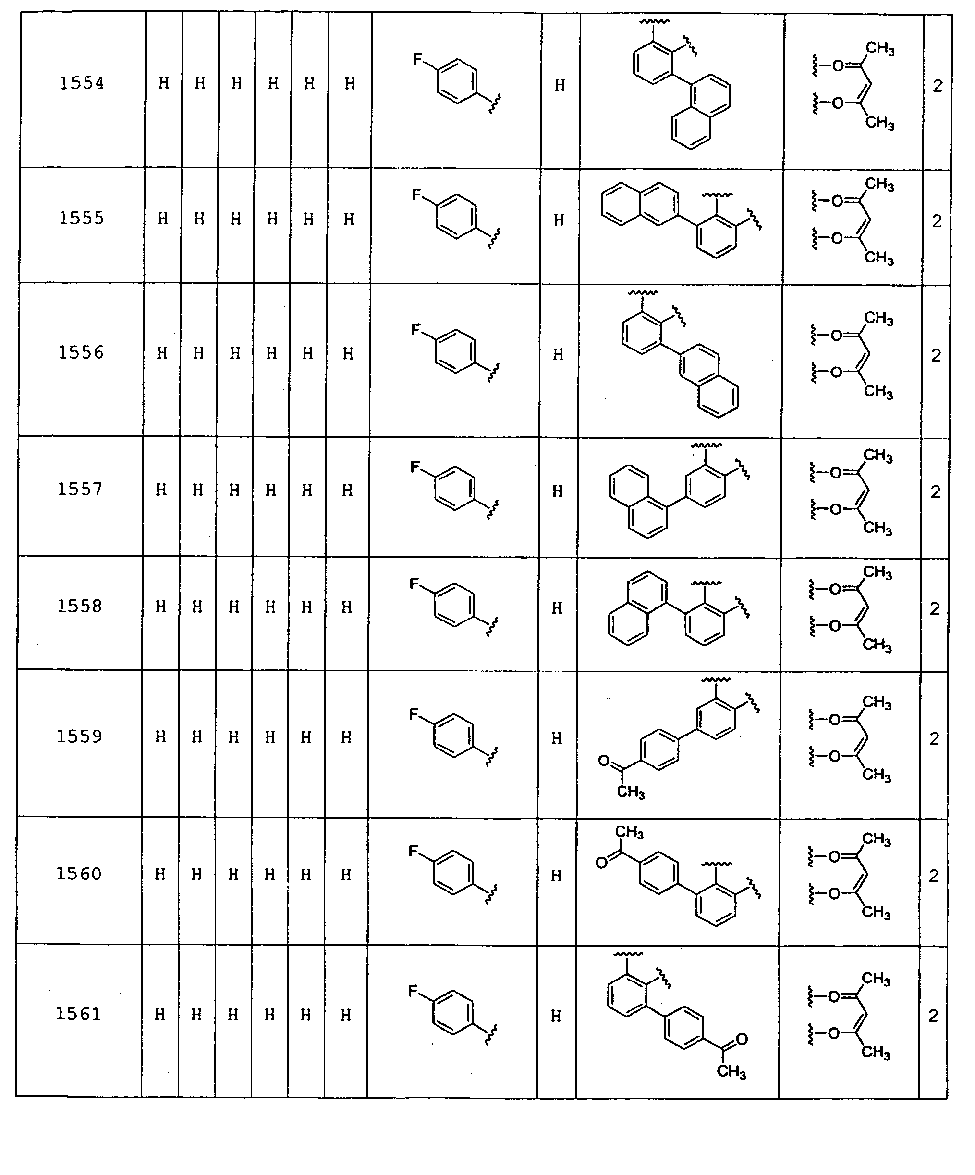

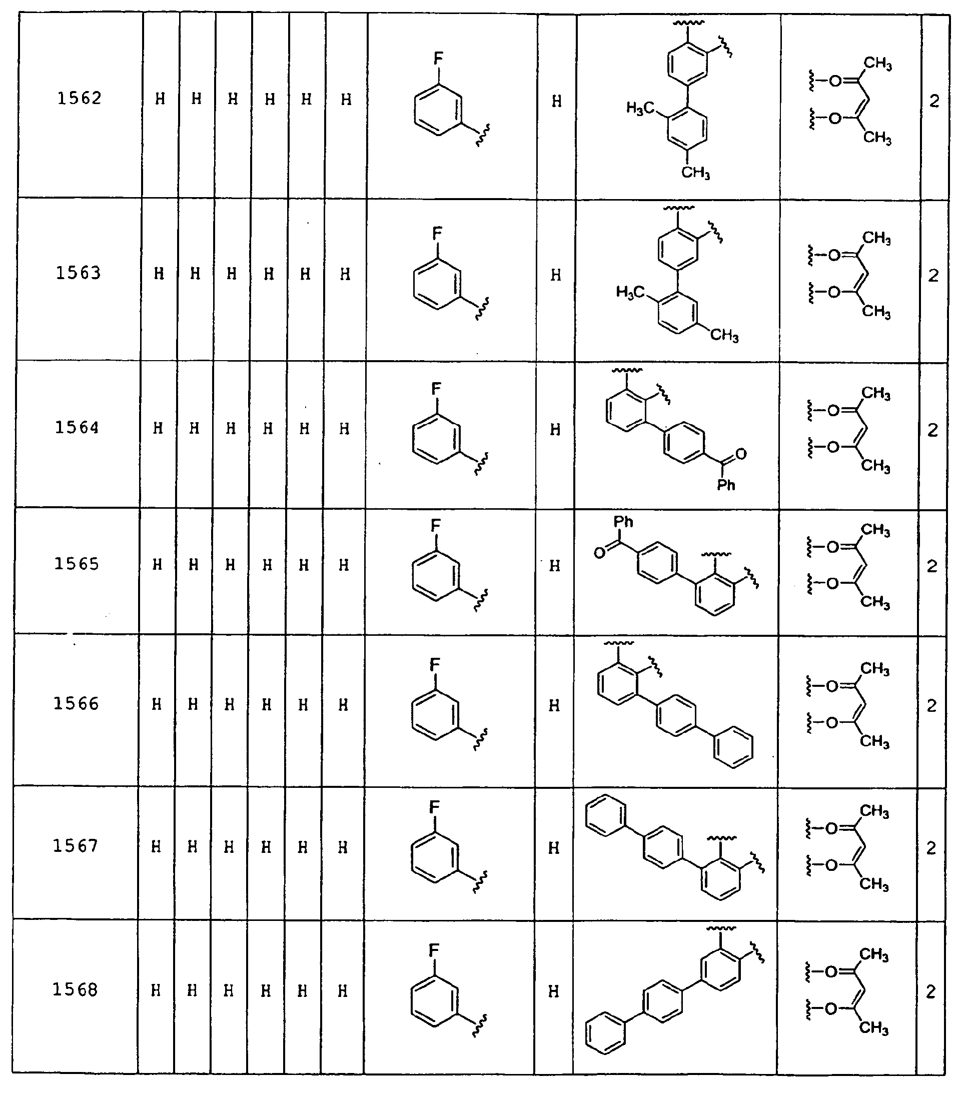

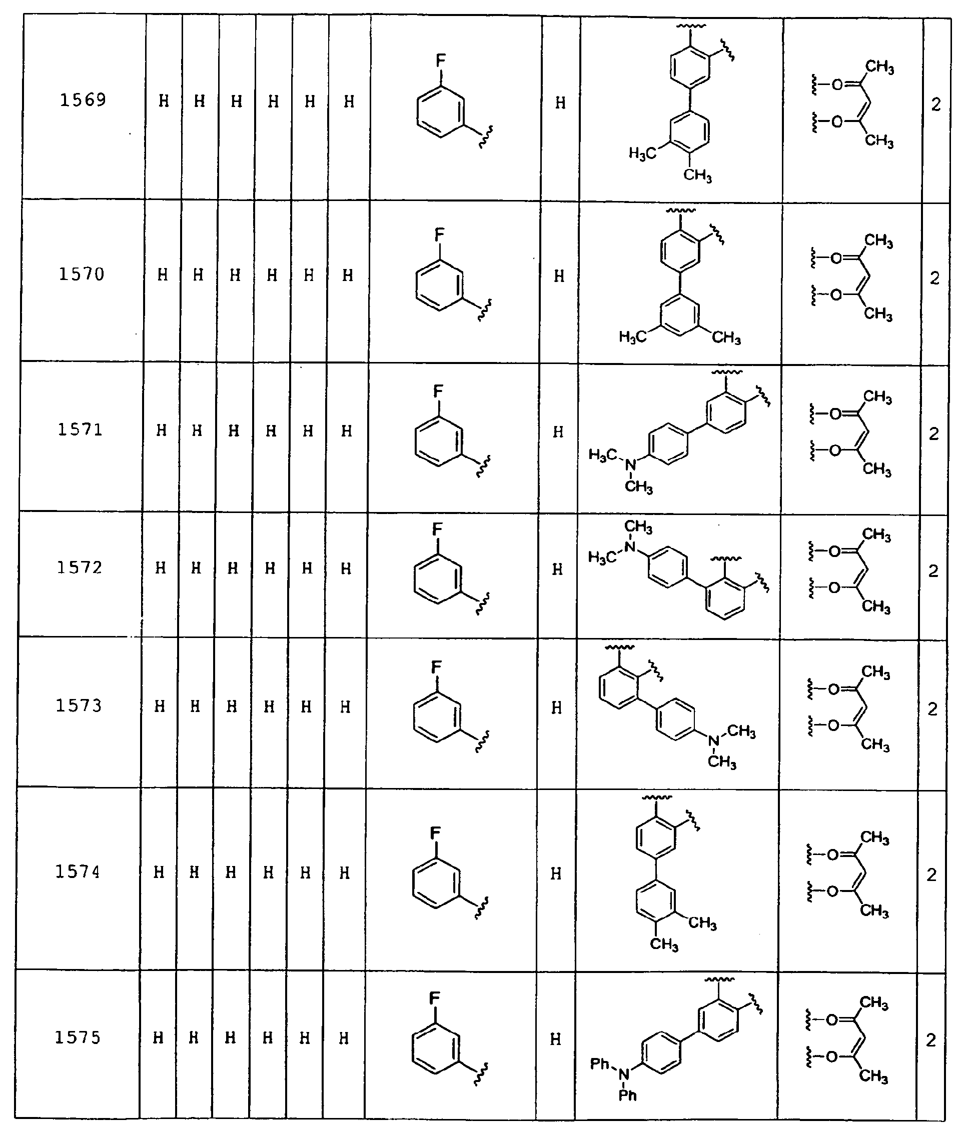

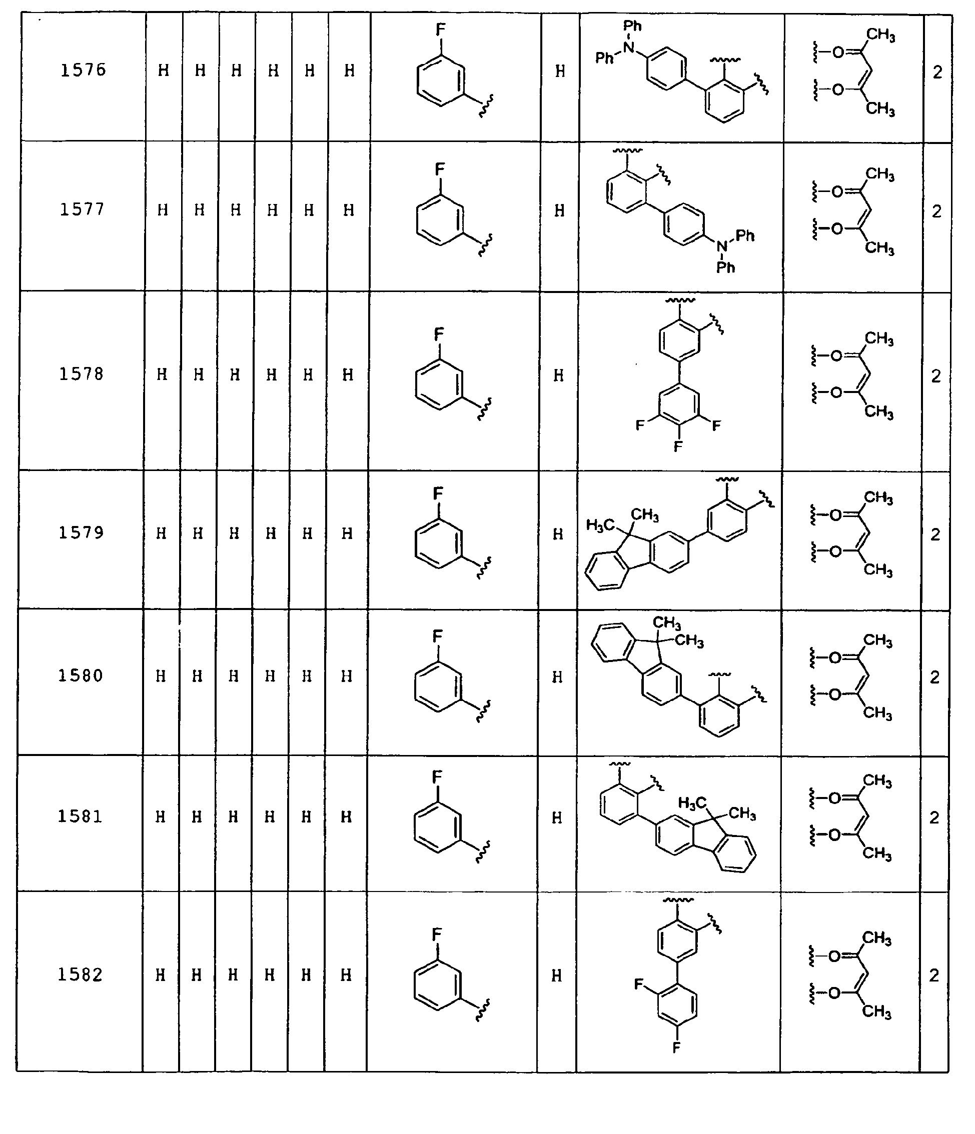

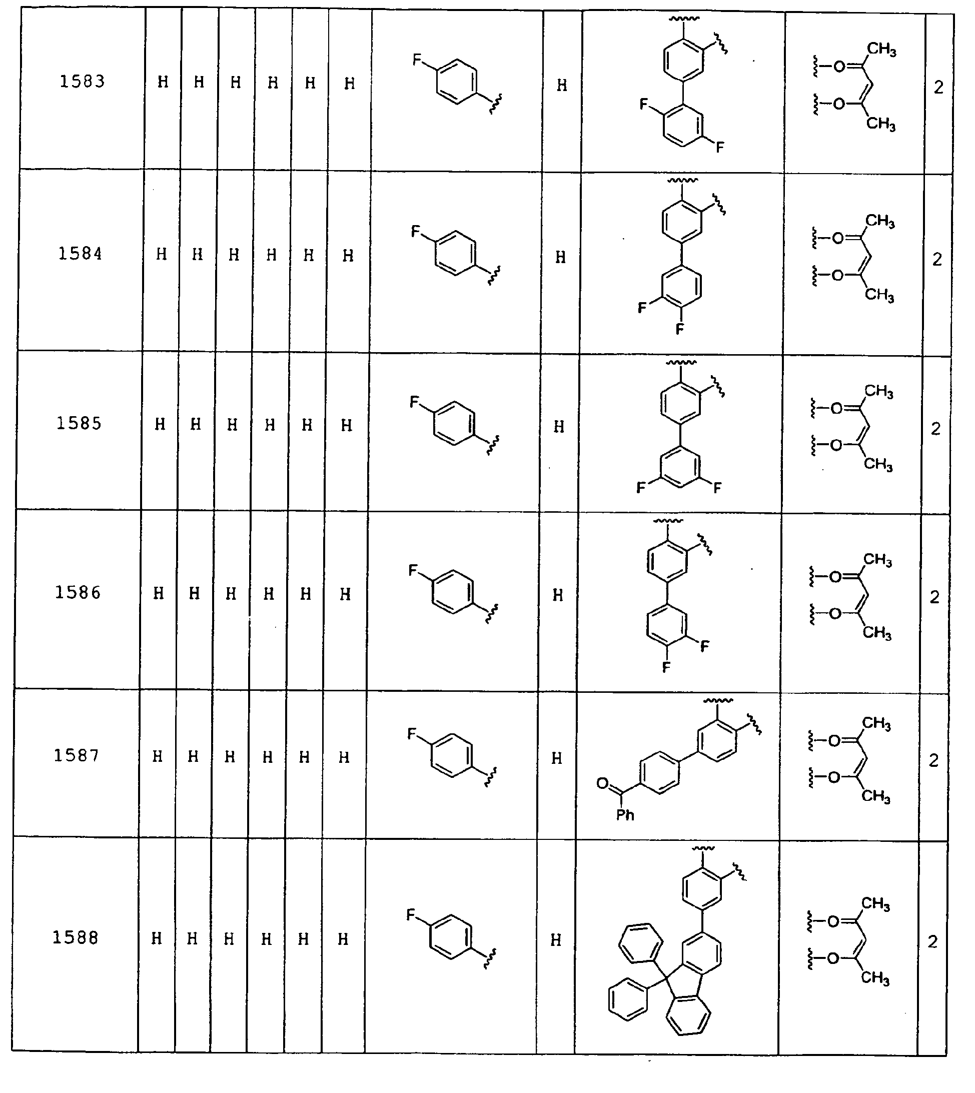

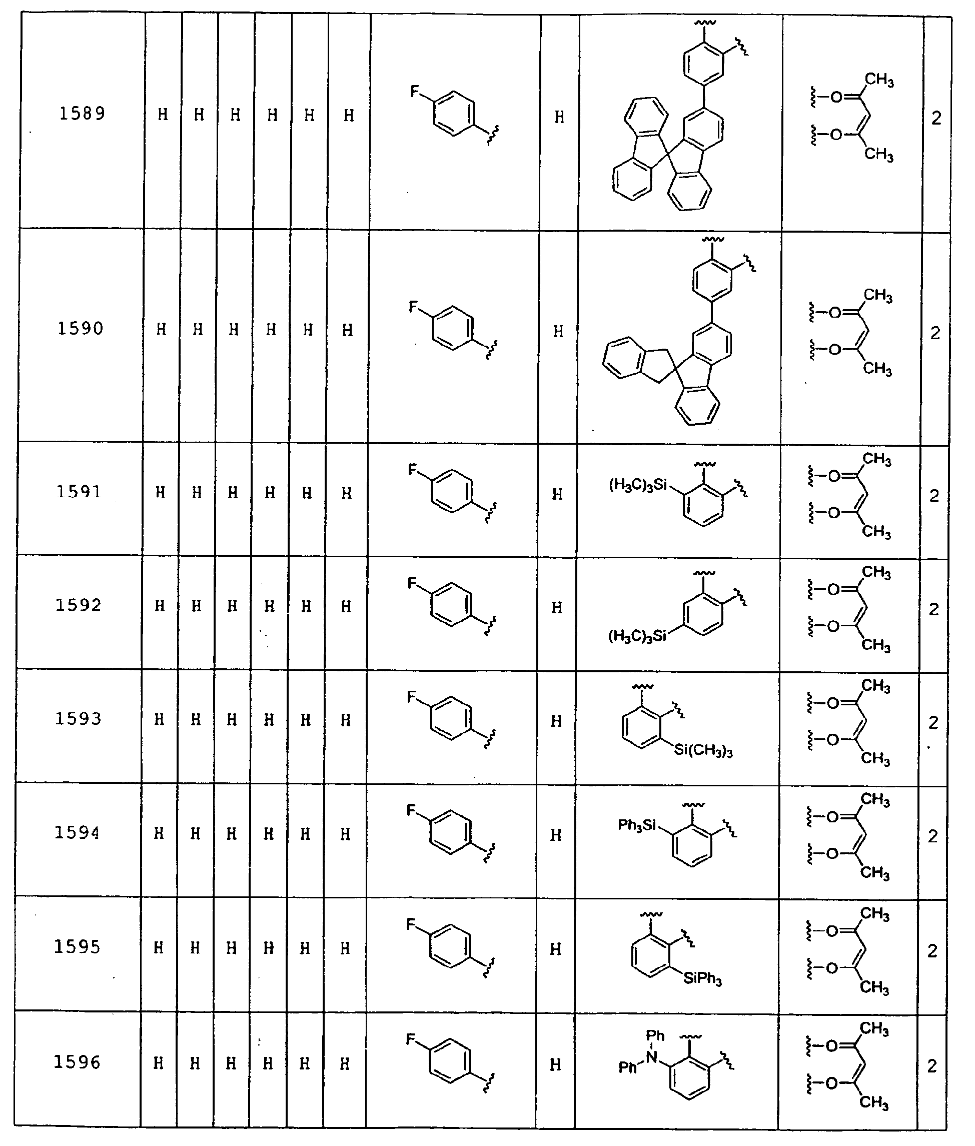

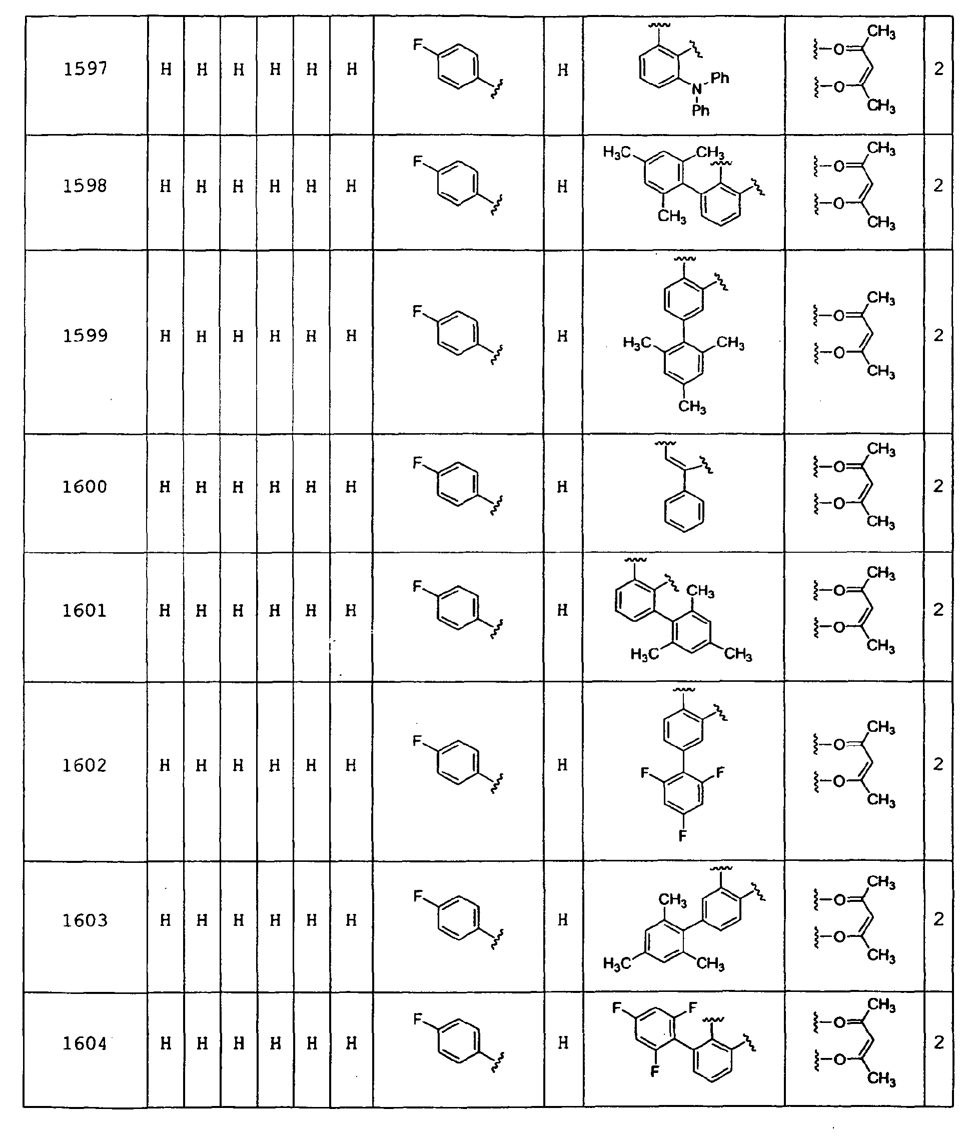

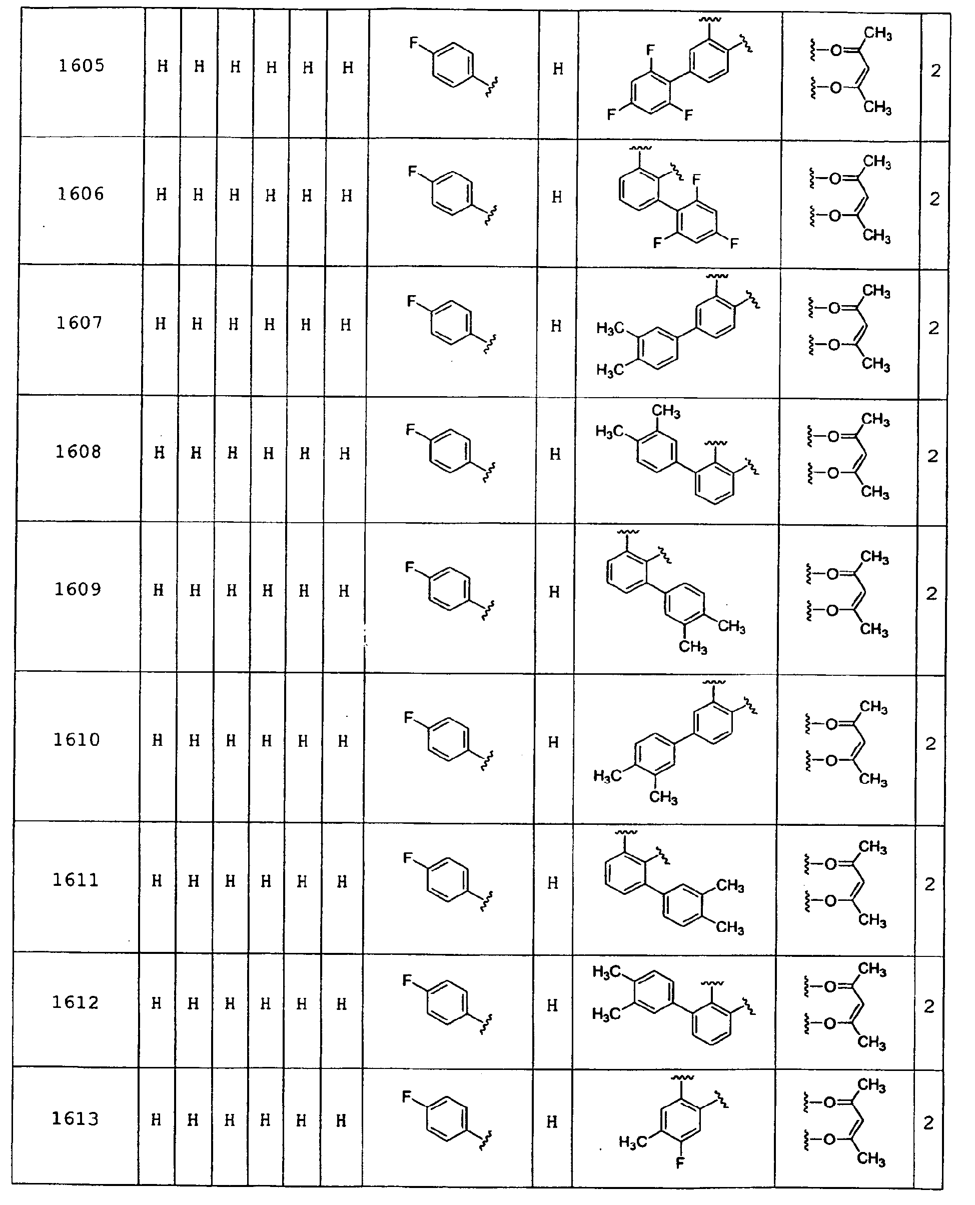

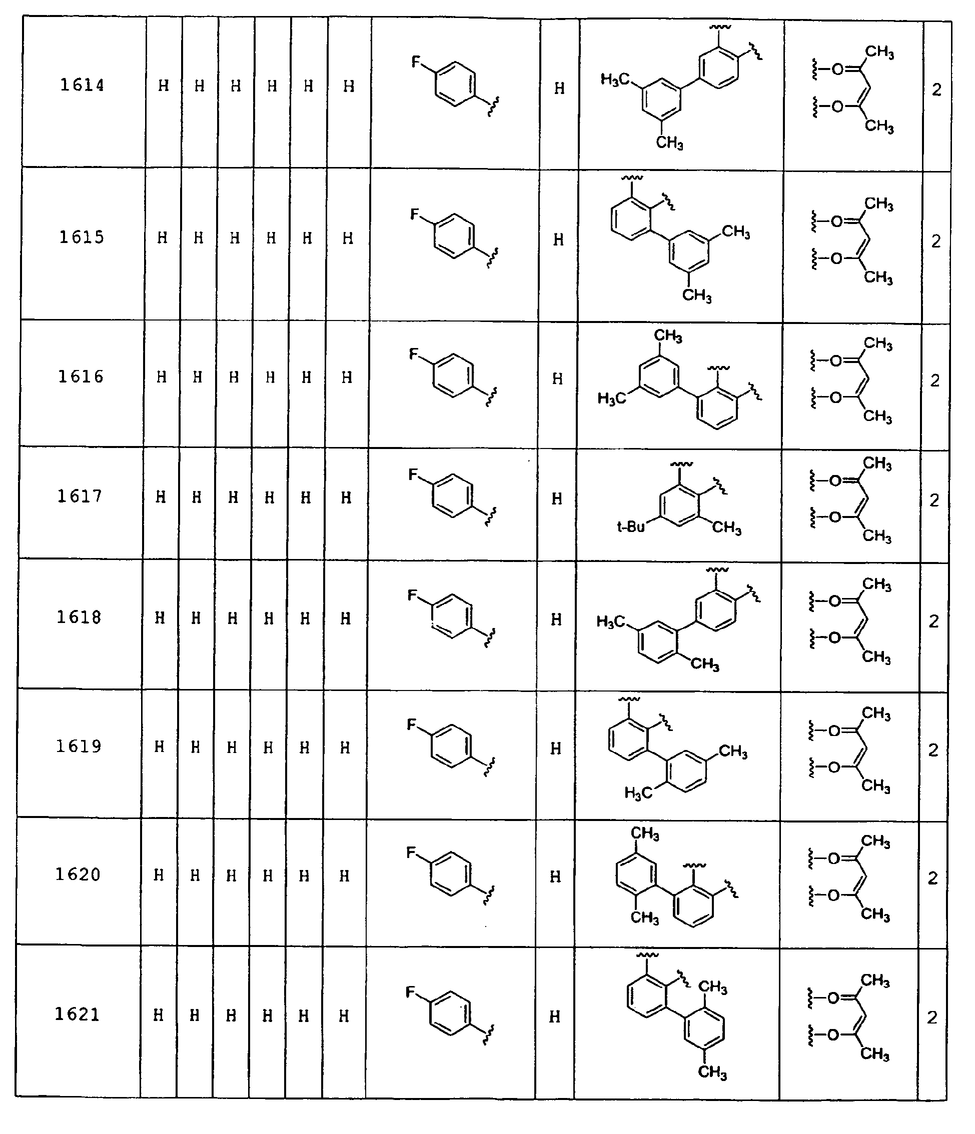

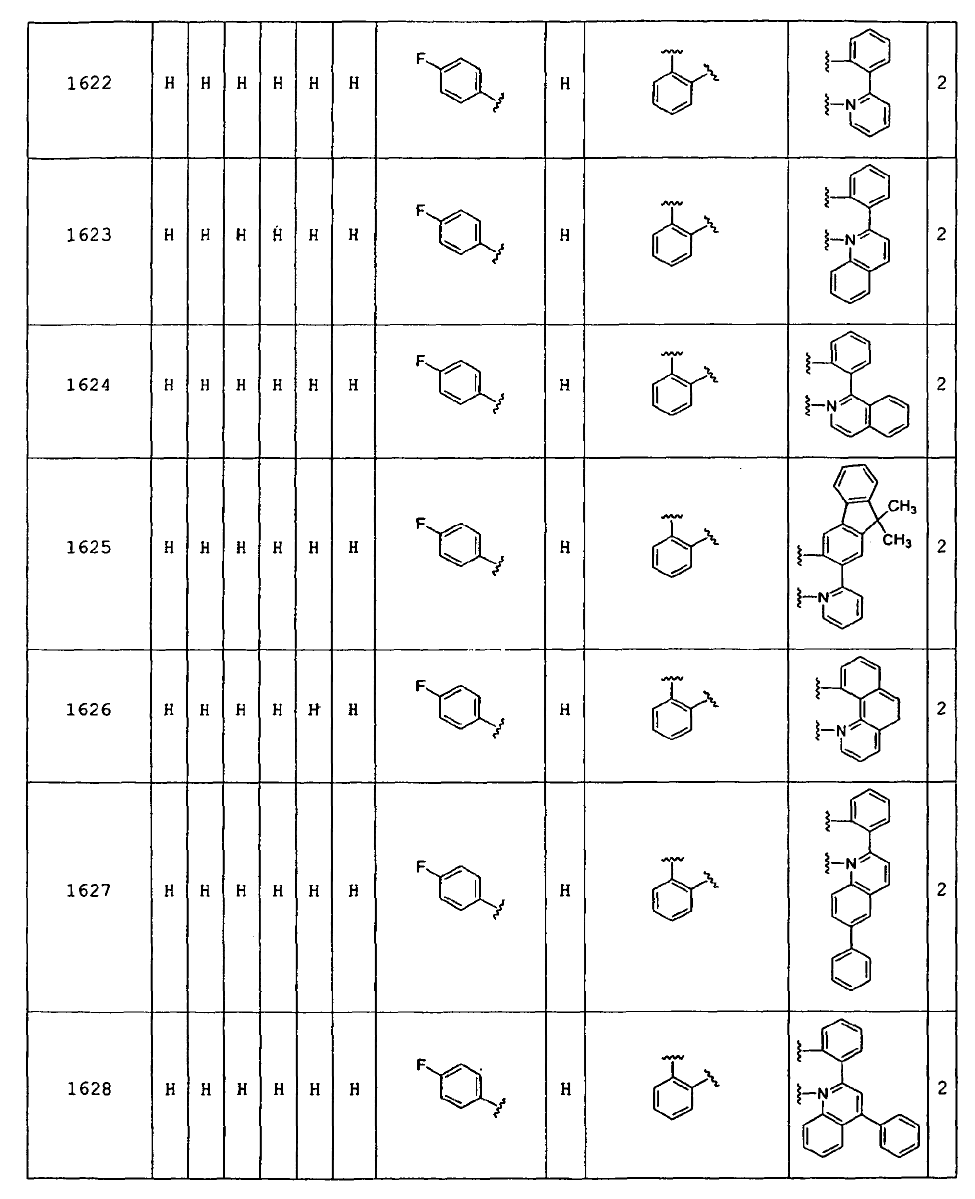

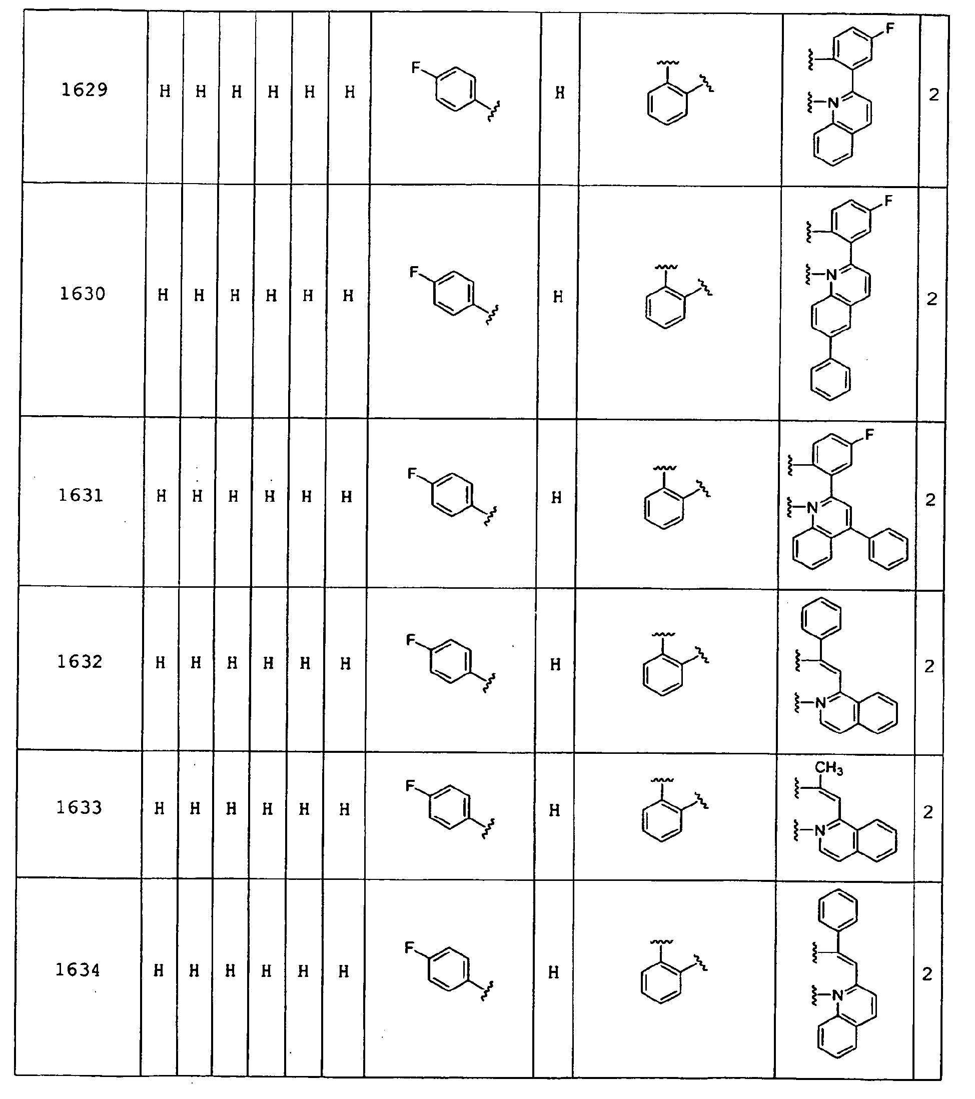

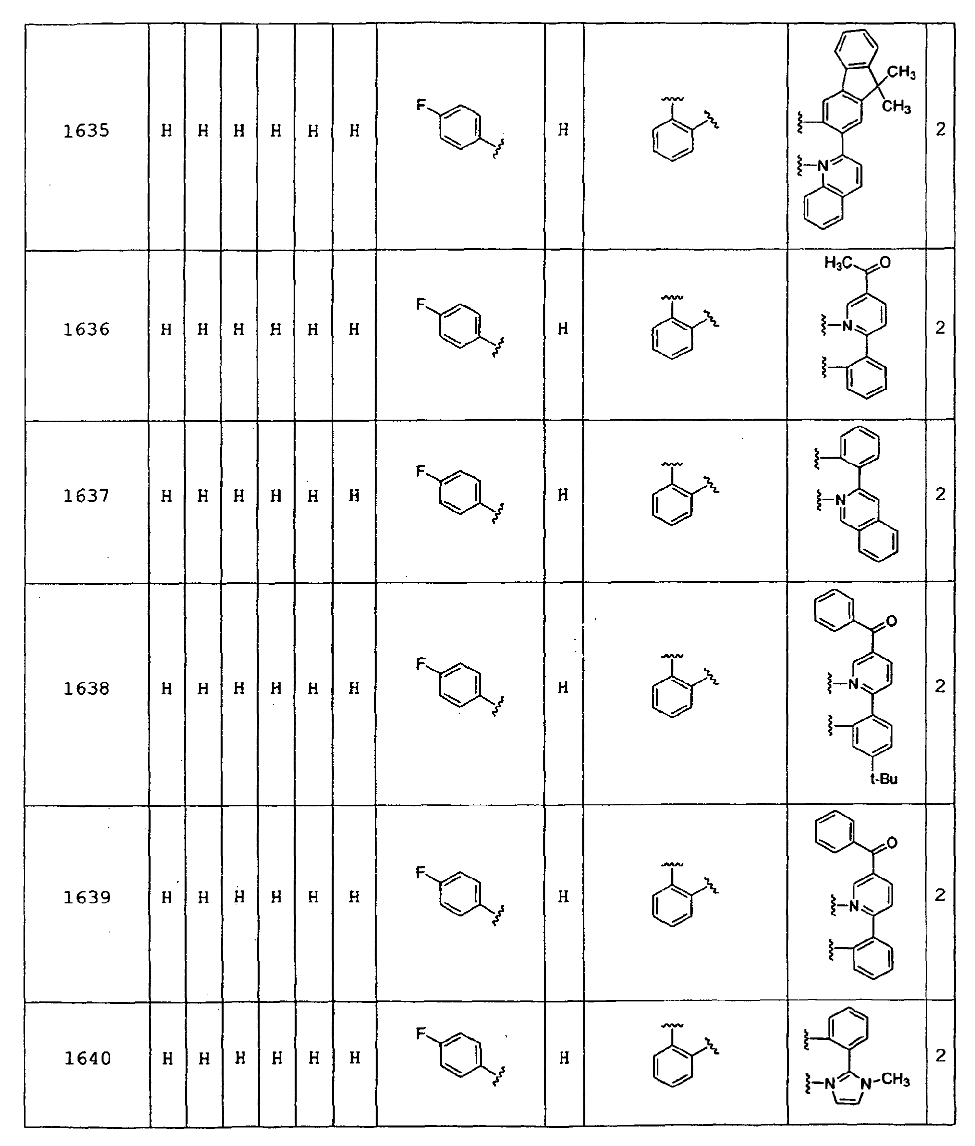

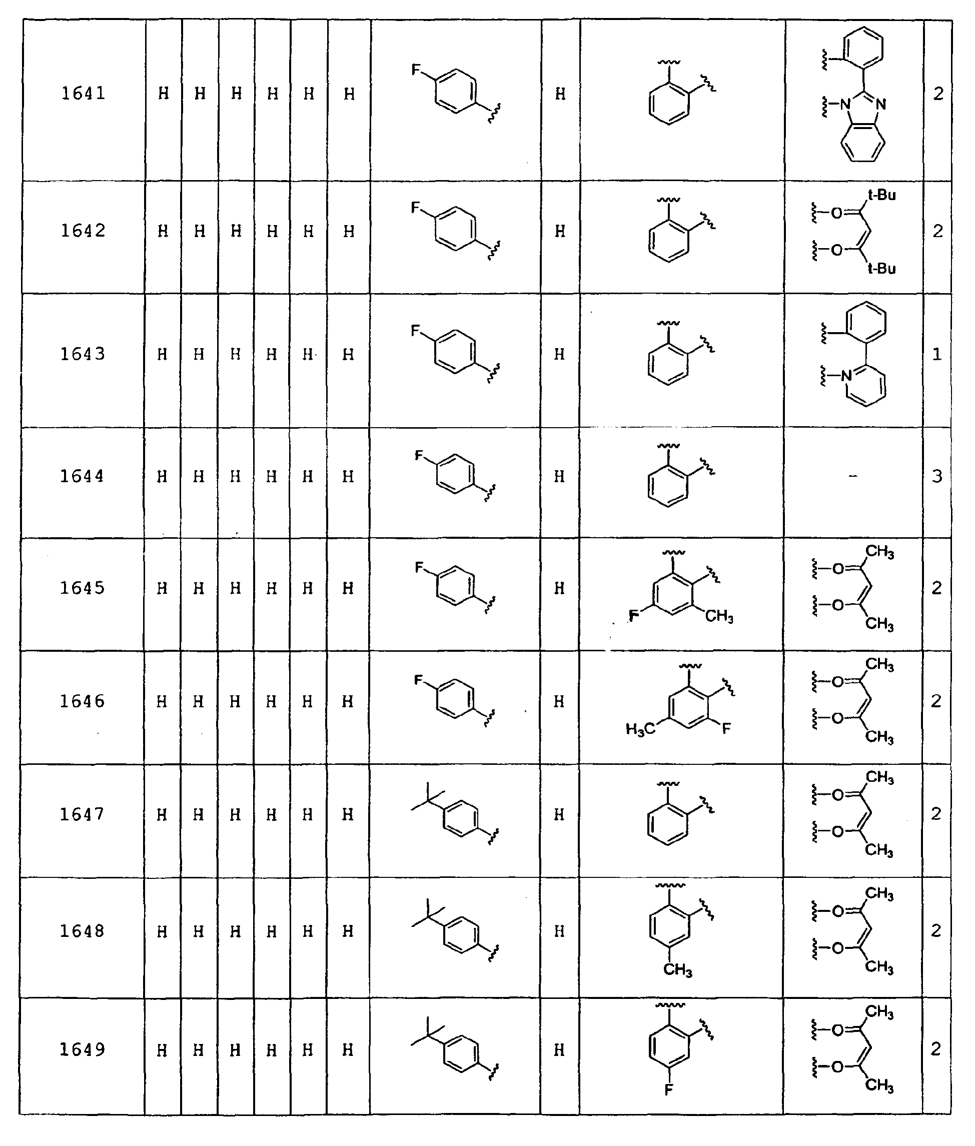

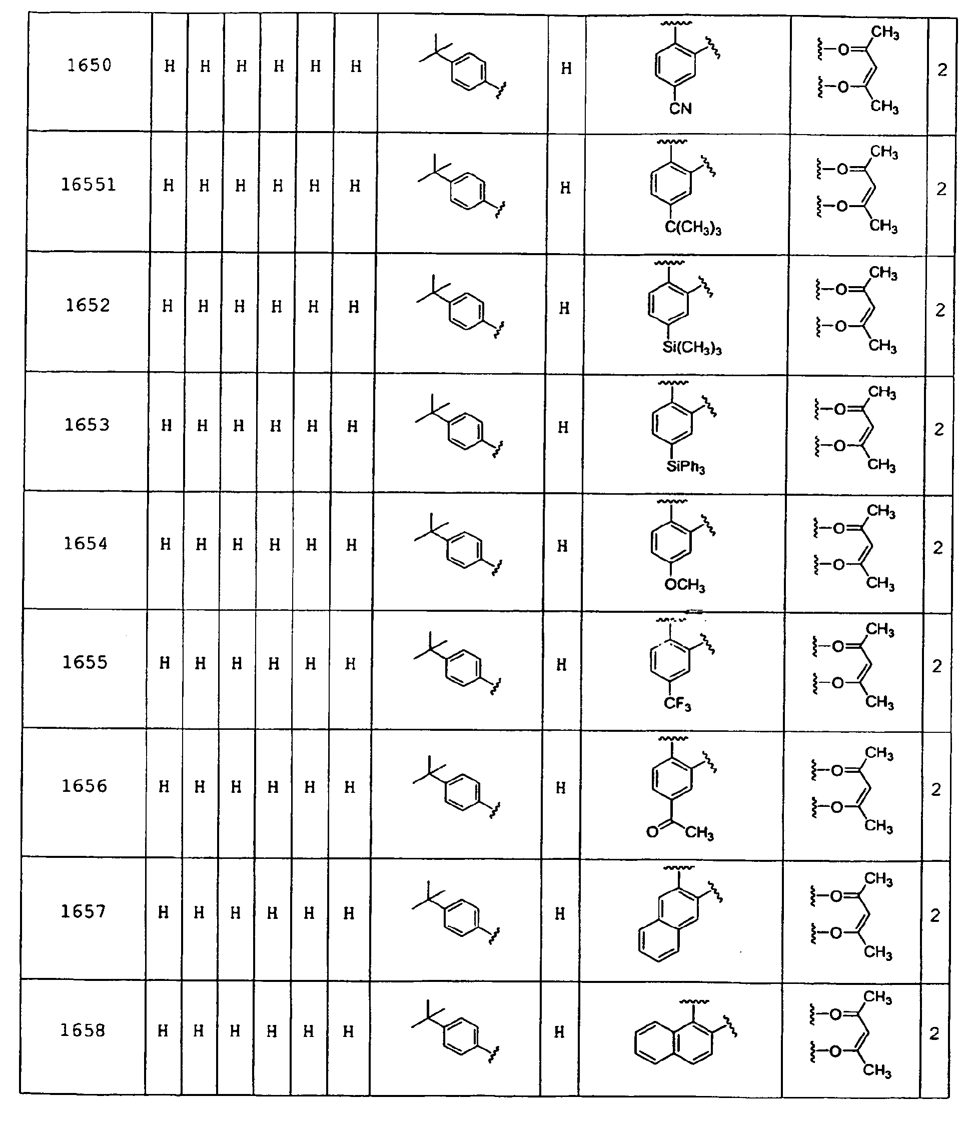

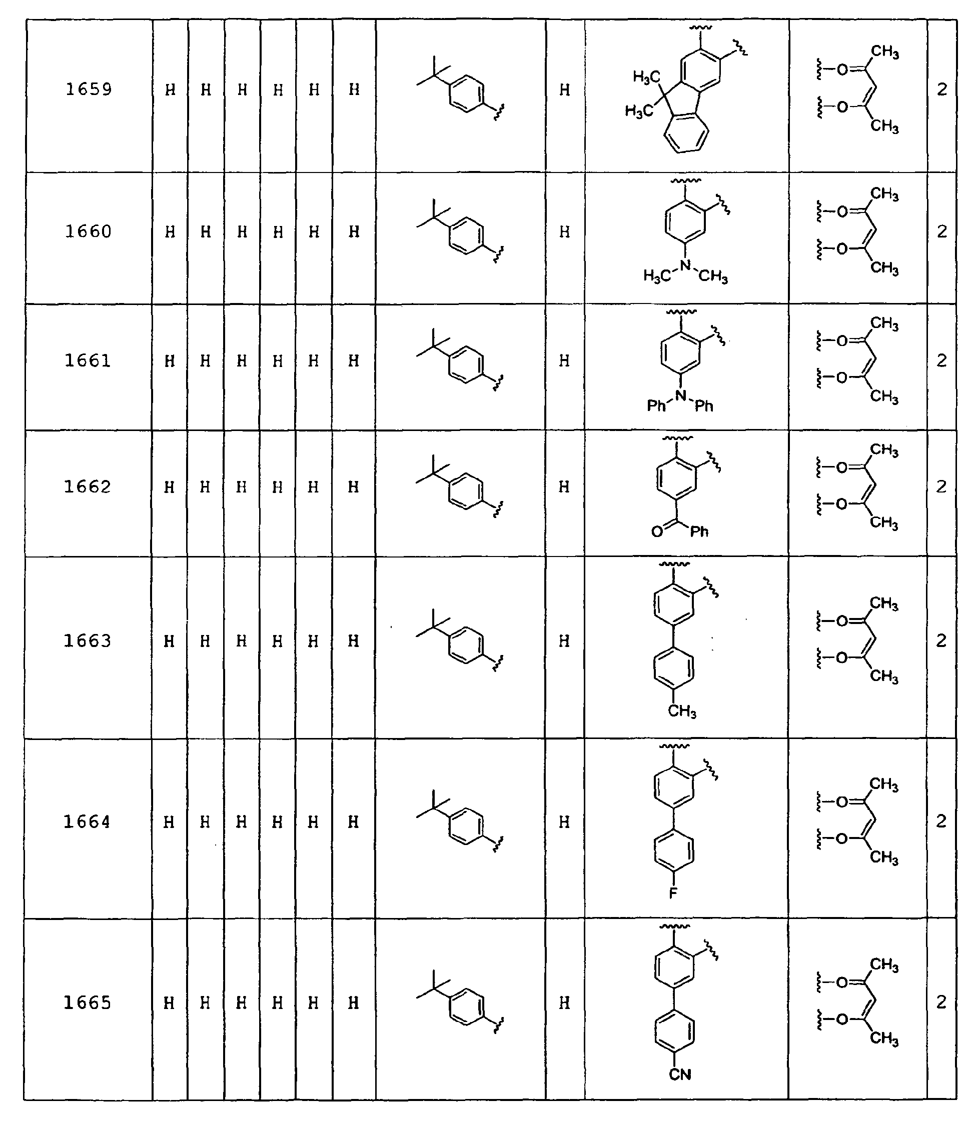

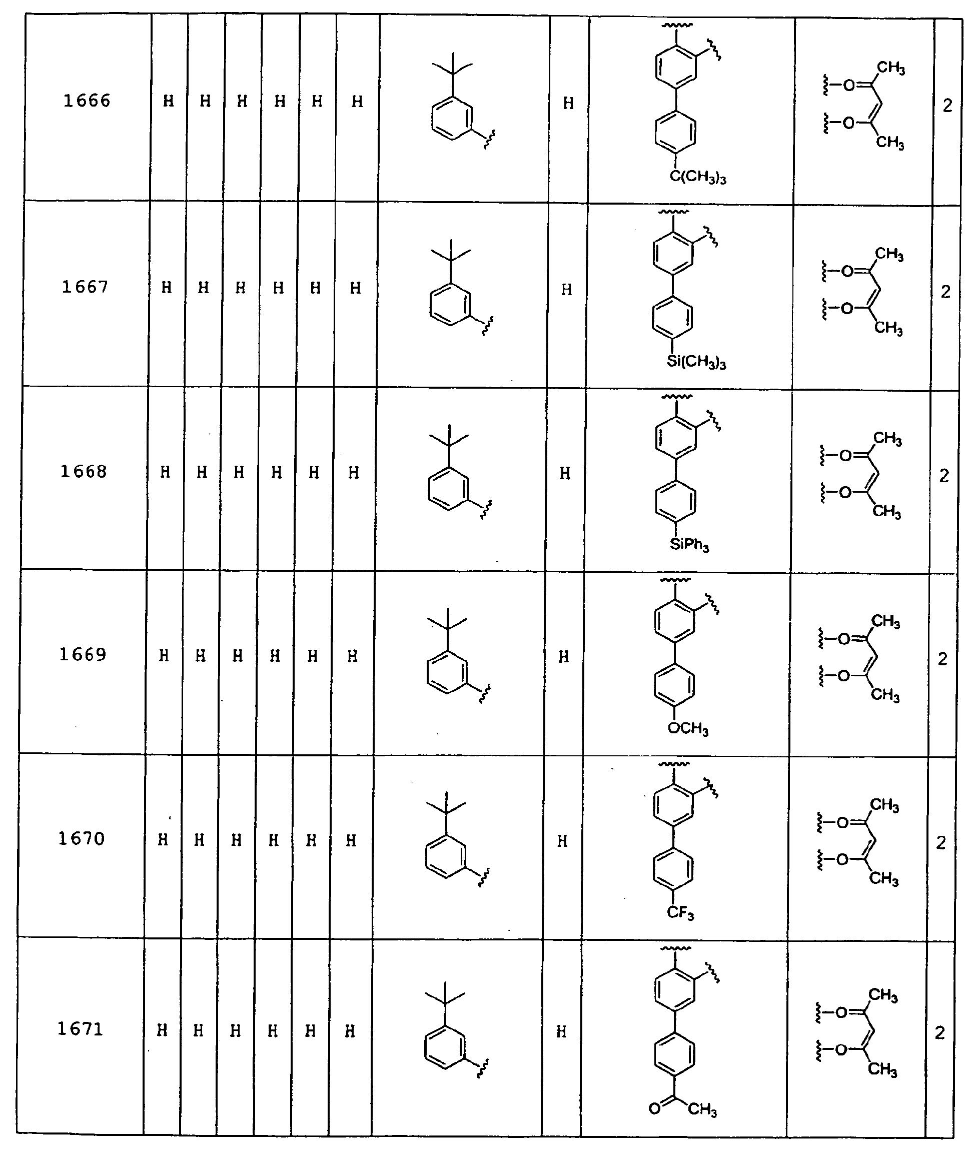

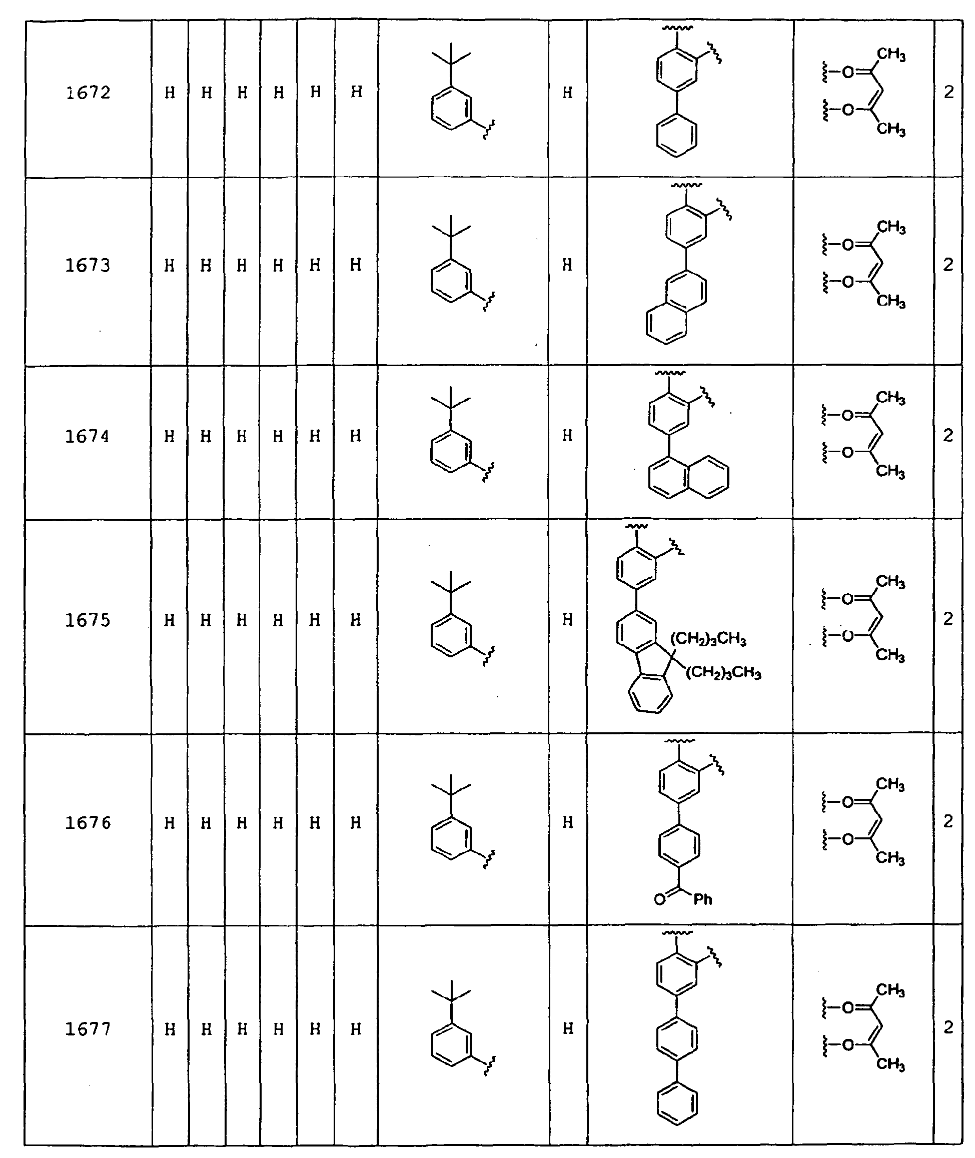

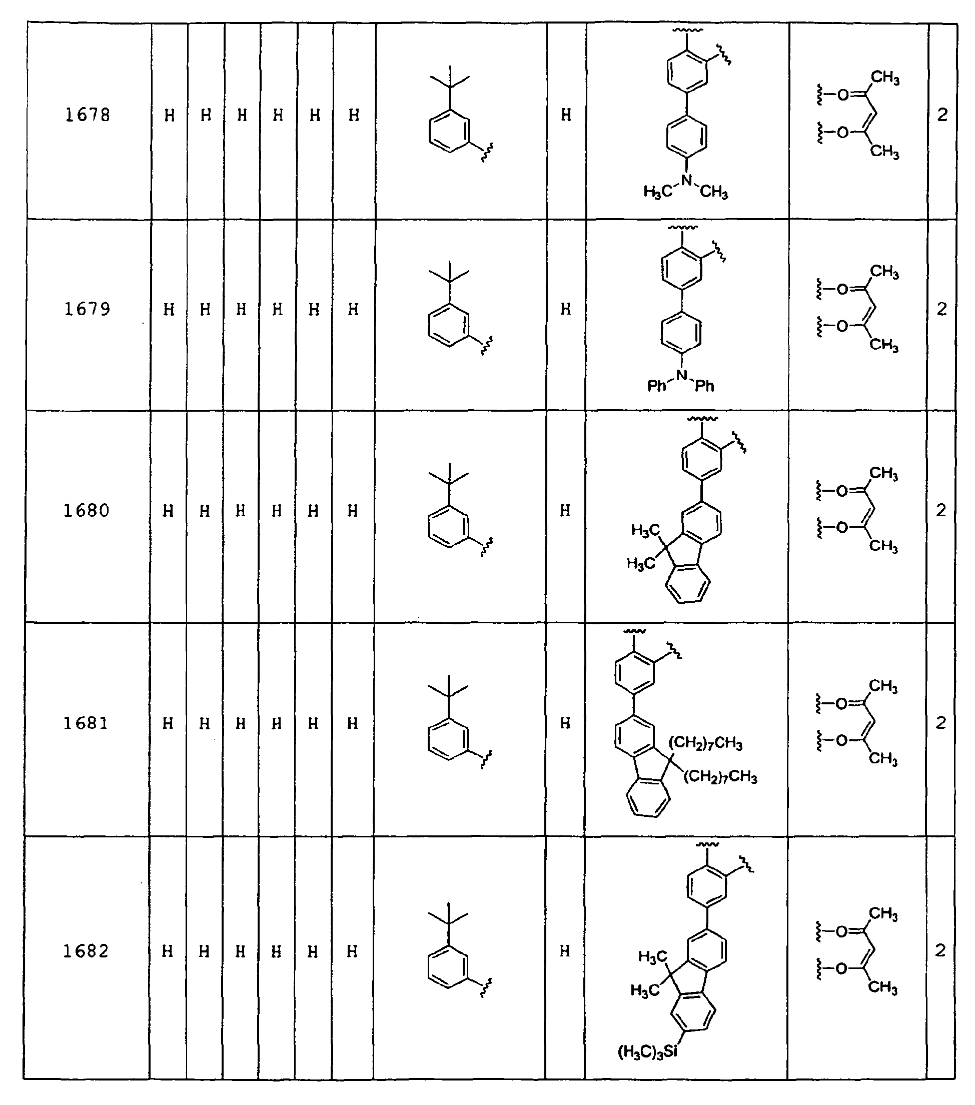

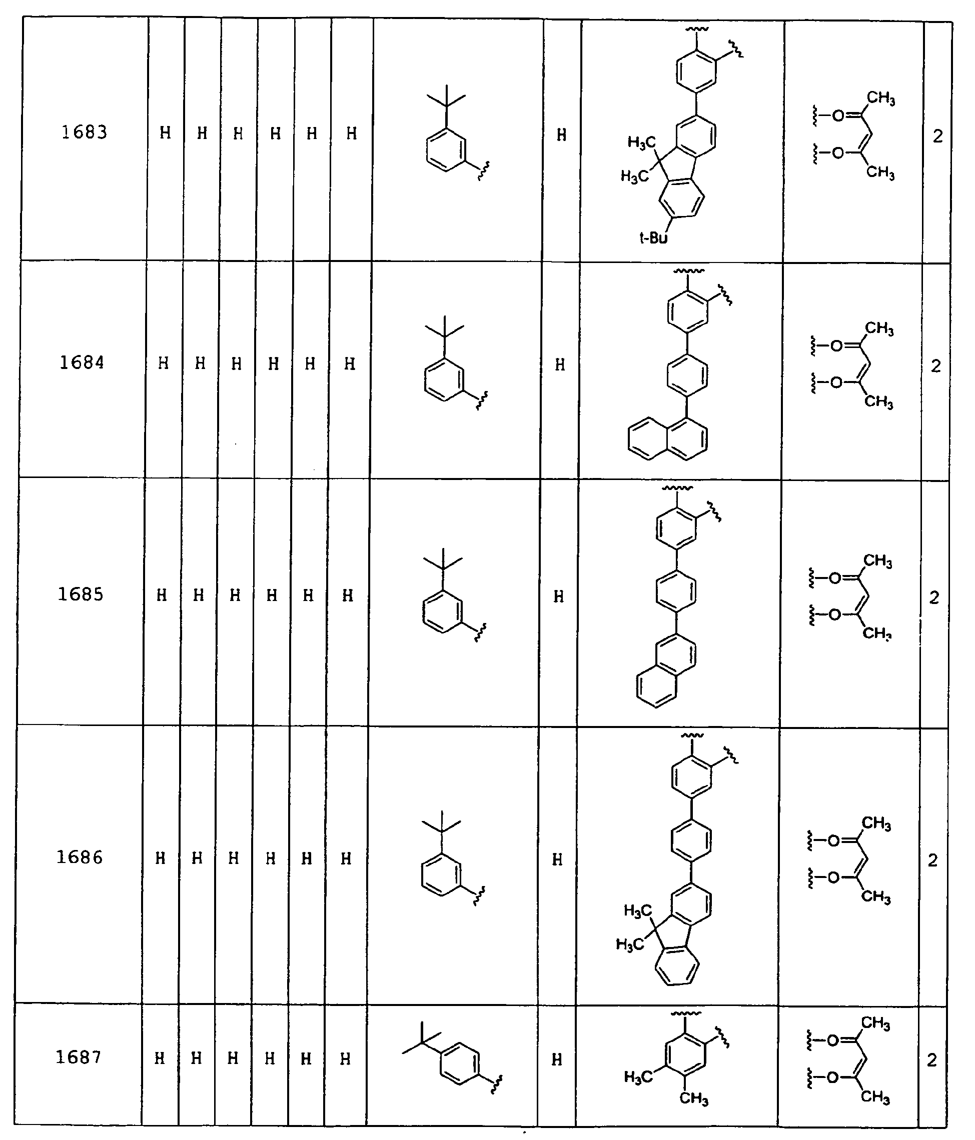

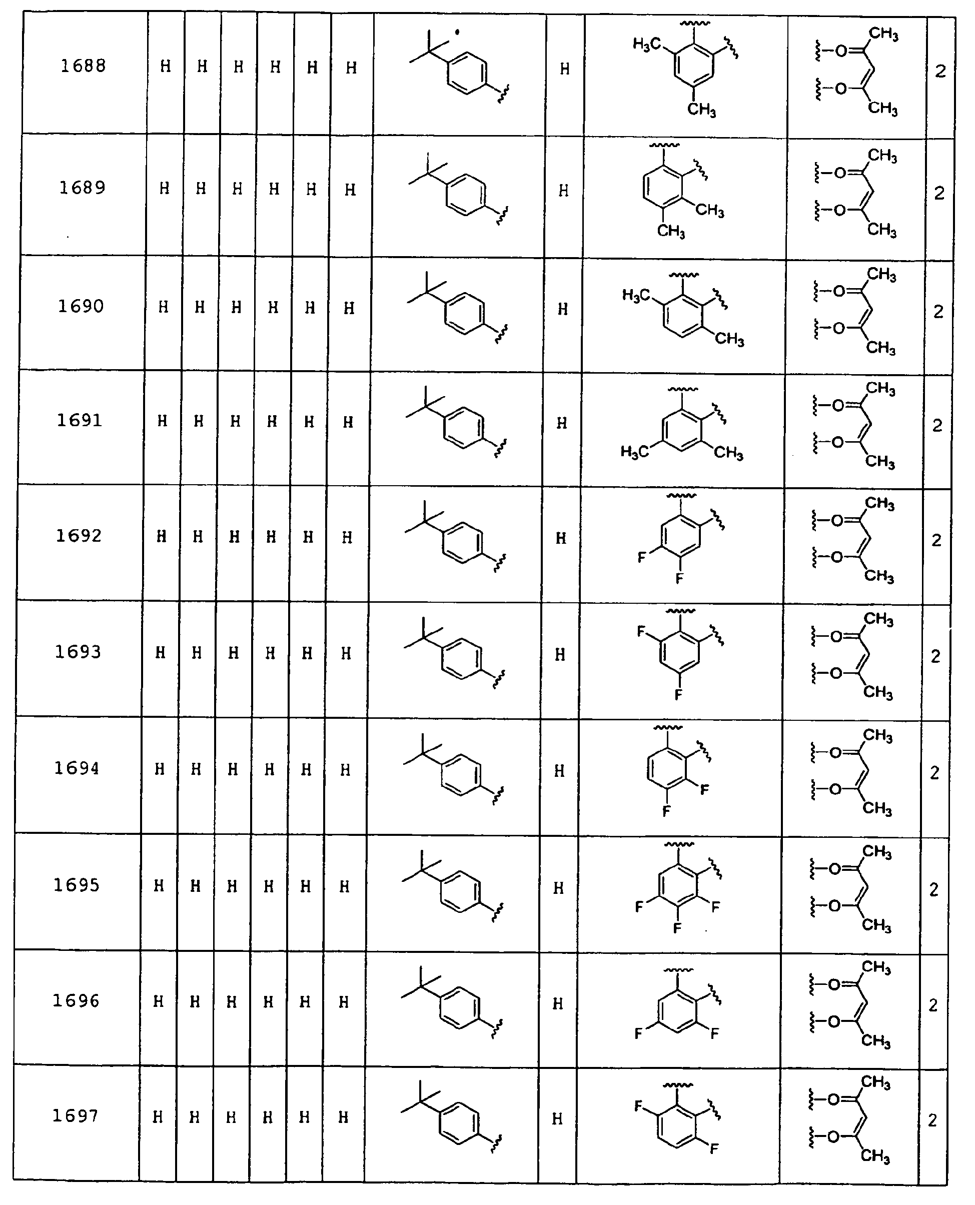

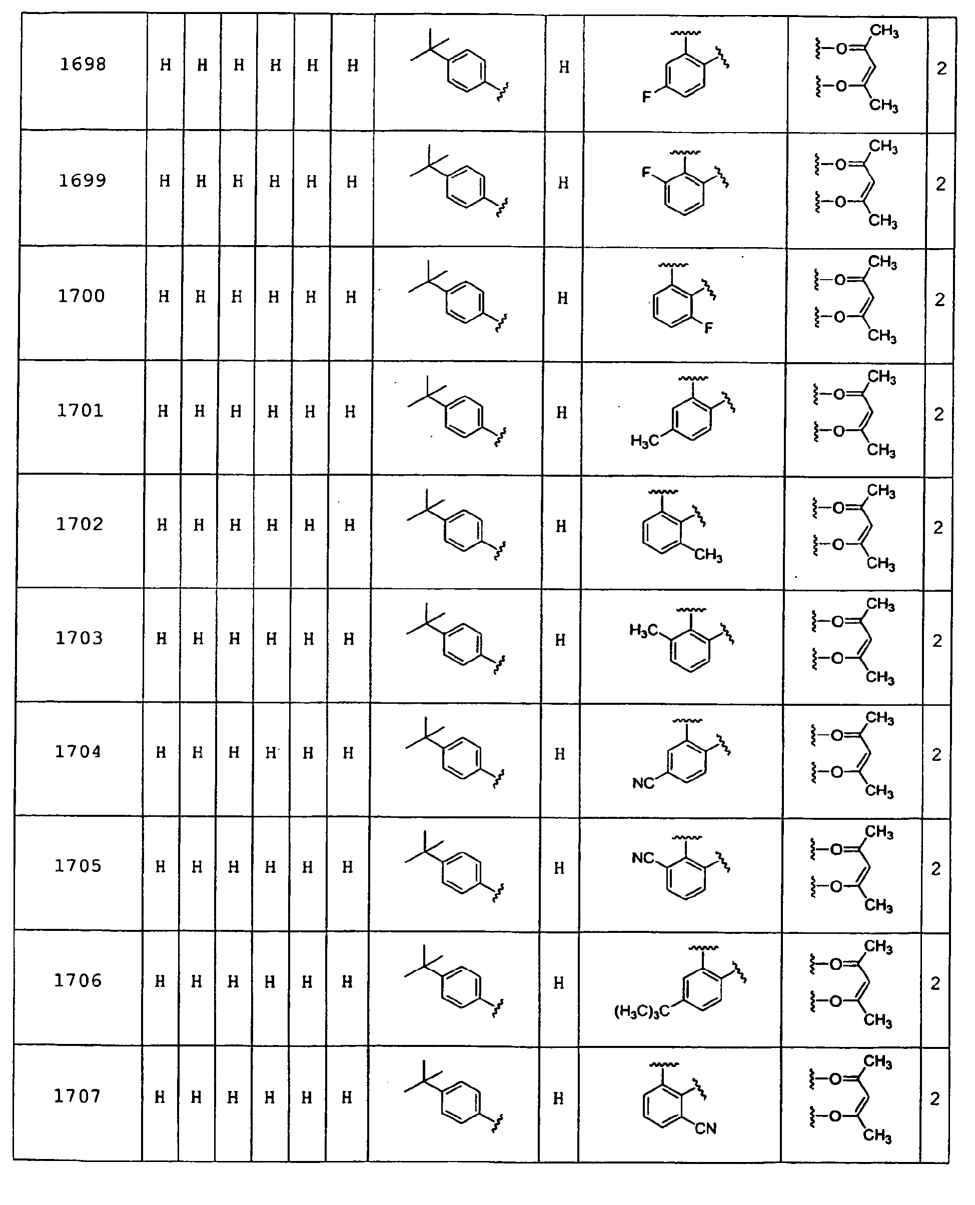

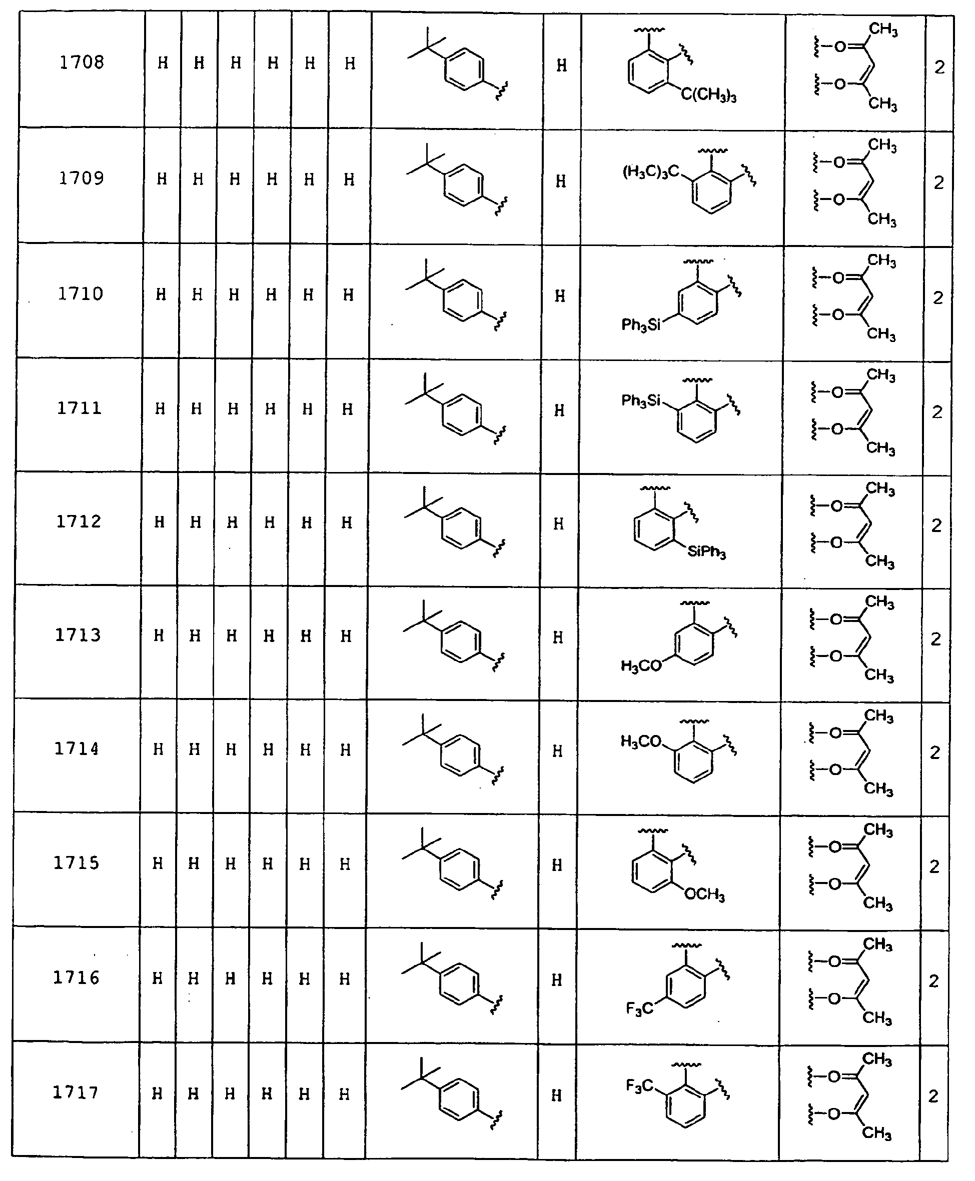

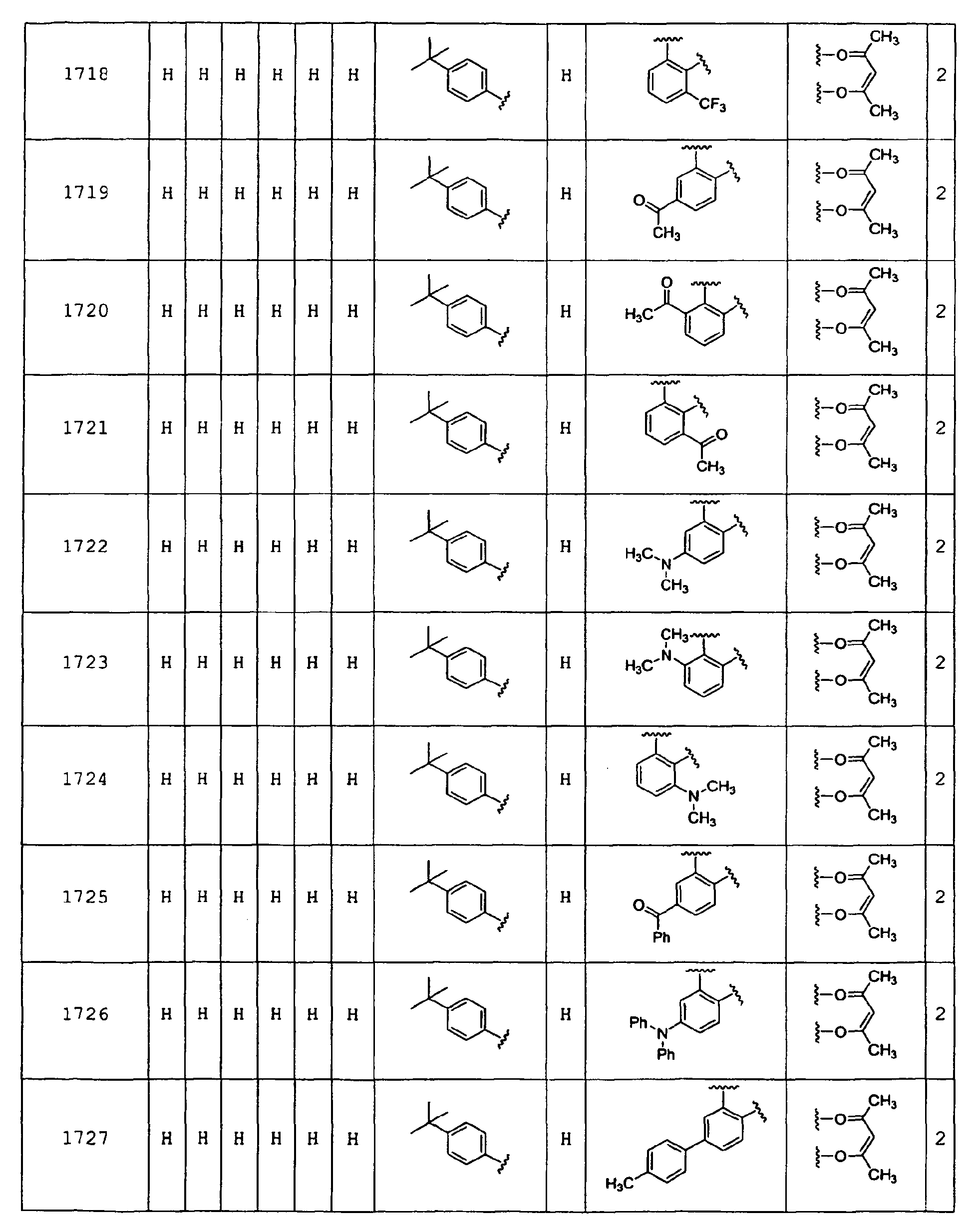

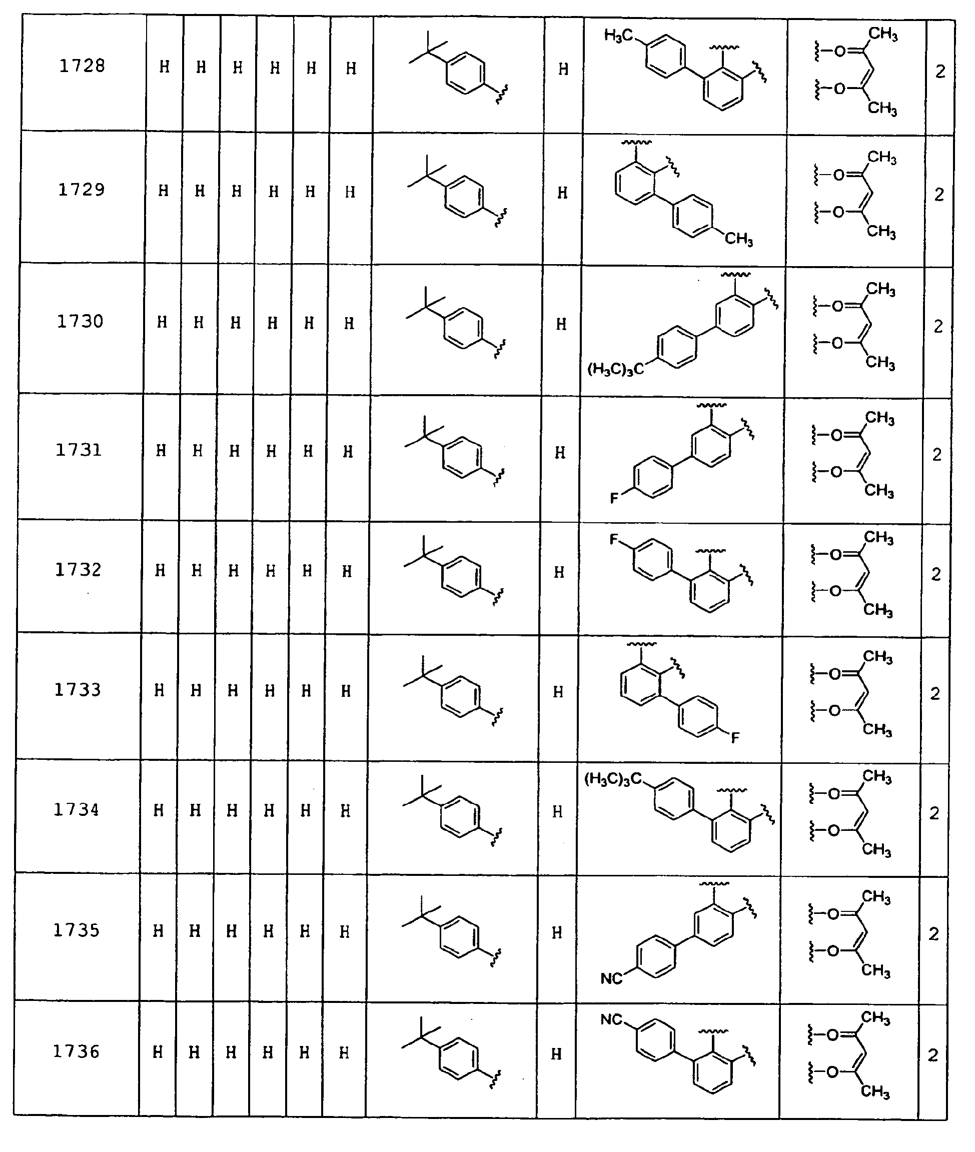

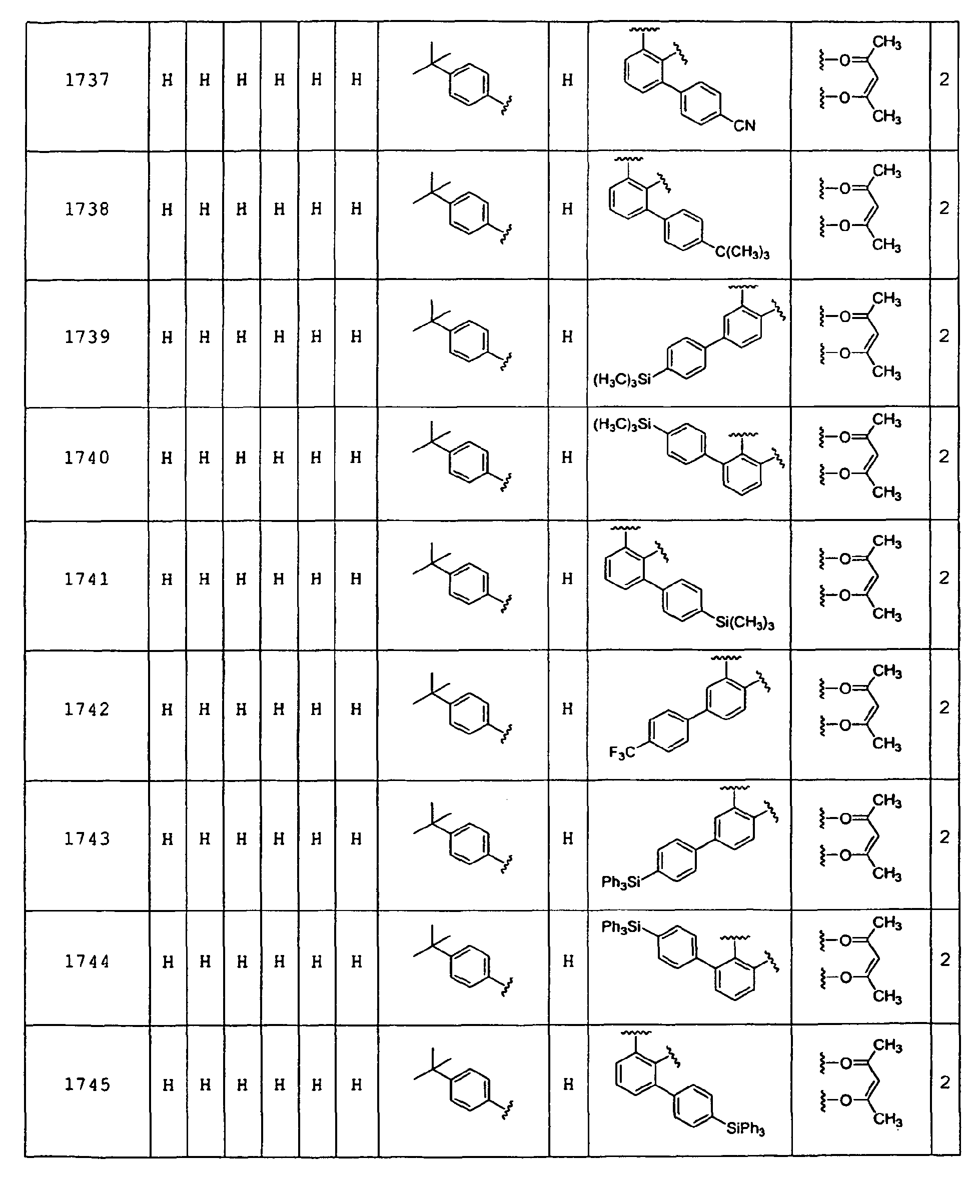

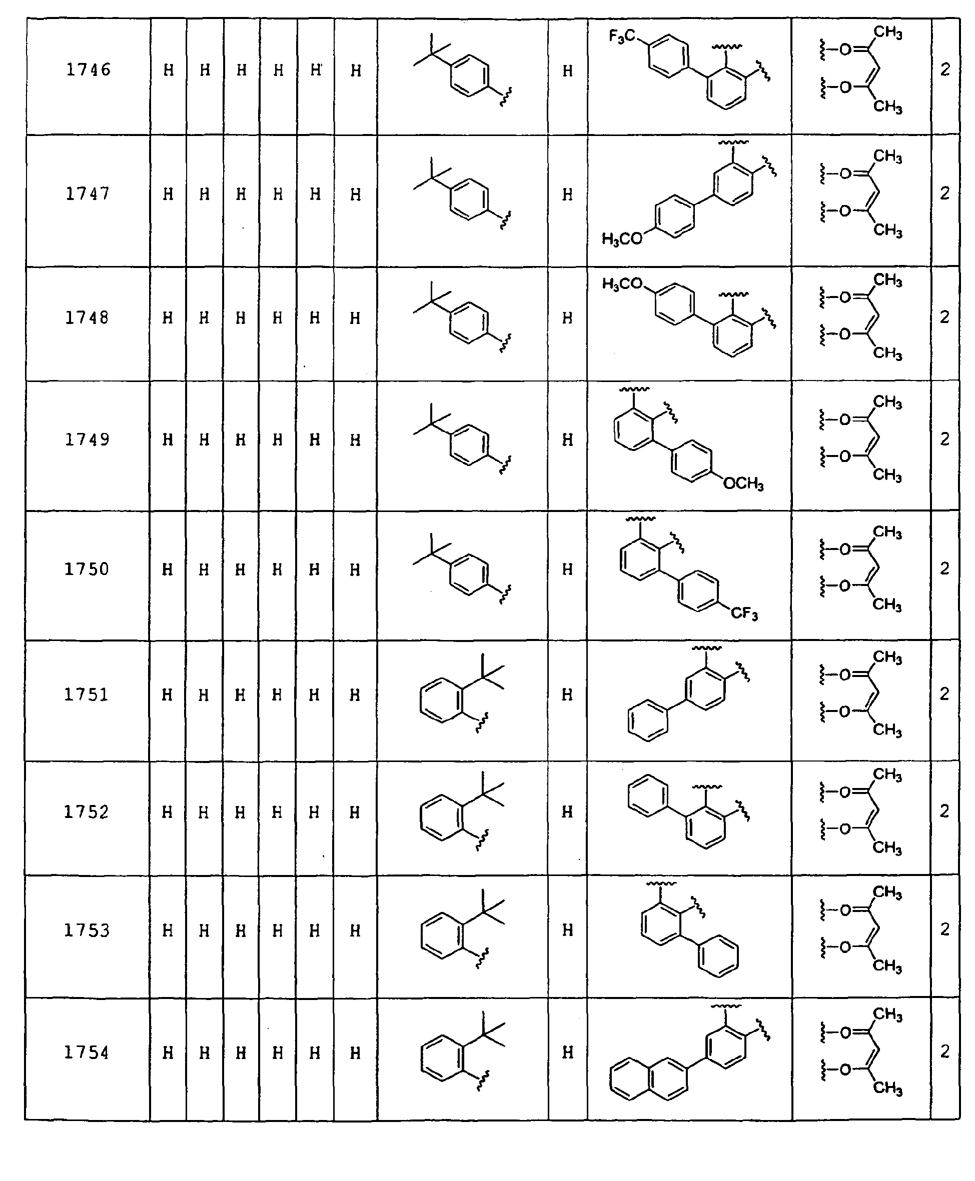

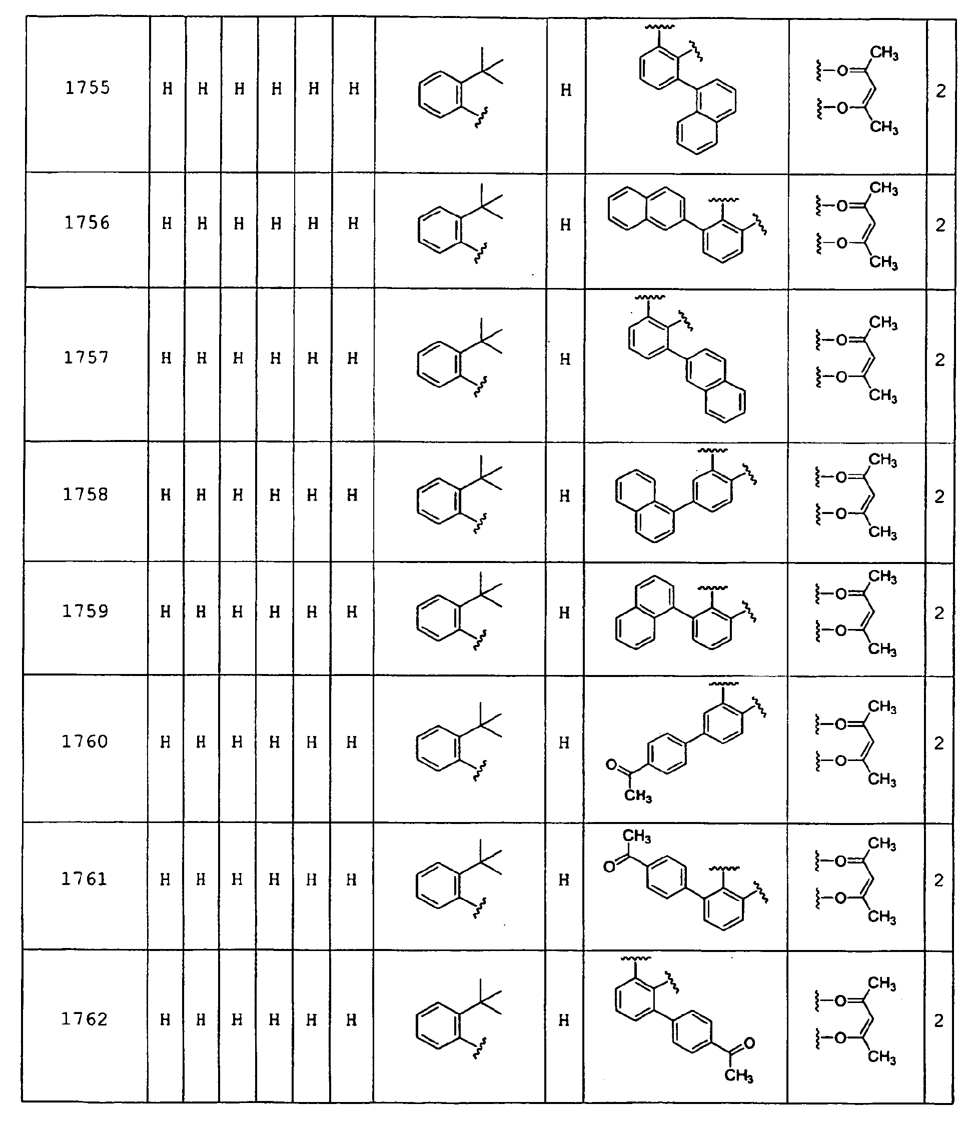

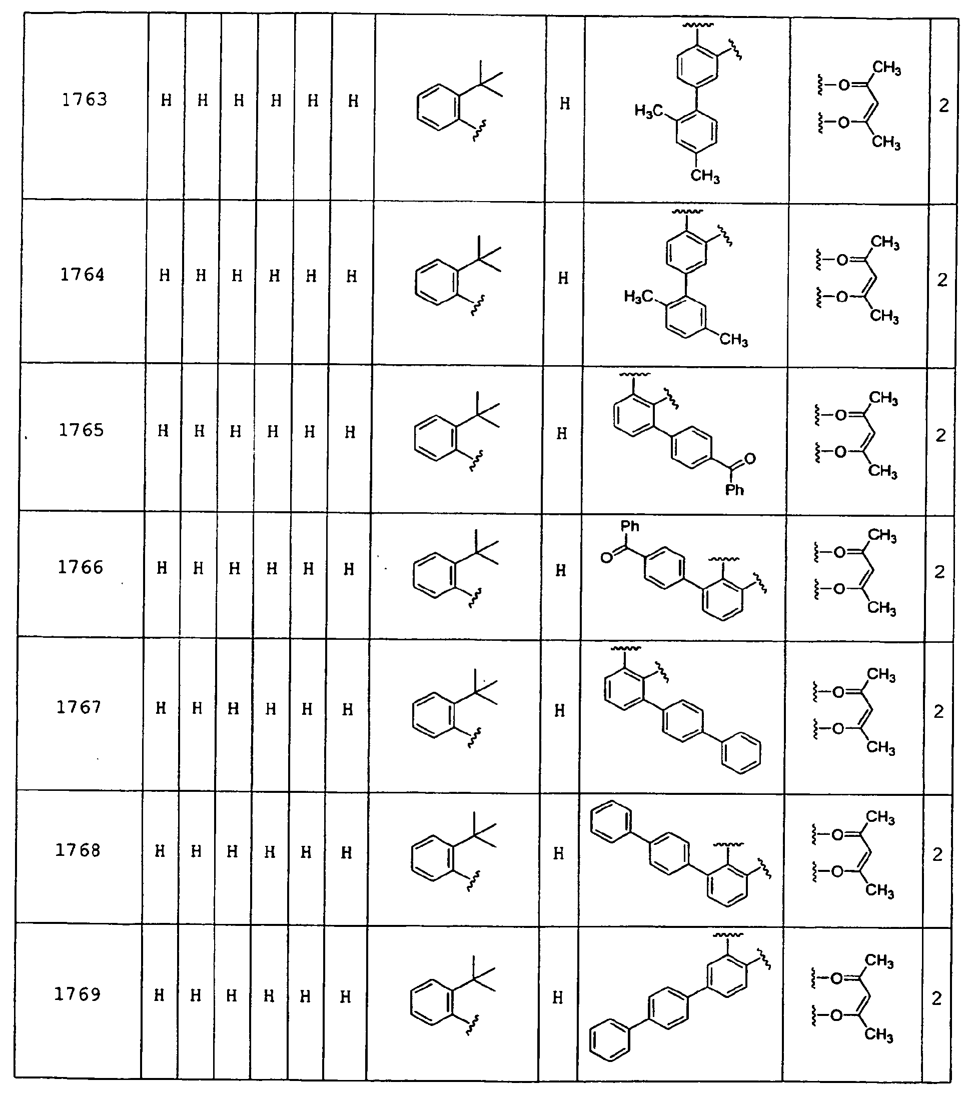

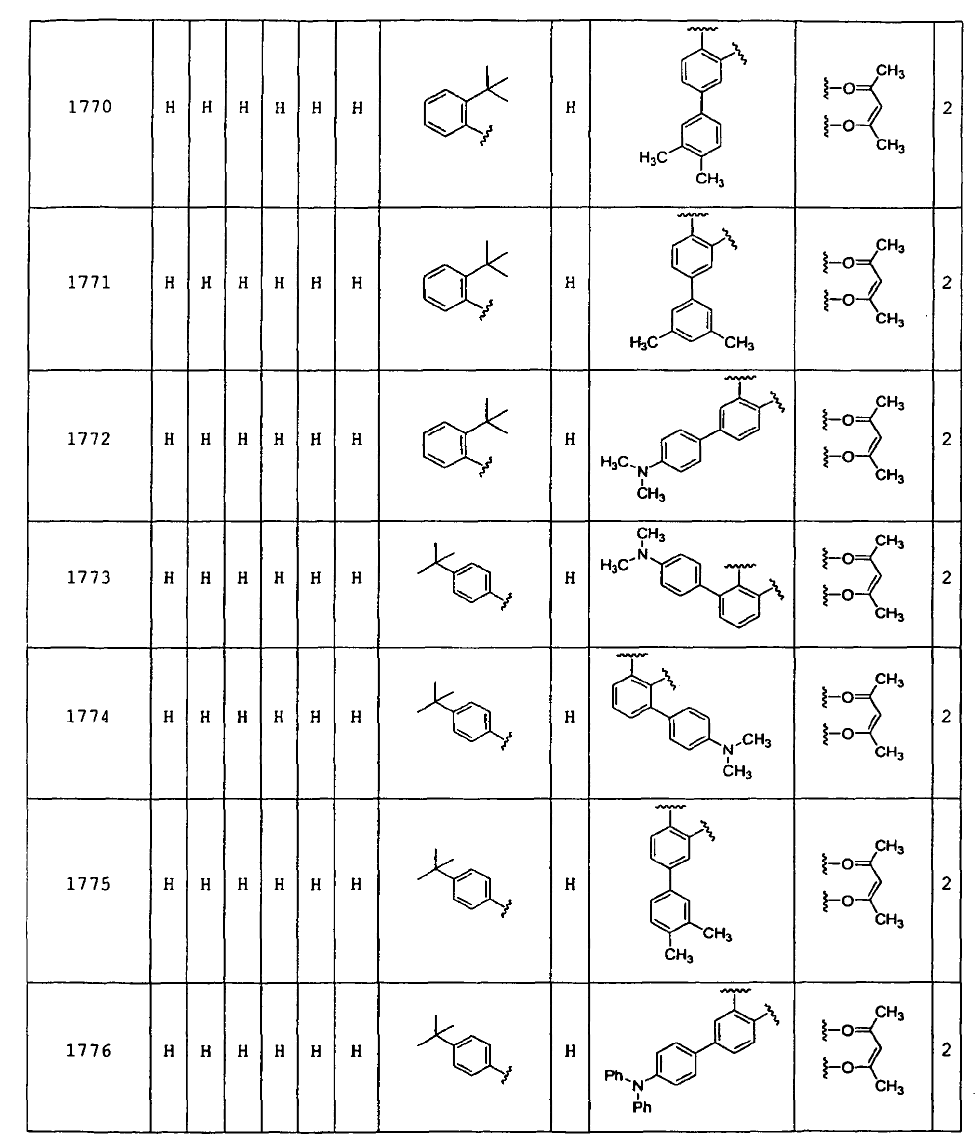

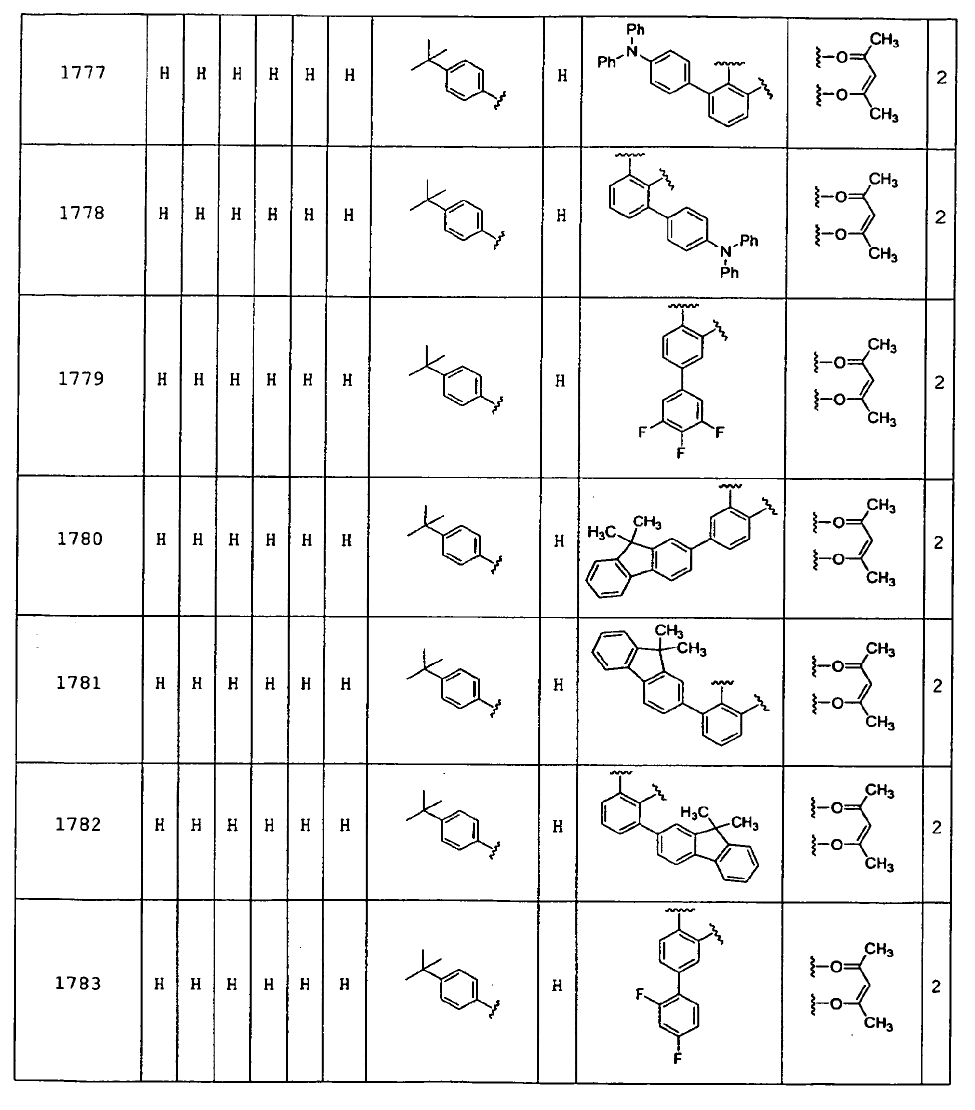

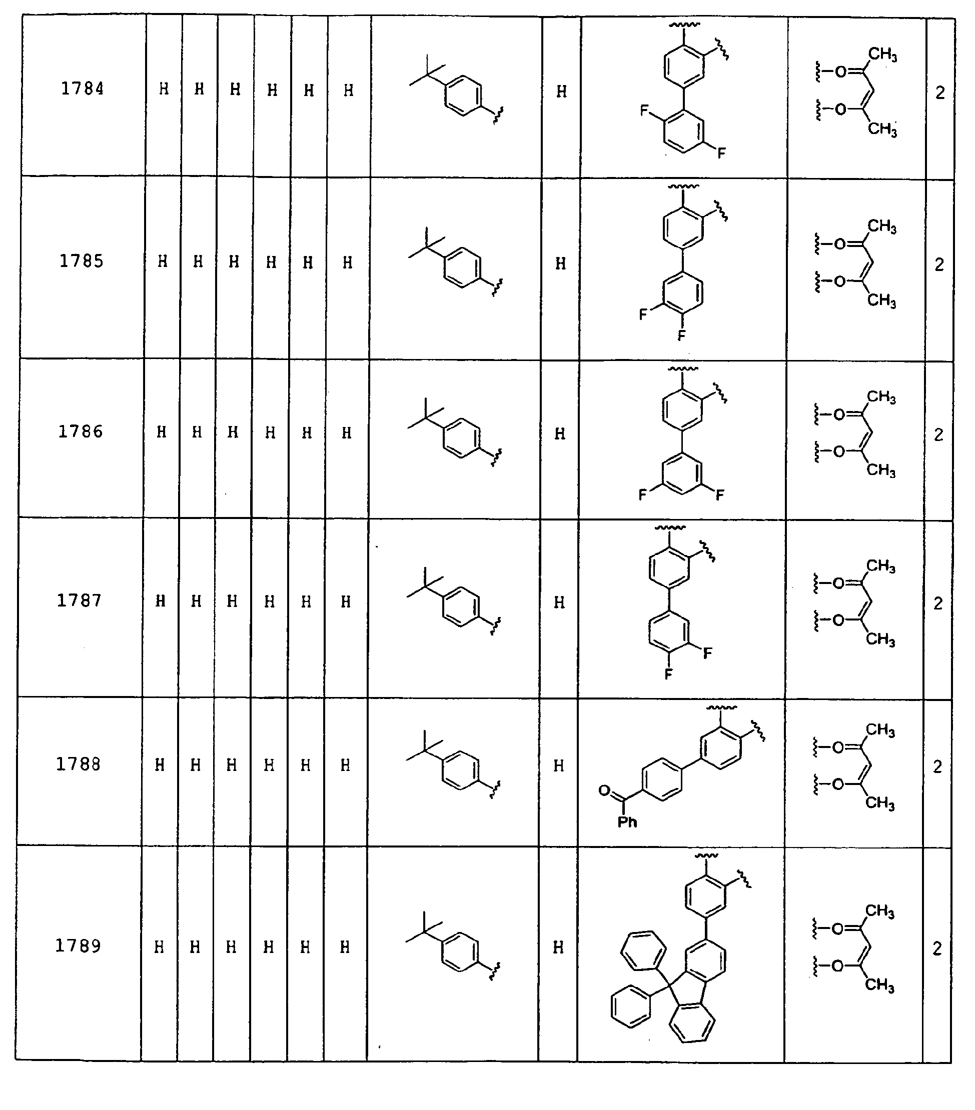

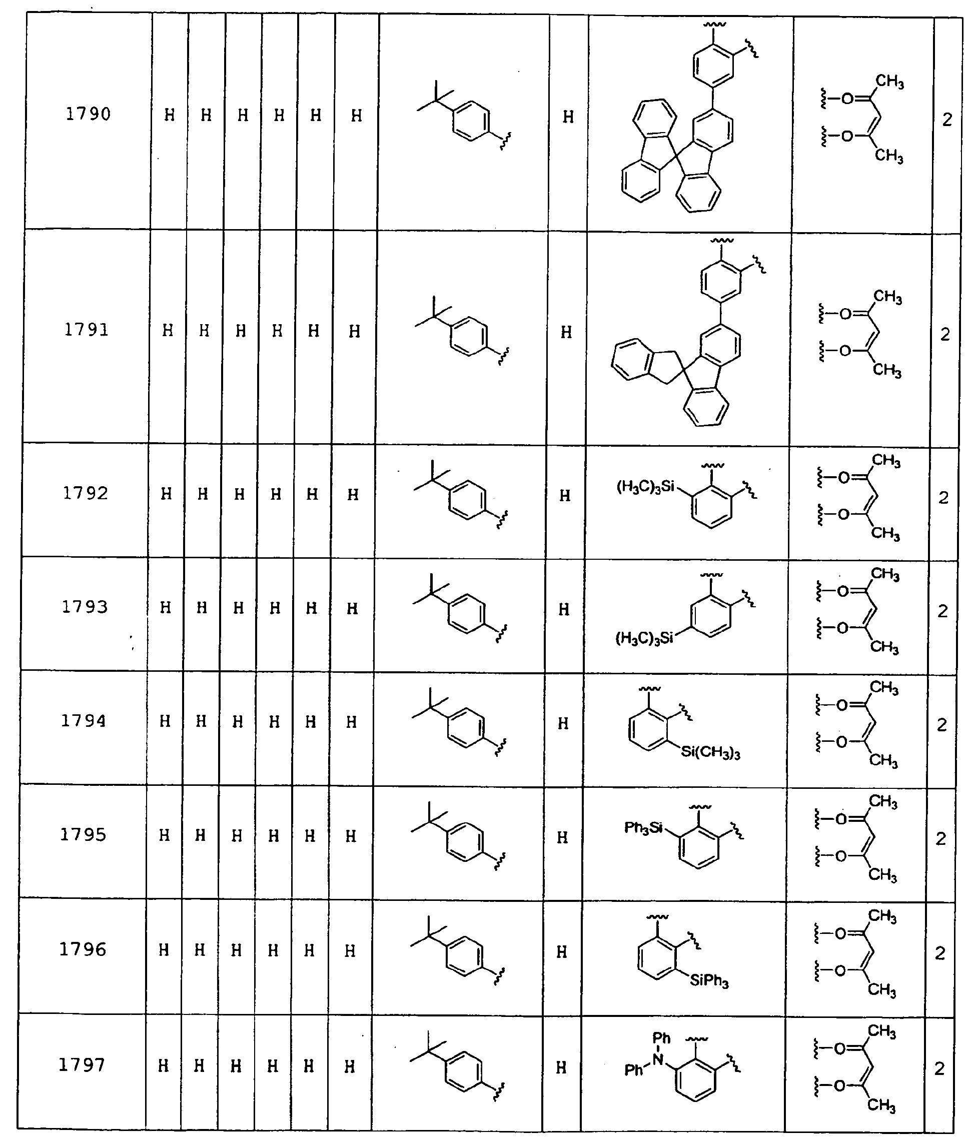

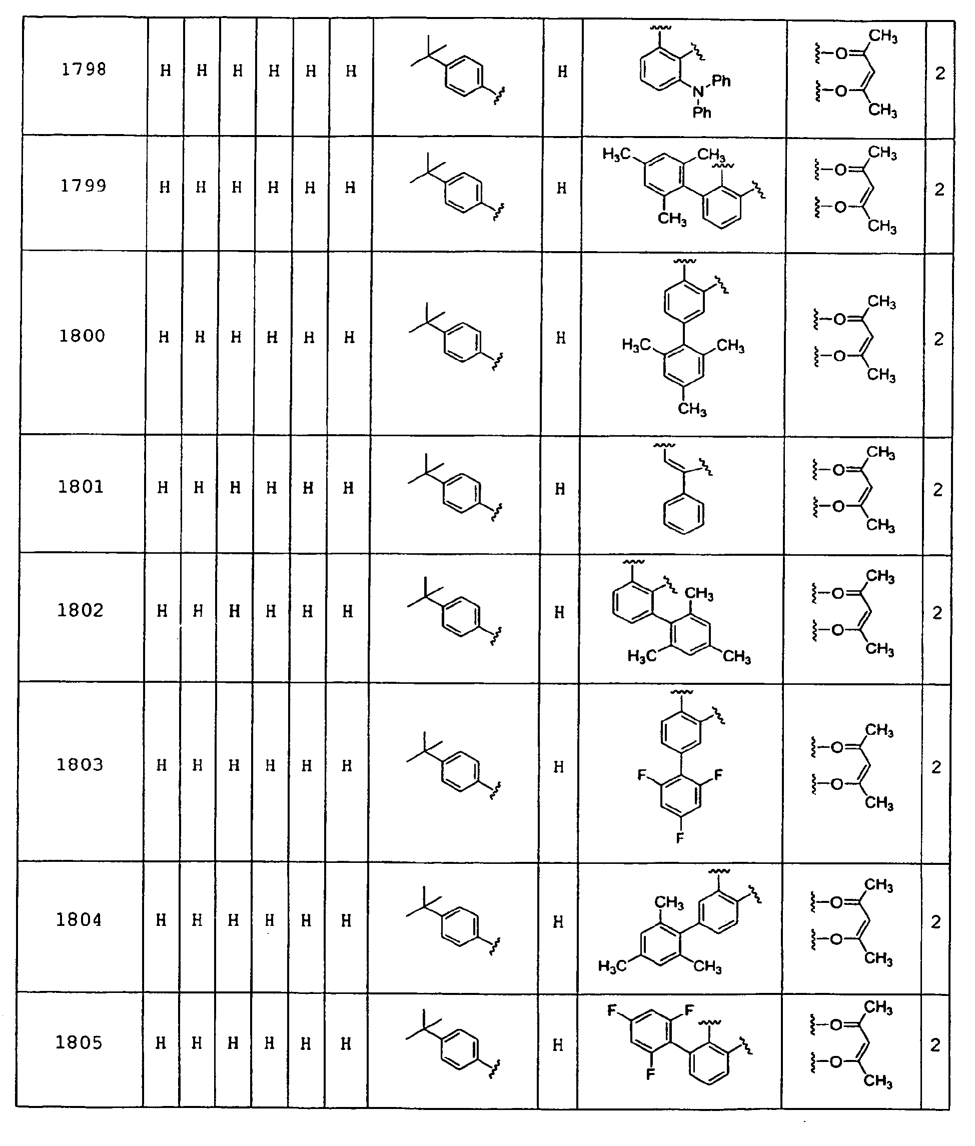

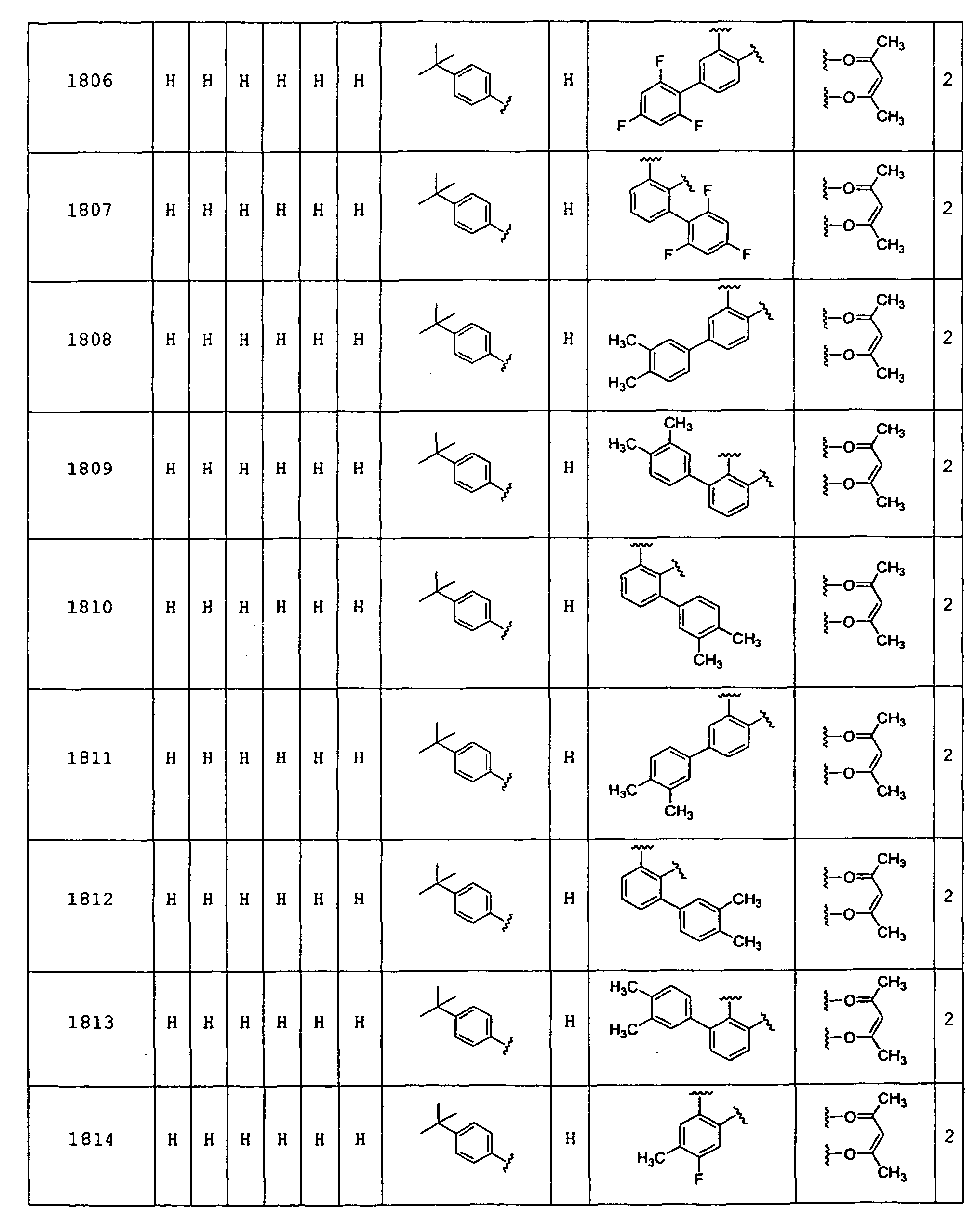

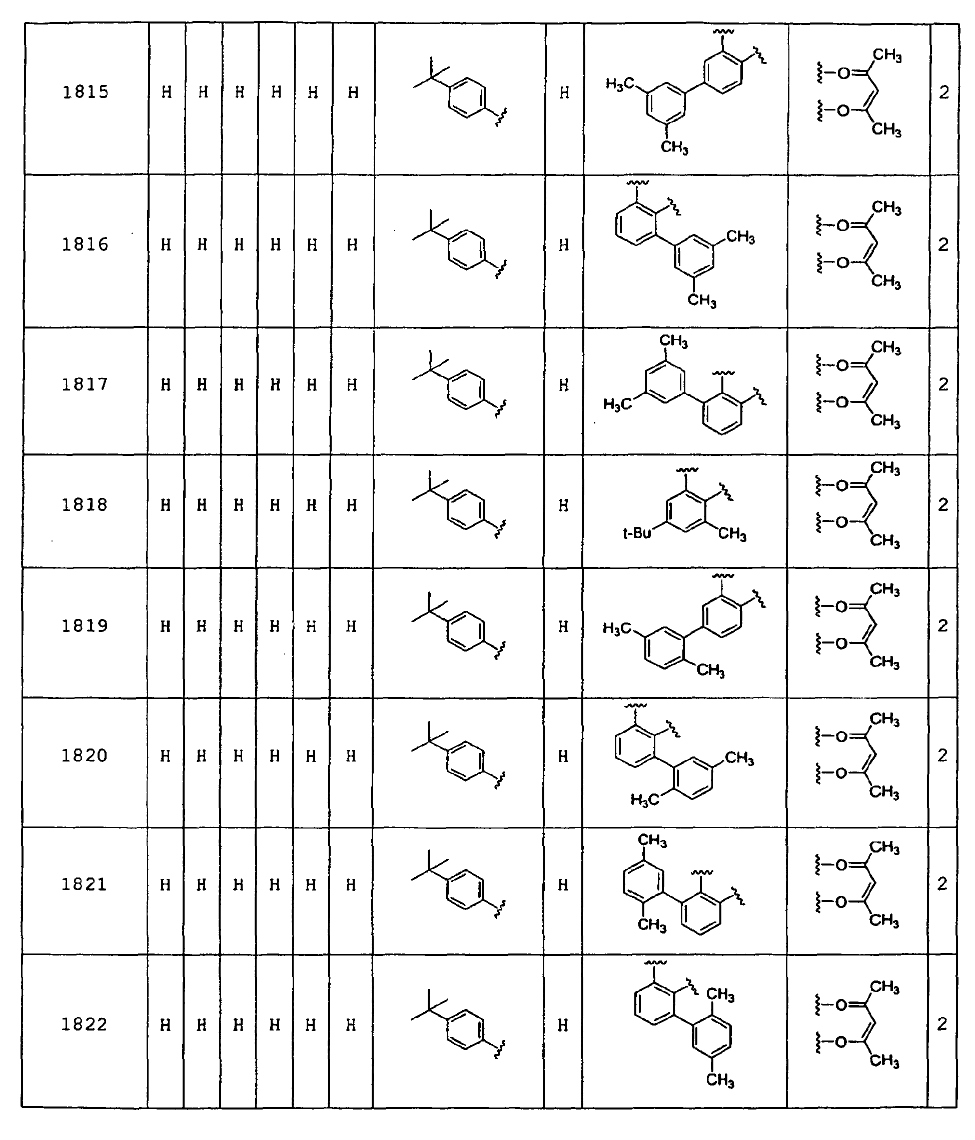

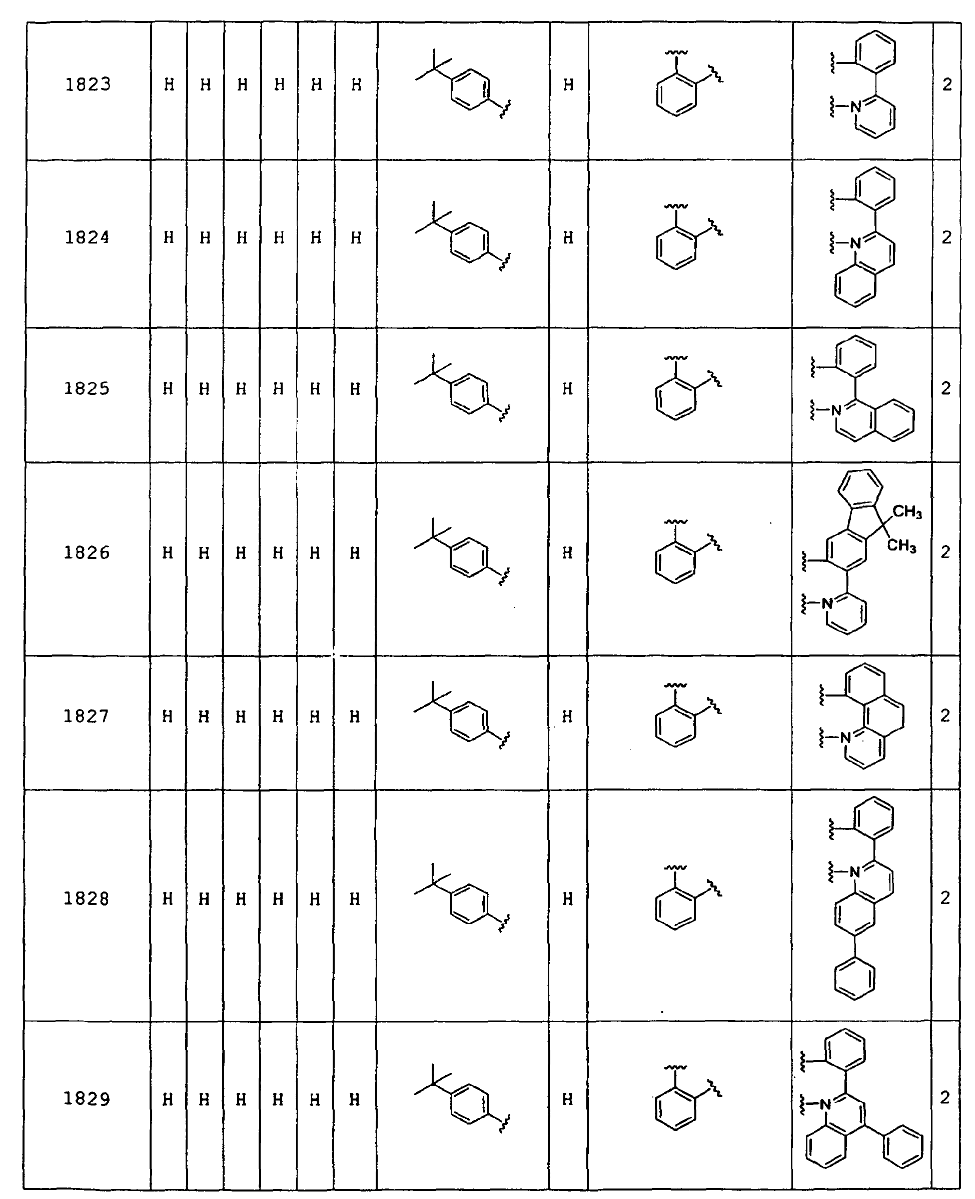

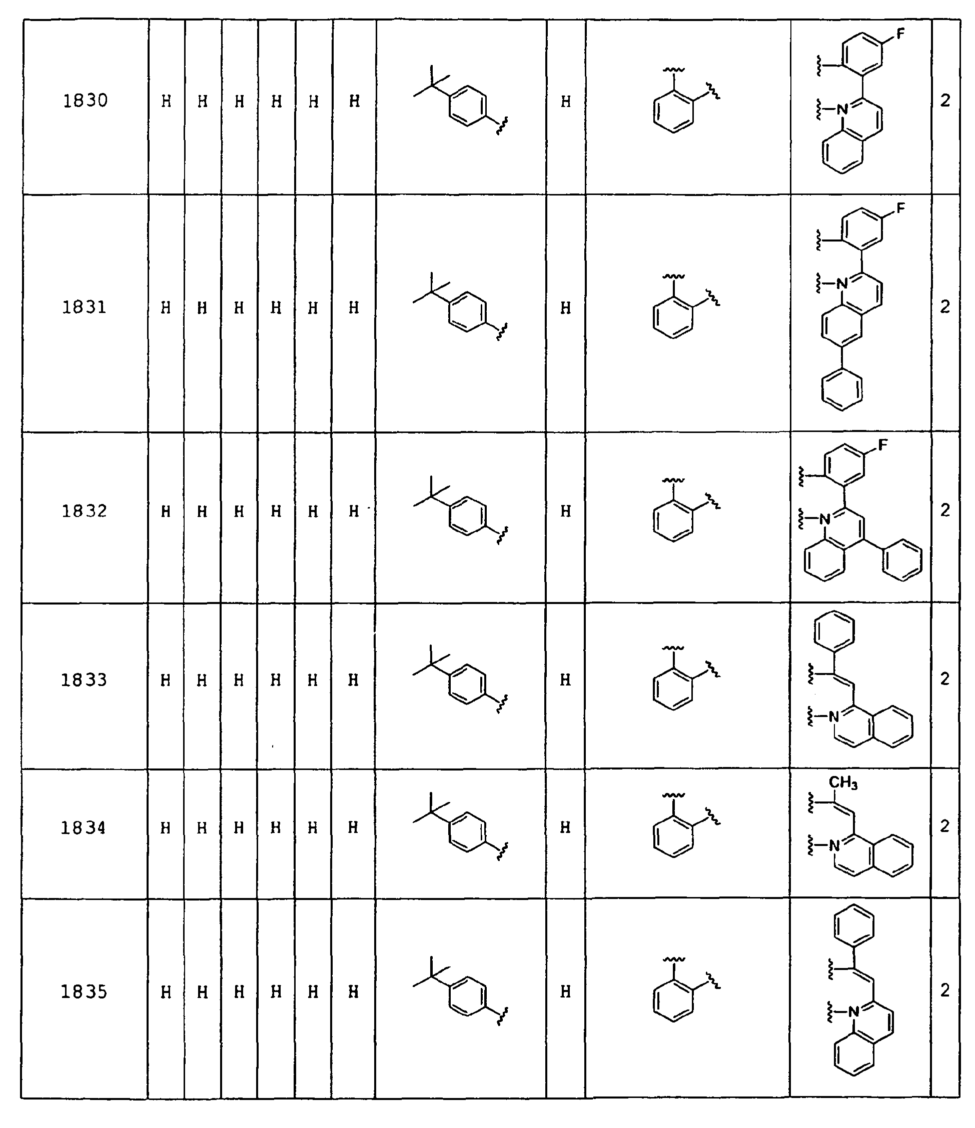

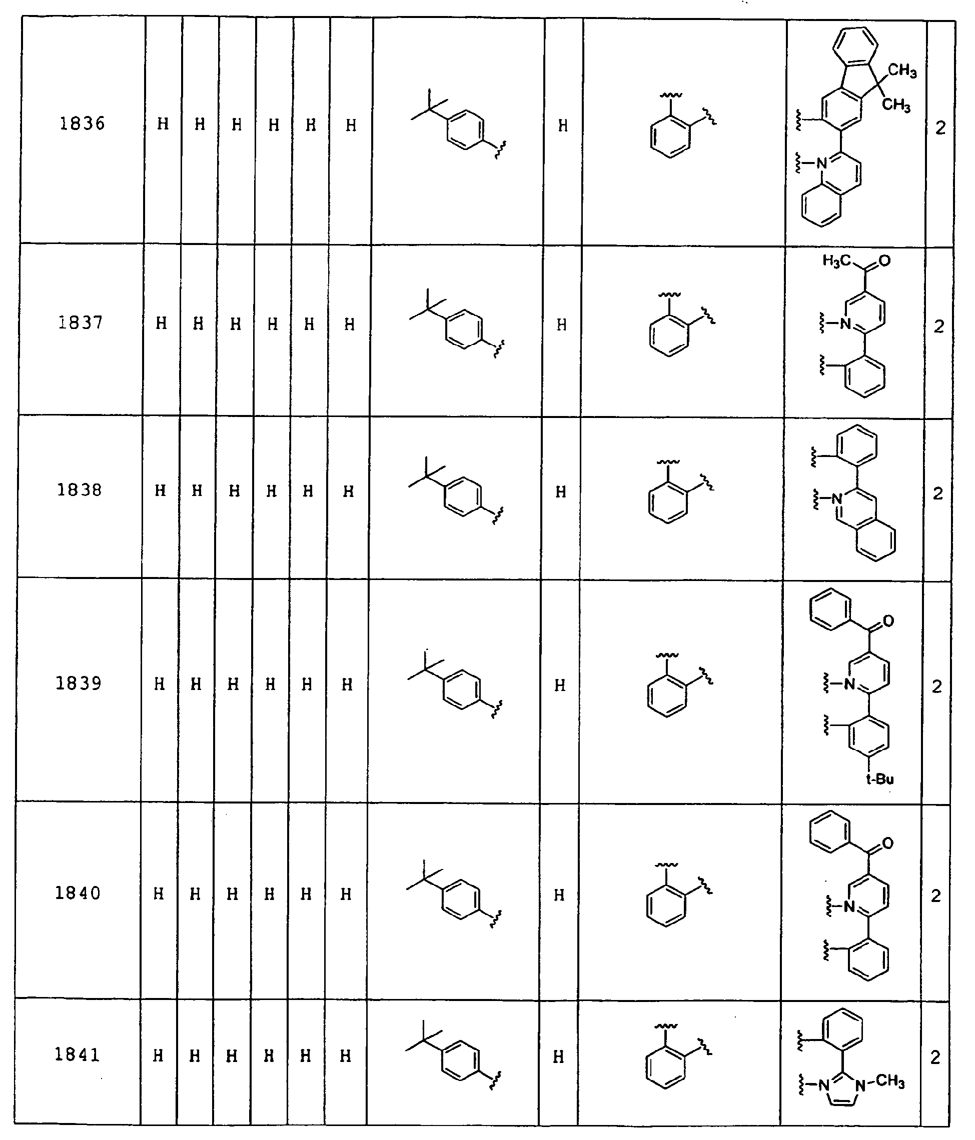

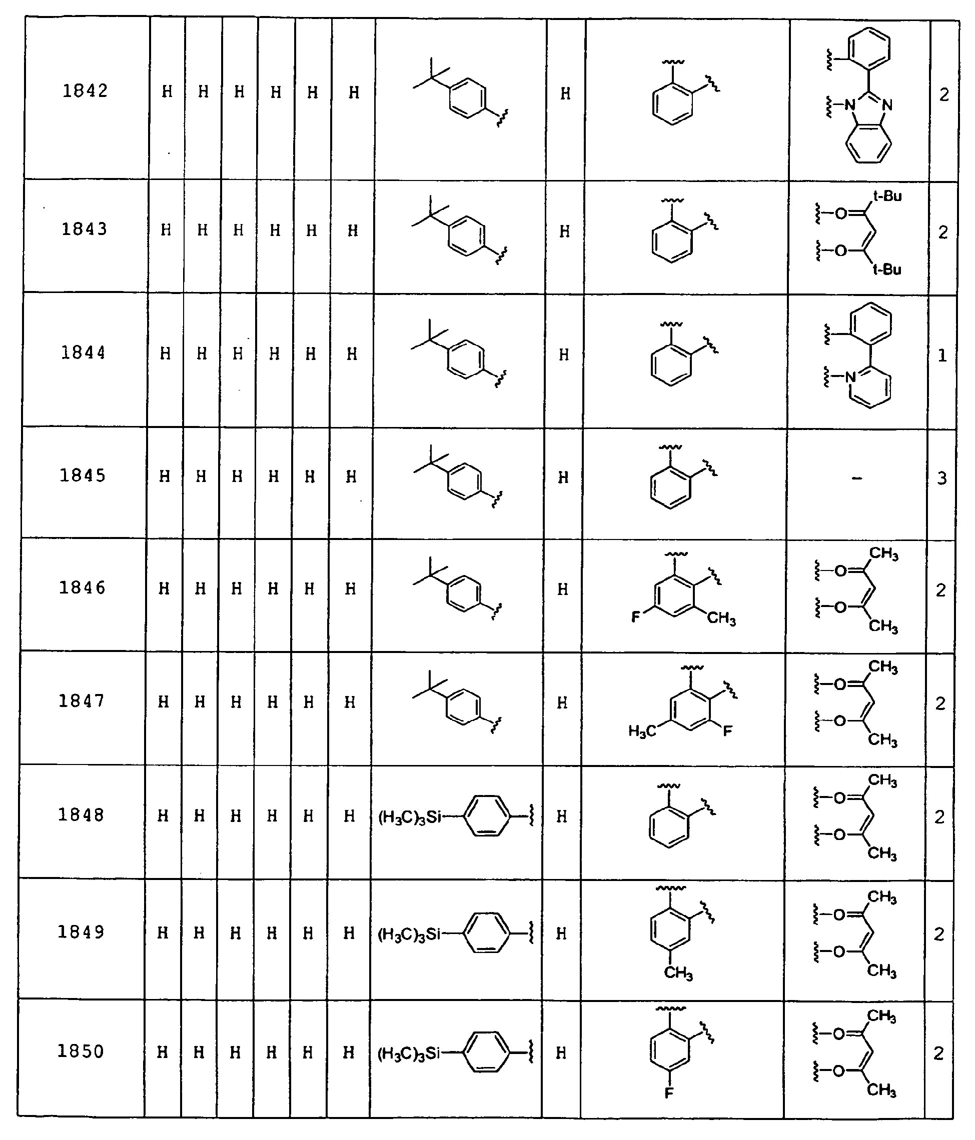

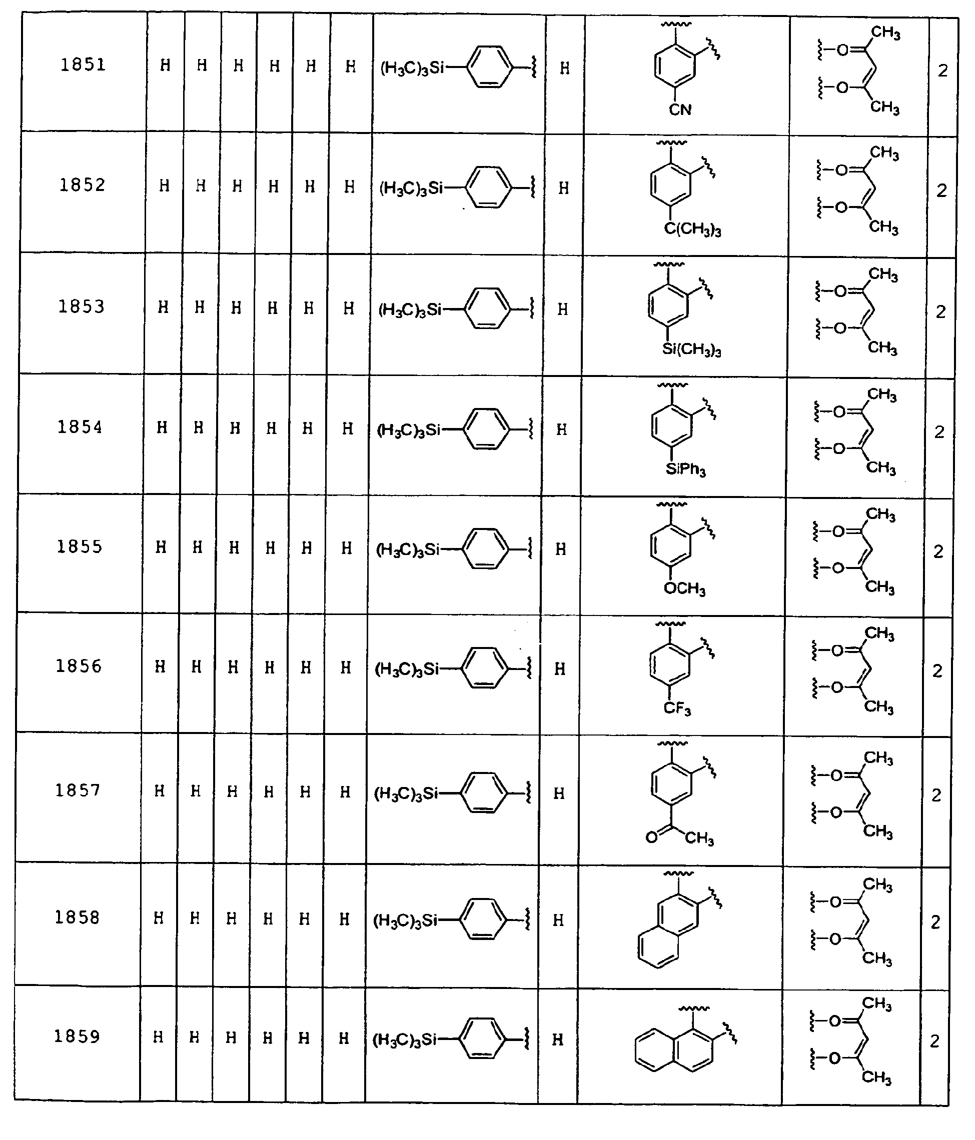

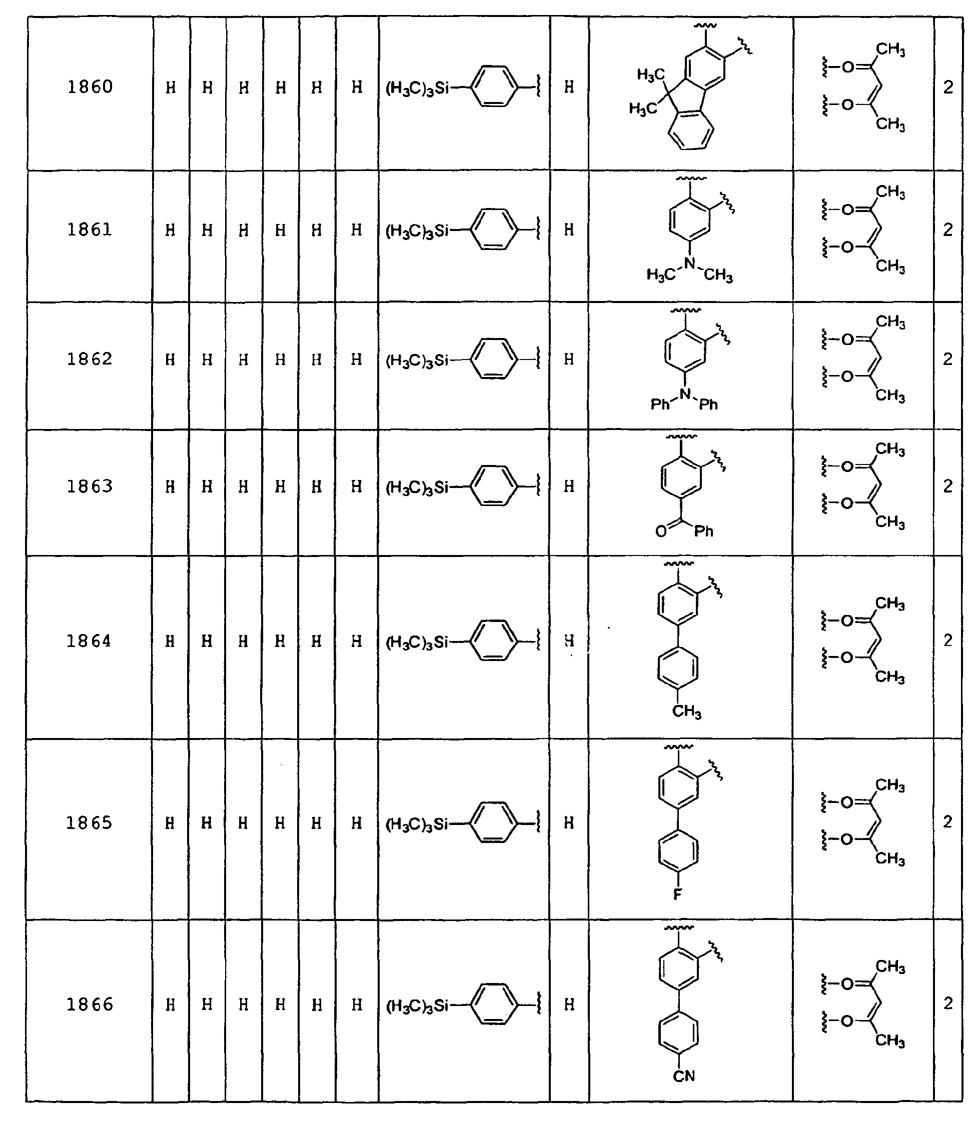

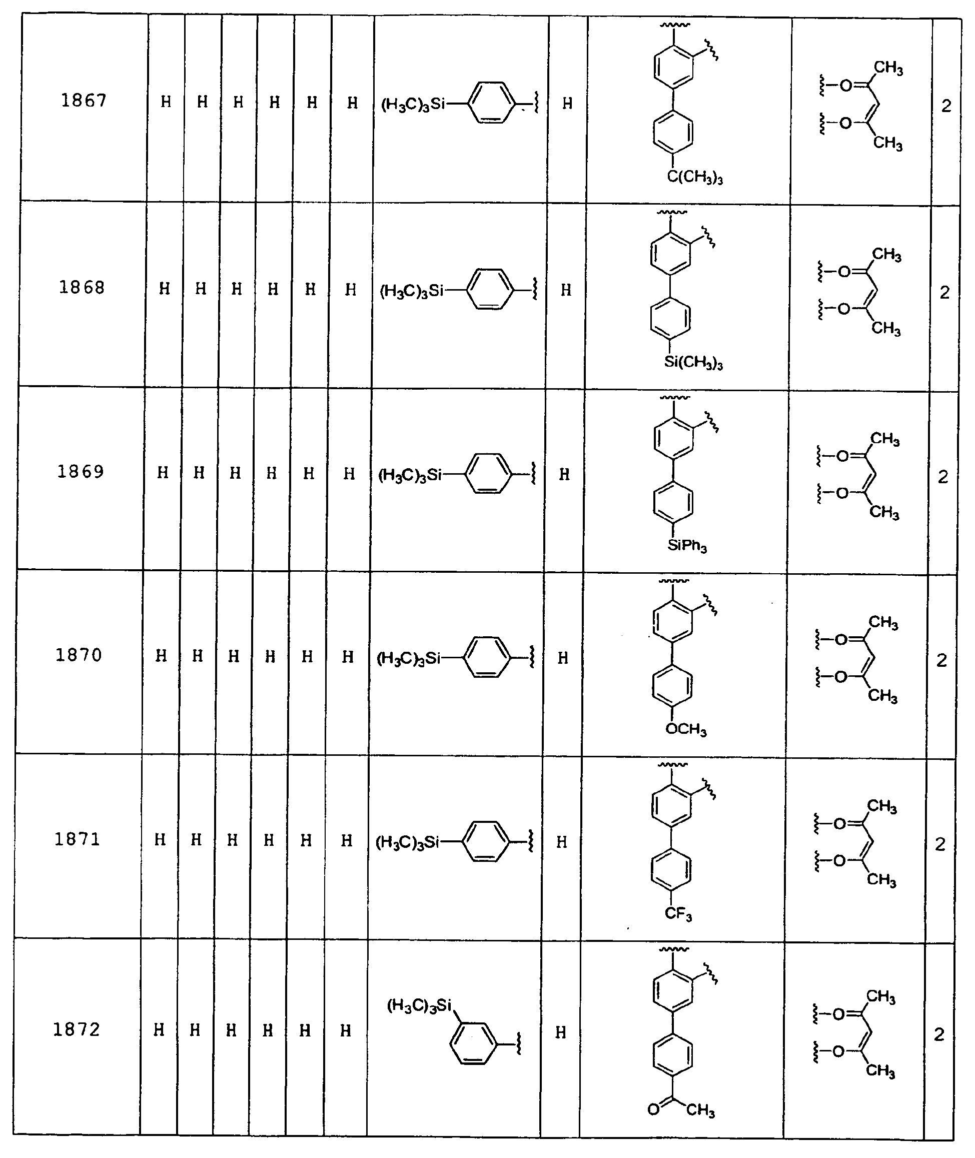

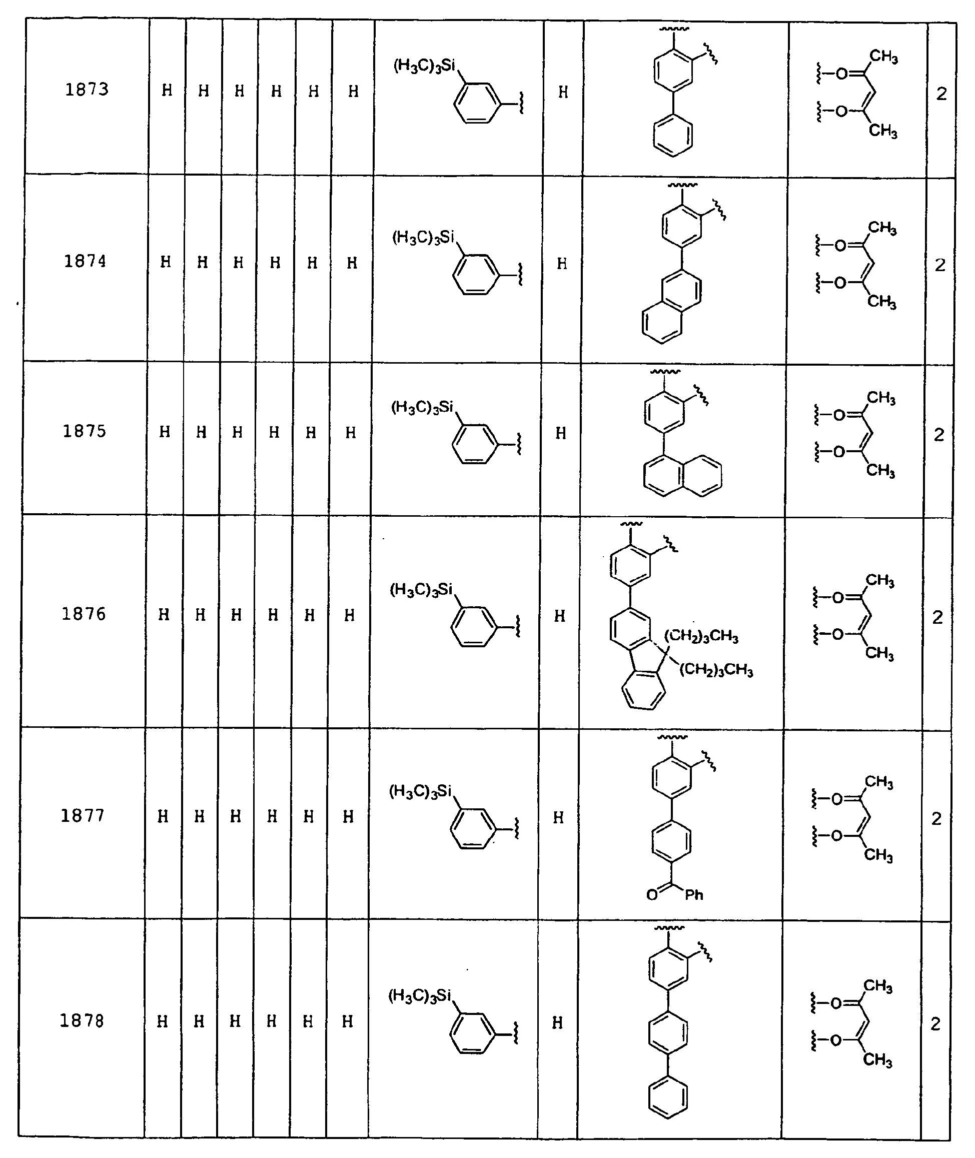

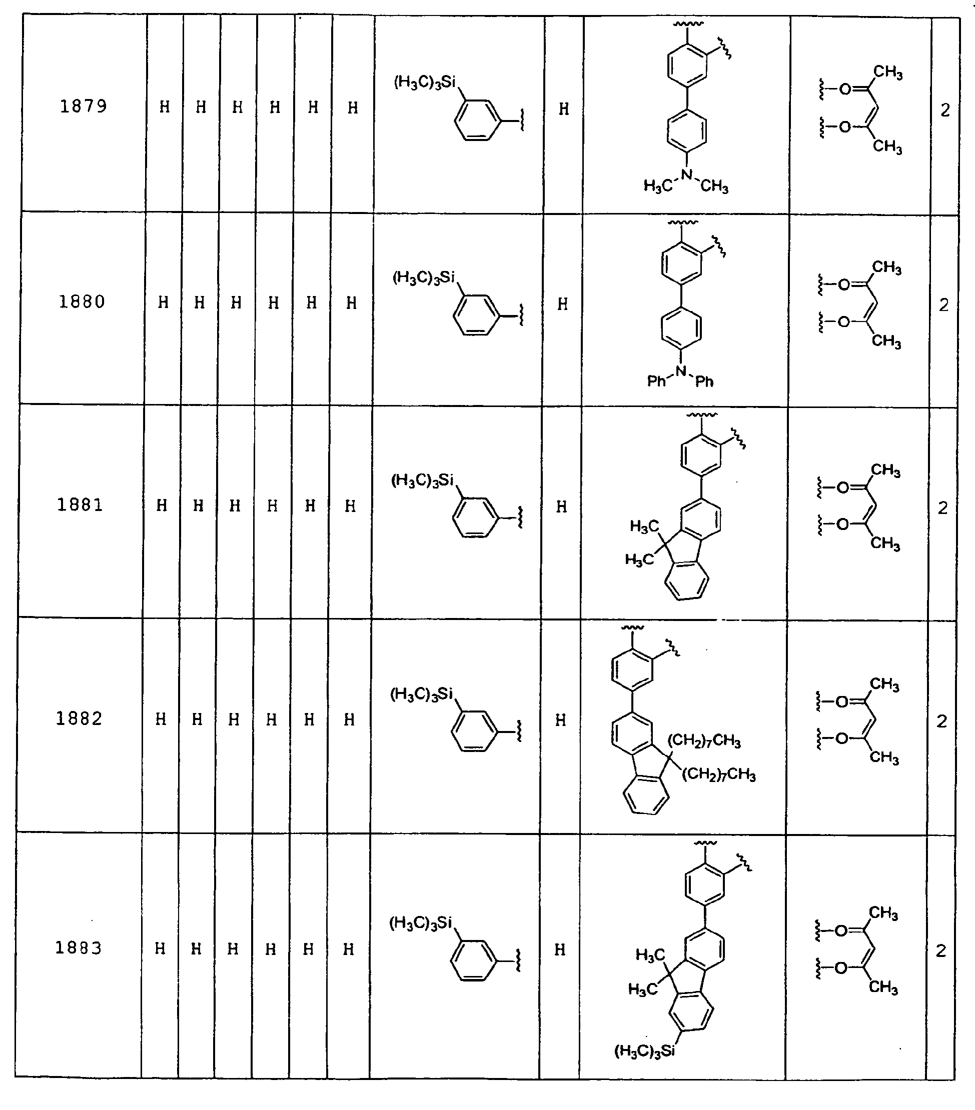

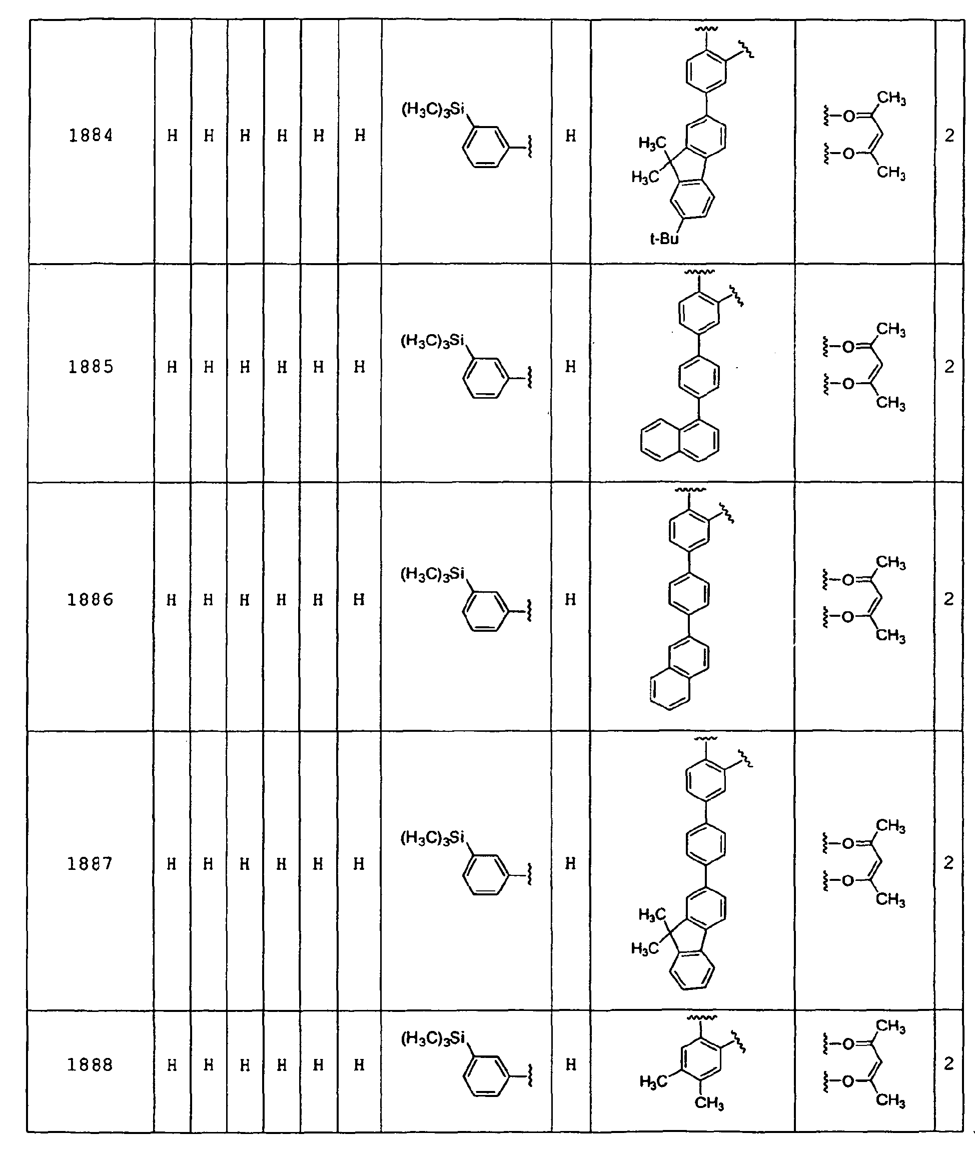

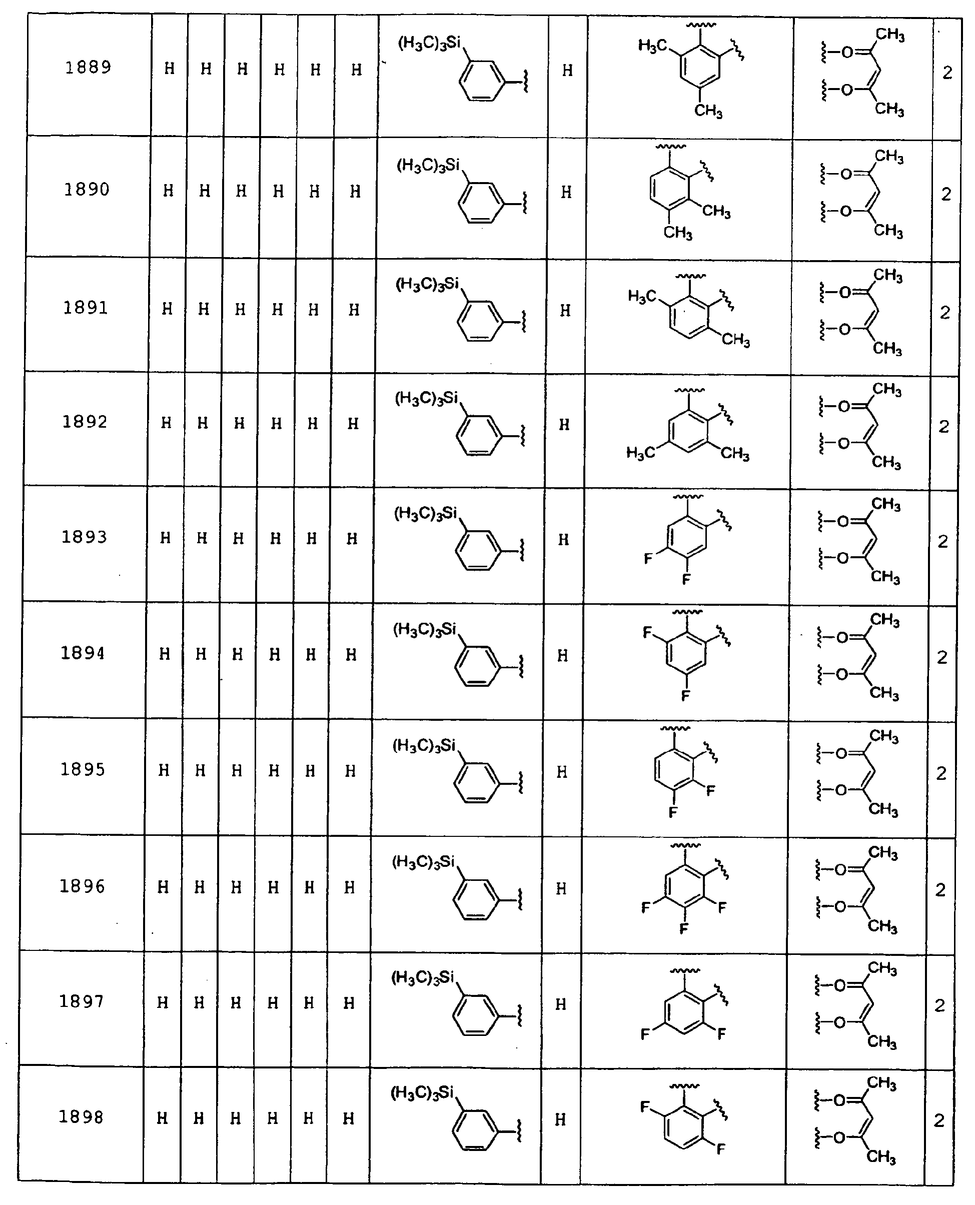

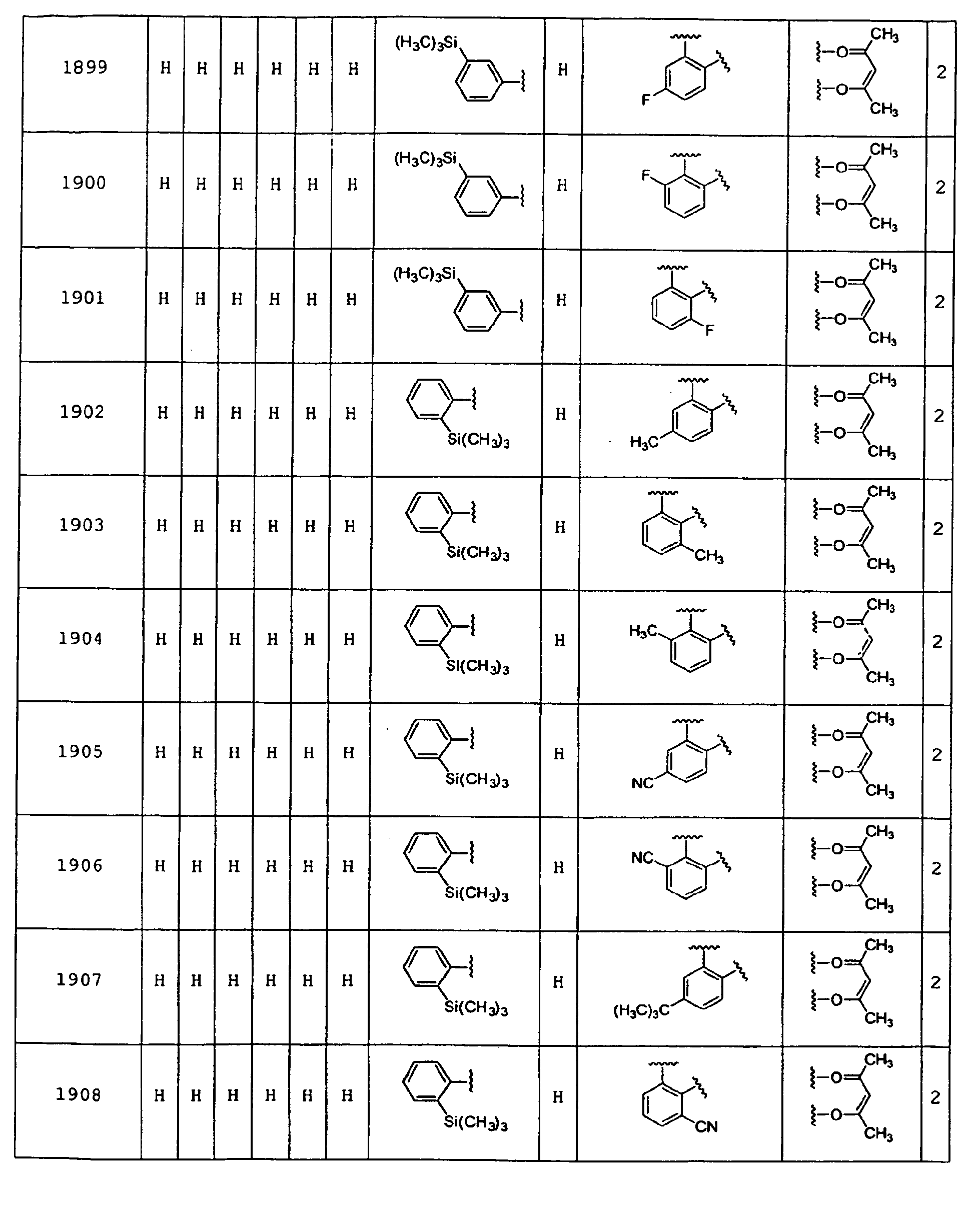

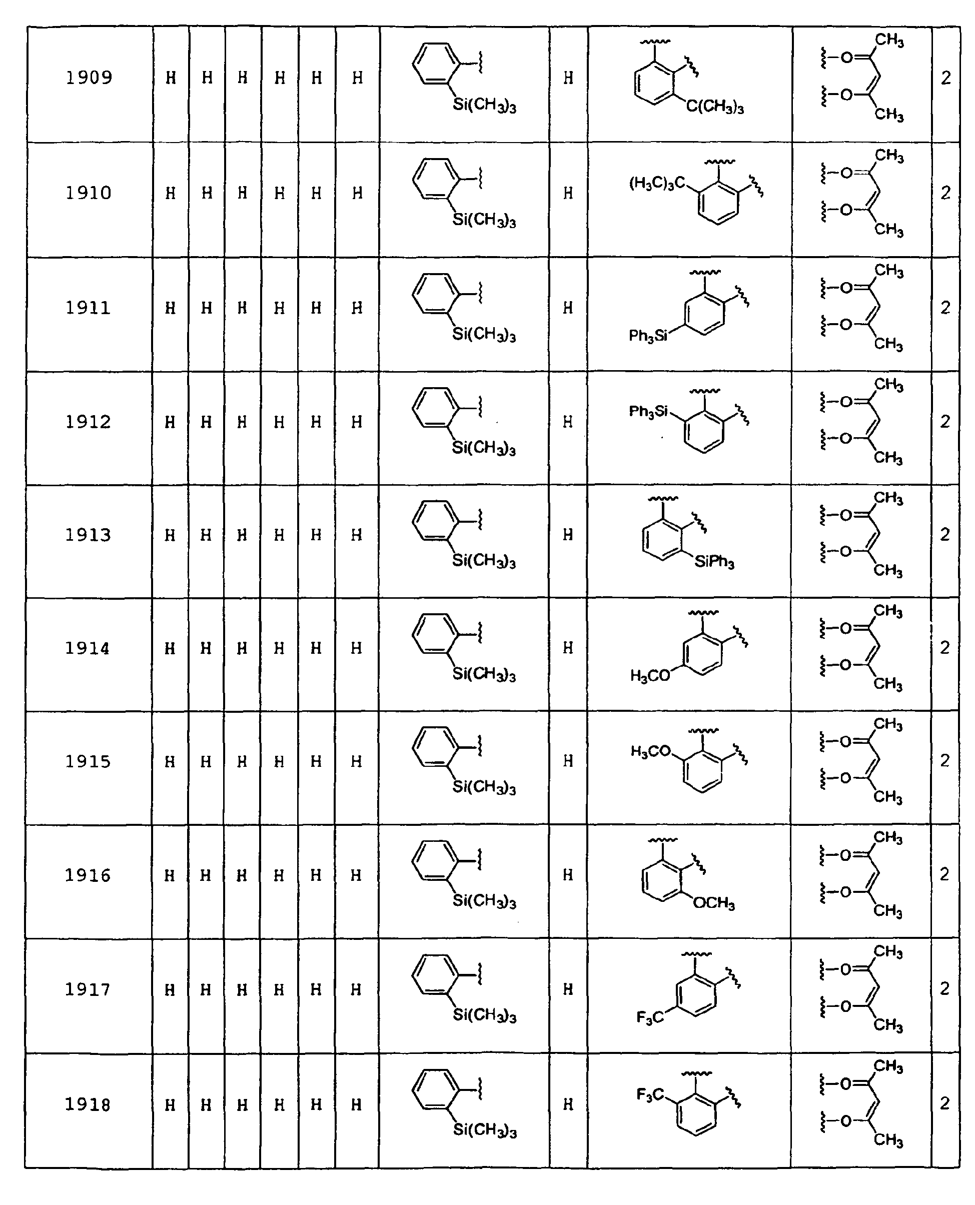

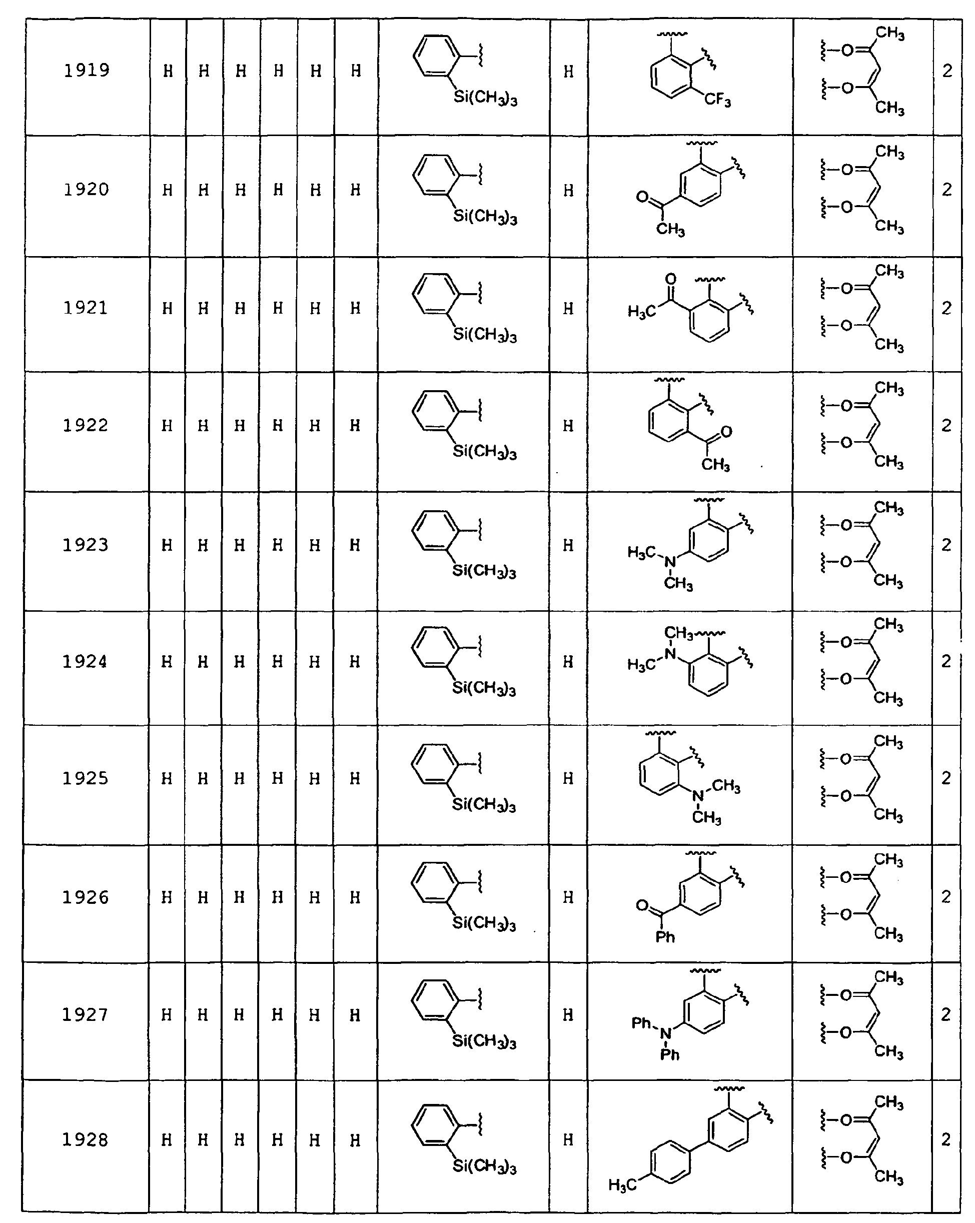

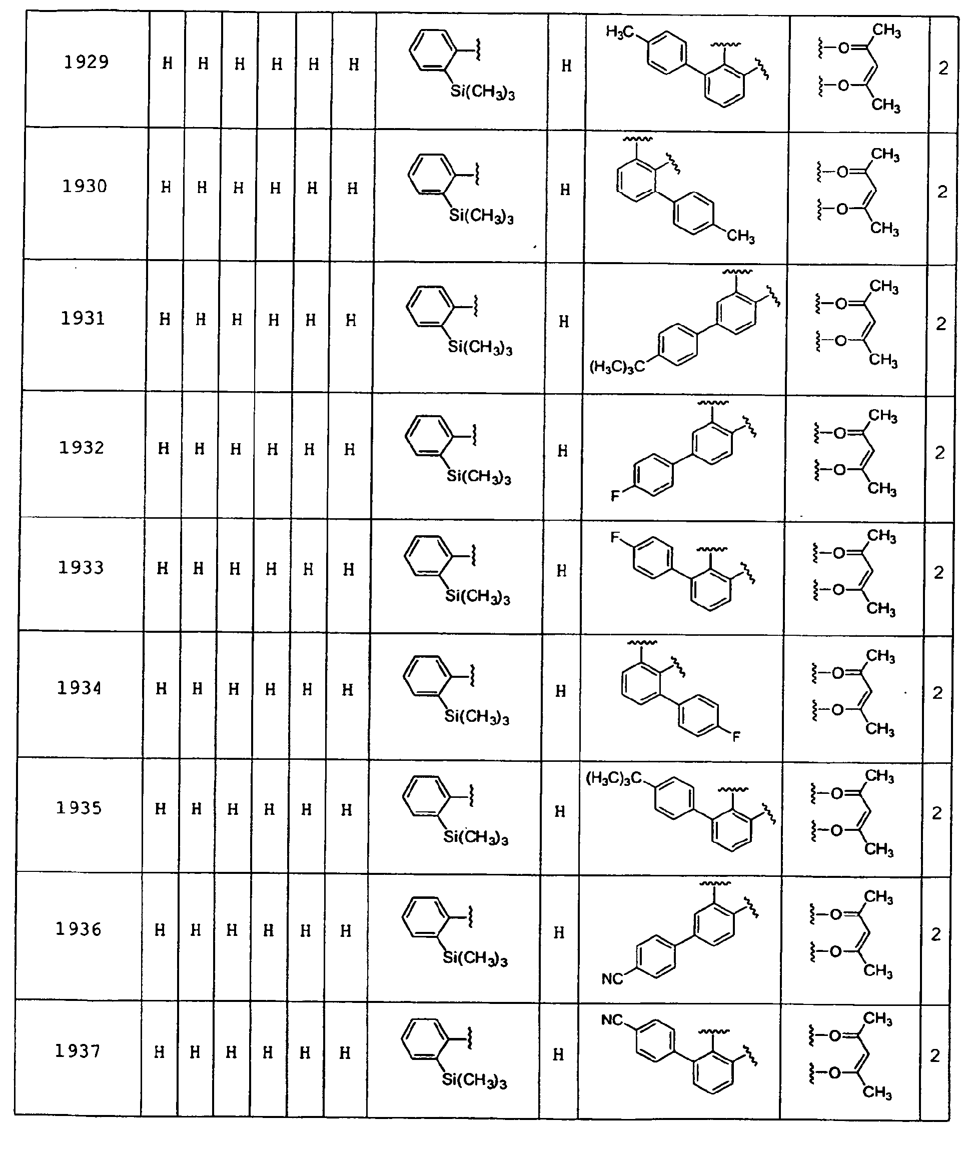

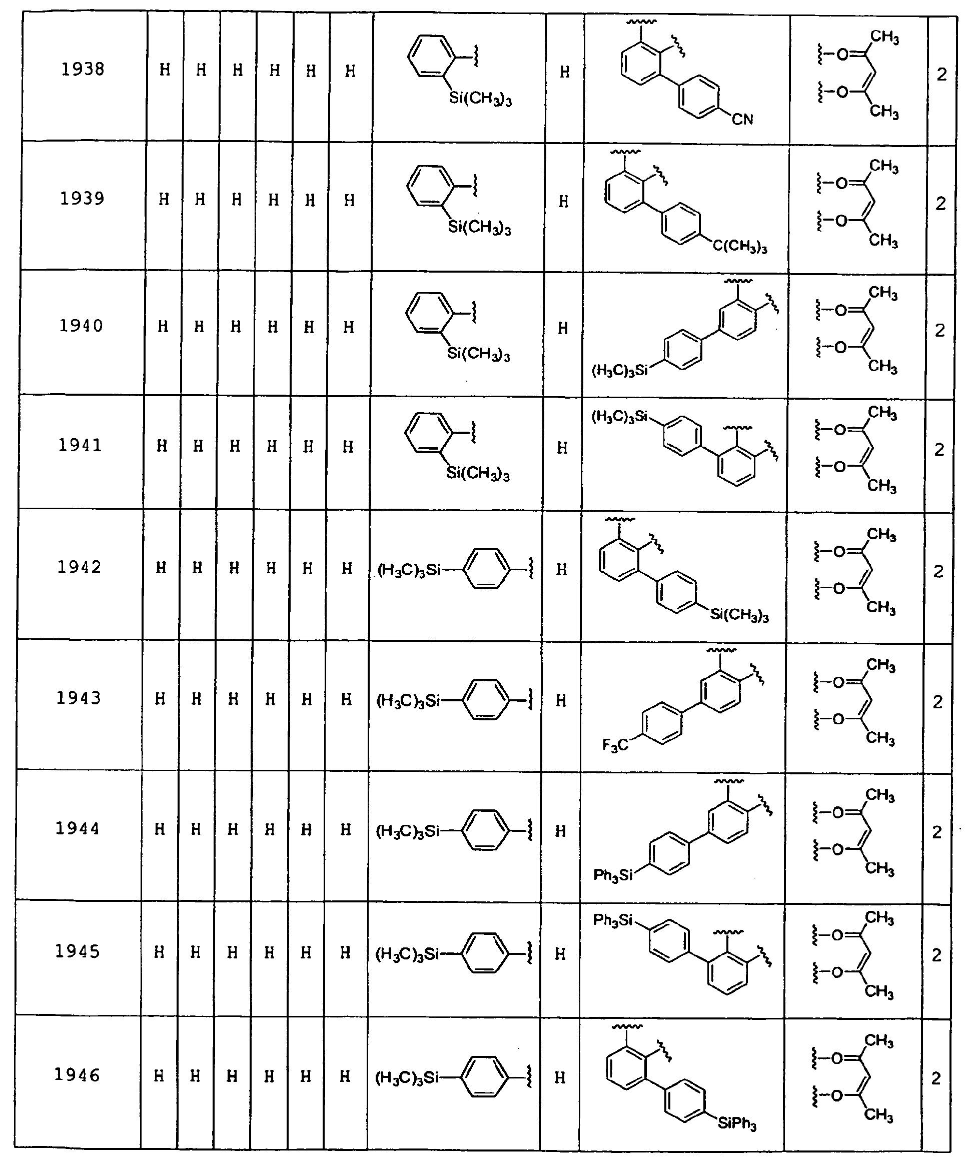

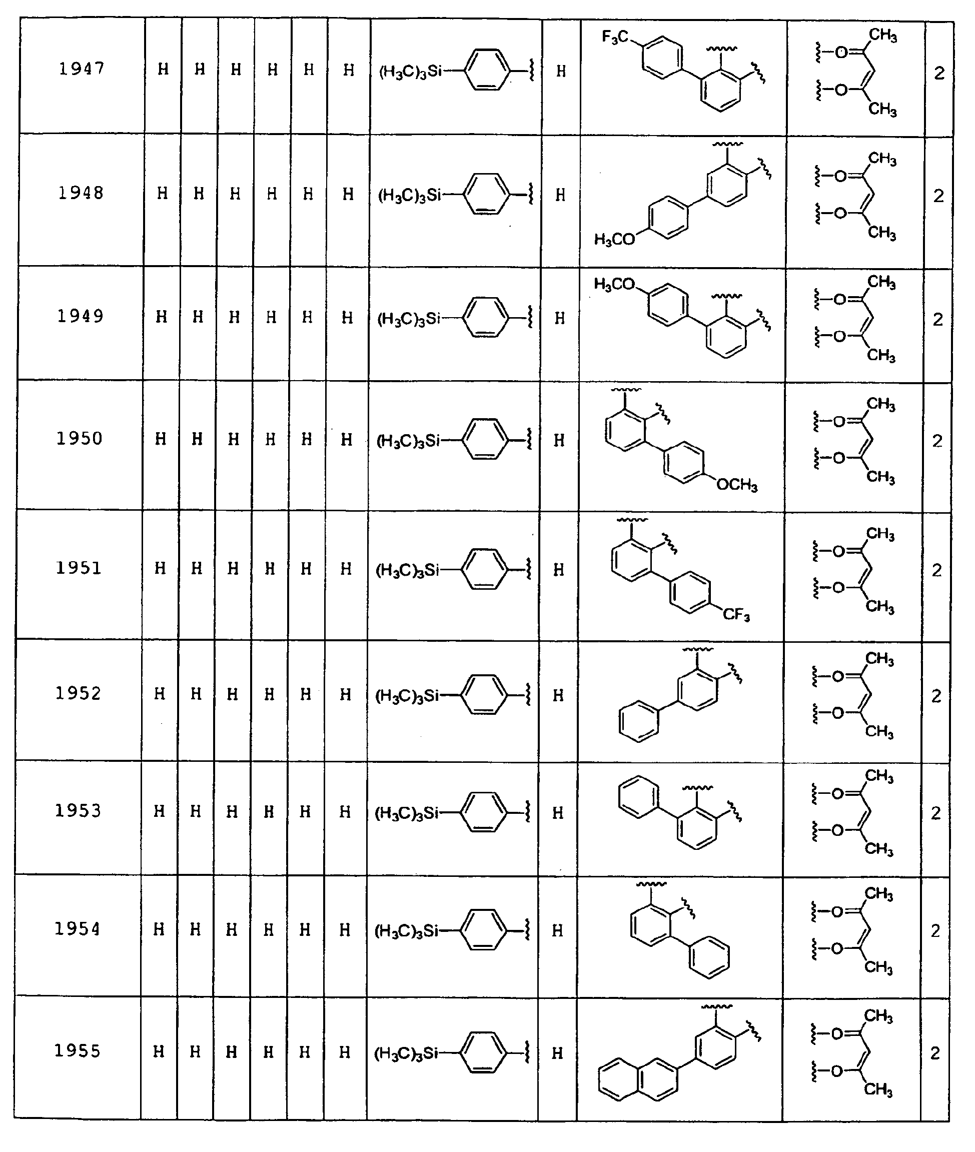

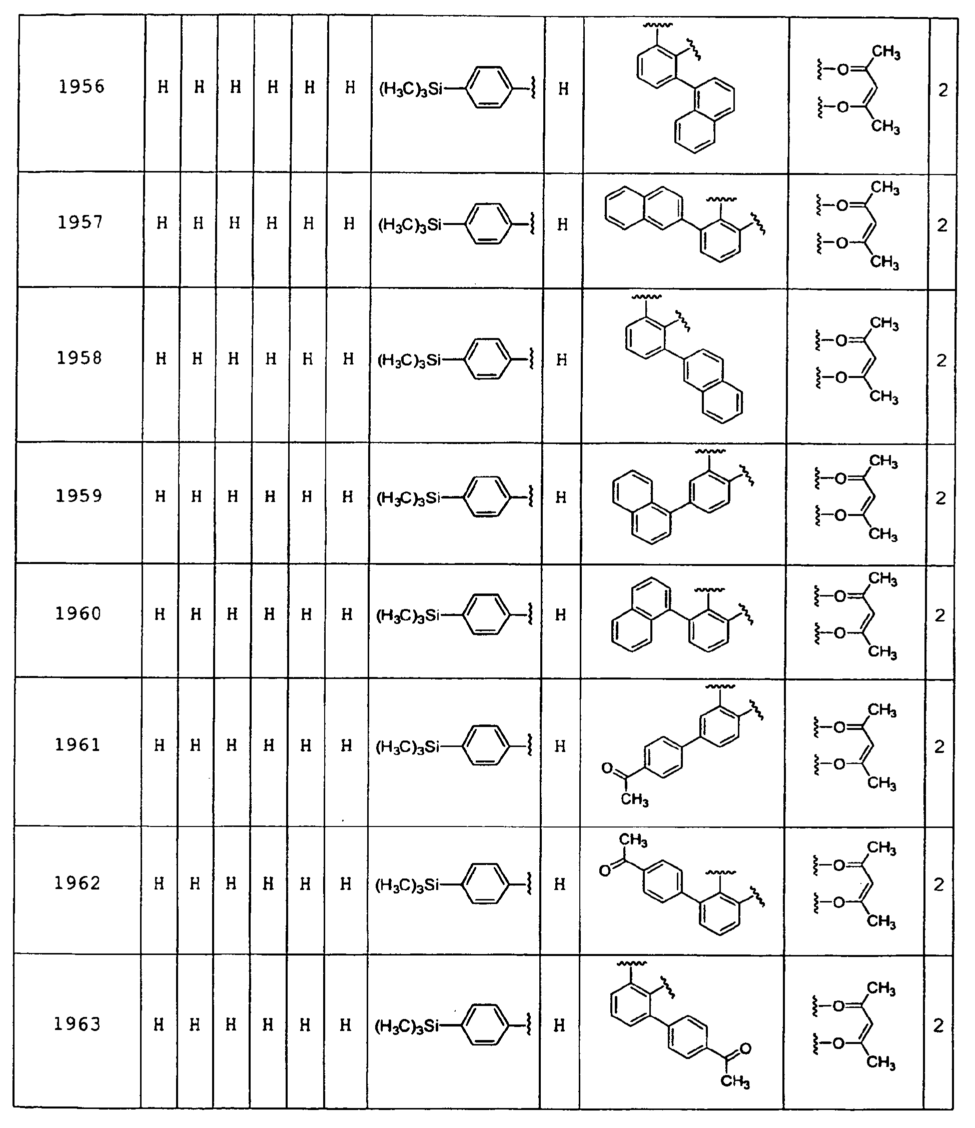

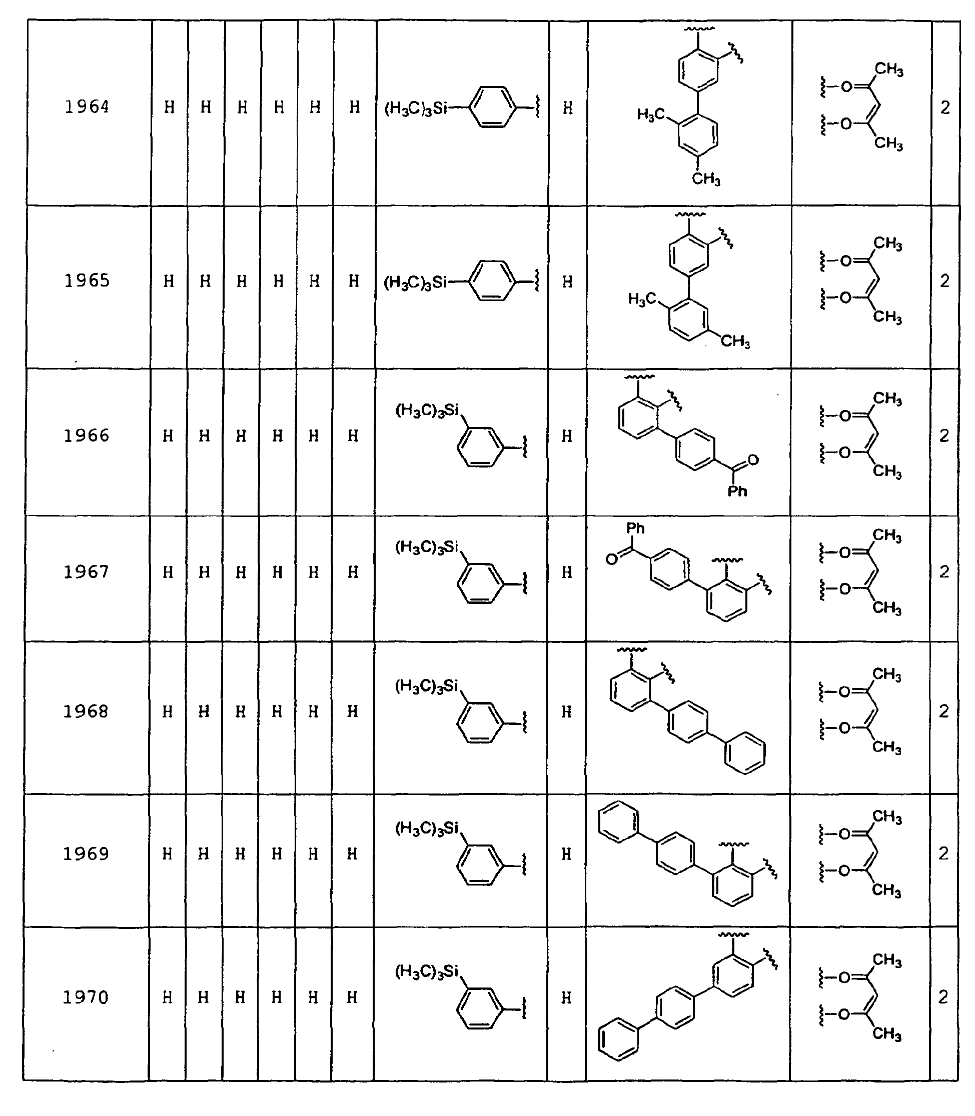

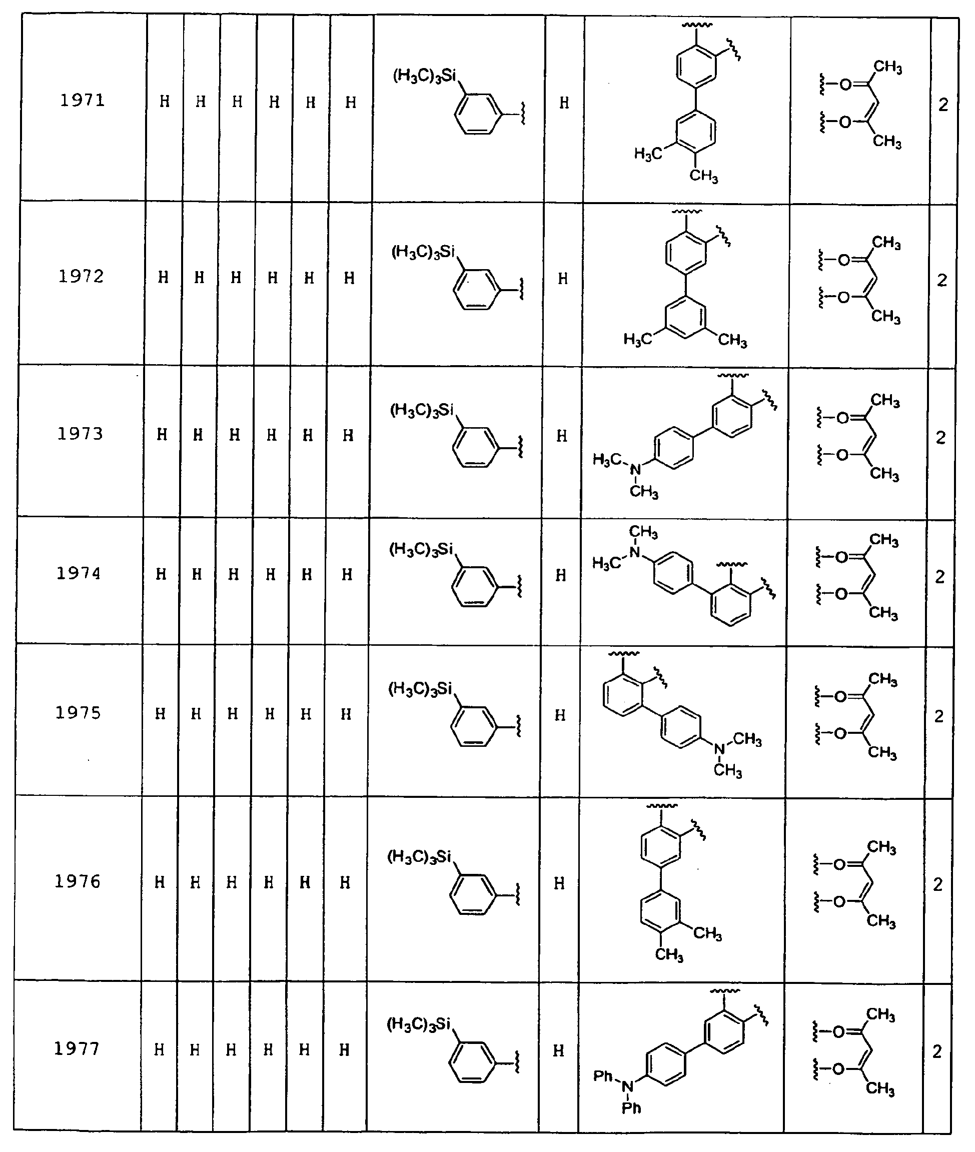

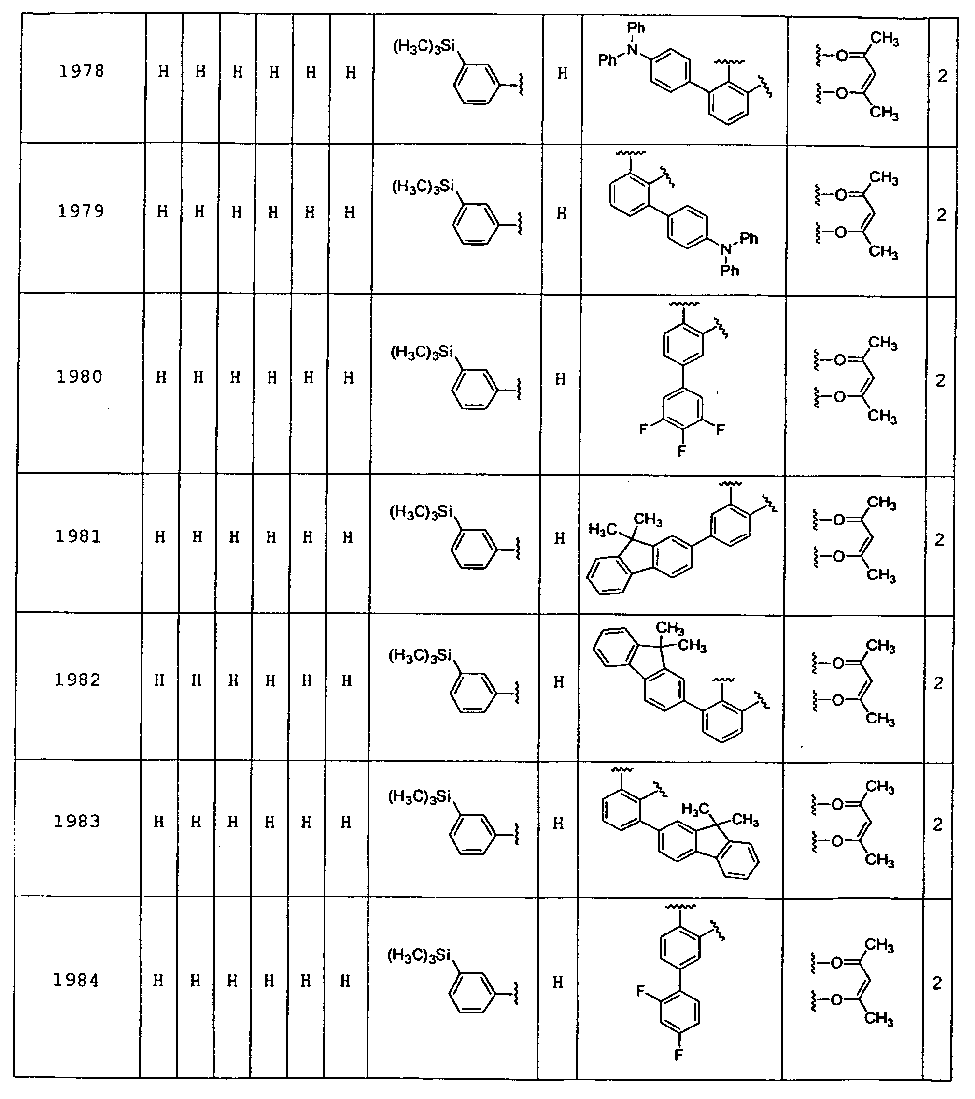

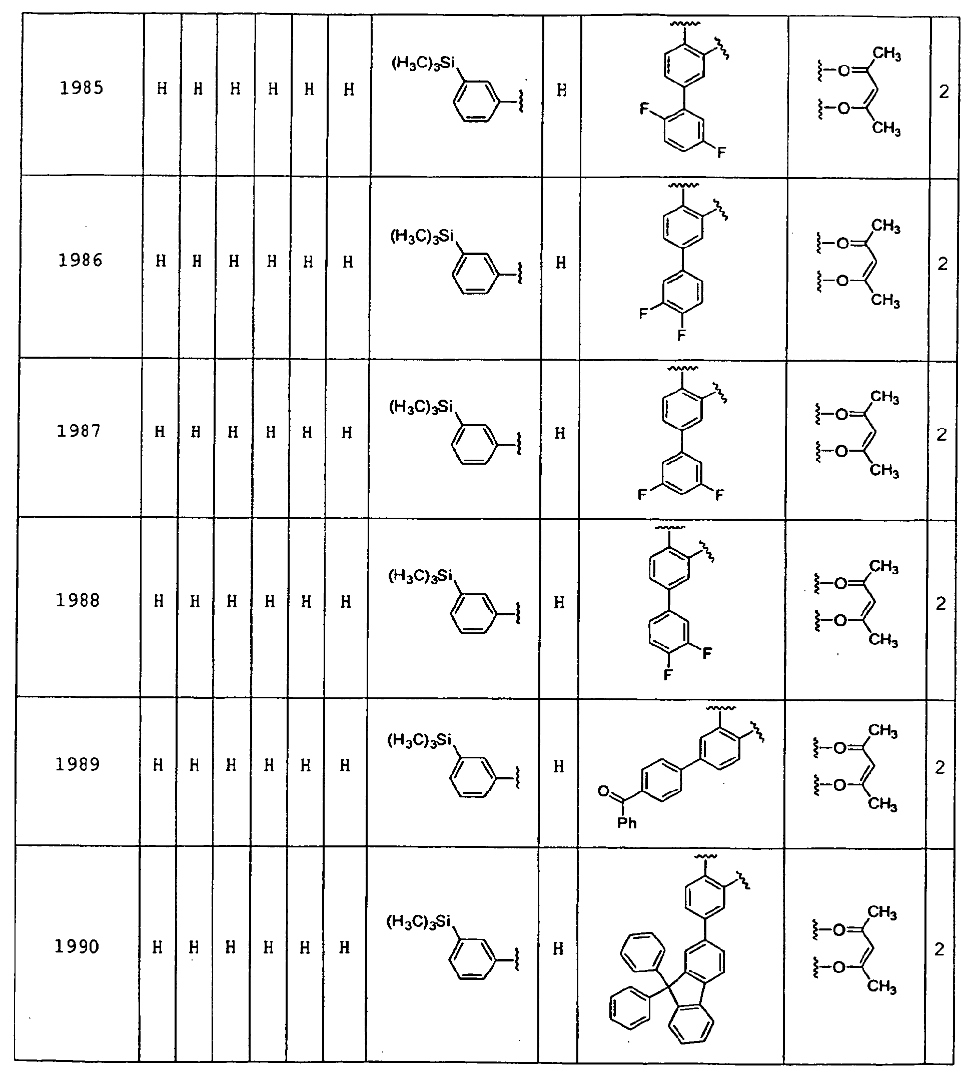

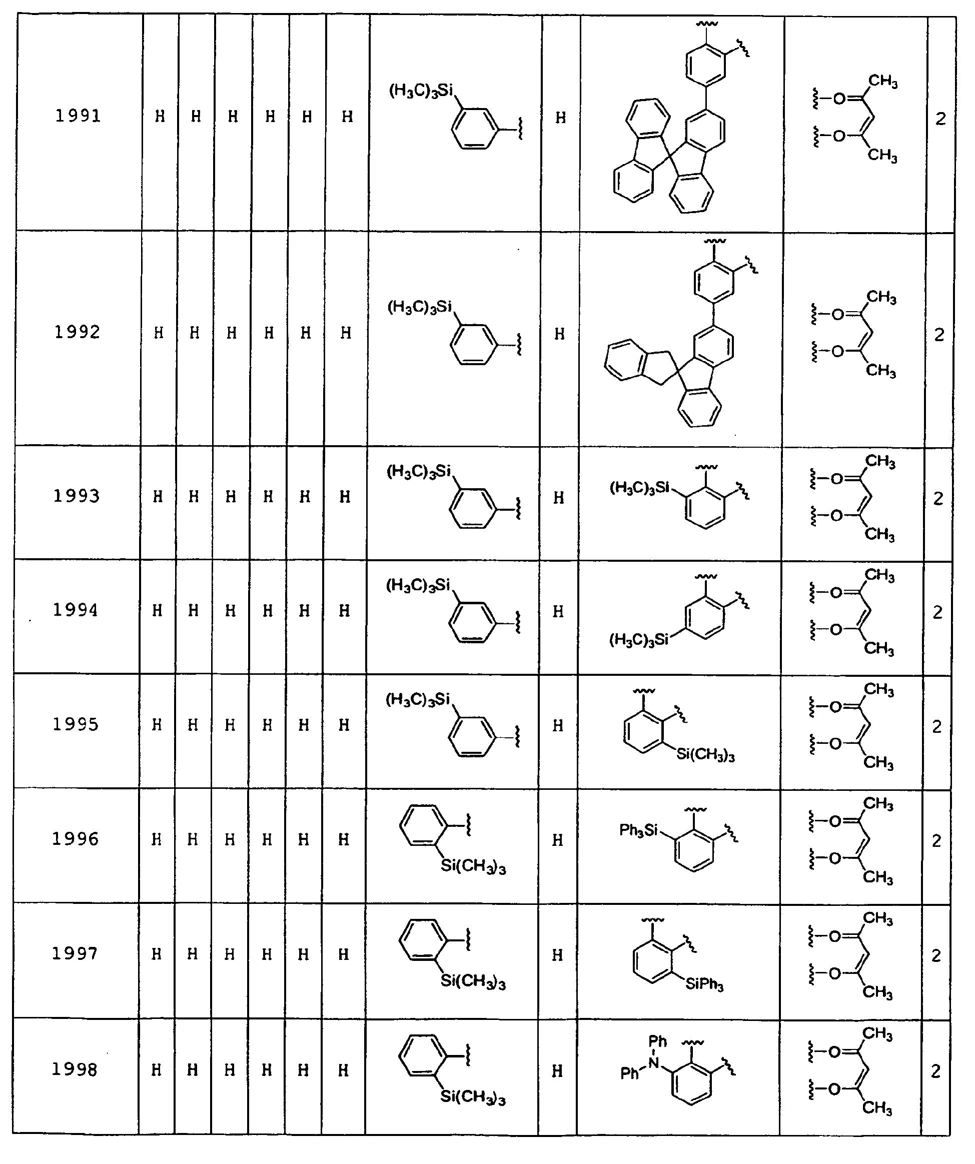

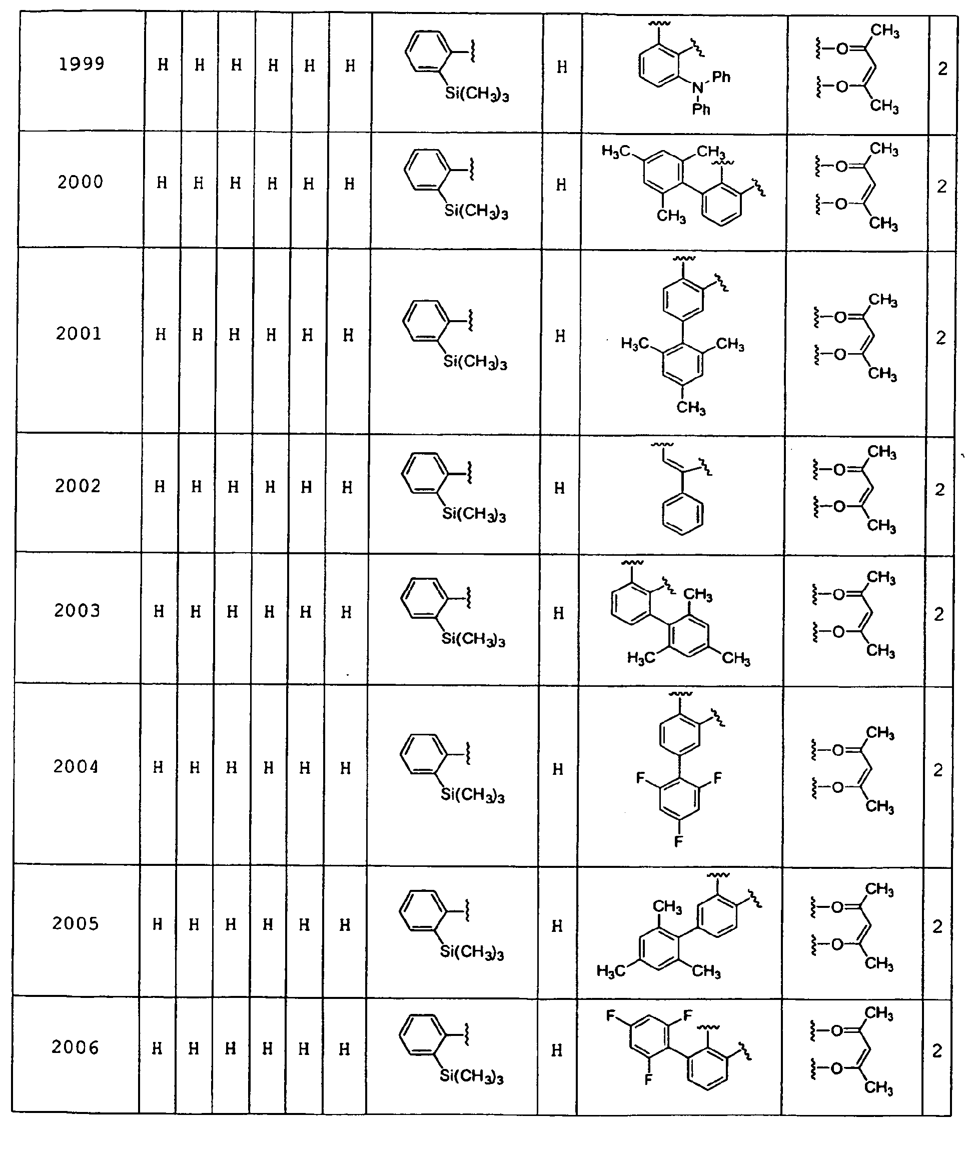

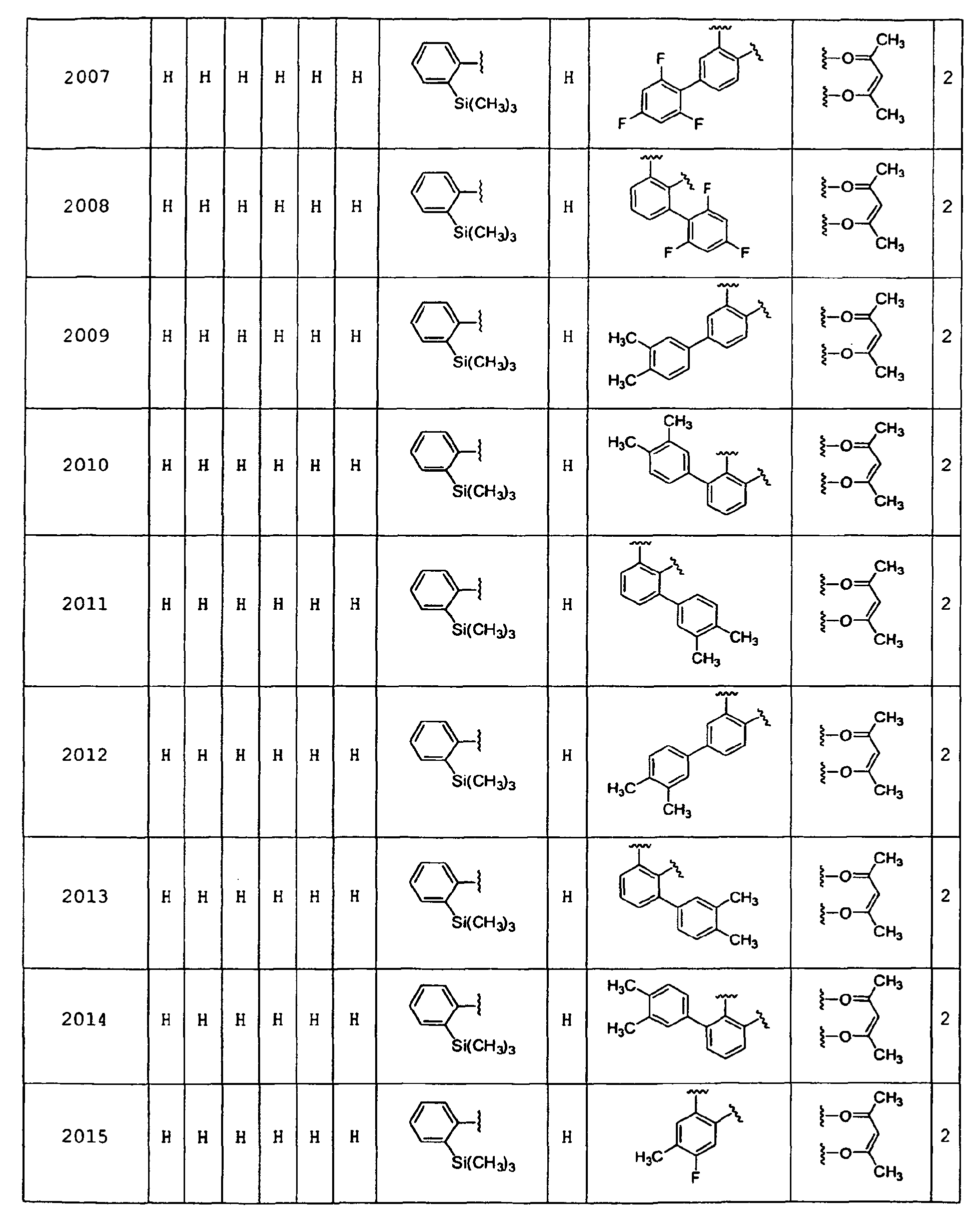

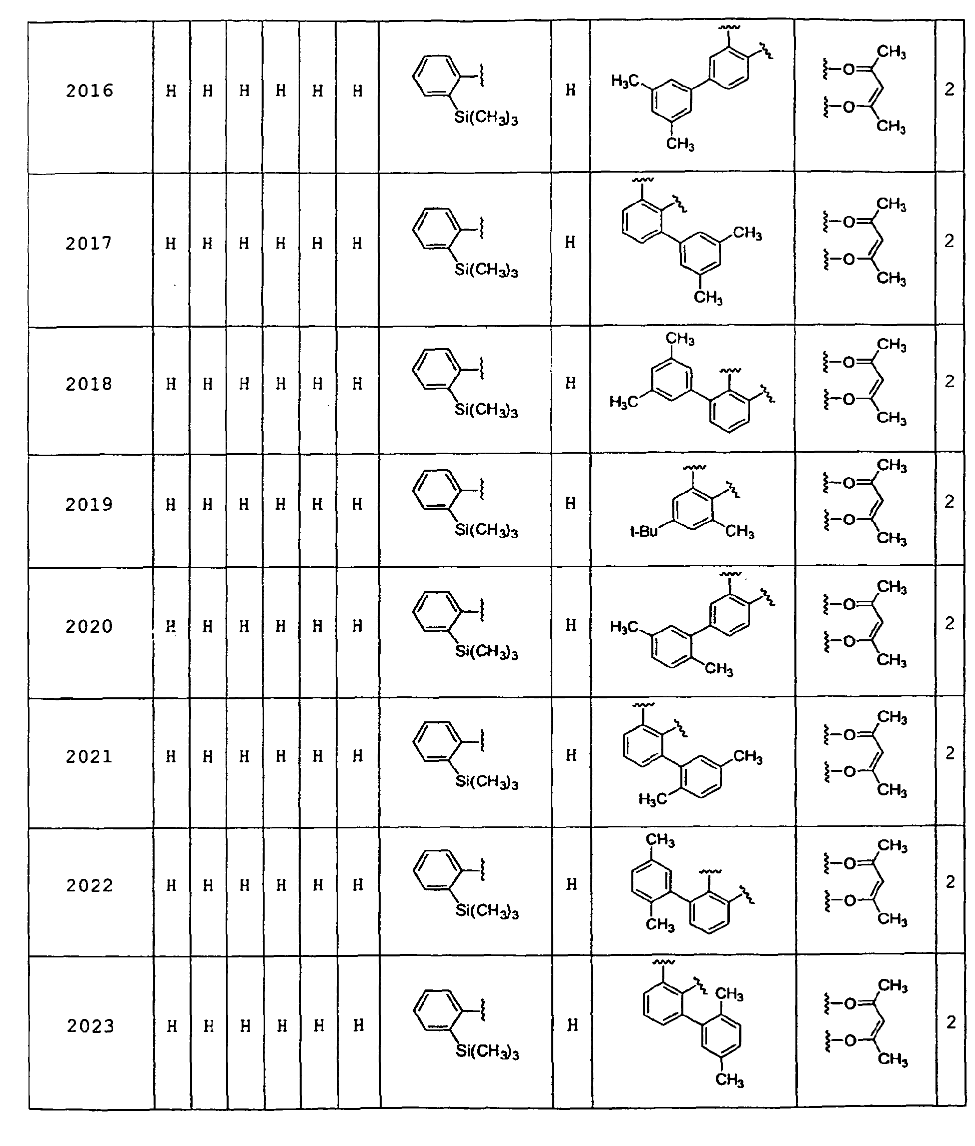

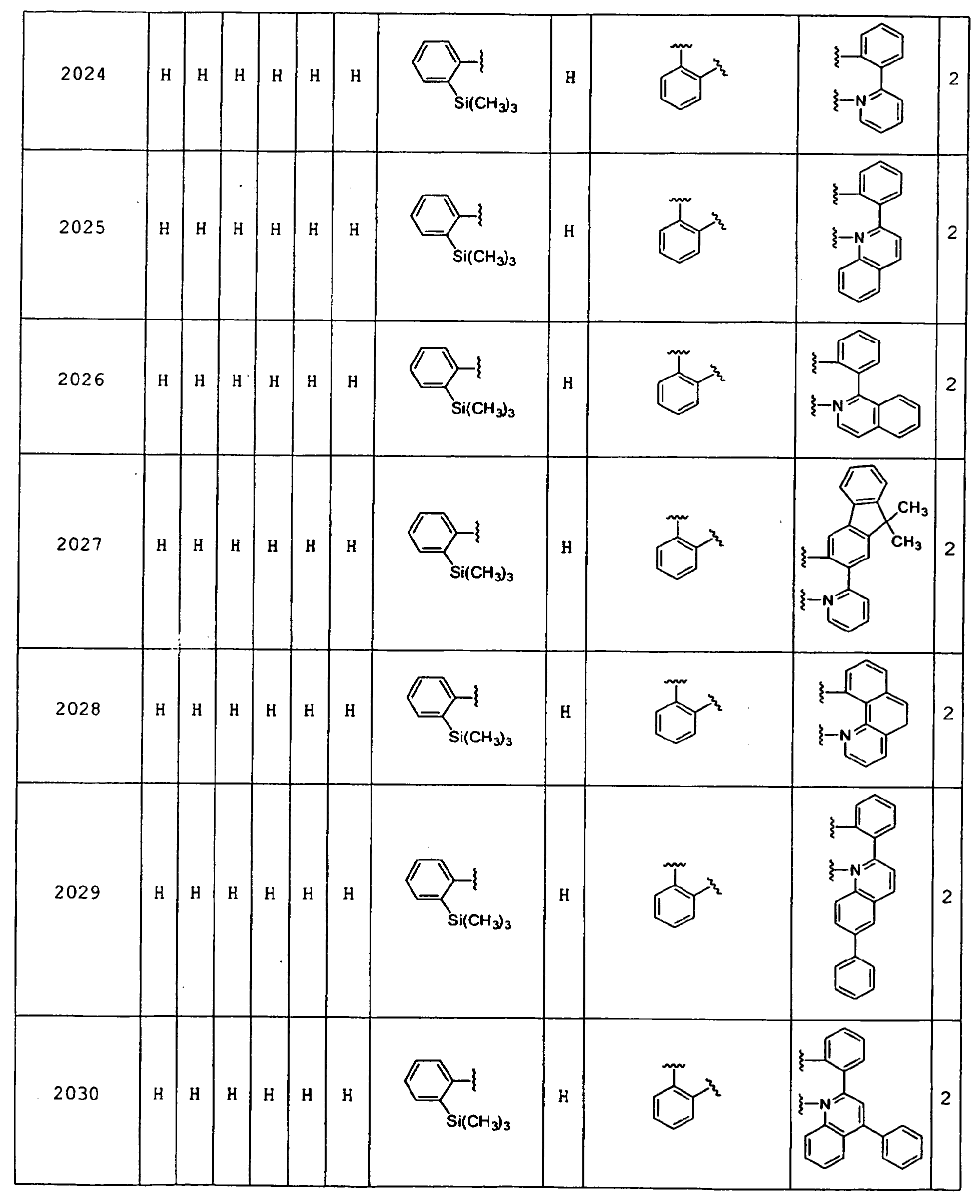

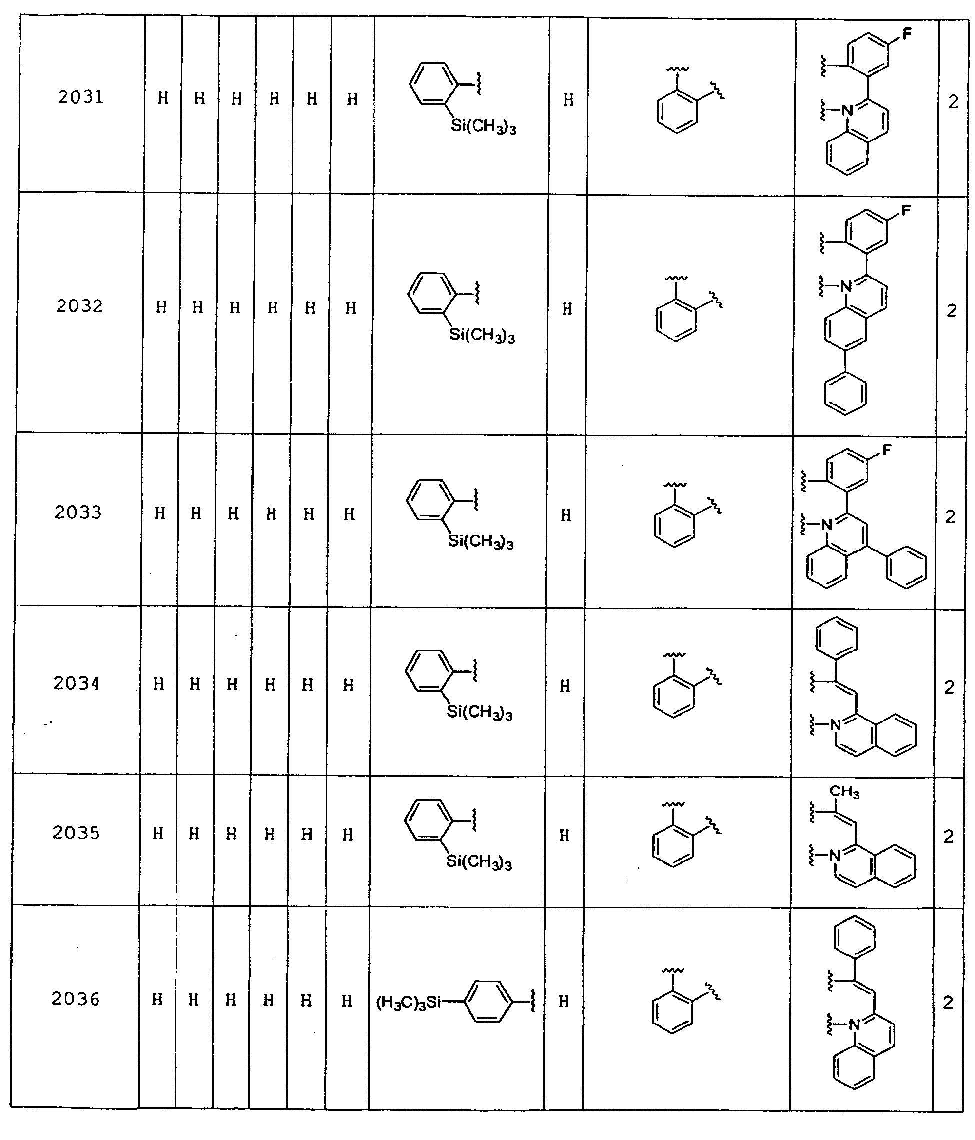

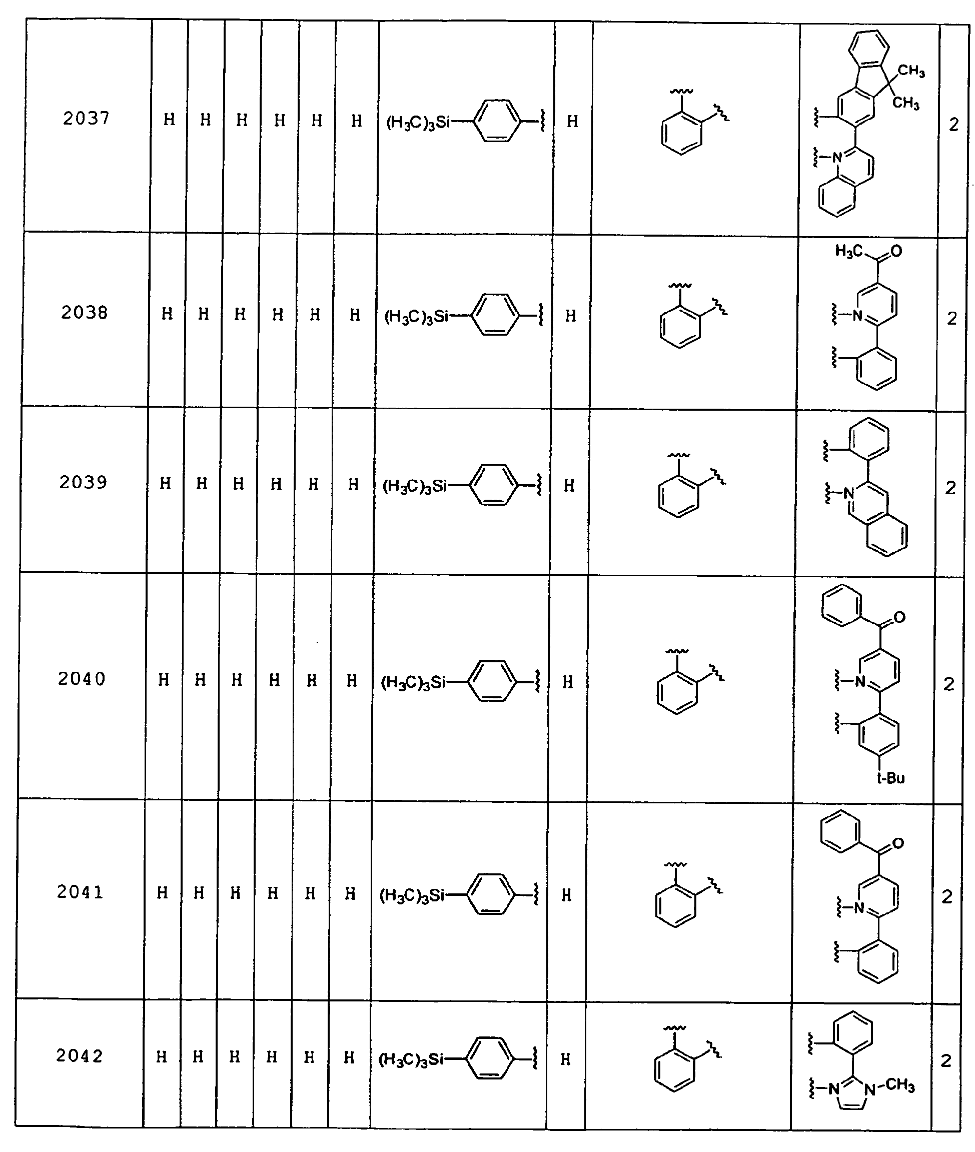

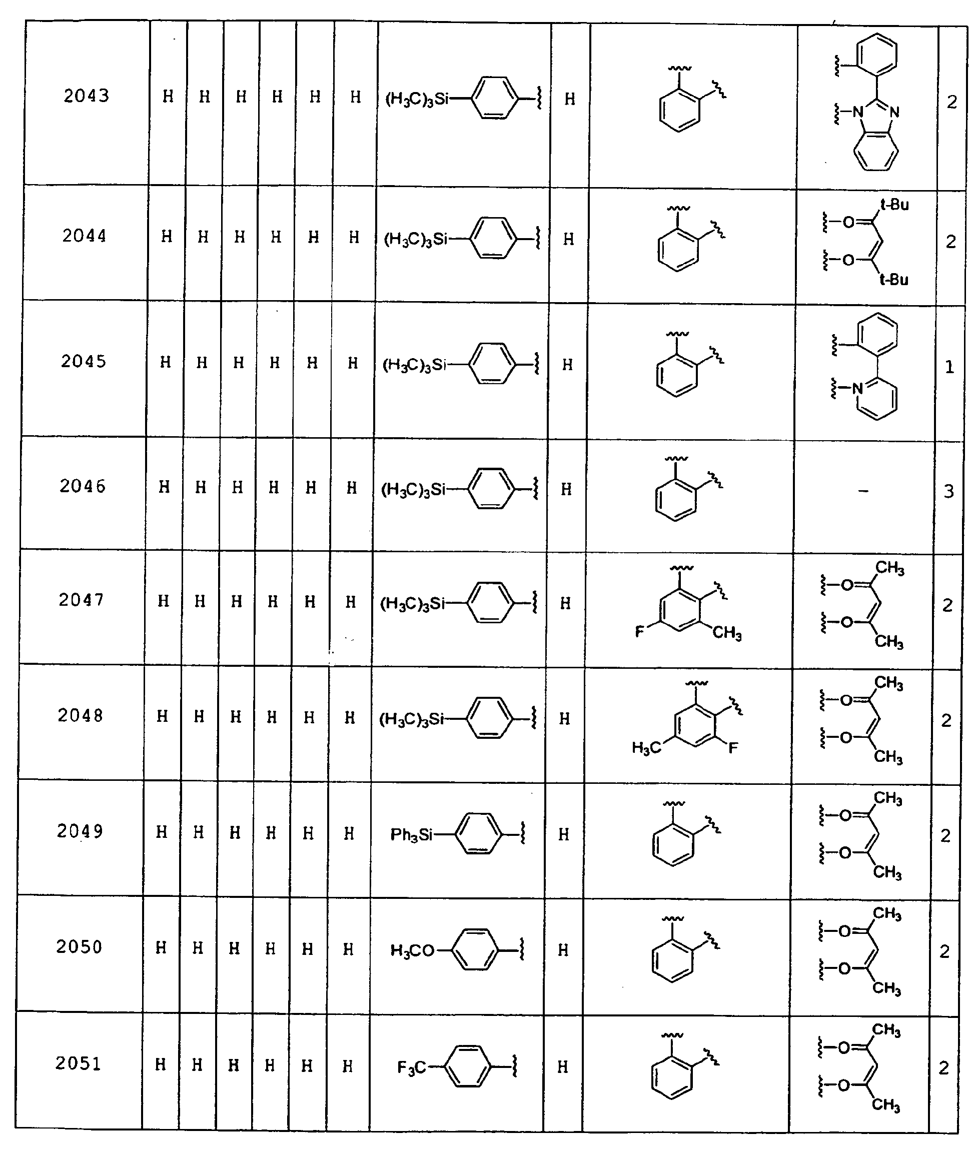

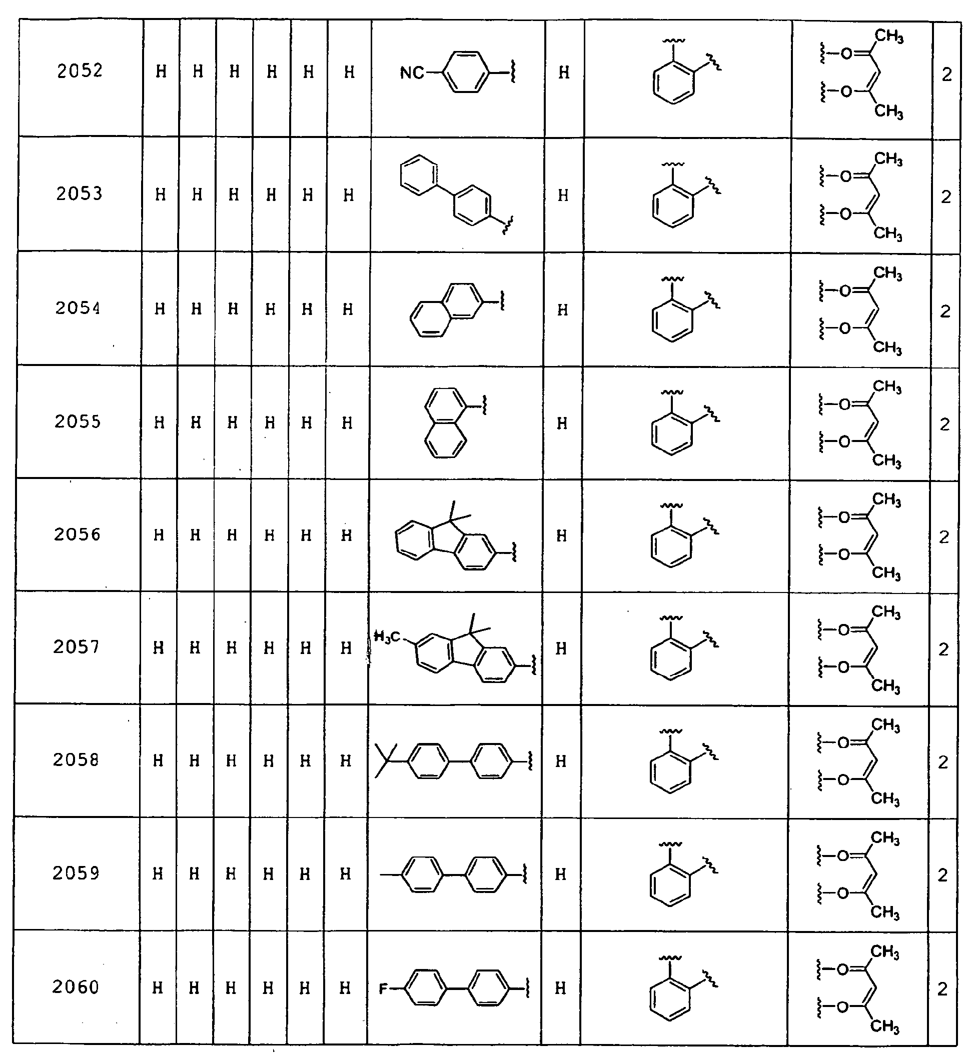

**Table 5**

| Compound No. | ¹H NMR(CDCl₃, 200 MHz) | MS/FAB | |
|---|---|---|---|
| | | found | calculated |
| **1** | δ = 8.40(s, 2H), 8.05(m, 2H), 7.76-7.61(m, 14H), 7.42(m, 2H), 7.32(m, 8H), 4.60(s, 1H), 2.08(s, 6H) | 899 | 900.06 |
| **21** | δ = 2.05(s, 6H), 4.60(s, 1H), 7.35(2H, m), 7.47(2H, m), 7.54(4H, m), 7.67(4H, m), 7.81(1H, m), 8.06~8.1(4H, m), 8.16(2H, m), 8.3(2H, m), 8.51(2H, m) | 799.94 | 800.20 |
| **75** | δ = 2.05(s, 6H), 2.34(6H, s), 4.60(s, 1H), 7.25(2H, m), 7.35(2H, m), 7.42(2H, m), 7.67(4H, m), 7.81(2H, m), 8.06-8.16(6H, m), 8.3(2H, m), 8.51(2H, m) | 827.99 | 828.23 |
| **159** | δ = 2.05(s, 6H), 4.60(s, 1H), 7.16(2H, m), 7.28(2H, m), 7.35(2H, m), 7.5(2H, m), 7.67(4H, m), 7.81(2H, m), 7.88(4H, m), 8.06~8.1(4H, m), 8.16(2H, m), 8.51(2H, m), 8.81(2H, m) | 1024.09 | 1029.23 |
| **204** | δ = 7.26 (1H, m), 7.35(2H, m), 7.47(2H, m), 7.54(5H, m), 7.67(5H, m), 7.81(2H, m), 8.06~8.1(9H, m), 8.16(2H, m), 8.3(2H, m), 8.51(2H, m) | 923.06 | 923.23 |
| **276** | δ = 2.05 (s, 6H); 4.60(s, 1H), 2.34 (6H, s), 2.61(6H, s), 4.60(s, 1H), 7.0(2H, s), 7.25(2H, m), 7.42(2H, m), 7.67(4H, m), 7.8(2H, m), 8.11~8.16(4H, m), 8.3(2H, m), 8.51(2H, m) | 856.04 | 856.26 |
| **405** | δ = 2.34(6H, s), 7.0(2H, s), 7.25(3H, m), 7.35 (1H, m), 7.42(2H, m), 7.52(1H, m), 7.67(5H, m), 7.8(3H, m), 8.11~8.16(8H, m), 8.3 (2H, m), 8.51(2H, m) | 951.12 | 951.26 |
| **527** | δ = 2.05 (s, 6H), 4.60(s, 1H), 7.13(2H, m), 7.41(2H, m), 7.51~7.6 (12H, m), 7.67(4H, m), 7.81(2H, m), 8.06(2H, m), 8.16-8.26(4H, m), 8.51 (2H, m) | 988.11 | 988.25 |
| **748** | δ = 1.35(18H, s), 2.05(s, 6H), 2.34(12H, s), 4.60(s, 1H) 7.0(2H, s), 7.31(2H, m), 7.6 (4H, m), 7.67 (4H, m), 7.8(2H, m), 7.88 (4H, m), 8.16(4H, m), 8.51(2H, m), 8.81(2H, m) | 1120.45 | 1120.45 |
| **869** | δ = 0.33 (18H, s), 2.05(s, 6H), 2.34(12H), 4.60 (s, 1H), 7.37(2H, m), 7.67 (6H, m), 7.81(2H, m), 8.11-8.16(4H, m), 8.06(2H, m), 8.51(2H, m) | 1000.40 | 1000.34 |
| **1029** | δ = 8.40 (s, 2H), 8.05(m, 2H), 7.76(m, 2H), 7.67-7.61(m, 12H), 7.48 (m, 4H), 7.32(m, 12H), 7.22 (m, 2H), 4.62 (s, 1H), 2.05(s, 6H) | 1052 | 1052.27 |
| **1044** | δ = 2.07 (s, 6H), 4.58(s, 1H), 7.41~7.54(12H, m), 7.64 (2H, s), 7.67(4H, m), 7.79~7.81 (6H, m), 8.06(2H, m), 8.16 (2H, m), 8.3(2H, m), 8.51 (2H, m) | 952.13 | 952.26 |
| **1148** | δ = 2.07(s, 6H), 4.58 (s, 1H), 7.41(4H, m), 7.51-7.6(16H, m), 7.64(2H, s), 7.67(4H, m), 7.79~7.81(6H, m), 8.06(2H, m), 8.16~8.26(4H, m), 8.51(2H, m) | 1104.32 | 1104.33 |
| **1349** | δ = 2.07(s, 6H), 2.39(6H, m), 4.58(s, 1H), 7.29~7.33(8H, m), 7.41(2H, m), 7.51~7.6(12H, m), 7.64(2H, s), 7.67(4H, m), 7.81(2H, m), 8.06(2H, m), 8.16~8.26(4H, m), 8.51(2H, m) | 1132.37 | 1132.36 |
| **1446** | δ = 2.07(s, 6H), 4.58 (s, 1H), 7.3(4H, m), 7.39(4H, m), 7.47(2H, m), 7.54(4H, m), 7.69(2H, s), 7.67(4H, m), 7.81(2H, m), 8.06(2H, m), 8.16(2H, m), 8.3(2H, m), 8.51(2H, m) | 988.11 | 988.25 |
| **1456** | δ = 2.07 (s, 6H), 4.58 (s, 1H), 7.3(4H, m), 7.39 (4H, m), 7.59 (4H, m), 7.64(2H, s), 7.67 (4H, m), 7.81 (2H, m), 7.95~8 (6H, m), 8.06 (2H, m), 8.16 (2H, m), 8.51(2H, m), 8.85(2H, m) | 1088.23 | 1088.28 |
| **1655** | δ = 1.35(18H, s), 2.07(s, 6H), 4.58 (s, 1H), 7.37~7.38 (8H, m), 7.64(2H, s), 7.67~7.71 (8H, m), 7.81(2H, m), 8.06(2H, m), 8.16(2H, m), 8.23 (2H, m), 8.51(2H, m) | 1200.34 | 1200.36 |
| **1691** | δ = 1.35(18H, s), 2.07(s, 6H), 2.34(12H, s), 4.58 (s, 1H), 7.37~7.38(10H, m), 7.64 (2H, s), 7.67(4H, m), 7.81(2H, m), 8.06-8.16(6H, m), 8.51(2H, m) | 1120.45 | 1120.45 |
| **1859** | δ = 0.25(18H, s), 2.07(s, 6H), 4.58(s, 1H), 7.46(4H, m), 7.55(4H, m), 7.64(4H, s), 7.64~7.67(4H, m), 7.77~7.81 (6H, m), 8.06~8.1(6H, m), 8.16(2H, m), 8.46~8.55(4H, m) | 1196.61 | 1196.37 |
| **2054** | δ = 2.07 (s, 6H), 4.58 (s, 1H), 7.47(2H, m), 7.54~7.59(10H, m), 7.64(2H, s), 7.67(4H, m), 7.73(2H, m), 7.81(2H, m), 7.92(2H, m), 8(4H, m), 8.06(2H, m), 8.16(2H, m), 8.3(2H, m), 8.51(2H, m) | 1052.24 | 1052.30 |
| **2055** | δ = 2.07(s, 6H), 4.58(s, 1H), 7.47(2H, m), 7.54~7.55(8H, m), 7.61(2H, m), 7.64(2H, s), 7.67(4H, m), 7.81(2H, m), 8.04~8.08(6H, m), 8.16(2H, m), 8.3(2H, m), 8.42(2H, m), 8.51~8.55 (4H, m) | 1052.29 | 1052.30 |
| **2056** | δ = 2.07(s, 6H), 4.58(s, 1H), 1.72(12H, s), 7.28(2H, m), 7.38(2H, m), 7.47(2H, m), 7.54~7.55(6H, m), 7.63(2H, m), 7.64(2H, s), 7.67(4H, m), 7.77~7.81(4H, m), 7.87~7.93(4H, m), 8.06(2H, m), 8.16(2H, m), 8.3(2H, m), 8.51 (2H, m) | 1184.45 | 1184.39 |
| **2060** | δ = 2.07 (s, 6H), 4.58 (s, 1H), 7.25~7.3(12H, m), 7.39(4H, m), 7.47(2H, m), 7.54(4H, m), 7.64 (2H, s), 7.67 (4H, m), 7.81 (2H, m), 8.06(2H, m), 8.16(2H, m), 8.3(2H, m), 8.51 (2H, m) | 1140.30 | 1140.31 |

### [Example 1] Manufacture of an OLED (1)

An OLED device was manufactured by using a compound for electronic material according to the invention.

First, a transparent electrode ITO thin film (15 Ω/□) (2) prepared from glass for OLED (produced by Samsung Corning) (1) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injecting layer (3) having 60 nm thickness on the ITO substrate.

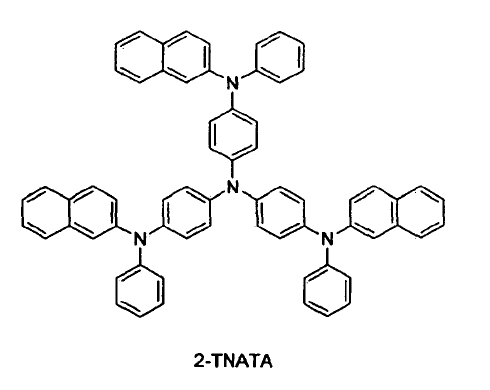

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm thickness on the hole injecting layer.

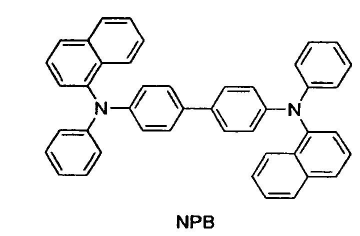

To another cell of said vacuum vapor-deposit device, charged was 4,4'-N,N'-dicarbazole-biphenyl (CBP) as an electroluminescent host material, and a compound for electronic material (e.g., Compound 2) according to the present invention was charged to still another cell. The two substances were evaporated at different rates to carry out doping, thereby vapor-depositing an electroluminescent layer (5) with 30 nm thickness on the hole transport layer. The suitable doping concentration is 4 to 10% by weight on the basis of CBP.

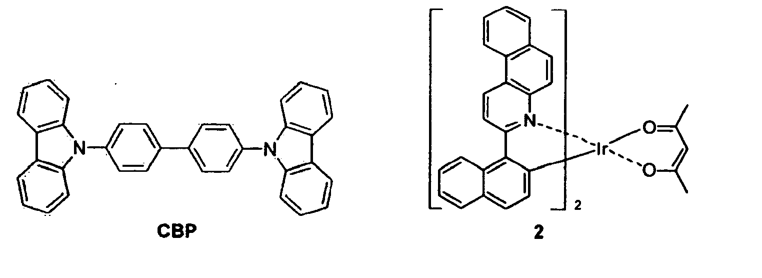

Then, on the electroluminescent layer, bis(2-methyl-8-quinolinato)(p-phenylphenolato)aluminum (III) (BAlq) was vapor-deposited as a hole blocking layer with a thickness of 10 nm in the same manner for NPB, tris(8-hydroxyquinoline)aluminum (III) (Alq) was vapor-deposited as an electron transport layer (6) with a thickness of 20 nm, and then lithium quinolate (Liq) was vapor-deposited as an electron injecting layer (7) in a thickness of 1 to 2 nm. Thereafter, an Al cathode (8) was vapor-deposited with a thickness of 150 nm by using another vacuum vapor-deposit device to manufacture an OLED.

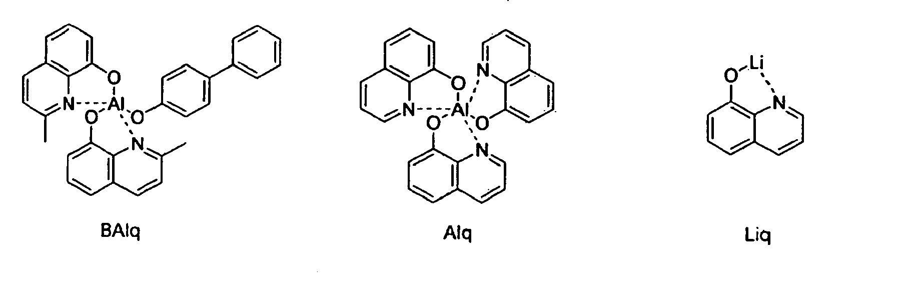

### [Example 2] Manufacture of an OLED (2)

A hole injecting layer and a hole transport layer were formed according to the procedure of Example 1, and an electroluminescent layer was vapor-deposited as follows. In another cell of said vacuum vapor-deposit device, charged was H-5 as an electroluminescent host material according to the present invention, and a compound for electronic material according to the present invention (Compound 52) was charged to still another cell. The two substances were evaporated at different rates to carry out doping, thereby vapor-depositing an electroluminescent layer (5) with 30 nm thickness on the hole transport layer. The suitable doping concentration is 4 to 10% by weight on the basis of the host. Then, a hole blocking layer, an electron transport layer and an electron injecting layer were vapor-deposited according to the same procedure as in Example 1, and then A1 cathode was vapor-deposited with a thickness of 150 nm by using another vacuum vapor-deposit device to manufacture an OLED.

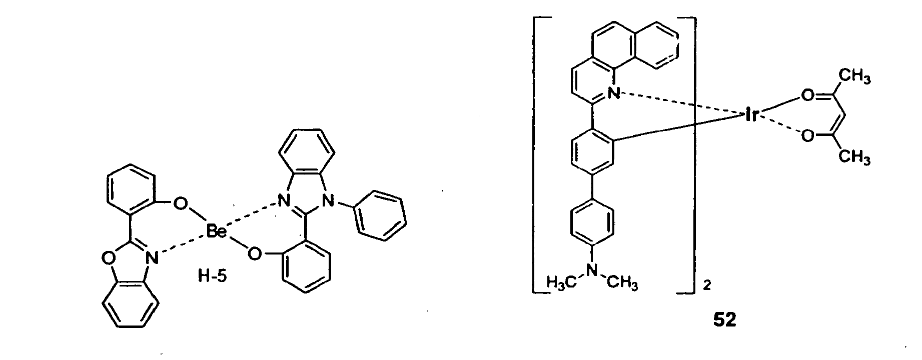

### [Example 3] Manufacture of an OLED (3)

A hole injecting layer, a hole transport layer and an electroluminescent layer were formed according to the same procedure as in Example 2, and then an electron transport layer and an electron injecting layer were vapor-deposited. Thereafter, Al cathode was vapor-deposited with a thickness of 150 nm by using another vacuum vapor-deposit device to manufacture an OLED.

### [Experimental Example 1] Evaluation of optical properties of electroluminescent materials

The complexes having high synthetic yield were purified by vacuum sublimation at 1.33 × 10⁻⁹bar (10⁻⁶ torr and used as a dopant for an electroluminescent layer of an OLED. In order to examine the performances of OLED's manufactured from Examples 1 to 3, external quantum efficiency of OLED's was measured at 10 mA/cm². Various properties of the compounds according to the invention are shown in Table 6.

**Table 6**

| | Material | Host | Hole blocking layer | EL color | Operation voltage | External quantum efficiency (%) |
|---|---|---|---|---|---|---|
| | Compound 2 | CBP | BAlq | Red | 8.2 | 6.8 |
| | Compound 21 | CBP | BAlq | Red | 8.1 | 7.7 |
| | Compound 46 | CBP | BAlq | Red | 7.9 | 8.2 |
| | Compound 79 | CBP | BAlq | Red | 7.7 | 7.1 |
| | Compound 108 | CBP | BAlq | Red | 7.9 | 7.9 |
| | Compound 290 | CBP | BAlq | Red | 7.7 | 7.8 |
| | Compound 401 | CBP | BAlq | Red | 8.2 | 5.8 |
| | Compound 687 | CBP | BAlq | Red | 7.9 | 6.1 |
| Ex.1 | Compound 750 | CBP | BAlq | Red | 8.0 | 5.9 |
| | Compound 821 | CBP | BAlq | Red | 8.3 | 6.4 |
| | Compound 907 | CBP | BAlq | Red | 7.7 | 6.0 |
| | Compound 1044 | CBP | BAlq | Red | 8.2 | 5.6 |
| | Compound 1245 | CBP | BAlq | Red | 7.7 | 6.4 |
| | Compound 1508 | CBP | BAlq | Red | 7.9 | 6.1 |
| | Compound 1712 | CBP | BAlq | Red | 8.0 | 5.8 |
| | Compound 1890 | CBP | BAlq | Red | 8.0 | 6.9 |
| | Compound 2043 | CBP | BAlq | Red | 7.6 | 6.7 |
| Ex.2 | Compound 52 | H-5 | BAlq | Red | 6.6 | 6.8 |
| | Compound 68 | H-33 | BAlq | Red | 6.5 | 5.9 |
| | Compound 1026 | H-10 | BAlq | Red | 7.5 | 6.3 |
| | Compound 1980 | H-17 | BAlq | Red | 6.4 | 6.2 |
| Ex.3 | Compound 106 | H-7 | - | Red | 7.0 | 6.3 |
| | Compound 1007 | H-5 | - | Red | 6.9 | 6.7 |
| | Compound 1745 | H-64 | - | Red | 6.6 | 7.4 |

In Example 1, Compound 46 showed good properties in voltage and external quantum efficiency; in Example 2, Compound 52; and in Example 3, Compound (1745) showed good properties in voltage and external quantum efficiency.

## Claims

1. An organic compound for electronic material represented by Chemical Formula (1): 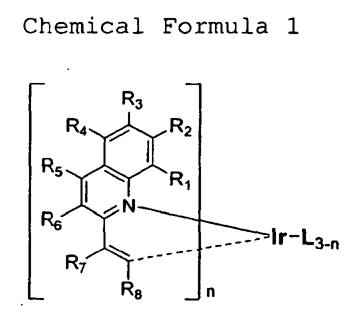 wherein, L represents an organic ligand;
R₁ and R₂, or R₃ and R₄ are independently linked via (C3-C12)alkylene or (C3-C12)alkenylene to form at least one fused ring(s), and the substituents which do not form a fused ring are independently substituted by hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
the fused ring formed by linkage from R₁ and R₂, or R₃ and R₄ via (C3-C12)alkylene or (C3-C12)alkenylene, or the alkyl, alkenyl, alkynyl, cycloalkyl, heterocycloalkyl, aryl, heteroaryl, arylsilyl, alkylsilyl, alkylamino or arylamino of other substituents which do not form a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₅ and R₆ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₇ and R₈ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60) arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60) alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₇ and R₈ may be linked via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, arylamino of R₅, R₆, R₇ and R₈, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from deuterium, halogen, (C1-C60)alkyl, halo(C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(Cl-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
n is an integer from 1 to 3;
provided that, if the ring formed from R₃ and R₄ of 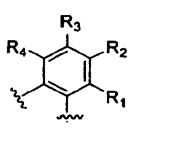 by linkage via alkylene or alkenylene is benzene, the ring formed
from R₇ and R₈ of 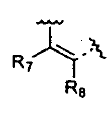 by linkage via alkylene or alkenylene is not benzene.

2. The organic compound for electronic material according to claim 1, which is selected from the compounds represented by Chemical Formula (2) or (3): 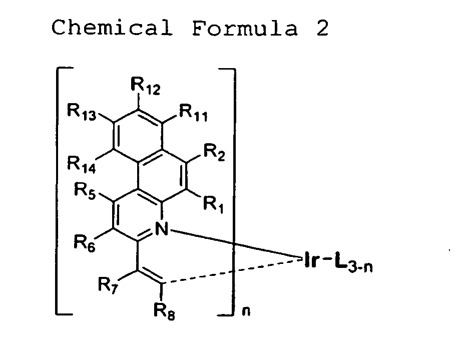 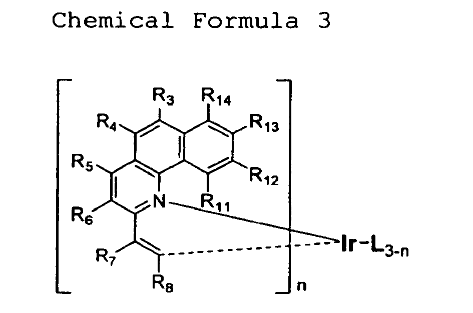 wherein, L, R₁, R₂, R₃, R₄, R₅, R₆, R₇, R₈ and n are defined as in claim 1;
R₁₁ through R₁₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; and
the alkyl, alkenyl, alkynyl, cycloalkyl, heterocycloalkyl, aryl, heteroaryl, arylsilyl, alkylsilyl, alkylamino or arylamino of R₁₁ through R₁₄ may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

3. The organic compound for electronic material according to claim 2, wherein ligand L is selected from the following structures: 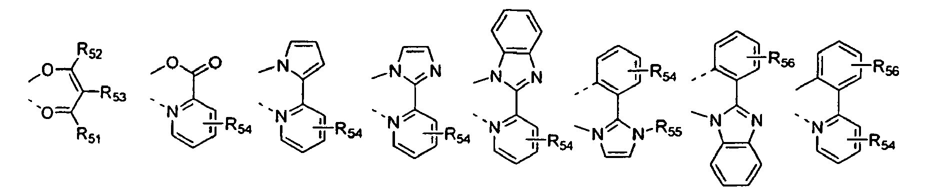 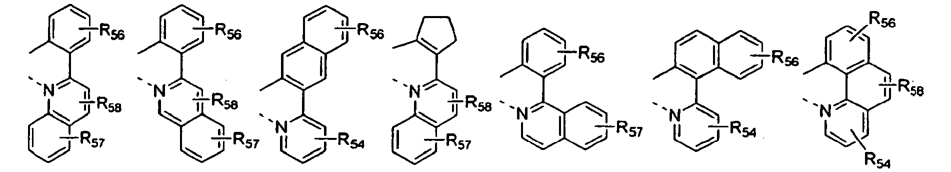 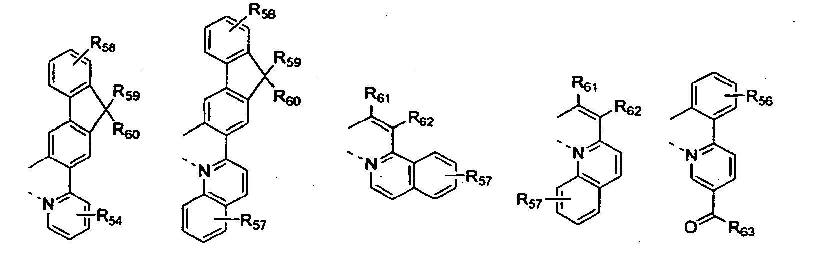 wherein, R₅₁ through R₆₃ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₅₁ through R₆₃ may be linked to an adjacent substituent via (C3-C60)alkylene or (C3-C60)alkenylene with or without a fused ring to form an alicyclic ring, or a monocyclic or polycyclic aromatic ring; and the alkyl, alkenyl, alkynyl, cycloalkyl, heterocycloalkyl, aryl, heteroaryl, arylsilyl, alkylsilyl, alkylamino or arylamino of R₅₁ through R₆₃, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

4. An organic solar cell which comprises an organic compound for electronic material represented by Chemical Formula (1): 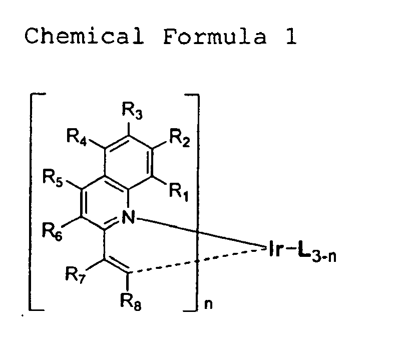 wherein, L represents an organic ligand;
R₁ and R₂, or R₃ and R₄ are independently linked via (C3-C12)alkylene or (C3-C12)alkenylene to form at least one fused ring(s), and the substituents which do not form a fused ring are independently substituted by hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
the fused ring formed by linkage from R₁ and R₂, or R₃ and R₄ via (C3-C12)alkylene or (C3-C12)alkenylene, or the alkyl, alkenyl, alkynyl, cycloalkyl, heterocycloalkyl, aryl, heteroaryl, arylsilyl, alkylsilyl, alkylamino or arylamino of other substituents which do not form a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₅ and R₆ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(Cl-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₇ and R₈ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(Cl-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₇ and R₈ may be linked via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, arylamino of R₅, R₆, R₇ and R₈, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from deuterium, halogen, (C1-C60)alkyl, halo(C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
n is an integer from 1 to 3;
provided that, if the ring formed from R₃ and R₄ of 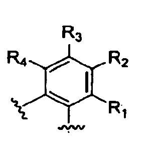 by linkage via alkylene or alkenylene is benzene, the ring formed from R₇ and R₈ of 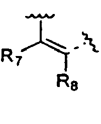 by linkage via alkylene or alkenylene is not benzene.

5. An organic electronic device which is comprised of a first electrode, a second electrode, and at least one organic layer(s) interposed between the first electrode and the second electrode; wherein the organic layer comprises an electroluminescent region, and the electroluminescent region comprises an organic compound(s) for electronic material represented by Chemical Formula (1): 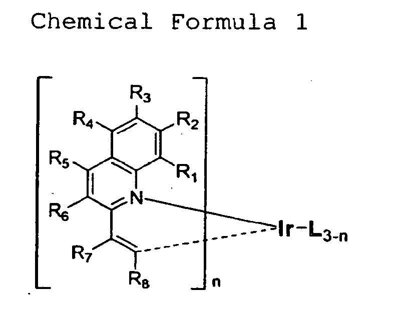 wherein, L represents an organic ligand;
R₁ and R₂, or R₃ and R₄ are independently linked via (C3-C12)alkylene or (C3-C12)alkenylene to form at least one fused ring(s), and the substituents which do not form a fused ring are independently substituted by hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
the fused ring formed by linkage from R₁ and R₂, or R₃ and R₄ via (C3-C12)alkylene or (C3-C12)alkenylene, or the alkyl, alkenyl, alkynyl, cycloalkyl, heterocycloalkyl, aryl, heteroaryl, arylsilyl, alkylsilyl, alkylamino or arylamino of other substituents which do not form a fused ring may be further substituted by one or more substituent(s) selected from deuterium, halogen, (C1-C60)alkyl, (C6-C60)aryl, (C4-C60) heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₅ and R₆ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₇ and R₈ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₇ and R₈ may be linked via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, arylamino of R₅, R₆, R₇ and R₈, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from deuterium, halogen, (C1-C60)alkyl, halo(C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
n is an integer from 1 to 3;
provided that, if the ring formed from R₃ and R₄ of 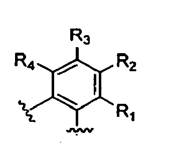 by linkage via alkylene or alkenylene is benzene, the ring formed from R₇ and R₈ of 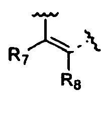 by linkage via alkylene or alkenylene is not benzene and one or more host selected from 1,3,5-tricarbazolylbenzene, polyvinylcarbazole, m-biscarbazolyl phenyl, 4,4',4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane, or one or more host(s) represented by one of Chemical Formulas (14) to (17) : 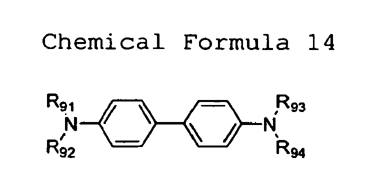 wherein, R₉₁ through R₉₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkylamino, arylamino of R₉₁ through R₉₄, and the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; 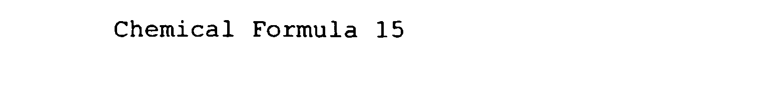 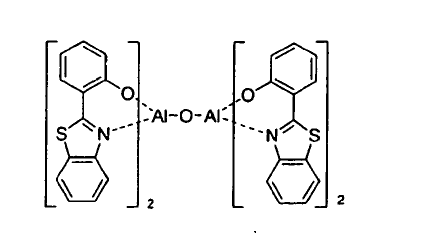 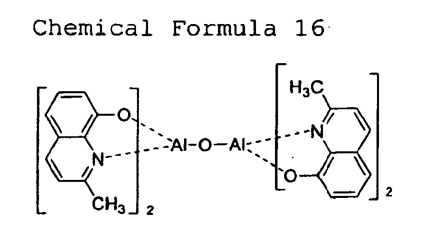
L¹L²M¹(Q)_{y} Chemical Formula 17
wherein, the ligands L¹ and L² are independently selected from the following structures; 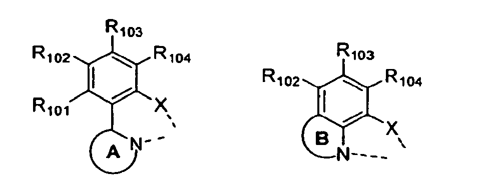 wherein, M¹ represents a bivalent or trivalent metal;
y is 0 when M¹ is a bivalent metal, while y is 1 when M¹ is a trivalent metal;
Q is (C6-C60)aryloxy or tri(C6-C60)arylsilyl, and the aryloxy or triarylsilyl of Q may be further substituted by (C1-C60)alkyl or (C6-C60)aryl;
X is O, S or Se;
ring A represents oxazole, thiazole, imidazole, oxadiazole, thiadiazole, benzoxazole, benzothiazole, benzimidazole, pyridine or quinoline;
ring B represents pyridine or quinoline which may be further substituted by (C1-C60)alkyl, or phenyl or naphthyl with or without (C1-C60)alkyl substituent(s);
R₁₀₁ through R₁₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and
ring A, or the alkyl, alkenyl, alkynyl, cycloalkyl, heterocycloalkyl, aryl, heteroaryl, arylsilyl, alkylsilyl, alkylamino or arylamino of R₁₀₁, through R₁₀₄, and the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60) alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

6. The organic electronic device according to claim 5, wherein the organic layer comprises one or more compound(s) selected from a group consisting of arylamine compounds and styrylarylamine compounds, or one or more metal(s) selected from a group consisting of organometals of Group 1, Group 2, 4^{th} period and 5^{th} period transition metals, lanthanide metals and d-transition elements in the Periodic Table of Elements.

7. The organic electronic device according to claim 5, which comprises an organic compound or organometallic compound with green or blue electroluminescence, in addition to the organic compound for electronic material.

8. The organic electronic device according to claim 5, wherein the organic layer comprises an electroluminescent layer and a charge generating layer.

9. The organic electronic device according to claim 5, wherein a mixed region of reductive dopant and organic substance, or a mixed region of oxidative dopant and organic substance is placed on the inner surface of one or both electrode(s) among the pair of electrodes.

## Patentansprüche

1. Organische Verbindung für ein elektronisches Material, dargestellt durch die chemische Formel (1): 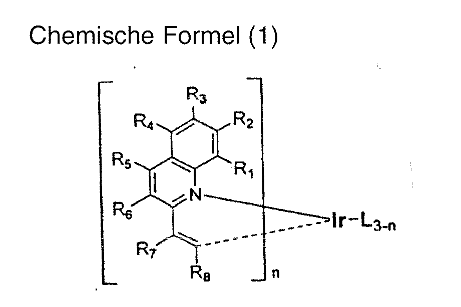 wobei L einen organischen Liganden darstellt;
R₁ und R₂, oder R₃ und R₄ unabhängig über (C3-C12)Alkylen oder (C3-C12)Alkenylen unter Bildung mindestens eines kondensierten Rings verknüpft sind und die Substituenten, die keinen kondensierten Ring bilden, unabhängig substituiert sind durch Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl;
der kondensierte Ring, gebildet durch Verknüpfung von R₁ und R₂, oder R₃ und R₄ über (C3-C12)Alkylen oder (C3-C12)Alkenylen, oder das Alkyl, Alkenyl, Alkinyl, Cycloalkyl, Heterocycloalkyl, Aryl, Heteroaryl, Arylsilyl, Alkylsilyl, Alkylamino oder Arylamino von anderen Substituenten, die nicht einen kondensierten Ring bilden, weiter substituiert sein können durch einen oder mehrere Substituenten, ausgewählt aus Deuterium, Halogen, (C1-C60)Alkyl, (C6-C60)Aryl, (C4-C60)Heteroaryl, 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl;
R₅ und R₆ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C5-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen;
R₇ und R₈ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen, oder R₇ und R₈ über (C3-C60)Alkylen oder (C3-C60)Alkenylen unter Bildung eines alicyclischen Rings, oder eines monocyclischen oder polycyclischen aromatischen Rings, mit oder ohne einen kondensierten Ring verknüpft sein können;
das Alkyl, Alkenyl, Alkinyl, Cycloalkyl, Heterocycloalkyl, Aryl, Heteroaryl, Arylsilyl, Alkylsilyl, Alkylamino, Arylamino von R₅, R₆, R₇ und R₈, oder der alicyclische Ring, oder der monocyclische oder polycyclische aromatische Ring, der daraus durch Verknüpfung über (C3-C60)Alkylen oder (C3-C60)Alkenylen, mit oder ohne einen kondensierten Ring, gebildet ist, weiter substituiert sein können durch einen oder mehrere Substituenten, ausgewählt aus Deuterium, Halogen, (C1-C50)Alkyl, Halo(C1-C60)alkyl, (C6-C60)Aryl, (C4-C60)Heteroaryl, 5-oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl; und
n eine ganze Zahl von 1 bis 3 ist;
mit der Massgabe, dass, wenn der Ring, gebildet aus R₃ und R₄ von 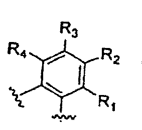 durch Verknüpfung über Alkylen oder Alkenylen Benzol ist, der Ring, gebildet aus R₇ und R₈ von 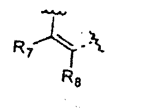 durch Verknüpfung über Alkylen oder Alkenylen nicht Benzol ist.

2. Organische Verbindung für ein elektronisches Material nach Anspruch 1, das ausgewählt ist aus den Verbindungen, dargestellt durch die chemische Formel (2) oder (3): 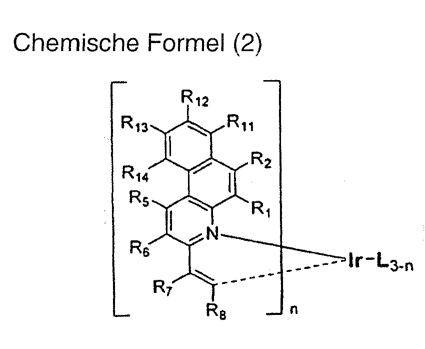 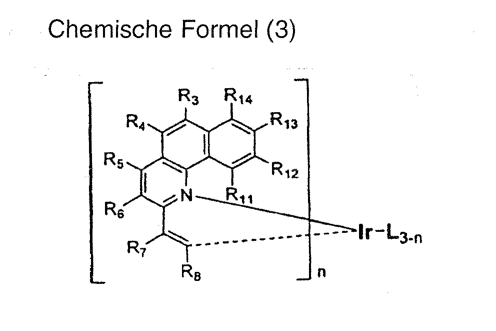 wobei L, R₁, R₂, R₃, R₄, R₅, R₆, R₇, R₈ und n wie in Anspruch 1 definiert sind; R₁₁ bis R₁₄ unabhängig Wasserstoff, Deuterium, Halogen, (C1-C60)Alkyl, (C6-C60)Aryl, (C4-C60)Heteroaryl, ein 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen; und
das Alkyl, Alkenyl, Alkinyl, Cycloalkyl, Heterocycloalkyl, Aryl, Heteroaryl, Arylsilyl, Alkylsilyl, Alkylamino oder Arylamino von R₁₁ bis R₁₄ weiter substituiert sein können durch einen oder mehrere Substituenten, ausgewählt aus Deuterium, Halogen, (C1-C60)Alkyl, (C6-C60)Aryl, (C4-C60)Heteroaryl, einem 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl.

3. Organische Verbindung für ein elektronisches Material nach Anspruch 1 oder 2, wobei der Ligand L ausgewählt ist aus den folgenden Strukturen: 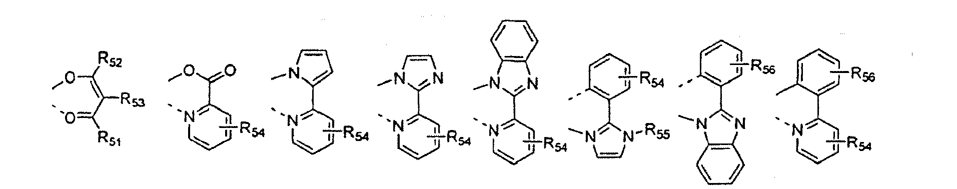 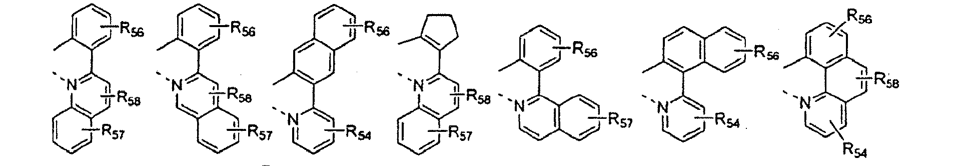 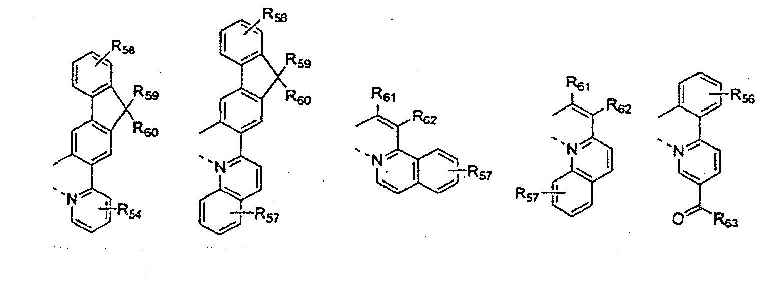 wobei R₅₁ bis R₆₃ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen, oder jedes von R₅₁ bis R₆₃ zu einem benachbarten Substituenten über (C3-C60)Alkylen oder (C3-C60)Alkenylen unter Bildung eines alicyclischen Rings, oder eines monocyclischen oder polycyclischen aromatischen Rings, mit oder ohne einen kondensierten Ring, verknüpft sein kann; und
das Alkyl, Alkenyl, Alkinyl, Cycloalkyl, Heterocycloalkyl, Aryl, Heteroaryl, Arylsilyl, Alkylsilyl, Alkylamino oder Arylamino von R₅₁ bis R₆₃, oder der alicyclische Ring, oder der monocyclische oder polycyclische aromatische Ring, der daraus durch Verknüpfung zu einem benachbarten Substituenten über (C3-C60)Alkylen oder (C3-C60)Alkenylen, mit oder ohne einen kondensierten Ring, gebildet ist, weiter substituiert sein können durch einen oder mehrere Substituenten, ausgewählt aus Deuterium, Halogen, (C1-C60)Alkyl, (C6-C60)Aryl, (C4-C60)Heteroaryl, 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl.

4. Organische Solarzelle, die eine organische Verbindung für ein elektronisches Material, dargestellt durch die chemische Formel (1) umfasst: 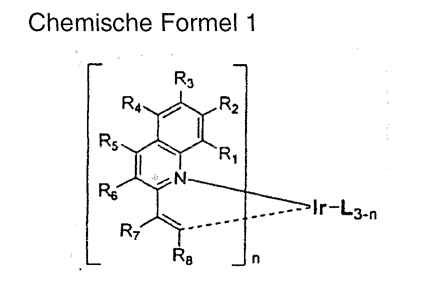 wobei L einen organischen Liganden darstellt;
R₁ und R₂, oder R₃ und R₄ unabhängig über (C3-C12)Alkylen oder (C3-C12)Alkenylen unter Bildung mindestens eines kondensierten Rings verknüpft sind und die Substituenten, die keinen kondensierten Ring bilden, unabhängig substituiert sind durch Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl;
der kondensierte Ring, gebildet durch Verknüpfung von R₁ und R₂, oder R₃ und R₄ über (C3-C12)Alkylen oder (C3-C12)Alkenylen, oder das Alkyl, Alkenyl, Alkinyl, Cycloalkyl, Heterocycloalkyl, Aryl, Heteroaryl, Arylsilyl, Alkylsilyl, Alkylamino oder Arylamino von anderen Substituenten, die nicht einen kondensierten Ring bilden, weiter substituiert sein können durch einen oder mehrere Substituenten, ausgewählt aus Deuterium, Halogen, (C1-C60)Alkyl, (C6-C60)Aryl, (C4-C60)Heteroaryl, 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl;
R₅ oder R₆ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen;
R₇ und R₈ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen, oder R₇ und R₈ über (C3-C60)Alkylen oder (C3-C60)Alkenylen unter Bindung eines alicyclischen Rings, oder eines monocyclischen oder polycyclischen aromatischen Rings, mit oder ohne einen kondensierten Ring, verknüpft sein können;
das Alkyl, Alkenyl, Alkinyl, Cycloalkyl, Heterocycloalkyl, Aryl, Heteroaryl, Arylsilyl, Alkylsilyl, Alkylamino, Arylamino von R₅, -R₆, R₇ und R₈, oder der alicyclische Ring, oder der monocyclische oder polycyclische aromatische Ring, der daraus durch Verknüpfung über (C3-C60)Alkylen oder (C3-C60)Alkenylen, mit oder ohne einen kondensierten Ring, gebildet ist, weiter substituiert sein können durch einen oder mehrere Substituenten, ausgewählt aus Deuterium, Halogen, (C1-C60)Alkyl, Halo(C1-C60)alkyl, (C6-C60)Aryl, (C4-C60)Heteroaryl, 5-oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl; und
n eine ganze Zahl von 1 bis 3 ist;
mit der Massgabe, dass, wenn der Ring, gebildet aus R₃ und R₄ von 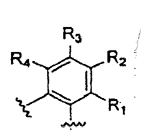 durch Verknüpfung über Alkylen oder Alkenylen Benzol ist, der Ring, gebildet aus R₇ und R₈ von 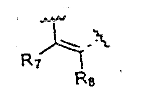 durch Verknüpfung über Alkylen oder Alkenylen nicht Benzol ist.

5. Organische elektronische Vorrichtung, die eine erste Elektrode, eine zweite Elektrode und mindestens eine organische Schicht, die zwischen der ersten Elektrode und der zweiten Elektrode angeordnet ist;
wobei die organische Schicht einen elektrolumineszenten Bereich umfasst, und der elektrolumineszente Bereich (eine) organische Verbindung(en) für ein elektronisches Material dargestellt durch die chemische Formel (1) umfasst: 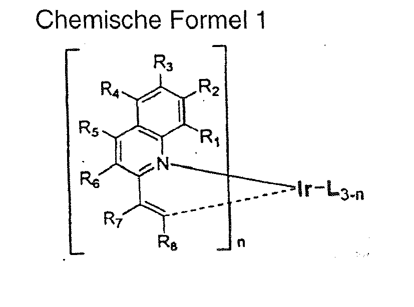 wobei L einen organischen Liganden darstellt;
R₁ und R₂, oder R₃ und R₄ unabhängig über (C3-C12)Alkylen oder (C3-C12)Alkenylen unter Bildung mindestens eines kondensierten Rings verknüpft sind und die Substituenten, die keinen kondensierten Ring bilden, unabhängig substituiert sind durch Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl;
der kondensierte Ring, gebildet durch Verknüpfung von R₁ und R₂, oder R₃ und R₄ über (C3-C12)Alkylen oder (C3-C12)Alkenylen, oder das Alkyl, Alkenyl, Alkinyl, Cycloalkyl, Heterocycloalkyl, Aryl, Heteroaryl, Arylsilyl, Alkylsilyl, Alkylamino oder Arylamino von anderen Substituenten, die nicht einen kondensierten Ring bilden, weiter substituiert sein können durch einen oder mehrere Substituenten, ausgewählt aus Deuterium, Halogen, (C1-C60)Alkyl, (C6-C60)Aryl, (C4-C60)Heteroaryl, 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl;
R₅ oder R₆ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen;
R₇ und R₈ unabhängig Wasserstoff, Deuterium, Halogen, (C1-C60)Alkyl, (C6-C60)Aryl, (C4-C60)Heteroaryl, 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen, oder R₇ und R₈ über (C3-C60)Alkylen oder (C3-C60)Alkenylen unter Bildung eines alicyclischen Rings, oder eines monocyclischen oder polycyclischen aromatischen Rings, mit oder ohne einen kondensierten Ring, verknüpft sein können;
das Alkyl, Alkenyl, Alkinyl, Cycloalkyl, Heterocycloalkyl, Aryl, Heteroaryl, Arylsilyl, Alkylsilyl, Alkylamino, Arylamino von R₅, R₆, R₇ und R₈, oder der alicyclische Ring, oder der monocyclische oder polycyclische aromatische Ring, der daraus durch Verknüpfung über (C3-C60)Alkylen oder (C3-C60)Alkenylen, mit oder ohne einen kondensierten Ring, gebildet ist, weiter substituiert sein können durch einen oder mehrere Substituenten, ausgewählt aus Deuterium, Halogen, (C1-C60)Alkyl, Halo(C1-C60)alkyl, (C6-C60)Aryl, (C4-C60)Heteroaryl, 5-oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl; und
n eine ganze Zahl von 1 bis 3 ist;
mit der Massgabe, dass, wenn der Ring, gebildet aus R₃ und R₄ von 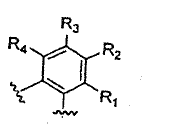 durch Verknüpfung über Alkylen oder Alkenylen Benzol ist, der Ring, gebildet aus R₇ und R₈ von 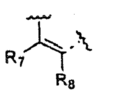 durch Verknüpfung über Alkylen oder Alkenylen nicht Benzol ist,
und einen oder mehrere Wirte, ausgewählt aus 1,3,5-Tricarbazolylbenzol, Polyvinylcarbazol, m-Biscarbazolylphenyl, 4,4',4"-Tri(N-carbazolyl)triphenylamin, 1,3,5-Tri(2-carbazolylphenyl)benzol, 1,3,5-Tris(2-carbazolyl-5-methoxyphenyl)-benzol, Bis(4-carbazolylphenyl)silan, oder ein oder mehrere Wirte, dargestellt durch eine der chemischen Formeln (14) bis (17), umfasst: 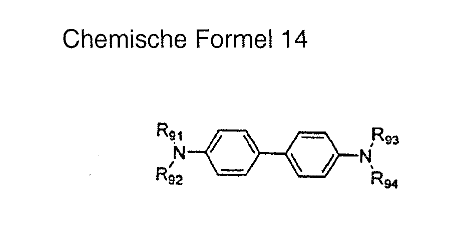 wobei R₉₁ bis R₉₄ unabhängig Wasserstoff, Deuterium, Halogen, (C1-C60)Alkyl, (C6-C60)Aryl, (C4-C60)Heteroaryl, einen 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen; oder jedes von R₉₁ bis R₉₄ zu einem benachbarten Substituenten über (C3-C60)Alkylen oder (C3-C60)Alkenylen unter Bildung eines alicyclischen Rings, oder eines monocyclischen oder polycyclischen aromatischen Rings, mit oder ohne einen kondensierten Ring, verknüpft sein kann; und
das Alkyl, Alkenyl, Alkinyl, Cycloalkyl, Heterocycloalkyl, Aryl, Heteroaryl, Arylsilyl, Alkylsilyl, Alkylamino, Arylamino von R₉₁ bis R₉₄, und der alicyclische Ring, oder der monocyclische oder polycyclische aromatische Ring, der daraus durch Verknüpfung zu einem benachbarten Substituenten über (C3-C60)Alkylen oder (C3-C60)Alkenylen, mit oder ohne einen kondensierten Ring, gebildet ist, weiter substituiert sein können durch einen oder mehrere Substituenten, ausgewählt aus Deuterium, Halogen, (C1-C60)Alkyl, (C6-C60)Aryl, (C4-C60)Heteroaryl, einem 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl; 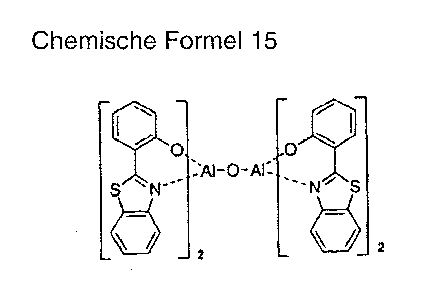 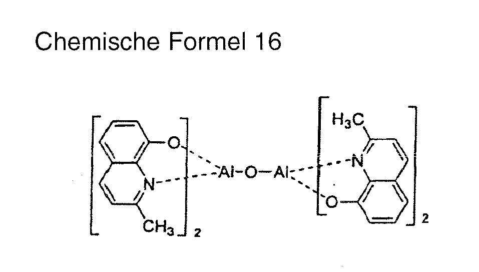
L¹L²M¹(Q)_{y} Chemische Formel 17
wobei die Liganden L¹ und L² unabhängig ausgewählt sind aus den folgenden Strukturen; 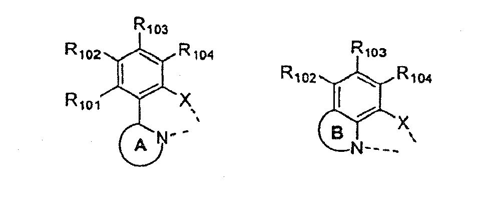 wobei M¹ ein zweiwertiges oder dreiwertiges Metall darstellt;
y 0 ist, wenn M¹ ein zweiwertiges Metall ist, während y 1 ist, wenn M¹ ein dreiwertiges Metall ist;
Q (C6-C60)Aryloxy oder Tri(C6-C60)arylsilyl ist, und das Aryloxy oder Triarylsilyl von Q weiter substituiert sein kann durch (C1-C60)Alkyl oder (C6-C60)Aryl; X O, S oder Se ist;
Ring A Oxazol, Thiazol, Imidazol, Oxadiazol, Thiadiazol, Benzoxazol, Benzothiazol, Benzimidazol, Pyridin oder Chinolin darstellt;
Ring B Pyridin oder Chinolin darstellt, die weiter substituiert sein können durch (C1-C60)Alkyl oder Phenyl oder Naphthyl mit oder ohne (C1-C60)Alkyl-Substituent(en);
R₁₀₁ bis R₁₀₄ unabhängig Wasserstoff, Deuterium, Halogen, (C1-C60)Alkyl, (C6-C60)Aryl, (C4-C60)Heteroaryl, ein 5- oder 6-gliedriges Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl darstellen; oder jedes von R₁₀₁ bis R₁₀₄ zu einem benachbarten Substituenten über (C3-C60)Alkylen oder (C3-C60)Alkenylen unter Bildung eines alicyclischen Rings, oder eines monocyclischen oder polycyclischen aromatischen Rings, mit oder ohne einen kundensierten Ring, verknüpft sein kann; und
Ring A oder das Alkyl, Alkenyl, Alkinyl, Cycloalkyl, Heterocycloalkyl, Aryl, Heteroaryl, Arylsilyl, Alkylsilyl, Alkylamino oder Arylamine von R₁₀₁ bis R₁₀₄, und der alicyclische Ring, oder der monocyclische oder polycyclische aromatische Ring, der daraus durch Verknüpfung zu einem benachbarten Substituenten über (C3-C60)Alkylen oder (C3-C60)Alkenylen, mit oder ohne einen kondensierten Ring, gebildet ist, weiter substituiert sein können durch einen oder mehrere Substituenten, ausgewählt aus Deuterium, Halogen, (C1-C60)Alkyl, (C6-C60)Aryl, (C4-C60)Heteroaryl, einem 5- oder 6-gliedrigem Heterocycloalkyl, das ein oder mehrere Heteroatom(e), ausgewählt aus N, O und S, enthält, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyano, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl.

6. Organische elektronische Vorrichtung nach Anspruch 5, wobei die organische Schicht eine oder mehrere Verbindung(en) umfasst, ausgewählt aus einer Gruppe, bestehend aus Arylamin-Verbindungen und Styrylarylamin-Verbindungen, oder einem oder mehreren Metall(en), ausgewählt aus einer Gruppe, bestehend aus Organometallen der Gruppe 1, Gruppe 2, Übergangsmetallen der vierten Periode und fünften Periode, Lanthanoidenmetalle und d-Übergangselementen im Periodensystem der Elemente.

7. Organische elektronische Vorrichtung nach Anspruch 5, welche eine organische Verbindung oder organometallische Verbindung mit grüner oder blauer Elektrolumineszenz zusätzlich zu der organischen Verbindung für elektronisches Material umfasst.

8. Organische elektronische Vorrichtung nach Anspruch 5, wobei die organische Schicht eine elektrolumineszente Schicht und eine ladungserzeugende Schicht umfasst.

9. Organische elektronische Vorrichtung nach Anspruch 5, wobei ein gemischter Bereich aus reduzierendem Dotierstoff und organischer Substanz, oder ein gemischter Bereich aus oxidierenden Dotierstoff und organischer Substanz auf der Innenfläche von einer oder beiden Elektrode(n) des Elektrodenpaars angeordnet ist.

## Revendications

1. Composé organique pour matériau électroniquereprésenté par la formule chimique(1): 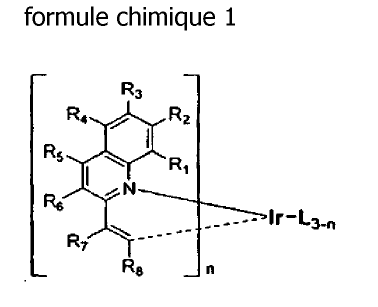 où L représenteun ligand organique;
R₁ et R₂, ou R₃ et R₄ sont liés indépendammentvia (C3-C12)alkylène ou (C3-C12)alcénylène pour formerau moins un cycle condensé, et les substituants qui ne forment pasun cycle condensésontsubstitués indépendammentparhydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N,Oet S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle ;
le cycle condensé formé par liaison à partir de R₁ et R₂, ou R₃ et R₄ via (C3-C12)alkylène ou (C3-C12)alcénylène, ou l'alkyle, alcényle, alcynyle, cycloalkyle, hétérocycloalkyle, aryle, hétéroaryle, arylsilyle, alkylsilyle, alkylamino ou arylamino d'autres substituantsqui ne forment pasun cycle condensé peut être substitué encore par un ou plusieurs substituantschoisis parmideutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, Oet S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle;
R₅ et R₆ représentent indépendammenthydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, Oet S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle;
R₇ et R₈ représentent indépendammenthydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, Oet S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle, ou R₇ et R₈ peuvent être liés via (C3-C60)alkylène ou (C3-C60)alcénylène avec ou sans un cycle condensépour formeruncycle alicyclique, ouun cycle aromatique monocyclique ou polycyclique;
l'alkyle, alcényle, alcynyle, cycloalkyle, hétérocycloalkyle, aryle, hétéroaryle, arylsilyle, alkylsilyle, alkylamino, arylamino de R₅, R₆, R₇ et R₈, ou le cycle alicyclique, ou le cycle aromatique monocyclique ou polycyclique forméà partir de ceux-ci par liaison via (C3-C60)alkylèneou (C3-C60)alcénylèneavecousansun cycle condensépeut être substitué encoreparunouplusieurssubstituants choisis parmideutérium, halogène, (C1-C60)alkyle,halo(C1-C60)alkyle,(C6-C60)aryle,(C4-C60)hétéroaryle,hétérocycloalkyle à 5 ou 6 chaînons contenantunouplusieurshétéroatomeschoisis parmi N, O et S, (C3-C60)cycloalkyle, tri(C1-C60)alkylsilyle, di(C1-C60)alkyl(C6-C60)arylsilyle,tri(C6-C60)arylsilyle,adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle,(C1-C60)alkyloxy, (C1-C60)alkylthio, (C6-C60)aryloxy, (C6-C60) arylthio, (C1-C60)alcoxycarbonyle, (C1-C60)alkylcarbonyle, (C6-C60)arylcarbonyle,carboxyle, nitro ethydroxyle;
et n estunentier parmi 1 à 3;
à condition que, si le cycle formé à partir de R₃ et R₄ de 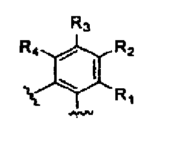 par liaison via alkylène ou alcénylène est le benzène, le cycle formé à partir de R₇ et R₈ de 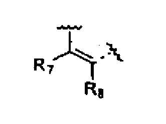 par liaison via alkylène ou alcénylène ne soit pas le benzène.

2. Composé organique pour matériau électronique selon la revendication 1, qui est choisi parmi les composés représentés par laformule chimique (2) ou (3): 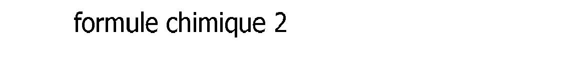 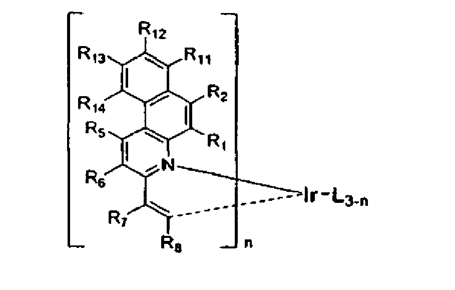 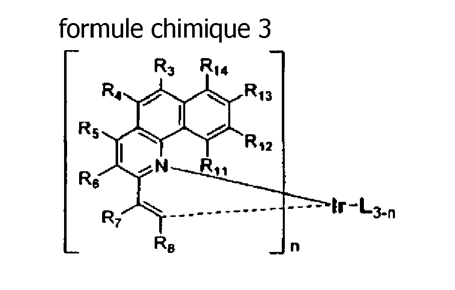 où L, R₁, R₂, R₃, R₄, R₅,R₆,R₇,R₈et n sont définis comme dans la revendication 1;
R₁₁à R₁₄représentent indépendammenthydrogène, deutérium, halogène, (C1-C60)alkyle, (C6-C60)aryle, (C4-C60)hétéroaryle, un hétérocycloalkyleà 5 à 6 chaînons contenantunouplusieurshétéroatomeschoisis parmi N, Oet S, (C3-C60)cycloalkyle, tri(C1-C60)alkylsilyle,di(C1-C60)alkyl(C6-C60)arylsilyle,tri(C6-C60)arylsilyle,adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle,carboxyle, nitro ouhydroxyle; et
l'alkyle,alcényle,alcynyle, cycloalkyle,hétérocycloalkyle,aryle,hétéroaryle, arylsilyle, alkylsilyle, alkylamino ou arylamino de R₁₁à R₁₄peut être substitué encoreparunouplusieurssubstituantschoisis parmideutérium, halogène, (C1-C60)alkyle, (C6-C60)aryle, (C4-C60)hétéroaryle, unhétérocycloalkyleà 5 à 6 chaînons contenantunouplusieurshétéroatomeschoisis parmi N, Oet S, (C3-C60)cycloalkyle, tri(C1-C60)alkylsilyle, di(C1-C60)alkyl(C6-C60)arylsilyle, tri(C6-C60)arylsilyle,adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle,(C1-C60)alkylcarbonyle, (C6-C60)arylcarbonyle,carboxyle, nitro ethydroxyle.

3. Composé organique pour matériau électronique selon la revendication 2, oùle ligand L estchoisiparmiles structures suivantes : 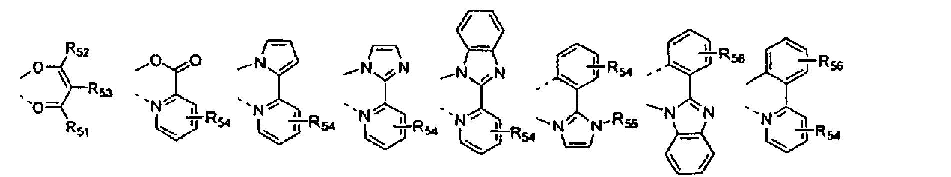 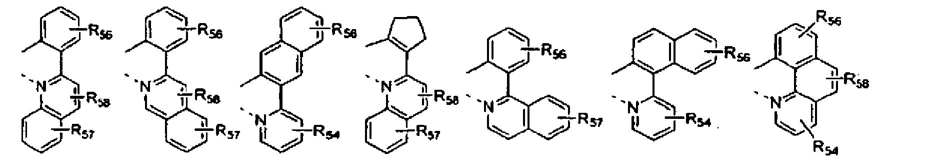 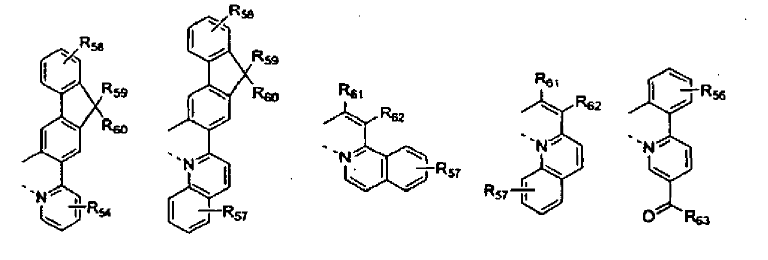 oùR₅₁à R₆₃représentent indépendammenthydrogène, deutérium,halogène, (C1-C60)alkyle,(C6-C60)aryle,(C4-C60)hétéroaryle,hétérocycloalkyleà 5 ou 6 chaînons contenantunouplusieurshétéroatomeschoisis parmi N, Oet S, (C3-C60)cycloalkyle,tri(C1-C60)alkylsilyle,di(C1-C60)alkyl(C6-C60)arylsilyle,tri(C6-C60)arylsilyle,adamantyle, (C7-C60)bicycloalkyle,(C2-C60)alcényle,(C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle,(C1-C60)alkylcarbonyle,(C6-C60)arylcarbonyle,carboxyle,nitro ouhydroxyle, ou chacun de R₅₁à R₆₃peut être lié àunsubstituant adjacent via (C3-C60)alkylèneou (C3-C60)alcénylèneavecousansun cycle condensépour formeruncycle alicyclique, ouun cycle aromatique monocyclique ou polycyclique ; etl'alkyle,alcényle,alcynyle, cycloalkyle,hétérocycloalkyle,aryle,hétéroaryle, arylsilyle, alkylsilyle,alkylamino ou arylamino de R₅₁ à R₆₃,oulecycle alicyclique, oulecycle aromatique monocyclique ou polycyclique forméà partir de ceux-cipar liaison àunsubstituant adjacent via (C3-C60)alkylèneou (C3-C60)alcénylèneavecousansun cycle condensé peut être substitué encore parunouplusieurssubstituantschoisis parmideutérium, halogène, (C1-C60)alkyle, (C6-C60)aryle, (C4-C60)hétéroaryle,hétérocycloalkyleà 5 ou 6 chaînons contenantunouplusieurshétéroatomeschoisis parmi N, O et S, (C3-C60)cycloalkyle, tri(C1-C60)alkylsilyle,di(C1-C60)alkyl(C6-C60)arylsilyle,tri(C6-C60)arylsilyle,adamantyle,(C7-C60)bicycloalkyle, (C2-C60)alcényle,(C2-C60)alcynyle, cyano, (C1-C60)alkylamino, (C6-C60)arylamino,(C6-C60)ar(C1-C60)alkyle,(C1-C60)alkyloxy,(C1-C60)alkylthio,(C6-C60)aryloxy, (C6-C60)arylthio, (C1-C60)alcoxycarbonyle,(C1-C60)alkylcarbonyle,(C6-C60)arylcarbonyle,carboxyle, nitro ethydroxyle.

4. Cellule solaire organique qui comprend un composé organique pour matériau électronique représenté par la formule chimique (1): 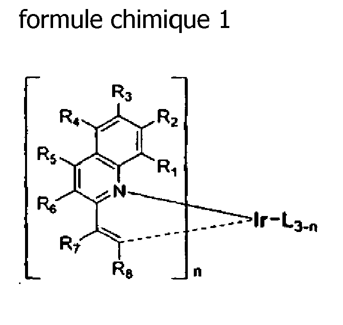 où L représente un ligand organique;
R₁ et R₂, ou R₃et R₄ sont liés indépendamment via (C3-C12)alkylène ou (C3-C12) alcénylène pour former au moins un cycle condensé, et les substituants qui ne forment pas un cycle condensé sont substitués indépendamment par hydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle ;
le cycle condensé formé par liaison à partir de R₁ et R₂,ou R₃et R₄ via (C3-C12)alkylène ou (C3-C12)alcénylène, ou l'alkyle, alcényle, alcynyle, cycloalkyle, hétérocycloalkyle, aryle, hétéroaryle, arylsilyle, alkylsilyle, alkylamino ou arylamino d'autres substituants qui ne forment pas un cycle condensé peut être substitué encore par un ou plusieurs substituantschoisis parmi deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle;
R₅et R₆représentent indépendamment hydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle,(C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle;
R₇ et R₈ représentent indépendamment hydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle, ou R₇ et R₈ peuvent être liés via (C3-C60)alkylène ou (C3-C60)alcénylène avec ou sans un cycle condensé pour former un cycle alicyclique, ou un cycle aromatique monocyclique ou polycyclique;
l'alkyle, alcényle, alcynyle, cycloalkyle, hétérocycloalkyle, aryle, hétéroaryle, arylsilyle, alkylsilyle, alkylamino, arylamino de R₅, R₆, R₇ et R₈, ou le cycle alicyclique, ou le cycle aromatique monocyclique ou polycyclique formé à partir de ceux-ci par liaison via (C3-C60)alkylène ou (C3-C60)alcénylène avec ou sans un cycle condensé peut être substitué encore par un ou plusieurs substituants choisis parmi deutérium, halogène, (C1-C60)alkyle, halo(C1-C60)alkyle, (C6-C60)aryle,(C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro et hydroxyle;
et n est un entier parmi 1 à 3;
à condition que, si le cycle formé à partir de R₃ et R₄de 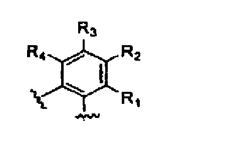 par liaison via alkylène ou alcénylène est le benzène, le cycle formé à partir de R₇ et R₈ de 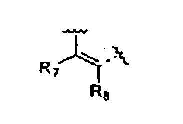 par liaison via alkylène ou alcénylène ne soit pas le benzène.

5. Dispositif électronique organique qui comprend une première électrode, une seconde électrode et au moins une couche organique disposée entre la première électrode et la seconde électrode ; où la couche organique comprend une région électroluminescente, et la région électroluminescente comprend un (des) composé(s) organique(s) pour matériau électronique représenté(s) par la formule chimique (1): 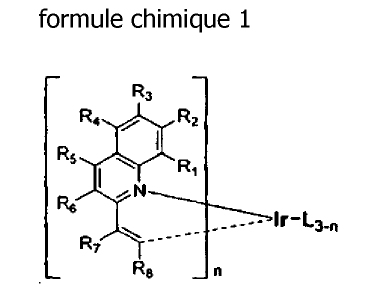 où L représente un ligand organique;
R₁ et R₂, ou R₃et R₄ sont liés indépendamment via (C3-C12)alkylène ou (C3-C12) alcénylène pour former au moins un cycle condensé, et les substituants qui ne forment pas un cycle condensé sont substitués indépendamment par hydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle ;
le cycle condensé formé par liaison à partir de R₁ et R₂, ou R₃et R₄ via (C3-C12)alkylène ou (C3-C12)alcénylène, ou l'alkyle, alcényle, alcynyle, cycloalkyle, hétérocycloalkyle, aryle, hétéroaryle, arylsilyle, alkylsilyle, alkylamino ou arylamino d'autres substituants qui ne forment pas un cycle condensé peut être substitué encore par un ou plusieurs substituantschoisis parmi deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle;
R₅et R₆représentent indépendamment hydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle,(C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle;
R₇ et R₈ représentent indépendamment hydrogène, deutérium, halogène, (C1-C60)alkyle, (C6-C60)aryle, (C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl(C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro ou hydroxyle, ou R₇ et R₈ peuvent être liés via (C3-C60)alkylène ou (C3-C60)alcénylène avec ou sans un cycle condensé pour former un cycle alicyclique, ou un cycle aromatique monocyclique ou polycyclique;
l'alkyle, alcényle, alcynyle, cycloalkyle, hétérocycloalkyle, aryle, hétéroaryle, arylsilyle, alkylsilyle, alkylamino, arylamino de R₅, R₆, R₇ et R₈, ou le cycle alicyclique, ou lecycle aromatique monocyclique ou polycyclique formé à partir de ceux-ci par liaison via (C3-C60)alkylène ou (C3-C60)alcénylène avec ou sans un cycle condensé peut être substitué encore par un ou plusieurs substituants choisis parmi deutérium, halogène, (C1-C60)alkyle, halo(C1-C60)alkyle, (C6-C60)aryle,(C4-C60)hétéroaryle, hétérocycloalkyle à 5 ou 6 chaînons contenant un ou plusieurs hétéroatomes choisis parmi N, O et S, (C3-C60)cycloalkyle, tri(C1-C60)alkylsilyle, di(C1-C60)alkyl (C6-C60)arylsilyle, tri(C6-C60)arylsilyle, adamantyle, (C7-C60)bicycloalkyle, (C2-C60)alcényle, (C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle, carboxyle, nitro et hydroxyle;
et n est un entier parmi 1 à 3;
à condition que, si le cycle formé à partir de R₃ et R₄ de 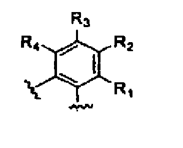 par liaison via alkylène ou alcénylène est le benzène, le cycle formé à partir de R₇ et R₈ de 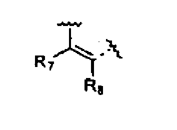 par liaison via alkylène ou alcénylène ne soit pas le benzène etunouplusieurshôteschoisis parmi 1,3,5-tricarbazolylbenzène, polyvinylcarbazole, m-biscarbazolylphényle, 4,4',4"-tri(N-carbazolyl)triphénylamine, 1,3,5-tri(2-carbazolylphényl)benzène,1,3,5-tris(2-carbazolyl-5-méthoxy-phényl)benzène, bis(4-carbazolylphényl)silane, ouunouplusieurshôtesreprésentés par l'une des formules chimiques (14) à (17) : 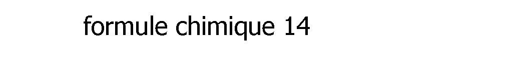 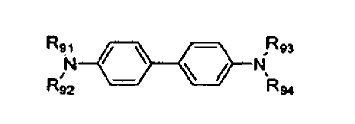 oùR₉₁àR₉₄ représentent indépendamment hydrogène, deutérium,halogène, (C1-C60)alkyle,(C6-C60)aryle,(C4-C60)hétéroaryle, unhétérocycloalkyle à 5 ou 6 chaînons contenant un ou plusieurs hétéroatomes choisis parmi N, Oet S, (C3-C60)cycloalkyle,tri(C1-C60)alkylsilyle, di(C1-C60)alkyl (C6-C60)arylsilyle,tri(C6-C60)arylsilyle,adamantyle,(C7-C60)bicycloalkyle,(C2-C60)alcényle,(C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle,carboxyle, nitro ou hydroxyle; ou chacunde R₉₁ àR₉₄ peut être lié à un substituant adjacent via (C3-C60)alkylèneou (C3-C60)alcénylèneavecousansun cycle condensépour formeruncycle alicyclique, ouun cycle aromatique monocyclique ou polycyclique; et
l'alkyle,alcényle,alcynyle,cycloalkyle,hétérocycloalkyle,aryle,hété roaryle,arylsilyle, alkylsilyle, alkylamino, arylamino de R₉₁àR₉₄,etle cycle alicyclique, oule cycle aromatique monocyclique ou polycyclique formé à partir de ceux-ciparliaison àunsubstituant adjacent via (C3-C60)alkylèneou(C3-C60)alcénylèneavecousans un cycle condensépeut être substitué encoreparunouplusieurssubstituantschoisisparmideutérium,halogène, (C1-C60)alkyle,(C6-C60)aryle,(C4-C60)hétéroaryle, un hétérocycloalkyle à 5 ou 6 chaînons contenantunouplusieurshétéroatomeschoisis parmiN, O etS,(C3-C60)cycloalkyle,tri(C1-C60)alkylsilyle,di(C1-C60)alkyl(C6-C60)arylsilyle,tri(C6-C60)arylsilyle,adamantyle,(C7-C60)bicycloalkyle, (C2-C60)alcényle,(C2-C60)alcynyle, cyano, (C1-C60)alkylamino,(C6-C60)arylamino,(C6-C60)ar(C1-C60)alkyle,(C1-C60)alkyloxy,(C1-C60)alkylthio, (C6-C60)aryloxy, (C6-C60)arylthio, (C1-C60)alcoxycarbonyle,(C1-C60)alkylcarbonyle,(C6-C60)arylcarbonyle,carboxyle,nitro ethydroxyle; 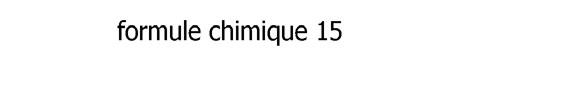 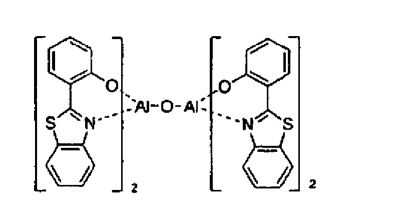 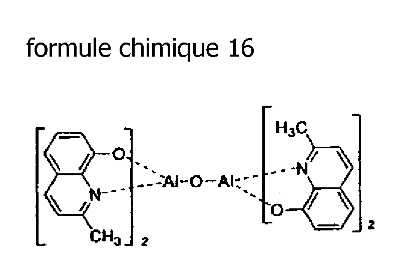
L¹L²M¹(Q)y formule chimique 17
oùles ligands L¹et L² sont choisis indépendamment parmi les structures suivantes ; 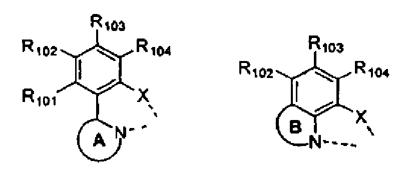 où M¹représente un métal divalent ou trivalent;
y est 0 quand M¹est un métal divalent, tandis que y est 1 quand M¹est unmétal trivalent ;
Q est (C6-C60)aryloxy ou tri(C6-C60)arylsilyle,etl'aryloxy ou triarylsilylede Q peut être substitué encorepar (C1-C60)alkyleou (C6-C60)aryle ;
X est O, S ou Se;
le cycle A représente oxazole, thiazole, imidazole, oxadiazole, thiadiazole, benzoxazole, benzothiazole, benzimidazole, pyridine ou quinoléine;
le cycle B représente pyridine ouquinoléinequipeut être substitué encorepar (C1-C60)alkyle,ouphényleounaphtyleavecousanssubstituant(s) (C1-C60)alkyle ;
R₁₀₁à R₁₀₄représentent indépendammenthydrogène, deutérium, halogène, (C1-C60)alkyle,(C6-C60)aryle, (C4-C60)hétéroaryle, un hétérocycloalkyle à 5 ou 6 chaînons contenant un ou plusieurs hétéro atomes choisis parmi N, O et S, (C3-C60)cycloalkyle, tri(C1-C60)alkylsilyle, di(C1-C60)alkyl(C6-C60)arylsilyle,tri(C6-C60)arylsilyle,adamantyle,(C7-C60)bicycloalkyle,(C2-C60)alcényle,(C2-C60)alcynyle, cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle,(C1-C60)alkylcarbonyle, (C6-C60)arylcarbonyle,carboxyle, nitro ouhydroxyle; ou chacunde R₁₀₁ à R₁₀₄peut être lié àun substituant adjacent via (C3-C60)alkylèneou(C3-C60)alcénylèneavecousansun cycle condensépour formeruncycle alicyclique, ouun cycle aromatique monocyclique ou polycyclique; et
le cycle A,ou l'alkyle,alcényle,alcynyle,cycloalkyle, hétérocycloalkyle,aryle,hétéroaryle, arylsilyle,alkylsilyle,alkylamino ou arylamino de R₁₀₁ à R₁₀₄, etlecycle alicyclique, oulecycle aromatique monocyclique ou polycyclique forméà partir de ceux-ciparliaison àunsubstituant adjacent via (C3-C60)alkylèneou (C3-C60)alcénylèneavecousansun cycle condensépeut être substitué encoreparunouplusieurssubstituantschoisisparmideutérium, halogène, (C1-C60)alkyle,(C6-C60)aryle, (C4-C60)hétéroaryle, unhétérocycloalkyleà 5 ou 6 chaînons contenantunouplusieurshétéroatomeschoisis parmi N, O et S, (C3-C60)cycloalkyle,tri(C1-C60)alkylsilyle,di(C1-C60)alkyl(C6-C60)arylsilyle, tri(C6-C60)arylsilyle,adamantyle,(C7-C60)bicycloalkyle,(C2-C60)alcényle,(C2-C60)alcynyle,cyano, (C1-C60)alkylamino, (C6-C60)arylamino, (C6-C60)ar(C1-C60)alkyle, (C1-C60)alkyloxy, (C1-C60)alkylthio, (C6-C60)aryloxy, (C6-C60)arylthio, (C1-C60)alcoxycarbonyle, (C1-C60)alkylcarbonyle, (C6-C60)arylcarbonyle,carboxyle, nitro ethydroxyle.

6. Dispositif électronique organiqueselon la revendication 5, oùla couche organique comprendunouplusieurs composéschoisis dans un groupeconsistant enles composés arylamineset les composés styrylarylamines, ouunouplusieurs métauxchoisis dans un groupeconsistant enles organométauxdu Groupe 1, du Groupe 2, les métaux de transition de la 4^{ème} périodeetde la 5^{ème}période, les métaux lanthanides etles éléments de transition d dans le tableau périodique des éléments.

7. Dispositif électronique organique selon la revendication 5, qui comprenduncomposé organique ou un composé organométallique avec une électroluminescence verte ou bleue, en plus du composé organique pour matériau électronique.

8. Dispositif électronique organique selon la revendication 5, oùla couche organique comprend une couche électroluminescente et une couche générant des charges.

9. Dispositif électronique organique selon la revendication 5, oùune région mixte de dopant réducteur et de substance organique, ou une région mixte de dopant oxydant et de substance organique est placée sur la surface interne d'une électrode ou des deux électrodes parmi la paire d'électrodes.
